# EUROPÄISCHE PATENTSCHRIFT

(11) **EP 4 042 337 B1**
(45) Veröffentlichungstag und Bekanntmachung des Hinweises auf die Patenterteilung: **05.11.2025**
(21) Anmeldenummer: 20816885.6
(22) Anmeldetag: 27.09.2020
(51) Int. Cl.: G06N 10/40, B82Y 10/00

(54) **KONZEPT FÜR EINEN STÖRSTELLENZENTREN BASIERENDEN QUANTENCOMPUTER BASIEREND AUF EINEM SUBSTRAT AUS ELEMENTEN DER IV. HAUPTGRUPPE**
CONCEPT FOR AN IMPURITY-CENTRE-BASED QUANTUM COMPUTER ON THE BASIS OF A SUBSTRATE CONSISTING OF ELEMENTS OF MAIN GROUP IV
CONCEPT D'ORDINATEUR QUANTIQUE BASÉ CENTRES D'IMPURETÉS, À BASE D'UN SUSBTRAT COMPOSÉ D'ÉLÉMENTS DU GROUPE PRINCIPAL IV

(30) Priorität: 28.10.2019 DE 102019129092; 07.11.2019 DE 102019130115; 08.12.2019 DE 102019133466
(43) Veröffentlichungstag der Anmeldung: 17.08.2022
(60) Teilanmeldung: 25203234.7
(73) Patentinhaber: Quantum Technologies GmbH, 04103 Leipzig (DE)
(72) Erfinder: BURCHARD, Bernd, 45276 Essen (DE)
(86) Internationale Anmeldenummer: PCT/DE2020/100827
(87) Internationale Veröffentlichungsnummer: WO 2021/083448

(56) Entgegenhaltungen:
- US-A1- 2018 238 989
- US-A1- 2019 044 049
- STEFAN BOGDANOVIC ET AL: "Robust nano-fabrication of an integrated platform for spin control in a tunable microcavity", ARXIV.ORG, CORNELL UNIVERSITY LIBRARY, 201 OLIN LIBRARY CORNELL UNIVERSITY ITHACA, NY 14853, 23 August 2017 (2017-08-23), XP081291139, DOI: 10.1063/1.5001144
- LUXMOORE I. J. ET AL: "Interfacing Spins in an InGaAs Quantum Dot to a Semiconductor Waveguide Circuit Using Emitted Photons", PHYSICAL REVIEW LETTERS, vol. 110, no. 3, 1 January 2013 (2013-01-01), US, XP055791868, ISSN: 0031-9007, DOI: 10.1103/PhysRevLett.110.037402
- MARCELO DAVANCO ET AL: "A heterogeneous III-V/silicon integration platform for on-chip quantum photonic circuits with single quantum dot devices", ARXIV.ORG, CORNELL UNIVERSITY LIBRARY, 201 OLIN LIBRARY CORNELL UNIVERSITY ITHACA, NY 14853, 23 November 2016 (2016-11-23), XP081361710, DOI: 10.1038/S41467-017-00987-6

## Beschreibung

### Feld der Erfindung

Die Erfindung richtet sich auf Konzept für einen auf NV-Zentren in Diamant oder anderen Zentren in anderen Materialien, beispielsweise auf G-Zentren in Silizium oder V_{Si}-Zentren in Siliziumkarbid basierenden Quantencomputer. Das Konzept umfasst dessen Elemente sowie die notwendigen Verfahren zu dessen Betrieb und deren Zusammenwirken. Eine Quanten-ALU besteht aus einem Quantenbit, das als Terminal dient zusammen mit mehreren Kernquantenpunkten, die der eigentlichen Ausführung der Quantenoperationen dient. Insbesondere umfasst die Erfindung einen Quantenbus zur Verschränkung entfernt voneinander liegender Quantenpunkte verschiedener Quanten-ALUs und Selektionsmechanismen und selektive Ansteuerverfahren. Hierdurch wird die Verschränkung von zwei Kernquantenpunkten in unterschiedlichen Quanten-ALUs, die entfernt voneinander liegen mittels dieses Quantenbusses möglich. Außerdem wird ein Verfahren mit zugehörigen Vorrichtungselementen angegeben, um ein Berechnungsergebnis auszulesen.

### Zum Stand der Technik

Zum Stand der Technik des Auslesens und Ansteuern von Quantenbits Aus der Schrift Gurudev Dutt, Liang Jiang, Jeronimo R. Maze, A. S. Zibrov "Quantum Register Based on Individual Electronic and Nuclear Spin Qubits in Diamond", Science, Vol. 316, 1312-1316, 01.06.2007, DOI: 10.1126/science.1139831 ist ein Verfahren zur Kopplung des nuklearen Spins von C¹³ Kernen mit den Elektronenspins der Elektronenkonfiguration von NV-Zentren bekannt.

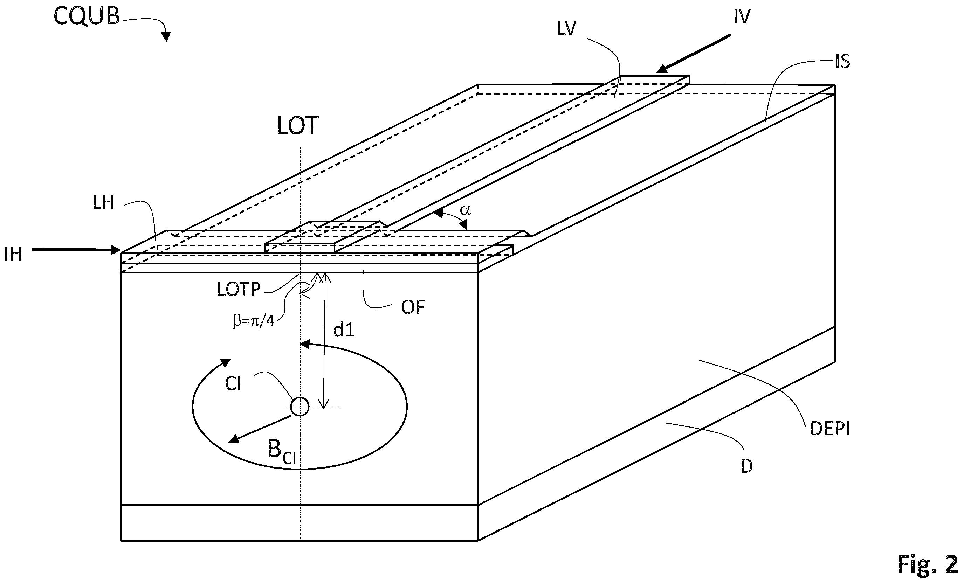

Aus der Schrift Thiago P. Mayer Alegre, Antonio C. Torrezan de Souza, Gilberto Medeiros-Ribeiro, "Microstrip resonator for microwaves with controllable polarization", arXiv:0708.0777v2 [cond-mat.other] 11.10.2007 ist ein kreuzförmiger elektrisch leitfähiger Mikrowellenresonator bekannt. Hierzu sei auf deren Figur 2 verwiesen. Eine von den Autoren im ersten Abschnitt der Arbeit benannte Anwendung des kreuzförmigen Mikrowellenresonators ist die Ansteuerung von paramagnetischen Zentren mittels optisch detektierter magnetischer Resonanz (OMDR). Eine dediziert genannte Anwendung ist Quanteninformationsverarbeitung (QIP). Das Substrat des elektrisch leitfähigen Mikrowellenresonators ist dabei ein PCB (=printed circuit board). Die Dimensionen des Resonators liegen mit 5,5cm in der Größenordnung der Wellenlänge der einzukoppelnden Mikrowellenstrahlung. Der Mikrowellenresonator wird mittels Spannungsansteuerung gespeist. Die beiden Balken des Resonatorkreuzes sind elektrisch miteinander verbunden. Eine selektive Ansteuerung einzelner paramagnetischer Zentren (NV1) bei gleichzeitiger Nichtansteuerung anderer paramagnetischer Zentren (NV1) ist mit der technischen Lehre der Schrift Thiago P. Mayer Alegre, Antonio C. Torrezan de Souza, Gilberto Medeiros-Ribeiro, "Microstrip resonator for microwaves with controllable polarization", arXiv:0708.0777v2 [cond-mat.other] 11.10.2007 nicht möglich.

Aus der Schrift Benjamin Smeltzer, Jean Mclntyre, Lilian Childress "Robust control of individual nuclear spins in diamond", Phys. Rev. A 80, 050302(R) - 25 November 2009 ist ein Verfahren zum Zugriff auf einzelne nukleare ¹³C-Spins mittels NV-Zenten in Diamant bekannt.

Aus der Schrift Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond" Science 15 Feb 2019, Vol. 363, Issue 6428, pp. 728-731, DOI: 10.1126/science.aav2789 ist das elektronische Auslesen von Spin-Zuständen der NV-Zentren bekannt.

Aus der Schrift Timothy J. Proctor, Erika Andersson, Viv Kendon "Universal quantum computation by the unitary control of ancilla qubits and using a fixed ancilla-register interaction", Phys. Rev. A 88, 042330 -24 Okt. 2013 ist ein Verfahren zur Nutzung sogenannter Ancilla Quantenbits bekannt, um einen ersten nuklearen Spin mit einem zweiten nuklearen Spin mittels Ancilla-Bits zu verschränken.

STEFAN BOGDANOVIC ET AL: "Robust nano-fabrication of an integrated platform for spin control in a tunable microcavity",ARXIV.ORG, CORNELL UNIVERSITY LIBRARY, 201 OLIN LIBRARY CORNELL UNIVERSITY ITHACA, NY 14853, 23. August 2017, stellt ein Kernquantenbit vor.

LUXMOORE I. J. ET AL: "Interfacing Spins in an InGaAs Quantum Dot to a Semiconductor Waveguide Circuit Using Emitted Photons",PHYSICAL REVIEW LETTERS, Bd. 110, Nr. 3, 1. Januar 2013, betrifft eine Vorrichtung, die zur Erzeugung eines elektromagnetischen zirkular polarisierten Wellenfeldes am Ort des Kernquantenpunkts geeignet ist.

### Aufgabe

Die hier vorgelegte Erfindung stellt sich die Aufgabe einen Konstruktions-, Produktions- und Betriebsvorschlag für einen Quantencomputer anzugeben, der insbesondere im Falle der Verwendung von NV-Zentren das Potenzial hat, bei Raumtemperatur betrieben werden zu können.

Natürlich können solche Quantencomputer auch bei tieferen Temperaturen bis nahe dem absoluten Nullpunkt betrieben werden.

### Lösung der Aufgabe

Die folgende technische Lehre wurde im Zusammenhang mit der Konzeption eines NV-Zentren in Dimant basierenden Quantencomputers entwickelt. Bei NV-Zentren handelt es sich um Stickstoff-Fehlstellen-Störzentren des Diamantkristallgitters. Es wurde erkennt, dass sich die Prinzipien auf Mischkristalle und elementreine Kristalle der VI. Hauptgruppe erweitern lassen. Exemplarisch werden hier Merkmale von Diamant basierenden Systemen, Silizium basierenden Systemen, Siliziumkarbid basierenden Systemen und Systemen auf Basis der besagten Mischsysteme mit ein, zwei, drei oder vier verschiedenen Elementen der vierten Hauptgruppe des Periodensystems beschrieben. Die Lösungen auf Basis von NV-Zentren in Diamant stehen dabei im Vordergrund, da hier die Entwicklung am weitesten fortgeschritten ist.

### Quantenbit

### Kernidee

Eine Kernidee ist ein Quantenbit (QUB), das eine besonders effiziente und relativ leicht, beispielsweise mittels E-Beam-Lithografie zu realisierende Vorrichtung zur Ansteuerung eines Quantenpunkts (NV) umfasst. Besonders bevorzugt handelt es sich bei dem Quantenpunkt (NV) um einen punktförmigen Gitterfehler in einem Kristall, dessen Atome bevorzugt kein magnetisches Moment aufweisen. Bevorzugt ist das Material des Kristalls ein Wide-Bandgap-Material, um eine Einkopplung von Phononen in den Quantenpunkt (NV) zu minimieren. Besonders bevorzugt ist die Nutzung eines Störstellenzentrums, beispielsweise eines NV-Zentrums oder eines ST1-Zentrums oder eines L2-Zentrums, in Diamant als Material des Substrats (D) oder eines anderen Störstellenzentrums in einem anderen Material, beispielsweise eines G-Zentrums in Silizium als Material des Substrats (D), insbesondere eines G11-Zentrums, als Quantenpunkt (NV). Im Falle eines Störstellenzentrums in Diamant ist das NV-Zentrum das bekannteste und am besten untersuchte Störstellenzentrum für diesen Zweck. Im Falle von Silizium als Substrat (D) ist das G-Zentrum das bekannteste Zentrum. Auf die Schrift von A. M. Tyryshkin, S. Tojo, J. J. L. Morton, H. Riemann, N. V. Abrosimov, P. Becker, H.-J. Pohl, Th. Schenkel,Mi. L. W. Thewalt, K. M. Itoh, S. A. Lyon, "Electron spin coherence exceeding seconds in high-purity silicon" NatureMat.11, 143 (2012) wird verwiesen. Im Falle von Siliziumkarbid ist sind V-Zentren und zwar bevorzugt V_{Si}-Störstellen als Störstellenzentren besonders geeignet. Auf die Publikation Stefania Castelletto and Alberto Boretti, "Silicon carbide color centers for quantum applications" 2020 J. Phys. Photonics2 022001 wird hingewiesen. Die Verwendung anderer paramagnetischer Zentren als Quantenpunkte ist darüber hinaus denkbar. Beispielsweise können auch NV-Zentren oder SiV-Zentren oder GeV-Zentren in Diamant als Quantenpunkt (NV) in dem Substrat (D) verwendet werden. Auf das Buch Alexander Zaitsev, "Optical Properties of Diamond", Springer; Auflage: 2001 (20. Juni 2001) wird hier in Bezug auf paramagnetische Zentren in Diamant verwiesen. Statt Silizium oder Diamant können auch andere Materialien verwendet werden. Besonders bevorzugt sind Halbleitermaterialien. Ganz besonders bevorzugt sind sogenannte Wide-Bandgap-Materialein mit einer größeren Bandlücke, da diese die Kopplung zwischen den Phononen des Gitters und den Elektronenkonfigurationen der Störstellen erschweren. Solche Materialien sind, ohne hier eine vollständige Aufzählung anzugeben beispielsweise BN, GaN, SiC, SiGe. Es kommt aber auch GaAs in Frage. III/V und II/VI-Mischkristalle kommen ebenfalls in Frage.

Die Forschung schreitet hier schnell voran, sodass sicherlich andere Substrate (D) mit anderen paramagnetischen Störstellenzentren hier in Zukunft entwickelt werden erden. Diese sollen von der Beanspruchung hier umfasst sein.

### Epitaktische Schicht und Freiheit von nuklearen magnetischen Momenten

Das Quantenbit (QUB) umfasst typischerweise ein Substrat (D), das bevorzugt mit einer epitaktischen Schicht (DEPI) versehen ist. Später werden in dieser Offenlegung noch analog aufgebaute Kernquantenbits (CQUB) mit Kernquantenpunkten (CI) beschrieben, die mittels magnetischer Kernmomente wechselwirken. Bevorzugt ist die epitaktischen Schicht (DEPI) oder gleich das ganze Substrat (D) aus einer Isotopenmischung hergestellt, bei der die einzelnen Isotope dieser Isotopenmischung bevorzugt kein magnetisches Moment aufweisen. Im Falle von Diamant als Substrat (D) ist das ¹²C-Kohlenstoff-Isotop zur Herstellung der epitaktischen Schicht (DEPI) und/oder des Substrats (D) besonders geeignet, da es kein magnetisches Moment aufweist. Im Falle von Silizium als Material des Substrats (D) ist das Silizium Isotop ²⁸Si zur Herstellung der epitaktischen Schicht (DEPI) und/oder des Substrats (D) besonders geeignet, da es ebenfalls kein magnetisches Moment aufweist. Wird Siliziumcarbid (Bezeichnung SiC) als Material des Substrats (D) bzw. der epitaktischen Schicht (DEPI) verwendet, so ist die Isotopenverbindung ²⁸Si¹²C besonders als Material des Substrats (D) bzw. der epitaktischen Schicht (DEPI) geeignet. Generell kann also gefordert werden, dass die Atome des Materials der epitaktischen Schicht (DEPI) bzw. des Substrats (D) und zwar bevorzugt zumindest in der Näher der paramagnetischen Zentren bzw. der Quantenpunkte (NV) bzw. der im Folgenden ebenfalls beschriebenen paramagnetischen Kernzentren und damit der Kernquantenpunkte (CI) nur Isotope ohne magnetisches Moment des Atomkerns umfassen sollten. Da die Atome der III. Hauptgruppe des Periodensystems und der V. Hauptgruppe des Periodensystems in der Regel keine stabilen Isotope ohne magnetisches Moment aufweisen, kommen daher als Material des Substrats (D) bzw. der epitaktischen Schicht (DEPI) bevorzugt Mischungen und/oder Verbindungen aus Isotopen ohne magnetisches Moment, also beispielsweise aus Isotopen der VI. Hauptgruppe - z.B. ¹²C, ¹⁴C, ²⁸Si, ³⁰Si, ⁷⁰Ge, ⁷²Ge, ⁷⁴Ge, ⁷⁶Ge,¹¹²Zn, ¹¹⁴Zn, ¹¹⁶Zn, ¹¹⁸Zn, ¹²⁰Zn, ¹²²Zn, ¹²⁴Zn und/oder der VI. Hauptgruppe ¹⁶O, ¹¹O, ³²S, ³⁴S, ³⁶S, ⁷⁴Se, ⁷⁶Se, ⁷⁸Se, ⁸⁰Se, ⁸²Se, ¹²⁰Te, ¹²²Te, ¹²⁴Te, ¹²⁶Te, ¹²⁸Te, ¹³⁰Te, und/oder der II. Hauptgruppe ²⁴Mg, ²⁶Mg, ⁴⁰Ca, ⁴²Ca, ⁴⁴Ca, ⁴⁶Ca, ⁴⁸Ca, ⁸⁴Sr, ⁸⁶Sr, ⁸⁸Sr, ¹³⁰Ba, ¹³²Ba, ¹³⁴Ba, ¹³⁶Ba, ¹³⁸Ba, und/oder der II. Nebengruppe ⁴⁶Ti, ⁴⁸Ti, ⁵⁰Ti, ⁹⁰Zr, ⁹⁰Zr, ⁹²Zr, ⁹⁴Zr, ⁹⁶Zr, ¹⁷⁴Hf, ¹⁷⁶Hf, ¹⁷⁸Hf, und/oder der IV. Nebengruppe ⁵⁰Cr, ⁵²Cr, ⁵³Cr, ⁹²Mo, ⁹⁴Mo, ⁹⁶Mo, ⁹⁸Mo, ¹⁰⁰Mo, ¹⁸⁰W, ¹⁸²W, ¹⁸⁴W, ¹⁸⁶W, und/oder der VI. Nebengruppe ⁵⁴Fe, ⁵⁶Fe, ⁵⁸Fe, ⁹⁶Ru, ⁹⁸Ru, ¹⁰⁰Ru, ¹⁰²Ru, ¹⁰⁴Ru, ¹⁸⁴Os, ¹⁸⁶Os, ¹⁸⁸Os, ¹⁹⁰Os, ¹⁹²Os und/oder der VIII. Nebengruppe ⁵⁸Ni, ⁶⁰Ni, ⁶²Ni, ⁶⁴Ni, ¹⁰²Pd, ¹⁰²Pd, ¹⁰⁴Pd, ¹⁰⁶Pd, ¹⁰⁸Pd, ¹¹⁰Pd, ¹⁹⁰Pt, ¹⁹²Pt, ¹⁹⁴Pt, ¹⁹⁶Pt, ¹⁹⁸Pt und/oder der X. Nebengruppe ⁶⁴Zn, ⁶⁶Zn, ⁶⁸Zn, ⁷⁰Zn, ¹⁰⁶Cd, ¹⁰⁸Cd, ¹¹⁰Cd, ¹¹²Cd, ¹¹⁴Cd, ¹¹⁶Cd, ¹⁹⁶Hg, ¹⁹⁸Hg, ²⁰⁰Hg, ²⁰²Hg, ²⁰⁴Hg und/oder der Lanthaniden: ¹³⁶Ce, ¹³⁸Ce, ¹⁴⁰Ce, ¹⁴²Ce, ¹⁴²Nd, ¹⁴⁴Nd, ¹⁴⁶Nd, ¹⁴⁸Nd, ¹⁵⁰Nd, ¹⁴⁴Sm, ¹⁴⁶Sm, ¹⁴⁸Sm, ¹⁵⁰Sm, ¹⁵²Sm, ¹⁵⁴Sm, ¹⁵²Gd, ¹⁵⁴Gd, ¹⁵⁶Gd, ¹⁵⁸Gd, ¹⁶⁰Gd, ¹⁵⁶Dy, ¹⁵⁸Dy, ¹⁶⁰Dy, ¹⁶²Dy, ¹⁶⁴Dy, ¹⁶²Er, ¹⁶⁴Er, ¹⁶⁶Er, ¹⁶⁸Er, ¹⁷⁰Er, ¹⁶⁸Yb, ¹⁷⁰Yb, ¹⁷²Yb, ¹⁷⁴Yb, ¹⁷⁶Yb, und/oder der Actiniden ²³²Th, ²³⁴Pa, ²³⁴U, ²³⁸U, ²⁴⁴Pu in Frage. Dabei ist zu berücksichtigen, dass einige der möglichen Materialien, beispielsweise einige Kristallstrukturen der ⁵⁴Fe, und/oder ⁵⁶Fe und/oder ⁵⁸Fe Isotope, ferromagnetische Eigenschaften oder andere störende kollektive magnetische Effekte aufweisen können, die typischerweise ebenfalls vermeiden werden sollten. Bevorzugt werden stabile Isotope mit einer Halbwertszeit von mehr als 10⁶ Jahren verwendet. Natürlich ist auch die Verwendung nicht stabiler Isotope ohne magnetische Moment möglich. Die vorstehende Liste und die nachfolgenden Tabellen umfassen daher nur solche stabilen Isotope, die bevorzugt verwendet werden. Die Beanspruchung umfasst auch nichtstabile magnetische Isotope ohne magnetisches Kernmoment.

Für die natürliche Isotopenmischung wird dabei die folgende Aufteilung der Anteile K_{0G} an Isotopen ohne magnetisches Moment und der Anteile K_{1G} an Isotopen mit magnetischem Moment bezogen auf die Gesamtmenge der Atome der jeweiligen Elemente zu Grunde als natürliche Isotopen Aufteilung des jeweiligen Elements für die Ansprüche zugrunde gelegt:

### Liste der natürlichen Verteilung der Anteile der Isotope ohne magnetisches Kernmoment µ an der Gesamtmenge der Isotope eines Elements

Wenn in dieser Schrift von Isotopen ohne magnetisches Moment oder von Isotopen ohne magnetische Kernmoment µ die Rede ist, dann ist damit gemeint, dass die Isotope im Wesentlichen ein magnetisches Kernmoment µ besitzen, das nahezu null ist. Umgekehrt haben Isotope mit magnetischem Moment bzw. begriffsgleich mit magnetischem Kernmoment µ ein von Null verschiedenes magnetisches Kernmoment. Mit diesem können sie mit anderen Isotopen mit magnetischem Kernmoment wechselwirken und sich somit mit diesen koppeln und/oder verschränken.

### IV. Hauptgruppe

### Für Kohlenstoff (C):

| Isotop | Anteil K₀ der Isotope ohne magnetisches Moment an 100% C |
|---|---|
| Isotop ¹²C | 98,94 % |
| Isotop ¹⁴C | Spuren |
| Gesamtanteil K_{0G} der Isotope ohne magnetisches Moment an 100% C | 98,94% |
| Gesamtanteil K_{1G} der Isotope mit magnetischen Moment an 100% C | 1,06% |

### Für Silizium (Si)

| Isotop | Anteil K₀ der Isotope ohne magnetisches Moment an 100% Si |
|---|---|
| Isotop ²⁸Si | 92,25% |
| Isotop ³⁰Si | 3,07% |
| Gesamtanteil K_{0G} der Isotope ohne magnetisches Moment an 100% Si | 95,33% |
| Gesamtanteil K_{1G} der Isotope mit magnetischen Moment an 100% Si | 4,67% |

### Für Germanium (Ge):

| Isotop | Anteil K₀ der Isotope ohne magnetisches Moment an 100% Ge |
|---|---|
| Isotop ⁷⁰Ge | 20,52% |
| Isotop ⁷²Ge | 27,45 % |
| Isotop ⁷⁴Ge | 36,52% |
| Isotop ⁷⁶Ge | 7,75 % |
| Gesamtanteil K_{0G} der Isotope ohne magnetisches Moment an 100% Ge | 92,24% |
| Gesamtanteil K_{1G} der Isotope mit magnetischen Moment an 100% Ge | 7,76% |

### Für Zinn (Sn):

| Isotop | Anteil K₀ der Isotope ohne magnetisches Moment an 100% Sn |
|---|---|
| Isotop ¹¹²Sn | 0,97(1) % |
| Isotop ¹¹⁴Sn | 0,66(1) % |
| Isotop ¹¹⁶Sn | 14,54(9) % |
| Isotop ¹¹⁸Sn | 24,22(9) % |
| Isotop ¹²⁰Sn | 32,58(9) % |
| Isotop ¹²²Sn | 4,63(3) % |
| Isotop ¹²⁴Sn | 5,79(5) % |
| Gesamtanteil K_{0G} der Isotope ohne magnetisches Moment an 100% Sn | 83% |
| Gesamtanteil K_{1G} der Isotope mit magnetischen Moment an 100% Sn | 17% |

### VI. Hauptgruppe

### Für Sauerstoff (O):

| Isotop | Anteil K₀ der Isotope ohne magnetisches Moment an 100% O |
|---|---|
| Isotop ¹⁶O | 99,76% |
| Isotop ¹⁸O | 0,20% |
| Gesamtanteil K_{0G} der Isotope ohne magnetisches Moment an 100% O | 99,96% |
| Gesamtanteil K_{1G} der Isotope mit magnetischen Moment an 100% O | 0,04% |

### Für Schwefel (S):

| Isotop | Anteil K₀ der Isotope ohne magnetisches Moment an 100% S |
|---|---|
| Isotop ³²S | 94,90% |
| Isotop ³⁴S | 4,30% |
| Isotop ³⁶S | 0,01% |
| Gesamtanteil K_{0G} der Isotope ohne magnetisches Moment an 100% S | 99,21% |
| Gesamtanteil K_{1G} der Isotope mit magnetischen Moment an 100% S | 0,79% |

### Für Selen (Se):

| Isotop | Anteil K₀ der Isotope ohne magnetisches Moment an 100% Se |
|---|---|
| Isotop ⁷⁴Se | 0,86% |
| Isotop ⁷⁶Se | 9,23% |
| Isotop ⁷⁸Se | 23,69% |
| Isotop ⁸⁰Se | 49,80% |
| Isotop ⁸²Se | 8,82% |
| Gesamtanteil K_{0G} der Isotope ohne magnetisches Moment an 100% Se | 92,40% |
| Gesamtanteil K_{1G} der Isotope mit magnetischen Moment an 100% Se | 7,60% |

### Für Tellur (Te)

| Isotop | Anteil K₀ der Isotope ohne magnetisches Moment an 100% Te |
|---|---|
| Isotop ¹²⁰Te | 0,09% |
| Isotop ¹²²Te | 2,55% |
| Isotop ¹²⁴Te | 4,74% |
| Isotop ¹²⁶Te | 18,84% |
| Isotop ¹²⁸Te | 31,74% |
| Isotop ¹³⁰Te | 34,08% |
| Gesamtanteil K_{0G} der Isotope ohne magnetisches Moment an 100% Te | 92,04% |
| Gesamtanteil K_{1G} der Isotope mit magnetischen Moment an 100% Te | 7,96% |

### II. Hauptgruppe

### Für Magnesium (Mg):

| Isotop | Anteil K₀ der Isotope ohne magnetisches Moment an 100% Mg |
|---|---|
| Isotop ²⁴Mg | 78,97% |
| Isotop ²⁶Mg | 11,02% |
| Gesamtanteil K_{0G} der Isotope ohne magnetisches Moment an 100% Mg | 89,99% |
| Gesamtanteil K_{1G} der Isotope mit magnetischen Moment an 100% Mg | 10,01% |

### Für Kalzium (Ca):

| Isotop | Anteil K₀ der Isotope ohne magnetisches Moment an 100% Ca |
|---|---|
| Isotop ⁴⁰Ca | 96,9410% |
| Isotop ⁴²Ca | 0,6470% |
| Isotop ⁴⁴Ca | 2,0860% |
| Isotop ⁴⁶Ca | 0,0040% |
| Isotop ⁴⁸Ca | 0,1870% |
| Gesamtanteil K_{0G} der Isotope ohne magnetisches Moment an 100% Ca | 99,8650% |
| Gesamtanteil K_{1G} der Isotope mit magnetischen Moment an 100% Ca | 0,1350% |

### Für Strontium (Sr):

| Isotop | Anteil K₀ der Isotope ohne magnetisches Moment an 100% Sr |
|---|---|
| Isotop ⁸⁴Sr | 0,57% |
| Isotop ⁸⁶Sr | 9,87% |
| Isotop ⁸⁸Sr | 82,52% |
| Gesamtanteil K_{0G} der Isotope ohne magnetisches Moment an 100% Sr | 92,96% |
| Gesamtanteil K_{1G} der Isotope mit magnetischen Moment an 100% Sr | 7,04% |

### Für Barium

| Isotop | Anteil K₀ der Isotope ohne magnetisches Moment an 100% Ba |
|---|---|
| Isotop ¹³⁰Ba | 0,11% |
| Isotop ¹³²Ba | 0,10% |
| Isotop ¹³⁴Ba | 2,42% |
| Isotop ¹³⁶Ba | 7,85% |
| Isotop ¹³⁸Ba | 71,70% |
| Gesamtanteil K_{0G} der Isotope ohne magnetisches Moment an 100% Ba | 82,18% |
| Gesamtanteil K_{1G} der Isotope mit magnetischen Moment an 100% Ba | 17,82% |

### II. Nebengruppe

### Für Titan (Ti):

| Isotop | Anteil K₀ der Isotope ohne magnetisches Moment an 100% Ti |
|---|---|
| Isotop ⁴⁶Ti | 8,25% |
| Isotop ⁴⁸Ti | 73,72% |
| Isotop ⁵⁰Ti | 5,18% |
| Gesamtanteil K_{0G} der Isotope ohne magnetisches Moment an 100% Ti | 87,15% |
| Gesamtanteil K_{1G} der Isotope mit magnetischen Moment an 100% Ti | 12,85% |

### Für Zirkon (Zr):

| Isotop | Anteil K₀ der Isotope ohne magnetisches Moment an 100% Zr |
|---|---|
| Isotop ⁹⁰Zr | 51,45% |
| Isotop ⁹²Zr | 17,15% |
| Isotop ⁹⁴Zr | 17,38% |
| Isotop ⁹⁶Zr | 2,80% |
| Gesamtanteil K_{0G} der Isotope ohne magnetisches Moment an 100% Zr | 88,78% |
| Gesamtanteil K_{1G} der Isotope mit magnetischen Moment an 100% Zr | 11,22% |

### Für Hafnium

| Isotop | Anteil K₀ der Isotope ohne magnetisches Moment an 100% Hf |
|---|---|
| Isotop ¹⁷⁴Hf | 0,16% |
| Isotop ¹⁷⁶Hf | 5,21% |
| Isotop ¹⁷⁸Hf | 27,30% |
| Gesamtanteil K_{0G} der Isotope ohne magnetisches Moment an 100% Hf | 67,77% |
| Gesamtanteil K_{1G} der Isotope mit magnetischen Moment an 100% Hf | 32,24% |

### IV. Nebengruppe

### Für Chrom

| Isotop | Anteil K₀ der Isotope ohne magnetisches Moment an 100% Cr |
|---|---|
| Isotop ⁵⁰Cr | 4,35% |
| Isotop ⁵²Cr | 83,79% |
| Isotop ⁵⁴Cr | 2,37% |
| Gesamtanteil K_{0G} der Isotope ohne magnetisches Moment an 100% Cr | 90,50% |
| Gesamtanteil K_{1G} der Isotope mit magnetischen Moment an 100% Cr | 9,50% |

### Für Molybdän

| Isotop | Anteil K₀ der Isotope ohne magnetisches Moment an 100% Mo |
|---|---|
| ⁹²Mo | 14,84% |
| ⁹⁴Mo | 9,25% |
| ⁹⁶Mo | 16,68% |
| ⁹⁸Mo | 24,13% |
| ¹⁰⁰Mo | 9,63% |
| Gesamtanteil K_{0G} der Isotope ohne magnetisches Moment an 100% Mo | 74,53% |
| Gesamtanteil K_{1G} der Isotope mit magnetischen Moment an 100% Mo | 25,47% |

### Für Wolfram

| Isotop | Anteil K₀ der Isotope ohne magnetisches Moment an 100% W |
|---|---|
| Isotop ¹⁸⁰W | 0,12% |
| Isotop ¹⁸²W | 26,50% |
| Isotop ¹⁸⁴W | 30,64% |
| Isotop ¹⁸⁶W | 28,43% |
| Gesamtanteil K_{0G} der Isotope ohne magnetisches Moment an 100% W | 85,69% |
| Gesamtanteil K_{1G} der Isotope mit magnetischen Moment an 100% W | 14,31% |

### VI. Nebengruppe

### Für Eisen

| | Anteil K₀ der Isotope ohne magnetisches Moment an 100% Fe |
|---|---|
| Isotop ⁵⁴Fe | 5,85% |
| Isotop ⁵⁶Fe | 91,75% |
| Isotop ⁵⁸Fe | 0,28% |
| Gesamtanteil K_{0G} der Isotope ohne magnetisches Moment an 100% Fe | 97,88% |
| Gesamtanteil K_{1G} der Isotope mit magnetischen Moment an 100% Fe | 2,12% |

### Für Ruthenium (Ru):

| | Anteil K₀ der Isotope ohne magnetisches Moment an 100% Ru |
|---|---|
| ⁹⁶Ru | 5,52% |
| ⁹⁸Ru | 1,88% |
| ¹⁰⁰Ru | 12,60% |
| ¹⁰²Ru | 31,60% |
| ¹⁰⁴Ru | 18,70% |
| Gesamtanteil K_{0G} der Isotope ohne magnetisches Moment an 100% Ru | 70,30% |
| Gesamtanteil K_{1G} der Isotope mit magnetischen Moment an 100% Ru | 29,70% |

### Für Osmium

| | Anteil K₀ der Isotope ohne magnetisches Moment an 100% Os |
|---|---|
| Isotop ¹⁸⁴O_{S} | 0,02% |
| Isotop ¹⁸⁶Os | 1,59% |
| Isotop ¹⁸⁸Os | 13,24% |
| Isotop ¹⁹⁰Os | 26,26% |
| Isotop ¹⁹²Os | 40,78% |
| Gesamtanteil K_{0G} der Isotope ohne magnetisches Moment an 100% Os | 81,89% |
| Gesamtanteil K_{1G} der Isotope mit magnetischen Moment an 100% Os | 18,11% |

### VIII. Nebengruppe

### Für Nickel (Ni):

| | Anteil K₀ der Isotope ohne magnetisches Moment an 100% Ni |
|---|---|
| Isotop ⁵⁸Ni | 68,08% |
| Isotop ⁶⁰Ni | 26,22% |
| Isotop ⁶²Ni | 3,63% |
| Isotop ⁶⁴Ni | 0,93% |
| Gesamtanteil K_{0G} der Isotope ohne magnetisches Moment an 100% Ni | 98,86% |
| Gesamtanteil K_{1G} der Isotope mit magnetischen Moment an 100% Ni | 1,14% |

### Für Palladium (Pd)

| | Anteil K₀ der Isotope ohne magnetisches Moment an 100% Pd |
|---|---|
| Isotop ¹⁰²Pd | 1,02% |
| Isotop ¹⁰⁴Pd | 11,14% |
| Isotop ¹⁰⁶Pd | 27,33% |
| Isotop ¹⁰⁸Pd | 26,46% |
| Isotop ¹¹⁰Pd | 11,72% |
| Gesamtanteil K_{0G} der Isotope ohne magnetisches Moment an 100% Pd | 77,67% |
| Gesamtanteil K_{1G} der Isotope mit magnetischen Moment an 100% Pd | 22,33% |

### Für Platin (Pt):

| | Anteil K₀ der Isotope ohne magnetisches Moment an 100% Pt |
|---|---|
| Isotop ¹⁹⁰Pt | 0,01% |
| Isotop ¹⁹²Pt | 0,78% |
| Isotop ¹⁹⁴Pt | 32,86% |
| Isotop ¹⁹⁶Pt | 25,21% |
| Isotop ¹⁹⁸Pt | 7,36% |
| Gesamtanteil K_{0G} der Isotope ohne magnetisches Moment an 100% Pt | 66,23% |
| Gesamtanteil K_{1G} der Isotope mit magnetischen Moment an 100% Pt | 33,78% |

### X. Nebengruppe

### Für Zink (Zn):

| | Anteil K₀ der Isotope ohne magnetisches Moment an 100% Zn |
|---|---|
| Isotop ⁶⁴Zn | 49,17% |
| Isotop ⁶⁶Zn | 27,73% |
| Isotop ⁶⁸Zn | 18,45% |
| Isotop ⁷⁰Zn | 0,61% |
| Gesamtanteil K_{0G} der Isotope ohne magnetisches Moment an 100% Zn | 95,96% |
| Gesamtanteil K_{1G} der Isotope mit magnetischen Moment an 100% Zn | 4,04% |

### Für Cadmium (Cd):

| | Anteil K₀ der Isotope ohne magnetisches Moment an 100% Cd |
|---|---|
| Isotop ¹⁰⁶Cd | 1,25% |
| Isotop ¹⁰⁸Cd | 0,89% |
| Isotop ¹¹⁰Cd | 12,47% |
| Isotop ¹¹²Cd | 24,11% |
| Isotop ¹¹⁴Cd | 28,75% |
| Isotop ¹¹⁶Cd | 7,51% |
| Gesamtanteil K_{0G} der Isotope ohne magnetisches Moment an 100% Cd | 74,98% |
| Gesamtanteil K_{1G} der Isotope mit magnetischen Moment an 100% Cd | 25,02% |

### Für Quecksilber (Hg):

| | Anteil K₀ der Isotope ohne magnetisches Moment an 100% Hg |
|---|---|
| Isotop ¹⁹⁶Hg | 0,15% |
| Isotop ¹⁹⁸Hg | 10,04% |
| Isotop ²⁰⁰Hg | 23,14% |
| Isotop ²⁰²Hg | 29,74% |
| Isotop ²⁰⁴Hg | 6,82% |
| Gesamtanteil K_{0G} der Isotope ohne magnetisches Moment an 100% Hg | 69,89% |
| Gesamtanteil K_{1G} der Isotope mit magnetischen Moment an 100% Hg | 30,11% |

### Lanthaniden:

### Für Cer (Ce):

| | Anteil K₀ der Isotope ohne magnetisches Moment an 100% Ce |
|---|---|
| Isotop ¹³⁶Ce | 0,19% |
| Isotop ¹³⁸Ce | 0,25% |
| Isotop ¹⁴⁰Ce | 88,45% |
| Isotop ¹⁴²Ce | 11,11% |
| Gesamtanteil K_{0G} der Isotope ohne magnetisches Moment an 100% Ce | 100,00% |
| Gesamtanteil K_{1G} der Isotope mit magnetischen Moment an 100% Ce | 0% |

| | Anteil K₀ der Isotope ohne magnetisches Moment an 100% Nd |
|---|---|
| Isotop ¹⁴²Nd | 27,15% |
| Isotop ¹⁴⁴Nd | 23,80% |
| Isotop ¹⁴⁶Nd | 17,19% |
| Isotop ¹⁴⁸Nd | 5,76% |
| Isotop ¹⁵⁰Nd | 5,64% |
| Gesamtanteil K_{0G} der Isotope ohne magnetisches Moment an 100% Nd | 79,53% |
| Gesamtanteil K_{1G} der Isotope mit magnetischen Moment an 100% Nd | 20,47% |

### Für Samarium (Sm):

| | Anteil K₀ der Isotope ohne magnetisches Moment an 100% Sm |
|---|---|
| Isotop ¹⁴⁴Sm | 3,08% |
| Isotop ¹⁴⁶Sm | 0% |
| Isotop ¹⁴⁸Sm | 11,25% |
| Isotop ¹⁵⁰Sm | 7,37% |
| Isotop ¹⁵²Sm | 26,74% |
| Isotop ¹⁵⁴Sm | 22,74% |
| Gesamtanteil K_{0G} der Isotope ohne magnetisches Moment an 100% Sm | 71,18% |
| Gesamtanteil K_{1G} der Isotope mit magnetischen Moment an 100% Sm | 28,82% |

### Für Gadolinium (Gd):

I

| | Anteil K₀ der Isotope ohne magnetisches Moment an 100% Gd |
|---|---|
| Isotop ¹⁵²Gd | 0,20% |
| Isotop ¹⁵⁴Gd | 2,18% |
| Isotop ¹⁵⁶Gd | 20,47% |
| Isotop ¹⁵⁸Gd | 24,84% |
| Isotop ¹⁶⁰Gd | 21,86% |
| Gesamtanteil K_{0G} der Isotope ohne magnetisches Moment an 100% Gd | 69,55% |
| Gesamtanteil K_{1G} der Isotope mit magnetischen Moment an 100% Gd | 30,45% |

### Für Dysprosium:

| | Anteil K₀ der Isotope ohne magnetisches Moment an 100% Dy |
|---|---|
| Isotop ¹⁵⁶Dy | 0,06% |
| Isotop ¹⁵⁸Dy | 0,10% |
| Isotop ¹⁶⁰Dy | 2,33% |
| Isotop ¹⁶²Dy | 25,48% |
| Isotop ¹⁶⁴Dy | 28,26% |
| Gesamtanteil K_{0G} der Isotope ohne magnetisches Moment an 100% Dy | 56,22% |
| Gesamtanteil K_{1G} der Isotope mit magnetischen Moment an 100% Dy | 43,79% |

### Für Erbium (Er):

| | Anteil K₀ der Isotope ohne magnetisches Moment an 100% Er |
|---|---|
| Isotop ¹⁶²Er | 0,14% |
| Isotop ¹⁶⁴Er | 1,60% |
| Isotop ¹⁶⁶Er | 33,50% |
| Isotop ¹⁶⁸Er | 26,98% |
| Isotop ¹⁷⁰Er | 14,91% |
| Gesamtanteil K_{0G} der Isotope ohne magnetisches Moment an 100% Er | 77,13% |
| Gesamtanteil K_{1G} der Isotope mit magnetischen Moment an 100% Er | 22,87% |

### Für Ytterbium (Yb):

| | Anteil K₀ der Isotope ohne magnetisches Moment an 100% Yb |
|---|---|
| Isotop ¹⁶⁸Yb | 0,13% |
| Isotop ¹⁷⁰Yb | 3,02% |
| Isotop ¹⁷²Yb | 21,75% |
| Isotop ¹⁷⁴Yb | 31,90% |
| Isotop ¹⁷⁶Yb | 12,89% |
| Gesamtanteil K_{0G} der Isotope ohne magnetisches Moment an 100% Yb | 69,69% |
| Gesamtanteil K_{1G} der Isotope mit magnetischen Moment an 100% Yb | 30,31% |

### Actiniden

### Für Thorium (Th):

| | Anteil K₀ der Isotope ohne magnetisches Moment an 100% Th |
|---|---|
| Isotop ²³²Th | 100% |
| Gesamtanteil K_{0G} der Isotope ohne magnetisches Moment an 100% Th | 100% |
| Gesamtanteil K_{1G} der Isotope mit magnetischen Moment an 100% Th | 0% |

### Für Proactinium (Pa)

| | Anteil K₀ der Isotope ohne magnetisches Moment an 100% Pa |
|---|---|
| Isotop ²³⁴Pa | 0% (Spuren) |
| Gesamtanteil K_{0G} der Isotope ohne magnetisches Moment an 100% Pa | 0% (Spuren) |
| Gesamtanteil K_{1G} der Isotope mit magnetischen Moment an 100% Pa | 100% |

### Für Uran (U):

| | Anteil K₀ der Isotope ohne magnetisches Moment an 100% U |
|---|---|
| Isotop ²³⁴U | 0,01% |
| Isotop ²³⁸U | 99,27% |
| Gesamtanteil K_{0G} der Isotope ohne magnetisches Moment an 100% U | 99,28% |
| Gesamtanteil K_{1G} der Isotope mit magnetischen Moment an 100% U | 0,72% |

### Für Plutonium (Pu):

| | Anteil K₀ der Isotope ohne magnetisches Moment an 100% Pu |
|---|---|
| Isotop ²⁴⁴Pu | 100% |
| Gesamtanteil K_{0G} der Isotope ohne magnetisches Moment an 100% Pu | 100% |
| Gesamtanteil K_{1G} der Isotope mit magnetischen Moment an 100% Pu | 0% |

### Aufbau eines beispielhaften Substrats (D)

Das Substrat (D) umfasst somit Elemente. Die Isotope dieser Elemente des Substrats (D) weisen zumindest Bereichsweise im Wesentlichen bevorzugt kein magnetisches Kernmoment µ auf. Ggf. kann das Substrat (D) beispielsweise eine natürliche Zusammensetzung von Isotopen und damit Isotope mit einem magnetischen Moment aufweisen, wenn das Substrat (D) mit einer funktionalen Schicht beispielsweise in Form einer epitaktischen Schicht (DEPI) gleichen Materials bedeckt ist, die stattdessen die Eigenschaft aufweist, dass die Isotope dieser Elemente der epitaktischen Schicht (DEPI) zumindest Bereichsweise im Wesentlichen kein magnetisches Kernmoment µ aufweisen. Die im Folgenden beschriebenen Quantenpunkte (NV) und Kernquantenpunkte (CI) werden dann in dieser epitaktischen Schicht (DEPI) gefertigt, deren Dicke dann größer als die Elektron-Elektron-Kopplungsreichweite zwischen zwei Quantenpunkten (NV) und größer als die Kern-Elektron-Kopplungsreichweite zwischen einem Quantenpunkt (NV) und einem Kernquantenpunkt (CI) sein sollte. Der Begriff "im Wesentlichen" bedeutet hierbei, dass der Gesamtanteil K_{1G} der Isotope mit magnetischen Moment eines Elements, das Bestandteil des Substrats (D) bzw. der epitaktischen Schicht (DEPI) bezogen auf 100% dieses Elements, das Bestandteil des Substrats (D) bzw. der epitaktischen Schicht (DEPI) ist, gegenüber den in den obigen Tabellen angegebenen natürlichen Gesamtanteil K_{1G} auf einen Anteil K_{1G}' der Isotope mit magnetischen Moment eines Elements, das Bestandteil des Substrats (D) bzw. der epitaktischen Schicht (DEPI) ist bezogen aus 100% dieses Elements, das Bestandteil des Substrats (D) bzw. der epitaktischen Schicht (DEPI) ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element des Substrats (D) bzw. der epitaktischen Schicht (DEPI) im Einwirkungsbereich der als Quantenpunkte (NV) benutzten paramagnetischen Störstellen (NV) und/oder der als Kernquantenpunkten (CI) benutzten nuklearen Spins ist.

Hierbei werden die Atome der Kernquantenpunkte nicht berücksichtigt, da deren magnetisches Moment ja beabsichtigt ist.

Im Falle von Siliziumcarbid als Material des Substrats (D) bzw. der epitaktischen Schicht (DEPI) werden bevorzugt V-Zentren in einem Substrat aus ²⁸Si-Atomen verwendet. Auf die Schrift von D. Riedel, F. Fuchs, H. Kraus, S. Vath, A. Sperlich, V. Dyakonov, A. A. Soltamova, P. G. Baranov, V. A. Ilyin, G. V. Astakhov, "Resonant addressing and manipulation of silicon vacancy qubits in silicon carbide" arXiv:1210.0505v1 [cond-mat.mtrl-sci] 1Oct 2012 wird verwiesen. Im Falle von Industriediamanten als Substrat (D), die mit einem Hochdruckprozess aus einer Metallschmelze als Kohlenstofflösungsmittel gezogen werden, enthalten diese Substrate (D) oft noch insbesondere ferromagnetische Verunreinigungen in Form von Fremdatomen wie beispielsweise Eisen oder Nickel, die ein starkes magnetisches Moment aufweisen. Dieses parasitäre Magnetfeld würde die Quantenpunkte (NV) massiv beeinflussen und unbrauchbar machen. Somit ist bei der Verwendung paramagnetischer Störstellen (NV1) in Diamant ein isotopenreiner Diamant aus ¹²C-Atomen zu bevorzugen, da diese ebenfalls kein magnetisches Moment aufweisen. Da ein Wafer aus isotopenreinem ²⁸Si-Silizium oder ein isotopenreiner Diamant aus Atomen ohne magnetischem Moment, beispielsweise aus ¹²C-Kohlenstoffatomen, sehr teuer ist, ist es sinnvoll, eine isotopenreine epitaktische Schicht (DEPI) aus dem gewünschten Material aus den gewünschten Isotopen ohne magnetisches Kernmoment auf der Oberfläche eines Standard Silizium-Wafers oder eines Standard SiC-Wafers bzw. eines Industriediamanten aufwachsen zu lassen. Die Dicke dieser epitaktischen Schicht (DEPI) wurde von den Autoren nicht im Detail untersucht. Mehrere µm erscheinen angebracht, möglicherweise reichen aber schon wenige Atomlagen, da die Reichweite der Wechselwirkung der Kernspins sehr klein ist. Die Dicke der epitaktischen Schicht (DEPI) sollte also zumindest größer als diese Reichweite der Wechselwirkung der Kernspins der Kernquantenpunkte (CI) und/oder besser größer als die doppelte Reichweite der Wechselwirkung der Kernspins er Kernquantenpunkte (CI) und/oder besser größer als die fünffache Reichweite der Wechselwirkung der Kernspins er Kernquantenpunkte (CI) und/oder besser größer als die zehnfache Reichweite der Wechselwirkung der Kernspins er Kernquantenpunkte (CI) und/oder besser größer als die zwanzigfache Reichweite der Wechselwirkung der Kernspins er Kernquantenpunkte (CI) und/oder besser größer als die fünfzigfache Reichweite der Wechselwirkung der Kernspins er Kernquantenpunkte (CI) und/oder besser größer als die hundertfache Reichweite der Wechselwirkung der Kernspins er Kernquantenpunkte (CI) sein. Je nach Typ des Substrats (D) sollten im Rahmen einer Nacharbeit Versuche zur Minimierung der Dicke der epitaktischen Schicht (DEPI) mit verschiedenen Schichtdicken der epitaktischen Schicht (DEPI) unternommen werden, um die für den Anwendungszweck optimale Schichtdicke zu ermitteln. Bevorzugt ist die epitaktische Schicht (DEPI) isotopenrein bzw. frei von Isotopen mit einem magnetischen Kernmoment. Hierdurch wird eine Wechselwirkung zwischen den Quantenpunkten der paramagnetischen Zentren (NV1) und den Kernquantenpunkten (CI) der nuklearen Spins einerseits und Atomen des Substrats (D) im Umgebungsbereich dieser Quantenpunkte (NV) aus paramagnetischen Zentren bzw. diesen Kernquantenpunkten (CI) aus nuklearen Spins andererseits unwahrscheinlicher. Damit steigt dann die Kohärenzzeit der Quantenpunkte (NV) bzw. Kernquantenpunkte (CI) an. Bei der Abscheidung diese epitaktischen Schicht (DEPI), beispielsweise mit einem CVD-Verfahren, kann das Material der epitaktischen Schicht (DEPI) mit Fremdatomen gezielt dotiert werden, um eine günstige Lage des Fermi-Niveaus zu erreichen und die Ausbeute der Quantenpunkte (NV) bei deren Fertigung zu erhöhen. Bevorzugt erfolgt diese Dotierung mit Isotopen, die kein magnetisches Moment aufweisen, oder in einem solchen Abstand, dass das magnetische Moment µ des nuklearen Atomkerns der Dotieratome im Wesentlichen keine Auswirkung auf die Quantenpunkte (NV) und/oder die Kernquantenpunkte (CI) mehr hat. Bevorzugt ist der kleinste Abstand (d_{dot}) zwischen einem Bereich des Substrats (D), der mit Fremdatomen dotiert ist, die ein magnetisches Kernmoment µ aufweisen, einerseits und einem relevanten Quantenpunkt (NV) und/oder einem Kernquantenpunkten (CI) andererseits zumindest größer als die Wechselwirkungsreichweite des magnetischen Moments der Quantenpunkte (NV) untereinander und/oder der Kernquantenpunkte (CI) untereinander und/oder zwischen einem Kernquantenpunkt und einem Quantenpunkt. Die größte der hier genannten Wechselwirkungsreichweiten und zwar erstens die Wechselwirkungsreichweite des magnetischen Moments der Quantenpunkte (NV) untereinander und zweitens die Wechselwirkungsreichweite der Kernquantenpunkte (CI) untereinander und drittens die größte Wechselwirkungsreichweite zwischen einem Kernquantenpunkt (CI) und einem Quantenpunkt (NV) bestimmt somit den Mindestabstand (d_{dotmin}) des Abstands (d_{dot}) zwischen einem Bereich des Substrats (D), der mit Fremdatomen dotiert ist, die ein magnetisches Kernmoment µ aufweisen, einerseits und einem relevanten Quantenpunkt (NV) und/oder einem Kernquantenpunkten (CI) andererseits zumindest größer als die Wechselwirkungsreichweite des magnetischen Moments der Quantenpunkte (NV) untereinander und/oder der Kernquantenpunkte (CI) untereinander und/oder zwischen einem Kernquantenpunkt und einem Quantenpunkt Hierzu später mehr. Bevorzugt ist dieser Abstand (d_{dot}) größer als der Mindestabstand (d_{dotmin}) und/oder besser größer als das doppelte des Mindestabstands (d_{dotmin}) und/oder besser größer als das Fünffache des Mindestabstands (d_{dotmin}) und/oder besser größer als das Zehnfache des Mindestabstands (d_{dotmin}) und/oder besser größer als das Zwanzigfache des Mindestabstands (d_{dotmin}) und/oder besser größer als das Fünfzigfache des Mindestabstands (d_{dotmin}) und/oder besser größer als das Hundertfache des Mindestabstands (d_{dotmin}) und/oder besser größer als das Zweihundertfache des Mindestabstands (d_{dotmin}) und/oder besser größer als das Fünfhundertfache des Mindestabstands (d_{dotmin}). Ist jedoch der Abstand zu groß, so wird das Fermi-Niveau am Ort der Quantenpunkte (NV) und/oder am Ort der Kernquantenpunkte (CI) nicht mehr beeinflusst. Es wird empfohlen mittels eines Design-of-Experiment-Experiments (Deutsch: statistische Versuchsplanung) für den jeweiligen konstruktiven Fall ein gutes Ergebnis zu erzielen. Bei der Ausarbeitung der Erfindung hat es sich bewährt, den Bereich der Quantenpunkte (NV) und/oder der Kernquantenpunkte mit Fremdatomen ohne magnetisches Moment zu dotieren und Kontaktdotierungen bzw. Kontaktimplantationen in einem größeren Abstand von den Quantenpunkten (NV) und/oder Kernquantenpunkten (CI) vorzunehmen, wenn diese Kontakte nicht zwischen zwei gekoppelten Quantenpunkten (NV1, NV2) platziert werden sollen. Im Falle von ¹²C-Diamant ist beispielsweise eine Dotierung mit ³²S-Schwefel-Isotopen im Bereich von NV-Zentren als Quantenpunkten (NV) besonders vorteilhaft.

### Quantenbit

Ein Quantenbit (QUB) im Sinne dieser Offenlegung umfasst zumindest einen Quantenpunkt (NV) mit einem Quantenpunkttyp. Der Quantenpunkttyp bestimmt, von welcher Art der Quantenpunkt ist. Ein G-Zentrum ist in diesem Sinne beispielsweise ein anderer Quantenpunkttyp als ein SiV-Zentrum. Bei dem Quantenpunkt (NV) handelt es sich bevorzugt um ein paramagnetisches Zentrum bevorzugt in einem Einkristall ausbevorzugt magnetisch neutralen Atomen. Ganz besonders bevorzugt handelt es sich um ein Störstellenzentrum in einem Kristall als Substrat (D). Aufgrund der unmagnetischen Eigenschaften ist ein Siliziumkristall, bzw. ein Siliziumkarbidkristall bzw. ein Diamantkristall als Material des Substrats (D) bevorzugt, die wiederum bevorzugt zumindest im Bereich der Quantenpunkte (NV) bzw. der Kernquantenpunkte (CI) isotopenrein bzw. frei von magnetischen Kernmomenten der Isotope des Materials des Substrats (D) sind. Auch wenn hier auf NV-Zentren in Diamant, bzw. G-zentren in Silizium bzw. V-Zentren in Siliziumcarbid fokussiert wird, sind andere Kombinationen aus Störstellenzentren und Kristallen und Materialien mit umfasst, sofern sie geeignet sind. Ein Merkmal der Eignung von Kristallen und Materialien als Substrat (D) und/oder Material der epitaktischen Schicht (DEPI) ist, dass sie zumindest im Bereich der Quantenpunkte (NV) und/oder Kernquantenpunkte (CI) in ihrem Material im Wesentlichen keine Isotope mit einem magnetischen Kernmoment µ, das bei solche unerwünschten Isotopen von Null verschieden ist, aufweisen. Bevorzugt besteht beispielsweise ein Diamantkristall in dem betreffenden Bereich der Quantenpunkte (NV) und/oder der Kernquantenpunkte (CI) aus ¹²C-Kohlenstoffisotopen. Bevorzugt besteht beispielsweise ein Siliziumkristall in dem betreffenden Bereich der Quantenpunkte (NV) und/oder der Kernquantenpunkte (CI) aus ²⁸Si-Siliziumisotopen. Bevorzugt besteht beispielsweise ein Siliziumkarbidkristall in dem betreffenden Bereich der Quantenpunkte (NV) und/oder der Kernquantenpunkte (CI) aus ¹²C-Kohlenstoffisotopen und ²⁸Si-Siliziumisotopen und stellt somit bevorzugt die stöchiometrische Isotopenformel ²⁸Si¹²C dar. Bevorzugt weist der betreffende Diamantkristall bzw. der betreffende Siliziumkristall bzw. der betreffende Siliziumkarbidkristall im Bereich des Quantenpunkts (NV) keine weiteren Störungen auf. Bei dem Quantenpunkt handelt es sich im Falle eines Diamantkristalls als Substrat (D) bevorzugt um ein NV-Zentrum (NV). Bei dem Quantenpunkt handelt es sich im Falle eines Siliziumkristalls bevorzugt um ein G-Zentrum (NV). Bei dem Quantenpunkt handelt es sich im Falle eines Siliziumkarbidkristalls bevorzugt um ein V-Zentrum (NV). Andere Zentren, wie beispielsweise ein SiV-Zentrum und/oder ein ST1-Zentrum oder andere geeignete paramagnetische Störstellen können auch als Quantenpunkt (NV) in Diamant verwendet werden. Andere Zentren als G-Zentren und geeignete paramagnetische Störstellen in Silizium können auch als Quantenpunkt (NV) in Silizium verwendet werden. Andere Zentren als V-Zentren und geeignete paramagnetische Störstellen in Siliziumkarbid können auch als Quantenpunkt (NV) in Siliziumkarbid verwendet werden. Wird Silizium als Substrat (D) verwendet, so kommen beispielsweise auch Phosphor-Atome als Quantenpunkte (NV) in Frage.

Um weniger geeignete Materialien doch für das Substrat (D) verwenden zu können, beispielsweise übliche Standard Silizium-Wafer für die CMOS Wafer-Produktion, die Siliziumatome mit magnetischen Momenten aufweisen, wird bevorzugt, aber nicht notwendigerweise die epitaktische Schicht (DEPI) auf dem Substrat (D) beispielsweise mittels CVD-Abscheidung aufgebracht. Bevorzugt ist diese epitaktische Schicht (DEPI) isotopenrein und/oder frei von Isotopen mit magnetischen Momenten, wenn man von Isotopen absieht, die die später erläuterten Kernquantenpunkte (CI) bilden. Bevorzugt ist im Falle eines Siliziumkristalls als Substrat (D) diese epitaktische Schicht (DEPI) isotopenrein und/oder frei von magnetischen Kernmomenten beispielsweise aus ²⁸Si-Siliziumisotopen gefertigt. Bevorzugt ist im Falle eines Diamantkristalls als Substrat (D) diese epitaktische Schicht (DEPI) isotopenrein und/oder frei von magnetischen Kernmomenten beispielsweise aus ¹²C-Kohlenstoffisotopen gefertigt. Bevorzugt ist im Falle eines Siliziumkarbidkristalls als Substrat (D) diese epitaktische Schicht (DEPI) isotopenrein und/oder frei von magnetischen Kernmomenten beispielsweise aus ²⁸Si-Siliziumisotopen und ¹²C-Kohlenstoffisotopen gefertigt.

### Vorrichtung zur Manipulation des Quantenpunkts

Entscheidend ist nun die Kombination mit einer Vorrichtung, die zur Erzeugung eines zirkular polarisierten elektromagnetischen Strahlungsfeldes, insbesondere eines zirkular polarisierten Mikrowellenfeldes (B_{MW}), am Ort des Quantenpunkts (NV) geeignet ist. Im Stand der Technik werden hierzu in der Regel makroskopische Spulen eingesetzt. Diese Technik hat den Vorteil, dass das Feld einer Helmholzspule sehr gut berechnet werden kann und sehr homogen ist. Der Nachteil einer solchen Technik ist jedoch, dass das zirkularpolarisierte elektromagnetisch Wellenfeld mehrere, typischerweise im Vergleich zur Wellenlänge des zirkularpolarisierten Wellenfeldes dicht beieinanderliegende Quantenpunkte (NV) beeinflusst. Im Stand der Technik beeinflussen diese Einrichtungen, die typischerweise zur Einstrahlung einer Mikrowellenstrahlung in den Quantenpunkt benutzt werden, in der Regel gleich alle Quantenpunkte der Vorrichtung in gleicher Weise. Dies wird bei dem hier vorgelegten Vorschlag vermieden. Hier werden die Quantenpunkte im Nahfeld einer oder mehrerer elektrischen Leitungen (LH, LV) platziert.

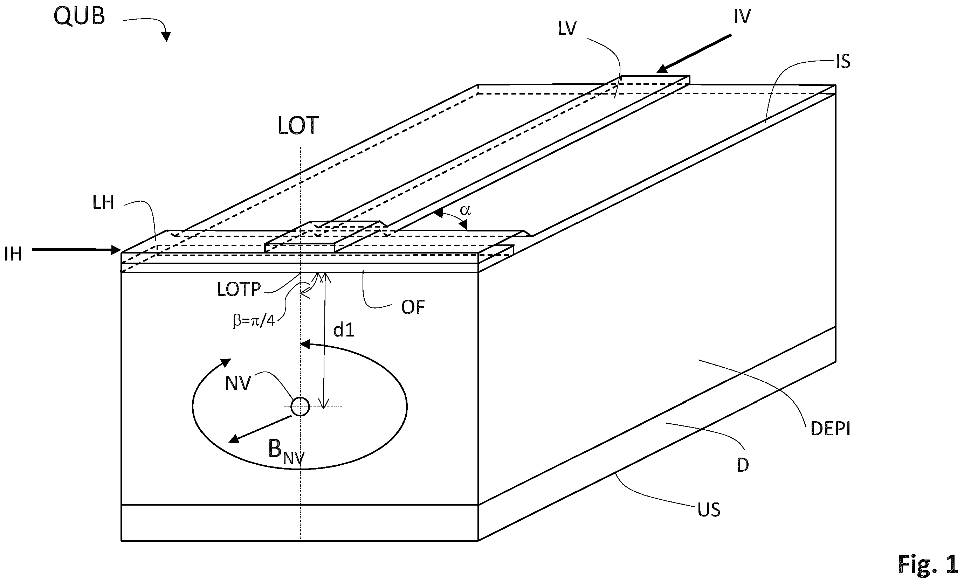

Eine solche Vorrichtung ist in Figur 1 dargestellt.

Das Substrat (D) und/oder die ggf. vorhandene epitaktische Schicht (DEPI) weisen eine Oberfläche (OF) auf. Im Sinne dieser Offenlegung liegen Leitungen (LH, LV) und deren Isolationsschichten (IS) in der Regel oberhalb der Oberfläche (OF).

Der Quantenpunkt (NV) ist, wie beschrieben, bevorzugt ein paramagnetisches Zentrum (NV) als Quantenpunkt (NV) in dem Substrat (D) und/oder in der ggf. vorhandenen epitaktischen Schicht (DEPI) platziert. Bevorzugt handelt es sich bei dem Substrat (D) um Diamant und bei dem Quantenpunkt (NV) und ein NV-Zentrum oder ein ST1-Zentrum oder ein L2-Zentrum oder bevorzugt um Silizium und bei dem Quantenpunkt (NV) um ein G-Zentrum oder bevorzugt um Siliziumkarbid und bei dem Quantenpunkt (NV) um ein V-Zentrum.

Für die Beschreibung der Geometrie ist es notwendig, den Abstand (d1) zwischen dem Quantenpunkt (NV) und der Oberfläche (OF) und den dort befindlichen Vorrichtungen zum Manipulieren und Verschränken des Quantenpunkts (NV) mit anderen Quantenobjekten präzise beschreiben zu können.

Zu diesem Zweck wird ein gedachtes Lot längs einer gedachten Lot-Linie (LOT) vom Ort des Quantenpunkts (NV) zur Oberfläche (OF) des Substrats (D) und/oder zur Oberfläche (OF) der ggf. vorhandenen epitaktischen Schicht (DEPI) eingeführt, das längs dieser gedachten Lot-Linie (LOT) gefällt werden kann. Die gedachte Lot-Linie (LOT) durchstößt dann virtuell die Oberfläche (OF) des Substrats (D) und/oder der ggf. vorhandenen epitaktischen Schicht (DEPI) an einem Lotpunkt (LOTP).

Die Vorrichtung, die zur Erzeugung eines zirkular polarisierten elektromagnetischen Wellenfeldes, insbesondere eines zirkular polarisierten Mikrowellenfeldes (B_{MW}), geeignet ist, befindet sich dann bevorzugt auf der Oberfläche des Substrats (D) und/oder der ggf. vorhandenen epitaktischen Schicht (DEPI) und zwar in der Nähe des Lot-Punktes (LOTP) oder am Lot-Punkt (LOTP). Hierbei bedeutet Nähe, dass die Vorrichtung so nahe am Quantenpunkt (NV) platziert ist, dass diese den Quantenpunkt (NV) bestimmungsgemäß so beeinflussen kann, dass die quantenmechanischen Operationen in endlicher Zeit möglich sind, so dass genügend Operationen durchgeführt werden können, bevor die Kohärenz versagt. Bevorzugt befindet sich die Vorrichtung also genau über dem Quantenpunkt (NV) auf der Oberfläche (OF) am Lot-Punkt (LOTP).

Ein zweites Merkmal betrifft nun die konkrete Ausgestaltung dieser Vorrichtung, die zur Erzeugung eines zirkular polarisierten elektromagnetischen Wellenfeldes, insbesondere eines zirkular polarisierten Mikrowellenfeldes (B_{MW}), geeignet ist. Es wird vorgeschlagen, die Vorrichtung in Form einer horizontalen Leitung (LH) und einer vertikalen Leitung (LV) zu realisieren. Hierbei sollen die Begriffe "horizontal" und "vertikal" eher als Teil eines Namens für bestimmte Begrifflichkeiten verstanden werden. Später werden zugehörige horizontale und vertikale Ströme eingeführt, die diesen Leitungen zugeordnet sind.

Die horizontale Leitung (LH) und die vertikale Leitung (LV) befinden sich nun, da sie ja die besagte Vorrichtung darstellen, auf der Oberfläche (OF) des Substrats (D) und/oder auf der Oberfläche (OF) der ggf. vorhandenen epitaktischen Schicht (DEPI). Die horizontale Leitung (LH) und die vertikale Leitung (LV) kreuzen sich in der Nähe des Lot-Punktes (LOTP) oder am Lot-Punkt (LOTP) in einem von null verschiedenen Kreuzungswinkel (α). Bevorzugt ist der Kreuzungswinkel (α) ein rechter Winkel von 90° bzw. π/2. Die horizontale Leitung (LH) und die vertikale Leitung (LV) besitzen bevorzugt einen Winkel von 45° gegenüber der Achse der des Quantenpunkts (NV) um die Magnetfeldlinien der horizontalen Leitung und der vertikalen Leitung (LV) zu addieren.

### Beispielhafte Ausrichtung des Kristalls des Substrats (D)

Im Falle der Verwendung von Diamant als Substrat (D) und eines NV-Zentrums als Quantenpunkt (NV) werden bevorzugt (111), (100) oder (113) Diamanten verwendet. Zu diesen kristallografischen Oberflächennormalenrichtungen sind die Richtungen des NV-Zentrums 53° geneigt.

Im Falle der Verwendung von Silizium als Substrat (D) und eines G-Zentrums als Quantenpunkt (NV) werden bevorzugt (111), (100) oder (113) Siliziumkristalle verwendet. Zu diesen kristallografischen Oberflächennormalenrichtungen sind die Richtungen des G-Zentrums um einen Winkel geneigt.

Im Falle der Verwendung von Siliziumkarbid als Substrat (D) und eines V-Zentrums als Quantenpunkt (NV) werden bevorzugt (111), (100) oder (113) Siliziumkarbidkristalle verwendet. Zu diesen kristallografischen Oberflächennormalenrichtungen sind die Richtungen des V-Zentrums um einen Winkel geneigt.

### Leitungsisolation

Es ist sinnvoll, dass die horizontale Leitung (LH) gegenüber der vertikalen Leitung (LV) beispielsweise durch eine elektrische Isolierung elektrisch isoliert ist. Bevorzugt ist die horizontale Leitung (LH) von der vertikalen Leitung (LV) mittels einer elektrischen Isolation (IS) elektrisch isoliert. Es ist des Weiteren sinnvoll, dass die horizontale Leitung (LH) gegenüber dem Substrat (D) beispielsweise durch eine weitere Isolierung elektrisch isoliert ist. Es ist somit typischerweise auch sinnvoll, dass die vertikale Leitung (LV) gegenüber dem Substrat (D) beispielsweise durch eine weitere Isolierung elektrisch isoliert ist. Dabei können zwei Isolierungen bevorzugt auch die Isolationsfunktion einer der drei vorgenannten Isolierungen erfüllen.

### Rückseitenkontakt

Bevorzugt ist das Substrat (D) mit einem optionalen Rückseitenkontakt (BSC) elektrisch mit einem definierten Potenzial verbunden. Der Rückseitenkontakt (BSC) befindet sich bevorzugt auf der Oberfläche des Substrats (D), die der Oberfläche (OF) mit der horizontalen Leitung (LH) und der vertikalen Leitung (LV) gegenüberliegt. Über den Rückseitenkontakt (BSC) kann der im Folgenden erwähnte Fotostrom (Iₚₕ) alternativ oder parallel zu den im Folgenden erwähnten Kontakten der im Folgenden erwähnten Abschirmleitungen (SH1, SH2, SH3, SH4, SV1, SV2) ausgelesen und einer Bewertung durch die im Folgenden erwähnte Steuervorrichtung (µC) und der dieser zugeordneten Messmittel zugeführt werden.

### Grünes Licht als Anregungsstrahlung

In den im Folgenden beschriebenen Betriebsverfahren wird "grünes Licht" zum Zurücksetzen der Quantenpunkte (NV) verwendet. Der Begriff "grünes Licht" ist hier funktional zu verstehen. Werden andere Störstellenzentren als NV-Zentren in Diamant, beispielsweise G-Zentren in Silizium oder V-Zentren in Siliziumkarbid, verwendet, so kann Licht bzw. elektromagnetische Strahlung anderer Wellenlängen verwendet werden, dass dann hier aber auch als "grünes Licht" bezeichnet wird. Damit dieses grüne Licht die Quantenpunkte (NV) erreichen kann, sollte die Struktur der horizontalen Leitung (LH) und der vertikalen Leitung (LV) ein Passieren des grünen Lichts in Richtung auf den jeweiligen Quantenpunkt (NV) zulassen. Alternativ ist ein Zuführen des "grünen Lichts" von der Rückseite des Substrats (D) denkbar, sodass das "grüne Licht" die horizontale Leitung (LH) und die vertikale Leitung (LV) nicht passieren muss.

**Tabelle der Wellenlängen der ZPL und beispielhafter Wellenlängen der Anregungsstrahlung**

| Die Tabelle ist nur eine beispielhafte Zusammenstellung einiger möglicher paramagnetischer Zentren. Die funktionaläquivalente Nutzung anderer Paramagnetischer Zentren in anderen Materialien ist ausdrücklich möglich. Die Wellenlängen der Anregungsstrahlung sind ebenfalls beispielhaft. Andere Wellenlängen sind in der Regel möglich, wenn sie kürzer als die Wellenlänge der anzuregenden ZPL sind. | | | | |
|---|---|---|---|---|
| Material | Störstellenzentrum | ZPL | beispielhafte Wellenlänge für "grünes Licht" als Anregungsstrahlung im Sinne dieser Schrift | Referenz |
| Diamant | NV-Zentrum | | 520nm, 532nm | |
| Diamant | SiV-Zentrum | 738 nm | 685 nm | /2/, /3/, /4/ |
| Diamant | GeV-Zentrum | 602 nm | 532 nm | /4/, /5/ |
| Diamant | SnV-Zentrum | 620 nm | 532 nm | /4/, /6/ |
| Diamant | PbV-Zentrum | 520 nm, | 450 nm | /4/, /7/ |
| | | 552 nm | | /4/, /7/ |
| | | 715 nm | 532 nm | /7/ |
| Silizium | G-Zentrum | 1278,38 nm | 637 nm | /8/ |
| Siliziumkarbid | V_{SI}-Zentrum | 862 nm(V1) 4H, | 730 nm | /1/, /9/, /10/ |
| | | 858,2 nm(V1') 4H | 730 nm | /1/, /9/, /10/ |
| | | 917 nm(V2) 4H, | 730 nm | /1/, /9/, /10/ |
| | | 865 nm(V1) 6H, | 730 nm | /1/, /9/, /10/ |
| | | 887 nm(V2) 6H, | 730 nm | /1/, /9/, /10/ |
| | | 907 nm(V3) 6H | 730 nm | /1/, /9/, /10/ |
| Siliziumkarbid | DV-Zentrum | 1078-1132 nm 6H | 730 nm | /9/ |
| Siliziumkarbid | V_{C}V_{SI}-Zentrum | 1093-1140 nm 6H | 730 nm | /9/ |
| Siliziumkarbid | CAV-Zentrum | 648.7 nm 4H, 6H, 3C | 730 nm | /9/ |
| | | 651.8 nm 4H, 6H, 3C | 730 nm | /9/ |
| | | 665.1 nm 4H, 6H, 3C | 730 nm | /9/ |
| | | 668.5 nm 4H, 6H, 3C | 730 nm | /9/ |
| | | 671.7 nm 4H, 6H, 3C | 730 nm | /9/ |
| | | 673 nm 4H, 6H, 3C | 730 nm | /9/ |
| | | 675.2 nm 4H, 6H, 3C | 730 nm | /9/ |
| | | 676.5 nm 4H, 6H, 3C | 730 nm | /9/ |
| Siliziumkarbid | N_{C}V_{SI}-Zentrum | 1180 nm-1242 nm 6H | 730 nm | /9/, /13/, /14/ |

### Liste der Referenzliteratur zu obiger Tabelle

/1/ Marina Radulaski, Matthias Widmann, Matthias Niethammer, Jingyuan Linda Zhang, Sang-Yun Lee, Torsten Rendler, Konstantinos G. Lagoudakis, Nguyen Tien Son, Erik Janzén, Takeshi Ohshima, Jörg Wrachtrup, Jelena Vučković, "Scalable Quantum Photonics with Single Color Centers in Silicon Carbide", Nano Letters 17 (3), 1782-1786 (2017), DOI: 10.1021/acs.nanolett.6b05102, arXiv:1612.02874
/2/ C. Wang, C. Kurtsiefer, H. Weinfurter, and B. Burchard, "Single photon emissionfrom SiV centres in diamond produced by ion implantation" J. Phys. B: At. Mol.Opt. Phys., 39(37), 2006
/3/ Björn Tegetmeyer, "Luminescence properties of SiV-centers in diamond diodes" Promotionsschrift, Universität Freiburg, 30.01.2018
/4/ Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992
/5/ Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph] 25 May 2020
/6/ Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph]
/7/ Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
/8/ M. Hollenbach, Y. Berencén, U. Kentsch, M. Helm, G. V. Astakhov "Engineering telecom singlephoton emitters in silicon for scalable quantum photonics" Opt. Express 28, 26111 (2020), DOI: 10.1364/OE.397377, arXiv:2008.09425 [physics.app-ph]
/9/ Castelletto and Alberto Boretti, "Silicon carbide color centers for quantum applications" 2020 J. Phys. Photonics2 022001
/10/ V. Ivády, J. Davidsson, N. T. Son, T. Ohshima, I. A. Abrikosov, A. Gali, "Identification of Si-vacancy related room-temperature qubits in 4H silicon carbide", Phys. Rev.B, 2017, 96,161114
/11/ J. Davidsson, V. Ivády, R. Armiento, N. T. Son, A. Gali, I. A. Abrikosov, "First principles predictions of magneto-optical data for semiconductor point defect identification: the case of divacancy defects in 4H-SiC", New J. Phys., 2018, 20, 023035
/12/ J. Davidsson, V. Ivády, R. Armiento, T. Ohshima, N. T. Son, A. Gali, I. A. Abrikosov "Identification of divacancy and silicon vacancy qubits in 6H-SiC", Appl. Phys. Lett. 2019, 114, 112107
/13/ S. A. Zargaleh, S. Hameau, B. Eble, F. Margaillan, H. J. von Bardeleben, J. L. Cantin, W. Gao , "Nitrogen vacancy center in cubic silicon carbide: a promising qubit in the 1.5µm spectral range for photonic quantum networks" Phys. Rev.B, 2018, 98, 165203
/14/ S. A. Zargaleh et al "Evidence for near-infrared photoluminescence of nitrogen vacancy centers in 4H-SiC" Phys. Rev.B, 2016, 94, 060102

### Transparenz der Ansteuerleitungen

Eine weitere einfache Möglichkeit ist es, wenn die horizontale Leitung (LH) und/oder die vertikale Leitung (LV) für "grünes Licht" transparent sind. Hierzu umfassen insbesondere die horizontale Leitung (LH) und/oder die vertikale Leitung (LV) bevorzugt ein elektrisch leitendes und optisch für grünes Licht transparentes Material. Insbesondere ist die Verwendung von Indium-Zinn-Oxid (gebräuchliche Abkürzung ITO) zu empfehlen. Hierbei ist es wichtig, dass der Abstand zwischen dem Quantenpunkt (NV) bzw. dem später beschriebenen Kernquantenpunkt (CI) und dem Material der Leitungen (LH, LV) größer ist als der maximale Wechselwirkungsabstand zwischen magnetischen Kernmomenten der Isotope des Materials der Leitungen (LH, LV) und dem Quantenpunkt (NV). Es ist nämlich leider so, dass sowohl Indium (IN) als auch Zinn (Sn) keine natürlichen stabilen Isotope ohne magnetisches Kernmoment aufweisen. Ein geeigneter Abstand kann beispielsweise durch eine ausreichend dicke Silizium Dioxid-Schicht aus ²⁸Si-Isotopen und ¹⁶O-Isotopen als Isolation zwischen den Leitungen (LH, LV) einerseits und dem Substrat (D) andererseits hergestellt werden, deren Atomkerne kein magnetisches Kernmoment aufweisen.

Darüber hinaus ist es denkbar, dass die horizontale Leitung (LH) und/oder die vertikale Leitung (LV) aus Material gefertigt werden, dass bei unterschreiten einer kritischen Temperatur, der Sprungtemperatur (T_{c}) supraleitend wird. Typischerweise sind Supraleiter nicht transparent. Sofern das Licht von der Oberseite zugeführt werden soll können statt der Verwendung von ITO in der horizontalen Leitung (LH) und/oder der vertikalen Leitung (LV) auch Öffnungen vorgesehen werden, um das Licht passieren zu lassen. Aufgrund der kleinen Dimensionen ist dies aber nur sehr eingeschränkt möglich. Auch ist es denkbar, die horizontale Leitung (LH) und/oder die vertikale Leitung (LV) als abschnittsweise zusammengesetzt aus mehreren, parallelgeführten Leitungen zu fertigen. Die Einführung von Öffnungen und/oder das Parallelführen mehrerer Leitungen ist bei Verwendung von Supraleitern für die Herstellung der horizontalen Leitung (LH) und/oder der vertikalen Leitung (LV) insbesondere deswegen wichtig, um ein sogenanntes Pinning zu verhindern. Dies dient dazu, ein Einfrieren von Flussquanten zu verhindern und damit ein komplettes magnetisches Zurücksetzen zu ermöglichen.

Wie bereits beschrieben, weist das vorgeschlagene Quantenbit (QUB) eine Oberfläche (OF) mit der horizontalen Leitung (LH) und mit der vertikalen Leitung (LV) auf. Ebenso weist das vorgeschlagene Quantenbit (QUB) eine der Oberfläche (OF) gegenüberliegende Unterseite (US) auf. Eine weitere Möglichkeit, den Lichtzugang zum Quantenpunkt (NV) des Quantenbits (QUB) zu gewährleisten ist, das Quantenbit (QUB) so zu montieren, dass die Unterseite (US) des Quantenbits (QUB) mit "grünem Licht" so bestahlt werden kann, dass das "grüne Licht" den Quantenpunkt (NV) erreichen und beeinflussen kann. Hierfür ist die Transparenz des Materials des Substrats (D) für die Pumpstrahlungswellenlänge des "grünen Lichts" natürlich Voraussetzung. Ggf. muss das Substrat (D) an soweit zumindest lokal z.B. durch Politur und/oder nasschemisches Ätzen und/oder Plasmaätzen abgedünnt werden, dass die Gesamtdämpfung des "grünen Lichts" bei Eintritt von der der Oberfläche (OF) gegenüberliegenden Oberfläche bis zum Quantenpunkt (NV) ausreichend gering ist.

In den hier diskutierten Beispielen wird bevorzugt auf Substrate (D) aus Diamant und Silizium und Siliziumkarbid als drei Beispielen eingegangen, was bereits eine bevorzugte Klasse von Quantenpunkttypen festlegt. Des Weiteren wird angenommen, dass ein Quantenpunkt (NV) bevorzugt ein paramagnetisches Zentrum (NV) ist. Auch wird angenommen, dass das Substrat (D) entsprechend dem jeweiligen Beispiel Diamant bzw. Silizium bzw. Siliziumkarbid umfasst und ein Quantenpunkt (NV) ein im Falle von beispielhaftem Diamant beispielhaft ein NV-Zentrum ist bzw. im Falle von beispielhaftem Silizium beispielhaft ein G-Zentrum ist bzw. im Falle von beispielhaftem Siliziumkarbid beispielhaft ein V-Zentrum ist. Die Erfindung ist aber auf diese drei Beispiele nicht beschränkt. In dieser Schrift wird für den Begriff Quantenpunt (NV) und den Begriff paramagnetisches Zentrum (NV) und den Begriff NV-Zentrum (NV) bzw. G-Zentrum bzw. V-Zentrum stets das gleiche Bezugszeichen (NV) der Obermenge Quantenpunkt (NV) verwendet. Wie oben bereits beschrieben, können andere Substrate (D) aus anderen Materialien mit anderen paramagnetischen Zentren verwendet werden, die somit wiederum andere Quantenobjekttypen definieren. Auch können andere Störstellenzentren in Silizium bzw. Siliziumkarbid bzw. Diamant verwendet werden, die wiederum andere Quantenobjekttypen definieren. Die Wellenlängen und Frequenzen müssen dann ggf. angepasst werden. Hier wird beispielhaft bevorzugt ein System mit NV-Zentren in Diamant als Repräsentant der anderen möglichen Kombinationen aus Materialien des Substrats (D) oder der epitaktischen Schicht (DEPI) einerseits und paramagnetischen Störstellen in diesen Materialien andererseits beschrieben.

Stattdessen ist es somit auch denkbar, dass das Substrat (D) Silizium umfasst und ein Quantenpunkt (NV) ein G-Zentrum oder ein anderes geeignetes Störstellenzentrum ist.

Stattdessen ist es somit auch denkbar, dass das Substrat (D) Siliziumkarbid umfasst und ein Quantenpunkt (NV) ein V-Zentrum oder ein anderes geeignetes Störstellenzentrum ist.

Stattdessen ist es somit auch denkbar, dass das Substrat (D) Diamant umfasst und ein Quantenpunkt (NV) ein SiV-Zentrum oder ein ST1-Zentrum oder ein L2-Zentrum oder ein anderes geeignetes Störstellenzentrum ist.

Allgemein kommen andere Störstellenzentren und Störstellen und Gitterfehler in Diamant somit auch in Frage. Verschiedene Ergebnisse deuten darauf hin, dass, wenn das Substrat (D) Diamant umfasst, der der Quantenpunkt (NV) bevorzugt eine Fehlstelle (Englisch Vacancy) umfassen sollte. Entsprechend sollte ein Quantenpunkt (NV) in Diamant als beispielhaftes Substrat (D) beispielsweise dann ein Si-Atom oder ein Ge-Atom oder ein N-Atom oder ein P-Atom oder ein As-Atom oder ein Sb-Atom oder ein Bi-Atom oder ein Sn-Atom oder ein Mn-Atom oder ein F-Atom oder ein anderes Atom, das in dem beispielhaften Diamant ein Störstellenzentrum mit einem paramagnetischen Verhalten erzeugt, umfassen.

Entsprechend sollte der Quantenpunkt (NV) in Silizium als Substrat (D) beispielsweise dann ein Si-Atom auf einem Zwischengitterplatz und/oder ein C-Atom auf einem Zwischengitterplatz oder als ein Siliziumatom substituierendes Atom aufweisen, das in dem beispielhaften Siliziumkristall ein Störstellenzentrum mit einem paramagnetischen Verhalten erzeugt. Auf die Schrift D. D. Berhanuddin, " Generation and characterisation of the carbon G-centre in silicon", PhD-thesis URN: 1456601S, University of Surrey, März 2015 wird hingewiesen.

Entsprechend sollte der Quantenpunkt (NV) in Siliziumkarbid als Substrat (D) beispielsweise dann ein VSi-Zentrum oder ein anderes Störstellenzentrum mit einem paramagnetischen Verhalten aufweisen.

Später werden in dieser Offenlegung noch Kernquantenbits (CQUB) mit Kernquantenpunkten (CI) beschrieben.

Um im Falle der Verwendung von NV-Zentren in Diamant als Quantenpunkte (NV) diese Kernquantenbits (CQUB) mit Kernquantenpunkten (CI) zusammen mit einem NV-Zentrum (NV) in Diamant als Substrat (D) zu fertigen, ist es sinnvoll, wenn der betreffende Quantenpunkt (NV) ein NV-Zentrum mit einem ¹⁵N Isotop als Stickstoffatom oder mit einem ¹⁴N Isotop als Stickstoffatom ist. Dabei wird die Verwendung eines ¹⁵N Isotops besonders bevorzugt. Auch ist es denkbar, isotopenreine ¹²C-Diamanten zu verwenden und in der Nähe, also im Wirkungsbereich des Quantenpunkts (NV) ein oder mehrere ¹³C-Kohlenstoff-Isotope zu implantieren oder abzuscheiden oder zu platzieren. Ganz besonderes bevorzugt werden 10-100 dieser ¹³C-Isotope dort platziert. Nähe ist hier so zu verstehen ist, dass das Magnetfeld des Kernspins des einen oder der mehreren¹³C-Atome den Spin einer Elektronenkonfiguration des Quantenpunkts (NV) beeinflussen können und dass der Spin der Elektronenkonfiguration des Quantenpunkts (NV) den Kernspin eines oder mehrerer dieser ¹³C-Isotope beeinflussen kann. Damit wird ein Kern-Elektron-Quantenregister (CEQUREG) in Diamant möglich.

Um im Falle der Verwendung von G-Zentren in Silizium als Quantenpunkte (NV) diese Kernquantenbits (CQUB) mit Kernquantenpunkten (CI) zusammen mit einem G-Zentrum (NV) in Silizium als Substrat (D) zu fertigen, ist es sinnvoll, wenn der betreffende Quantenpunkt (NV) ein G-Zentrum mit einem oder zwei ¹³C Isotopen als Kohlenstoffatome und/oder mit einem ²⁹Si Isotop als Siliziumatom im Einwirkungsbereich des G-Zentrums als Quantenpunkt (NV) ist. Dabei wird die Verwendung eines ¹³C Isotops besonders bevorzugt. Auch ist es denkbar, isotopenreine ²⁸Si-Wafer bzw. epitaktische, isotopenreine ²⁸Si-Schichten (DEPI) zu verwenden und in der Nähe, also im Wirkungsbereich des Quantenpunkts (NV) ein oder mehrere ²⁹Si-Silizium-Isotope zu implantieren oder abzuscheiden oder zu platzieren. Ganz besonderes bevorzugt werden 10-100 dieser ²⁹Si-Isotope dort platziert. Nähe ist hier so zu verstehen ist, dass das Magnetfeld des Kernspins des einen oder der mehreren²⁹Si-Atome den Spin einer Elektronenkonfiguration des Quantenpunkts (NV) beeinflussen können und dass der Spin der Elektronenkonfiguration des Quantenpunkts (NV) den Kernspin eines oder mehrerer dieser ²⁹Si-Isotope beeinflussen kann. Damit wird ein Kern-Elektron-Quantenregister (CEQUREG) in Silizium möglich.

Um im Falle der Verwendung von V-Zentren in Siliziumkarbid als Quantenpunkte (NV) diese Kernquantenbits (CQUB) mit Kernquantenpunkten (CI) zusammen mit einem V-Zentrum (NV) in Siliziumkarbid als Substrat (D) zu fertigen, ist es sinnvoll, wenn der betreffende Quantenpunkt (NV) ein V-Zentrum mit einem oder mehreren ¹³C Isotopen als Kohlenstoffatome und/oder mit einem oder mehreren ²⁹Si Isotopen als Siliziumatomen im Einwirkungsbereich des V-Zentrums als Quantenpunkt (NV) ist. Dabei wird die Verwendung eines ¹³C Isotops und/oder eines ²⁹C Isotops besonders bevorzugt. Auch ist es denkbar, isotopenreine ²⁸Si¹²C-Siliziumkarbid-Wafer bzw. epitaktische, isotopenreine ²⁸Si¹²C-Schichten (DEPI) zu verwenden und in der Nähe, also im Wirkungsbereich des Quantenpunkts (NV) ein oder mehrere ²⁹Si-Siliziumisotope und/oder ¹³C-Kohlenstoffisotope zu implantieren oder abzuscheiden oder zu platzieren. Ganz besonderes bevorzugt werden 10-100 dieser ²⁹Si-Siliziumisotope und/oder ¹³C-Kohlenstoffisotope dort platziert. Nähe ist hier so zu verstehen ist, dass das Magnetfeld des Kernspins des einen oder der mehreren²⁹Si-Atome bzw. ¹³C-Atome den Spin einer Elektronenkonfiguration des Quantenpunkts (NV) beeinflussen können und dass der Spin der Elektronenkonfiguration des Quantenpunkts (NV) den Kernspin eines oder mehrerer dieser ²⁹Si-Siliziumisotope und/oder ¹³C-Kohlenstoffisotope beeinflussen kann. Damit wird ein Kern-Elektron-Quantenregister (CEQUREG) in Siliziumkarbid möglich. Auf die Schrift Stefania Castelletto and Alberto Boretti, "Silicon carbide color centers for quantum applications" 2020 J. Phys. Photonics2 022001 wird hier hingewiesen, in der weitere mögliche Störstellenzentren genannt werden. Werden andere Elemente zur Erzeugung der Störstellenzentren genutzt, so können Isotope dieser Elemente mit einem magnetischen Moment für die Herstellung der Kernquantenpunkte in analoger Weise verwendet werden.

Ganz allgemein kann somit ein Quantenbit (QUB) auf Diamantbasis definiert werden, bei dem der Quantenpunkttyp des Quantenbits (QUB) dadurch gekennzeichnet ist, dass das Substrat (D) ein Diamant-Material umfasst und ein oder mehrere Isotope mit einem Kernspin in der Nähe des Quantenpunkts (NV) angeordnet sind. Hierbei ist Nähe dann wieder so zu verstehen ist, dass das Magnetfeld des Kernspins des einen oder der mehreren Isotope den Spin einer Elektronenkonfiguration des Quantenpunkts (NV) beeinflussen können und dass der Spin der Elektronenkonfiguration des Quantenpunkts (NV) den Kernspin eines oder mehrerer dieser Isotope beeinflussen kann.

Ganz allgemein kann somit in analoger Weise ein Quantenbit (QUB) auf Siliziumbasis definiert werden, bei dem der Quantenpunkttyp des Quantenbits (QUB) dadurch gekennzeichnet ist, dass das Substrat (D) ein Silizium-Material umfasst und ein oder mehrere Isotope mit einem Kernspin in der Nähe des Quantenpunkts (NV) angeordnet sind. Hierbei ist Nähe dann wieder so zu verstehen ist, dass das Magnetfeld des Kernspins des einen oder der mehreren Isotope den Spin einer Elektronenkonfiguration des Quantenpunkts (NV) beeinflussen können und dass der Spin der Elektronenkonfiguration des Quantenpunkts (NV) den Kernspin eines oder mehrerer dieser Isotope beeinflussen kann.

Ebenso kann dann ganz allgemein kann somit in analoger Weise ein Quantenbit (QUB) auf Siliziumkarbidbasis definiert werden, bei dem der Quantenpunkttyp des Quantenbits (QUB) dadurch gekennzeichnet ist, dass das Substrat (D) ein Siliziumkarbid-Material umfasst und ein oder mehrere Isotope mit einem Kernspin in der Nähe des Quantenpunkts (NV) angeordnet sind. Hierbei ist Nähe dann wieder so zu verstehen ist, dass das Magnetfeld des Kernspins des einen oder der mehreren Isotope den Spin einer Elektronenkonfiguration des Quantenpunkts (NV) beeinflussen können und dass der Spin der Elektronenkonfiguration des Quantenpunkts (NV) den Kernspin eines oder mehrerer dieser Isotope beeinflussen kann.

Da isotopenreine Diamanten extrem teuer sind, ist es sinnvoll, wenn der Quantenpunkttyp des Quantenpunkts (NV) des Quantenbits (QUB) dadurch gekennzeichnet ist, dass das Substrat (D) ein Diamant-Material umfasst und dass das Diamant-Material eine epitaktisch aufgewachsene isotopenreine Schicht (DEPI) im Wesentlichen aus ¹²C-Isotopen umfasst. Diese kann beispielsweise mittels CVD und anderen Abscheidemethoden auf der ursprünglichen Oberfläche eines als Substrat (D) verwendeten Silizium-Wafers abgeschieden werden. Im Wesentlichen bedeutet dabei, dass der Gesamtanteil K_{1G}' der C-Isotope mit magnetischen Moment, die Bestandteil des Substrats (D) sind, bezogen auf 100% der C-Atome, die Bestandteil des Substrats (D) sind, gegenüber den in den obigen Tabellen angegebenen natürlichen Gesamtanteil K_{1G} auf einen Anteil K_{1G}' der C-Isotope mit magnetischen Moment, die Bestandteil des Substrats (D) sind, bezogen auf 100% der C-Isotope, die Bestandteil des Substrats (D) sind, herabgesetzt ist. Dabei ist bevorzugt dieser Anteil K_{1G}' kleiner als 50%, besser kleiner als 20%, besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für C-Isotope mit magnetischen Moment an den C-Isotopen des Substrats (D) im Einwirkungsbereich der als Quantenpunkte (NV) benutzten paramagnetischen Störstellen (NV) und/oder der als Kernquantenpunkten (CI) benutzten nuklearen Spins. Bei der Bestimmung des Anteil K_{1G}' werden die C-Atome mit magnetischem Moment der Kernquantenpunkte (CI) nicht berücksichtigt, da deren magnetisches Moment ja beabsichtigt und nicht parasitär ist.

Da isotopenreine Silizium-Wafer extrem teuer sind, ist es sinnvoll, wenn der Quantenpunkttyp des Quantenpunkts (NV) des Quantenbits (QUB) dadurch gekennzeichnet ist, dass das Substrat (D) ein Silizium-Material umfasst und dass das Silizium-Material eine epitaktisch aufgewachsene isotopenreine Schicht (DEPI) im Wesentlichen aus ²⁸Si-Isotopen umfasst. Diese kann beispielsweise mittels CVD und anderen Abscheidemethoden auf der ursprünglichen Oberfläche eines als Substrat (D) verwendeten Silizium-Wafers abgeschieden werden. Im Wesentlichen bedeutet dabei, dass der Gesamtanteil K_{1G}' der Si-Isotope mit magnetischen Moment, die Bestandteil des Substrats (D) sind, bezogen aus 100% der Si-Atome, die Bestandteil des Substrats (D) sind, gegenüber den in den obigen Tabellen angegebenen natürlichen Gesamtanteil K_{1G} auf einen Anteil K_{1G}' der Si-Isotope mit magnetischen Moment, die Bestandteil des Substrats (D) sind, bezogen auf 100% der Si-Isotope, die Bestandteil des Substrats (D) sind, herabgesetzt ist. Dabei ist bevorzugt dieser Anteil K_{1G}' kleiner als 50%, besser kleiner als 20%, besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für Si-Isotope mit magnetischen Moment an den Si-Isotopen des Substrats (D) im Einwirkungsbereich der als Quantenpunkte (NV) benutzten paramagnetischen Störstellen (NV) und/oder der als Kernquantenpunkten (CI) benutzten nuklearen Spins. Bei der Bestimmung des Anteil K_{1G}' werden die Si-Atome der Kernquantenpunkte (CI) mit magnetischem Moment nicht berücksichtigt, da deren magnetisches Moment ja beabsichtigt und nicht parasitär ist.

Da auch isotopenreine Siliziumkarbid-Wafer extrem teuer sind, ist es sinnvoll, wenn der Quantenpunkttyp des Quantenpunkts (NV) des Quantenbits (QUB) in einem Siliziumkarbid-Substrat (D) dadurch gekennzeichnet ist, dass das Substrat (D) ein Siliziumkarbid-Material umfasst und dass das Siliziumkarboid-Material eine epitaktisch aufgewachsene isotopenreine Schicht (DEPI) im Wesentlichen aus ²⁸Si-Isotopen und ¹²C-Isotopen umfasst. Diese kann beispielsweise mittels CVD und anderen Abscheidemethoden auf der ursprünglichen Oberfläche eines als Substrat (D) verwendeten Siliziumkarbid-Wafers abgeschieden werden. Im Wesentlichen bedeutet dabei, dass der Gesamtanteil K_{1G}' der Si-Isotope mit magnetischen Moment und der C-Isotope mit magnetischen Moment, die Bestandteil des Substrats (D) sind, bezogen auf 100% der Si-Atome und 100% der C-Atome, die Bestandteil des Substrats (D) sind, gegenüber den in den obigen Tabellen angegebenen natürlichen Gesamtanteil K_{1G} auf einen Anteil K_{1G}' der Si-Isotope mit magnetischen Moment und der C-Isotope mit magnetischen Moment, die beide Bestandteil des Substrats (D) sind, bezogen auf 100% der Si-Isotope, die Bestandteil des Substrats (D) sind, und geleichzeitig bezogen auf 100% der C-Isotope, die Bestandteil des Substrats (D) sind herabgesetzt ist. Dabei ist bevorzugt dieser Anteil K_{1G}' kleiner als 50%, besser kleiner als 20%, besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für Si-Isotope mit magnetischen Moment bezogen auf die Si-Isotope des Substrats (D) im Einwirkungsbereich der als Quantenpunkte (NV) benutzten paramagnetischen Störstellen (NV) und/oder der als Kernquantenpunkten (CI) benutzten nuklearen Spins und für C-Isotope mit magnetischen Moment bezogen auf die C-Isotopen des Substrats (D) im Einwirkungsbereich der als Quantenpunkte (NV) benutzten paramagnetischen Störstellen (NV) und/oder der als Kernquantenpunkten (CI) benutzten nuklearen Spins. Bei der Bestimmung des Anteil K_{1G}' werden die Si-Atome der Kernquantenpunkte (CI) mit magnetischem Moment bzw. die C-Atome der Kernquantenpunkte (CI) mit magnetischem Moment nicht berücksichtigt, da deren magnetisches Moment ja für die Ausformung der Kernquantenpunkte (CI) benötigt wird und damit beabsichtigt ist und nicht parasitär ist.

Für die Funktionstüchtigkeit der NV-Zentren (NV) in einem Diamanten als Substrat (D) ist es wichtig, dass das Substrat (D), also der Diamant, in der Nähe des NV-Zentrums (NV) n-dotiert ist, damit sich das NV-Zentrum mit hoher Wahrscheinlichkeit in einem negativ geladenen Zustand befindet, da es die überschüssigen Elektronen einfängt. Diese Erkenntnis ist eine der wesentlichsten, die Produzierbarkeit des hier vorgelegten Vorschlags sicherzustellen. Um den Quantenpunkt (NV) unabhängig vom Substrat und vom verwendeten paramagnetischen Zentrum (NV) bzw. unabhängig vom als Quantenpunkt (NV) verwendeten Quantenpunkttyp nicht zu stören sollten verwendete Dotierstoffe keinen Kernspin oder nur einen unwesentlichen Kernspin aufweisen. Für NV-Zentren in Diamant ist eine Dotierung im Bereich des Quantenpunkts (NV) mit kernspinfreiem und zwar insbesondere mit ³²S-Isotopen zu empfehlen, da diese sich bewährt haben. Ganz allgemein sollen somit im Bereich des Quantenpunkts (NV) kernspinfreie Isotopen zur Dotierung verwendet werden. Der Begriff "Bereich" ist hierbei als Wirkungsbereich für eine direkte oder indirekte Wechselwirkung zu verstehen. Eine direkte Wechselwirkung erfolgt dabei von einem Quantenobjekt - z.B. einem Quantenpunkt -direkt zu dem anderen Quantenobjekt-z.B. einem anderen Quantenpunkt -. Eine indirekte Wechselwirkung erfolgt unter Zuhilfenahme zumindest eines weiteren Quantenobjekts - z.B. eines dritten Quantenpunkts -. Hierzu sei auf die im Folgenden später beschriebenen Ausführungen zum "Quantenbus" verwiesen. Bevorzugt befindet sich der Quantenpunkt (NV) in einem mehr oder weniger vorgegebenen ersten Abstand (d1) längs der virtuellen Lot-Linie (LOT) unter der Oberfläche (OF) des Substrats (D) und/oder der ggf. vorhandenen epitaktischen Schicht (DEPI). Bevorzugt beträgt dieser erste Abstand (d1) 2 nm bis 60 nm beträgt und/oder besser 5 nm bis 30 nm beträgt und/oder 10 nm bis 20 nm, wobei insbesondere ein erster Abstand (d1) von 5 nm bis 30 nm bevorzugt ist.

In der Halbleiterindustrie werden zu verschiedenen Zwecken vor allem die Dotierstoffe B, Al, Ga, In für die Erzeugung einer p-Dotierung in einem Silizium-Substrat (D) eingesetzt. Bor, Aluminium, Gallium und Indium verfügen über kein ausreichend langlebiges Isotop ohne magnetisches Kernmoment. In der Halbleiterindustrie werden zu verschiedenen Zwecken vor allem die Dotierstoffe P, As, Sb, Bi, Li für die Erzeugung einer n-Dotierung in einem Silizium-Substrat (D) eingesetzt. Auch Phosphor, Arsen, Antimon, Bismut und Lithium verfügen über kein ausreichend langlebiges Isotop ohne magnetisches Kernmoment. Somit ist die Dotierung von ²⁸Si-Silizium-Substraten (D) ohne Einbringung parasitärer magnetischer Momente ein ernsthaftes Problem.

Auch für G-Zentren in Silizium ist eine n-Dotierung im Bereich des Quantenpunkts (NV) mit kernspinfreiem und zwar insbesondere mit stabilen Isotopen der sechsten Hauptgruppe möglich. Beispielsweise ¹²⁰Te-Isotope und/oder ¹²²Te-Isotope und/oder ¹²⁴Te-Isotope und/oder ¹²⁶Te-Isotope und/oder ¹²⁸Te-Isotope und/oder ¹³⁰Te-Isotope, weisen kein magnetisches Kernmoment auf. Tellur ist in Silizium ein Donator mit einem Abstand von 0,14 eV zur Leitungsbandkante. Die Titan-Isotope ⁴⁶Ti, ⁴⁸Ti, ⁵⁰Ti erscheinen auch bei einem Abstand zur Leitungsbandkante von 0,21 eV in Silizium geeignet.

Als weiterer Donator kommen die Kohlenstoff Isotope ¹²C und ¹⁴C in Frage, die ohnehin Bestandteil der G-Zentren sind. Des Weiteren kommen die Se-Isotope ⁷⁴Se, ⁷⁶Se, ⁷⁸Se, ⁸⁰Se als Donatoren mit einer Aktivierungsenergie von 0,25 eV in Frage. Ebenso kommen die Ba-Isotope ¹³⁰Ba, ¹³²Ba,¹³⁴Ba,¹³⁶Ba, ¹³⁸Ba mit einem Abstand von 0,32 eV zur Leitungsbandkante in Frage. Dabei hat das Barium-Isotop ¹³⁰Ba eine Halbwertszeit von 1,6 × 10²¹ Jahre und ist damit im technischen Sinne so wie die anderen genannten Ba-Isotope stabil. Auch die Schwefel Isotope ³²S, ³⁴S, und ³⁶S sind mit einem energetischen Abstand von 0,26 eV zur Valenzbandkante geeignet. Die anderen üblichen stabilen Isotopen von n-Dotierstoffen in Silizium wie alle stabilen Isotope des Antimons ¹²¹Sb und ¹²³Sb und das stabile Isotop des Phosphors, ³¹P, und das stabile Isotop des Arsens, ⁷⁵As, und das stabile Isotop des Wismuts, ²⁰⁹Bi, und zwei der stabilen Isotope des Tellurs, ¹²³Te und ¹²⁵Te, weisen ein magnetisches Kernmoment auf und sind für den Zweck der Verschiebung des Fermi-Niveaus in der Nähe des Quantenpunkts (NV) oder des Kernquantenpunkts (CI) somit nicht geeignet. Sie kommen allerdings als potenzieller Kernquantenpunkt (CI), der später erläutert wird, in Frage. Wird im Rahmen eines CMOS-Prozesses eine Dotierung eines Silizium-Substrats (D) vorgenommen, so sollte zwischen den mit den StandardDotierstoffen der siliziumbasierenden Halbleitertechnologie aus der III. und V. Hauptgruppe dotierten Bereichen des Silizium-Substrats (D) und den Quantenpunkten (NV) bzw. Kernquantenpunkten (CI) ein Abstand eingehalten werden, der eine störende parasitäre Kopplung der magnetischen Momente der Dotieratome mit den Quantenpunkten (NV) und/oder den Kernquantenpunkten (CI) ausschließt. Solche Standarddotierstoffe für die Dotierung von Silizium sind beispielsweise die Dotierstoffe B, Al, Ga, In, P, As, Sb, Bi und Li. Es hat sich gezeigt, dass ein Abstand von mehreren µm zwischen dem Quantenpunkt (NV) bzw. dem Kernquantenpunkt (CI) einerseits und dem Siliziumbereich, der mit diesen Standarddotierstoffen dotiert ist, ausreichend ist, wobei die Ausdiffusion im CMOS-Prozess berücksichtigt ist. Ggf. wird ein Versuch mit einer statistischen Versuchsplanung (Englisch. Design of Experiment, DoE) empfohlen, um den Abstand der verwendeten Halbleitertechnologie und den Anforderungen der Anwendung entsprechend zu minimieren. Als n-Dotierstoffe für die Dotierung von Silizium-Substraten (D) im Kopplungsbereich der Quantenpunkte (NV) und/oder Kernquantenpunkte (CI) eignen sich somit besonders ¹²⁰Te, ¹²²Te, ¹²⁴Te, ¹²⁶Te, ¹²⁸Te, ¹³⁰Te, ⁴⁶Ti, ⁴⁸Ti, ⁵⁰Ti, ²C, ¹⁴C, ⁷⁴Se, ⁷⁶Se, ⁷⁸Se, ⁸⁰Se, ¹³⁰Ba, ¹³²Ba, ¹³⁴Ba, ¹³⁶Ba, ¹³⁸Ba, ³²S, ³⁴S, und ³⁶S. Für G-Zentren in Silizium ist eine p-Dotierung des Materials des Silizium-Substrats (D) im Bereich des Quantenpunkts (NV) mit kernspinfreiem Isotopen sehr schwierig. Statt der Standarddotieratome der III. Hauptgruppe müssen andere Isotope verwendet werden, da diese Standarddotieratome der III. Hauptgruppe allesamt ein magnetisches Kernmoment aufweisen. Einige energetisch weniger schlecht liegende potenzielle Dotierstoffe sind nur quasistabil und weisen kein magnetisches Kernmoment auf. ²⁰⁴TI hat eine Halbwertszeit von 3,783(12) × 10¹² Jahren und ist damit quasi stabil. Das magnetische Moment µ von ²⁰⁴TI beträgt nur 0,09. Mit 0,3eV liegt das Akzeptor-Niveau aber bereits etwas weiter von der Bandkante entfernt. Somit ist eine Dotierung mit ²⁰⁴TI ein sehr schlechter, aber ggf. noch einsetzbarer Kompromiss. Stabile Palladium-Isotope ¹⁰²Pd, ¹⁰⁴Pd, ¹⁰⁶Pd, ¹⁰⁸Pd, ¹¹⁰Pd, führen zu einer p-Dotierung frei von magnetischen Kernmomenten mit einem energetischen Abstand zur Valenzbandkante von 0,34eV. Palladium ist somit ein besserer Kompromiss. Ebenfalls metastabil ist das Beryllium-Isotop ¹⁰Be, das frei von magnetischen Kernmomenten ist, mit einer Halbwertszeit von 1,51(4) × 10⁶ Jahren. In Silizium agiert Beryllium als Akzeptor mit zwei Energieniveaus in der Bandlücke bei 0,42eV und 0,17eV Abstand von der Valenzbandkante. Damit ist das radioaktive Beryllium ¹⁰Be ein sehr guter Kompromiss für eine p-Dotierung des Siliziums eines Silizium-Substrats (D) im Bereich der Quantenpunkte (NV) bzw. der Kernquantenpunkte (CI). Eine wesentliche Erkenntnis bei der Ausarbeitung dieser Schrift ist daher die Dotierung des Materials des Silizium-Substrats (D) im Kopplungsbereich der Quantenpunkte (NV) und/oder der Kernquantenpunkte (CI) mit einem Isotop, das kein magnetisches Kernmoment aufweist, oder das als Kompromiss ein Kernmoment kleiner als µ=0,1 aufweist. Es wurde erkannt, dass die Dotierung des Silizium-Materials des Silizium-Substrats (D) mit metastabilen Isotopen der dritten Hauptgruppe mit einer Halbwertszeit von mehr als 10⁵ Jahren, wenn diese Isotope kein magnetisches Kernmoment µ aufweisen, besonders bevorzugt ist, um eine p-Dotierung des Materials des Silizium-Substrats (D) im Kopplungsbereich der Quantenpunkte (NV) bzw. im Kopplungsbereich der Kernquantenpunkte (CI) zu erreichen.

Andere stabile Isotope, wie beispielsweise das Bor-Isotop ¹⁰B oder das Aluminium-Isotop, ²⁶Al, weisen ein ganzzahliges magnetisches Moment µ auf und koppeln daher parasitär mit dem Quantenpunkt (NV) und dem Kernquantenpunkt (CI).

Somit eignen sich ¹⁰Be, ¹⁰²Pd, ¹⁰⁴Pd, ¹⁰⁶Pd, ¹⁰⁸Pd, ¹¹⁰Pd, ²⁰⁴TI für die Erzeugung einer p-Dotierung von Silizium-Substraten (D), insbesondere von ²⁸Si-Silizium-Substraten und ²⁸Si-epitaktischen Schichten (DEPI), da diese frei von magnetischen Momenten sind (¹⁰Be, ¹⁰²Pd, ¹⁰⁴Pd, ¹⁰⁶Pd, ¹⁰⁸Pd, ¹¹⁰Pd) bzw. wie ²⁰⁴TI nur ein sehr geringes magnetisches Moment besitzen.

Die anderen üblichen stabilen Isotope von p-Dotierstoffen in Silizium, wie das stabile Isotop des Bors, ¹¹B, und die stabilen Gallium-Isotope,⁶⁹Ga und ⁷¹Ga, und das stabile Indium-Isotop, ¹¹³In, und die stabile Thallium-Isotope, ²⁰³TI und ²⁰⁵TI, weisen ein signifikantes magnetisches Kernmoment auf und sind für den Zweck der Verschiebung des Fermi-Niveaus in der Nähe des Quantenpunkts (NV) bzw. in der Nähe eines Kernquantenpunkts (CI) somit nicht ohne Weiteres geeignet. Sie kommen allerdings als potenzieller Kernquantenpunkt (CI), der später erläutert wird, in Frage. Auf die Schrift von H. R. Vydyanath, J. S. Lorenzo, F. A. Kröger, "Defect pairing diffusion, and solubility studies in seleniumdoped silicon", Journal of Applied Physics 49, 5928 (1978), https://doi.org/10.1063/1.324560 wird hingewiesen.

Ganz allgemein sollen somit im Bereich des Quantenpunkts (NV) bzw. des Kernquantenpunkts (CI) Isotope ohne magnetisches Moment zur Dotierung verwendet werden. Der Begriff "Bereich" ist hierbei als Wirkungsbereich für eine direkte oder indirekte Wechselwirkung in Form einer Kopplung zu verstehen. Eine direkte Wechselwirkung erfolgt dabei von einem Quantenobjekt - z.B. einem Quantenpunkt (NV) oder einem Kernquantenpunkt (CI)-direkt zu dem anderen Quantenobjekt -z.B. einem anderen Quantenpunkt -. Eine indirekte Wechselwirkung erfolgt unter Zuhilfenahme zumindest eines weiteren Quantenobjekts -z.B. eines dritten Quantenpunkts -. Hierzu sei auf die im Folgenden später beschriebenen Ausführungen zum "Quantenbus" verwiesen. Bevorzugt befindet sich der Quantenpunkt (NV) in einem mehr oder weniger vorgegebenen ersten Abstand (d1) längs der virtuellen Lot-Linie (LOT) unter der Oberfläche (OF) des Substrats (D) und/oder der ggf. vorhandenen epitaktischen Schicht (DEPI). Bevorzugt beträgt dieser erste Abstand (d1) 2 nm bis 60 nm beträgt und/oder besser 5 nm bis 30 nm beträgt und/oder 10 nm bis 20 nm, wobei insbesondere ein erster Abstand (d1) von 5 nm bis 30 nm bevorzugt ist.

Um die Einkopplung von Steuersignalen des Quantenbits (QUB) in andere Quantenbits (QUB2) einer Vorrichtung zu vermindern oder sogar zu vermeiden, ist es sinnvoll, durch Mikrostreifenleitungen, auch Mikrostrip-Leitungen genannt, die Feldausdehnung auf das Mindestmaß zu reduzieren. Es wird daher hier ein Quantenbit (QUB) vorgeschlagen, bei dem die horizontale Leitung (LH, LH1) und die vertikale Leitung (LV, LV1) jeweils Teil einer jeweiligen Mikrostreifenleitung und/oder Teil einer jeweiligen Tri-Plate-Leitung sind. Im Falle der Verwendung von Mikrostreifenleitungen umfasst dann die vertikale Mikrostreifenleitung eine erste vertikale Abschirmleitung (SV1) und die vertikale Leitung (LV) und die horizontale Mikrostreifenleitung eine erste horizontale Abschirmleitung (SH1) und die horizontale Leitung (LH).

Im Falle einer Tri-Plate-Leitung umfasst die vertikale Tri-Plate-Leitung eine erste vertikale Abschirmleitung (SV1) und eine zweite vertikale Abschirmleitung (SV2) und die vertikale Leitung (LV).

Die vertikale Leitung (LV) verläuft in diesem Falle bevorzugt zumindest teilweise zwischen der ersten vertikalen Abschirmleitung (SV1) und der zweiten vertikalen Abschirmleitung (SV2).

Die horizontale Tri-Plate-Leitung umfasst in diesem Fall bevorzugt eine erste horizontale Abschirmleitung (SH1) und eine zweite horizontale Abschirmleitung (SH2) und die horizontale Leitung (LV), die zumindest teilweise zwischen der ersten horizontalen Abschirmleitung (SH1) und der zweiten horizontalen Abschirmleitung (SH2) verläuft.

Bevorzugt, aber nicht notwendiger Weise ist im Falle der Verwendung von Tri-Plate-Leitungen die Summe der Ströme (ISV1, IV, ISV2) durch die Tri-Plate-Leitung (SV1, LV, SV2) null, wodurch das Magnetfeld dieser Ströme auf den Nahbereich dieser Leitungen begrenzt bleibt.

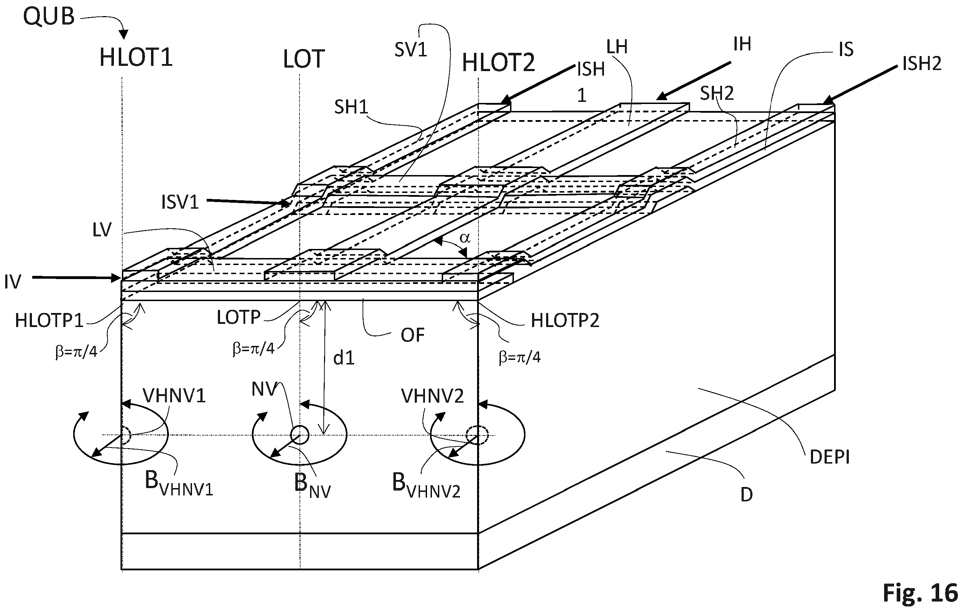

Diese Begrenzung des Magnetfeldes kann besser definiert werden (Siehe Figur 16). Hierzu wird ein erstes weiteres vertikales Lot längs einer ersten weiteren vertikalen Lot-Linie (VLOT1) parallel zur ersten Lot-Linie (LOT) vom Ort eines ersten virtuellen vertikalen Quantenpunkts (VVNV1) zur Oberfläche (OF) des Substrats (D) und/oder der ggf. vorhandenen epitaktischen Schicht (DEPI) gefällt. Dieser erste virtuelle vertikale Quantenpunkt (VVNV1) befinde sich nun ebenfalls in dem ersten Abstand (d1) von der Oberfläche (OF) und somit auf der gleichen Tiefe wie der Quantenpunkt (NV). Die erste weitere vertikale Lot-Linie (VLOT1) durchstößt dann die Oberfläche (OF) des Substrats (D) und/oder der ggf. vorhandenen epitaktischen Schicht (DEPI) an einem ersten weiteren vertikalen Lotpunkt (VLOTP1). Die horizontale Leitung (LH) und die erste vertikale Abschirmleitung (SV1) befinden sich wieder auf der Oberfläche des Substrats (D) und/oder der ggf. vorhandenen epitaktischen Schicht (DEPI). Die horizontale Leitung (LH) und die erste vertikale Abschirmleitung (SV1) kreuzen sich nun bevorzugt in der Nähe des ersten vertikalen Lot-Punktes (VLOTP1) oder am ersten vertikalen Lot-Punkt (VLOTP1) in dem von Null verschiedenen Kreuzungswinkel (α). Ebenso kann auf der gegenüber liegenden Seite des Quantenpunkts (NV) ein zweites weiteres vertikales Lot längs einer zweiten weiteren vertikalen Lot-Linie (VLOT2) parallel zur ersten Lot-Linie (LOT) vom Ort eines zweiten virtuellen vertikalen Quantenpunkts (VVNV2) zur Oberfläche (OF) des Substrats (D) und/oder der ggf. vorhandenen epitaktischen Schicht (DEPI) gefällt werden. Der zweite virtuelle vertikale Quantenpunkt (VVNV2) befindet sich dabei ebenfalls in dem ersten Abstand (d1) von der Oberfläche (OF) unter derselben. Die zweite weitere vertikale Lot-Linie (VLOT2) durchstößt die Oberfläche (OF) des Substrats (D) und/oder der ggf. vorhandenen epitaktischen Schicht (DEPI) an einem zweiten weiteren vertikalen Lotpunkt (VLOTP2). Die horizontale Leitung (LH) und die zweite vertikale Abschirmleitung (SV2) befinden sich wieder auf der Oberfläche des Substrats (D) und/oder der ggf. vorhandenen epitaktischen Schicht (DEPI). Die horizontale Leitung (LH) und die zweite vertikale Abschirmleitung (SV2) kreuzen sich in analoger Weise in der Nähe des zweiten vertikalen Lot-Punktes (VLOTP2) oder am zweiten vertikalen Lot-Punkt (VLOTP2) in dem von Null verschiedenen Kreuzungswinkel (α). Die Einzelströme (ISV1, IV, ISV2) durch die einzelnen Leitungen (SV1, LV, SV2) der Triplate-Leitung sind nun bevorzugt so gewählt, dass der Betrag des ersten virtuellen vertikalen magnetischen Flussdichtevektors (B_{VVNV1}) am Ort des ersten virtuellen vertikalen Quantenpunkts (VVNV1) nahezu null ist und dass der Betrag des zweiten virtuellen vertikalen magnetischen Flussdichtevektors (B_{VVNV2}) am Ort des zweiten virtuellen vertikalen Quantenpunkts (VVNV2) nahezu null ist und dass der Betrag des magnetischen Flussdichtevektors (B_{NV}) am Ort des Quantenpunkts (NV) von Null verschieden ist. Wie leicht zu erkennen ist, ist dies am Ende ein Polynom-Approximationsproblem mit jeder Abschirmleitung parallel zu einer Leitung (LH, LV) mehr kann ein weiterer Abschirmstrom frei gewählt werden und damit die Approximation verbessert werden. Der Nachteil ist, dass hierdurch der Mindestabstand zwischen zwei Quantenbits (QUB1, QUB2) vergrößert wird und dadurch die Koppelfrequenz sinkt und damit die Anzahl der durchführbaren Operationen sinkt.

In analoger Weise kann die Approximation des Feldes längs der horizontalen Leitung vorgenommen werden. Dabei kann ein erstes weiteres horizontales Lot längs einer ersten weiteren horizontalen Lot-Linie (HLOT1) parallel zur ersten Lot-Linie (LOT) vom Ort eines ersten virtuellen horizontalen Quantenpunkts (VHNV1) zur Oberfläche (OF) des Substrats (D) und/oder der ggf. vorhandenen epitaktischen Schicht (DEPI) gefällt werden. Der erste virtuelle horizontale Quantenpunkt (VHNV1) befindet sich in dem ersten Abstand (d1) von der Oberfläche (OF) unter derselben. Die erste weitere horizontale Lot-Linie (VLOT1) durchstößt die Oberfläche (OF) des Substrats (D) und/oder der ggf. vorhandenen epitaktischen Schicht (DEPI) an einem ersten weiteren horizontalen Lotpunkt (HLOTP1). Die vertikale Leitung (LV) und die erste horizontale Abschirmleitung (SH1) befinden auf der Oberfläche des Substrats (D) und/oder der ggf. vorhandenen epitaktischen Schicht (DEPI). Die vertikale Leitung (LV) und die erste horizontale Abschirmleitung (SH1) kreuzen sich in der Nähe des ersten horizontalen Lot-Punktes (HLOTP1) oder am ersten horizontalen Lot-Punkt (HLOTP1) in dem von Null verschiedenen Kreuzungswinkel (α). Ein zweites weiteres horizontales Lot kann längs einer zweiten weiteren horizontalen Lot-Linie (HLOT2) parallel zur ersten Lot-Linie (LOT) vom Ort eines zweiten virtuellen horizontalen Quantenpunkts (VHNV2) zur Oberfläche (OF) des Substrats (D) und/oder der ggf. vorhandenen epitaktischen Schicht (DEPI) gefällt werden. Der zweite virtuelle horizontale Quantenpunkt (VHNV2) befindet sich in dem ersten Abstand (d1) von der Oberfläche (OF) unter derselben. Die zweite weitere horizontale Lot-Linie (HLOT2) durchstößt die Oberfläche (OF) des Substrats (D) und/oder der ggf. vorhandenen epitaktischen Schicht (DEPI) an einem zweiten weiteren horizontalen Lotpunkt (HLOTP2). Die vertikale Leitung (LV) und die zweite horizontale Abschirmleitung (SH2) befinden sich auf der Oberfläche des Substrats (D) und/oder der ggf. vorhandenen epitaktischen Schicht (DEPI). Die vertikale Leitung (LV) und die zweite horizontale Abschirmleitung (SH2) kreuzen sich in der Nähe des zweiten horizontalen Lot-Punktes (HLOTP2) oder am zweiten horizontalen Lot-Punkt (HLOTP2) in dem von Null verschiedenen Kreuzungswinkel (α). Die Einzelströme (ISH1, IH, ISH2) durch die einzelnen Leitungen (SH1, LH, SH2) der Triplate-Leitung sind auch hier dabei so gewählt, dass der Betrag des ersten virtuellen horizontalen magnetischen Flussdichtevektors (B_{VHNV1}) am Ort des ersten virtuellen horizontalen Quantenpunkts (VHNV1) nahezu null ist und dass der Betrag des zweiten virtuellen horizontalen magnetischen Flussdichtevektors (B_{VHNV2}) am Ort des zweiten virtuellen horizontalen Quantenpunkts (VHNV2) nahezu null ist und dass der Betrag des magnetischen Flussdichtevektors (B_{NV}) am Ort des Quantenpunkts (NV) von Null verschieden ist.

Um erzeugte Fotoelektronen absaugen zu können, ist es sinnvoll, wenn im Bereich oder in der Nähe des Lotpunkts (LOTP) das Substrat (D) mittels zumindest eines ersten horizontalen ohmschen Kontakts (KH11) mit der ersten horizontalen Abschirmleitung (SH1) verbunden ist und /oder wenn im Bereich oder in der Nähe des Lotpunkts (LOTP) das Substrat (D) mittels zumindest eines zweiten horizontalen ohmschen Kontakts (KH12) mit der zweiten horizontalen Abschirmleitung (SH2) verbunden ist und /oder wenn im Bereich oder in der Nähe des Lotpunkts (LOTP) das Substrat (D) mittels zumindest eines ersten vertikalen ohmschen Kontakts (KV11) mit der ersten vertikalen Abschirmleitung (SV1) verbunden ist und /oder wenn im Bereich oder in der Nähe des Lotpunkts (LOTP) das Substrat (D) mittels zumindest eines zweiten vertikalen ohmschen Kontakts (KV12) mit der zweiten vertikalen Abschirmleitung (SV2) verbunden ist und/oder wenn im Bereich oder in der Nähe des Lotpunkts (LOTP) das Substrat (D) mittels zumindest eines zweiten vertikalen ohmschen Kontakts (KV12) mit einer Absaugleitung verbunden ist. Bevorzugt umfasst ein ohmscher Kontakt (KV11, KV12, KH11, KH12) eine hohe n- oder p-Dotierung, wobei die Dotierung bevorzugt mittels einer Verwendung der zuvor erwähnten Isotope ohne magnetisches Moment µ erzielt wird. Bevorzugt werden die Leitungen aus einem Material gefertigt, das bevorzugt im Wesentlichen keine Isotope mit einem magnetischen Kernmoment umfasst. Beispielsweise kommt eine Metallisierung aus Titan mit den Isotopen ⁴⁶Ti, ⁴⁸Ti und ⁵⁰Ti in Frage. Bevorzugt werden die Isolierungen zwischen den Leitungen (LH, LV) untereinander und zwischen den Leitungen (LH, LV) einerseits und dem Material des Substrats (D) andererseits auch aus einem Material gefertigt, das im Wesentlichen keine Isotope mit magnetischen Momenten umfasst. Beispielsweise ist vielfach die Verwendung von ²⁸Si¹⁶O₂-Siliziumoxid besonders zu empfehlen. Die Verwendung anderer ohmscher Kontakte als Titan-Kontakten ist natürlich möglich.

### Erfindungsgemäßes Kernquantenbit (CQUB)

Im vorausgehenden Abschnitt wurde bereits erwähnt, dass neben den Quantenpunkten (NV) auch Kernquantenpunkte (CI) gefertigt werden können.

Der nun folgende Abschnitt ist in seinem Kern eine Wiederholung des vorhergehenden Abschnitts mit dem Unterschied, dass das Quantenbit nun strukturell nicht auf Elektronenspins, sondern auf Kernspins basiert. Auf den vorausgehenden Abschnitt, der die verwendbaren Isotope ausführlich behandelte, wird hier verwiesen.

Wie bereits erwähnt können u.a. ¹³C-Isotope im Falle eines Diamant-Substrats (D) als Kernquantenpunkt (CI) Verwendung finden.

Im Falle eines Silizium-Substrats (D) können als Kernquantenpunkt (CI) beispielsweise ²⁹Si-Isotope Verwendung finden.

Im Falle eines Siliziumkarbid-Substrats (D) können als Kernquantenpunkt (CI) beispielsweise ²⁹Si-Isotope und/oder ¹³C-Isotope Verwendung finden.

### Diamant

Wichtig ist hier das die ¹³C-Isotope im Falle eines Dimant-Substrats (D) möglichst nahe an die Quantenpunkte (NV) - beispielsweise in Form der NV-Zentren - im Herstellungsprozess gebracht werden können und unterschiedliche Positionen zum Quantenpunkt (NV), also z.B. einem NV-Zentrum, einnehmen.

### Silizium

Im Falle eines Silizium-Substrats (D) ist in analoger Weise wichtig, dass die ²⁹Si-Isotope möglichst nahe an die Quantenpunkte (NV) in Form der G-Zentren im Herstellungsprozess gebracht werden können und unterschiedliche Positionen zum Quantenpunkt (NV), also z.B. einem G-Zentrum, einnehmen.

### Siliziumkarbid

Im Falle eines Siliziumkarbid-Substrats (D) ist in analoger Weise wichtig, dass die ²⁹Si-Isotope bzw. die ¹³C-Isotope möglichst nahe an die Quantenpunkte (NV) in Form der V-Zentren im Herstellungsprozess gebracht werden können und unterschiedliche Positionen zum Quantenpunkt (NV), also z.B. einem V-Zentrum, einnehmen.

### Allgemeines zu Kopplung

Man kann dabei sehr viele ¹³C-Isotope bzw. ²⁹Si-Isotope implantieren da sie sich aufgrund der kurzen Kopplungsreichweite gegenseitig nicht stören. Im Gegensatz zu elektrischen Spins der Elektronenkonfigurationen der Quantenpunkte (NV), die eine lange Kopplungsreichweite haben, haben der Kernspins der Kernquantenpunkte (CI) nur eine sehr kurze Kopplungsreichweite. Daher ist es bevorzugt, eine Verbindung zwischen voneinander räumlich entfernten Kernquantenpunkten (CI), die weiter als die Kern-Kern-Kopplungsreichweite voneinander entfernt sind, über eine Kette aus einem oder mehreren Quantenpunkten (NV) herzustellen, die zumindest paarweise voneinander so beabstandet sind, dass beide Quantenpunkte (NV1, NV2) eines solchen Quantenpunktpaares einen Abstand kleiner als die Elektron-Elektron-Kopplungsreichweite zwischen diesen zwei Quantenpunkten (NV1, NV2) haben, und wobei die Quantenpunktpaare eine geschlossene Kette zumindest paarweise miteinander gekoppelter Quantenpunkte ergeben, sodass die voneinander räumlich entfernten Kernquantenpunkten (CI) miteinander über diese Ancilla-Quantenpunkte verkoppelt werden können. Dies wird durch den später beschriebenen Quantenbus (QUBUS) vorgenommen.

### Implantation von Molekülen in Diamant

Um geeignete Strukturen in einem Diamant-Substrat (D) herzustellen, kann man beispielsweise Hepteamin oder eine andere geeignete Kohlenstoffverbindung mit einem Stickstoffatom implantieren. Geeignet gefertigtes Heptamin kann ein N-Stickstoff-Atom und 5 ¹³C-Isotope umfassen. In dem Fall kann das das Stickstoffatom zusammen mit den ¹³C-Isotopen implantiert werden. Das Stickstoffatom bildet dann bevorzugt das NV-Zentrum, also den Quantenpunkt (NV), während die ¹³C-Isotope die Kernquantenpunkte (CI) ausbilden. Dies hat den Vorteil, dass auf diesem Wege ein komplexeres Register in einem Fertigungsschritt in Diamant als Substrat (D) hergestellt werden kann. Dabei handelt es sich bevorzugt um ein Verfahren zum Herstellen einer QuantenALU in dem Material eines Diamant-Substrats (D) umfassend den Schritt des Implantierens eines kohlenstoffhaltigen Moleküls, wobei das Molekül zumindest ein oder zwei oder drei oder vier oder fünf oder sechs oder sieben oder mehr ¹³C-Isotope umfasst und wobei das Molekül mindestens ein Stickstoffatom umfasst.

### Grundlegende Ansteuervorrichtung

Ein auf Kernquantenpunkten (CI) basierendes Kernquantenbit (CQUB) umfasst daher eine Vorrichtung zur Ansteuerung des Kernquantenpunkts (CI), ein Substrat (D), ggf. mit einer epitaktischen Schicht (DEPI), den Kernquantenpunkt (CI) und eine Vorrichtung, die zur Erzeugung eines elektromagnetischen bevorzugt zirkular polarisierten Wellenfeldes (B_{RW}) am Ort des Kernquantenpunkts (CI) geeignet ist. Bevorzugt ist, wie bereits oben beschrieben, die epitaktische Schicht (DEPI), sofern vorhanden, auf dem Substrat (D) aufgebracht. Das Substrat (D) und/oder die ggf. vorhandene epitaktische Schicht (DEPI) weist eine Oberfläche (OF) auf. Der Kernquantenpunkt (CI) weist ein magnetisches Moment, insbesondere einen Kernspin, auf. Die Vorrichtung, die zur Erzeugung eines elektromagnetischen, insbesondere zirkular polarisierten, Wellenfeldes (B_{RW}) geeignet ist, befindet sich bevorzugt sich auf der Oberfläche des Substrats (D) und/oder der ggf. vorhandenen epitaktischen Schicht (DEPI). Die Vorrichtung, die zur Erzeugung eines elektromagnetischen, insbesondere zirkular polarisierten, Wellenfeldes (B_{RW}) geeignet ist, ist bevorzugt fest mit dem Substrat (D) und/oder der ggf. vorhandenen epitaktischen Schicht (DEPI) verbunden.

Wie beim Quantenbit (QUB) kann wieder ein Lot längs einer Lot-Linie (LOT) vom Ort des Kernquantenpunkts (CI) zur Oberfläche (OF) des Substrats (D) und/oder der ggf. vorhandenen epitaktischen Schicht (DEPI) gefällt werden. Die Lot-Linie (LOT) durchbricht die Oberfläche (OF) des Substrats (D) und/oder der ggf. vorhandenen epitaktischen Schicht (DEPI) an einem Lotpunkt (LOTP). Die Vorrichtung, die zur Erzeugung eines, insbesondere zirkular polarisierten, elektromagnetischen Wellenfeldes, insbesondere eines Radiowellenfeldes (B_{RW}), geeignet ist, befindet sich bevorzugt in der Nähe des Lot-Punktes (LOTP) oder am Lot-Punkt (LOTP).

Das vorgeschlagene Kernquantenbit (CQUB) umfasst eine horizontale Leitung (LH) und eine vertikale Leitung (LV), die bevorzugt auf der Oberfläche des Substrats (D) und/oder der ggf. vorhandenen epitaktischen Schicht (DEPI) befinden. Erfindungsgemäß bilden die horizontale Leitung (LH) und die vertikale Leitung (LV) die bereits erwähnte Vorrichtung, die zur Erzeugung eines, insbesondere zirkular polarisierten, elektromagnetischen Wellenfeldes, insbesondere eines Radiowellenfeldes (B_{RW}), am Ort des Kernquantenpunkts (CI) geeignet ist.

Bevorzugt kann ein virtuelles Lot längs einer virtuellen Lot-Linie (LOT) vom Ort des Kernquantenpunkts (CI) zur Oberfläche (OF) des Substrats (D) und/oder der ggf. vorhandenen epitaktischen Schicht (DEPI) gefällt werden, wobei die Lot-Linie (LOT) die Oberfläche (OF) des Substrats (D) und/oder der ggf. vorhandenen epitaktischen Schicht (DEPI) an einem Lotpunkt (LOTP) durchstößt und wobei sich die horizontale Leitung (LH) und die vertikale Leitung (LV) in der Nähe des Lot-Punktes (LOTP) oder am Lot-Punkt (LOTP) in einem von null verschiedenen Kreuzungswinkel (α) kreuzen.

Die horizontale Leitung (LH) ist von der vertikalen Leitung (LV) bevorzugt mittels einer elektrischen Isolation (IS) elektrisch isoliert. Dabei ist bevorzugt die horizontale Leitung (LH) und/oder die vertikale Leitung (LV) für "grünes Licht" transparent und bevorzugt aus einem elektrisch leitenden und optisch für grünes Licht transparenten Material, insbesondere aus Indium-Zinn-Oxid (gebräuchliche Abkürzung ITO) gefertigt.

Der Winkel (α) ist bevorzugt im Wesentlichen ein rechter Winkel. Bevorzugt umfasst das Substrat (D) ein paramagnetisches Zentrum und/oder einen Quantenpunkt (NV). Des Weiteren umfasst das Substrat (D) bevorzugt Diamant oder alternativ Silizium oder alternativ Siliziumkarbid. Die Verwendung anderer Materialien als Substrat ist denkbar.

### Varianten nach Material des Substrats (D)

In einer bevorzugten Variante umfasst das Substrat (D) Diamant mit einem NV-Zentrum und/oder einem ST1-Zentrum und/oder einem L2-Zentrum und/oder ein SiV-Zentrum als Quantenpunkt (NV).

In einer anderen bevorzugten Variante umfasst das Substrat (D) Silizium mit einem G-Zentrum als Quantenpunkt (NV).

In einer weiteren bevorzugten Variante umfasst das Substrat (D) Siliziumkarbid mit einem V-Zentrum als Quantenpunkt (NV).

### Diamant

In einer Diamant-Variante umfasst das Substrat (D) Diamant und einen Quantenpunkt (NV), wobei der Quantenpunkt (NV) eine Fehlstelle (Englisch Vacancy) oder eine andere Störstelle umfasst. Bevorzugt umfasst das Substrat (D) Diamant und einen Quantenpunkt (NV), wobei der Quantenpunkt (NV) ein Si-Atom oder ein Ge-Atom oder ein N-Atom oder ein P-Atom oder ein As-Atom oder ein Sb-Atom oder ein Bi-Atom oder ein Sn-Atom oder ein Mn-Atom oder eine F-Atom oder ein anderes Atom, das in Diamant ein Störstellenzentrum und/oder eine Störstelle mit einem paramagnetischen Verhalten erzeugt, umfasst. In einer weiteren Untervariante umfasst das Substrat (D) Diamant und einen Kernquantenpunkt (CI), der einen Atomkern eines ¹³C-Isotops oder eines ¹⁴N-Isotops oder eines ¹⁵N-Isotops oder eines anderen Atoms umfasst, dessen Atomkern ein magnetisches Moment aufweist. In einer wichtigen Untervariante wird das NV-Zentrum selbst als Kernquantenpunkt (CI) und als Quantenpunkt (NV) gleichzeitig ausgebildet In diesem Fall umfasst das Substrat (D) Diamant und bevorzugt als Kernquantenpunkt (CI) den Atomkern eines ¹⁴N Isotops oder eines ¹⁵N Isotops des Sickstoffatoms, der das Stickstoffatom des betreffenden NV-Zentrums ist.

### Silizium

In einer Silizium-Variante umfasst das Substrat (D) Silizium und einen Quantenpunkt (NV), wobei der Quantenpunkt (NV) eine Fehlstelle (Englisch Vacancy) oder eine andere Störstelle, beispielsweise Kohlenstoffatome, umfasst. Bevorzugt umfasst das Substrat (D) Silizium und einen Quantenpunkt (NV), wobei der Quantenpunkt (NV) ein C-Atom oder ein Ge-Atom oder ein N-Atom oder ein P-Atom oder ein As-Atom oder ein Sb-Atom oder ein Bi-Atom oder ein Sn-Atom oder ein Mn-Atom oder ein F-Atom oder ein anderes Atom umfasst, das in Silizium ein Störstellenzentrum und/oder eine Störstelle mit einem paramagnetischen Verhalten erzeugt. In einer weiteren Untervariante umfasst das Substrat (D) Silizium und einen Kernquantenpunkt (CI), der einen Atomkern eines ²⁹Si-Isotops oder eines ¹³C-Isotops oder eines ¹⁴N-Isotops oder eines ¹³N-Isotops oder eines anderen Atoms umfasst, dessen Atomkern ein magnetisches Moment aufweist. In einer wichtigen Untervariante dieser Variante wird das G-Zentrum selbst als Kernquantenpunkt (CI) und als Quantenpunkt (NV) gleichzeitig ausgebildet In diesem Fall umfasst das Substrat (D) Silizium und bevorzugt als Kernquantenpunkt (CI) den Atomkern eines ¹³C-Isotops oder eines ²⁹Si-Isotops.

### Siliziumkarbid

In einer Siliziumkarbid-Variante umfasst das Substrat (D) Siliziumkarbid und einen Quantenpunkt (NV), wobei der Quantenpunkt (NV) eine Fehlstelle (Englisch Vacancy) oder eine andere Störstelle umfasst. Bevorzugt umfasst das Substrat (D) Siliziumkarbid und einen Quantenpunkt (NV), wobei der Quantenpunkt (NV) ein Si-Atom auf einer C-Position oder ein C-Atom auf einer Si-Position oder ein Ge-Atom oder ein N-Atom oder ein P-Atom oder ein As-Atom oder ein Sb-Atom oder ein Bi-Atom oder ein Sn-Atom oder ein Mn-Atom oder ein F-Atom oder ein anderes Atom umfasst, das in Siliziumkarbid ein Störstellenzentrum und/oder eine Störstelle mit einem paramagnetischen Verhalten erzeugt. In einer weiteren Untervariante umfasst das Substrat (D) Siliziumkarbid und einen Kernquantenpunkt (CI), der einen Atomkern eines ²⁹Si-Isotops oder eines ¹³C-Isotops oder eines ¹⁴N-Isotops oder eines ¹³N-Isotops oder eines anderen Atoms umfasst, dessen Atomkern ein magnetisches Moment aufweist. In einer wichtigen Untervariante dieser Variante wird das V-Zentrum selbst als Kernquantenpunkt (CI) und als Quantenpunkt (NV) gleichzeitig ausgebildet In diesem Fall umfasst das Substrat (D) Silizium und bevorzugt als Kernquantenpunkt (CI) den Atomkern eines ¹³C-Isotops oder eines ²⁹Si-Isotops.

### Diamant

Bei Kernquantenpunkten in Diamant auf Basis von ¹³C-Isotopen als Material des Substrats (D) umfasst bevorzugt das Substrat (D) Diamant und der Kernquantenpunkt (CI) ist bevorzugt der Atomkern eines ¹³C-Isotops. Der Quantenpunkt ist dann bevorzugt ein NV-Zentrum oder ein ST1-Zentrum oder ein L2-Zentrum oder ein anderes paramagnetisches Zentrum, das dann bevorzugt in der Nähe des ¹³C-Isotops angeordnet ist. Dabei ist Nähe hier wieder so zu verstehen, dass das Magnetfeld des Kernspins des ¹³C-Atoms den Spin der Elektronenkonfiguration des NV-Zentrums bzw. des ST1-Zentrums bzw. des L2-Zentrums bzw. des betreffenden anderen paramagnetischen Zentrums beeinflussen kann und dass der Spin der Elektronenkonfiguration des NV-Zentrums bzw. des ST1-Zentrums bzw. des L2-Zentrums bzw. des anderen paramagnetischen Zentrums den Kernspin des besagten ¹³C-Isotops beeinflussen kann.

### Silizium

Bei Kernquantenpunkten in Silizium auf Basis von ²⁹Si-Isotopen als Material des Substrats (D) umfasst bevorzugt das Substrat (D) Silizium und der Kernquantenpunkt (CI) ist bevorzugt der Atomkern eines ²⁹Si-Isotops. Der Quantenpunkt ist dann bevorzugt ein G-Zentrum oder ein anderes paramagnetisches Zentrum, das dann bevorzugt in der Nähe des ²⁹Si-Isotops angeordnet ist. Dabei ist Nähe hier wieder so zu verstehen, dass das Magnetfeld des Kernspins des ²⁹Si-Atoms den Spin der Elektronenkonfiguration des G-Zentrums bzw. des betreffenden anderen paramagnetischen Zentrums beeinflussen kann und dass der Spin der Elektronenkonfiguration des G-Zentrum bzw. des anderen paramagnetischen Zentrums den Kernspin des besagten ²⁹Si-Isotops beeinflussen kann.

### Siliziumkarbid

Bei Kernquantenpunkten in Siliziumkarbid auf Basis von ²⁹Si-Isotopen und ¹²C-Isotopen als Material des Substrats (D) umfasst bevorzugt das Substrat (D) Siliziumkarbid (²⁸Si¹²C) und der Kernquantenpunkt (CI) ist bevorzugt der Atomkern eines ²⁹Si-Isotops oder der Atomkern eines ¹³C-Isotops. Der Quantenpunkt (NV) ist dann bevorzugt ein V-Zentrum oder ein anderes paramagnetisches Zentrum, das dann bevorzugt in der Nähe des ²⁹Si-Isotops bzw. des ¹³C-Isotops angeordnet ist. Dabei ist Nähe hier wieder so zu verstehen, dass das Magnetfeld des Kernspins des ²⁹Si-Atoms bzw. des ¹³C-Atoms den Spin der Elektronenkonfiguration des V-Zentrums bzw. des betreffenden anderen paramagnetischen Zentrums beeinflussen kann und dass der Spin der Elektronenkonfiguration des V-Zentrum bzw. des anderen paramagnetischen Zentrums den Kernspin des besagten ²⁹Si-Isotops bzw. des besagten ¹³C-Isotops beeinflussen kann.

An dieser Stelle sei nur der Vollständigkeit halber erwähnt, dass ein Kernspin ein Kernspin mit einem Kernspin betragsmäßig größer 0 ist.

### Diamant

Ganz allgemein kann als Kernquantenbit (CQUB) eine Konstruktion definiert werden, bei der das Substrat (D) Diamant umfasst und wobei der Kernquantenpunkt (CI) ein Isotop mit einem Kernspin ist und wobei ein NV-Zentrum oder ein ST1-Zentrum oder ein L2-Zentrum oder ein anderes paramagnetisches Zentrum in der Nähe des Isotops mit dem Kernspin angeordnet ist und wobei Nähe auch hier so zu verstehen ist, dass das Magnetfeld des Kernspins des Isotops den Spin der Elektronenkonfiguration des NV-Zentrums beeinflussen kann und dass der Spin der Elektronenkonfiguration des NV-Zentrums bzw. des ST1-Zentrums bzw. des L2-Zentrums bzw. des anderen paramagnetischen Zentrums den Kernspin des Isotops beeinflussen kann.

Es können auch mehrere Kernspins verwendet werden. Das entsprechende Kernquantenbit (CQUB) ist dann so definiert, dass das Substrat (D) Diamant umfasst, wobei der Kernquantenpunkt (CI) ein Isotop mit einem magnetischen Moment µ ist und wobei mindestens ein weiterer Kernquantenpunkt (CI') ein Isotop mit einem magnetischen Moment µ ist und wobei ein NV-Zentrum oder ein ST1-Zentrum oder ein L2-Zentrum oder ein anderes paramagnetisches Zentrum in der Nähe des Kernquantenpunkts (CI) angeordnet ist und wobei das NV-Zentrum oder das ST1-Zentrum oder das L2-Zentrum oder das anderes paramagnetisches Zentrum in der Nähe des mindestens einen weiteren Kernquantenpunkts (CI') angeordnet ist und wobei Nähe hier so zu verstehen ist, dass das Magnetfeld des Kernquantenpunkts (CI) den Spin der Elektronenkonfiguration des NV-Zentrums bzw. des ST1-Zentrums bzw. des L2-Zentrums bzw. des anderen paramagnetischen Zentrums beeinflussen kann und dass das Magnetfeld des mindestens einen weiteren Kernquantenpunkts (CI') ebenfalls den Spin der Elektronenkonfiguration des NV-Zentrum bzw. des ST1-Zentrums bzw. des L2-Zentrums bzw. des anderen paramagnetischen Zentrums beeinflussen kann und dass der Spin der Elektronenkonfiguration des NV-Zentrum bzw. des ST1-Zentrums bzw. des L2-Zentrums bzw. des anderen paramagnetischen Zentrums den Kernspin des Kernquantenpunkts (CI) beeinflussen kann und dass der Spin der Elektronenkonfiguration des NV-Zentrum bzw. des ST1-Zentrums bzw. des L2-Zentrums bzw. des anderen paramagnetischen Zentrums den Kernspin des mindestens einen weiteren Kernquantenpunkts (CI') beeinflussen kann. Dies ist eine einfache QuantenALU (QUALU) auf Diamant-Basis.

Bevorzugt liegt die Kopplungsstärke zwischen einem Kernquantenbit (CI, CI') und der Elektronenkonfiguration des NV-Zentrum bzw. des ST1-Zentrums bzw. des L2-Zentrums bzw. des anderen paramagnetischen Zentrums in einem Bereich von 1 kHz bis 200 GHz und/oder besser 10 kHz bis 20 GHz und/oder besser 100 kHz bis 2 GHz und/oder besser 0,2 MHz bis 1 GHz und/oder besser 0,5 MHz bis 100 MHz und/oder besser 1 MHz bis 50 MHz, insbesondere bevorzugt bei 10 MHz.

Bevorzugt ist ein Quantenpunkt bzw. ein paramagnetisches Zentrum (NV1), beispielsweise ein NV-Zentrum, mit einem Ladungsträger, im Falle des NV_-Zentrums mit einem Elektron, oder mit einer Ladungsträgerkonfiguration, im Falle des NV₋-Zentrums mit einer Elektronenkonfiguration, in der Nähe des Kernquantenpunkts (CI) angeordnet. Die negative Ladung des Quantenpunkts (NV-Zentrums) ergibt sich im Falle des NV₋Zentrums als Quantenpunkt durch die bereits erwähnte bevorzugte Schwefeldotierung des Diamanten. Im Falle der Verwendung anderer Quantenpunkttypen als der von NV-Zentren in Diamant, können Ladungsträger bzw. Ladungsträgerkonfiguration, Farbzentrum, also Quantenpunkttyp, und Dotierung des Substrats (D) bzw. der epitaktischen Schicht (DEPI) entsprechend angepasst werden. Der Ladungsträger bzw. die Ladungsträgerkonfiguration - hier beispielhaft ein Elektron bzw. eine Elektronenkonfiguration - weisen einen Ladungsträger-Spin-Zustand auf. Der Kernquantenpunkt (CI) weist einen Kern-Spin-Zustand auf. Der Begriff "Nähe" ist hierbei so zu verstehen, dass der Kern-Spin-Zustand den Ladungsträger-Spin-Zustand beeinflussen kann und/oder dass der Ladungsträger-Spin-Zustand den Kern-Spin-Zustand beeinflussen kann.

### Silizium

Ganz allgemein kann als Kernquantenbit (CQUB) eine Konstruktion definiert werden, bei der das Substrat (D) Silizium umfasst und wobei der Kernquantenpunkt (CI) ein Isotop mit einem magnetischen Moment ist und wobei ein G-Zentrum oder ein anderes paramagnetisches Zentrum in der Nähe des Isotops mit dem von Null verschiedenen magnetischen Moment µ angeordnet ist und wobei Nähe auch hier so zu verstehen ist, dass das Magnetfeld des Kernspins des Isotops den Spin der Elektronenkonfiguration des G-Zentrums beeinflussen kann und dass der Spin der Elektronenkonfiguration des G-Zentrums bzw. des anderen paramagnetischen Zentrums den Kernspin des Isotops beeinflussen kann.

Es können auch mehrere Isotope mit von Null verschiedenen magnetischen Momenten verwendet werden. Das entsprechende Kernquantenbit (CQUB) ist dann so definiert, dass das Substrat (D) Silizium umfasst, wobei der Kernquantenpunkt (CI) ein Isotop mit einem von Null verschiedenen magnetischen Moment µ ist und wobei mindestens ein weiterer Kernquantenpunkt (CI') ein Isotop mit einem von Null verschiedenen magnetischen Moment µ ist und wobei ein G-Zentrum oder ein anderes paramagnetisches Zentrum in der Nähe des Kernquantenpunkts (CI) angeordnet ist und wobei das G-Zentrum oder das andere paramagnetische Zentrum in der Nähe des mindestens einen weiteren Kernquantenpunkts (CI') angeordnet ist und wobei Nähe hier so zu verstehen ist, dass das Magnetfeld des Kernquantenpunkts (CI) den Spin der Elektronenkonfiguration des G-Zentrums bzw. des anderen paramagnetischen Zentrums beeinflussen kann und dass das Magnetfeld des mindestens einen weiteren Kernquantenpunkts (CI') ebenfalls den Spin der Elektronenkonfiguration des G-Zentrum bzw. des anderen paramagnetischen Zentrums beeinflussen kann und dass der Spin der Elektronenkonfiguration des G-Zentrum bzw. des anderen paramagnetischen Zentrums den Kernspin des Kernquantenpunkts (CI) beeinflussen kann und dass der Spin der Elektronenkonfiguration des G-Zentrum bzw. des anderen paramagnetischen Zentrums den Kernspin des mindestens einen weiteren Kernquantenpunkts (CI') beeinflussen kann. Dies ist eine einfache QuantenALU (QUALU) auf Silizium-Basis.

Bevorzugt liegt die Kopplungsstärke zwischen einem Kernquantenbit (CI, CI') und der Elektronenkonfiguration des G-Zentrum bzw. des anderen paramagnetischen Zentrums in einem Bereich von 1 kHz bis 200 GHz und/oder besser 10 kHz bis 20 GHz und/oder besser 100 kHz bis 2 GHz und/oder besser 0,2 MHz bis 1 GHz und/oder besser 0,5 MHz bis 100 MHz und/oder besser 1 MHz bis 50 MHz, insbesondere bevorzugt bei 10 MHz.

Bevorzugt ist ein Quantenpunkt bzw. ein paramagnetisches Zentrum (NV1), beispielsweise ein G-Zentrum, mit einem Ladungsträger, im Falle des G₋-Zentrums mit einem Elektron, oder mit einer Ladungsträgerkonfiguration, im Falle des G₋-Zentrums mit einer Elektronenkonfiguration, in der Nähe des Kernquantenpunkts (CI) angeordnet. Die negative Ladung des Quantenpunkts (G-Zentrums) ergibt sich im Falle des G₋Zentrums als Quantenpunkt durch die bereits erwähnte bevorzugte n-Dotierung des Siliziums. Im Falle der Verwendung anderer Quantenpunkttypen als der von G-Zentren in Diamant, können Ladungsträger bzw. Ladungsträgerkonfiguration, Störstellenzentrum, also Quantenpunkttyp, und Dotierung des Substrats (D) bzw. der epitaktischen Schicht (DEPI) entsprechend angepasst werden. Der Ladungsträger bzw. die Ladungsträgerkonfiguration - hier beispielhaft ein Elektron bzw. eine Elektronenkonfiguration - weisen einen Ladungsträger-Spin-Zustand auf. Der Kernquantenpunkt (CI) weist einen Kern-Spin-Zustand auf. Der Begriff "Nähe" ist hierbei so zu verstehen, dass der Kern-Spin-Zustand den Ladungsträger-Spin-Zustand beeinflussen kann und/oder dass der Ladungsträger-Spin-Zustand den Kern-Spin-Zustand beeinflussen kann.

### Siliziumkarbid

Ganz allgemein kann als Kernquantenbit (CQUB) eine Konstruktion definiert werden, bei der das Substrat (D) Siliziumkarbid umfasst und wobei der Kernquantenpunkt (CI) ein Isotop mit einem von Null verschiedenen magnetischen Moment und einem Kernspin ist und wobei ein V-Zentrum oder ein anderes paramagnetisches Zentrum in der Nähe des Isotops mit dem von Null verschiedenen magnetischen Moment µ und dem Kernspin angeordnet ist und wobei Nähe auch hier so zu verstehen ist, dass das Magnetfeld des Kernspins des Isotops den Spin der Elektronenkonfiguration des V-Zentrums beeinflussen kann und dass der Spin der Elektronenkonfiguration des V-Zentrums bzw. des anderen paramagnetischen Zentrums den Kernspin des Isotops beeinflussen kann.

Es können auch mehrere Kernspins verwendet werden. Das entsprechende Kernquantenbit (CQUB) ist dann so definiert, dass das Substrat (D) Siliziumkarbid umfasst, wobei der Kernquantenpunkt (CI) ein Isotop mit einem Kernspin und einem von Null verschiedenen magnetischen Moment µ ist und wobei mindestens ein weiterer Kernquantenpunkt (CI') ein Isotop mit einem Kernspin und einem von Null verschiedenen magnetischen Moment µ ist und wobei ein V-Zentrum oder ein anderes paramagnetisches Zentrum in der Nähe des Kernquantenpunkts (CI) angeordnet ist und wobei das V-Zentrum oder das andere paramagnetische Zentrum in der Nähe des mindestens einen weiteren Kernquantenpunkts (CI') angeordnet ist und wobei Nähe hier so zu verstehen ist, dass das Magnetfeld des Kernquantenpunkts (CI) den Spin der Elektronenkonfiguration des V-Zentrums bzw. des anderen paramagnetischen Zentrums beeinflussen kann und dass das Magnetfeld des mindestens einen weiteren Kernquantenpunkts (CI') ebenfalls den Spin der Elektronenkonfiguration des V-Zentrum bzw. des anderen paramagnetischen Zentrums beeinflussen kann und dass der Spin der Elektronenkonfiguration des V-Zentrum bzw. des anderen paramagnetischen Zentrums den Kernspin des Kernquantenpunkts (CI) beeinflussen kann und dass der Spin der Elektronenkonfiguration des V-Zentrum bzw. des anderen paramagnetischen Zentrums den Kernspin des mindestens einen weiteren Kernquantenpunkts (CI') beeinflussen kann. Dies ist eine einfache QuantenALU (QUALU) auf Siliziumkarbidbasis.

Bevorzugt liegt die Kopplungsstärke zwischen einem Kernquantenbit (CI, CI') und der Elektronenkonfiguration des V-Zentrum bzw. des anderen paramagnetischen Zentrums in einem Bereich von 1 kHz bis 200 GHz und/oder besser 10 kHz bis 20 GHz und/oder besser 100 kHz bis 2 GHz und/oder besser 0,2 MHz bis 1 GHz und/oder besser 0,5 MHz bis 100 MHz und/oder besser 1 MHz bis 50 MHz, insbesondere bevorzugt bei 10 MHz.

Bevorzugt ist ein Quantenpunkt bzw. ein paramagnetisches Zentrum (NV1), beispielsweise ein V-Zentrum, mit einem Ladungsträger, im Falle des V₋-Zentrums mit einem Elektron, oder mit einer Ladungsträgerkonfiguration, im Falle des V₋-Zentrums mit einer Elektronenkonfiguration, in der Nähe des Kernquantenpunkts (CI) angeordnet. Die negative Ladung des Quantenpunkts (V-Zentrums) ergibt sich im Falle des V-Zentrums als Quantenpunkt durch die bereits erwähnte bevorzugte n-Dotierung des Siliziumkarbidmaterials. Im Falle der Verwendung anderer Quantenpunkttypen als der von V-Zentren in Siliziumkarbid, können Ladungsträger bzw. Ladungsträgerkonfiguration, Farbzentrum, also Quantenpunkttyp, und Dotierung des Substrats (D) bzw. der epitaktischen Schicht (DEPI) entsprechend angepasst werden. Der Ladungsträger bzw. die Ladungsträgerkonfiguration - hier beispielhaft ein Elektron bzw. eine Elektronenkonfiguration - weisen einen Ladungsträger-Spin-Zustand auf. Der Kernquantenpunkt (CI) weist einen Kern-Spin-Zustand auf. Der Begriff "Nähe" ist hierbei so zu verstehen, dass der Kern-Spin-Zustand den Ladungsträger-Spin-Zustand beeinflussen kann und/oder dass der Ladungsträger-Spin-Zustand den Kern-Spin-Zustand beeinflussen kann.

### Epitaktische Diamantschicht auf einem Diamantsubstrat (D)

Die hier vorgelegte Beschreibung fokussiert auf einen Quantencomputer bei dem das Substrat (D) Diamant umfasst ohne sich darauf zu beschränken. Um eine parasitäre Kopplung zwischen den NV-Zentren bzw. anderen verwendeten Störstellenzentren und den Kernspins des Substrats (D) zu unterbinden, ist es sinnvoll, wenn der Diamant eine epitaktisch aufgewachsene isotopenreine Schicht aus ¹²C-Isotopen aufweist. Isotopenreinheit liegt im Sinne dieser Offenlegung dann vor, wenn der Anteil an ¹³C-Atomen im Radius von 1µm, besser im Radius von 0,5µm, besser im Radius von 0,2µm, besser im Radius von 0,1µm, besser im Radius von 50nm, besser im Radius von 20nm um das NV-Zentrum herum kleiner als 1%, besser kleiner als 0,1%, besser kleiner als 0,01%, besser kleiner als 0,001% ist. Hierbei werden solche ¹³C-Isotope, die selbst Teil des Quanten-Computers sind oder im Betrieb des Quanten-Computers verwendet werden oder die für eine solche Verwendung vorgesehen sind, nicht mitgezählt und wie ¹²C-Isotope gewertet, da es bei dieser Qualitätsbetrachtung des Materials um eine Minimierung von unbeabsichtigten Störquellen für den Betrieb des Quanten-Computers geht. Um eine Ankopplung des Kernquantenbits (CQUB) über einen später beschriebenen Quantenbus (QBUS) zu ermöglichen, ist es bevorzugt, wenn das Substrat (D) im Bereich des Kernquantenpunkts (CI) n-dotiert ist. Dies erhöht im Falle eines NV-Zentrums (NV) in Diamant die Wahrscheinlichkeit, dass sich bei Implantation eines Stickstoffatoms tatsächlich ein NV-Zentrum (NV) am vorbestimmten Ort bildet. Ähnliche Mechanismen greifen im Falle anderer Substrate und Zentren. Wie oben bereits beschrieben, ist das Substrat (D) dann bevorzugt Diamant und im Bereich des Kernquantenpunkts (CI) mit Schwefel und zwar bevorzugt mit kernspinfreiem Schwefel und zwar besonders bevorzugt mit ³²S-Isotopen dotiert. Da die Wirkung auf die Fehlstellen (Englisch Vacancies) hier maßgeblich ist, die sich durch eine negative Ladung voneinander abstoßen, wird hierdurch eine Wirkung erzielt, die eine Zusammenballung der Fehlstellen im Kristall reduziert. Bei Verwendung anderer Isotope bzw. Atome für die Erzielung dieses Effekts ist es wichtig, dass das Substrat (D) im Bereich des Kernquantenpunkts (CI) mit kernspinfreien Isotopen dotiert wird, um die Quantenbits (QUB)und das Kernquantenbit (CQUB) nicht durch zusätzliche Wechselwirkungen zu stören.

### Epitaktische Siliziumschicht auf einem Siliziumsubstrat (D)

Die hier vorgelegte Beschreibung fokussiert auch auf einen Quantencomputer bei dem das Substrat (D) Silizium umfasst ohne sich darauf zu beschränken. Um eine parasitäre Kopplung zwischen den G-Zentren bzw. anderen verwendeten Störstellenzentren und den Kernspins des Substrats (D) zu unterbinden, ist es sinnvoll, wenn das Silizium des Substrats (D) eine epitaktisch aufgewachsene isotopenreine Schicht aus ²⁸-Isotopen (DEPI) aufweist. Isotopenreinheit liegt im Sinne dieser Offenlegung dann vor, wenn der Anteil an ²⁹Si-Atomen im Radius von 1µm, besser im Radius von 0,5µm, besser im Radius von 0,2µm, besser im Radius von 0,1µm, besser im Radius von 50nm, besser im Radius von 20nm um das G-Zentrum herum kleiner als 1%, besser kleiner als 0,1%, besser kleiner als 0,01%, besser kleiner als 0,001% ist. Hierbei werden solche ²⁹Si-Isotope, die als Kernquantenpunkte (CI) selbst Teil des Quanten-Computers sind oder im Betrieb des Quanten-Computers verwendet werden oder die für eine solche Verwendung vorgesehen sind, nicht mitgezählt und wie ²⁸Si-Isotope gewertet, da es bei dieser Qualitätsbetrachtung des Materials um eine Minimierung von unbeabsichtigten Störquellen für den Betrieb des Quanten-Computers geht. Um eine Ankopplung des Kernquantenbits (CQUB) über einen später beschriebenen Quantenbus (QBUS) zu ermöglichen, ist es bevorzugt, wenn das Substrat (D) im Bereich des Kernquantenpunkts (CI) geeignet dotiert ist. Dies erhöht im Falle eines G-Zentrums als Quantenpunkt (NV) in Silizium die Wahrscheinlichkeit, dass sich bei Implantation eines Kohlenstoffatoms tatsächlich ein G-Zentrum (NV) am vorbestimmten Ort bildet. Wie oben bereits beschrieben, ist das Substrat (D) dann bevorzugt Silizium und im Bereich des Kernquantenpunkts (CI) mit Schwefel und zwar bevorzugt mit kernspinfreiem Schwefel und zwar besonders bevorzugt mit ³²S-Isotopen dotiert. Bei Verwendung anderer Isotope bzw. Atome für die Erzielung dieses Effekts ist es wichtig, dass das Substrat (D) im Bereich des Kernquantenpunkts (CI) mit kernspinfreien Isotopen dotiert wird, um die Quantenbits (QUB)und das Kernquantenbit (CQUB) nicht durch zusätzliche Wechselwirkungen zu stören.

### Anordnung der Kernquantenpunkte

Bevorzugt wird das Kernquantenbit (CQUB) so aufgebaut, dass sich zumindest einer seiner Kernquantenpunkte (CI) in einem ersten Kernabstand (d1') längs der Lot-Linie (LOT) unter der Oberfläche (OF) des Substrats (D) und/oder der ggf. vorhandenen epitaktischen Schicht (DEPI) befindet. Dieser erste Kernabstand (d1') beträgt bevorzugt 2 nm bis 60 nm beträgt und/oder besser 5 nm bis 30 nm beträgt und/oder besser 10 nm bis 20 nm beträgt, wobei insbesondere ein erster Kernabstand (d1') von 5 nm bis 30 nm ganz besonders bevorzugt ist und angestrebt werden sollte. Die Ansteuerung des Kernquantenbits (CQUB) kann nun in analoger Weise wie die Ansteuerung der Quantenbits (QUB) erfolgen. Die Frequenz der Strompulse ist jedoch niedriger, da die Kerne der Kernquantenpunkte (CI) eine größere Masse besitzen.

Ein erfindungsgemäßes Kernquantenbit (CQUB) umfasst daher wieder eine horizontale Leitung (LH, LH1), die bevorzugt wieder Teil einer Mikrostreifenleitung und/oder Teil einer Tri-Plate-Leitung ist und eine vertikale Leitung (LV, LV1), die ebenfalls bevorzugt wieder Teil einer Mikrostreifenleitung und/oder Teil einer Tri-Plate-Leitung (SV1, LH, SV2) ist.

Die vertikale Mikrostreifenleitung des Kernquantenbits (CQUB) umfasst bevorzugt wieder eine erste vertikale Abschirmleitung (SV1) und die vertikale Leitung (LV). Die horizontale Mikrostreifenleitung umfasst analog wieder bevorzugt eine erste horizontale Abschirmleitung (SH1) und die horizontale Leitung (LH).

In analoger Weise umfasst bevorzugt eine vertikale Tri-Plate-Leitung eine erste vertikale Abschirmleitung (SV1) und eine zweite vertikale Abschirmleitung (SV2) und die vertikale Leitung (LV), die zwischen der ersten vertikalen Abschirmleitung (SV1) und der zweiten vertikalen Abschirmleitung (SV2) verläuft. Eine horizontale Tri-Plate-Leitung umfasst bevorzugt wieder eine erste horizontale Abschirmleitung (SH1) und eine zweite horizontale Abschirmleitung (SH2) und die horizontale Leitung (LV), die zwischen der ersten horizontalen Abschirmleitung (SH1) und der zweiten horizontalen Abschirmleitung (SH2) verläuft.

Wie im Falle des zuvor beschriebenen Quantenbits (QUB) wird bevorzugt die Ansteuerungsvorrichtung des hier diskutierte Kernquantenbits (CQUB) so gestaltet, dass die Summe der Ströme durch die Tri-Plate-Leitung (SV1, LV, SV2) null ist. Hierdurch wird, wie zuvor beim Quantenbit (QUB) das Feld der magnetischen Flussdichte auf den Bereich in unmittelbarer Nähe der Tri-Plate-Leitung beschränkt. In diesem Bereich sollte der Kernquantenpunkt (CI) liegen, um direkt beeinflusst werden zu können.

Wie im Falle des später noch zu beschreibenden Quantenregisters (QUREG), das aus einer Zusammenstellung mehrerer Quantenbits (QUB) besteht, kann die Bestromung aller Leitungen der Kernquantenbits (CQUB) eines später noch beschriebenen Kernquantenregisters (CQUREG) aus einer Zusammenstellung mehrerer Kernquantenbits (CQUB) so gestaltet werden, dass die durch die Bestromung der horizontalen und vertikalen Leitungen hervorgerufene magnetische Flussdichte B nur am Ort eines Kernquantenpunkts (CI) wesentlich von Null verschieden ist. Die Bestromung der Abschirmleitungen wird dabei bevorzugt so gewählt, dass die magnetische Flussdichte B unter den durch die Einfügung der Abschirmleitungen zusätzlich entstehenden Kreuzungspunkten in einer Tiefe im Substrat (D), die dem besagten ersten Abstand (d1) entspricht, im Wesentlichen ebenfalls Null ist. Hierzu kann ein erstes weiteres virtuelles vertikales Lot längs einer ersten weiteren vertikalen Lot-Linie (VLOT1) parallel zur ersten Lot-Linie (LOT) vom Ort eines ersten virtuellen vertikalen Kernquantenpunkts (VVCI1) zur Oberfläche (OF) des Substrats (D) und/oder der ggf. vorhandenen epitaktischen Schicht (DEPI) gefällt werden. Der erste virtuelle vertikale Kernquantenpunkt (VVCI1) befindet sich in dem ersten Abstand (d1) von der Oberfläche (OF). Die erste weitere vertikale Lot-Linie (VLOT1) durchstößt virtuell die Oberfläche (OF) des Substrats (D) und/oder der ggf. vorhandenen epitaktischen Schicht (DEPI) an einem ersten weiteren vertikalen Lotpunkt (VLOTP1).

Die horizontale Leitung (LH) und die erste vertikale Abschirmleitung (SV1) befinden sich bevorzugt auf der Oberfläche des Substrats (D) und/oder der ggf. vorhandenen epitaktischen Schicht (DEPI). Sie kreuzen sich und in der Nähe des ersten vertikalen Lot-Punktes (VLOTP1) oder am ersten vertikalen Lot-Punkt (VLOTP1) in dem von null verschiedenen Kreuzungswinkel (α). Ein zweites weiteres virtuelles vertikales Lot längs einer zweiten weiteren vertikalen Lot-Linie (VLOT2) kann parallel zur ersten Lot-Linie (LOT) vom Ort eines zweiten virtuellen vertikalen Kernquantenpunkts (VVCI2) zur Oberfläche (OF) des Substrats (D) und/oder der ggf. vorhandenen epitaktischen Schicht (DEPI) gefällt werden. Der zweite virtuelle vertikale Kernquantenpunkt (VVCI2) befindet sich ebenfalls sich in dem ersten Abstand (d1) von der Oberfläche (OF). Die zweite weitere vertikale Lot-Linie (VLOT2) durchdringt wieder die Oberfläche (OF) des Substrats (D) und/oder der ggf. vorhandenen epitaktischen Schicht (DEPI) an einem zweiten weiteren vertikalen Lotpunkt (VLOTP2). Die horizontale Leitung (LH) und die zweite vertikale Abschirmleitung (SV2) befinden sich ebenfalls auf der Oberfläche des Substrats (D) und/oder der ggf. vorhandenen epitaktischen Schicht (DEPI). Die horizontale Leitung (LH) und die zweite vertikale Abschirmleitung (SV2) kreuzen sich wieder in der Nähe des zweiten vertikalen Lot-Punktes (VLOTP2) oder am zweiten vertikalen Lot-Punkt (VLOTP2) in dem von null verschiedenen Kreuzungswinkel (α). Wie zuvor werden bevorzugt die Einzelströme (ISV1, IV, ISV2) durch die einzelnen Leitungen (SV1, LV, SV2) der Tri-Plate-Leitung so gewählt, dass der Betrag des ersten virtuellen vertikalen magnetischen Flussdichtevektors (B_{VVCI1}) am Ort des ersten virtuellen vertikalen Kernquantenpunkts (VVCI1) nahezu null ist und dass der Betrag des zweiten virtuellen vertikalen magnetischen Flussdichtevektors (B_{VVCI2}) am Ort des zweiten virtuellen vertikalen Kernquantenpunkts (VVCI2) nahezu null ist und dass der Betrag des magnetischen Flussdichtevektors (B_{CI}) am Ort des Kernquantenpunkts (CI) von Null verschieden ist.

Wir stellen uns ein zweidimensional angeordnetes Kernquantenregister (CQUREG) mit m Spalten und n Zeilen vor. Das Kernquantenregister (CQUREG) enthalte n x m Kernquantenbits mit hier vereinfacht angenommenen 1 Kernquantenpunkt (CI) pro Kernquantenbit (CQUB). Das Kernquantenregister (CQUREG) sei so organisiert, dass die m Kernquantenbits (CQUBi1 bis CQUBim) einer i-ten Zeile des Kernquantenregisters (CQUREG), mit 1≤i≤n die horizontale Leitung (LHi) gemeinsam haben und dass die n Kernquantenbits (CQUB1j bis CQUBnj) einer j-ten Spalte des Kernquantenregisters (CQUREG), mit 1≤j≤m die vertikale Leitung (LVj) gemeinsam haben.

Jedes Kernquantenbit (CQUBij) der n x m Kernquantenbits (CQUB) des Kernquantenregisters (CQUREG) besitzt einen Kernquantenpunkt (Clij) mit einer zugehörigen lokalen magnetischen Flussdichte (Bij) am Ort des Kernquantenpunkts (Clij). Diese zugehörigen lokalen magnetischen Flussdichten (Bij) an den Orten der Kernquantenpunkte (Clij) bilden einen magnetischen Flussdichtevektor. Um einen vorbestimmten magnetischen Flussdichtevektor zu erzeugen, muss nun in jede der Leitungen jeweils ein individuelles Stromsignal eingespeist werden. Diese Stromsignale bilden zusammen ein vektorielles Stromsignal. Die Dimension dieses Stromdichtevektors wächst nur linear mit der Summe aus der Anzahl der Zeilen n und Spalten m. Demgegenüber wächst die Anzahl der Kernquantenpunkte proportional zum Produkt aus der Anzahl der Spalten m und Zeilen n. Es ist leicht zu verstehen, dass daher bevorzugt ein Kernquantenregister (CQUREG) bevorzugt als eindimensionale Anordnung von Kernquantenbits (CQUREG) mit Kernquantenpunkten (CI) gefertigt wird.

Dieses Ergebnis kann auf die zuvor eingeführten Quantenbits (QUB) übertragen werden.

Wir stellen uns dazu in analoger Weise ein zweidimensional angeordnetes Quantenregister (QUREG) mit m Spalten und n Zeilen vor. Das Quantenregister (QUREG) enthalte in analoger Weise n x m Quantenbits (QUBij) mit hier vereinfacht angenommenen 1 Quantenpunkt (NVij) pro Kernquantenbit (QUBij). Das Quantenregister (QUREG) sei wieder so organisiert, dass die m Quantenbits (QUBi1 bis QUBim) einer i-ten Zeile des Quantenregisters (QUREG), mit 1≤i≤n die horizontale Leitung (LHi) gemeinsam haben und dass die n Quantenbits (QUB1j bis QUBnj) einer j-ten Spalte des Quantenregisters (QUREG), mit 1≤j≤m die vertikale Leitung (LVj) gemeinsam haben.

Jedes Quantenbit (QUBij) der n x m Kernquantenbits (CQUB) des Kernquantenregisters (CQUREG) besitzt einen Quantenpunkt (NVj) mit einer zugehörigen lokalen magnetischen Flussdichte (Bij) am Ort des Quantenpunkts (NVij). Diese zugehörigen lokalen magnetischen Flussdichten (Bij) an den Orten der Quantenpunkte (NVij) bilden einen magnetischen Flussdichtevektor. Um einen vorbestimmten magnetischen Flussdichtevektor zu erzeugen, muss nun in jede der Leitungen jeweils ein individuelles Stromsignal eingespeist werden. Diese Stromsignale bilden zusammen ein vektorielles Stromsignal. Die Dimension dieses Stromdichtevektors wächst ebenfalls nur linear mit der Summe aus der Anzahl der Zeilen n und Spalten m. Demgegenüber wächst die Anzahl der Quantenpunkte proportional zum Produkt aus der Anzahl der Spalten m und Zeilen n. Es ist leicht zu verstehen, dass daher bevorzugt ein Quantenregister (QUREG) bevorzugt als eindimensionale Anordnung von Quantenbits (NV) mit Quantenpunkten (NV) gefertigt wird.

Wir kommen zurück zu dem zuvor beschriebenen Kernquantenbit (CQUB).

Bevorzugt kann ein erstes weiteres virtuelles horizontales Lot längs einer ersten weiteren horizontalen Lot-Linie (HLOT1) parallel zur ersten Lot-Linie (LOT) vom Ort eines ersten virtuellen horizontalen Kernquantenpunkts (VHCI1) zur Oberfläche (OF) des Substrats (D) und/oder der ggf. vorhandenen epitaktischen Schicht (DEPI) gefällt werden. Der erste virtuelle horizontale Kernquantenpunkt (VHCIV1) befindet sich bevorzugt in dem ersten Abstand (d1) von der Oberfläche (OF). Die erste weitere horizontale Lot-Linie (HLOT1) durchstößt wieder die Oberfläche (OF) des Substrats (D) und/oder der ggf. vorhandenen epitaktischen Schicht (DEPI) an einem ersten weiteren horizontalen Lotpunkt (HLOTP1). Die vertikale Leitung (LV) und die erste horizontale Abschirmleitung (SH1) befinden sich wieder bevorzugt auf der Oberfläche des Substrats (D) und/oder der ggf. vorhandenen epitaktischen Schicht (DEPI). Die vertikale Leitung (LV) und die erste horizontale Abschirmleitung (SH1) kreuzen sich wieder bevorzugt in der Nähe des ersten horizontalen Lot-Punktes (HLOTP1) oder am ersten horizontalen Lot-Punkt (HLOTP1) in dem von null verschiedenen Kreuzungswinkel (α). Ein zweites weiteres virtuelles horizontales Lot kann längs einer zweiten weiteren horizontalen Lot-Linie (HLOT2) parallel zur ersten Lot-Linie (LOT) vom Ort eines zweiten virtuellen horizontalen Kernquantenpunkts (VHCI2) zur Oberfläche (OF) des Substrats (D) und/oder der ggf. vorhandenen epitaktischen Schicht (DEPI) gefällt werden. Der zweite virtuelle horizontale Kernquantenpunkt (VHCI2) befindet sich bevorzugt in dem ersten Abstand (d1) von der Oberfläche (OF). Die zweite weitere horizontale Lot-Linie (HLOT2) durchstößt wieder bevorzugt die Oberfläche (OF) des Substrats (D) und/oder der ggf. vorhandenen epitaktischen Schicht (DEPI) an einem zweiten weiteren horizontalen Lotpunkt (HLOTP2). Die vertikale Leitung (LV) und die zweite horizontale Abschirmleitung (SH2) befinden sich dabei ebenfalls bevorzugt auf der Oberfläche des Substrats (D) und/oder der ggf. vorhandenen epitaktischen Schicht (DEPI). Die vertikale Leitung (LV) und die zweite horizontale Abschirmleitung (SH2) kreuzen sich in analoger Weise bevorzugt in der Nähe des zweiten horizontalen Lot-Punktes (HLOTP2) oder am zweiten horizontalen Lot-Punkt (HLOTP2) in dem von null verschiedenen Kreuzungswinkel (α). Auch hier werden wieder die Einzelströme (ISH1, IH, ISH2) durch die einzelnen Leitungen (SH1, LH, SH2) der Tri-Plate-Leitung bevorzugt so gewählt, dass der Betrag des ersten virtuellen horizontalen magnetischen Flussdichtevektors (B_{VHCI1}) am Ort des ersten virtuellen horizontalen Kernquantenpunkts (VHCI1) nahezu null ist und dass der Betrag des zweiten virtuellen horizontalen magnetischen Flussdichtevektors (B_{VHCI2}) am Ort des zweiten virtuellen horizontalen Quantenpunkts (VHCI2) nahezu null ist und dass der Betrag des magnetischen Flussdichtevektors (B_{NV}) am Ort des Kernquantenpunkts (CI) von Null verschieden ist.

Um erzeugte Fotoelektronen absaugen zu können, ist im Bereich oder in der Nähe des Lotpunkts (LOTP) das Substrat (D) mittels zumindest eines ersten horizontalen ohmschen Kontakts (KH11) mit der ersten horizontalen Abschirmleitung (SH1) verbunden. Darüber hinaus ist das Substrat (D) bevorzugt im Bereich oder in der Nähe des Lotpunkts (LOTP) das Substrat (D) mittels zumindest eines zweiten horizontalen ohmschen Kontakts (KH12) mit der zweiten horizontalen Abschirmleitung (SH2) verbunden. Des Weiteren ist bevorzugt im Bereich oder in der Nähe des Lotpunkts (LOTP) das Substrat (D) mittels zumindest eines ersten vertikalen ohmschen Kontakts (KV11) mit der ersten vertikalen Abschirmleitung (SV1) verbunden. Schließlich ist bevorzugt im Bereich oder in der Nähe des Lotpunkts (LOTP) das Substrat (D) mittels zumindest eines zweiten vertikalen ohmschen Kontakts (KV12) mit der zweiten vertikalen Abschirmleitung (SV2) verbunden.

Bevorzugt umfassen solche ohmschen Kontakte (KV11, KV12, KH11, KH12) Titan.

### Erfindungsgemäße Registerkonstruktionen

### Konstruktion eines Quantenregisters (CEQUREG) aus einem Quantenpunkt (NV) und einem Kernquantenpunkt (CI)

Das grundlegende Kern-Elektron-Quantenregister (CEQUREG), das zuvor bereits angedeutet wurde, umfasst ein Kern-Quantenbit (CQUB) und ein Quantenbit (QUB).

Das allgemeine Kern-Elektron-Quantenregister (CEQUREG) umfasst mindestens ein Kern-Quantenbit (CQUB) und mindestens ein Quantenbit (QUB).

Im Folgenden wird ein Kern-Elektron-Quantenregister (CEQUREG) umfassend n, mindestens aber zwei Kern-Quantenbits (CQUB1 bis CQUBn) und ein Quantenbit (QUB) als Quanten-ALU (QUALU) bezeichnet.

Die Vorrichtung zur Ansteuerung eines Kernquantenpunkts (CI) des Kern-Quantenbits (CQUB) des Kern-Elektron-Quantenregister (CEQUREG) weist eine Teilvorrichtung (LH, LV) auf, die auch eine Teilvorrichtung (LH, LV) der Vorrichtung zur Ansteuerung des Quantenpunkts (NV) des Quantenbits (QUB) des Kern-Elektron-Quantenregisters (CEQUREG) ist.

Das erfindungsgemäße Kern-Elektron-Quantenregister (CEQUREG) umfasst daher eine Vorrichtung zur Ansteuerung des Kernquantenpunkts (CI) des Kernquantenbits (CQUB) des Kern-Elektron-Quantenregisters (CEQUREG) und zur gleichzeitigen Ansteuerung des Quantenpunkts (NV) des Quantenbits (QUB) des Kern-Elektron-Quantenregister (CEQUREG), mit einem gemeinsamen Substrat (D) des Kernquantenbits (CQUB) und des Quantenbits (QUB) und ggf. mit einer gemeinsamen epitaktischen Schicht (DEPI) des Kernquantenbits (CQUB) und des Quantenbits (QUB) und mit einer gemeinsamen Vorrichtung des Kernquantenbits (CQUB) und des Quantenbits (QUB), die zur Erzeugung eines elektromagnetischen Wellenfeldes (B_{RW}, B_{MW}) am Ort des Kernquantenpunkts (CI) und am Ort des Quantenpunkts (CI) geeignet ist. Die gemeinsame epitaktische Schicht (DEPI), sofern vorhanden, ist bevorzugt auf dem gemeinsamen Substrat (D) aufgebracht. Ggf. werden die Kernquantenpunkte (CI) zusammen mit der epitaktischen Schicht (DEPI) abgeschieden. Das gemeinsame Substrat (D) und/oder die ggf. vorhandene gemeinsame epitaktische Schicht (DEPI) weist eine Oberfläche (OF) auf. Der Kernquantenpunkt (CI) weist typischerweise ein magnetisches Moment auf. Der Quantenpunkt (NV) ist bevorzugt ein paramagnetisches Zentrum in dem gemeinsamen Substrat (D) und/oder in der ggf. vorhandenen gemeinsamen epitaktischen Schicht (DEPI).

### Quantenpunkte

Insbesondere kann es sich bei dem Quantenpunkt (NV) wieder um ein NV-Zentrum in Diamant oder ein ST1-Zetrum oder ein L2-Zentrum oder ein anderes paramagnetisches Störstellenzentrum handeln, wenn Diamant verwendet wird.

Insbesondere kann es sich bei dem Quantenpunkt (NV) wieder um ein G-Zentrum in Silizium oder ein anderes paramagnetisches Störstellenzentrum handeln, wenn Silizium verwendet wird.

Insbesondere kann es sich bei dem Quantenpunkt (NV) wieder um ein V-Zentrum in Siliziumkarbid oder ein anderes paramagnetisches Störstellenzentrum handeln, wenn Siliziumkarbid verwendet wird.

### Ansteuervorrichtung

Die gemeinsame Vorrichtung, die zur Erzeugung eines elektromagnetischen Wellenfeldes (B_{RW},B_{MW}) geeignet ist und die bevorzugt zur Ansteuerung der Kernquantenpunkte (CI) und des Quantenpunkts ident, befindet sich wieder bevorzugt sich auf der Oberfläche des gemeinsamen Substrats (D) und/oder der ggf. vorhandenen gemeinsamen epitaktischen Schicht (DEPI).

Erfindungsgemäß ist die Vorrichtung aus horizontalen Leitungen und vertikalen Leitungen zur Erzeugung eines zirkular polarisierten elektromagnetischen Wellenfeldes (B_{RW},B_{MW}) geeignet. Dies kann bei der horizontalen Leitung (LH) und der vertikalen Leitung (LV) dadurch erreicht werden, dass der Strom in der horizontalen Leitung (LH) eine horizontale Stromkomponente mit einer Frequenz aufweist und dass der Strom in der vertikalen Leitung (LV) eine vertikale Stromkomponente mit dieser Frequenz aufweist ist. Dabei ist die vertikale Stromkomponente in der vertikalen Leitung (LV) bevorzugt um +/-90° gegenüber der horizontalen Stromkomponente in der horizontalen Leitung (LH) verschoben. Die durch diese Stromkomponenten erzeugten Anteile an der magnetischen Flussdichte des magnetischen Feldes überlagern sich dann im Bereich des bzw. der Kernquantenpunkte (CI) bzw. des Quantenpunkts (NV) so, dass sich dort ein links oder rechtsherum zirkularpolarisiertes Magnetfeld ergibt.

Ähnlich, wie zuvor im Falle des Kernquantenbits (CQUB) bzw. des Quantenbits (QUB) kann nun wieder ein virtuelles Lot längs einer virtuellen Lot-Linie (LOT) vom Ort des Kernquantenpunkts (CI) und/oder vom Ort des Quantenpunkts (NV) zur Oberfläche (OF) des Substrats (D) und/oder der ggf. vorhandenen epitaktischen Schicht (DEPI) gefällt werden. Die virtuelle Lot-Linie (LOT) durchstößt wieder die Oberfläche (OF) des Substrats (D) und/oder der ggf. vorhandenen epitaktischen Schicht (DEPI) an einem Lotpunkt (LOTP). Wie zuvor befindet sich bevorzugt die Vorrichtung, die zur Erzeugung eines zirkular polarisierten elektromagnetischen Wellenfeldes, insbesondere eines Radio- und/oder Mikrowellenfeldes, geeignet ist, sich in der Nähe des Lot-Punktes (LOTP) oder am Lot-Punkt (LOTP).

Ein vorschlagsgemäßes Kern-Elektron-Quantenregister (CEQUREG) umfasst somit eine horizontale Leitung (LH) und eine vertikale Leitung (LV) als Vorrichtung, die zur Erzeugung eines zirkular polarisierten elektromagnetischen Wellenfeldes, insbesondere eines Radio- und/oder Mikrowellenfeldes, geeignet ist,

Wie zuvor befinden sich die horizontale Leitung (LH) und die vertikale Leitung (LV) bevorzugt auf der Oberfläche des Substrats (D) und/oder der ggf. vorhandenen epitaktischen Schicht (DEPI). Bevorzugt kreuzen sich die horizontale Leitung (LH) und die vertikale Leitung (LV) in der Nähe des virtuellen Lot-Punktes (LOTP) oder am Lot-Punkt (LOTP) in einem von null verschiedenen Kreuzungswinkel (α).

Erfindungsgemäß sind die horizontale Leitung (LH) von der vertikalen Leitung (LV) bevorzugt mittels einer elektrischen Isolation (IS) gegeneinander ausreichend elektrisch isoliert.

Wird das "grüne Licht" zum Zurücksetzen der Quantenpunkte nicht von der Unterseite (US) her eingestrahlt, so sollten die horizontale Leitung (LH) und/oder die vertikale Leitung (LV) für "grünes Licht" transparent sein. Dabei sollte bevorzugt insbesondere die horizontale Leitung (LH) und/oder die vertikale Leitung (LV) aus einem elektrisch leitenden und optisch für "grünes Licht" transparenten Material, insbesondere aus Indium-Zinn-Oxid (gebräuchliche Abkürzung ITO) gefertigt sein. Bevorzugt ist der Winkel (α) im Wesentlichen ein rechter Winkel.

Bevorzugt umfasst das Substrat (D) des Kern-Elektron-Quantenregisters (CEQUREG) Diamant.

### Diamant

Bevorzugt handelt es sich bei dem Material des Substrats (D) um isotopenreinen Diamant aus ¹²C-Isotopen, die keinen magnetischen Kernspin aufweisen. In dem Fall ist in einer bevorzugten Variante der Kernquantenpunkt (CI) der Atomkern eines ¹³C-Isotops, der dann im Gegensatz zu den meisten anderen ¹²C-Atomen des Substrats (D) einen magnetischen Kernspin und damit ein von Null verschiedenes magnetisches Moment µ aufweist und somit mit dem Quantenpunkt, beispielsweise mit einem NV-Zentrum, in Wechselwirkung treten kann. Dafür sollte der Quantenpunkt (NV) in der Nähe des ¹³C-Isotops, das einen Kernquantenpunkt (CI) darstellt, angeordnet sein. Wie erwähnt, ist der Quantenpunkt (NV) bevorzugt ein NV-Zentrum. Auch ist wieder die Verwendung von ST1 und L2-Zentren oder anderen paramagnetischen Störstellenzentren denkbar. Der Begriff "Nähe" hierbei so zu verstehen, dass das Magnetfeld des Kernspins des ¹³C-Atoms den Spin einer Elektronenkonfiguration des Quantenpunkts (NV), also beispielsweise der Elektronenkonfiguration eines NV-Zentrums (NV), beeinflussen kann und dass der Spin einer Elektronenkonfiguration des Quantenpunkts (NV) den Kernspin des ¹³C-Isotops, insbesondere über eine Dipol-Dipol Wechselwirkung, beeinflussen kann.

### Silizium

Bevorzugt handelt es sich bei dem Material des Substrats (D) um isotopenreines Silizium aus ²⁸Si-Isotopen, die keinen magnetischen Kernspin aufweisen. In dem Fall ist in einer bevorzugten Variante der Kernquantenpunkt (CI) der Atomkern eines ²⁹Si-Isotops, der dann im Gegensatz zu den meisten anderen ²⁸Si-Atomen des Substrats (D) einen magnetischen Kernspin aufweist und damit ein von Null verschiedenes magnetisches Moment µ und somit mit dem Quantenpunkt (NV), beispielsweise mit einem G-Zentrum, in Wechselwirkung treten kann. Dafür sollte der Quantenpunkt (NV) in der Nähe des ²⁹Si-Isotops, das einen Kernquantenpunkt (CI) darstellt, angeordnet sein. Wie erwähnt ist der Quantenpunkt (NV) bevorzugt ein G-Zentrum. Auch ist wieder die Verwendung anderer paramagnetischer Störstellenzentren denkbar. Der Begriff "Nähe" hierbei so zu verstehen, dass das Magnetfeld des Kernspins des ²⁹Si-Atoms den Spin einer Elektronenkonfiguration des Quantenpunkts (NV), also beispielsweise der Elektronenkonfiguration eines G-Zentrums, beeinflussen kann und dass der Spin einer Elektronenkonfiguration des Quantenpunkts (NV) den Kernspin des ²⁹Si-Isotops, insbesondere über eine Dipol-Dipol Wechselwirkung, beeinflussen kann.

### Siliziumkarbid

Bevorzugt handelt es sich bei dem Material des Substrats (D) um isotopenreines Siliziumkarbid aus ²⁸Si-Isotopen und ¹²C-Isotopen, die beide keinen magnetischen Kernspin aufweisen. In dem Fall ist in einer bevorzugten Variante der Kernquantenpunkt (CI) der Atomkern eines ²⁹Si-Isotops oder der Atomkern eines ¹³C-Isotops, der dann im Gegensatz zu den meisten anderen ²⁸Si-Atomen und ¹²C-Atomen des Substrats (D) einen magnetischen Kernspin aufweist und damit ein von Null verschiedenes magnetisches Moment µ und somit mit dem Quantenpunkt (NV), beispielsweise mit einem V-Zentrum, in Wechselwirkung treten kann. Dafür sollte der Quantenpunkt (NV) in der Nähe des ²⁹Si-Isotops bzw. in der Nähe des ¹³C-Isotops, das einen Kernquantenpunkt (CI) darstellt, angeordnet sein. Wie erwähnt ist der Quantenpunkt (NV) bevorzugt ein V-Zentrum. Auch ist wieder die Verwendung anderer paramagnetischer Störstellenzentren denkbar. Der Begriff "Nähe" hierbei so zu verstehen, dass das Magnetfeld des Kernspins des ²⁹Si-Atoms bzw. des ¹³C-Atoms den Spin einer Elektronenkonfiguration des Quantenpunkts (NV), also beispielsweise der Elektronenkonfiguration eines V-Zentrums, beeinflussen kann und dass der Spin einer Elektronenkonfiguration des Quantenpunkts (NV) den Kernspin des ²⁹Si-Isotops bzw. des des ¹³C-Isotops, insbesondere über eine Dipol-Dipol Wechselwirkung, beeinflussen kann.

Ganz allgemein kann das Kern-Elektron-Quantenregister (CEQUREG) einen Quantenpunkt (NV) aufweisen, bei dem der Quantenpunkt (NV) ein paramagnetisches Zentrum mit einem Ladungsträger oder einer Ladungsträgerkonfiguration ist und in der Nähe des Kernquantenpunkts (CI) angeordnet ist. Der Ladungsträger bzw. die Ladungsträgerkonfiguration weist dabei einen Ladungsträger-Spin-Zustand auf. Der Kernquantenpunkt (CI) weist einen Kern-Spin-Zustand auf. Der Begriff "Nähe" ist hierbei, wie oben, hier so zu verstehen ist, dass der Kernspinzustand den Ladungsträger-Spin-Zustand beeinflussen kann und/oder umgekehrt, dass der Ladungsträger-Spin-Zustand den Kernspinzustand beeinflussen kann. Bevorzugt ist dabei der Frequenzbereich der Kopplungsstärke mindestens 1 kHz und/oder besser mindestens 1 MHz und weniger als 20 MHz. Anders ausgedrückt ist bevorzugt der Frequenzbereich der Kopplungsstärke 1 kHz bis 200 GHz und/oder besser 10 kHz bis 20 GHz und/oder besser 100 kHz bis 2 GHz und/oder besser 0,2 MHz bis 1 GHz und/oder besser 0,5 MHz bis 100 MHz und/oder besser 1 MHz bis 50 MHz, insbesondere besonders bevorzugt ca. 10 MHz.

### Konstruktion einer Quanten-ALU (QUALU)

Nachdem nun die Begriffe Quantenbit (QUB), Kernquantenbit (CQUB), Quantenregister (QUREG) und Kernquantenregister (CQUREG) sowie Kern-Elektron-Quantenregister (CEQUREG) beschrieben wurden, wird nun die erste Quantencomputerkomponente definiert. Sie wird im Folgenden Quanten-ALU (QUALU) genannt. Sie besitzt einen ersten Quantenpunkt (NV), im Falle von Diamant als Material des Substrats (D) beispielsweise ein NV-Zentrum (NV) oder im Falle von Silizium als Material des Substrats (D) beispielsweise ein G-Zentrum oder im Falle von Siliziumkarbid als Material des Substrats (D) beispielsweise ein V-Zentrum, das quasi als Terminal für den Standardblock "Quanten-ALU (QUALU)" dient. Dieses Terminal kann dann über eine überlappende Kette von Quantenregistern (QUREG) aus mindestens zwei Quantenpunkten (NV) mit einem anderen Quantenpunkt (NV) einer anderen QuantenALU (QUALU) gekoppelt werden. Dies andere QuantenALU (QUALU) kann dabei so weit entfernt von der ersten QuantenALU beabstandet sein, dass die Kernquantenpunkte der ersten QuantenALU nicht mit den Kernquantenpunkten der zweiten QuantenALU direkt koppeln. Diese Kopplung kann nur mit Hilfe der überlappenden Kette von Quantenregistern (QUREG) erfolgen, deren Quantenpunkte (NV) als Ancilla-Bits eine indirekte Kopplung der Kernquantenpunkte der ersten QuantenALU mit den Kernquantenpunkten der zweiten QuantenALU (QUALU) ermöglichen. Die überlappende Kette von Quantenregistern (QUREG) spielt in der hier vorgeschlagenen Architektur somit die Rolle eines Quantenbusses (QUBUS) analog zu einem Datenbus in einem normalen Mikrorechner. Jedoch werden nicht die Daten über diesen Quantenbus (QUBUS) transportiert, sondern Abhängigkeiten. Die eigentlichen Berechnungen werden dann in den jeweiligen Quanten-ALUs (QUALU) durchgeführt, die an den Quantenbus (QUBUS) über ihre Quantenpunkte (NV) angeschlossen sind. Dies ist die grundlegende Idee des hier dargestellten Quantencomputers. Er ist eine Kombination aus QuantenALUs, bestehend aus Kern-Elektron-Quantenregistern (CEQUREG), verbunden über Quantenbusse (QUBUS) bestehend aus Quantenregistern (QUREG) in verschiedensten Topologien.

Eine solche QuantenALU (QUALU) umfasst daher bevorzugt ein erstes Kern-Quantenbit (CQUB1) und typischerweise mindestens ein zweites Kern-Quantenbit (CQUB2). Bevorzugt weist eine solche QuantenALU (QUALU) eine massiv höhere Anzahl p an Kern-Quantenbits (CQUB1 bis CQUBp) auf. Da die Abstände von dem jeweiligen Kernquantenpunkt (Clj) des j-ten Kern-Elektron-Quantenregisters (CEQUREGj) der p Kern-Elektron-Quantenregister (CEQUREG1 bis CEQUREGp) der QuantenALU (QUALU) zu dem vorzugsweise gemeinsamen Quantenpunkt (NV) der p Kern-Elektron-Quantenregister (CEQUREG1 bis CEQUREGp) in der Regel unterschiedlich sind, sind die Kopplungsstärken und damit die im Folgenden erläuterten Elektron-Kern-Resonanzfrequenzen und die Kern-Elektron-Resonanzfrequenzen für die jeweiligen Kern-Elektron-Quantenregister (CEQUREGj) (1≤j≤p) der p Kern-Elektron-Quantenregister (CEQUREG1 bis CEQUREGp) unterschiedlich. Somit ist eine Adressierung der einzelnen Kernquantenpunkte (Clj) der p Kernquantenpunkte (CI1 bis Clp) der Quanten-ALU (QUALU) mittels dieser unterschiedlichen Kern-Elektron-Resonanzfrequenzen und Elektron-Kern-Resonanzfrequenzen möglich.

Eine Quanten-ALU (QUALU) umfasst also bevorzugt ein Quantenbit (QUB), das mit dem ersten Kern-Quantenbit (CQUB1) ein erstes Kern-Elektron-Quantenregister (CEQUREG1) bildet und mit dem zweiten Kern-Quantenbit (CQUB2) ein zweites Kern-Elektron-Quantenregister (CEQUREG2) bildet.

Besonders bevorzugt weist die Vorrichtung zur Ansteuerung des ersten Kernquantenpunkts (CI1) des ersten Kern-Quantenbits (CQUB1) des ersten Kern-Elektron-Quantenregisters (CEQUREG1) eine Teilvorrichtung (LH, LV) auf, die auch die Teilvorrichtung (LH, LV) der Vorrichtung zur Ansteuerung des Quantenpunkts (NV) des Quantenbits (QUB) des ersten Kern-Elektron-Quantenregisters (CEQUREG1) ist und die auch die Vorrichtung zur Ansteuerung des zweiten Kernquantenpunkts (CI2) des zweiten Kern-Quantenbits (CQUB2) des zweiten Kern-Elektron-Quantenregisters (CEQUREG2) ist.

### Konstruktion eines homogenen Quantenregisters (QUREG)

Ein homogenes Quantenregister (QUREG) oder kurz nur Quantenregister (QUREG) umfasst nur Quantenpunkte (NV) eines Quantenpunkttyps. Ein solches Quantenregister umfasst bevorzugt ein erstes Quantenbit (QUB1) und mindestens ein zweites Quantenbit (QUB2). Eine Kette aus solchen Quantenregistern (QUB) ist der wesentliche Teil des im Folgenden erläuterten Quantenbusses (QUBUS), der den Transport von Abhängigkeiten erlaubt. Die Eigenschaft der Homogenität des Quantenregisters (QUREG) drückt sich vorschlagsgemäß so aus, dass der erste Quantenpunkttyp des ersten Quantenpunkts (NV1) des ersten Quantenbits (QUB1) des Quantenregisters (QUREG) gleich dem zweiten Quantenpunkttyp des zweiten Quantenpunkts (NV2) des zweiten Quantenbits (QUB2) des Quantenregisters (QUREG) ist. Beispielsweise kann es sich bei dem ersten Quantenpunkttyp um ein NV-Zentrum in Diamant als Substrat handeln und bei dem zweiten Quantenpunkttyp ebenfalls um ein NV-Zentrum im gleichen Substrat handeln. Beispielsweise kann es sich in analoger Weise bei dem ersten Quantenpunkttyp um ein G-Zentrum in Silizium als Material des Substrats (D) handeln und bei dem zweiten Quantenpunkttyp ebenfalls um ein G-Zentrum im gleichen Substrat (D) handeln. Beispielsweise kann es sich in analoger Weise bei dem ersten Quantenpunkttyp um ein V-Zentrum in Siliziumkarbid als Material des Substrats (D) handeln und bei dem zweiten Quantenpunkttyp ebenfalls um ein V-Zentrum im gleichen Substrat (D) handeln Typischerweise ist das Substrat (D) dem ersten Quantenbit (QUB1) des Quantenregisters (QUREG) und dem zweiten Quantenbit (QUB2) des Quantenregisters (QUREG) gemeinsam. Im Folgenden wird zur besseren Klarheit der Quantenpunkt (NV) des ersten Quantenbits (QUB1) des Quantenregisters (QUREG) der erste Quantenpunkt (NV1) genannt und der Quantenpunkt (NV) des zweiten Quantenbits (QUB2) des Quantenregisters (QUREG) der zweite Quantenpunkt (NV2) genannt. Analog wird zur besseren Klarheit im Folgenden die horizontale Leitung (LH) des ersten Quantenbits (QUB1) des Quantenregisters (QUREG) im Folgenden als erste horizontale Leitung (LH1) bezeichnet und die horizontale Leitung (LH) des zweiten Quantenbits (QUB2) des Quantenregisters (QUREG) als die zweite horizontale Leitung (LH2) bezeichnet. Ebenso wird im Folgenden die vertikale Leitung (LV) des ersten Quantenbits (QUB1) im Folgenden als erste vertikale Leitung (LV1) bezeichnet und die vertikale Leitung (LV) des zweiten Quantenbits (QUB2) im Folgenden als zweite vertikale Leitung (LV2) bezeichnet. Es ist sinnvoll, wenn z.B. die erste horizontale Leitung (LH1) identisch mit der zweiten horizontalen Leitung (LH2) ist. Alternativ ist es sinnvoll, wenn z.B. die erste vertikale Leitung (LV1) identisch mit der zweiten vertikalen Leitung (LV2) ist.

Bevorzugt sind die erste horizontale Leitung (LH1) und die zweite horizontale Leitung (LH2) und die erste vertikale Leitung (LV) und die zweite vertikale Leitung im Wesentlichen aus Isotopen ohne magnetisches Moment µ gefertigt. Im Wesentlichen bedeutet dabei, dass der Gesamtanteil K_{1G} der Isotope mit magnetischen Moment eines Elements, das Bestandteil einer oder mehrerer der Leitungen ist, bezogen auf 100% dieses Elements, das Bestandteil dieser Leitungen ist, gegenüber den in den obigen Tabellen angegebenen natürlichen Gesamtanteil K_{1G} auf einen Anteil K_{1G}' der Isotope mit magnetischen Moment eines Elements, das Bestandteil einer oder mehrerer dieser Leitungen bezogen auf 100% dieses Elements, das einer oder mehrerer Leitungen ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element einer oder mehrerer der Leitungen im Einwirkungsbereich der als Quantenpunkte (NV) benutzten paramagnetischen Störstellen (NV) und/oder der als Kernquantenpunkten (CI) benutzten nuklearen Spins ist.

Das Quantenregister (QUREG) sollte zur Erfüllung der bestimmungsgemäßen Funktion so klein gebaut werden, dass das Magnetfeld des zweiten Quantenpunkts (NV2) des zweiten Quantenbits (QUB2) des Quantenregisters (QUREG) das Verhalten des ersten Quantenpunkts (NV1) des ersten Quantenbits (QUB1) des Quantenregisters (QUREG) zumindest zeitweise beeinflusst und/oder dass das Magnetfeld des ersten Quantenpunkts (NV1) des ersten Quantenbits (QUB1) das Verhalten des zweiten Quantenpunkts (NV2) des zweiten Quantenbits (QUB2) zumindest zeitweise beeinflusst.

Bevorzugt ist hierzu der räumliche Abstand (sp12) zwischen dem ersten Quantenpunkt (NV1) des ersten Quantenbits (QUB1) des Quantenregisters (QUREG) und dem zweiten Quantenpunkt (NV2) des zweiten Quantenbits (QUB2) des Quantenregisters (QUREG) so klein, dass das Magnetfeld des zweiten Quantenpunkts (NV2) des zweiten Quantenbits (QUB2) des Quantenregisters (QUREG) das Verhalten des ersten Quantenpunkts (NV1) des ersten Quantenbits (QUB1) des Quantenregisters (QUREG) zumindest zeitweise beeinflusst, und/oder dass das Magnetfeld des ersten Quantenpunkts (NV1) des ersten Quantenbits (QUB1) des Quantenregisters (QUREG) das Verhalten des zweiten Quantenpunkts (NV2) des zweiten Quantenbits (QUB2) des Quantenregisters (QUREG) zumindest zeitweise beeinflusst. Bevorzugt beträgt hierzu der zweite Abstand (sp12) zwischen dem ersten Quantenpunkt (NV1) des ersten Quantenbits (QUB1) des Quantenregisters (QUREG) und dem zweiten Quantenpunkt (NV2) des zweiten Quantenbits (QUB2) des Quantenregisters (QUREG) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der zweite Abstand (sp12) zwischen dem ersten Quantenpunkt (NV1) des ersten Quantenbits (QUB1) des Quantenregisters (QUREG) und dem zweiten Quantenpunkt (NV2) des zweiten Quantenbits (QUB2) des Quantenregisters (QUREG) zwischen 30 nm und 2 nm und/oder weniger als 10 nm und/oder weniger als 5 nm und/oder weniger als 2 nm.

Ein solches Quantenregister kann verkettet werden. Das zuvor beschriebene Zwei-Bit-Quantenregister wurde längs der horizontalen Leitung (LH) aufgereiht, die den beiden Quantenbits (QUB1, QUB2) gemeinsam ist. Statt der horizontalen Aneinanderreihung ist eine vertikale Aneinanderreihung längs der vertikalen Leitung ebenso denkbar. Die horizontale und die vertikale Leitung tauschen dann die Funktion. Auch ist eine zweidimensionale Aneinanderreihung denkbar, was einer Kombination dieser Möglichkeiten entspricht.

Statt eines Zweibit-Quantenregisters (QUREG) ist auch die Aneinanderreihung von n Quantenbits (QUB1 bis QUBn) denkbar. Beispielhaft wird hier ein Dreibit-Quantenregister beschrieben, das längs der horizontalen Leitung (LH) beispielhaft fortgesetzt wird. Für folgende Quantenbits (QUB4 bis QUBn) gilt dann entsprechendes. Das Quantenregister kann natürlich auch in die andere Richtung um m Quantenbits (QUB0 bis QUB(m-1)) erweitert werden. Zur Vereinfachung der Beschreibung beschränkt sich der hier vorgelegte Text auf positive Werte der Indices von 1 bis n.

Durch eine beispielhafte lineare Verkettung der n Quantenbits (QUB1 bis QUBn) längs einer beispielhaften eindimensionalen Linie innerhalb eines n-Bit-Quantenregisters (QUREG), beispielsweise längs der besagten vertikalen Leitung (LV) oder längs der besagten horizontalen Leitung (LH) kann der räumliche Abstand (sp1n) zwischen dem ersten Quantenpunkt (NV1) des ersten Quantenbits (QUB1) des n-Bit-Quantenregisters (QUREG) und dem n-ten Quantenpunkt (NVn) des n-ten Quantenbits (QUBn) des n-Bit-Quantenregisters (QUREG) so groß, dass der erste Quantenpunkt (NV1) des ersten Quantenbits (QUB1) des n-Bit-Quantenregisters (QUREG) nicht mehr mit dem n-ten Quantenpunkt (NVn) des n-ten Quantenbits (QUBn) des n-Bit-Quantenregisters (QUREG) verkoppelt ist oder direkt verschränkt werden kann. Zur Vereinfachung nehmen wir an, dass die n Quantenpunkte (NV1 bis NVn) der n Quantenpunkte (QUB1 bis QUBn) abzählbar längs der besagten eindimensionalen Line aufgereiht sind. Diese eindimensionale Linie kann auch gekrümmt oder eckig sein. Somit sollen die n Quantenpunkte (NV1 bis NVn) und damit ihre jeweiligen Quantenbits (QUB1 bis QUBn) in diesem Beispiel eine Kette von n Quantenpunkten (NV1 bis NVn) darstellen, die mit dem ersten Quantenpunkt (NV1) beginnt und mit dem n-ten Quantenpunkt (NVn) endet. Innerhalb dieser Kette von n Quantenpunkten (NV1 bis NVn) sind die Quantenpunkte (NV1 bis NVn) und damit auch die Quantenbits (QUB1 bis QUBn) abzählbar und können damit mit ganzen positiven Zahlen von 1 bis n durchnummeriert werden.

Damit geht innerhalb der Kette einem j-ten Quantenpunkt (NVj) ein (j-1)-ter Quantenpunkt (NV(j-1)) voraus, der im Folgenden der Vorgängerquantenpunkt (NV(j-1)) genannt wird. Damit geht innerhalb der Kette einem j-ten Quantenbit (QUBj) mit dem j-ten Quantenpunkt (NVj) ein (j-1)-tes Quantenbit (QUB(j-1)) mit dem (j-1)-ter Quantenpunkt (NV(j-1)) voraus, das im Folgenden das Vorgängerquantenbit (QUB(j-1)) genannt wird.

Damit folgt innerhalb der Kette einem j-ten Quantenpunkt (NVj) ein (j+1)-ter Quantenpunkt (NV(j+1)) nach, der im Folgenden der Nachfolgerquantenpunkt (NV(j+1)) genannt wird. Damit folgt innerhalb der Kette einem j-ten Quantenbit (QUBj) mit dem j-ten Quantenpunkt (NVj) ein (j+1)-tes Quantenbit (QUB(j+1)) mit dem (j+1)-ter Quantenpunkt (NV(j+1)) nach, der im Folgenden das Nachfolgerquantenbit (QUB(j-1)) genannt wird. Hierbei soll der Index j in Bezug auf diese beispielhafte Kette hier eine beliebige ganze positive Zahl mit 1<j<n sein, wobei n eine ganze positive Zahl mit n>2 sein soll.

Innerhalb der Kette weist der j-te Quantenpunkt (NVj) dann einen Abstand (sp(j-1)j), seinen Vorgängerabstand, auf. Bevorzugt ist hierzu dieser räumliche Abstand (sp(j-1)j) zwischen dem j-ten Quantenpunkt (NVj) des j-ten Quantenbits (QUBj) des Quantenregisters (QUREG) und dem vorausgehenden (j-1)-ten Quantenpunkt (NV(j-1)) des (j-1)-ten Quantenbits (QUB(j-1)) des Quantenregisters (QUREG) so klein, dass das Magnetfeld des vorausgehenden (j-1)-ten Quantenpunkts (NV(j-1)) des (j-1)-ten Quantenbits (QUB(j-1)) des n-Bit-Quantenregisters (QUREG) das Verhalten des j-ten Quantenpunkts (NVj) des j-ten Quantenbits (QUBj) des n-Bit-Quantenregisters (QUREG) zumindest zeitweise beeinflusst, und/oder dass das Magnetfeld des j-ten Quantenpunkts (NVj) des j-ten Quantenbits (QUBj) des n-Bit-Quantenregisters (QUREG) das Verhalten des vorausgehenden (j-1)-ten Quantenpunkts (NV(j-1)) des (j-1)-ten Quantenbits (QUB(j-1)) des Quantenregisters (QUREG) zumindest zeitweise beeinflusst. Bevorzugt beträgt hierzu der Abstand (sp(j-1)1) zwischen dem j-ten Quantenpunkt (NVj) des j-ten Quantenbits (QUBj) des n-Bit-Quantenregisters (QUREG) und dem vorausgehenden (j-1)-ten Quantenpunkt (NV(j-1)) des (j-1)-ten Quantenbits (QUB(j-1)) des n-Bit-Quantenregisters (QUREG) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (sp(j-1)j) zwischen dem j-ten Quantenpunkt (NVj) des j-ten Quantenbits (QUBj) des n-Bit-Quantenregisters (QUREG) und dem vorausgehenden (j-1)-ten Quantenpunkt (NV(j-1)) des (j-1)-ten Quantenbits (QUB(j-1)) des n-Bit-Quantenregisters (QUREG) zwischen 30 nm und 2 nm und/oder weniger als 10 nm und/oder weniger als 5 nm und/oder weniger als 2 nm.

Innerhalb der Kette weist der j-te Quantenpunkt (NVj) dann einen Abstand (spj(j+1)), seinen Nachfolgerabstand, auf. Bevorzugt ist hierzu dieser räumliche Abstand (spj(j+1)) zwischen dem j-ten Quantenpunkt (NVj) des j-ten Quantenbits (QUBj) des Quantenregisters (QUREG) und dem nachfolgenden (j+1)-ten Quantenpunkt (NV(j+1)) des (j+1)-ten Quantenbits (QUB(j+1)) des Quantenregisters (QUREG) so klein, dass das Magnetfeld des nachfolgenden (j+1)-ten Quantenpunkts (NV(j+1)) des (j+1)-ten Quantenbits (QUB(j+1)) des n-Bit-Quantenregisters (QUREG) das Verhalten des j-ten Quantenpunkts (NVj) des j-ten Quantenbits (QUBj) des n-Bit-Quantenregisters (QUREG) zumindest zeitweise beeinflusst, und/oder dass das Magnetfeld des j-ten Quantenpunkts (NVj) des j-ten Quantenbits (QUBj) des n-Bit-Quantenregisters (QUREG) das Verhalten des nachfolgenden (j+1)-ten Quantenpunkts (NV(j+1)) des (j+1)-ten Quantenbits (QUB(j+1)) des n-Bit-Quantenregisters (QUREG) zumindest zeitweise beeinflusst. Bevorzugt beträgt hierzu der Abstand (spj(j+1)) zwischen dem j-ten Quantenpunkt (NVj) des j-ten Quantenbits (QUBj) des n-Bit-Quantenregisters (QUREG) und dem nachfolgenden (j+1)-ten Quantenpunkt (NV(j+1)) des (j+1)-ten Quantenbits (QUB(j+1)) des n-Bit-Quantenregisters (QUREG) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (spj(j+1)) zwischen dem j-ten Quantenpunkt (NVj) des j-ten Quantenbits (QUBj) des n-Bit-Quantenregisters (QUREG) und dem nachfolgenden (j+1)-ten Quantenpunkt (NV(j+1)) des (j+1)-ten Quantenbits (QUB(j+1)) des n-Bit-Quantenregisters (QUREG) zwischen 30 nm und 2 nm und/oder weniger als 10 nm und/oder weniger als 5 nm und/oder weniger als 2 nm.

Innerhalb der Kette weist der erste Quantenpunkt (NV1) dann einen ersten Abstand (sp12), seinen Nachfolgerabstand, auf. Bevorzugt ist hierzu dieser erste räumliche Abstand (sp12) zwischen dem ersten Quantenpunkt (NV1) des ersten Quantenbits (QUB1) des Quantenregisters (QUREG) und dem nachfolgenden zweiten Quantenpunkt (NV2) des zweiten Quantenbits (QUB2) des Quantenregisters (QUREG) so klein, dass das Magnetfeld des nachfolgenden zweiten Quantenpunkts (NV2) des zweiten Quantenbits (QUB2) des n-Bit-Quantenregisters (QUREG) das Verhalten des ersten Quantenpunkts (NV1) des ersten Quantenbits (QUB1) des n-Bit-Quantenregisters (QUREG) zumindest zeitweise beeinflusst, und/oder dass das Magnetfeld des ersten Quantenpunkts (NV1) des ersten Quantenbits (QUB1) des n-Bit-Quantenregisters (QUREG) das Verhalten des nachfolgenden zweiten Quantenpunkts (NV2) des zweiten Quantenbits (QUB2) des n-Bit-Quantenregisters (QUREG) zumindest zeitweise beeinflusst. Bevorzugt beträgt hierzu der Abstand (sp12) zwischen dem ersten Quantenpunkt (NV1) des ersten Quantenbits (QUB1) des n-Bit-Quantenregisters (QUREG) und dem nachfolgenden zweiten Quantenpunkt (NV2) des zweiten Quantenbits (QUB2) des n-Bit-Quantenregisters (QUREG) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (sp12) zwischen dem ersten Quantenpunkt (NV1) des ersten Quantenbits (QUB1) des n-Bit-Quantenregisters (QUREG) und dem nachfolgenden zweiten Quantenpunkt (NV2) des zweiten Quantenbits (QUB2) des n-Bit-Quantenregisters (QUREG) zwischen 30 nm und 2 nm und/oder weniger als 10 nm und/oder weniger als 5 nm und/oder weniger als 2 nm.

Innerhalb der Kette weist der n-te Quantenpunkt (NVn) dann einen Abstand (sp(n-1)n), seinen Vorgängerabstand, auf. Bevorzugt ist hierzu dieser räumliche Abstand (sp(n-1)n) zwischen dem n-ten Quantenpunkt (NVn) des n-ten Quantenbits (QUBn) des Quantenregisters (QUREG) und dem vorausgehenden (n-1)-ten Quantenpunkt (NV(n-1)) des (n-1)-ten Quantenbits (QUB(n-1)) des Quantenregisters (QUREG) so klein, dass das Magnetfeld des vorausgehenden (n-1)-ten Quantenpunkts (NV(n-1)) des (n-1)-ten Quantenbits (QUB(n-1)) des n-Bit-Quantenregisters (QUREG) das Verhalten des n-ten Quantenpunkts (NVn) des n-ten Quantenbits (QUBn) des n-Bit-Quantenregisters (QUREG) zumindest zeitweise beeinflusst, und/oder dass das Magnetfeld des j-ten Quantenpunkts (NVn) des n-ten Quantenbits (QUBn) des n-Bit-Quantenregisters (QUREG) das Verhalten des vorausgehenden (n-1)-ten Quantenpunkts (NV(n-1)) des (n-1)-ten Quantenbits (QUB(n-1)) des Quantenregisters (QUREG) zumindest zeitweise beeinflusst. Bevorzugt beträgt hierzu der Abstand (sp(n-1)1) zwischen dem n-ten Quantenpunkt (NVn) des n-ten Quantenbits (QUBn) des n-Bit-Quantenregisters (QUREG) und dem vorausgehenden (n-1)-ten Quantenpunkt (NV(n-1)) des (n-1)-ten Quantenbits (QUB(n-1)) des n-Bit-Quantenregisters (QUREG) weniger als 50 nm und/oder weniger als 30 nm und/oder weniger als 20 nm und/oder weniger als 10 nm und/oder weniger als 10 nm und/oder weniger als 5 nm und/oder weniger als 2 nm beträgt, und/oder der Abstand (sp(n-1)n) zwischen dem n-ten Quantenpunkt (NVn) des n-ten Quantenbits (QUBn) des n-Bit-Quantenregisters (QUREG) und dem vorausgehenden (n-1)-ten Quantenpunkt (NV(n-1)) des (n-1)-ten Quantenbits (QUB(n-1)) des n-Bit-Quantenregisters (QUREG) zwischen 30 nm und 2 nm und/oder weniger als 10 nm und/oder weniger als 5 nm und/oder weniger als 2 nm beträgt.

Innerhalb der Kette kann dann der erste Quantenpunkt (NV1) im Verhältnis zum n-ten Quantenpunkt (NVn) dann einen Abstand (sp1n), seine Kettenlänge, aufweisen. Bevorzugt ist hierzu dieser räumliche Abstand (sp1n) zwischen dem ersten Quantenpunkt (NV1) des ersten Quantenbits (QUB1) des Quantenregisters (QUREG) am Anfang der Kette und dem n-ten Quantenpunkt (NVn) des n-ten Quantenbits (QUBn) des n-Bit-Quantenregisters (QUREG) am Ende der Kette so groß sein, dass das Magnetfeld des ersten Quantenpunkts (NV1) des ersten Quantenbits (QUB1) des n-Bit-Quantenregisters (QUREG) am Anfang der Kette das Verhalten des n-ten Quantenpunkts (NVn) des n-ten Quantenbits (QUBn) des n-Bit-Quantenregisters (QUREG) am Ende der Kette nicht mehr wesentlich beeinflussen kann, und/oder dass das Magnetfeld des n-ten Quantenpunkts (NVn) des n-ten Quantenbits (QUBn) des n-Bit-Quantenregisters (QUREG) am Ende der Kette das Verhalten des ersten Quantenpunkts (NV1) des ersten Quantenbits (QUB1) des n-Bit-Quantenregisters (QUREG) am Anfang der Kette nicht mehr direkt beeinflussen kann, sondern nur noch mit Hilfe der n-2 Quantenpunkte (NV2 bis NV(n-1)) zwischen dem ersten Quantenpunkt (NV1) und dem n-ten Quantenpunkt (NVn).

Die im Folgenden beschriebenen Prinzipien für ein Dreibit-Quantenregister können daher auf ein n-Bit-Quantenregister mit mehr als drei Quantenbits (n>3) übertragen werden. Daher werden diese Prinzipien für ein Mehrbitquantenregister nicht mehr ausgeführt, da sie sich für den Fachmann aus der folgenden Beschreibung eines Dreibit-Quantenregisters leicht ergeben. Solche Mehrbitquantenregister sind von der Beanspruchung ausdrücklich mit umfasst.

Ein Dreibit-Quantenregister ist dann ein Quantenregister, wie es zuvor beschrieben wurde, mit mindestens einem dritten Quantenbit (QUB3) entsprechend der vorhergehenden Beschreibung. Bevorzugt sind dann der erste Quantenpunkttyp des ersten Quantenpunkts (NV1) des ersten Quantenbits (QUB1) und der zweite Quantenpunkttyp des zweiten Quantenpunkts (NV2) des zweiten Quantenbits (QUB2) gleich dem dritten Quantenpunkttyp des dritten Quantenpunkts (NV3) des dritten Quantenbits (QUB3).

Bevorzugt ist bei einem solchen beispielhaften Dreibit-Quantenregister das Substrat (D) dem ersten Quantenbit (QUB1) und dem zweiten Quantenbit (QUB2) und dem dritten Quantenbit (QUB3) gemeinsam. Der Quantenpunkt (NV) des dritten Quantenbits (QUB3) wird im Folgenden als dritter Quantenpunkt (NV3) bezeichnet. Bevorzugt ist die horizontale Leitung (LH) des dritten Quantenbits (QUB3) die besagte erste horizontale Leitung (LH1) und damit gemeinsam mit der horizontalen Leitung (LH) des zweiten Quantenbits (QUB2) und der horizontalen Leitung (LH) des ersten Quantenbits (QUB1). Die vertikale Leitung (LV) des dritten Quantenbits (QUB3) wird im Folgenden als dritte vertikale Leitung (LV3) bezeichnet. Statt dieser Aufreihung der Quantenbits längs der ersten horizontalen Leitung (LH1) sind, wie bereits erwähnt andere Aufreihungen denkbar.

Um nun einen Transport von Abhängigkeiten von Quanteninformationen zu ermöglichen, ist es sinnvoll, wenn das Magnetfeld des zweiten Quantenpunkts (NV2) des zweiten Quantenbits (QUB2) das Verhalten des dritten Quantenpunkts (NV3) des dritten Quantenbits (QUB3) zumindest zeitweise beeinflussen kann und/oder wenn das Magnetfeld des dritten Quantenpunkts (NV3) des dritten Quantenbits (QUB3) das Verhalten des zweiten Quantenpunkts (NV2) des zweiten Quantenbits (QUB2) zumindest zeitweise beeinflussen kann. Hierdurch entsteht dabei das, was im Folgenden als Quantenbus bezeichnet wird und zum Transport von Abhängigkeiten der Quanteninformationen der Quantenpunkte des so entstehenden Quantenbusses (QUBUS) dient.

Um diese Abhängigkeiten zu ermöglichen, ist es sinnvoll, wenn der räumliche Abstand (sp23) zwischen dem dritten Quantenpunkt (NV3) des dritten Quantenbits (QUB3) und dem zweiten Quantenpunkt (NV2) des zweiten Quantenbits (QUB2) so klein ist, dass das Magnetfeld des zweiten Quantenpunkts (NV2) des zweiten Quantenbits (QUB2) das Verhalten des dritten Quantenpunkts (NV3) des dritten Quantenbits (QUB3) zumindest zeitweise beeinflussen kann, und/oder dass das Magnetfeld des dritten Quantenpunkts (NV3) des dritten Quantenbits (QUB3) das Verhalten des zweiten Quantenpunkts (NV2) des zweiten Quantenbits (QUB2) zumindest zeitweise beeinflussen kann.

Um diese Kopplung zu erreichen, ist es wieder sinnvoll, wenn der räumliche Abstand (sp23) zwischen dem dritten Quantenpunkt (NV3) des dritten Quantenbits (QUB3) und dem zweiten Quantenpunkt (NV2) des zweiten Quantenbits (QUB2) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm beträgt und/oder wenn der räumliche Abstand (sp23) zwischen dem dritten Quantenpunkt (NV3) des dritten Quantenbits (QUB3) und dem zweiten Quantenpunkt (NV2) des zweiten Quantenbits (QUB2) zwischen 30 nm und 2 nm und/oder weniger als 10 nm und/oder weniger als 5 nm und/oder weniger als 2 nm, beträgt.

Wie oben bereits erläutert, sind die Quantenbits (QUB) des Quantenregisters (QUREG) bevorzugt in einem eindimensionalen Gitter angeordnet. Eine Anordnung in einem zweidimensionalen Gitter ist möglich, aber nicht so vorteilhaft, da dann die Stromgleichungen nicht mehr ohne Weiteres eindeutig gelöst werden können.

Bevorzugt sind somit die Quantenbits (QUB) des Quantenregisters (QUREG) in einem ein- oder zweidimensionalen Gitter aus Elementarzellen von Anordnungen von einem oder mehreren Quantenpunkten (NV) mit einem zweiten Abstand (sp12) als Gitterkonstante für den Abstand zwischen den jeweiligen Elementarzellen angeordnet.

### Konstruktion eines inhomogenen Quantenregisters (IHQUREG)

Ein inhomogenes Quantenregister (IHQUREG) besteht nun im Gegensatz zu einem homogenen Quantenregister (QUREG) aus Quantenpunkten (NV) unterschiedlicher Quantenpunkttypen.

Beispielsweise kann es sich bei einem Quantenpunkt (NV) des inhomogenen Quantenregisters (IHQUREG) um ein NV-Zentrum (NV) in Diamant als einen ersten Quantenpunkttyp handeln und bei einem anderen Quantenpunkt (NV) einem Quantenpunkt (NV) des inhomogenen Quantenregisters (IHQUREG) um ein SiV-Zentrum in Diamant als einen zweiten Quantenpunkttyp handeln.

Ein inhomogenes Quantenregister (IHQUREG) umfasst somit bevorzugt ein erstes Quantenbit (QUB1) und mindestens ein zweites Quantenbit (QUB2), wobei der erste Quantenpunkttyp des ersten Quantenpunkts (NV1) des ersten Quantenbits (QUB1) des inhomogenen Quantenregisters (IHQUREG) vom zweiten Quantenpunkttyp des zweiten Quantenpunkts (NV2) des zweiten Quantenbits (QUB2) des inhomogenen Quantenregisters (IHQUREG) verschieden ist.

Bevorzugt ist jedoch das Substrat (D) dem ersten Quantenbit (QUB1) und dem zweiten Quantenbit (QUB2) gemeinsam. Im Folgenden wird auch hier der Quantenpunkt (NV) des ersten Quantenbits (QUB1) des inhomogenen Quantenregisters (IHQUREG) der erste Quantenpunkt (NV1) des inhomogenen Quantenregisters (IHQUREG) genannt und der Quantenpunkt (NV) des zweiten Quantenbits (QUB2) des inhomogenen Quantenregisters (IHQUREG) der zweite Quantenpunkt (NV2) des inhomogenen Quantenregisters (IHQUREG) genannt.

Analog dazu wird wieder die horizontale Leitung (LH) des ersten Quantenbits (QUB1) des inhomogenen Quantenregisters (IHQUREG) im Folgenden als erste horizontale Leitung (LH1) bezeichnet und die horizontale Leitung (LH) des zweiten Quantenbits (QUB2) als zweite horizontale Leitung (LH2) bezeichnet.

In analoger Weise wird bevorzugt die vertikale Leitung (LV) des ersten Quantenbits (QUB1) des inhomogenen Quantenregisters (IHQUREG) im Folgenden als erste vertikale Leitung (LV1) bezeichnet und die vertikale Leitung (LV) des zweiten Quantenbits (QUB2) im Folgenden als zweite vertikale Leitung (LV2) bezeichnet. Es ist sinnvoll, wenn z.B. die erste horizontale Leitung (LH1) identisch mit der zweiten horizontalen Leitung (LH1) ist. Alternativ ist es sinnvoll, wenn z.B. die erste vertikale Leitung (LV1) identisch mit der zweiten vertikalen Leitung (LV1) ist.

Bevorzugt sind die erste horizontale Leitung (LH1) und die zweite horizontale Leitung (LH2) und die erste vertikale Leitung (LV) und die zweite vertikale Leitung im Wesentlichen aus Isotopen ohne magnetisches Moment µ gefertigt. Im Wesentlichen bedeutet dabei, dass der Gesamtanteil K_{1G} der Isotope mit magnetischen Moment eines Elements, das Bestandteil einer oder mehrerer der Leitungen ist, bezogen auf 100% dieses Elements, das Bestandteil dieser Leitungen ist, gegenüber den in den obigen Tabellen angegebenen natürlichen Gesamtanteil K_{1G} auf einen Anteil K_{1G}' der Isotope mit magnetischen Moment eines Elements, das Bestandteil einer oder mehrerer dieser Leitungen bezogen auf 100% dieses Elements, das einer oder mehrerer Leitungen ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element einer oder mehrerer der Leitungen im Einwirkungsbereich der als Quantenpunkte (NV) benutzten paramagnetischen Störstellen (NV) und/oder der als Kernquantenpunkten (CI) benutzten nuklearen Spins ist.

Bevorzugt wird das inhomogene Quantenregister (IHQUREG) so gestaltet, dass das Magnetfeld des zweiten Quantenpunkts (NV2) des zweiten Quantenbits (QUB2) des inhomogenen Quantenregisters (IHQUREG) das Verhalten des ersten Quantenpunkts (NV1) des ersten Quantenbits (QUB1) des inhomogenen Quantenregisters (IHQUREG) zumindest zeitweise beeinflusst und/oder dass das Magnetfeld des ersten Quantenpunkts (NV1) des ersten Quantenbits (QUB1) des inhomogenen Quantenregisters (IHQUREG) das Verhalten des zweiten Quantenpunkts (NV2) des zweiten Quantenbits (QUB2) des inhomogenen Quantenregisters (IHQUREG) zumindest zeitweise beeinflusst.

Hierzu wird wieder bevorzugt der räumliche Abstand (sp12) zwischen dem ersten Quantenpunkt (NV1) des ersten Quantenbits (QUB1) des inhomogenen Quantenregisters (IHQUREG) und dem zweiten Quantenpunkt (NV2) des zweiten Quantenbits (QUB2) des inhomogenen Quantenregisters (IHQUREG) so klein gewählt, dass das Magnetfeld des zweiten Quantenpunkts (NV2) des zweiten Quantenbits (QUB2) des inhomogenen Quantenregisters (IHQUREG) das Verhalten des ersten Quantenpunkts (NV1) des ersten Quantenbits (QUB1) des inhomogenen Quantenregisters (IHQUREG) zumindest zeitweise beeinflusst, und/oder dass das Magnetfeld des ersten Quantenpunkts (NV1) des ersten Quantenbits (QUB1) des inhomogenen Quantenregisters (IHQUREG) das Verhalten des zweiten Quantenpunkts (NV2) des zweiten Quantenbits (QUB2) des inhomogenen Quantenregisters (IHQUREG) zumindest zeitweise beeinflusst. Bevorzugt beträgt der zweite Abstand (sp12) zwischen dem ersten Quantenpunkt (NV1) des ersten Quantenbits (QUB1) des inhomogenen Quantenregisters (IHQUREG) und dem zweiten Quantenpunkt (NV2) des zweiten Quantenbits (QUB2) des inhomogenen Quantenregisters (IHQUREG) weniger als 50 nm und/oder besser weniger als 30 nm und/oder besser weniger als 20 nm und/oder besser weniger als 10 nm beträgt und/oder besser weniger als 10 nm und/oder besser weniger als 5 nm und/oder besser weniger als 2 nm, und/oder der zweite Abstand (sp12) zwischen dem ersten Quantenpunkt (NV1) des ersten Quantenbits (QUB1) des inhomogenen Quantenregisters (IHQUREG) und dem zweiten Quantenpunkt (NV2) des zweiten Quantenbits (QUB2) des inhomogenen Quantenregisters (IHQUREG) beträgt bevorzugt zwischen 30 nm und 2 nm und/oder besser weniger als 10 nm und/oder besser weniger als 5 nm und/oder besser weniger als 2 nm.

Bevorzugt sind die Quantenbits des inhomogenen Quantenregisters (IHQUREG) aus Elementarzellen von Anordnungen von zwei oder mehreren Quantenbits in einem ein- oder zweidimensionalen Gitter für die jeweilige Elementarzelle angeordnet.

Bevorzugt sind die Quantenbits des inhomogenen Quantenregisters (IHQUREG) in einem ein- oder zweidimensionalen Gitter aus Elementarzellen von Anordnungen bestehend aus einem oder mehreren Quantenbits mit einem zweiten Abstand (sp12) als Gitterkonstante für die jeweilige Elementarzelle angeordnet.

### Konstruktion eines Kernquantenregisters (CCQUREG)

Ein weiterer Aspekt des Konzepts betrifft ein Kern-Kern-Quantenregister (CCQUREG). Das Kern-Kern-Quantenregister (CCQUREG) umfasst ein erstes Kernquantenbit (CQUB1) und, wie zuvor beschrieben mindestens ein zweites solches Kernquantenbit (CQUB2). Wichtig ist hierbei, dass die Kernquantenpunkte (CI1, CI2) der Kernquantenbits (CQUB1, CQUB2) so dicht bei einander positioniert sein sollten, dass sie miteinander wechselwirken können, ohne dass dazu ein Quantenpunkt (NV), also beispielsweise ein NV-Zentrum (NV) bei Diamant als Material des Substrats (D) oder ein G-Zentrum bei Silizium als Material des Substrats (D), zur Hilfe genommen werden muss. Aufgrund der Schwierigkeiten bei dieser sehr dichten Platzierung wird dieses Kernquantenregister (CCQUREG) hier nur der Vollständigkeit halber aufgeführt. Derzeit ist eine Fertigung nur durch einen Zufallsprozess möglich, bei dem die Kernquantenpunkte (CI1, CI2) zufällig nah genug beieinander zu liegen kommen. Auch ist es denkbar, mittels eines STM auf der Oberfläche eines Substrats die Isotope der späteren Kernquantenpunkte, beispielsweise als dichte Line solcher Isotope, nebeneinander anzuordnen und dann das umgebende Material abzuscheiden.

Nichtsdestotrotz können solche Kern-Quantenregister (CCQUREG) mittels Implantation kernspinbehafteter Isotope in das Substrat (D) schon heute mit sehr niedriger Ausbeute hergestellt werden.

Wird Diamant als Substrat (D) verwendet, können beispielsweise chemische Verbindungen mit mehreren ¹³C-Atomen, also beispielsweise organische Moleküle, implantiert werden. Hierdurch kommen die ¹³C-Isotope nahe beieinander zu liegen. Umfasst das Molekül auch ein Stickstoffatom, so kann eine Quanten-ALU (QUALU), wie oben beschrieben, auf diese Weise sehr einfach hergestellt in Diamant als Substrat (D) hergestellt werden. Das Substrat (D) wird bevorzugt zuvor durch Anbringen von Justiermarken vorbereitet. Dies kann durch Lithografie und zwar im Besonderen durch Elektronen- und/oder lonenstrahllithografie erfolgen. Das Molekül wird implantiert, anschließend wird ein Temperaturschritt zum Ausheilen des Kristalls, z.B. des Diamantsubstrats, durchgeführt. Später im Prozess wird die Lage des entstandenen Quantenpunkts, beispielsweise eines NV-Zentrums, optisch durch Bestrahlung mit "grünem Licht" festgestellt, dass im Falle von NV-Zentren in Diamant beispielsweise die NV-Zentren zur roten Fluoreszenz angeregt. Bevorzugt geschieht dies in einem STED-Mikroskop. Hierdurch ist die Lokalisierung mit ausreichender Genauigkeit relativ zu den zuvor aufgebrachten Justiermarken möglich. Bevorzugt in Abhängigkeit von dem Lokalisierungsergebnis erfolgt dann z.B. mittels Elektronenstrahllithografie der Fertigung der horizontalen und vertikalen Leitungen (LV, LH).

Für andere Materialien des Substrates (D) und/oder andere paramagnetische Störstellenzentren gilt entsprechendes.

Wie zuvor ist auch hier typischerweise das Substrat (D) dem ersten Kernquantenbit (CQUB1) und dem zweiten Kernquantenbit (CQUB2) gemeinsam. Der Kernquantenpunkt (CI) des ersten Kernquantenbits (CQUB1) wird im Folgenden als der erste Kernquantenpunkt (CI1) und der Kernquantenpunkt (CI) des zweiten Quantenbits (CQUB2) im Folgenden als der zweite Kernquantenpunkt (CI2) bezeichnet. Analog zu den zuvor beschriebenen Registern wird die horizontale Leitung (LH) des ersten Kernquantenbits (CQUB1) im Folgenden als erste horizontale Leitung (LH1) und die horizontale Leitung (LH) des zweiten Kernquantenbits (CQUB2) die besagte erste horizontale Leitung (LH1) und die vertikale Leitung (LV) des ersten Kernquantenbits (CQUB1) im Folgenden als erste vertikale Leitung (LV1) und die vertikale Leitung (LV) des zweiten Kernquantenbits (CQUB2) im Folgenden als zweite vertikale Leitung (LV2) bezeichnet.

Liegen die Kernquantenpunkte (CI1, CI2) des Kern-Kern-Quantenregisters (CCQUREG) nah genug beieinander, so kann das Magnetfeld des zweiten Kernquantenpunkts (CI2) des zweiten Kernquantenbits (CQUB2) das Verhalten des ersten Kernquantenpunkts (CI1) des ersten Kernquantenbits (CQUB1) zumindest zeitweise beeinflussen und/oder das Magnetfeld des ersten Kernquantenpunkts (CI1) des ersten Kernquantenbits (CQUB1) das Verhalten des zweiten Kernquantenpunkts (CI2) des zweiten Kernquantenbits (CQUB2) zumindest zeitweise beeinflussen. Dies kann für Quantenoperationen genutzt werden.

Hierzu sollte bevorzugt der räumliche Abstand (sp12) zwischen dem ersten Kernquantenpunkt (CI1) des ersten Kernquantenbits (CQUB1) und dem zweiten Kernquantenpunkt (CI2) des zweiten Kernquantenbits (CQUB2) so klein sein, dass das Magnetfeld des zweiten Kernquantenpunkts (CI2) des zweiten Kernquantenbits (CQUB2) das Verhalten des ersten Kernquantenpunkts (CI1) des ersten Kernquantenbits (CQUB1) zumindest zeitweise beeinflussen kann, und/oder dass das Magnetfeld des ersten Kernquantenpunkts (CI1) des ersten Kernquantenbits (CQUB1) das Verhalten des zweiten Kernquantenpunkts (CI2) des zweiten Quantenbits (CQUB2) zumindest zeitweise beeinflussen kann.

Hierzu sollte bevorzugt der vierte Abstand (sp12') zwischen dem ersten Kernquantenpunkt (CI1) des ersten Kernquantenbits (CQUB1) und dem zweiten Kernquantenpunkt (CI2) des zweiten Kernquantenbits (CQUB2) weniger als 100pm und/oder besser weniger als 50pm und/oder besser weniger als 30pm und/oder besser weniger als 20pm und/oder besser weniger als 10pm betragen.

Sofern möglich, sollten die Kernquantenbits des Kern-Kern-Quantenregisters (CCQUREG) in einem ein- oder zweidimensionalen Gitter angeordnet werden.

Bevorzugt sind die Kernquantenbits des Kern-Kern-Quantenregisters (CCQUREG) in einem ein- oder zweidimensionalen Gitter aus Elementarzellen von Anordnungen von einem oder mehreren Kernquantenbits mit einem zweiten Abstand (sp12) als Gitterkonstante für die jeweilige Elementarzelle angeordnet. Bei einer typischerweise auftretenden, geeigneten unsymmetrischen Positionierung des Quantenpunkts (NV) relativ zu dem ein- bzw. zweidimensionalen Gitter der Kernquantenpunkte (CI) sind die Kopplungsenergien der Paare aus jeweils einem Kernquantenpunkt der Kernquantenpunkte (CI1, CI2) des ein- oder zweidimensionalen Kernquantenpunktgitters mit dem Quantenpunkt (NV) dann von Paar zu Paar verschieden. Dies ermöglicht dann eine Selektion bzw. Adressierung der einzelnen voneinander verschiedenen Paare aus Kernquantenpunkt (CI) und Quantenpunkt (NV). Hierdurch können Quantenoperationen auf das betreffende Paar aus Kernquantenpunkt (CI) und Quantenpunkt (NV) beschränkt werden.

Auch die Kern-Kern-Quantenregister (CCQUREG) können inhomogen ausgeführt werden. Ein solches inhomogenes Kern-Kern-Quantenregister (CCQUREG) ist dadurch gekennzeichnet, dass mindestens ein Kernquantenpunkt ein anderes Isotop aufweist als ein weiterer Kernquantenpunkt des Kern-Kern-Quantenregisters (CCQUREG). Beispielsweise kann ein Kern-Kern-Quantenregister (CCQUREG) in Diamant als Material des Substrats (D) ein ¹³C-Isotop als ersten Kernquantenpunkt (CI1) aufweisen und ein ¹⁵N-Isotop als zweiten Kernquantenpunkt (CI2), die bei ausreichender Nähe miteinander wechselwirken.

Ein solches Kern-Kern-Quantenregister (CCQUREG) kann verkettet werden. Das zuvor beschriebene Zwei-Bit- Kern-Kern-Quantenregister (CCQUREG) wurde längs der horizontalen Leitung (LH) aufgereiht, die den beiden Kernquantenbits (CQUB1, CQUB2) gemeinsam ist. Statt der horizontalen Aneinanderreihung ist eine vertikale Aneinanderreihung längs der vertikalen Leitung ebenso denkbar. Die horizontale und die vertikale Leitung tauschen dann die Funktion. Auch ist eine zweidimensionale Aneinanderreihung denkbar, was einer Kombination dieser Möglichkeiten entspricht.

Statt eines Zweibit- Kern-Kern-Quantenregister (CCQUREG) ist auch die Aneinanderreihung von n Kernquantenbits (CQUB1 bis CQUBn) denkbar. Beispielhaft wird hier ein Dreibit- Kern-Kern-Quantenregister (CCQUREG) beschrieben, das längs der horizontalen Leitung (LH) beispielhaft fortgesetzt wird. Für folgende Kernquantenbits (QUB4 bis QUBn) gilt dann entsprechendes. Das Kern-Kern-Quantenregister (CCQUREG) kann natürlich auch in die andere Richtung um m Kernquantenbits (CQUB0 bis CQUB(m-1)) erweitert werden. Zur Vereinfachung der Beschreibung beschränkt sich der hier vorgelegte Text auf positive Werte der Indices von 1 bis n.

Durch eine beispielhafte lineare Verkettung der n Kernquantenbits (CQUB1 bis CQUBn) längs einer beispielhaften eindimensionalen Linie innerhalb eines n-Bit-Kern-Kern-Quantenregister (CCQUREG), beispielsweise längs der besagten vertikalen Leitung (LV) oder längs der besagten horizontalen Leitung (LH) kann der räumliche Abstand (sp1n) zwischen dem ersten Kernquantenpunkt (CI1) des ersten Kernquantenbits (QUB1) des n-Bit-Quantenregisters (QUREG) und dem n-ten Kernquantenpunkt (Cln) des n-ten Kernquantenbits (CQUBn) des n-Bit-Kern-Kern-Quantenregister (CCQUREG) so groß, dass der erste Kernquantenpunkt (CI1) des ersten Kernquantenbits (CQUB1) des n-Bit-Kern-Kern-Quantenregister (CCQUREG) nicht mehr mit dem n-ten Kernquantenpunkt (Cln) des n-ten Kernquantenbits (CQUBn) des n-Bit- Kern-Kern-Quantenregister (CCQUREG) verkoppelt ist oder direkt verschränkt werden kann. Zur Vereinfachung nehmen wir an, dass die n Kernquantenpunkte (CI1 bis Cln) der n Kernquantenpunkte (CQUB1 bis CQUBn) abzählbar längs der besagten eindimensionalen Line aufgereiht sind. Diese eindimensionale Linie kann auch gekrümmt oder eckig sein. Somit sollen die n Kernquantenpunkte (CI1 bis CIn) und damit typischerweise auch ihre jeweiligen Kernquantenbits (CQUB1 bis CQUBn) in diesem Beispiel eine Kette von n Kernquantenpunkten (CI1 bis CIn) darstellen, die mit dem ersten Kernquantenpunkt (CI1) beginnt und mit dem n-ten Kernquantenpunkt (Cln) endet. Innerhalb dieser Kette von n Kernquantenpunkten (CI1 bis Cln) sind die Kernquantenpunkte (CI1 bis CIn) und damit typischerweise auch die Kernquantenbits (CQUB1 bis CQUBn) des Kern-Kern-Quantenregisters (CCQUREG) abzählbar und können damit mit ganzen positiven Zahlen von 1 bis n durchnummeriert werden.

Damit geht innerhalb der Kette einem j-ten Kernquantenpunkt (Clj) ein (j-1)-ter Kernquantenpunkt (CI(j-1)) voraus, der im Folgenden der Vorgängerkernquantenpunkt (CI(j-1)) genannt wird. Damit geht typischerweise auch innerhalb der Kette einem j-ten Kernquantenbit (CQUBj) mit dem j-ten Kernquantenpunkt (Clj) ein (j-1)-tes Kernquantenbit (CQUB(j-1)) des Kern-Kern-Quantenregisters (CCQUREG) mit dem (j-1)-ter Kernquantenpunkt (CI(j-1)) voraus, das im Folgenden das Vorgängerkernquantenbit (CQUB(j-1)) genannt wird.

Damit folgt innerhalb der Kette einem j-ten Kernquantenpunkt (Clj) ein (j+1)-ter Kernquantenpunkt (CI(j+1)) nach, der im Folgenden der Nachfolgerkernquantenpunkt (CI(j+1)) genannt wird. Damit folgt innerhalb der Kette einem j-ten Kernquantenbit (CQUBj) mit dem j-ten Kernquantenpunkt (Clj) ein (j+1)-tes Kernquantenbit (CQUB(j+1)) mit dem (j+1)-ten Kernquantenpunkt (CI(j+1)) nach, der im Folgenden das Nachfolgerkernquantenbit (CQUB(j-1)) genannt wird. Hierbei soll der Index j in Bezug auf diese beispielhafte Kette hier eine beliebige ganze positive Zahl mit 1<j<n sein, wobei n eine ganze positive Zahl mit n>2 sein soll.

Innerhalb der Kette weist der j-te Kernquantenpunkt (Clj) dann einen Abstand (sp'(j-1)j), seinen Vorgängerabstand, auf. Bevorzugt ist hierzu dieser räumliche Abstand (sp'(j-1)j) zwischen dem j-ten Kernquantenpunkt (Clj) des j-ten Kernquantenbits (CQUBj) des n-Bit-Kern-Kern-Quantenregisters (CCQUREG) und dem vorausgehenden (j-1)-ten Kernquantenpunkt (CI(j-1)) des (j-1)-ten Kernquantenbits (CQUB(j-1)) des Kern-Kern-Quantenregister (CCQUREG) so klein, dass das Magnetfeld des vorausgehenden (j-1)-ten Kernquantenpunkts (CI(j-1)) des (j-1)-ten Kernquantenbits (CQUB(j-1)) des n-Bit- Kern-Kern-Quantenregisters (CCQUREG) das Verhalten des j-ten Kernquantenpunkts (Clj) des j-ten Kernquantenbits (CQUBj) des n-Bit- Kern-Kern-Quantenregisters (CCQUREG) zumindest zeitweise beeinflusst, und/oder dass das Magnetfeld des j-ten Kernquantenpunkts (Clj) des j-ten Kernquantenbits (CQUBj) des n-Bit- Kern-Kern-Quantenregisters (CCQUREG) das Verhalten des vorausgehenden (j-1)-ten Kernquantenpunkts (CI(j-1)) des (j-1)-ten Kernquantenbits (CQUB(j-1)) des Kern-Kern-Quantenregisters (CCQUREG) zumindest zeitweise beeinflusst. Bevorzugt beträgt hierzu der Abstand (sp'(j-1)1) zwischen dem j-ten Kernquantenpunkt (Clj) des j-ten Kernquantenbits (CQUB1) des n-Bit-Kern-Kern-Quantenregister (CCQUREG) und dem vorausgehenden (j-1)-ten Kernquantenpunkt (CI(j-1)) des (j-1)-ten Kernquantenbits (CQUB(j-1)) des n-Bit-Kern-Kern-Quantenregisters (CCQUREG) weniger als 200 pm und/oder besser weniger als 100 pm und/oder besser weniger als 50 pm und/oder besser weniger als 30 pm und/oder besser weniger als 20 pm und/oder besser weniger als 10 pm. und/oder der Abstand (sp'(j-1)j) zwischen dem j-ten Kernquantenpunkt (Clj) des j-ten Kernquantenbits (CQUBj) des n-Bit- Kern-Kern-Quantenregisters (CCQUREG) und dem vorausgehenden (j-1)-ten Kernquantenpunkt (CI(j-1)) des (j-1)-ten Kernquantenbits (CQUB(j-1)) des n-Bit Kern-Kern-Quantenregisters (CCQUREG) zwischen 200 pm und 2 pm und/oder besser zwischen als 100 pm und 5 pm und/oder besser weniger als 50 pm und/oder besser weniger als 30 pm und/oder besser weniger als 20 pm und/oder besser weniger als 10 pm und 2pm.

Beispielsweise kann eine Kette von ¹³C-Isotopen mittels der Verschiebung einzelner ¹³C-Atome auf einer Diamantoberfläche eines ¹²C-Diamanten als Substrat (D) mit solchen Abständen benachbarter ¹³C-Atome zueinander gefertigt werden, die dann mittels eines CVD-Verfahrens mit einer ¹²C-Schicht abgedeckt und stabilisiert wird. Die ¹³C-Atome dieser Kette von ¹³C-Atomen sind dann miteinander verkoppelt.

Innerhalb der Kette weist der j-te Kernquantenpunkt (Clj) dann einen Abstand (sp'j(j+1)), seinen Nachfolgerabstand, auf. Bevorzugt ist hierzu dieser räumliche Abstand (sp'j(j+1)) zwischen dem j-ten Kernquantenpunkt (Clj) des j-ten Kernquantenbits (CQUBj) des Kern-Kern-Quantenregisters (CCQUREG) und dem nachfolgenden (j+1)-ten Kernquantenpunkt (CI(j+1)) des (j+1)-ten Kernquantenbits (CQUB(j+1)) des Kern-Kern-Quantenregisters (CCQUREG) so klein, dass das Magnetfeld des nachfolgenden (j+1)-ten Kernquantenpunkts (CI(j+1)) des (j+1)-ten Kernquantenbits (CQUB(j+1)) des n-Bit- Kern-Kern-Quantenregisters (CCQUREG) das Verhalten des j-ten Kernquantenpunkts (Clj) des j-ten Kernquantenbits (CQUBj) des n-Bit- Kern-Kern-Quantenregisters (CCQUREG) zumindest zeitweise beeinflusst, und/oder dass das Magnetfeld des j-ten Kernquantenpunkts (Clj) des j-ten Kernquantenbits (CQUBj) des n-Bit- Kern-Kern-Quantenregisters (CCQUREG) das Verhalten des nachfolgenden (j+1)-ten Kernquantenpunkts (CI(j+1)) des (j+1)-ten Kernquantenbits (CQUB(j+1)) des n-Bit-Kern-Kern-Quantenregisters (CCQUREG) zumindest zeitweise beeinflusst. Bevorzugt beträgt hierzu der Abstand (sp'j(j+1)) zwischen dem j-ten Kernquantenpunkt (Clj) des j-ten Kernquantenbits (CQUB1) des n-Bit-Kern-Kern-Quantenregisters (CCQUREG) und dem nachfolgenden (j+1)-ten Kernquantenpunkt (CI(j+1)) des (j+1)-ten Kernquantenbits (CQUB(j+1)) des n-Bit-Kern-Kern-Quantenregisters (CCQUREG) weniger als 200 pm und/oder weniger als 100 pm und/oder weniger als 50 pm und/oder weniger als 20 pm beträgt und/oder weniger als 10 pm und/oder weniger als 5 pm und/oder weniger als 2 pm, und/oder der Abstand (sp'j(j+1)) zwischen dem j-ten Kernquantenpunkt (Clj) des j-ten Kernquantenbits (CQUBj) des n-Bit-Kern-Kern-Quantenregisters (CCQUREG) und dem nachfolgenden (j+1)-ten Kernquantenpunkt (CI(j+1)) des (j+1)-ten Kernquantenbits (CQUB(j+1)) des n-Bit-Kern-Kern-Quantenregisters (CCQUREG) zwischen 200pm und 2 pm und/oder weniger als 100 pm und/oder weniger als 50 pm und/oder weniger als 20 pm.

Innerhalb der Kette weist der erste Kernquantenpunkt (CI1) dann einen ersten Abstand (sp'12), seinen Nachfolgerabstand, auf. Bevorzugt ist hierzu dieser erste räumliche Abstand (sp'12) zwischen dem ersten Kernquantenpunkt (CI1) des ersten Kernquantenbits (CQUB1) des n-Bit-Kern-Kern-Quantenregisters (CCQUREG) und dem nachfolgenden zweiten Kernquantenpunkt (CI2), typischerweise des zweiten Kernquantenbits (CQUB2) des n-Bit-Kern-Kern-Quantenregisters (CCQUREG), so klein, dass das Magnetfeld des nachfolgenden zweiten Kernquantenpunkts (CI2) des zweiten Kernquantenbits (CQUB2) des n-Bit-Kern-Kern-Quantenregisters (CCQUREG) das Verhalten des ersten Kernquantenpunkts (CI1) des ersten Kernquantenbits (CQUB1) des n-Bit-Kern-Kern-Quantenregisters (CCQUREG) zumindest zeitweise beeinflusst, und/oder dass das Magnetfeld des ersten Kernquantenpunkts (CI1) des ersten Kernquantenbits (CQUB1) des n-Bit-Kern-Kern-Quantenregisters (CCQUREG) das Verhalten des nachfolgenden zweiten Kernquantenpunkts (CI2) des zweiten Kernquantenbits (CQUB2) des n-Bit-Kern-Kern-Quantenregisters (CCQUREG) zumindest zeitweise beeinflusst. Bevorzugt beträgt hierzu der Abstand (sp'12) zwischen dem ersten Kernquantenpunkt (CI1) des ersten Kernquantenbits (CQUB1) des n-Bit-Kern-Kern-Quantenregisters (CCQUREG) und dem nachfolgenden zweiten Kernquantenpunkt (CI2) des zweiten Kernquantenbits (CQUB2) des n-Bit-Kern-Kern-Quantenregisters (CCQUREG) weniger als 200 pm und/oder weniger als 100 pm und/oder weniger als 50 pm und/oder weniger als 20 pm beträgt und/oder weniger als 10 pm und/oder weniger als 5 pm und/oder weniger als 2 pm, und/oder der Abstand (sp'12) zwischen dem ersten Kernquantenpunkt (CI1) des ersten Kernquantenbits (CQUB1) des n-Bit-Kern-Kern-Quantenregisters (CCQUREG) und dem nachfolgenden zweiten Kernquantenpunkt (CI2) des zweiten Kernquantenbits (CQUB2) des n-Bit-Kern-Kern-Quantenregisters (CCQUREG) zwischen 200 pm und 2 pm und/oder weniger als 100 pm und/oder weniger als 50 pm und/oder weniger als 20 pm.

Innerhalb der Kette weist der n-te Kernquantenpunkt (Cln) dann einen Abstand (sp'(n-1)n), seinen Vorgängerabstand, auf. Bevorzugt ist hierzu dieser räumliche Abstand (sp'(n-1)n) zwischen dem n-ten Kernquantenpunkt (Cln) des n-ten Kernquantenbits (CQUBn) des n-Bit-Kern-Kern-Quantenregisters (CCQUREG) und dem vorausgehenden (n-1)-ten Kernquantenpunkt (CI(n-1)) des (n-1)-ten Kernquantenbits (CQUB(n-1)) des n-Bit-Kern-Kern-Quantenregisters (CCQUREG) so klein, dass das Magnetfeld des vorausgehenden (n-1)-ten Kernquantenpunkts (CI(n-1)) des (n-1)-ten Kernquantenbits (CQUB(n-1)) des n-Bit-Kern-Kern-Quantenregisters (CCQUREG) das Verhalten des n-ten Kernquantenpunkts (Cln) des n-ten Kernquantenbits (CQUBn) des n-Bit-Kern-Kern-Quantenregisters (CCQUREG) zumindest zeitweise beeinflusst, und/oder dass das Magnetfeld des j-ten Kernquantenpunkts (Cln) des n-ten Kernquantenbits (CQUBn) des n-Bit-Kern-Kern-Quantenregisters (CCQUREG) das Verhalten des vorausgehenden (n-1)-ten Kernquantenpunkts (CI(n-1)) des (n-1)-ten Kernquantenbits (CQUB(n-1)) des n-Bit-Kern-Kern-Quantenregisters (CCQUREG) zumindest zeitweise beeinflusst. Bevorzugt beträgt hierzu der Abstand (sp'(n-1)1) zwischen dem n-ten Kernquantenpunkt (CIn) des n-ten Kernquantenbits (CQUBn) des n-Bit-Kern-Kern-Quantenregisters (CCQUREG) und dem vorausgehenden (n-1)-ten Kernquantenpunkt (CI(n-1)) des (n-1)-ten Kernquantenbits (CQUB(n-1)) des n-Bit-Kern-Kern-Quantenregisters (CCQUREG) weniger als 200 pm und/oder weniger als 100 pm und/oder weniger als 50 pm und/oder weniger als 20 pm und/oder weniger als 10 pm und/oder weniger als 5 pm und/oder weniger als 2 pm beträgt, und/oder der Abstand (sp'(n-1)n) zwischen dem n-ten Kernquantenpunkt (Cln) des n-ten Kernquantenbits (CQUBn) des n-Bit-Kern-Kern-Quantenregisters (CCQUREG) und dem vorausgehenden (n-1)-ten Kernquantenpunkt (CI(n-1)) des (n-1)-ten Kernquantenbits (CQUB(n-1)) des n-Bit-Kern-Kern-Quantenregisters (CCQUREG) zwischen 200 pm und 2 pm und/oder weniger als 100 pm und/oder weniger als 50 pm und/oder weniger als 20 pm und/oder weniger als 10 pm und/oder weniger als 5 pm und/oder weniger als 2 pm beträgt.

Innerhalb der Kette kann dann der erste Kernquantenpunkt (CI1) im Verhältnis zum n-ten Kernquantenpunkt (Cln) dann einen Abstand (sp'1n), seine Kettenlänge, aufweisen. Bevorzugt ist hierzu dieser räumliche Abstand (sp'1n) zwischen dem ersten Kernquantenpunkt (CI1), typischerweise des ersten Kernquantenbits (QUB1), des n-Bit-Kern-Kern-Quantenregisters (CCQUREG) am Anfang der Kette und dem n-ten Kernquantenpunkt (Cln), typischerweise des n-ten Quantenbits (QUBn), des n-Bit-Kern-Kern-Quantenregisters (CCQUREG) am Ende der Kette so groß sein, dass das Magnetfeld des ersten Kernquantenpunkts (CI1), typischerweise des ersten Kernquantenbits (CQUB1), des n-Bit-Kern-Kern-Quantenregisters (CCQUREG) am Anfang der Kette das Verhalten des n-ten Kernquantenpunkts (Cln), typischerweise des n-ten Kernquantenbits (CQUBn), des n-Bit-Kern-Kern-Quantenregisters (CCQUREG) am Ende der Kette nicht mehr wesentlich beeinflussen kann, und/oder dass das Magnetfeld des n-ten Kernquantenpunkts (Cln), typischerweise des n-ten Kernquantenbits (CQUBn), des n-Bit-Kern-Kern-Quantenregisters (CCQUREG) am Ende der Kette das Verhalten des ersten Kernquantenpunkts (CI1), typischerweise des ersten Kernquantenbits (CQUB1), des n-Bit-Kern-Kern-Quantenregisters (CCQUREG) am Anfang der Kette nicht mehr direkt beeinflussen kann, sondern nur noch mit Hilfe der n-2 Kernquantenpunkte (CI2 bis CI(n-1)) zwischen dem ersten Kernquantenpunkt (CI1) und dem n-ten Kernquantenpunkt (Cln).

Die im Folgenden beschriebenen Prinzipien für ein Dreibit-Kern-Kern-Quantenregister können daher auf ein Kern-Kern-Quantenregister (CCQUREG) mit mehr als drei Kernquantenpunkten (CI1 bis Cln) übertragen werden. Daher werden diese Prinzipien für ein n-Bit-Kern-Kern-Quantenregister (CCQUREG) mit n>3 nicht mehr ausgeführt, da sie sich für den Fachmann aus der folgenden Beschreibung eines Dreibit-Kern-Kern-Quantenregisters leicht ergeben. Solche Mehrbit-Kern-Kern-Quantenregister sind von der Beanspruchung ausdrücklich mit umfasst.

Ein Dreibit-Kern-Kern-Quantenregister (CCQUREG) ist dann ein Kern-Kern-Quantenregister (CCQUREG), wie es zuvor beschrieben wurde, mit mindestens einem dritten Kernquantenbit (CQUB3) entsprechend der vorhergehenden Beschreibung. Bevorzugt sind dann der erste Kernquantenpunkttyp des ersten Kernquantenpunkts (CI1), typischerweise des ersten Kernquantenbits (CQUB1) und der zweite Kernquantenpunkttyp des zweiten Kernquantenpunkts (CI2), typischerweise des zweiten Kernquantenbits (CQUB2), gleich dem dritten Kernquantenpunkttyp des dritten Kernquantenpunkts (CI3), typischerweise des dritten Kernquantenbits (CQUB3).

Bevorzugt ist bei einem solchen beispielhaften Dreibit-Kern-Kern-Quantenregister das Substrat (D) dem ersten Kernquantenpunkt (CI1) und dem zweiten Kernquantenpunkt (CI2) und dem dritten Quantenpunkt (CI3) gemeinsam. Der Kernquantenpunkt (CI), typischerweise des dritten Kernquantenbits (CQUB3), wird im Folgenden als dritter Kernquantenpunkt (CI3) bezeichnet. Bevorzugt ist die horizontale Leitung (LH) des dritten Kernquantenbits (CQUB3) die besagte erste horizontale Leitung (LH1) und damit gemeinsam mit der horizontalen Leitung (LH) des zweiten Kernquantenbits (CQUB2) und der horizontalen Leitung (LH) des ersten Kernquantenbits (CQUB1). Die vertikale Leitung (LV) des dritten Kernquantenbits (CQUB3) wird im Folgenden als dritte vertikale Leitung (LV3) bezeichnet. Statt dieser Aufreihung der Kernquantenbits längs der ersten horizontalen Leitung (LH1) sind, wie bereits erwähnt andere Aufreihungen denkbar.

Um nun einen Transport von Abhängigkeiten von Quanteninformationen zu ermöglichen, ist es sinnvoll, wenn das Magnetfeld des zweiten Kernquantenpunkts (CI2), typischerweise des zweiten Kernquantenbits (CQUB2), das Verhalten des dritten Kernquantenpunkts (CI3), typischerweise des dritten Kernquantenbits (CQUB3) zumindest zeitweise beeinflussen kann und/oder wenn das Magnetfeld des dritten Kernquantenpunkts (CI3) des dritten Kernquantenbits (CQUB3) das Verhalten des zweiten Kernquantenpunkts (CI2), typischerweise des zweiten Kernquantenbits (CQUB2), zumindest zeitweise beeinflussen kann. Hierdurch entsteht dabei das, was im Folgenden als Kernquantenbus bezeichnet wird und zum Transport von Abhängigkeiten der Quanteninformationen der Kernquantenpunkte des so entstehenden Kernquantenbusses (CQUBUS) dient.

Um diese Abhängigkeiten zu ermöglichen, ist es sinnvoll, wenn der räumliche Abstand (sp'23) zwischen dem dritten Kernquantenpunkt (CI3), typischerweise des dritten Kernquantenbits (CQUB3), und dem zweiten Kernquantenpunkt (CI2) des zweiten Kernquantenbits (CQUB2) bevorzugt so klein ist, dass das Magnetfeld des zweiten Kernquantenpunkts (CI2), typischerweise des zweiten Kernquantenbits (CQUB2), das Verhalten des dritten Kernquantenpunkts (CI3), typischerweise des dritten Kernquantenbits (CQUB3), zumindest zeitweise beeinflussen kann, und/oder dass das Magnetfeld des dritten Kernquantenpunkts (CI3), typischerweise des dritten Kernquantenbits (CQUB3), das Verhalten des zweiten Kernquantenpunkts (CI2), typischerweise des zweiten Kernquantenbits (CQUB2), zumindest zeitweise beeinflussen kann.

Um diese Kopplung zu erreichen, ist es wieder sinnvoll, wenn der räumliche Abstand (sp'23) zwischen dem dritten Kernquantenpunkt (CI3) des dritten Kernquantenbits (CQUB3) und dem zweiten Kernquantenpunkt (CI2), typischerweise des zweiten Kernquantenbits (CQUB2), weniger als 200 pm und/oder weniger als 100 pm und/oder weniger als 50 pm und/oder weniger als 20 pm beträgt und/oder weniger als 10 pm und/oder weniger als 5 pm und/oder weniger als 2 pm beträgt und/oder wenn der räumliche Abstand (sp'23) zwischen dem dritten Kernquantenpunkt (CI3), typischerweise des dritten Kernquantenbits (CQUB3) und dem zweiten Kernquantenpunkt (CI2), typischerweise des zweiten Kernquantenbits (CQUB2), zwischen 200 pm und 2 pm und/oder weniger als 100 pm und/oder weniger als 50 pm und/oder weniger als 20 pm und/oder weniger als 10 pm und/oder weniger als 5 pm und/oder weniger als 2 pm, beträgt.

Wie oben bereits erläutert, sind die Kernquantenpunkte (CI) des Kern-Kern-Quantenregisters (CCQUREG) bevorzugt in einem eindimensionalen Gitter angeordnet. Eine Anordnung in einem zweidimensionalen Gitter ist möglich, aber nicht so vorteilhaft, da dann die Stromgleichungen nicht mehr ohne Weiteres eindeutig gelöst werden können.

Bevorzugt sind somit die Kernquantenpunkte (CI) des Kern-Kern-Quantenregisters (CCQUREG) in einem ein- oder zweidimensionalen Gitter aus Elementarzellen von Anordnungen von einem oder mehreren Kernquantenpunkten (CI) mit einem zweiten Abstand (sp'12) als Gitterkonstante für den Abstand zwischen den jeweiligen Elementarzellen angeordnet.

### Konstruktion eines Kern-Elektron-Kern-Elektron-Quantenregisters (CECEQUREG)

Aus den zuvor beschriebenen Registern lässt sich nun ein Kern-Elektron-Kern-Elektron-Quantenregister (CECEQUREG) zusammensetzen.

Ein solches Kern-Elektron-Kern-Elektron-Quantenregister (CECEQUREG) umfasst erfindungsgemäß ein erstes Kernquantenbit (CQUB1) und mindestens ein zweites Kernquantenbit (CQUB2), wie es zuvor beschrieben wurde. Das Kern-Elektron-Kern-Elektron-Quantenregister (CECEQUREG) umfasst darüber hinaus ein erstes Quantenbit (QUB1) und mindestens ein zweites Quantenbit (QUB2), wie sie zuvor beschrieben wurden. Ein solches Kern-Elektron-Kern-Elektron-Quantenregister (CECEQUREG) ist die einfachste Form eines Quantenbusses (QUBUS).

Zur Vereinfachung nehmen wir an, dass der erste Kernquantenpunkt (CI1) des ersten Kernquantenbits (CQUB1) weiter als der Kern-Kern-Kopplungsabstand von dem zweiten Kernquantenpunkt (CI2) des zweiten Kernquantenbits (CQUB2) entfernt ist und dass somit der erste Kernquantenpunkt (CI1) nicht direkt mit dem zweiten Kernquantenpunkt (CI2) gekoppelt ist.

Des Weiteren nehmen wir an, dass der erste Kernquantenpunkt (CI1) des ersten Kernquantenbits (CQUB1) näher als der Elektron-Kern-Kopplungsabstand von dem ersten Quantenpunkt (NV1) des ersten Quantenbits (QUB1) entfernt ist und dass somit der erste Kernquantenpunkt (CI1) direkt mit dem ersten Quantenpunkt (NV1) gekoppelt ist bzw. gekoppelt werden kann.

Außerdem nehmen wir an, dass der zweite Kernquantenpunkt (CI2) des zweiten Kernquantenbits (CQUB2) näher als der Elektron-Kern-Kopplungsabstand von dem zweiten Quantenpunkt (NV2) des zweiten Quantenbits (QUB2) entfernt ist und dass somit der zweite Kernquantenpunkt (CI2) direkt mit dem zweiten Quantenpunkt (NV2) gekoppelt ist bzw. gekoppelt werden kann.

Schließlich nehmen wir an, dass der erste Quantenpunkt (NV1) des ersten Quantenbits (QUB1) näher als der Elektron-Elektron-Kopplungsabstand von dem zweiten Quantenpunkt (NV2) des zweiten Quantenbits (QUB2) entfernt ist und dass somit der erste Quantenpunkt (NV1) direkt mit dem zweiten Quantenpunkt (NV2) gekoppelt ist bzw. gekoppelt werden kann.

Somit ist eine Kopplung des ersten Kernquantenpunkts (CI1) mit dem zweiten Kernquantenpunkt (CI2) nur indirekt über den ersten Quantenpunkt (NV1) und den zweiten Quantenpunkt (NV2) möglich.

Bevorzugt bilden nun das erste Kernquantenbit (CQUB1) und das erste Quantenbit (QUB1) ein Kern-Elektron-Quantenregister (CEQUREG), im Folgenden erstes Kern-Elektron-Quantenregister (CEQUREG1) genannt, in der zuvor bereits beschriebenen Form.

Das zweite Kernquantenbit (CQUB2) und das zweite Quantenbit (QUB2) bilden bevorzugt in analoger Weise ein Kern-Elektron-Quantenregister (CEQUREG), im Folgenden zweites Kern-Elektron-Quantenregister (CEQUREG2) genannt, in der zuvor bereits beschriebenen Form.

Theoretisch können das erste Kernquantenbit (CQUB1) und das zweite Kernquantenbit (CQUB2) ein Kern-Kern-Quantenregister (CCQUREG) entsprechend der vorausgehenden entsprechenden Beschreibung bilden. In den allermeisten Fällen wird dies aber nicht der Fall sein. Wir nehmen hier wie bereits beschreiben zur Vereinfachung an, dass dies nicht der Fall ist, da die Kern-Kern-Kopplungsreichweite wesentlich keiner ist, als die Elektron-Elektron-Kopplungsreichweite.

Wichtiger ist jedoch, dass bevorzugt das erste Quantenbit (QUB1) und das zweite Quantenbit (CQUB2) ein Elektron-Elektron-Quantenregister (QUREG), wie zuvor beschrieben, bilden, da dies den Transport von Abhängigkeiten zwischen dem ersten Kern-Elektron-Quantenregister (CEQUREG1) und dem zweites Kern-Elektron-Quantenregister (CEQUREG2) ermöglicht. Die Elektron-Elektron-Kopplungsreichweite zwischen dem ersten Quantenpunkt (NV1) des ersten Quantenbits (QUB1) eines Elektro-Elektron-Quantenregisters (QUREG) und dem zweiten Quantenpunkt (NV2) des zweiten Quantenbits (QUB2) dieses Elektro-Elektron-Quantenregisters (QUREG) einerseits ist typischerweise größer als die Kern-Kern-Kopplungsreichweite zwischen dem ersten Kernquantenpunkt (CI1) des ersten Kernquantenbits (CQUB1) eines Kern-Kern-Quantenregisters (CQUREG) und dem zweiten Kernquantenpunkt (CI2) des zweiten Kernquantenbits (CQUB2) eines Kern-Kern-Quantenregisters (CQUREG) andererseits. Aufgrund dieser höheren Elektron-Elektron-Kopplungsreichweite kann daher ein Elektron-Elektron-Quantenregister (QUREG) die Funktion übernehmen, die in einem konventionellen Rechner der Datenbus hat. Das Elektron-Elektron-Quantenregister (QUREG) kann somit auch durch eine geschlossene Kette von n-1 Elektron-Elektron-Quantenregistern (QUREG) mit n als ganzer positiver Zahl ersetzt sein, die auch Verzweigungen und Schleifen umfassen kann. Somit wird die Erstellung komplexer Quantennetzwerke (QUNET) möglich, die die verschiedenen Kern-Elektron-Quantenregister (CEQUREG2) miteinander verbinden und die mehr als ein n-Bit-Elektron-Elektron-Quantenregister (QUREG) umfassen. Hierbei kann der n-te Quantenpunkt (NVn) des n-ten Quantenbits (QUBn) weiter als die Elektron-Elektron-Kopplungsreichweite vom ersten Quantenpunkt (NV1) des ersten Quantenbits (QUB1) beabstandet sein, so dass eine direkte Kopplung des ersten Quantenpunkts (NV1) des ersten Quantenbits (QUB1) mit dem n-ten Quantenpunkt (NVn) des n-ten Quantenbits (QUBn) nicht mehr möglich ist. Durch die geschlossene Kette der n-1 Zwei-Bit-Elektron-Elektron-Quantenregister (QUREG1 bis QUREG(n-1)) zwischen dem ersten Quantenbit (QUB1) und dem n-ten Quantenbit (QUBn) ist jedoch eine indirekte Kopplung unter Zuhilfenahme dieser Kette aus n-1 Zwei-Bit-Elektron-Elektron-Quantenregistern (QUREG1 bis QUREG(n-1) möglich. Innerhalb einer solchen Kette eines n-Bit-Elektron-Elektron-Quantenregisters (NBQUREG) umfassen zwei aufeinander folgende Zwei-Bit-Elektron-Elektron-Quantenregistern (QUREG) stets mindestens ein Quantenbit (QUB), genauer den Quantenpunkt (NV) dieses Quantenbits (QUB), gemeinsam.

### Beispiel eines Kern-Elektron-Kern-Elektron-Quantenregisters (CECEQUREG) mit weit beabstandeten Kern-Elektron-Quantenregistern

Diese Möglichkeit der Kopplung über weite Entfernungen soll nun an einem Beispiel zweier weit voneinander beabstandeter Kern-Elektron-Quantenregister, einem ersten Kern-Elektron-Quantenregister (CEQUREG1) und einem n-ten Kern-Elektron-Quantenregister (CEQUREGn) genauer dargestellt werden.

In diesem Beispiel umfasst das erste Kern-Elektron-Quantenregister (CEQUREG1) wieder, wie oben beschrieben, ein erstes Quantenbit (QUB1) mit einem ersten Quantenpunkt (NV1) und ein erstes Kernquantenbit (CQUB1) mit einem ersten Kernquantenpunkt (CI1).

In diesem Beispiel umfasst das n-te Kern-Elektron-Quantenregister (CEQUREGn) wieder, wie oben beschrieben, ein n-tes Quantenbit (QUBn) mit einem n-ten Quantenpunkt (NVn) und ein n-tes Kernquantenbit (CQUBn) mit einem n-ten Kernquantenpunkt (Cln).

Das erste Quantenbit (QUB1) des ersten Kern-Quanten-Registers (CEQUREG1) und sein erster Quantenpunkt (NV1) stellen in diesem Beispiel gleichzeitig auch den Anfang eines n-Bit-Elektron-Elektron-Quantenregisters (NBQUREG) dar. Wir können uns dabei dieses n-Bit-Elektron-Elektron-Quantenregister (NBQUREG) als Teil eines größeren Quantennetzwerks (QUNET) aus mehreren n-Bit-Elektron-Elektron-Quantenregistern (NBQUREG) vorstellen, wobei die Anzahl n der Quantenbits (QB1 bis QUBn) des jeweiligen n-Bit-Elektron-Elektron-Quantenregisters (NBQUREG) von einem n-Bit-Elektron-Elektron-Quantenregisters (NBQUREG) des Quantennetzwerks (QUNET) zu einem anderen n-Bit-Elektron-Elektron-Quantenregisters (NBQUREG) des Quantennetzwerks (QUNET) unterschiedlich sein kann.

Das erste Quantenbit (QUB1) des ersten Kern-Quanten-Registers (CEQUREG1) und sein erster Quantenpunkt (NV1) sind in diesem Beispiel somit gleichzeitig auch Teil des n-Bit-Elektron-Elektron-Quantenregisters (NBQUREG) mit n Quantenbits (QUB1 bis QUBn) und zugehörigen n Quantenpunkten (NV1 bis NVn). Hierdurch wird der erste Kern-Quantenpunkt (CI1) des ersten Kern-Elektron-Quantenregisters (CEQUTEG1) an das n-Bit-Elektron-Elektron-Quantenregister (NBQUREG) und damit an das Quantennetzwerk (QUNET) angeschlossen. Die Idee ist, die typischerweise lange Kohärenzzeit der Nuklerar-Spins des ersten Kernquantenbits (CI1) und des n-ten Kernquantenbits (Cln) für die Durchführung von Quantenoperationen zu nutzen und die räumlich lange Reichweite der Kopplung der n Quantenpunkte (NV1 bis NVn) der n Quantenbits (QUB1 bis QUBn) des n-Bit-Quantenregisters (NBQUREG) für den Transport der Abhängigkeiten über größere räumliche Abstände als die Kern-Kern-Kopplungsreichweite der Kernquantenpunkte (CI1, Cln) zu nutzen.

Übertragen auf die Begrifflichkeiten eines konventionellen Rechnersystems stellt das n-Bit-Elektron-Elektron-Quantenregister (NBQUREG) mit seinen n Quantenpunkten (NV1 bis NVn) in bevorzugt n Quantenbits (QUB1 bis QUBn) somit das dar, was in einem konventionellen Rechner der Datenbus leistet. Während aber in einem konventionellen Datenbus logische Werte transportiert werden, werden hier in dem hier Quantenbus (QUBUS) genannten Konstrukt, Abhängigkeiten transportiert, sodass hier die angeschlossenen Kern-Quantenpunkte (CI1, CIn) auch über größere Entfernungen hin miteinander verschränkt werden können. Dies hat den Vorteil, dass dadurch der sich ergebende Quanten-Computer skalierbar wird und eine wesentlich größere Anzahl an Quantenpunkten und Kernquantenpunkten miteinander verschränkt werden können. Dabei können auch solche Kern-Quantenpunkte (CI1, Cln) mit Hilfe von Ancilla-Quantenpunkten miteinander verschränkt werden, die aufgrund ihrer Entfernung zueinander nicht direkt miteinander verschränkt werden können. Durch eine Verkettung mehrerer Quantenpunkte (NV1 bis NVn) können bei sehr langen Ketten auch Quantenpunkte (NV1, NVn) miteinander durch die anderen Quantenpunkte (NV2 bis NV(n-1)) als Ancilla-Quantenpunkte miteinander gekoppelt und verschränkt werden, die aufgrund ihrer großen Entfernung zueinander nicht direkt miteinander verschränkt werden können. Ein solcher Quantenbus (QUBUS) kann auch als langer Quantenbus (QUBUS) bezeichnet werden. Durch die Möglichkeit der selektiven Ansteuerung einzelner Quantenpunkte (NV1 bis NVn) und einzelner Kernquantenpunkte und deren Paarungen ist es im Gegensatz zum Stand der Technik somit möglich, einen skalierbaren Quantencomputer aufzubauen.

Natürlich kann jedes der n Quantenbits (QUB1 bis QUBn) und damit jeder der n Quantenpunkte (NV1 bis NVn) selbst wieder Teil eines von beispielsweise n Kern-Elektron-Quantenregistern (CEQUREG1 bis CEQUREGn) sein. Für das Verständnis des Vorschlags ist jedoch die Betrachtung der zwischen dem ersten Quantenbit (QUB1) und dem n-ten Quantenbit (QUBn) liegenden Quantenbits (QUB2 bis QUB(n-1)) vollkommen ausreichend, weshalb wir uns hier darauf beschränken und ggf. die Kernquantenpunkte der n-2 vorhandene Kern-Elektron-Quantenregister der n-2 Quantenpunkte (NV2 bis NV(n-1)) zwischen dem ersten Quantenpunkt (NV1) und dem n-ten Quantenpunkt (NVn) vernachlässigen.

Im einfachsten Fall besteht das Quantennetzwerk (QUNET) somit aus einer einzigen Kette von miteinander verbundenen Zwei-Bit-Elektron-Elektron-Quantenregistern (QUREG), die zusammen ein n-Bit-Quantenregister (NBQREG) mit n Quantenbits (QUB1 bis QUBn) und zugehörigen n Quantenpunkten (NV1 bis NVn) bilden. Zur besseren Abgrenzung ist in dieser Schrift ein Quantennetzwerk (QUNET) so definiert, dass es mindestens zwei n-Bit-Elektron-Elektron-Quantenregister (NBQUREG) umfasst.

Durch das Quantennetzwerk (QUNET) bzw. den Quantenbus (QUBUS) kann nun trotz der geringeren Kern-Kern-Kopplungsreichweite des ersten Kernquantenpunkts (CI1) und des n-ten Kernquantenpunkts(Cln) mittels eines das erste Kern-Elektro-Quantenregister (CEQUREG1) und das n-te Kern-Elektron-Quantenregister (CEQUREGn) verbindenden ein erster Kernquantenpunkt (CI1) des ersten Kern-Elektron-Quantenregisters (CEQUREG1) mit dem n-ten Kernquantenpunkt (Cln) eines n-ten Kern-Elektron-Quantenregisters (CEQUREGn) verkoppelt bzw. verschränkt werden. Der betroffene Quantenbus (QUBUS) des Quantennetzwerks (QUNET) umfasst dabei, wie bereits beschrieben, in diesem Beispiel eine Verkettung von n-1 miteinander verbundenen Zwei-Bit-Elektron-Elektron-Quantenregistern (QUREG), die alle zusammen jeweils ein n-Bit-Quantenregister (NBQREG) bilden. In diesem Beispiel erfolgt die Verschränkung oder Verkopplung des ersten Kernquantenpunkts (CI1) und des n-ten Kernquantenpunkts(CIn) aufgrund eines beispielhaft als zu groß angenommenen räumlichen Abstands zwischen diesen nicht durch eine direkte Kopplung zwischen dem ersten Kernquantenpunkt (CI1) und dem n-ten Kernquantenpunkt (Cln), sondern durch Nutzung des n-Bit Elektron-Elektron-Registers (NBQUREG) für den Transport dieser Abhängigkeit vom ersten Kernquantenpunkt (CI1) zum n-ten Kernquantenpunkt (Cln) oder in umgekehrter Richtung.

Durch eine solche beispielhafte lineare Verkettung der n Quantenpunkte (NV1 bis NVn) der n Quantenbits (QUB1 bis QUBn) des n-Bit-Elektron-Elektron-Quantenregisters (NBQUREG) längs einer beispielhaften eindimensionalen Linie innerhalb eines n-Bit-Quantenregisters (NBQUREG), beispielsweise längs der besagten vertikalen Leitung (LV) oder längs der besagten horizontalen Leitung (LH), kann der räumliche Abstand (sp1n) zwischen dem ersten Quantenpunkt (NV1) des ersten Quantenbits (QUB1) des n-Bit-Quantenregisters (NBQUREG) und dem n-ten Quantenpunkt (NVn) des n-ten Quantenbits (QUBn) des n-Bit-Quantenregisters (NBQUREG) sogar so groß sein, dass auch der erste Quantenpunkt (NV1) des ersten Quantenbits (QUB1) des n-Bit-Quantenregisters (NBQUREG) nicht mehr mit dem n-ten Quantenpunkt (NVn) des n-ten Quantenbits (QUBn) des n-Bit-Quantenregisters (NBQUREG) direkt verkoppelt sein kann oder direkt verschränkt werden kann.

Zur Vereinfachung nehmen wir wieder an, dass die n Quantenpunkte (NV1 bis NVn) der n Quantenpunkte (QUB1 bis QUBn) abzählbar längs der besagten eindimensionalen Line aufgereiht sind. Diese eindimensionale Linie kann, wie beschrieben, auch gekrümmt oder eckig und auch ringförmig geschlossen sein. Somit sollen die n Quantenpunkte (NV1 bis NVn) und damit ihre jeweiligen Quantenbits (QUB1 bis QUBn) in diesem Beispiel einen Quantenbus (QUBUS) eines Quantennetzwerks (QUNET) in Form einer Kette von n Quantenpunkten (NV1 bis NVn) darstellen, die mit dem ersten Quantenpunkt (NV1) des ersten Kern-Elektron-Quantenregisters (CEQUREG1) beginnt und mit dem n-ten Quantenpunkt (NVn) des n-ten Kern-Elektron-Quantenregisters (CEQUREGn) endet.

Dabei ist der erste Quantenpunkt (NV1) des ersten Kern-Elektron-Quantenregisters (CEQUREG1) auch der erste Quantenpunkt (NV1) des ersten Quantenbits (QUB1) am Anfang des n-Bit-Elektron-Elektron-Quantenregisters (NBQUREG).

Dabei ist der n-te Quantenpunkt (NVn) des n-ten Kern-Elektron-Quantenregisters (CEQUREGn) auch der n-te Quantenpunkt (NVn) des n-ten Quantenbits (QUBn) am Ende des n-Bit-Elektron-Elektron-Quantenregisters (NBQUREG).

Innerhalb dieses Quantenbusses (QUBUS) des Quantennetzwerks (QUNET) in Form der besagten Kette von n Quantenpunkten (NV1 bis NVn) sind die n Quantenpunkte (NV1 bis NVn) des n-Bit-Elektron-Elektron-Quantenregisters (NBQUREG) und damit auch die n Quantenbits (QUB1 bis QUBn) des n-Bit-Elektron-Elektron-Quantenregisters (NBQUREG) abzählbar und können damit mit ganzen positiven Zahlen von 1 bis n durchnummeriert werden.

Damit geht innerhalb der Kette der Quantenpunkte (NV1 bis NVn) des Quantenbusses (QUBUS) des Quantennetzwerks (QUNET) einem j-ten Quantenpunkt (NVj) ein (j-1)-ter Quantenpunkt (NV(j-1)) voraus, der im Folgenden der Vorgängerquantenpunkt (NV(j-1)) genannt wird. Damit geht innerhalb der Kette einem j-ten Quantenbit (QUBj) mit dem j-ten Quantenpunkt (NVj) ein (j-1)-tes Quantenbit (QUB(j-1)) mit dem (j-1)-ter Quantenpunkt (NV(j-1)) voraus, das im Folgenden das Vorgängerquantenbit (QUB(j-1)) genannt wird.

Damit folgt innerhalb der Kette der Quantenpunkte (NV1 bis NVn) des Quantenbusses (QUBUS) des Quantennetzwerks (QUNET) einem j-ten Quantenpunkt (NVj) ein (j+1)-ter Quantenpunkt (NV(j+1)) nach, der im Folgenden der Nachfolgerquantenpunkt (NV(j+1)) genannt wird. Damit folgt innerhalb der Kette einem j-ten Quantenbit (QUBj) mit dem j-ten Quantenpunkt (NVj) ein (j+1)-tes Quantenbit (QUB(j+1)) mit dem (j+1)-ter Quantenpunkt (NV(j+1)) nach, der im Folgenden das Nachfolgerquantenbit (QUB(j-1)) genannt wird. Hierbei soll der Index j in Bezug auf diese beispielhafte Kette hier eine beliebige ganze positive Zahl mit 1<j<n sein, wobei n eine ganze positive Zahl mit n>2 sein soll.

Innerhalb der Kette weist der j-te Quantenpunkt (NVj) dann einen Abstand (sp(j-1)j), seinen Vorgängerabstand, auf. Bevorzugt ist hierzu dieser räumliche Abstand (sp(j-1)j) zwischen dem j-ten Quantenpunkt (NVj) des j-ten Quantenbits (QUBj) des Quantenregisters (QUREG) und dem vorausgehenden (j-1)-ten Quantenpunkt (NV(j-1)) des (j-1)-ten Quantenbits (QUB(j-1)) des n-Bit-Quantenregisters (NBQUREG) so klein, dass das Magnetfeld des vorausgehenden (j-1)-ten Quantenpunkts (NV(j-1)) des (j-1)-ten Quantenbits (QUB(j-1)) des n-Bit-Quantenregisters (NBQUREG) das Verhalten des j-ten Quantenpunkts (NVj) des j-ten Quantenbits (QUBj) des n-Bit-Quantenregisters (NBQUREG) zumindest zeitweise beeinflusst, und/oder dass das Magnetfeld des j-ten Quantenpunkts (NVj) des j-ten Quantenbits (QUBj) des n-Bit-Quantenregisters (QUREG) das Verhalten des vorausgehenden (j-1)-ten Quantenpunkts (NV(j-1)) des (j-1)-ten Quantenbits (QUB(j-1)) des n-Bit-Quantenregisters (NBQUREG) zumindest zeitweise beeinflusst. Bevorzugt beträgt hierzu der Abstand (sp(j-1)1) zwischen dem j-ten Quantenpunkt (NVj) des j-ten Quantenbits (QUBj) des n-Bit-Quantenregisters (NBQUREG) des Quantenbusses (QUBUS) des Quantennetzwerks (QUNET) und dem vorausgehenden (j-1)-ten Quantenpunkt (NV(j-1)) des (j-1)-ten Quantenbits (QUB(j-1)) des n-Bit-Quantenregisters (NBQUREG) des Quantenbusses (QUBUS) des Quantennetzwerks (QUNET) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (sp(j-1)j) zwischen dem j-ten Quantenpunkt (NVj) des j-ten Quantenbits (QUBj) des n-Bit-Quantenregisters (NBQUREG) des Quantenbusses (QUBUS) des Quantennetzwerks (QUNET) und dem vorausgehenden (j-1)-ten Quantenpunkt (NV(j-1)) des (j-1)-ten Quantenbits (QUB(j-1)) des n-Bit-Quantenregisters (NBQUREG) des Quantenbusses (QUBUS) des Quantennetzwerks (QUNET) zwischen 30 nm und 2 nm und/oder weniger als 10 nm und/oder weniger als 5 nm und/oder weniger als 2 nm.

Innerhalb der Kette der Quantenpunkte (NV1 bis NVn) des Quantenbusses (QUBUS) des Quantennetzwerks (QUNET) weist der j-te Quantenpunkt (NVj) dann einen Abstand (spj(j+1)), seinen Nachfolgerabstand, auf. Bevorzugt ist hierzu dieser räumliche Abstand (spj(j+1)) zwischen dem j-ten Quantenpunkt (NVj) des j-ten Quantenbits (QUBj) des n-Bit-Quantenregisters (QUREG) des Quantenbusses (QUBUS) des Quantennetzwerks (QUNET) und dem nachfolgenden (j+1)-ten Quantenpunkt (NV(j+1)) des (j+1)-ten Quantenbits (QUB(j+1)) des Quantenregisters (QUREG) so klein, dass das Magnetfeld des nachfolgenden (j+1)-ten Quantenpunkts (NV(j+1)) des (j+1)-ten Quantenbits (QUB(j+1)) des n-Bit-Quantenregisters (NBQUREG) des Quantenbusses (QUBUS) des Quantennetzwerks (QUNET) das Verhalten des j-ten Quantenpunkts (NVj) des j-ten Quantenbits (QUBj) des n-Bit-Quantenregisters (NBQUREG) des Quantenbusses (QUBUS) des Quantennetzwerks (QUNET) zumindest zeitweise beeinflusst, und/oder dass das Magnetfeld des j-ten Quantenpunkts (NVj) des j-ten Quantenbits (QUBj) des n-Bit-Quantenregisters (NBQUREG) des Quantenbusses (QUBUS) des Quantennetzwerks (QUNET) das Verhalten des nachfolgenden (j+1)-ten Quantenpunkts (NV(j+1)) des (j+1)-ten Quantenbits (QUB(j+1)) des n-Bit-Quantenregisters (NBQUREG) des Quantenbusses (QUBUS) des Quantennetzwerks (QUNET) zumindest zeitweise beeinflusst. Bevorzugt beträgt hierzu der Abstand (spj(j+1)) zwischen dem j-ten Quantenpunkt (NVj) des j-ten Quantenbits (QUBj) des n-Bit-Quantenregisters (NBQUREG) des Quantenbusses (QUBUS) des Quantennetzwerks (QUNET) und dem nachfolgenden (j+1)-ten Quantenpunkt (NV(j+1)) des (j+1)-ten Quantenbits (QUB(j+1)) des n-Bit-Quantenregisters (NBQUREG) des Quantenbusses (QUBUS) des Quantennetzwerks (QUNET) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (spj(j+1)) zwischen dem j-ten Quantenpunkt (NVj) des j-ten Quantenbits (QUBj) des n-Bit-Quantenregisters (NBQUREG) des Quantenbusses (QUBUS) des Quantennetzwerks (QUNET) und dem nachfolgenden (j+1)-ten Quantenpunkt (NV(j+1)) des (j+1)-ten Quantenbits (QUB(j+1)) des n-Bit-Quantenregisters (NBQUREG) des Quantenbusses (QUBUS) des Quantennetzwerks (QUNET) zwischen 30 nm und 2 nm und/oder weniger als 10 nm und/oder weniger als 5 nm und/oder weniger als 2 nm.

Innerhalb der Kette der Quantenpunkte (NV1 bis NVn) des Quantenbusses (QUBUS) des Quantennetzwerks (QUNET) weist der erste Quantenpunkt (NV1) dann einen ersten Abstand (sp12), seinen Nachfolgerabstand, auf. Bevorzugt ist hierzu dieser erste räumliche Abstand (sp12) zwischen dem ersten Quantenpunkt (NV1) des ersten Quantenbits (QUB1) des Quantenregisters (QUREG) des Quantenbusses (QUBUS) des Quantennetzwerks (QUNET) und dem nachfolgenden zweiten Quantenpunkt (NV2) des zweiten Quantenbits (QUB2) des n-Bit-Quantenregisters (NBQUREG) des Quantenbusses (QUBUS) des Quantennetzwerks (QUNET) so klein, dass das Magnetfeld des nachfolgenden zweiten Quantenpunkts (NV2) des zweiten Quantenbits (QUB2) des n-Bit-Quantenregisters (NBQUREG) des Quantenbusses (QUBUS) des Quantennetzwerks (QUNET) das Verhalten des ersten Quantenpunkts (NV1) des ersten Quantenbits (QUB1) des n-Bit-Quantenregisters (NBQUREG) des Quantenbusses (QUBUS) des Quantennetzwerks (QUNET) zumindest zeitweise beeinflusst, und/oder dass das Magnetfeld des ersten Quantenpunkts (NV1) des ersten Quantenbits (QUB1) des n-Bit-Quantenregisters (NBQUREG) des Quantenbusses (QUBUS) des Quantennetzwerks (QUNET) das Verhalten des nachfolgenden zweiten Quantenpunkts (NV2) des zweiten Quantenbits (QUB2) des n-Bit-Quantenregisters (NBQUREG) des Quantenbusses (QUBUS) des Quantennetzwerks (QUNET) zumindest zeitweise beeinflusst. Bevorzugt beträgt hierzu der Abstand (sp12) zwischen dem ersten Quantenpunkt (NV1) des ersten Quantenbits (QUB1) des n-Bit-Quantenregisters (NBQUREG) des Quantenbusses (QUBUS) des Quantennetzwerks (QUNET) und dem nachfolgenden zweiten Quantenpunkt (NV2) des zweiten Quantenbits (QUB2) des n-Bit-Quantenregisters (NBQUREG) des Quantenbusses (QUBUS) des Quantennetzwerks (QUNET) weniger als 50 nm und/oder weniger als 30 nm und/oder weniger als 20 nm und/oder weniger als 10 nm beträgt und/oder weniger als 10 nm und/oder weniger als 5 nm und/oder weniger als 2 nm, und/oder der Abstand (sp12) zwischen dem ersten Quantenpunkt (NV1) des ersten Quantenbits (QUB1) des n-Bit-Quantenregisters (NBQUREG) des Quantenbusses (QUBUS) des Quantennetzwerks (QUNET) und dem nachfolgenden zweiten Quantenpunkt (NV2) des zweiten Quantenbits (QUB2) des n-Bit-Quantenregisters (NBQUREG) des Quantenbusses (QUBUS) des Quantennetzwerks (QUNET) zwischen 30 nm und 2 nm und/oder weniger als 10 nm und/oder weniger als 5 nm und/oder weniger als 2 nm.

Innerhalb der Kette der n Quantenpunkte (NV1 bis NVn) des Quantenbusses (QUBUS) des Quantennetzwerks (QUNET) weist der n-te Quantenpunkt (NVn) dann einen Abstand (sp(n-1)n), seinen Vorgängerabstand, auf. Bevorzugt ist hierzu dieser räumliche Abstand (sp(n-1)n) zwischen dem n-ten Quantenpunkt (NVn) des n-ten Quantenbits (QUBn) des n-Bit-Quantenregisters (NBQUREG) des Quantenbusses (QUBUS) des Quantennetzwerks (QUNET) und dem vorausgehenden (n-1)-ten Quantenpunkt (NV(n-1)) des (n-1)-ten Quantenbits (QUB(n-1)) des n-Bit-Quantenregisters (NBQUREG) des Quantenbusses (QUBUS) des Quantennetzwerks (QUNET) so klein, dass das Magnetfeld des vorausgehenden (n-1)-ten Quantenpunkts (NV(n-1)) des (n-1)-ten Quantenbits (QUB(n-1)) des n-Bit-Quantenregisters (NBQUREG) des Quantenbusses (QUBUS) des Quantennetzwerks (QUNET) das Verhalten des n-ten Quantenpunkts (NVn) des n-ten Quantenbits (QUBn) des n-Bit-Quantenregisters (NBQUREG) des Quantenbusses (QUBUS) des Quantennetzwerks (QUNET) zumindest zeitweise beeinflusst, und/oder dass das Magnetfeld des j-ten Quantenpunkts (NVn) des n-ten Quantenbits (QUBn) des n-Bit-Quantenregisters (NBQUREG) des Quantenbusses (QUBUS) des Quantennetzwerks (QUNET) das Verhalten des vorausgehenden (n-1)-ten Quantenpunkts (NV(n-1)) des (n-1)-ten Quantenbits (QUB(n-1)) des n-Bit-Quantenregisters (NBQUREG) des Quantenbusses (QUBUS) des Quantennetzwerks (QUNET) zumindest zeitweise beeinflusst. Bevorzugt beträgt hierzu der Abstand (sp(n-1)1) zwischen dem n-ten Quantenpunkt (NVn) des n-ten Quantenbits (QUBn) des n-Bit-Quantenregisters (NBQUREG) des Quantenbusses (QUBUS) des Quantennetzwerks (QUNET) und dem vorausgehenden (n-1)-ten Quantenpunkt (NV(n-1)) des (n-1)-ten Quantenbits (QUB(n-1)) des n-Bit-Quantenregisters (NBQUREG) des Quantenbusses (QUBUS) des Quantennetzwerks (QUNET) weniger als 50 nm und/oder weniger als 30 nm und/oder weniger als 20 nm und/oder weniger als 10 nm und/oder weniger als 10 nm und/oder weniger als 5 nm und/oder weniger als 2 nm beträgt, und/oder der Abstand (sp(n-1)n) zwischen dem n-ten Quantenpunkt (NVn) des n-ten Quantenbits (QUBn) des n-Bit-Quantenregisters (NBQUREG) des Quantenbusses (QUBUS) des Quantennetzwerks (QUNET) und dem vorausgehenden (n-1)-ten Quantenpunkt (NV(n-1)) des (n-1)-ten Quantenbits (QUB(n-1)) des n-Bit-Quantenregisters (NBQUREG) des Quantenbusses (QUBUS) des Quantennetzwerks (QUNET) zwischen 30 nm und 2 nm und/oder weniger als 10 nm und/oder weniger als 5 nm und/oder weniger als 2 nm beträgt.

Innerhalb der Kette der n Quantenpunkte (NV1 bis NVn) des Quantenbusses (QUBUS) des Quantennetzwerks (QUNET) kann dann der erste Quantenpunkt (NV1) im Verhältnis zum n-ten Quantenpunkt (NVn) dann einen Abstand (sp1n), seine Kettenlänge, aufweisen. In diesem Beispiel sei dieser räumliche Abstand (sp1n) zwischen dem ersten Quantenpunkt (NV1) des ersten Quantenbits (QUB1) des n-Bit-Quantenregisters (NBQUREG) des Quantenbusses (QUBUS) des Quantennetzwerks (QUNET) am Anfang der Kette und dem n-ten Quantenpunkt (NVn) des n-ten Quantenbits (QUBn) des n-Bit-Quantenregisters (NBQUREG) des Quantenbusses (QUBUS) des Quantennetzwerks (QUNET) am Ende der Kette der n Quantenpunkte (NV1 bis NVn) des Quantenbusses (QUBUS) des Quantennetzwerks (QUNET) so groß sein, dass das Magnetfeld des ersten Quantenpunkts (NV1) des ersten Quantenbits (QUB1) des n-Bit-Quantenregisters (NBQUREG) des Quantenbusses (QUBUS) des Quantennetzwerks (QUNET) am Anfang der Kette der n Quantenpunkte (NV1 bis NVn) des Quantenbusses (QUBUS) des Quantennetzwerks (QUNET) das Verhalten des n-ten Quantenpunkts (NVn) des n-ten Quantenbits (QUBn) des n-Bit-Quantenregisters (NBQUREG) des Quantenbusses (QUBUS) des Quantennetzwerks (QUNET) am Ende der Kette der n Quantenpunkte (NV1 bis NVn) des Quantenbusses (QUBUS) des Quantennetzwerks (QUNET) nicht mehr wesentlich beeinflussen kann, und/oder dass das Magnetfeld des n-ten Quantenpunkts (NVn) des n-ten Quantenbits (QUBn) des n-Bit-Quantenregisters (NBQUREG) des Quantenbusses (QUBUS) des Quantennetzwerks (QUNET) am Ende der Kette das Verhalten des ersten Quantenpunkts (NV1) des ersten Quantenbits (QUB1) des n-Bit-Quantenregisters (NBQUREG) des Quantenbusses (QUBUS) des Quantennetzwerks (QUNET) am Anfang der Kette der n Quantenpunkte (NV1 bis NVn) des Quantenbusses (QUBUS) des Quantennetzwerks (QUNET) nicht mehr direkt beeinflussen kann, sondern nur noch mit Hilfe der weiteren n-2 Quantenpunkte (NV2 bis NV(n-1)) des Quantenbusses (QUBUS) des Quantennetzwerks (QUNET) zwischen dem ersten Quantenpunkt (NV1) und dem n-ten Quantenpunkt (NVn).

Die Abstände sind nun bevorzugt so, dass der erste Kernquantenpunkt (CI1) des ersten Kern-Elektron-Quantenregisters (CEQUREG1) den n-ten Quantenpunkt (NVn) und den n-ten Kernquantenpunkt (Cln) des n-ten Kern-Elektron-Quantenregisters (CEQUREG2) nicht mehr direkt beeinflussen kann. Insbesondere sind diese Abstände sind nun bevorzugt so gewählt, dass ein magnetisches Moment des ersten Kernquantenpunkts (CI1) des ersten Kern-Elektron-Quantenregisters (CEQUREG1) das magnetische Moment des n-ten Quantenpunkts (NVn) und/oder das magnetische Moment des n-ten Kernquantenpunkts (Cln) des n-ten Kern-Elektron-Quantenregisters (CEQUREG2) nicht mehr direkt beeinflussen kann. Damit kann der erste Kernquantenpunkt (CI1) des ersten Kern-Elektron-Quantenregisters (CEQUREG1) nicht mehr ohne weiteres mit dem n-ten Quantenpunkt (NVn) und mit dem n-ten Kernquantenpunkt (Cln) des n-ten Kern-Elektron-Quantenregisters (CEQUREG2) verschränkt werden. Um den ersten Kernquantenpunkt (CI1) des ersten Kern-Elektron-Quantenregisters (CEQUREG1) mit dem n-ten Quantenpunkt (NVn) und/oder mit dem n-ten Kernquantenpunkt (Cln) des n-ten Kern-Elektron-Quantenregisters (CEQUREG2) zu verschränken, kann aber der Zustand des ersten Kernquantenpunkts (CI1) des ersten Kern-Elektron-Quantenregisters (CEQUREG1) mit dem Zustand des ersten Quantenpunkts (NV1) des ersten Kern-Elektron-Quantenregisters (CQUREG1) verschränkt werden. Danach kann der Zustand des zweiten Quantenpunkts (NV2) des zweiten Quantenbits (QUB2) des n-Bit-Elektron-Elektron-Quantenregisters (NBQUREG) des Quantenbusses (QUBUS) des Quantennetzwerks (QUNET) mit dem Zustand des ersten Quantenpunkts (NV1) des ersten Quantenbits (QUB1) des n-Bit-Elektron-Elektron-Quantenregisters (NBQUREG) des Quantenbusses (QUBUS) des Quantennetzwerks (QUNET) verschränkt werden. Danach kann der Zustand des dritten Quantenpunkts (NV3) des dritten Quantenbits (QUB3) des n-Bit-Elektron-Elektron-Quantenregisters (NBQUREG) des Quantenbusses (QUBUS) des Quantennetzwerks (QUNET) mit dem Zustand des zweiten Quantenpunkts (NV2) des zweiten Quantenbits (QUB2) des n-Bit-Elektron-Elektron-Quantenregisters (NBQUREG) des Quantenbusses (QUBUS) des Quantennetzwerks (QUNET) verschränkt werden. Dies kann so innerhalb der Kette der n Quantenpunkte (NV1 bis NVn) des Quantenbusses (QUBUS) des Quantennetzwerks (QUNET) in Form des beispielhaften n-Bit-elektron-Elektron-Quantenregisters (NBQUREG) fortgesetzt werden, bis schließlich der Zustand des n-ten Quantenpunkts (NVn) des n-ten Quantenbits (QUBn) des n-Bit-Elektron-Elektron-Quantenregisters (NBQUREG) des Quantenbusses (QUBUS) des Quantennetzwerks (QUNET) mit dem Zustand des (n-1)-ten Quantenpunkts (NV(n-1)) des (n-1)-ten Quantenbits (QUB(n-1)) des n-Bit-Elektron-Elektron-Quantenregisters (NBQUREG) des Quantenbusses (QUBUS) des Quantennetzwerks (QUNET) verschränkt wird. Auf diese Weise kann somit der Zustand des n-ten Quantenpunkts (NVn) des n-ten Quantenbits (QUBn) des n-Bit-Elektron-Elektron-Quantenregisters (NBQUREG) des Quantenbusses (QUBUS) des Quantennetzwerks (QUNET) mit dem Zustand des ersten Quantenpunkts (NV1) des ersten Quantenbits (QUB1) des n-Bit-Elektron-Elektron-Quantenregisters (NBQUREG) des Quantenbusses (QUBUS) des Quantennetzwerks (QUNET) verschränkt werden. Somit kann damit auch der Zustand des n-ten Quantenpunkts (NVn) des n-ten Quantenbits (QUBn) des n-Bit-Elektron-Elektron-Quantenregisters (NBQUREG) des Quantenbusses (QUBUS) des Quantennetzwerks (QUNET) mit dem Zustand des ersten Kernquantenpunkts (CI1) des ersten Kernquantenbits (CQUB1) verschränkt werden, wenn zuvor der Zustand des ersten Quantenpunkts (NV1) des ersten Quantenbits (QUB1) des n-Bit-Elektron-Elektron-Quantenregisters (NBQUREG) des Quantenbusses (QUBUS) des Quantennetzwerks (QUNET) mit dem Zustand des ersten Kernquantenpunkts (CI1) des ersten Kernquantenbits (CQUB1) verschränkt wurde. Abschließend kann dann der Zustand des n-ten Kernquantenpunkts (Cln) des n-ten Kernquantenbits (CQUBn) mit dem Zustand des n-ten Quantenpunkts (NVn) des n-ten Quantenbits (QUBn) des n-Bit-Elektron-Elektron-Quantenregisters (NBQUREG) des Quantenbusses (QUBUS) des Quantennetzwerks (QUNET) verschränkt werden. Dadurch wird dann auch der Zustand des n-ten Kernquantenpunkts (Cln) des n-ten Kern-Elektron-Quantenregisters (CQUREGn) mit dem Zustand des ersten Kernquantenpunkts (CI1) des ersten Kernquantenbits (CQUB1) des ersten Kern-Elektron-Quantenregisters (CQUREG1) indirekt über den Quantenbus (QUBUS) des Quantennetzwerks (QUNET) in Form des beispielhaften n-Bit-Elektro-Elektron-Quantenregisters (NBQUREG) verschränkt, obwohl eine direkte Kopplung und damit eine direkte Verschränkung des Zustands des n-ten Kernquantenpunkts (Cln) des n-ten Kern-Elektron-Quantenregisters (CQUREGn) mit dem Zustand des ersten Kernquantenpunkts (CI1) des ersten Kernquantenbits (CQUB1) des ersten Kern-Elektron-Quantenregisters (CQUREG1) aufgrund des zu großen räumlichen Abstands zwischen dem ersten Kernquantenpunkt (CI1) und dem n-ten Kernquantenpunkt (Cln) nicht möglich ist.

Statt der Kern-Elektron-Quantenregister (CEQUREG1, CEQUREG2) können auch zwei Quanten-ALUs (QUALU1, QUALU2) verwendet werden, die durch das Elektron-Elektron-Quantenregister (QUREG) oder den Quantenbus (QUBUS) des Quantennetzwerks (QUNET) miteinander verbunden werden. Ein Quantennetzwerk (QUNET) umfasst dabei bevorzugt mindestens zwei Quantenbusse (QUBUS), die miteinander verbunden sind. Im weitesten Sinne kann aber auch ein einzelner Quantenbus (QUBUS) bereits als Quantennetzwerk (QUNET) betrachtet werden.

Besonders vorteilhaft an den hier vorgestellten Quantenbits (QUB) ist, dass sie jeweils die beschriebene vertikale Leitung (LV) und horizontale Leitung (LH) aufweisen. Diese Leitungen können mit einem elektrischen konstantem Potenzial zusätzlichen und überlagernd zu den ggf. angelegten Steuersignalen beaufschlagt werden, die die Resonanzfrequenzen der zugehörigen Quantenpunkte (NV) der betreffenden Quantenbits (QUB) an einer Quantenpunkt-Position im n-Bit-Elektron-Elektron-Quantenregister (NBQUREG) eines Quantenbusses (QUBUS) verstimmen und so einen Weitertransport von Abhängigkeiten von einem Kern-Quantenpunkt (CI1) über diese Position des verstimmten Quantenpunkts hinaus verhindern. Hierdurch ist es möglich, durch das Anlegen von statischen Potenzialmustern an die Steuerleitungen (LH, LV) der Quantenbits (QUB) eines Quantennetzwerks (QUNET) mit Ihren Quantenpunkten (NV) einzelne Quantenpunkte dieses Quantennetzwerks (QUNET) zu verstimmen und somit für eine Manipulation ihrer Quantenzustände durch an die Leitungen (LH, LV) angelegte Steuersignale unempfindlich zu machen. Hierdurch kann innerhalb des Quantennetzwerks eine Untermenge von Quantenbits (QUB) mit ihren Quantenpunkten (NV) für die Steuersignale empfindlich geschaltet werden, während die übrigen Menge an Quantenbits (QUB) mit ihren Quantenpunkten (NV) für diese Steuersignale unempfindlich geschaltet ist. Dies kann beispielsweise zur Teilung eines n-Bit-Quantenregisters in ein m-Bit-Quantenregister und ein p-Bit-Quantenregister genutzt werden, wobei m+p=n gelten sollte. Diese Selektierbarkeit einzelner Quantenbits (QUB) und ihrer Quantenpunkte (NV) oder ganzer Quantenbusabschnitte und die Skalierbarkeit des hier vorgestellten Ansatzes zusammen bilden einen wesentlichen Vorteil des Vorschlags.

### Erfindungsgemäße Quantenpunktarrays

### Konstruktion eines vorschlagsgemäßen Quantenpunktarrays

Wie oben vorgestellt, ist eine wichtige mögliche Basis des hier beschriebenen Quantencomputersystems eine eindimensionale Anordnung (Figur 25) von Quantenpunkten (QREG1D, QREG2D), die als Teil eines Quantenbussystems Knicke (Figur 26), Abzweigungen (Figur 27) und Schleifen (Figur 28) aufweisen kann. In den erwähnten Figuren sind die Quantenpunkte Teil der in diesen Figuren dargestellten QuantenALUs. Die Quantenpunkte (NV11, NV12, NV13, NV21, NV22, NV23, NV31, NV32, NV33) werden bevorzugt in einem eindimensionalen Gitter (QREG1D) oder in einem zweidimensionalen Gitter (QREG2D) angeordnet. Dabei können einzelne Gitterplätze dieses eindimensionalen Gitters (QREG1D) oder zweidimensionalen Gitters (QREG2D) nicht mit Quantenpunkten besetzt sein. Wichtig ist dabei, dass bevorzugt die verbleibenden Quantenpunkte einen Graphen aus Elektron-Elektron-Quantenregistern (QUREG) bilden.

Damit dies möglich ist, sollte die hier vorgestellte Anordnung von Quantenpunkten (NV) bevorzugt so gestaltet werden, dass der Abstand (sp12) zweier unmittelbar benachbarter Quantenpunkte der Quantenpunkte (NV11, NV12, NV13, NV21, NV22, NV23, NV31, NV32, NV33) kleiner ist als 100 nm und/oder besser kleiner ist als 50 nm und/oder besser kleiner ist als 30 nm und/oder besser kleiner ist als 20 nm und/oder besser kleiner ist als 10 nm.

Bevorzugt sind alle, zumindest aber zwei Quantenpunkte der Quantenpunkte (NV11, NV12, NV13, NV21, NV22, NV23, NV31, NV32, NV33) jeweils für sich Teil genau eines Quantenbits wie zuvor beschrieben. Wie zuvor bereits mehrfach erwähnt, sind bei Verwendung von Diamant als Substrat (D) ein oder mehrere Quantenpunkte der Quantenpunkte (NV11, NV12, NV13, NV21, NV22, NV23, NV31, NV32, NV33) ein NV-Zentrum oder ein SiV Zentrum oder ein ST1-Zentrum oder ein L2-Zentrum. Besonders bevorzugt ist aufgrund der besseren Kenntnislage zum Zeitpunkt der Anmeldung dieser Schrift die Verwendung von NV-Zentren in Diamant bzw. von G-Zentren in Silizium bzw. von V-zentren in Siliziumkarbid.

### Konstruktion eines Kern-Quantenpunktarrays (CQREG1D, CQREG2D)

Analog zu der Anordnung von Quantenpunkten kann eine Anordnung von Kernquantenpunkten (CQREG1D, CQREG2D) definiert werden. Bevorzugt sind die Kernquantenpunkte (CI11, CI12, CI13, CI21, CI22, CI23, CI31, CI32, CI33) zumindest näherungsweise in einem eindimensionalen Gitter (CQREG1D) oder in einem zweidimensionalen Gitter (CQREG2D) angeordnet. Dabei kann eine Elementarzelle dieses Gitters durch mehrere Kernquantenpunkte gebildet werden. Dies ist beispielsweise dann sinnvoll, wenn ein Gitter aus QuantenALUs aufgebaut werden soll. Dabei wird ein Gitter aus Quantenpunkten (NV11, NV12, NV13, NV21, NV22, NV23, NV31, NV32, NV33) aufgebaut. Bevorzugt jedem dieser Quantenpunkte (NV11, NV12, NV13, NV21, NV22, NV23, NV31, NV32, NV33) wird dann eine Gruppe von Kernquantenpunkten zugeordnet, deren Anzahl bevorzugt, aber nicht unbedingt immer gleich ist. Bevorzugt ist auch die Anordnung der Kernquantenpunkte, die einem solchen Quantenpunkt zugeordnet sind, von QuantenALU zu QuantenALU ähnlich oder gleich. Wichtiger ist aber, dass die erste Kopplungsstärke und damit die zugehörige erste Resonanzfrequenz zwischen einem Quantenpunkt zu einem ersten Kernquantenpunkt, der diesem Quantenpunkt zugeordneten Kernquantenpunkte, verschieden ist von der zweiten Kopplungsstärke und damit die zugehörige zweite Resonanzfrequenz zwischen diesem Quantenpunkt zu einem zweiten Kernquantenpunkt, der diesem Quantenpunkt zugeordneten Kernquantenpunkte.

Wie oben ausgeführt, ist es denkbar, dass die Kernspins der Kernquantenpunkte direkt miteinander gekoppelt werden. Hierfür muss der Kernabstand (sp12') zweier unmittelbar benachbarter Kernquantenpunkte der Kernquantenpunkte (CI11, CI12, CI13, CI21, CI22, CI23, CI31, CI32, CI33) kleiner als 200 pm und/oder besser kleiner 100 pm und/oder besser kleiner ist als 50 pm und/oder besser kleiner ist als 30 pm und/oder besser kleiner ist als 20 pm und/oder besser kleiner ist als 10 pm sein.

Für die Formierung einer QuantenALU, die ein Kernelement des hier vorgestellten Quantencomputerkonzepts ist, ist es besonders zu empfehlen, dass zumindest zwei Kernquantenpunkte der Kernquantenpunkte (CI11, CI12, CI13, CI21, CI22, CI23, CI31, CI32, CI33) jeweils für sich Teil genau eines Kernquantenbits (CQUB), wie oben beschrieben, sind.

Wie oben beschrieben, ist es sinnvoll, wenn bei der Verwendung von Diamant als Substrat (D) ein oder mehrere Kernquantenpunkte der Kernquantenpunkte (CI11, CI12, CI13, CI21, CI22, CI23, CI31, CI32, CI33) ein oder mehrere Atomkerne eines ¹³C-Isotops sind.

Wie oben beschrieben, ist es sinnvoll, wenn bei der Verwendung von Silizium als Substrat (D) ein oder mehrere Kernquantenpunkte der Kernquantenpunkte (CI11, CI12, CI13, CI21, CI22, CI23, CI31, CI32, CI33) ein oder mehrere Atomkerne eines ²⁹Si-Isotops sind.

Wie oben beschrieben, ist es sinnvoll, wenn bei der Verwendung von Siliziumkarbid als Substrat (D) ein oder mehrere Kernquantenpunkte der Kernquantenpunkte (Cl11, CI12, CI13, CI21, CI22, CI23, CI31, CI32, CI33) ein oder mehrere Atomkerne eines ²⁹Si-Isotops sind oder ein oder mehrere Kernquantenpunkte der Kernquantenpunkte (CI11, CI12, CI13, CI21, CI22, CI23, CI31, CI32, CI33)ein oder mehrere Atomkerne eines ¹³C-Isotops sind.

Da bei Verwendung von Diamant als Material des Substrats (D) NV-Zentren eine hier bevorzugte Variante der Realisierung der Quantenpunkte sind, ist es bevorzugt, wenn dann ein oder mehrere Kernquantenpunkte der Kernquantenpunkte (CI11, CI12, CI13, CI21, CI22, CI23, CI31, CI32, CI33) ein Atomkern eines ¹⁵N-Isotops platziert in Diamant als Substrat (D) sind. Dies ermöglicht es beispielsweise mittels einer Implantation eines Moleküls in Diamant, das ein ¹⁵N-Isotop und mehrere ¹³C-Isotope aufweist, in einem einzigen Arbeitsschritt eine QuantenALU mit einem NV-Zentrum und mehreren Kernquantenbits aus ¹³C-Isotopen und einem Kernquantenbit in Form des ¹⁵N-Isotops als Stickstoffatom des NV-Zentrums in Diamant zu fertigen. Auch ist es möglich, dass in diesem Fall ein Kernquantenpunkt der Kernquantenpunkte (CI11, CI12, CI13, CI21, CI22, CI23, CI31, CI32, CI33) ein Atomkern eines ¹⁴N-Isotops in Diamant als Substrat (D) ist.

### Verfahren zum Betrieb des Quantencomputers

Im Folgenden werden verschiedene Verfahren beschrieben, die zum Betrieb des beschriebenen Quantencomputers benötigt werden, bzw. dafür sinnvoll sind.

Bevorzugt werden die folgenden Verfahren zum Betreiben eines Quanten-Computers durch eine Steuervorrichtung (µC) gesteuert und durchgeführt. Die Steuervorrichtung (µC) kann beispielsweise ein Mikrorechner oder ein endlicher Automat sein. Für den Betrieb werden über einen Datenbus (DA) Binärcodes in einem Speicher der Steuervorrichtung (µC) abgelegt. Die Ablage erfolgt gemäß einem Ordnungsparameter. Dies kann beispielsweise eine Speicheradresse sein. Diese Binärcodes symbolisieren eines der folgenden Verfahren oder Kombination und/oder Abfolgen (was auch eine Kombination ist) von diesen. Diese Binärcodes werden dann in Abhängigkeit von dem Ordnungsparameter wieder aus dem Speicher abgerufen. Beispielsweise kann es sich um einen Quantencomputer-Programm-Zähler handeln, der mit jedem Prozessschritt um einen Wert von 1 erhöht wird. Dieser zeigt dann direkt oder indirekt auf die nächste Speicherstelle im Speicher und damit auf den Binärcode des als nächstes auszuführenden Verfahrens. Die Steuervorrichtung (µC) arbeitet dann somit zumindest eine Teilmenge dieser Binärcodes in Abhängigkeit von dem Ordnungsparameter ab. Die Steuervorrichtung (µC) führt dann mit Hilfe der weiteren Hilfsvorrichtungen die symbolisierten Verfahren und/oder deren Kombinationen durch. Bevorzugt entspricht dabei jeder binäre Kode einem Teilverfahren zur Manipulation der Quantenpunkte bzw. der Kernquantenpunkte.

### Vorbereitende Prozesse

Die im Folgenden beschriebenen vorbereitenden Prozesse werden benötigt, um die verschiedenen Kopplungsstärken innerhalb der zuvor beschriebenen Register zu bestimmen. Diese Kopplungsstärken drücken sich in unterschiedlichen Resonanzfrequenzen aus. Um den Quantencomputer und/oder dessen Komponenten betreiben zu können, werden diese Resonanzfrequenzen einmalig vermessen und bevorzugt in einem Speicher eines Steuerrechners (µC) oder einem Speicher, auf den der Steuerrechner (µC) Zugriff hat, abgelegt. Bei der selektiven Ansteuerung der Quantenpunkte, bzw. Kernquantenpunkte, bzw. Quantenregister, bzw. Kernquantenregister, bzw. Kern-Elektron-Quantenregister werden diese ermittelten Frequenzen durch die Steuervorrichtung (µC) zur selektiven Ansteuerung dieser Vorrichtungsteile verwendet.

### Verfahren zur Frequenzbestimmung

Das erste Verfahren bestimmt die Resonanzfrequenz jedes einzelnen ansteuerbaren Quantenpunkts (NV) des Quantencomputers oder einer Teilvorrichtung, wie sie oben beschrieben wurde.

Diese Resonanzfrequenz wird im Folgenden mit Elektron1-Elektron1-Mikrowellenresonanzfrequenz (f_{MW}) bezeichnet. Das angewandte Verfahren ist daher ein Verfahren zur Vorbereitung der Änderung der Quanteninformation eines ersten Quantenpunkts (NV1), insbesondere der Elektronenkonfiguration des ersten Quantenpunkts (NV1), eines ersten Quantenbits (QUB1), wie zuvor beschrieben, in Abhängigkeit von der Quanteninformation dieses ersten Quantenpunkts (NV1), insbesondere des ersten Spins der ersten Elektronenkonfiguration des ersten Quantenpunkts (NV1), des ersten Quantenbits (QUB1). Hierzu erfolgt die Bestimmung der Energieverschiebung des ersten Quantenpunkts (NV1), insbesondere dessen ersten Elektronenkonfiguration, insbesondere wenn der Spin der ersten Elektronenkonfiguration Spin-up oder wenn der Spin der ersten Elektronenkonfiguration Spin-down ist, mittels eines ODMR Experiments mittels des Durchstimmens der Frequenz (f) einer auf den Quantenpunkt einstrahlenden elektromagnetischen Strahlung und die Bestimmung einer Elektron1-Elektron1-Mikrowellenresonanzfrequenz (f_{MW}).

Das zweite Verfahren bestimmt die Resonanzfrequenz jedes einzelnen ansteuerbaren Paares von zwei Quantenpunkten (NV1, NV2) des Quantencomputers oder einer Teilvorrichtung, wie sie oben beschrieben wurde. Es geht hier somit im Gegensatz zum vorausgehenden Verfahren nicht um die Manipulation eines einzelnen Quantenpunkts, sondern nun um die Kopplung eines ersten Quantenpunkts mit einem zweiten Quantenpunkt, der vom ersten Quantenpunkt verschieden ist.

Diese Resonanzfrequenz wird im Folgenden mit Elektron1-Elektron2- Mikrowellenresonanzfrequenz (f_{MWEE}) bezeichnet. Das angewandte Verfahren ist daher ein Verfahren zur Vorbereitung der Änderung der Quanteninformation eines ersten Quantenpunkts (NV1), insbesondere des Spins der Elektronenkonfiguration des Quantenpunkts (NV1), eines ersten Quantenbits (QUB1) eines Quantenregisters (QUREG), wie zuvor beschrieben, in Abhängigkeit von der Quanteninformation eines zweiten Quantenpunkts (NV2), insbesondere vom zweiten Spin der zweiten Elektronenkonfiguration des zweiten Quantenpunkts (NV2), eines zweiten Quantenbits (QUB2) dieses Quantenregisters (QUREG). Das Verfahren umfasst die Bestimmung der Energieverschiebung des ersten Quantenpunkts (NV1), insbesondere dessen ersten Elektronenkonfiguration, insbesondere wenn der Spin der zweiten Elektronenkonfiguration Spin-up oder wenn der Spin der zweiten Elektronenkonfiguration Spin-down ist, mittels eines ODMR Experiments durch Durchstimmen der Frequenz (f) und Bestimmung einer Elektron1-Elektron2-Mikrowellenresonanzfrequenz (f_{MWEE}).

Das dritte Verfahren bestimmt die Resonanzfrequenz jedes einzelnen ansteuerbaren Paares von einem Quantenpunkt (NV1) und einem Kernquantenpunkt (CI) des Quantencomputers oder einer Teilvorrichtung, wie sie oben beschrieben wurde. Es geht hier somit im Gegensatz zum vorausgehenden Verfahren nicht um die Manipulation eines einzelnen Quantenpunkts oder eines Paares von zwei Quantenpunkten, sondern nun um die Kopplung eines ersten Quantenpunkts mit einem ersten Kernquantenpunkt.

Die Resonanzfrequenz zur Änderung der Quanteninformation eines Quantenpunkts (NV), insbesondere des Spins seiner Elektronenkonfiguration, eines Quantenbits (QUB) eines Kern-Elektron-Quantenregisters (CEQUREG) in Abhängigkeit von der Quanteninformation eines Kernquantenpunkts (CI) wird im Folgenden mit Kern-Elektron- Mikrowellenresonanzfrequenz (f_{MWCE}) bezeichnet.

Die Resonanzfrequenz zur Änderung der Quanteninformation eines Kernquantenpunkts (CI) in Abhängigkeit von der Quanteninformation eines Quantenpunkts (NV), insbesondere des Spins seiner Elektronenkonfiguration, eines Quantenbits (QUB) eines Kern-Elektron-Quantenregisters (CEQUREG) wird im Folgenden mit Elektron-Kern-Radiowellenresonanzfrequenzen (F_{RWEC}) bezeichnet.

Das Verfahren zur Bestimmung der Kern-Elektron- Mikrowellenresonanzfrequenz (f_{MWCE}) ist daher ein Verfahren zur Vorbereitung der Änderung der Quanteninformation eines Quantenpunkts (NV), insbesondere des Spins seiner Elektronenkonfiguration, eines Quantenbits (QUB) eines Kern-Elektron-Quantenregisters (CEQUREG), wie oben beschrieben, in Abhängigkeit von der Quanteninformation eines Kernquantenpunkts (CI), insbesondere des Kernspins dessen Atomkerns, eines Kernquantenbits (CQUB) dieses Kern-Elektron-Quantenregisters (CEQUREG). Das Verfahren umfasst die Bestimmung der Energieverschiebung des Quantenpunkts (NV), insbesondere dessen Elektrons, insbesondere wenn der Kernspin Spin up oder wenn der Kernspin Spin down ist, mittels eines ODMR Experiments durch Durchstimmen der Frequenz (f) und Bestimmung einer Kern-Elektron- Mikrowellenresonanzfrequenz (f_{MWCE}).

Das Verfahren zur Bestimmung der Elektron-Kern-Radiowellenresonanzfrequenzen (f_{RWEC}) dagegen ist ein Verfahren zur Vorbereitung der Änderung der Quanteninformation eines Kernquantenpunkts (CI), insbesondere des Kernspins dessen Atomkerns, eines Kernquantenbits (CQUB) eines Kern-Elektron-Quantenregisters (CEQUREG), wie oben beschrieben, in Abhängigkeit von der Quanteninformation eines Quantenpunkts (NV), insbesondere des Spins dessen Elektronenkonfiguration, eines Quantenbits (QUB) dieses Kern-Elektron-Quantenregisters (CEQUREG). Das Verfahren umfasst die Bestimmung der Energieverschiebung eines Quantenpunkts (NV), insbesondere dessen Elektronenkonfiguration, insbesondere wenn der Kernspin Spin up oder wenn der Kernspin Spin down ist, mittels eines ODMR Experiments durch Durchstimmen der Frequenz (f) und Bestimmung der Elektron-Kern-Radiowellenresonanzfrequenzen (f_{RWEC}).

Der Vollständigkeit halber wird hier auch die Kopplung zweier Kernspins behandelt. Hierbei ist das Verfahren ein Verfahren zur Vorbereitung der Änderung der Quanteninformation eines ersten Kernquantenpunkts (CI1), insbesondere des Kernspins dessen Atomkerns, eines ersten Kernquantenbits (CQUB) eines Kern-Kern-Quantenregisters (CCQUREG) in Abhängigkeit von der Quanteninformation eines zweiten Kernquantenpunkts (CI2), insbesondere des Kernspins des zweiten Kernquantenpunks (Ci2), eines zweiten Kernquantenbits (CQUB2) dieses Kern-Kern-Quantenregisters (CCQUREG). Das Verfahren umfasst die Bestimmung der Energieverschiebung eines ersten Kernquantenpunkts (CI1), insbesondere dessen ersten Kernspins, insbesondere wenn der zweite Kernspin des zweiten Kernquantenpunkts (CI2) Spin up oder wenn der zweite Kernspin Spin down ist, mittels eines ODMR Experiments durch Durchstimmen der Frequenz (f) und Bestimmung der Kern-Kern-Radiowellenresonanzfrequenzen (f_{RWCC}).

Im Folgenden wird nun angenommen, dass die zuvor beschriebenen Kern-Kern-Radiowellenresonanzfrequenzen (f_{RWCC}), Elektron-Kern-Radiowellenresonanzfrequenzen (f_{RWEC}), Kern-Elektron- Mikrowellenresonanzfrequenzen (f_{MWCE}), Elektron1-Elektron2-Mikrowellenresonanzfrequenzen (f_{MWEE}) und Elektron1-Elektron1-Mikrowellenresonanzfrequenzen (f_{MW}) für die elektromagnetischen Steuerfelder und damit für die elektrischen Steuerströme der horizontalen und vertikalen Leitungen (LH, LV) bekannt sind. Die entsprechenden Werte für die zu manipulierenden Quantencomputerkomponenten, die zuvor beschrieben wurde, werden bevorzugt in einem Speicher des Steuerrechners (µC) oder einem Speicher, der diesem zugänglich ist, abgelegt.

Der Steuerrechner (µC) konfiguriert für jede Operation dann Mittel (HD1, HD2, HD3, VD1, HS1, HS2, HS3, VS1) in der Art, dass diese Mittel (HD1, HD2, HD3, VD1, HS1, HS2, HS3, VS1) bevorzugt beginnend mit dem Startsignal des Steuerrechners (µC) oder einer anderen, bevorzugt durch den Steuerrechner (µC) kontrollierten, Ablaufsteuerung die notwendigen Strombursts und/oder elektromagnetischen Wellenbursts mit der richtigen Frequenz und der richtigen Hüllkurve erzeugen.

### Einzeloperationen

Im Folgenden werden wichtige Einzeloperationen beschrieben, die zum Verwenden des hier vorgeschlagenen Quantencomputers notwendig sind. Bevorzugt symbolisieren bestimmte binäre Kodes diese Einzeloperationen. Diese Einzeloperationen können zu Befehlssequenzen zusammengesetzt werden. Diese Befehlssequenzen entsprechen Sequenzen von Binär-Kodes, die der Steuerrechner (µC) ausführt. Bevorzugt steuert eine Steuervorrichtung, beispielsweise ein Steuerrechner (µC), die zeitliche Abfolge der hier vorgestellten Einzeloperationen. Bevorzugt arbeitet dabei der Steuerrechner (µC) bzw. die Steuervorrichtung einen Programm-Code aus Binär-Zahlen ab, bei denen zumindest ein Teil der Binärzahlen eine vorbestimmte Folge von Einzeloperationen darstellt.

Ein Einzeloperationscode des besagten Binärprogramms des Steuerrechners (µC) löst eine Operation des Steuerrechners (µC) aus, die bevorzugt aus einer oder mehreren Einzeloperationen bestehen kann, die bevorzugt zeitlich sequenziell oder parallel ausgeführt werden. Der Steuerrechner (µC) erhöht hierzu einen Programmzähler (PCN) und ermittelt den Binärwert des aktuellen Einzeloperationscodes am Speicherort entsprechend dem Programmzähler (PCN) in seinem Programmspeicher, der den Binärcode enthält. Bei dem Steuerrechner (µC) handelt es sich bevorzugt um einen konventionellen Rechner in von-Neumann- oder Harvard-Architektur. Der Steuerrechner (µC) erzeugt dann die zeitlich korrekten Abfolgen der verschiedenen Steuersignale für die horizontalen und vertikalen Leitungen (LH, LV) der Quantenbits (QUB) des Quantencomputers und die betreffenden Hilfsaggregate, wie beispielsweise Leuchtmittel zur Erzeugung "grünen Lichts" zur Bestrahlung der Quantenpunkte (NV) der Quantenbits (QUB) mit grünem Licht entsprechend dem Binärwert des Programm-Codes am Speicherort. Bevorzugt verweist ein solcher Binärwert des Programm-Codes auf Unter-Routinen aus Einzeloperationscodes, um komplexere Abfolgen erzeugen zu können.

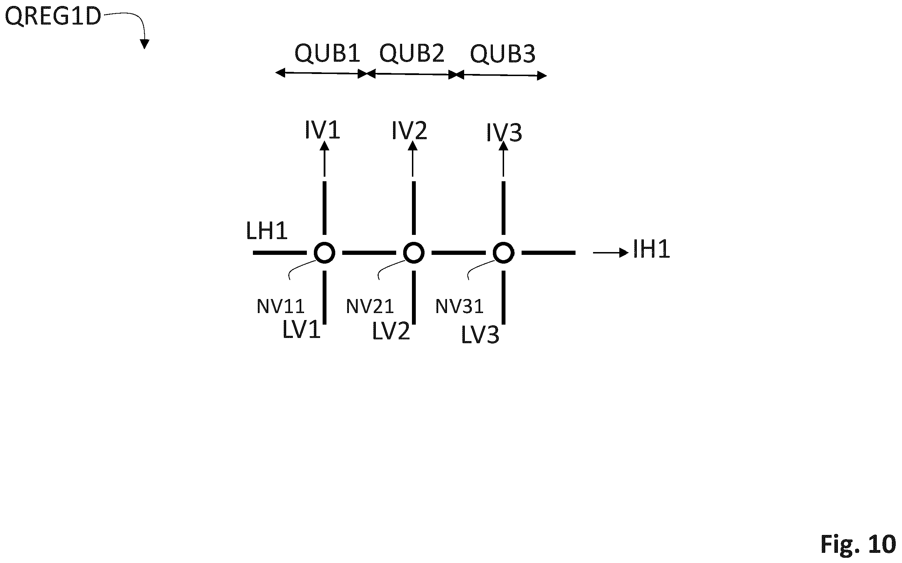

Im Folgenden nehmen wir an, dass der Quantencomputer über n Quantenbits (QUB1 bis QUBn) verfügt, die linear längs einer horizontalen Leitung (LH1) angeordnet sind. Jedem j-ten Quantenbit (QUBj), mit 1≤j≤n, der n Quantenbits (QUB1 bis QUBn) sei jeweils eine j-te vertikale Leitung (LVj), mit 1≤j≤n, der n vertikalen Leitungen (LV1 bis LVn) zugeordnet. Den n Quantenbits (QUB1 bis QUBn) entsprechen ihre n Quantenpunkte (NV11 bis NV1n). Für die Situation n=3 sei eine lineare Anordnung der Quantenbits (QUB1 bis QUBn) in Form eines eindimensionalen Quantenregisters (QREG1D) vereinfacht als schematische Skizze der Figur 10 beispielhaft hier angegeben, um das Gemeinte zu verdeutlichen.

### Quantenbit-Rücksetzverfahren

Eine der wichtigsten Einzeloperationen eines Quantencomputers ist dabei ein Verfahren zum Zurücksetzen eines Quantenpunkts (NV) eines zuvor beschriebenen Quantenbits (QUB) in einen vordefinierten Zustand. Das Verfahren wird bevorzugt beispielsweise durch einen Rücksetz-Code im besagten Binärprogramm des Steuerrechners (µC) ausgelöst.

Der Steuerrechner (µC) aktiviert hierzu ein Leuchtmittel (LED), dass den betreffenden j-ten Quantenpunkt (QUBj) der n Quantenpunkte (QUB1 bis QUBn) mit grünem Licht bestrahlen kann. Hierbei kann die Vorrichtung optische Funktionsmittel wie Spiegel, Linsen, Lichtwellenleiter etc. aufweisen, die das grüne Licht des Leuchtmittels (LED) zu dem betreffenden j-ten Quantenpunkt (QUBj) der n Quantenpunkte (QUB1 bis QUBn) leiten. Bevorzugt erfolgt das Rücksetzen so, dass alle Quantenpunkte (NV1 bis NVn) aller Quantenbits (QUB1 bis QUBn) des Quantencomputers gleichzeitig durch Bestrahlung mit "grünem Licht" einer oder mehrerer Leuchtmittel (LED) oder einer funktionsäquivalenten Strahlung zurückgesetzt werden. Es erfolgt somit ein Bestrahlen zumindest eines Quantenpunkts (NV) der Quantenpunkte (NV1 bis NVn) mit Licht, das funktionsgleich zu einer Bestrahlung eines NV-Zentrums in Diamant bei der Verwendung dieses NV-Zentrums als Quantenpunkt (NV) mit "grünem Licht" in Bezug auf die Wirkung dieser Bestrahlung auf den Quantenpunkt (NV) ist.

Bei einem NV-Zentrum (NV) in Diamant als Material des Substrats (D) führt die Bestrahlung mit "grünem Licht" im Sinne dieser Offenlegung zu einem Zurücksetzen der Quanteninformation. Bei der beispielhaften Verwendung eines NV-Zentrums (NV) in Diamant als Quantenpunkt (NV) besitzt das "grüne Licht" bevorzugt eine Wellenlänge in einem Wellenlängenbereich von 400 nm bis 700 nm Wellenlänge und/oder besser 450 nm bis 650 nm und/oder besser 500 nm bis 550 nm und/oder besser 515 nm bis 540 nm. Im Zuge der Erarbeitung des technischen Inhalts dieser Schrift ergab eine Wellenlänge von 532 nm der elektromagnetischen Rücksetzstrahlung, die durch einen Laser (LED) erzeugt wurde, gute Resultate. Auch wurden mit einer grünen Laser-Diode mit 520nm Wellenlänge gute Ergebnisse erzielt. Im Falle der Verwendung anderer Subastrate (D) und/oder anderer Quantenpunkte wird eine elektromagnetische Strahlung im Sinne dieser Schrift dann als "grünes Licht" bezeichnet, wenn diese Bestrahlung mit dieser elektromagnetischen Strahlung eine funktionsähnliche Wirkung auf den betreffenden Quantenpunkt (NV) hat, wie die zuvor beschriebene Bestrahlung eines NV-Zentrums in Dimant mit elektromagnetischer Strahlung in einem Wellenlängenbereich von 400 nm bis 700 nm Wellenlänge und/oder besser 450 nm bis 650 nm und/oder besser 500 nm bis 550 nm und/oder besser 515 nm bis 540 nm und/oder optimal mit einer Wellenlänge von 532 nm. Im Falle von NV-Zentren in Diamant hat sich eine Laser-Diode der Fa. Osram vom Typ PLT5 520B mit 520nm Wellenlänge als beispielhafte Quelle "grünen Lichts" für die Bestrahlung von NV-Zentren in Diamant als Material des Substrats (D) bewährt. Dieses funktionsgleiche Licht wird in dieser Schrift ganz allgemein als "grünes Licht" bezeichnet und ist daher nicht durch den visuellen Eindruck, sondern durch seine Funktionalität in der vorgeschlagenen Vorrichtung definiert.

### Kernquantenbit-Rücksetzverfahren bzw. QuantenALU-Rücksetzverfahren

Im Folgenden Abschnitt wird das Zurücksetzen eines Kern-Elektron-Quantenregisters (CEQUREG), wie es oben beschrieben wurde, dargestellt. Wie zuvor beschrieben, kann das Quantenbit (QUB) des eines Kern-Elektron-Quantenregisters (CEQUREG) als Terminal für den Anschluss einer Kette aus Quantenregistern (QUREG) beispielsweise in Form eines n-Bit-Quantenregisters (NBQUREG) verstanden werden. Über dieses Terminal des Quantenpunkts (NV) des Quantenbits (QUB) des Kern-Elektron-Quantenregisters (CEQUREG) wird bevorzugt der Löschvorgang des Kernquantenbits (CQUB) des Kern-Elektron-Quantenregisters (CEQUREG) durchgeführt, da der direkte Zugriff auf den Kernquantenpunkt (CI) des Kernquantenbits (CQUB) des Kern-Elektron-Quantenregisters (CEQUREG) schwierig ist. Um diesen Kernquantenpunkt (CI) des Kernquantenbits(CQUB) des Kern-Elektron-Quantenregisters (CEQUREG) zurückzusetzen, wird zunächst der Quantenpunkt (NV) des Quantenbits (QUB) des Kern-Elektron-Quantenregisters (CEQUREG) zurückgesetzt. Dies geschieht wie oben beschrieben durch Bestrahlen des Quantenpunkts (NV) des Quantenbits (QUB) des Kern-Elektron-Quantenregisters (CEQUREG) mit grünem Licht. Der erste Schritt ist somit die Einzeloperation des Löschens der Quanteninformation des Quantenpunkts(NV) des Quantenbits (QUB) des Kern-Elektron-Quantenregisters (CEQUREG).

Nun ändert in einer zweiten Quantenoperation bevorzugt der Steuerrechner (µC) die Quanteninformation des Kernquantenpunkts (CI) des Kernquantenbits (CQUB) des Kern-Elektron-Quantenregisters (CEQUREG) in Abhängigkeit von der Quanteninformation des Quantenpunkts (NV). Insbesondere wird hierbei der bevorzugt der Kernspins des Atomkerns des Kernquantenpunkts (CI) des Kernquantenbits (CQUB) des Kern-Elektron-Quantenregisters (CEQUREG) geändert. Bevorzugt erfolgt die Änderung in Abhängigkeit von dem Elektronenspin der Elektronenkonfiguration des Quantenpunkts (NV) des Quantenbits (QUB) dieses Kern-Elektron-Quantenregisters (CEQUREG) bzw. vom Elektronenspin eines Elektrons des Quantenpunkts (NV) des Quantenbits (QUB) dieses Kern-Elektron-Quantenregisters (CEQUREG). Bevorzugt erfolgt die Änderung der Quanteninformation des Kernquantenpunkts (CI), insbesondere des Kernspins dessen Atomkerns, des Kernquantenbits (CQUB) des Kern-Elektron-Quantenregisters (CEQUREG) in Abhängigkeit von der Quanteninformation des Quantenpunkts (NV), insbesondere vom Elektronenspin dessen Elektrons bzw. dessen Elektronenkonfiguration, des Quantenbits (QUB) dieses Kern-Elektron-Quantenregisters (CEQUREG) mit Hilfe eines Verfahrens wie zuvor beschrieben.

### Einzelbit-Manipulationen

### Quantenbit-Manipulationsverfahren

Wir beschreiben nun ein Verfahren zur Manipulation eines einzelnen Quantenbits (QUB). Wir nehmen hier an, dass das Quantenbit (QUB) insbesondere einem der zuvor beschriebenen Quantenbitkonstruktionen entspricht. Um nun den Quantenpunkt (NV) des Quantenbits (QUB) anzusteuern, erfolgt ein zeitweises Bestromen der horizontalen Leitung (LH). Hierbei speist die zugehörige horizontale Treiberstufe (HD) bevorzugt einen horizontalen Mikrowellenstrom in die horizontale Leitung (LH) ein, die mit der Elektron1-Elektron1-Mikrowellenresonanzfrequenz (f_{MW}) moduliert ist. Dabei handelt es sich nur um die Schwerpunktfrequenz des Stromsignals. In der Realität handelt es sich ja um einen Burst. Alleine schon durch die zeitliche Begrenzung des Bursts mit einem Startzeitpunkt und einem Endzeitpunkt kommt es zu einer Modifikation des Spektrums, die hier nicht weiter betrachtet wird. Der Startzeitpunkt und der Endzeitpunkt entsprechen einer zeitweisen Bestromung. Der durch die horizontale Treiberstufe (HD) eingespeiste horizontalen Strom (IH) weist somit eine horizontale Stromkomponente auf, die mit einer Elektron1-Elektron1-Mikrowellenresonanzfrequenz (f_{MW}) mit einer horizontalen Modulation moduliert ist. In analoger Weise erfolgt ein zeitweises Bestromen der vertikalen Leitung (LV) mit einem vertikalen Strom (IV) mit einer vertikalen Stromkomponente, die mit der Elektron-Elektron-Mikrowellenresonanzfrequenz (f_{MW}) mit einer vertikalen Modulation moduliert ist. Hierbei speist die zugehörige vertikale Treiberstufe (VD) bevorzugt einen vertikalen Mikrowellenstrom in die horizontale Leitung (LH) ein, der mit der Elektron1-Elektron1-Mikrowellenresonanzfrequenz (f_{MW}) moduliert ist. Auch hier wird wieder ein Strom-Burst verwendet, der einen zeitlichen Beginn und ein zeitliches Ende aufweist. Die vertikale Bestromung ist somit ebenfalls nur zeitweise. Bevorzugt ist jedoch der zeitliche Beginn des vertikalen Strom-Bursts gegenüber dem zeitlichen Beginn des horizontalen Strom-Bursts zeitlich verschoben. Damit ist die horizontale Modulation der horizontalen Stromkomponente bevorzugt um +/- 90° gegenüber der vertikalen Modulation der vertikalen Stromkomponente zeitlich phasenverschoben. Dies führt zu einem links oder rechts-polarisierten Mikrowellenfeld am Ort des Quantenpunkts (NV), der mit Hilfe dieses Mikrowellenfeldes dann manipuliert werden kann. Die zeitliche Differenz zwischen dem zeitlichen Ende des vertikalen Strom-Bursts und dem zeitlichen Beginn des vertikalen Strom-Bursts ist die vertikale Pulsdauer. Die zeitliche Differenz zwischen dem zeitlichen Ende des horizontalen Strom-Bursts und dem zeitlichen Beginn des horizontalen Strom-Bursts ist die horizontale Pulsdauer. Bevorzugt sind die vertikale Pulsdauer und die horizontale Pulsdauer in etwa gleich. Die vertikale Stromkomponente ist somit bevorzugt mit einem vertikalen Strompuls mit einer Pulsdauer gepulst und die horizontale Stromkomponente ist bevorzugt mit einem horizontalen Strompuls mit einer Pulsdauer gepulst. Um die zirkulare Polarisation des elektromagnetischen Mikrowellenfeldes am Ort des Quantenpunkts (NV) des Quantenbits (QUB) zu erzeugen, ist der vertikale Strompuls gegenüber dem horizontalen Strompuls bevorzugt um +/- π/2 der Periode der Elektron-Elektron-Mikrowellenresonanzfrequenz (f_{MW}) phasenverschoben. Der Steuerrechner (µC) stellt dabei die horizontale Treiberstufe (HD) und die vertikale Treiberstufe (VD) so ein, dass diese bevorzugt mit Hilfe eines Synchronisationssignals synchronisiert und phasenrichtig den jeweiligen horizontalen Strompuls bzw. vertikalen Strompuls erzeugen.

Bevorzugt entspricht dabei die zeitliche Pulsdauer des horizontalen Strompulses und die zeitliche Pulsdauer des vertikalen Strompulses einer zeitlichen Pulsdauer entsprechend einer zeitlichen Phasendifferenz von π/4 oder π/2 (Hadamard Gate) oder 3π/4 oder π (NOT-Gate) der Rabi-Oszillation des Quantenpunkts (NV). Im Falle einer Pulsdauer von π/2 wird im Folgenden von einem Hadamar-Gate oder einer Hadamar-Operation gesprochen. Im Falle einer Pulsdauer von π wird im Folgenden von einem NOT-Gate oder einer NOT-Operation gesprochen. Alternativ kann eine Operation bevorzugt auch so definiert werden, dass die zeitliche Pulsdauer des horizontalen Strompulses und die zeitliche Pulsdauer des vertikalen Strompulses einer zeitlichen Pulsdauer entsprechend einer Phasendifferenz eines ganzzahligen Vielfachen von π/4 der Rabi-Oszillation des Quantenpunkts (NV) entspricht.

Muss ein Quantenbit (QUBj) (1≤j≤n) mehrerer Quantenbits (QUB1 bis QUBn) (n>1, n ∈ N) einer Gesamtvorrichtung angesteuert werden, so ist das zu verwendende Spektrum des MikrowellenBursts dahingehend entscheidend, dass dieses über die Verkopplung mit anderen Quantenbits der n Quantenbits (QUB1 bis QUBn) entscheidet. Dies wird durch eine geeignete Gestaltung der Einschwingphase und der Ausschwingphase des Mikrowellenbursts erreicht. Ein Strompuls zur Erzeugung eines Mikrowellenpulses weist daher bevorzugt eine Einschwingphase und eine Ausschwingphase auf, wobei der Strompuls eine Amplitudenhüllkurve besitzt. Die Pulsdauer des Strompulses bezieht sich dann auf den zeitlichen Abstand der Zeitpunkte der 70% Amplitude der Amplitudenhüllkurve bezogen auf die Maximalamplitude der Amplitudenhüllkurve des Strompulses zur Erzeugung des Mikrowellensignals.

### Kernquantenbit-Manipulationsverfahren

Im vorausgehenden Abschnitt wurde diskutiert, wie der Quantenzustand eines Elektrons bzw. der Elektronenkonfiguration eines Quantenpunkts (NV) eines Quantenbits (QUB) direkt manipuliert werden kann. Nun wird das analoge Verfahren für ein Kernquantenbit (CQUB), wie es zuvor beschrieben wurde, betrachtet.

Wie leicht durch Vergleich der Figuren 1 und 2 leicht erkenntlich ist, ist die Vorrichtung zur direkten Ansteuerung des Kernquantenpunkts (CI) eines Kernquantenbits (CQUB) praktisch gleich der Vorrichtung zur Ansteuerung des Quantenpunkts (NV) eines Quantenbits (QUB). Diese Vorrichtung besteht in den Vorrichtungen der Figuren 1 und 2 aus einer horizontalen Leitung (LH) und einer vertikalen Leitung (LV), die sich über dem Quantenpunkt (NV) bzw. dem Kernquantenpunkt (CI) kreuzen.

Die Ansteuerung eines Kernquantenpunktes (CI) erfolgt daher analog zu der Ansteuerung eines Quantenpunkts (NV). Da die Masse eines Elektrons bzw. einer Elektronenkonfiguration eines Quantenpunkts (NV) geringer ist als die Masse eines Atomkerns eines Kernquantenpunkts (CI), ist für die Manipulationen des Kernquantenpunkts (CI) eine betragsmäßig kleinere zweiten Kern-Kern-Radiowellenfrequenz (f_{RWCC2}) notwendig als der Betrag der Elektron-Elektron-Mikrowellenresonanzfrequenz (f_{MW}), die zur Manipulation des Quantenpunkts (NV) verwendet wird.

Das Verfahren zu Manipulation der Quanteninformation des Kernquantenpunkts (CI) umfasst daher analog zur Ansteuerung des Quantenpunkts (NV) eines Quantenbits (QUB) ein Bestromen der horizontalen Leitung (LH) des Kernquantenbits (CQUB) mit einem horizontalen Strom (IH) mit einer horizontalen Stromkomponente, die mit einer ersten Kern-Kern-Radiowellenfrequenz (f_{RWCC}) und/oder mit einer zweiten Kern-Kern-Radiowellenfrequenz (f_{RWCC2}) als Modulationsfrequenz mit einer horizontalen Modulation moduliert ist. Des Weiteren umfasst das Verfahren in analoger Weise das vorzugsweise leicht zeitversetzte Bestromen der vertikalen Leitung (LV) des Kernquantenbits (CQUB) mit einem vertikalen Strom (IV) mit einer vertikalen Stromkomponente, die mit der Modulationsfrequenz mit einer vertikalen Modulation moduliert ist. Wie bei der Ansteuerung eines Quantenpunkts (NV) ist es sinnvoll, zur Manipulation des Kernquantenpunkts (CI) links oder rechts polarisierte elektromagnetische Wellen am Ort des Kernquantenpunkts (CI) zu verwenden. Hierzu ist bevorzugt die horizontale Modulation der horizontalen Stromkomponente um +/- 90° gegenüber der vertikalen Modulation der vertikalen Stromkomponente zeitlich phasenverschoben. Hierbei bezieht sich die Angabe +/-π/2 auf die Phasenlage der Modulationsanteile des vertikalen Stromanteils und der horizontalen Stromanteils mit Kern-Kern-Radiowellenfrequenz (f_{RWCC2}) relativ zueinander. Wie zuvor im Falle der Manipulation eines Quantenpunkts (NV) sind auch im Falle der Manipulation eines Kernquantenpunkts die vertikale Stromkomponente mit einem vertikalen Strompuls mit einer Pulsdauer gepulst und die horizontale Stromkomponente mit einem horizontalen Strompuls mit einer Pulsdauer gepulst. Alternativ kann dies auch so ausgedrückt werden, dass bevorzugt der vertikale Strompuls gegenüber dem horizontalen Strompuls um +/- π/4 oder besser +/- π/2 der Periode der ersten Kern-Kern-Radiowellenfrequenz (F_{RWCC}) bzw. um +/- π/4 oder besser +/- π/2 der Periode der zweiten Kern-Kern-Radiowellenfrequenz (f_{RWCC2}) phasenverschoben ist. Bevorzugt besitzt die zeitliche Pulsdauer des horizontalen Strompulses und des vertikalen Strompulses eine Pulsdauer entsprechend einer Phasendifferenz von π/4 oder π/2 (Hadamard-Gate) oder 3π/4 oder π (NOT-Gate) der Periodendauer der Rabi-Oszillation Kernquantenpunkts (CI) des ersten Kernquantenbits (CQUB). Anders ausgedrückt besitzt die zeitliche Pulsdauer des horizontalen Strompulses und des vertikalen Strompulses eine Pulsdauer entsprechend einer Phasendifferenz eines ganzzahligen Vielfachen von π/4 der Periodendauer der Rabi-Oszillation Kernquantenpunkts (CI) des ersten Kernquantenbits (CQUB).

Bevorzugt entspricht dabei die zeitliche Pulsdauer des horizontalen Strompulses und die zeitliche Pulsdauer des vertikalen Strompulses einer zeitlichen Pulsdauer entsprechend einer zeitlichen Phasendifferenz von π/4 oder π/2 (Hadamard Gate) oder 3π/4 oder π (NOT-Gate) der Rabi-Oszillation des Kernquantenpunkts (CI). Im Falle einer Pulsdauer von π/2 wird im Folgenden von einem Hadamar-Gate oder einer Hadamar-Operation gesprochen. Im Falle einer Pulsdauer von π wird im Folgenden von einem NOT-Gate oder einer NOT-Operation gesprochen. Alternativ kann eine Operation bevorzugt auch so definiert werden, dass die zeitliche Pulsdauer des horizontalen Strompulses und die zeitliche Pulsdauer des vertikalen Strompulses einer zeitlichen Pulsdauer entsprechend einer Phasendifferenz eines ganzzahligen Vielfachen von π/4 der Rabi-Oszillation des Kernquantenpunkts (CI) entspricht.

Muss ein Kernquantenpunkt (Clj) mehrerer Kernquantenpunkte (CI1 bis CIn) einer Gesamtvorrichtung, z.B. einer QuantenALU wie sie im Folgenden noch erläutert wird, angesteuert werden, so ist das zu verwendende Spektrum des Radiowellen-Bursts dahingehend entscheidend, dass dieses über die Verkopplung mit anderen Kernquantenpunkten der n Kernquantenpunkte (CI1 bis Cln) entscheidet. Dies wird durch eine geeignete Gestaltung der Einschwingphase und der Ausschwingphase des Radiowellenbursts erreicht. Ein Strompuls zur Erzeugung eines Radiowellenpulses (=Radiowellenbursts) weist daher bevorzugt eine Einschwingphase und eine Ausschwingphase auf, wobei der Strompuls eine Amplitudenhüllkurve besitzt. Die Pulsdauer des Strompulses bezieht sich dann auf den zeitlichen Abstand der Zeitpunkte der 70% Amplitude der Amplitudenhüllkurve bezogen auf die Maximalamplitude der Amplitudenhüllkurve des Strompulses zur Erzeugung des Radiowellensignals.

Das Kernquantenbitmanipulationsverfahren wird hier nur der Vollständigkeit halber aufgeführt. Für den Betrieb des Quantencomputers hat es zum Zeitpunkt der Anmeldung dieser Schrift eine untergeordnete Bedeutung.

### Quantenregistereinzeloperationen

### Selektive Manipulationsverfahren für einzelne Quantenbits in Quantenregistern

*Selektives Ansteuerverfahren zur Ansteuerung eines einzelnen Quantenbits eines Quantenregisters ohne wesentliche Beeinträchtigung der anderen Quantenbits des betreffenden Quantenregisters.* In diesem Abschnitt wird diskutiert, wie die Quanteninformation eines einzelnen Quantenbits (QBj) eines n-Bit-Quantenregisters (NBQUREG) mit n Quantenbits (QUB1 bis QUBn) mit 1≤j≤n mit hoher Wahrscheinlichkeit geändert werden kann ohne der Quanteninformationen der n-1 anderen Quantenbits (QUB1 bis QUB(i-1) und QUB(j+1) bis QUBn) der n Quantenbits (QUB1 bis QUBn) zu ändern. Dies ist somit eine sehr grundlegende Operation, da sie die Adressierung einzelner Quantenbits (QUBj) der n Quantenbits (QUB1 bis QUBn) des n-Bit-Quantenregisters (NBQUREG) beschreibt.

Zur Beschreibung des Vorgangs wird angenommen, dass j=1 gilt, es sich also um das erste Quantenbit (QUB1) handelt. Das Verfahren kann aber auch auf alle anderen Quantenbits eines ein- oder zweidimensionalen Quantenregisters angewendet werden. Das Quantenregister und die Quantenbits entsprechen bevorzugt den zuvor beschriebenen Quantenbits und Quantenregistern.

Es handelt sich bei dem hier beispielhaft beschriebenen Verfahren somit um ein beispielhaftes Verfahren zur selektiven Ansteuerung eines ersten Quantenbits (QUB1) eines beispielhaften n-Bit-Quantenregisters (NBQUREG), wie es zuvor beschrieben wurde. Zuvor wurde beispielhaft angenommen, dass die Quantenbits (QUB1 bis QUBn) längs der ersten horizontalen Leitung (LH1) angeordnet sind, die den beispielhaften n Quantenbits (QUB1 bis QUBn) des beispielhaften n-Bit-Quantenregisters (NBQUREG) beispielhaft gemeinsam sein soll. Es wird ausdrücklich darauf hingewiesen, dass diese Anordnung hier nur beispielhaft zur Vereinfachung der Beschreibung verwendet wird und dass andere Anordnungen möglich sind und von der Beanspruchung umfasst sind.

Für die Adressierung umfasst das Verfahren den Schritt des zeitweisen Bestromens der beispielhaft gemeinsamen ersten horizontalen Leitung (LH1) des n-Bit-Quantenregisters (NBQUREG) mit einer ersten horizontalen Stromkomponente des ersten horizontalen Stromes (IH1), der mit einer ersten horizontalen Elektron1-Elektron1-Mikrowellenresonanzfrequenz (f_{MWH1}) mit einer ersten horizontalen Modulation moduliert ist. Es wird also ein erster horizontaler Strom-Burst oder Strompuls in die erste horizontale Leitung (LH1) eingespeist. Entsprechend der beispielhaften Konstruktion werden somit alle Quantenbits des n-Bit-Quantenregisters (NBQUREG) längs der ersten horizontalen Leitung (LH1) dem sich ergebenden magnetischen Feld ausgesetzt. Des Weiteren umfasst das beispielhafte Verfahren das zeitweise Bestromen der ersten vertikalen Leitung (LV1) des n-Bit-Quantenregisters (NBQUREG) mit einer ersten vertikalen Stromstromkomponente des ersten vertikalen Stromes (IV1), die mit der ersten vertikalen Elektron1-Elektron1-Mikrowellenresonanzfrequenz (f_{MWV1}) mit einer ersten vertikalen Modulation moduliert ist. Das magnetische Feld dieser ersten vertikalen Stromstromkomponente des ersten vertikalen Stromes (IV1) beeinflusst somit vor allem den ersten Quantenpunkt (NV1) des ersten Quantenbits (QUB1) und in wesentlich geringerem Maße die benachbarten Quantenpunkte der benachbarten Quantenbits, wobei die Beeinflussung mit steigendem Abstand schnell abfällt. Es wird also ein erster vertikaler Strom-Burst oder Strompuls in die erste vertikale Leitung (LV1) eingespeist.

Um nun die anderen Quantenpunkte der anderen Quantenbits der n Quantenbits (QUB1 bis QUBn) und zwar insbesondere die unmittelbar benachbarten Quantenpunkte der benachbarten Quantenbits nicht durch den vertikalen Strompuls und/oder den horizontalen Strompuls anzusprechen, werden die Resonanzfrequenzen dieser nicht anzusprechenden Quantenbits gezielt verstimmt. Diese Verstimmung kann beispielsweise durch statische Gleichströme in den zugehörigen vertikalen Leitungen dieser nicht anzusprechenden Quantenbits erfolgen oder durch elektrostatische Potenziale auf diesen vertikalen Leitungen, die zu elektrischen Feldstärken am Ort der Quantenpunkte dieser nicht anzusprechenden Quantenbits führen, die diese Resonanzfrequenzen verstimmen. Durch diese Verstimmung geraten diese verstimmten Quantenpunkte nicht mehr in Resonanz mit der vertikalen Elektron1-Elektron1-Mikrowellenresonanzfrequenz (f_{MWV1}) und/oder der horizontalen Elektron1-Elektron1-Mikrowellenresonanzfrequenz (f_{MWH1}). Somit wird die Quanteninformation der Quantenpunkte dieser verstimmten Quantenbits der n Quantenbits (QUB1 bis QUBn) nicht durch den vertikalen Strompuls und/oder den horizontalen Strompuls beeinflusst.

Somit wird hier die Funktion offengelegt, die der Funktion eines Adressdekoders in einem konventionellen Rechner mit Von-Neumann- oder Harvard-Architektur entspricht.

Dieses Verfahren zur Selektion eines oder mehrerer einzelner Quantenbits in der Menge der n-Quantenbits eine n-Bi-Quantenregisters (NBQUREG) ist ein wesentlicher Aspekt der hier vorgelegten technischen Lehre. Mittels dieser Methodik können einzelne Quantenbits aber auch Gruppen von zwei oder mehr Quantenbits, beispielsweise einzelne Zwei-Bit-Quantenregister innerhalb von Mehrbitquantenregistern, mittels Verstimmung der nicht anzusprechenden Quantenbits und Ansteuerung mit der geeigneten Resonanzfrequenz angesprochen werden.

Die Verstimmung wird an der Paarung aus einem ersten Quantenbit (QUB1) und einem zweiten Quantenbit (QUB2) erläutert. Sie kann auf andere Paarungen beispielsweise eines i-ten Quantenbits (QUBi) mit einem j-ten Quantenbit (QUBj) erweitert werden. Somit können dann beispielsweise k Quantenbits angesprochen werden und n-k Quantenbits eines beispielhaften n-Bit-Quantenregisters (NBQUREG) verstimmt werden sodass nur k Quantenbits des besagten beispielhaften n-Bit-Quantenregisters (NBQUREG) mit n Quantenbits (QUB1 bis QUBn) angesprochen werden. Besonders bevorzugt wird k=1 gewählt.

Diese Verstimmung der Resonanzfrequenzen erfolgt beispielsweise bevorzugt durch zusätzliches Bestromen der ersten horizontalen Leitung (LH1) mit einer ersten horizontalen Gleichstromkomponente (IHG1) des ersten horizontalen Stromes (IH1), wobei die erste horizontale Gleichstromkomponente (IHG1) einen ersten horizontalen Stromwert von 0A aufweisen kann, und/oder durch zusätzliches Bestromen der ersten vertikalen Leitung (LV1) mit einer ersten vertikalen Gleichstromkomponente (IVG1) des ersten vertikalen Stromes (IV1), wobei auch die erste vertikale Gleichstromkomponente (IVG1) einen ersten vertikalen Stromwert von 0A aufweisen kann. Um die anderen Quantenbits der n Quantenbits (QUB1 bis QUBn) nun zu verstimmen, erfolgt beispielsweise ein zusätzliches Bestromen der zweiten vertikalen Leitung (LV2) mit einer zweiten vertikalen Gleichstromkomponente (IVG2), wobei die zweite vertikale Gleichstromkomponente einen zweiten vertikalen Stromwert aufweist, der von dem ersten vertikalen Stromwert abweicht. Durch dieses Abweichen des zweiten vertikalen Stromwerts von dem ersten vertikalen Stromwert wird erreicht, dass die Resonanzfrequenz des ersten Quantenpunkts (NV1) des ersten Quantenbits (QUB1) von der Resonanzfrequenz des zweiten Quantenpunkts (NV2) des zweiten Quantenbits (QUB2) abweicht.

Wie bereits zuvor erwähnt, kann dieses Verfahren auch für andere Quantenbitpaarungen angewendet werden. Basis des selektiven Ansteuerungsverfahrens ist dabei, wie bereits erwähnt, die Selektion des ersten Quantenbits (QUB1) oder des zweiten Quantenbits (QUB2) durch Verstimmung der der ersten vertikalen Elektron1-Elektron1-Mikrowellenresonanzfrequenz (f_{MWV1}) des ersten Quantenbits (QUB1) gegenüber der zweiten vertikalen Elektron1-Elektron1-Mikrowellenresonanzfrequenz (f_{MWV2}) des zweiten Quantenbits (QUB2).

Wie zuvor ist die Verwendung zirkular polarisierter elektromagnetischer Wellen zu Manipulation der Quantenpunkte der Quantenbits sinnvoll. Es ist daher zweckmäßig, wenn die erste horizontale Modulation um +/- π/2 der Periode der ersten horizontalen Elektron1-Elektron1-Mikrowellenresonanzfrequenz (f_{MWH1}) gegenüber der ersten vertikalen Modulation phasenverschoben ist.

Besonders bevorzugt ist aus dem gleichen Grund der Fall, dass die erste vertikale Elektron1-Elektron1-Mikrowellenresonanzfrequenz (f_{MWV1}) gleich der ersten horizontalen Elektron1-Elektron1-Mikrowellenresonanzfrequenz (f_{MWH1}) ist.

Ebenso ist es besonders vorteilhaft, wenn die erste vertikale Stromkomponente mit einem ersten vertikalen Strompuls mit einer ersten Pulsdauer gepulst ist und die erste horizontale Stromkomponente ebenfalls mit einem ersten horizontalen Strompuls mit der ersten Pulsdauer gepulst ist.

Wie zuvor bereits erwähnt, ist es dann sinnvoll, wenn der erste vertikale Strompuls gegenüber dem ersten horizontalen Strompuls um +/- π/2 der Periode der ersten horizontalen Elektron1-Elektron1-Mikrowellenresonanzfrequenz (f_{MWH1}) phasenverschoben ist.

Besonders günstig ist es wieder, wenn die erste zeitliche Pulsdauer eine erste Pulsdauer entsprechend einer Phasendifferenz von π/4 oder π/2 (Hadamard-Gate) oder 3π/4 oder π (NOT-Gate) der Rabi-Oszillation des ersten Quantenpunkts (NV1) hat und/oder wenn die erste zeitliche Pulsdauer eine erste Pulsdauer entsprechend einer Phasendifferenz eines ganzzahligen Vielfachen von π/4 der Rabi-Oszillation des ersten Quantenpunkts (NV1) hat.

### Ansteuerverfahren zur unterschiedlichen gleichzeitigen Ansteuerung eines ersten einzelnen Quantenbits und eines zweiten einzelnen Quantenbits eines Quantenregisters

In diesem Abschnitt wird nun diskutiert, wie die in den vorhergehenden Abschnitten beschriebene Ansteuerung eines einzelnen Quantenbits (QUBj) eines n-Bit-Quantenregisters (NBQUREG) mit n Quantenbits (QUB1 bis QUBn) parallelisiert werden kann, so dass zwei voneinander verschiedene Quantenbits des n-Bit-Quantenregisters (NBQUREG) unterschiedlich angesprochen werden können, ohne die anderen n-2 Quantenbits des n-Bit-Quantenregisters (NBQUREG) wesentlich zu modifizieren. Hierbei wird hier zunächst noch eine gegenseitige Beeinflussung in Kauf genommen werden müssen. Im Vordergrund dieses Abschnitts steht somit zunächst nur die Ansteuerung eines zweiten Quantenbits. Hierbei setzt das Verfahren auf das unmittelbar zuvor beschriebene Verfahren auf. Beispielhaft wird hier angenommen, dass das erste Quantenbit (QUB1) und das zweite Quantenbit (QUB2) eines n-Bit-Quantenregisters (NBQUREG) angesteuert werden sollen und die weiteren Quantenbits (QUB3 bis QUBn) des n-Bit-Quantenregisters (NBQUREG) unbeeinflusst bleiben sollen. Statt dieser Quantenbits (QUB1, QUB2) können auch andere Quantenbitpaarungen und/oder mehr als zwei Quantenbits manipuliert werden. Insofern ist die hier behandelte Kombination aus erstem Quantenbit (QUB1) und zweiten Quantenbit (QUB2) nur beispielhaft. Das im Folgende beschriebene gilt dann entsprechend. Hier wird somit ein Verfahren zur unterschiedlichen Ansteuerung eines ersten Quantenbits (QUB1) und eines zweiten Quantenbits (QUB2) eines n-Bit-Quantenregisters (NBQUREG), wie es zuvor beschrieben wurde, mit n als ganzer positiver Zahl beschrieben. Neben den im vorhergehenden Abschnitt beschriebenen Bestromungen zur Ansteuerung des ersten Quantenbits (QUB1) werden nun zusätzliche Leitungen bestromt. Das Verfahren umfasst daher den Schritt des zusätzlichen Bestromens der zweiten horizontalen Leitung (LH2) mit einer zweiten horizontalen Stromkomponente des zweiten horizontalen Stromes (IH2), der mit einer zweiten horizontalen Elektron1-Elektron1-Mikrowellenresonanzfrequenz (f_{MWH2}) mit einer zweiten horizontalen Modulation moduliert ist, und des zusätzlichen Bestromens der zweiten vertikalen Leitung (LV2) mit einer zweiten vertikalen Stromkomponente des zweiten vertikalen Stromes (IV2), der mit einer zweiten vertikalen Elektron1-Elektron1-Mikrowellenresonanzfrequenz (f_{MWV2}) mit einer zweiten vertikalen Modulation moduliert ist.

Um eine links oder rechts polarisierte elektromagnetische Welle am Ort des zweiten Quantenpunkts (NV2) des zweiten Quantenbits (QUB2) zur erzeugen, ist es wieder sinnvoll, dass bevorzugt die zweite horizontale Modulation um +/- π/2 der Periode der zweiten horizontalen Elektron1-Elektron1-Mikrowellenresonanzfrequenz (f_{MWH2}) gegenüber der zweiten vertikalen Modulation phasenverschoben ist.

Ebenso ist bevorzugt die zweite vertikale Elektron1-Elektron1-Mikrowellenresonanzfrequenz (f_{MWV2}) gleich der zweiten horizontalen Elektron1-Elektron1-Mikrowellenresonanzfrequenz (f_{MWH2}), um diese Phasenbeziehung sicherzustellen.

Es wird daher vorgeschlagen, dass bevorzugt die zweite vertikale Stromkomponente mit einem zweiten vertikalen Strompuls mit einer zweiten Pulsdauer gepulst ist und die erste horizontale Stromkomponente mit einem zweiten horizontalen Strompuls mit der zweiten Pulsdauer gepulst sind.

Bevorzugt ist der zweite vertikale Strompuls gegenüber dem zweiten horizontalen Strompuls um +/π/2 der Periode der zweiten vertikalen Elektron1-Elektron1-Mikrowellenresonanzfrequenz (f_{MWV2}) phasenverschoben, was zu der besagten zirkularen Polarisation des elektromagnetischen Feldes am Ort des zweiten Quantenpunkts (NV2) des zweiten Quantenbits (QUB2) führt.

Um nun Quantenoperationen durchführen zu können, ist es notwendig, die zweite Pulsdauer geeignet zu wählen. Es ist daher bevorzugt, dass die zweite zeitliche Pulsdauer eine zweite Pulsdauer entsprechend einer Phasendifferenz von π/4 oder π/2 (Hadamar-Gate) oder 3π/4 oder π (Not-Gate) der Rabi-Oszillation des zweiten Quantenpunkts (NV2) besitzt und/oder dass die zweite zeitliche Pulsdauer eine zweite Pulsdauer entsprechend einer Phasendifferenz eines ganzzahligen Vielfachen von π/4 der Rabi-Oszillation des zweiten Quantenpunkts (NV2) hat.

Eine Pulsdauer von π/2 entspricht dabei einem Hadamar-Gate, das auch Hadamar-Operation genannt wird. Es rotiert die Quanteninformation des zweiten Quantenpunkts (NV2) des zweiten Quantenbits (QUB2) um 90°.

### Selektives Ansteuerverfahren zur synchronen Ansteuerung eines ersten einzelnen Quantenbits eines Quantenregisters und eines zweiten einzelnen Quantenbits dieses Quantenregisters ohne wesentliche Beeinträchtigung der anderen Quantenbits des betreffenden Quantenregisters

In diesem Abschnitt wird nun diskutiert, wie die im vorhergehenden Abschnitt beschriebene Ansteuerung eines einzelnen Quantenbits (QUBj) eines n-Bit-Quantenregisters (NBQUREG) mit n Quantenbits (QUB1 bis QUBn) parallelisiert werden kann, ohne dass es zu einer wesentlichen Beeinflussung der nicht angesprochenen n-1 Quantenbits kommt. Hierbei setzt das Verfahren auf das unmittelbar zuvor beschriebene Verfahren auf. Beispielhaft wird hier angenommen, dass das erste Quantenbit (QUB1) und das zweite Quantenbit (QUB2) eines n-Bit-Quantenregisters (NBQUREG) angesteuert werden sollen. Statt dieser Quantenbits können auch andere Quantenbitpaarungen und/oder mehr als zwei Quantenbits manipuliert werden. Das im Folgende beschriebene gilt dann entsprechend.

Das hier beschriebene Verfahren zur nun synchronen Ansteuerung eines beispielhaft ersten Quantenbits (QUB1) und eines beispielhaften zweiten Quantenbits (QUB2) eines n-Bit-Quantenregisters (NBQUREG) basiert auf einem Verfahren, wie es zuvor beschrieben wurde. Es wird nun angenommen, dass die vertikalen Leitungen gleich bestromt werden und die horizontalen Leitungen unabhängig sind. Das Verfahren umfasst dann den zusätzlichen Schritt des zusätzlichen Bestromens der zweiten horizontalen Leitung (LH2) des zweiten Quantenbits (QUB2) mit einer zweiten horizontalen Stromkomponente des zweiten horizontalen Stromes (IH2), der mit der zweiten horizontalen Elektron1-Elektron1-Mikrowellenresonanzfrequenz (f_{MWH2}) mit der zweiten horizontalen Modulation moduliert ist und das zusätzliche Bestromen der ersten vertikalen Leitung (LV1) mit einer zweiten vertikalen Stromkomponente des ersten vertikalen Stromes (IV1), der mit einer zweiten vertikalen Elektron1-Elektron1-Mikrowellenresonanzfrequenz (f_{MWV2}) mit einer zweiten vertikalen Modulation moduliert Bevorzugt ist die zweite horizontale Modulation um +/- π/2 der Periode der zweiten horizontalen Elektron1-Elektron1-Mikrowellenresonanzfrequenz (f_{MWH2}) gegenüber der zweiten vertikalen Modulation phasenverschoben. Ebenso bevorzugt ist die zweite vertikale Elektron1-Elektron1-Mikrowellenresonanzfrequenz (f_{MWV2}) gleich der zweiten horizontalen Elektron1-Elektron1-Mikrowellenresonanzfrequenz (f_{MWH2}). Die zweite vertikale Stromkomponente ist bevorzugt mit einem zweiten vertikalen Strompuls mit einer zweiten Pulsdauer gepulst. Die erste horizontale Stromkomponente ist bevorzugt mit einem zweiten horizontalen Strompuls mit der zweiten Pulsdauer gepulst.

Bevorzugt ist der zweite vertikale Strompuls gegenüber dem zweiten horizontalen Strompuls um +/π/2 der Periode der zweiten vertikalen Elektron1-Elektron1-Mikrowellenresonanzfrequenz (f_{MWV2}) phasenverschoben. Die zweite zeitliche Pulsdauer besitzt bevorzugt eine zweite Pulsdauer entsprechend einer Phasendifferenz von π/4 oder π/2 (Hadamar-Gate) oder 3π/4 oder π (Not-Gate) der Rabi-Oszillation des zweiten Quantenpunkts (NV2) und/oder eine zweite Pulsdauer entsprechend einer Phasendifferenz eines ganzzahligen Vielfachen von π/4 der Rabi-Oszillation des zweiten Quantenpunkts (NV2).

### Selektives Ansteuerverfahren zur synchronen Ansteuerung eines zweiten einzelnen Quantenbits eines Quantenregisters und eines ersten einzelnen Quantenbits dieses Quantenregisters ohne wesentliche Beeinträchtigung der anderen Quantenbits des betreffenden Quantenregisters

Das nun beschriebene Verfahren entspricht dem unmittelbar zuvor beschriebenen Verfahren mit dem Unterschied, dass das erste Quantenbit (QUB1) und das zweite Quantenbit (QUB2) die Rolle tauschen.

Es handelt sich somit um ein Verfahren zur unterschiedlichen Ansteuerung eines ersten Quantenbits (QUB1) und eines zweiten Quantenbits (QUB2) eines n-Bit-Quantenregisters (NBQUREG), wie es zuvor beschrieben wurde. Das Verfahren umfasst den Schritt des Bestromens der ersten horizontalen Leitung (LH1) mit einer zweiten horizontalen Stromkomponente des ersten horizontalen Stromes (IH1), der mit einer zweiten horizontalen Elektron1-Elektron1-Mikrowellenresonanzfrequenz (f_{MWH2}) mit einer zweiten horizontalen Modulation moduliert ist, und des zusätzlichen Bestromens der zweiten vertikalen Leitung (LV2) mit einer zweiten vertikalen Stromkomponente des zweiten vertikalen Stromes (IV2), der mit einer zweiten vertikalen Elektron1-Elektron1-Mikrowellenresonanzfrequenz (f_{MWV2}) mit einer zweiten vertikalen Modulation moduliert ist.

Wie zuvor ist bevorzugt die zweite horizontale Modulation um +/- 90° der Periode der zweiten vertikalen Elektron1-Elektron1-Mikrowellenresonanzfrequenz (f_{MWV2}) und/oder der zweiten horizontalen Elektron1-Elektron1-Mikrowellenresonanzfrequenz (f_{MWH2}) gegenüber der zweiten vertikalen Modulation phasenverschoben.

Bevorzugt ist die zweite vertikale Elektron1-Elektron1-Mikrowellenresonanzfrequenz (f_{MWV2}) gleich der zweiten horizontalen Elektron1-Elektron1-Mikrowellenresonanzfrequenz (f_{MWH2}). Wie zuvor sind bevorzugt die zweite vertikale Stromkomponente mit einem zweiten vertikalen Strompuls mit einer zweiten Pulsdauer gepulst und die erste horizontale Stromkomponente mit einem zweiten horizontalen Strompuls mit der zweiten Pulsdauer gepulst.

Bevorzugt ist wieder der zweite vertikale Strompuls gegenüber dem zweiten horizontalen Strompuls um +/- π/2 der Periode der zweiten vertikalen Elektron1-Elektron1-Mikrowellenresonanzfrequenz (f_{MWV2}) phasenverschoben. Bevorzugt besitzt die zweite zeitliche Pulsdauer eine zweite Pulsdauer entsprechend einer Phasendifferenz von π/4 oder π/2 (Hadamar-Gate) oder 3π/4 oder π (Not-Gate) der Rabi-Oszillation des zweiten Quantenpunkts (NV2) und/oder eine zweite Pulsdauer entsprechend einer Phasendifferenz eines ganzzahligen Vielfachen von π/4 der Rabi-Oszillation des zweiten Quantenpunkts (NV2).

### Austauschoperation zwischen einem ersten Quantenpunkt eines ersten Quantenbits eines Quantenregisters und einem zweiten Quantenpunkt eines zweiten Quantenbits eines Quantenregisters.

### Nicht selektives NV1 NV2 Quantenbit-Kopplungsverfahren

Im Folgenden dieses Abschnitts wird ein Verfahren zur Ansteuerung des Paares aus einem ersten Quantenbit (QUB1) und einem zweiten Quantenbit (QUB2) eines Zwei-Bit-Quantenregisters (QUREG) dieses n-Bit-Quantenregisters (NBQUREG), wie es zuvor beschrieben wurde, dargestellt. Das vorgeschlagene Verfahren umfasst bevorzugt ein zumindest zeitweises Bestromen der ersten horizontalen Leitung (LH1) des Quantenregisters (QUREG) mit einer ersten horizontalen Stromkomponente des ersten horizontalen Stromes (IH1), die mit einer ersten horizontalen Elektron1-Elektron2-Mikrowellenresonanzfrequenz (f_{MWHEE1}) mit einer ersten horizontalen Modulation moduliert ist. Hier wird zur Vereinfachung der Beschreibung wieder beispielhaft angenommen, dass die beispielhaften n Quantenbits (QUB1 bis QUBn) mit ihren n Quantenpunkten (NV1 bis NVn) wieder beispielhaft längs der ersten horizontalen Leitung (LH1) angeordnet sind und dass jedes der n Quantenbits (QUB1 bis QUBn) über eine der n vertikalen Leitungen (LV1 bis LVn) verfügt. Diese beispielhafte Anordnung dient hier nur der Verdeutlichung. Andere Anordnungen und Verschaltungen der horizontalen Leitungen und vertikalen Leitungen sind ausdrücklich möglich und von der Beanspruchung ausdrücklich umfasst. Des Weiteren umfasst das Verfahren bevorzugt das zumindest zeitweise Bestromen der ersten vertikalen Leitung (LV1) des Quantenregisters (QUREG) mit einer ersten vertikalen Stromstromkomponente des ersten vertikalen Stromes (IV1), die mit einer ersten vertikalen Elektron1-Elektron2-Mikrowellenresonanzfrequenz (f_{MWVEE1}) mit einer ersten vertikalen Modulation moduliert ist, und das zumindest zeitweise Bestromen der zweiten horizontalen Leitung (LH2) des Quantenregisters (QUREG) mit einer zweiten horizontalen Stromkomponente des zweiten horizontalen Stromes (IH2), die mit der ersten horizontalen Elektron1-Elektron2-Mikrowellenresonanzfrequenz (f_{MWHEE1}) mit der zweiten horizontalen Modulation moduliert ist. Außerdem umfasst das beispielhafte Verfahren das zumindest zeitweise Bestromen der zweiten vertikalen Leitung (LV2) des Quantenregisters (QUREG) mit einer zweiten vertikalen Stromstromkomponente des zweiten vertikalen Stromes (IV2), die mit der ersten vertikalen Elektron1-Elektron2-Mikrowellenresonanzfrequenz (f_{MWVEE1}) mit der zweiten vertikalen Modulation moduliert ist. Bevorzugt ist, wie bereits erwähnt, beispielsweise die zweite horizontale Leitung (LH2) gleich der ersten horizontalen Leitung (LH1). Der zweite horizontale Strom (IH2) ist dann natürlich gleich dem ersten horizontalen Strom (IH1). Der zweite horizontale Strom (IH2) ist dann konsequenter Weise mit der Einspeisung des ersten horizontalen Stromes (IH1) bereits eingespeist.

In dem hier vorgestellten Beispiel wird beispielhaft angenommen, dass die n-2 anderen horizontalen Leitungen (LH3 bis LHn) des Quantenregisters (QUREG) mit n Quantenbits (QUB1 bis QUBn) sequenziell miteinander verbunden sind, um eine gemeinsame erste horizontale Leitung (LH1) zu bilden und zu nutzen. Wie zuvor werden hier nur das erste Quantenbit (QUB1) und das zweite Quantenbit (QUB2) stellvertretend für andere Quantenbitpaarungen betrachtet. Die Beanspruchung umfasst ausdrücklich auch andere funktionstüchtige Paarungen. Ist der Abstand zweier verschiedener Quantenbits (QUBj, QUBi mit i≠j) zu groß, also größer als die Elektron-Elektron-Kopplungsreichweite, so ist eine Kopplung dieser zwei verschiedenen Quantenbits (QUBj, QUBi mit i≠j) nicht möglich.

Natürlich kann eine Aufreihung der Quantenbits auch alternativ und/oder teilweise gleichzeitig längs der vertikalen Leitungen erfolgen. In einem solchen Fall wäre dann die zweite vertikale Leitung (LV2) gleich der ersten vertikalen Leitung (LV2). Der zweite vertikale Strom (IV2) wäre dann gleich dem ersten vertikalen Strom (IV1) und der zweite vertikale Strom (IV2) wäre dann mit der Einspeisung des ersten vertikalen Stromes (IV1) bereits eingespeist.

Besonders bevorzugt sind die erste horizontale Modulation um +/- π/2 der Periode der ersten horizontalen Elektron1-Elektron2-Mikrowellenresonanzfrequenz (f_{MWHEE1}) gegenüber der ersten vertikalen Modulation phasenverschoben und/oder die zweite horizontale Modulation um +/- π/2 der Periode der zweiten horizontalen Elektron1-Elektron2-Mikrowellenresonanzfrequenz (f_{MWHEE2}) gegenüber der zweiten vertikalen Modulation phasenverschoben.

Bevorzugt erfolgt zumindest zeitweise ein zusätzliches Bestromen der ersten horizontalen Leitung (LH1) mit einer ersten horizontalen Gleichstromkomponente (IHG1) des ersten horizontalen Stromes (IH1), wobei die erste horizontale Gleichstromkomponente (IHG1) einen ersten horizontalen Stromwert besitzt. Die erste horizontale Gleichstromkomponente (IHG1) kann dabei einen ersten horizontalen Stromwert von 0A aufweisen. Ein solcher Gleichstromoffset kann zur Änderung der zweiten horizontalen Elektron1-Elektron2-Mikrowellenresonanzfrequenz (f_{MWHEE2}) und der ersten Elektron1-Elektron1-Mikrowellenresonanzfrequenz (f_{MWH1}) und zur Verstimmung dieser Resonanzfrequenzen gegenüber den anderen Resonanzfrequenzen der vorgeschlagenen Vorrichtung genutzt werden. Diese zusätzlichen Gleichstromkomponenten in den horizontalen und vertikalen Leitungen stellen somit das entscheidende Mittel zur Adressierung der einzelnen Quantenbits und/oder Quantenteilregister innerhalb eines größeren Quantenregisters und zur Unterdrückung einer Beeinflussung der anderen Quantenbits und/oder Quantenteilregister des größeren Quantenregisters dar. Unter einem Quantenteilregister wird hier eine Teilmenge der Quantenbits eines größeren Quantenregisters verstanden, die untereinander zumindest wieder ein Quantenregister bilden. So verfügt ein Quantenregister mit drei Quantenbits, wenn alle diese drei Quantenbits miteinander gekoppelt werden können über zumindest drei Quantenteilregister.

Das vorgeschlagene Verfahren umfasst des Weiteren bevorzugt das zumindest zeitweise zusätzliche Bestromen der ersten vertikalen Leitung (LV1) mit einer ersten vertikalen Gleichstromkomponente (IVG1) des ersten vertikalen Stromes (IV1). Die erste vertikale Gleichstromkomponente (IVG1) besitzt in Analogie zum vorherbeschriebenen einen ersten vertikalen Stromwert. Die erste vertikale Gleichstromkomponente (IVG1) kann dabei einen ersten vertikalen Stromwert von 0A aufweisen.

Das vorgeschlagene Verfahren umfasst des Weiteren bevorzugt das zumindest zeitweise zusätzliche Bestromen der zweiten horizontalen Leitung (LH2) mit einer zweiten horizontalen Gleichstromkomponente (IHG2) des zweiten horizontalen Stromes (IH2), wobei die zweite horizontale Gleichstromkomponente (IHG2) einen zweiten horizontalen Stromwert besitzt und wobei die zweite horizontale Gleichstromkomponente (IHG2) einen zweiten horizontalen Stromwert von 0A aufweisen kann.

Das vorgeschlagene Verfahren umfasst des Weiteren bevorzugt das zumindest zeitweise zusätzliche Bestromen der zweiten vertikalen Leitung (LV2) mit einer zweiten vertikalen Gleichstromkomponente (IVG2) des zweiten vertikalen Stromes (IV2), wobei die zweite vertikale Gleichstromkomponente (IVG2) einen zweiten vertikalen Stromwert besitzt und wobei die zweite vertikale Gleichstromkomponente (IVG2) einen ersten vertikalen Stromwert von 0A aufweisen kann.

Bevorzugt sind dabei der erste horizontale Stromwert gleich dem zweiten horizontalen Stromwert und/oder der erste vertikale Stromwert gleich dem zweiten vertikalen Stromwert.

Bevorzugt ist die erste vertikale Elektron1-Elektron1-Mikrowellenresonanzfrequenz (f_{MWV1}) gleich der ersten horizontalen Elektron1-Elektron2-Mikrowellenresonanzfrequenz (f_{MWHEE1}).

Bevorzugt sind die erste vertikale Stromkomponente mit einem ersten vertikalen Strompuls mit einer ersten Pulsdauer gepulst ist und/oder die erste horizontale Stromkomponente mit einem ersten horizontalen Strompuls mit der ersten Pulsdauer gepulst.

Typischerweise sind die zweite vertikale Stromkomponente mit einem zweiten vertikalen Strompuls mit einer zweiten Pulsdauer gepulst und/oder die zweite horizontale Stromkomponente mit einem zweiten horizontalen Strompuls mit der zweiten Pulsdauer gepulst.

Typischerweise sind in analoger Weise die erste vertikale Stromkomponente mit einem ersten vertikalen Strompuls mit einer ersten Pulsdauer gepulst und die erste horizontale Stromkomponente mit einem ersten horizontalen Strompuls mit der ersten Pulsdauer gepulst.

Bevorzugt sind die zweite vertikale Stromkomponente mit einem zweiten vertikalen Strompuls mit einer zweiten Pulsdauer gepulst und/oder die zweite horizontale Stromkomponente mit einem zweiten horizontalen Strompuls mit der zweiten Pulsdauer gepulst.

Bevorzugt sind der erste vertikale Strompuls gegenüber dem ersten horizontalen Strompuls um +/π/2 der Periode der ersten Elektron1-Elektron2-Mikrowellenresonanzfrequenz (f_{MWHEE1}) phasenverschoben und/oder der zweite vertikale Strompuls gegenüber dem zweiten horizontalen Strompuls um +/- π/2 der Periode der zweiten Elektron1-Elektron2-Mikrowellenresonanzfrequenz (f_{MWHEE2}) phasenverschoben.

Bevorzugt besitzt die erste zeitliche Pulsdauer eine erste Pulsdauer entsprechend einer Phasendifferenz von π/4 oder π/2 (Hadamard-Gate) oder 3π/4 oder π (Not-Gate) der Rabi-Oszillation des Quantenpunktpaares aus dem ersten Quantenpunkt (NV1) und dem zweiten Quantenpunkt (NV2) und/oder eine erste Pulsdauer entsprechend einer Phasendifferenz eines ganzzahligen Vielfachen von π/4 der Rabi-Oszillation des Quantenpunktpaares aus dem ersten Quantenpunkt (NV1) und dem zweiten Quantenpunkt (NV2).

Bevorzugt besitzt die zweite zeitliche Pulsdauer eine zweite Pulsdauer entsprechend einer Phasendifferenz von π/4 oder π/2 (Hadamard-Gate) oder 3π/4 oder π (not-Gate)der Rabi-Oszillation des Quantenpunktpaares aus dem ersten Quantenpunkt (NV1) und dem zweiten Quantenpunkt (NV2) und/oder die zweite zeitliche Pulsdauer eine zweite Pulsdauer entsprechend einer Phasendifferenz eines ganzzahligen Vielfachen von π/4 der Rabi-Oszillation des Quantenpunktpaares aus dem ersten Quantenpunkt (NV1) und dem zweiten Quantenpunkt (NV2).

Bevorzugt ist die erste zeitliche Pulsdauer gleich der zweiten zeitlichen Pulsdauer.

### Selektives Quantenbit-Kopplungsverfahren für einen ersten Quantenpunkt und einen zweiten Quantenpunkt

Es wird nun eine Modifikation des Verfahrens zur Ansteuerung des Paares aus einem ersten Quantenbit (QUB1) und einem zweiten Quantenbit (QUB2) eines n-Bit-Quantenregisters (NBQUREG) beschrieben. Dabei ist die Ansteuerung selektiv gegenüber weiteren Quantenbits (QUBj) dieses n-Bit-Quantenregisters (NBQUREG). Das Verfahren umfasst die zusätzlichen Schritte des zumindest zeitweise zusätzlichen Bestromens der ersten horizontalen Leitung (LH1) mit einer ersten horizontalen Gleichstromkomponente (IHG1) des ersten horizontalen Stromes (IH1), wobei die erste horizontale Gleichstromkomponente (IHG1) einen ersten horizontalen Stromwert besitzt und wobei die erste horizontale Gleichstromkomponente (IHG1) einen ersten horizontalen Stromwert von 0A aufweisen kann, und des zumindest zeitweisen zusätzlichen Bestromens der ersten vertikalen Leitung (LV1) mit einer ersten vertikalen Gleichstromkomponente (IVG1) des ersten vertikalen Stromes (IV1), wobei die erste vertikale Gleichstromkomponente (IVG1) einen ersten vertikalen Stromwert besitzt und wobei die erste vertikale Gleichstromkomponente (IVG1) einen ersten vertikalen Stromwert von 0A aufweisen kann. Des Weiteren umfasst die vorgeschlagene Verfahrensmodifikation das zumindest zeitweise zusätzliche Bestromen der zweiten horizontalen Leitung (LH2) mit einer zweiten horizontalen Gleichstromkomponente (IHG2) des zweiten horizontalen Stromes (IH2), wobei die zweite horizontale Gleichstromkomponente (IHG2) einen zweiten horizontalen Stromwert besitzt und wobei die zweite horizontale Gleichstromkomponente (IHG2) einen zweiten horizontalen Stromwert von 0A aufweisen kann. Außerdem umfasst die Verfahrenserweiterung bevorzugt das zumindest zeitweise zusätzliche Bestromen der zweiten vertikalen Leitung (LV2) mit einer zweiten vertikalen Gleichstromkomponente (IVG2) des zweiten vertikalen Stromes (IV2), wobei die zweite vertikale Gleichstromkomponente (IVG2) einen zweiten vertikalen Stromwert besitzt und wobei die zweite vertikale Gleichstromkomponente (IVG2) einen ersten vertikalen Stromwert von 0A aufweisen kann. Ebenso umfasst die vorgeschlagene Verfahrenserweiterung ein zumindest zeitweises zusätzliches Bestromen der j-ten horizontalen Leitung (LHj) eines ggf. vorhandenen weiteren j-ten Quantenbits (QUBj) des n-Bit-Quantenregisters (NBQUREG) mit einer j-ten horizontalen Gleichstromkomponente (IHGj), wobei die j-te horizontale Gleichstromkomponente (IHGj) einen j-ten horizontalen Stromwert besitzt. Schließlich umfasst die vorgeschlagene Verfahrensvariante bevorzugt ein zumindest zeitweises zusätzliches Bestromen der j-ten vertikalen Leitung (LVj) eines ggf. vorhandenen weiteren j-ten Quantenbits (QUBj) des n-Bit-Quantenregisters (NBQUREG) mit einer j-ten vertikalen Gleichstromkomponente (IVGj), wobei die j-te vertikale Gleichstromkomponente (IHGj) einen j-ten vertikalen Stromwert besitzt.

Bevorzugt sind dabei der erste vertikale Stromwert von dem j-ten vertikalen Stromwert verschieden und/oder der zweite vertikale Stromwert von dem j-ten vertikalen Stromwert verschieden und/oder der erste horizontale Stromwert von dem j-ten horizontalen Stromwert verschieden und/oder der zweite horizontale Stromwert von dem j-ten horizontalen Stromwert verschieden. Hierdurch werden die Resonanzfrequenzen gegeneinander verstimmt, was eine gezielte Adressierung eines Quantenpunkts und/oder eines Quantenteilregisters des Quantenregisters ermöglicht.

### Verfahren zur allgemeinen Verschränkung zweier Quantenpunkte

Hier wird nun ein Verfahren zur Verschränkung der Quanteninformation eines ersten Quantenpunkts (NV1), insbesondere des Spins seiner ersten Elektronenkonfiguration, eines ersten Quantenbits (QUB1) eines n-Bit-Quantenregisters (NBQUREG) bzw. eines inhomogenen n-Bit-Quantenregisters (NBIQUREG) mit der Quanteninformation eines zweiten Quantenpunkts (NV2), insbesondere des zweiten Spins der zweiten Elektronenkonfiguration des zweiten Quantenpunkts (NV2), eines zweiten Quantenbits (QUB2) dieses n-Bit-Quantenregisters (QUREG) bzw. dieses inhomogenen n-Bit-Quantenregisters (NBIQUREG), im Folgenden als Elektron-Elektron-ENTENGLEMENT-Operation bezeichnet, beschrieben.

In diesem Beispiel werden willkürlich der erste Quantenpunkt (NV1) eines ersten Quantenbits (QUB1) des n-Bit-Quantenregisters (NBQUREG) und der zweite Quantenpunkt (NV1) eines zweiten Quantenbits (QUB2) des n-Bit-Quantenregisters (NBQUREG) zur Verdeutlichung gewählt. Die Beanspruchung bezieht sich aber auf alle koppelbaren Paare oder n-Tupeln aus zwei oder mehreren Quantenpunkten von zwei oder mehreren Quantenbits des n-Bit-Quantenregisters (NBQUREG).

Das Verfahren zur Verschränkung der Quanteninformation eines ersten Quantenpunkts (NV1) mit der der Quanteninformation eines zweiten Quantenpunkts (NV2) umfasst typischerweise ein Verfahren zum Zurücksetzen des Elektron-Elektron-Quantenregisters (NBQUREG) bzw. des inhomogenen Quantenregisters (IQUREG), um das erste Quantenbit und das zweite Quantenbit in einen definierten Zustand zu bringen. Nach dieser Initialisierung wird typischer Weise ein Hadamard-Gate als Schritt für das Quantenteilregister aus dem ersten Quantenbit und dem zweiten Quantenbit ausgeführt. Anschließend wird bevorzugt ein CNOT-Gate für dieses Quantenteilregister ausgeführt. Stattdessen kann theoretisch auch ein anderes Verfahren zur Verschränkung der Quanteninformation des ersten Quantenpunkts (NV1), insbesondere des ersten Spins der ersten Elektronenkonfiguration des ersten Quantenpunkts (NV1), des ersten Quantenbits (QUB1) des Quantenregisters (QUREG) bzw. des inhomogenen Quantenregisters (IQUREG) mit der Quanteninformation eines zweiten Quantenpunkts (NV2), insbesondere des zweiten Spins der zweiten Elektronenkonfiguration dieses zweiten Quantenpunkts (NV2), eines zweiten Quantenbits (QUB2) dieses Elektron-Elektron-Quantenregisters (QUREG) bzw. dieses inhomogenen Quantenregisters (IQUREG) durchgeführt werden. Beispielsweise ist es denkbar, hierzu andere Quantenpunkte, beispielsweise in einem Quantenbus (QUBUS) zu nutzen.

### Elektron-Kern-Austausch-Operation

### Kern-Elektron-CNOT-Operation

Im Folgenden Abschnitt beschreiben wir eine *Kern-Elektron-CNOT-Operation* zur Änderung der der Quanteninformation eines Quantenpunkts (NV), insbesondere dessen Elektrons bzw. dessen Elektronenkonfiguration, eines Quantenbits (QUB) eines Kern-Elektron-Quantenregisters (CEQUREG) in Abhängigkeit von der Quanteninformation eines Kernquantenpunkts (CI), insbesondere des Kernspins dessen Atomkerns, eines Kernquantenbits (CQUB) dieses Kern-Elektron-Quantenregisters (CEQUREG), im Folgenden Kern- Elektron-CNOT-Operation genannt. Wie bei den zuvor beschriebenen selektiven Ansteuerverfahren zur Ansteuerung eines einzelnen Quantenbits eines Quantenregisters ohne wesentliche Beeinträchtigung der anderen Quantenbits des betreffenden Quantenregisters werden wieder die horizontale und die vertikale Leitung zur Ansteuerung genutzt. Die *Kern-Elektron-CNOT-Operation* umfasst daher den Schritt des Einspeisens einer horizontalen Stromkomponente des horizontalen Stromes (IH) in die horizontale Leitung (LH) des Quantenbits (QUB), wobei die horizontale Stromkomponente eine horizontale Modulation mit der Kern-Elektron-Mikrowellenresonanzfrequenz (f_{MWCE}) aufweist, und das Einspeisen einer vertikalen Stromkomponente des vertikalen Stromes (IV) in die vertikale Leitung (LV) des Quantenbits (QUB), wobei die vertikale Stromkomponente eine vertikale Modulation mit der Kern-Elektron-Mikrowellenresonanzfrequenz (f_{MWCE}) aufweist.

Bevorzugt ist wieder zur Erzeugung eines bevorzugten links- oder rechts polarisierten elektromagnetischen Feldes die vertikale Modulation gegenüber der horizontalen Modulation um +/π/2 der Periode der Kern-Elektron- Mikrowellenresonanzfrequenz (f_{MWCE}) verschoben.

Bevorzugt sind die erste vertikale Stromkomponente mit einem ersten vertikalen Strompuls mit einer ersten Pulsdauer gepulst und/oder die erste horizontale Stromkomponente mit einem ersten horizontalen Strompuls mit der ersten Pulsdauer gepulst.

Bevorzugt ist wieder zur Erzeugung eines bevorzugten links- oder rechts polarisierten elektromagnetischen Feldes der erste vertikale Strompuls gegenüber dem horizontalen Strompuls um +/- π/2 der Periode der Mikrowellenresonanzfrequenz (f_{MWCE}) phasenverschoben.

Bevorzugt besitzt die erste zeitliche Pulsdauer eine erste Pulsdauer entsprechend einer Phasendifferenz von π/4 oder π/2 (Hadamard-Gate) π oder 3π/4 oder π (Not-Gate) der Rabi-Oszillation des Quantenpaares aus dem Quantenpunkt (NV1) Kern-Elektron-Quantenregisters (CEQUREG) und dem Kernquantenpunkt (CQUB) des Kern-Elektron-Quantenregisters (CEQUREG) und/oder eine erste Pulsdauer entsprechend einer Phasendifferenz eines ganzzahligen Vielfachen von π/4 der Rabi-Oszillation des Quantenpaares aus dem Quantenpunkt (NV1) Kern-Elektron-Quantenregisters (CEQUREG) und dem Kernquantenpunkt (CQUB) des Kern-Elektron-Quantenregisters (CEQUREG).

### Elektron-Kern-CNOT-Operation

Im Folgenden wird eine *Elektron-Kern-CNOT-Operation* zur Änderung der Quanteninformation eines Kernquantenpunkts (CI), insbesondere des Kernspins des Atomkerns, eines Kernquantenbits (CQUB) eines Kern-Elektron-Quantenregisters (CEQUREG) in Abhängigkeit von der Quanteninformation eines Quantenpunkts (NV), insbesondere dessen Elektrons bzw. dessen Elektronenkonfiguration, eines Quantenbits (QUB) dieses Kern-Elektron-Quantenregisters (CEQUREG), im Folgenden Elektron-Kern-CNOT-Operation genannt, beschrieben. Die *Elektron-Kern-CNOT-Operation* umfasst den Schritt des Einspeisens einer horizontalen Stromkomponente des horizontalen Stromes (IH) in die horizontale Leitung (LH) des Quantenbits (QUB), wobei die horizontale Stromkomponente eine horizontale Modulation mit der Elektron-Kern-Radiowellenresonanzfrequenz (F_{RWEC}) aufweist, und des Einspeisens einer Stromkomponente des vertikalen Stromes (IV) in die vertikale Leitung (LV) des Quantenbits (QUB), wobei die vertikale Stromkomponente eine vertikale Modulation mit der Elektron-Kern-Radiowellenresonanzfrequenz (f_{RWEC}) aufweist.

Zur Erzeugung eines links oder rechts zirkular polarisierten elektromagnetischen Feldes ist die vertikale Modulation bevorzugt gegenüber der horizontalen Modulation um +/- π/2 bezogen auf die Periodendauer der Elektron-Kern-Radiowellenresonanzfrequenz (F_{RWEC}) verschoben.

Bevorzugt sind die vertikale Stromkomponente mit einem vertikalen Strompuls mit einer Pulsdauer gepulst und die horizontale Stromkomponente mit einem horizontalen Strompuls mit der Pulsdauer gepulst.

Zur Erzeugung eines links oder rechts zirkular polarisierten elektromagnetischen Feldes ist der vertikale Strompuls bevorzugt gegenüber dem horizontalen Strompuls um +/- π/2 der Periode der Elektron-Kern-Radiowellenresonanzfrequenz (F_{RWEC}) phasenverschoben.

Bevorzugt besitzt die erste zeitliche Pulsdauer eine erste Pulsdauer entsprechend einer Phasendifferenz von π/4 oder π/2 (Hadamard) oder 3π/4 oder π (Not-gate) der Rabi-Oszillation des Quantenpaares aus dem Quantenpunkt (NV1) Kern-Elektron-Quantenregisters (CEQUREG) und dem Kernquantenpunkt (CQUB) des Kern-Elektron-Quantenregisters (CEQUREG) und/oder eine erste Pulsdauer entsprechend einer Phasendifferenz eines ganzzahligen Vielfachen von π/4 der Rabi-Oszillation des Quantenpaares aus dem Quantenpunkt (NV1) Kern-Elektron-Quantenregisters (CEQUREG) und dem Kernquantenpunkt (CQUB) des Kern-Elektron-Quantenregisters (CEQUREG).

### Elektron-Kern-Austausch-Operation

Im Folgenden wird ein Verfahren zur Verschränkung der Quanteninformation eines Kernquantenpunkts (CI), insbesondere des Kernspins dessen Atomkerns, eines Kernquantenbits (CQUB) eines Kern-Elektron-Quantenregisters (CEQUREG) nach einem oder mehreren der Merkmale 203 bis 215 mit der Quanteninformation eines Quantenpunkts (NV), insbesondere dessen Elektrons, eines Quantenbits (QUB) dieses Kern-Elektron-Quantenregisters (CEQUREG), im Folgenden Elektron-Kern-Austausch-Operation genannt, beschrieben. Dieses Verfahren weist dabei den Schritt des Durchführens einer *Elektron-Kern-CNOT-Operation* und den unmittelbar oder nicht unmittelbar anschließenden Schritt des Durchführens einer *Kern-Elektron-CNOT-Operation* den unmittelbar oder nicht unmittelbar anschließenden Schritt des Durchführens einer *Elektron-Kern-CNOT-Operation* auf.

### Alternatives Verfahren zum Spin-Austausch zwischen Kern und Elektron

Im Folgenden ist ein alternatives Verfahren zur Verschränkung der Quanteninformation eines Kernquantenpunkts (CI), insbesondere des Kernspins dessen Atomkerns, eines Kernquantenbits (CQUB) eines Kern-Elektron-Quantenregisters (CEQUREG) mit der Quanteninformation eines Quantenpunkts (NV), insbesondere dessen Elektrons bzw. dessen Elektronenkonfiguration, eines Quantenbits (QUB) dieses Kern-Elektron-Quantenregisters (CEQUREG), im Folgenden Elektron-Kern-Austausch-Delay-Operation genannt, beschrieben. Das Verfahren umfasst den Schritt des Änderns der Quanteninformation des Quantenpunkts (NV), insbesondere der Quanteninformation des Spins-Zustands des Elektrons bzw. der Elektronenkonfiguration des Quantenpunkts(NV) und das anschließende Abwarten einer Kernspinrelaxationszeit τ_{K}. Hierbei wird ausgenutzt, dass der Spin der Elektronenkonfiguration bzw. des Elektrons mit dem Spin des Kerns wechselwirkt. Durch Abstrahlung und Präzision kippt der Kern in Abhängigkeit vom Spin der Elektronenkonfiguration in den neuen Zustand innerhalb der besagten Kernspinrelaxationszeit τ_{K}.

### Verfahren zur allgemeinen Verschränkung eines Kerns und eines Elektrons (Kern-Elektron-Entenglement)

Ein vorgeschlagenes Verfahren zur Verschränkung der Quanteninformation eines Kernquantenpunkts (CI), insbesondere des Kernspins dessen Atomkerns, eines Kernquantenbits (CQUB) eines Kern-Elektron-Quantenregisters (CEQUREG) mit der Quanteninformation eines Quantenpunkts (NV), insbesondere dessen des Spins der Elektronenkonfiguration des Quantenpunkts (NV), eines Quantenbits (QUB) dieses Kern-Elektron-Quantenregisters (CEQUREG), im Folgenden als Kern-Elektron-ENTENGLEMENT-Operation bezeichnet, ist dadurch gekennzeichnet, dass es ein Verfahren zum Zurücksetzen eines Kern-Elektron-Quantenregister (CEQUREG) umfasst und dass es ein Verfahren zum Ausführen eines Hadamard-Gates umfasst. Des Weiteren umfasst das Verfahren ein Verfahren zum Ausführen eines CNOT-Gates. Alternativ kann das Verfahren auch ein anderes Verfahren zur Verschränkung der Quanteninformation eines Kernquantenpunkts (CI), insbesondere des Kernspins dessen Atomkerns, eines Kernquantenbits (CQUB) eines Kern-Elektron-Quantenregisters (CEQUREG), insbesondere dessen des Spins der Elektronenkonfiguration oder des Elektrons eines Quantenpunkts (NV), eines Quantenbits (QUB) dieses Kern-Elektron-Quantenregisters (CEQUREG) umfassen.

### Allgemeines Quanteninformationsaustauschverfahren zwischen Kern und Elektron

Von besonderer Wichtigkeit ist ein Verfahren zur Vertauschung der Quanteninformation eines Kernquantenpunkts (CI), insbesondere des Kernspins dessen Atomkerns, eines Kernquantenbits (CQUB) eines Kern-Elektron-Quantenregisters (CEQUREG) mit der Quanteninformation eines Quantenpunkts (NV), insbesondere dessen Elektrons bzw. dessen Elektronenkonfiguration, eines Quantenbits (QUB) dieses Kern-Elektron-Quantenregisters (CEQUREG), im Folgenden als Kern-Elektron-Austausch-Operation bezeichnet. Eine solche Kern-Elektron-Austausch-Operation im Sinne dieser Schrift ist dadurch gekennzeichnet, dass sie eine Elektron-Kern-Austausch-Delay-Operation ist oder dass sie eine Elektron-Kern-Austausch-Operation ist oder dass sie ein anderes Verfahren zur Verschränkung der Quanteninformation eines Kernquantenpunkts (CI), insbesondere des Kernspins dessen Atomkerns, eines Kernquantenbits (CQUB) eines Kern-Elektron-Quantenregisters (CEQUREG) mit der Quanteninformation eines Quantenpunkts (NV), insbesondere dessen Elektrons, eines Quantenbits (QUB) dieses Kern-Elektron-Quantenregisters (CEQUREG) ist.

### Elektron- Kern-Quantenregister-Radiowellenansteuerverfahren

Hier wird nun ein Verfahren zur Änderung der Quanteninformation eines Kernquantenpunkts (CI), insbesondere des Kernspins dessen Atomkerns, eines Kernquantenbits (CQUB) eines Kern-Elektron-Quantenregisters (CEQUREG) in Abhängigkeit von der Quanteninformation eines Quantenpunkts (NV), insbesondere dessen Elektrons bzw. dessen Elektronenkonfiguration, eines Quantenbits (QUB) dieses Kern-Elektron-Quantenregisters (CEQUREG) beschrieben. Das Verfahren umfasst bevorzugt die Schritte des Bestromens der horizontalen Leitung (LH) des Quantenbits (QUB) mit einem horizontalen Strom (IH) mit einer horizontalen Stromkomponente, die mit einer Elektron-Kern-Radiowellenresonanzfrequenz (f_{RWEC}) mit einer horizontalen Modulation moduliert ist und des Bestromens der vertikalen Leitung (LV) des Quantenbits (QUB) mit einem vertikalen Strom (IV) mit einer vertikalen Stromkomponente, die mit der Elektron-Kern-Radiowellenresonanzfrequenz (f_{RWEC}) mit einer vertikalen Modulation moduliert ist. Wie zuvor werden also wieder die horizontale Leitung und die vertikale Leitung für die Ansteuerung des Kern-Elektron-Quantenregisters (CEQUREG) benutzt. Durch die Wahl des Elektron-Kern-Radiowellenresonanzfrequenz (F_{RWEC}) wird das richtige Kern-Elektron-Quantenregisters(CEQUREG) ausgewählt, wenn die Kombination aus der jeweiligen horizontalen Leitung und der jeweiligen vertikalen Leitung mehrere Kern-Elektron-Quantenregister (CEQUREG) ansteuern kann. Da die Kern-Quantenpunkte (CI) in der Realität unterschiedliche Abstände zum Quantenpunkt (NV) aufweisen, unterscheiden sich die Kopplungsstärken zwischen Quantenpunkt (NV) und Kernquantenpunkt (CI) von Kernquantenpunkt zu Kernquantenpunkt. Somit unterscheiden sich auch die Elektron-Kern-Radiowellenresonanzfrequenzen (F_{RWEC}) von Paar zu Paar dieser Paarungen aus Quantenpunkt (NV) und Kernquantenpunkt (CI) bei mehreren Paaren aus Quantenpunkt (NV) und Kernquantenpunkt (CI), die durch die horizontale Leitung und die vertikale Leitung adressiert werden können. Dies kann also zur gezielten Ansprache einzelner Kernquantenpunkte genutzt werden.

Um wieder ein links oder rechts polarisiertes elektromagnetisches Feld zu erzeugen, ist es wieder vorteilhaft, wenn die horizontale Modulation der horizontalen Stromkomponente um +/-π/2 der Periode der Elektron-Kern-Radiowellenresonanzfrequenz (F_{RWEC}) gegenüber der vertikalen Modulation der vertikalen Stromkomponente zeitlich phasenverschoben ist.

Bevorzugt ist auch hier die vertikale Stromkomponente mit einem vertikalen Strompuls und/oder die horizontale Stromkomponente mit einem horizontalen Strompuls gepulst.

Bevorzugt ist der zweite vertikale Strompuls gegenüber dem zweiten horizontalen Strompuls um +/π/2 der Periode der Elektron-Kern-Radiowellenresonanzfrequenz (f_{RWEC}) phasenverschoben.

Bevorzugt besitzt die zeitliche Pulsdauer τ_{RCE} des horizontalen Strompulses und des vertikalen Strompulses die Pulsdauer entsprechend einer Phasendifferenz von π/4 oder π/2 (Hadamard-Gate) oder 3π/4 oder π (NOT-Gate) der Periodendauer der Rabi-Oszillation des Systems aus dem Quantenpunkt (NV) des Quantenbits (QUB) des Kern-Elektron-Quantenregisters (CEQUREG) und dem Kernquantenpunkt (CI) des Kernquantenbits (CQUB) des Kern-Elektron-Quantenregisters (CEQUREG) und/oder die zeitliche Pulsdauer τ_{RCE} des horizontalen Strompulses und des vertikalen Strompulses die Pulsdauer entsprechend einer Phasendifferenz eines ganzzahligen Vielfachen von π/4 der Periodendauer der Rabi-Oszillation des Systems aus dem Quantenpunkt (NV) des Quantenbits (QUB) des Kern-Elektron-Quantenregisters (CEQUREG) und dem Kernquantenpunkt (CI) des Kernquantenbits (CQUB) des Kern-Elektron-Quantenregisters (CEQUREG).

### Kern-Elektron-Quantenregister-Mikrowellenansteuerverfahren

Im Gegensatz zum unmittelbar zuvor beschriebenen Verfahren wird hier nun ein Verfahren für die umgekehrte Beeinflussungsrichtung beschrieben. Es handelt sich somit um ein Verfahren zur Änderung der Quanteninformation eines Quantenpunkts (NV), insbesondere dessen Elektrons bzw. dessen Elektronenkonfiguration, eines Quantenbits (QUB) eines Kern-Elektron-Quantenregisters (CEQUREG) in Abhängigkeit von der Quanteninformation eines Kernquantenpunkts (CI), insbesondere des Kernspins dessen Atomkerns, eines Kernquantenbits (CQUB) dieses Kern-Elektron-Quantenregisters (CEQUREG). Das hier vorgestellte Verfahren umfasst insbesondere bevorzugt die Schritte des Bestromens der horizontalen Leitung (LH) des Quantenbits (QUB) mit einem horizontalen Strom (IH) mit einer horizontalen Stromkomponente, die mit einer Kern-Elektron-Mikrowellenresonanzfrequenz (f_{MWCE}) mit einer horizontalen Modulation moduliert ist und des Bestromens der vertikalen Leitung (LV) des Quantenbits (QUB) mit einem vertikalen Strom (IV) mit einer vertikalen Stromkomponente, die mit der Kern-Elektron- Mikrowellenresonanzfrequenz (f_{MWCE}) mit einer vertikalen Modulation moduliert ist.

Um wieder ein links oder rechts zirkular polarisiertes elektromagnetisches Feld zu erzeugen, ist wieder bevorzugt die horizontale Modulation der horizontalen Stromkomponente um +/-π/2 der Periode der Kern-Elektron- Mikrowellenresonanzfrequenz (f_{MWCE}) gegenüber der vertikalen Modulation der vertikalen Stromkomponente zeitlich phasenverschoben.

Bevorzugt sind die vertikale Stromkomponente mit einem vertikalen Strompuls gepulst und die horizontale Stromkomponente mit einem horizontalen Strompuls gepulst.

Bevorzugt ist wieder der zweite vertikale Strompuls gegenüber dem zweiten horizontalen Strompuls um +/- π/2 der Periode der Kern-Elektron- Mikrowellenresonanzfrequenz (f_{MWCE}) phasenverschoben.

Bevorzugt besitzt wieder die zeitliche Pulsdauer τ_{CE} des horizontalen Strompulses und des vertikalen Strompulses die Pulsdauer entsprechend einer Phasendifferenz von π/4 oder π/2 (Hadamard-Gate) oder π oder 3π/4 oder π (Not-Gate) der Periodendauer der Rabi-Oszillation des Quantenpaars aus dem Quantenpunkt (NV) des Quantenbits (QUB) des Kern-Elektron-Quantenregisters (CEQUREG) und dem Kernquantenpunkt (CI) des Kernquantenbits (CQUB) des Kern-Elektron-Quantenregisters (CEQUREG) und/oder die zeitliche Pulsdauer τ_{CE} des horizontalen Strompulses und des vertikalen Strompulses die Pulsdauer entsprechend einer Phasendifferenz eines ganzzahligen Vielfachen von π/4 der Periodendauer der Rabi-Oszillation des Quantenpaars aus dem Quantenpunkt (NV) des Quantenbits (QUB) des Kern-Elektron-Quantenregisters (CEQUREG) und dem Kernquantenpunkt (CI) des Kernquantenbits (CQUB) des Kern-Elektron-Quantenregisters (CEQUREG).

### Kern-Kern-Quantenregister-Radiowellenansteuerverfahren

Nun wird ein Verfahren zur Änderung der Quanteninformation eines ersten Kernquantenpunkts (CI1), insbesondere des Kernspins dessen Atomkerns, eines ersten Kernquantenbits (CQUB) eines Kern-Kern-Quantenregisters (CCQUREG) in Abhängigkeit von der Quanteninformation eines zweiten Kernquantenpunkts (CI2), insbesondere des Kernspins des zweiten Kernquantenpunks (Ci2), eines zweiten Kernquantenbits (CQUB2) dieses Kern-Kern-Quantenregisters (CCQUREG) betrachtet. Das Verfahren umfasst wiederum die Schritte des Bestromens der ersten horizontalen Leitung (LH1) des ersten Kernquantenbits (CQUB1) mit einer ersten horizontalen Stromkomponente (IH1), die mit einer ersten Kern-Kern-Radiowellenresonanzfrequenz (F_{RWECC}) mit einer horizontalen Modulation moduliert ist, und des Bestromens der ersten vertikalen Leitung (LV1) Kernquantenbits (CQUB1) mit einer ersten vertikalen Stromkomponente (IV1), die mit der ersten Kern-Kern-Radiowellenresonanzfrequenz (f_{RWECC}) mit einer vertikalen Modulation moduliert ist.

Bevorzugt ist wieder horizontale Modulation um +/-π/2 der Periode der ersten Kern-Kern-Radiowellenresonanzfrequenz (f_{RWECC}) gegenüber der vertikalen Modulation zeitlich phasenverschoben, um wieder, wie bereits in anderen zuvor beschriebenen Fällen, wieder ein links- oder rechts zirkular polarisiertes elektromagnetisches Feld zu erzeugen.

Bevorzugt sind die horizontale Stromkomponente zumindest zeitweise mit einem horizontalen Strompulsanteil und die vertikale Stromkomponente zumindest zeitweise mit einem vertikalen Strompulsanteil gepulst.

Bevorzugt ist der zweite vertikale Strompuls gegenüber dem zweiten horizontalen Strompuls um +/π/2 der Periode der ersten Kern-Kern-Radiowellenresonanzfrequenz (F_{RWECC}) phasenverschoben ist.

Bevorzugt besitzt die zeitliche Pulsdauer τ_{RCC} des horizontalen und vertikalen Strompulsanteils die Dauer entsprechend einer Phasendifferenz von π/4 oder π/2 oder π (Hadamard-Gate) oder 3π/4 oder π (Not-Gate) der Periodendauer Rabi-Oszillation des Quantenpaares aus erstem Kernquantenpunkt (CI1) des ersten Kernquantenbits (CQUB1) und aus dem zweiten Kernquantenpunkt(CI2) des zweiten Kernquantenbits (CQUB2) und/oder die zeitliche Pulsdauer τ_{RCC} des horizontalen und vertikalen Strompulsanteils die Dauer entsprechend einer Phasendifferenz eines ganzzahligen Vielfachen von π/4 der Periodendauer Rabi-Oszillation des Quantenpaares aus erstem Kernquantenpunkt (CI1) des ersten Kernquantenbits (CQUB1) und aus dem zweiten Kernquantenpunkt(CI2) des zweiten Kernquantenbits (CQUB2).

### Zusammengesetzte Verfahren

Nachdem nun die grundlegenden Verfahren in den vorausgegangenen Abschnitten beschrieben wurden, können nun aus diesen grundlegenden Verfahren komplexere Verfahren zusammengesetzt werden, die auf die vorgeschlagene Vorrichtung angewendet werden können. Diese Kombination erfolgt bevorzugt durch sequentielle Anwendung dieser Verfahren auf einen oder mehrere Quantenpunkte und/oder Kernquantenpunkte. Eine Parallelisierung ist in Teilen, wie beschrieben, möglich. Erst die Kombination aller dieser Einzelteile und Schritte führt zu einem voll funktionsfähigen System.

### Quantenbit Bewertung

Eines der wichtigsten Verfahren dient dem Auslesen des Ergebnisses der Berechnungen der Vorrichtung. Es handelt sich um eine Verfahren zum Bewerten der Quanteninformation, insbesondere des Spin-Zustands, des ersten Quantenpunkts (NV1) eines auszulesenden ersten Quantenbits (QUB1) eines Kern-Elektron-Kern-Elektron-Quantenregisters (CECEQUREG). Hierbei steht wieder das erste Quantenbits (QUB1) stellvertretend für ein beliebiges Quantenbit des Kern-Elektron-Kern-Elektron-Quantenregisters (CECEQUREG).

In einem ersten Schritt wird der Quantenpunkt (NV) des auszulesenden Quantenbits (QUB1) des Kern-Elektron-Kern-Elektron-Quantenregisters (CECEQUREG) in einen definierten Startzustand versetzt. Dies erfolgt bevorzugt durch das Bestrahlen des Quantenpunkts (NV1) des auszulesenden Quantenbits (QUB1) des Kern-Elektron-Kern-Elektron-Quantenregisters (CECEQUREG) mit "grünem Licht". Wie bereits erläutert, steht der Begriff "grünes Licht" hier für Licht, dass im Zusammenwirken mit dem Quantenpunkt (NV) eine bestimmte Funktion realisiert.

Im beispielhaften Falle eines NV-Zentrums in Diamant als Substrat (D) handelt es sich somit bevorzugt um Licht mit einer Wellenlänge von bevorzugt 500nm Wellenlänge bis 700nm Wellenlänge. Erfahrungsgemäß ist die Verwendung von Licht von typischerweise 532nm Wellenlänge hier optimal. Je größer der wellenlängenmäßige Abstand von diesem Wellenlängenwert ist, desto schlechter typischerweise die Ergebnisse.

Bei der Verwendung anderer Störstellenzentren und Störstellen, die sich insbesondere auch noch in anderen Materialien befinden können, müssen dann als grünes Licht entsprechende andere Wellenlängen verwendet werden, um dann den funktionalen Effekt des "grünen Lichts" für diese Störstellenzentren, Störstellen und Substrate hervorzurufen.

In dem vorgeschlagenen Verfahren erfolgt dann typischerweise ein gleichzeitiges Anlegen einer Spannung zwischen mindestens einer ersten elektrischen Absaugleitung, insbesondere einer als ersten elektrischen Absaugleitung verwendeten Abschirmleitung (SH1, SV1), und einer zweiten elektrischen Absaugleitung, insbesondere einer als zweiten elektrischen Absaugleitung verwendeten, zur verwendeten Abschirmleitung (SH1, SV1) benachbarten, weiteren Abschirmleitung (SH2, SV2). Hierdurch werden Ladungsträger, die bei der Bestrahlung mit "grünem Licht" erzeugt werden, abgesaugt. Dies setzt voraus, dass die Quantenpunkte durch die Bestrahlung mit grünem Licht in einen ungeladenen Zustand übergehen und diese dann sich wieder durch Einfangen eines Ladungsträgers neu laden.

Im Falle der Verwendung von Diamant als Material des Substrats (D) und dem Fall eines NV-Zentrums als Quantenpunkt (NV1) bedeutet dies, dass das Fermi-Niveau bevorzugt über dem Niveau des NV-Zentrums in der Bandlücke liegen sollte. Durch die Bestrahlung mit "grünem Licht" gibt das NV-Zentrum ein Elektron an das Leitungsband ab, wo es durch das von extern über die Kontakte der Absaugleitungen angelegte elektrostatische Feld abgesaugt wird. Da das Fermi-Niveau über dem energetischen Niveau des NV-Zentrums liegt, wird dieses wieder durch die Aufnahme eines Elektrons aus dem Valenzband wieder umgeladen, wodurch es wieder geladen ist. Hierzu sollte der Diamant bevorzugt n-dotiert sein. Daher ist eine n-Dotierung beispielsweise mit kernspin-freiem Schwefel vorteilhaft. Entscheidend ist, dass dieser Auslesevorgang von dem Quantenzustand abhängt.

Genaueres zu diesem Vorgang findet sich in Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond", Science 363, 728-731 (2019) 15 February 2019.

Im Falle der Verwendung von Silizium als Material des Substrats (D) und dem Fall eines G-Zentrums als Quantenpunkt (NV1) bedeutet dies, dass das Fermi-Niveau bevorzugt über dem Niveau des G-Zentrums in der Bandlücke liegen sollte. Durch die Bestrahlung mit "grünem Licht" gibt das G-Zentrum ein Elektron an das Leitungsband ab, wo es durch das von extern über die Kontakte der Absaugleitungen angelegte elektrostatische Feld abgesaugt wird. Da das Fermi-Niveau über dem energetischen Niveau des G-Zentrums liegt, wird dieses wieder durch die Aufnahme eines Elektrons aus dem Valenzband wieder umgeladen, wodurch es wieder geladen ist. Hierzu sollte das Silizium bevorzugt n-dotiert sein. Daher ist eine n-Dotierung beispielsweise mit kernspin-freiem Isotopen vorteilhaft. Wie oben beschrieben, kommen im Bereich der Quantenpunkte beispielsweise die Isotope ¹²⁰Te, ¹²²Te, ¹²⁴Te, ¹²⁶Te, ¹²⁸Te, ¹³⁰Te, ⁴⁶Ti, ⁴⁸Ti, ⁵⁰Ti, ²C, ¹⁴C, ⁷⁴Se, ⁷⁶Se, ⁷⁸Se, ⁸⁰Se, ¹³⁰Ba, ¹³²Ba, ¹³⁴Ba, ¹³⁶Ba, ¹³⁸Ba, ³²S, ³⁴S, und ³⁶S für eine n-Dotierung von Silizium mit Isotopen ohne magnetisches Kernmoment µ in Frage. Entscheidend ist, dass dieser Auslesevorgang auch hier von dem Quantenzustand abhängt.

Erst die Kombination der Quantenbit-Konstruktion mit der selektiven Adressierung und des zuvor beschriebenen Read-Outs mit dieser Methode ergibt eine Realisierungsmöglichkeit für einen Quanten-Computer.

Damit das hier vorgeschlagene Verfahren funktioniert, muss sich der auszulesende Quantenpunkt (NV1) des auszulesenden Quantenbits (QUB1) des Kern-Elektron-Kern-Elektron-Quantenregisters (CECEQUREG) sich in dem elektrischen Feld zwischen diesen beiden elektrischen Absaugleitungen befinden. Bevorzugt befinden sich die nicht auszulesenden Quantenpunkte (NV2) der übrigen Quantenbits (QUB2) des Kern-Elektron-Kern-Elektron-Quantenregisters (CECEQUREG) sich nicht in dem elektrischen Feld zwischen diesen beiden elektrischen Absaugleitungen. Bevorzugt werden die auszulesenden Quantenpunkte (NV1) der jeweils auszulesenden Quantenbits (QUB1) des Kern-Elektron-Kern-Elektron-Quantenregisters (CECEQUREG) selektiv angesteuert, wie oben beschrieben.

Mittels des in Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond", Science 363, 728-731 (2019) 15 February 2019 beschriebenen Mechanismus werden dann Fotoelektronen mittels eines zwei Photonenprozesses durch den auszulesenden Quantenpunkt (NV1) des auszulesenden Quantenbits (QUB1) des Kern-Elektron-Kern-Elektron-Quantenregisters (CECEQUREG) in Abhängigkeit vom Kernspin des Kernquantenpunkts (CI1) des Kernquantenbits (CQUB1), das mit dem auszulesenden Quantenbit (QUB1) ein Kern-Elektron-Quantenregister (CQUREG) bildet, erzeugt. Es folgt dann das Absaugen der ggf. vorhandenen Fotoelektronen des auszulesenden Quantenpunkts (NV1) des auszulesenden Quantenbits (QUB1) des Quantenregisters (QUREG) über einen Kontakt (KV11, KH11) zwischen der ersten elektrischen Absaugleitung, insbesondere der Abschirmleitung (SH1, SV1), und dem Substrat (D) bzw. der epitaktischen Schicht (DEPI) als Elektronenstrom. In analoger Weise erfolgt das Absaugen der ggf. vorhandenen Löcher des auszulesenden Quantenpunkts (NV1) des auszulesenden Quantenbits (QUB1) des Quantenregisters (QUREG) über einen Kontakt (KV12, KH22) zwischen der zweiten elektrischen Absaugleitung, insbesondere der weiteren Abschirmleitung (SH2, SV2), und dem Substrat (D) bzw. der epitaktischen Schicht (DEPI) als Löcherstrom. Ob Fotoelektronen oder Fotolöcher verwendet werden, hängt vom Substratmaterial und dem Störstellenzentrum ab, das als Quantenpunkt verwendet wird. Eine Auswerteschaltung wertet den so erzeugten Fotostrom aus und erzeugt ein Auswertesignal mit einem ersten logischen Wert falls der Gesamtstrom aus Löcherstrom und Elektronenstrom einen Gesamtstrombetrag des Stromwerts unter einem ersten Schwellwert (SW1) aufweist und mit einem zweiten logischen Wert falls der Gesamtstrom aus Löcherstrom und Elektronenstrom einen Gesamtstrombetrag des Stromwerts über dem ersten Schwellwert (SW1) aufweist. Dabei ist natürlich bevorzugt der zweite logische Wert vom ersten logischen Wert verschieden.

Bevorzugt sind auch die Abschirm- und Absaugleitungen aus Isotopen ohne magnetisches Moment µ gefertigt. Hierfür eignen sich die oben bereits erwähnten Titanisotope besonders.

### Quantencomputer-Ergebnisextraktion

Vereinfacht kann somit ein Verfahren zum Auslesen des Zustands eines Quantenpunkts (NV) eines Quantenbits (QUB) mit den Schritten der Bewertung des Ladungszustands des Quantenpunkts (NV) und der Erzeugung eines Auswertungssignals mit einem ersten logischen Pegel sofern der Quantenpunkt (NV) bei dem Beginn der Bewertung negativ geladen ist, und der Erzeugung eines Auswertungssignals mit einem zweiten logischen Pegel, der vom ersten logischen Pegel verschieden ist, sofern der Quantenpunkt (NV) bei dem Beginn der Bewertung nicht negativ geladen ist, angegeben werden.

### Elektron-Elektron-CNOT Operation

Nun geben wir hier eine CNOT-Operation, die eine der wichtigsten Quantencomputer Operationen ist. Es handelt sich hier um ein Verfahren zum Ausführen einer CNOT-Manipulation für ein Quantenregister (QUREG), im Folgenden ELEKTRON-ELEKTRON-CNOT genannt. Dabei soll das Substrat (D) des Quantenregisters (QUREG) dem ersten Quantenbit (QUB1) des Quantenregisters (QUREG) und dem zweiten Quantenbit (QUB2) des Quantenregisters (QUREG) gemeinsam sein. Der Quantenpunkt (NV) des ersten Quantenbits (QUB1) des Quantenregisters (QUREG) wird im Folgenden als erster Quantenpunkt (NV1) bezeichnet. Der Quantenpunkt (NV) des zweiten Quantenbits (QUB2) des Quantenregisters (QUREG) wird im Folgenden als der zweite Quantenpunkt (NV2) bezeichnet. Die horizontale Leitung (LH) des ersten Quantenbits (QUB1) des Quantenregisters (QUREG) wird im Folgenden als erste horizontale Leitung (LH1) bezeichnet. Die horizontale Leitung (LH) des zweiten Quantenbits (QUB2) des Quantenregisters (QUREG) wird im Folgenden als zweite horizontale Leitung (LH2) bezeichnet. Die vertikale Leitung (LV) des ersten Quantenbits (QUB1) des Quantenregisters (QUREG) wird im Folgenden als erste vertikale Leitung (LV1) bezeichnet. Die vertikale Leitung (LV) des zweiten Quantenbits (QUB2) des Quantenregisters (QUREG) wird im Folgenden als zweite vertikale Leitung (LV2) bezeichnet. Die erste horizontale Leitung (LH1) ist bevorzugt gleich der zweiten horizontalen Leitung (LH2). Dies führt zu einer möglichen Topologie eines n-Bit-Quantenregisters (NBQUREG), bei dem die Quantenpunkte (NV1, NV2) längs dieser horizontalen Leitung (LH1) wie auf einer Perlenkette aufgereiht sind, wenn dies für alle Quantenregister (QUREG) einer Vorrichtung mit mehreren Quantenregistern (QUREG) gilt. Dies hat den Vorteil, dass die selektive Ansteuerung einzelner Quantenpunkte dieser Vorrichtung dann einfacher wird. Natürlich ist auch eine Aufreihung in der Vertikalen möglich. Die erste vertikale Leitung (LV1) kann somit auch gleich der zweiten vertikalen Leitung (LH2) sein. Bevorzugt ist dann die erste horizontale Leitung (LH1) nicht gleich der zweiten horizontalen Leitung (LH2) ist.

Wie zuvor umfasst das vorgeschlagene Verfahren dann das Bestromen der ersten horizontalen Leitung (LH1) mit einem ersten horizontalen Stromanteil des ersten horizontalen Stromes (IH1) für eine zeitliche Dauer, die einem ersten Phasenwinkel von φ₁, insbesondere von π/4 oder π/2 (Hadamard-Gate) oder 3π/4 oder π (Not-Gate) odereinem ganzzahligen Vielfachen von π/4, der Periodendauer der Rabi-Oszillation des ersten Quantenpunkts (NV1) des ersten Quantenbits (QUB1) entspricht.

Bevorzugt ist dabei der erste horizontale Stromanteil mit einer ersten Mikrowellenresonanzfrequenz (f_{MW1}) mit einer ersten horizontalen Modulation moduliert.

Ebenso bevorzugt erfolgt das Bestromen der ersten vertikalen Leitung (LV1) mit einem ersten vertikalen Stromanteil des ersten vertikalen Stromes (IV1) für eine zeitliche Dauer, die dem ersten Phasenwinkel von φ₁, insbesondere von π/4 oder π/2 (Hadamard-Gate) oder 3π/4 oder π (Not-Gate) odereinem ganzzahligen Vielfachen von π/4, der Periodendauer der Rabi-Oszillation des ersten Quantenpunkts (NV1) des ersten Quantenbits (QUB1) entspricht, wobei bevorzugt der erste vertikale Stromanteil mit einer ersten Mikrowellenresonanzfrequenz (f_{MW1}) mit einer ersten vertikalen Modulation moduliert ist.

Bevorzugt erfolgt die Bestromung der ersten horizontalen Leitung (LH1) bis auf besagte Phasenverschiebung zeitlich parallel zur Bestromung der ersten vertikalen Leitung (LV1).

Das Bestromen der ersten horizontalen Leitung (LH1) erfolgt bevorzugt mit einem ersten horizontalen Gleichstrom (IHG1) mit einem ersten horizontalen Stromwert, wobei der erste horizontale Stromwert einen Betrag von 0A haben kann.

Das Bestromen der ersten vertikalen Leitung (LV1) erfolgt bevorzugt mit einem ersten vertikalen Gleichstrom (IVG1) mit einem ersten vertikalen Stromwert, wobei der erste vertikale Stromwert einen Betrag von 0A haben kann.

Das Bestromen der zweiten horizontalen Leitung (LH2) erfolgt bevorzugt mit einem zweien horizontalen Gleichstrom (IHG2) mit dem ersten horizontalen Stromwert, wobei der erste horizontale Stromwert einen Betrag von 0A haben kann.

Das Bestromen der zweiten vertikalen Leitung (LV2) erfolgt bevorzugt mit einem zweiten vertikalen Gleichstrom (IVG2), dessen zweiter vertikaler Stromwert von dem ersten vertikaler Stromwert abweicht. Bevorzugt sin dabei der zweite vertikale Stromwert und der erste vertikale Stromwert so gewählt, dass der Phasenvektor des ersten Quantenpunkts (NV1) des ersten Quantenbits (QUB1) eine Phasendrehung um den ersten Phasenwinkel φ₁, insbesondere von π/4 oder π/2 (Hadamard-Gate) oder 3π/4 oder π (Not-Gate) odereinem ganzzahligen Vielfachen von π/4, ausführt, wenn sich der Phasenvektor des zweiten Quantenpunkts (NV2) des zweiten Quantenbits (QUB2) in einer ersten Position befindet und dass der Phasenvektor des ersten Quantenpunkts (NV1) des ersten Quantenbits (QUB1) keine Phasendrehung um den Phasenwinkel φ₁, insbesondere von π/4 oder π/2 (Hadamard-Gate) oder 3π/4 oder π (Not-Gate) odereinem ganzzahligen Vielfachen von π/4, ausführt, wenn sich der Phasenvektor des zweiten Quantenpunkts (NV2) des zweiten Quantenbits (QUB2) nicht in der ersten Position sondern in einer zweiten Position befindet und dass der Phasenvektor des zweiten Quantenpunkts (NV2) des zweiten Quantenbits (QUB2) keine oder nur eine unwesentliche Phasendrehung ausführt.

Bevorzugt erfolgt anschließend das Bestromen der zweiten horizontalen Leitung (LH2) mit einem zweiten horizontalen Stromanteil (IHM2) für eine zeitliche Dauer, die einem Phasenwinkel von φ₂, insbesondere von π/4 oder π/2 (Hadamard-Gate) oder 3π/4 oder π (Not-Gate) odereinem ganzzahligen Vielfachen von π/4, der Periodendauer der Rabi-Oszillation des zweiten Quantenpunkts (NV2) des zweiten Quantenbits entspricht, wobei der zweite horizontale Stromanteil (IHM2) mit einer zweiten Mikrowellenresonanzfrequenz (f_{MW2}) mit einer zweiten horizontalen Modulation moduliert ist.

Das Bestromen der zweiten vertikalen Leitung (LV2) erfolgt bevorzugt mit einem zweiten vertikalen Stromanteil (IVM2) für eine zeitliche Dauer, die einem Phasenwinkel von φ₂, insbesondere von π/4 oder π/2 (Hadamard-Gate) oder 3π/4 oder π (Not-Gate) odereinem ganzzahligen Vielfachen von π/4, der Periodendauer der Rabi-Oszillation des zweiten Quantenpunkts (NV2) des zweiten Quantenbits entspricht, wobei der zweite vertikale Stromanteil (IVM2) mit einer zweiten vertikalen Mikrowellenresonanzfrequenz (f_{MW2}) mit einer zweiten vertikalen Modulation moduliert ist und wobei die Bestromung der zweiten horizontalen Leitung (LH2) bis auf die besagte Phasenverschiebung zeitlich parallel zur Bestromung der zweiten vertikalen Leitung (LV2) erfolgt.

Bevorzugt erfolgt das Bestromen der zweiten horizontalen Leitung (LH2) mit einem zweiten horizontalen Gleichstromanteil (IHG2) mit einem zweiten horizontalen Stromwert, wobei der zweite horizontalen Stromwert von 0A sein kann.

Bevorzugt erfolgt das Bestromen der zweiten vertikalen Leitung (LV2) mit einem zweiten vertikalen Gleichstromanteil (IVG2) mit einem zweiten vertikalen Stromwert, wobei der zweite vertikale Stromwert von 0A sein kann.

Bevorzugt erfolgt das Bestromen der ersten horizontalen Leitung (LH1) mit einem ersten horizontalen Gleichstromanteil (IHG1) mit einem ersten horizontalen Stromwert, wobei der erste horizontalen Stromwert von 0A sein kann.

Bevorzugt erfolgt das Bestromen der ersten vertikalen Leitung (LV1) mit einem ersten vertikalen Gleichstromanteil (IVG1) mit einem ersten vertikalen Stromwert, wobei der erste vertikale Stromwert von dem zweiten vertikalen Stromwert abweicht. Hierdurch erst findet eine Adressierung statt.

Bevorzugt wird der erste vertikale Stromwert und der zweite vertikale Stromwert nun so gewählt, dass der Phasenvektor des zweiten Quantenpunkts (NV2) des zweiten Quantenbits (QUB2) eine Phasendrehung um den Winkel φ₂, insbesondere von π/4 oder π/2 (Hadamard-Gate) oder 3π/4 oder π (Not-Gate) oder einem ganzzahligen Vielfachen von π/4, ausführt, wenn sich der Phasenvektor des ersten Quantenpunkts (NV1) des ersten Quantenbits (QUB1) in einer ersten Position befindet und dass der Phasenvektor des zweiten Quantenpunkts (NV2) des zweiten Quantenbits (QUB2) keine Phasendrehung um den Winkel φ₂, insbesondere von π/4 oder π/2 (Hadamard-Gate) oder 3π/4 oder π (Not-Gate) oder einem ganzzahligen Vielfachen von π/4, ausführt, wenn sich der Phasenvektor des ersten Quantenpunkts (NV1) des ersten Quantenbits (QUB1) nicht in der ersten Position sondern in einer zweiten Position befindet und dass der Phasenvektor des ersten Quantenpunkts (NV1) des ersten Quantenbits (QUB1) dann keine Phasendrehung ausführt.

Zur Erzeugzeugung eines links oder rechts polarisierten elektromagnetischen Feldes ist wieder bevorzugt die erste horizontale Modulation um +/- π/2 der Periodendauer der ersten Mikrowellenresonanzfrequenz (f_{MW1}) gegenüber der ersten vertikalen Modulation phasenverschoben und/oder die zweite horizontale Modulation um +/- π/2 der Periode der zweiten Mikrowellenresonanzfrequenz (f_{MW2}) gegenüber der zweiten vertikalen Modulation phasenverschoben.

### Quantum-Computing

Im Folgenden wird nun ein einfaches Verfahrensgrundschema zum Durchführen von einfachen Berechnungen beschrieben. Es handelt sich um ein Verfahren zum Betreiben eines Kern-Elektron-Kern-Elektron-Quantenregisters (CECEQUREG). Es umfasst bevorzugt die Schritte des Zurücksetzens der Quantenpunkte (NV) der Quantenbits (QUB1, QUB2) des Kern-Elektron- Kern-Elektron-Quantenregisters (CECEQUREG) und des einmaligen oder mehrfachen Manipulierens der Quantenpunkte (NV) der Quantenbits (QUB1, QUB2) des Kern-Elektron- Kern-Elektron-Quantenregisters (CECEQUREG) und des Speichern des Manipulationsergebnisses sowie des Zurücksetzen der Quantenpunkte (NV) der Quantenbits (QUB1, QUB2) des Kern-Elektron- Kern-Elektron-Quantenregisters (CECEQUREG) und des Zurücklesens der gespeicherten Manipulationsergebnisse sowie des Auslesens des Zustands der Quantenpunkte (NV) der Quantenbits (QUB1, QUB2) des Kern-Elektron- Kern-Elektron-Quantenregisters (CECEQUREG).

Bevorzugt erfolgt das Zurücksetzen der Quantenpunkte (NV) der Quantenbits (QUB1, QUB2) des Kern-Elektron- Kern-Elektron-Quantenregisters (CECEQUREG) mittels eines der beschriebenen Quantenbitrücksetzverfahren.

Bevorzugt erfolgt die einmalige oder mehrfache Manipulation der Quantenzustände der der Quantenpunkte (NV) der Quantenbits (QUB1, QUB2) des Kern-Elektron- Kern-Elektron-Quantenregisters (CECEQUREG) mittels eines der beschriebenen Quantenbitmanipulationsverfahren.

Bevorzugt erfolgt das Speichern des Manipulationsergebnisses mittels eines der zuvor beschriebenen Verfahren zur Beeinflussung des Quantenzustands eines Kernquantenpunkts in Abhängigkeit vom Quantenzustand eines Quantenpunkts.

Bevorzugt erfolgt das zweite Zurücksetzen der Quantenpunkte (NV) der Quantenbits (QUB1, QUB2) des Kern-Elektron- Kern-Elektron-Quantenregisters (CECEQUREG) mittels eines der beschriebenen Quantenbitrücksetzverfahren.

Bevorzugt erfolgt das Zurücklesen der gespeicherten Manipulationsergebnisse mittels eines Verfahrens mittels eines der zuvor beschriebenen Verfahren zur Beeinflussung des Quantenzustands eines Quantenpunkts in Abhängigkeit vom Quantenzustand eines Kernquantenpunkts.

Bevorzugt erfolgt das Auslesen des Zustands der Quantenpunkte (NV) der Quantenbits (QUB1, QUB2) des Quantenregisters (QUREG) und/oder des Quantenpunkts (NV) des Quantenbits (QUB) mittels eines Verfahrens zur Quantenbit-Bewertung und/oder eines Verfahrens zur Quantencomputer-Ergebnisextraktion.

Ein alternatives Verfahren zum Betreiben eines Quantenregisters (QUREG) und/oder eines Quantenbits (QUB) umfasst die Schritte des Zurücksetzen der Quantenpunkte (NV) der Quantenbits (QUB1, QUB2) des Kern-Elektron-Kern-Elektron-Quantenregisters (CECEQUREG) mittels eines der beschriebenen Quantenbitrücksetzverfahren und den Schritt des einmaligen oder mehrfachen Manipulierens der Quantenzustände der Quantenpunkte (NV) der Quantenbits (QUB1, QUB2) des Kern-Elektron-Kern-Elektron-Quantenregisters (CECEQUREG) mittels eines der beschriebenen Quantenbitmanipulationsverfahren und den Schritt des Speicherns des Manipulationsergebnisses mittels eines der zuvor beschriebenen Verfahren zur Beeinflussung des Quantenzustands eines Kernquantenpunkts in Abhängigkeit vom Quantenzustand eines Quantenpunkts und den Schritt des Zurücksetzens der Quantenpunkte (NV) der Quantenbits (QUB1, QUB2) des Kern-Elektron-Kern-Elektron-Quantenregisters (CECEQUREG) mittels eines der beschriebenen Quantenbitrücksetzverfahren sowie das Zurücklesen der gespeicherten Manipulationsergebnisse mittels eines der zuvor beschriebenen Verfahren zur Beeinflussung des Quantenzustands eines Quantenpunkts in Abhängigkeit vom Quantenzustand eines Kernquantenpunkts und das Auslesen des Zustands der der Quantenpunkte (NV) der Quantenbits (QUB1, QUB2) des Quantenregisters (QUREG) und/oder des Quantenpunkts (NV) des Quantenbits (QUB) mittels eines Verfahrens zur Quantenbit-Bewertung und/oder eines Verfahrens zur Quantencomputer-Ergebnisextraktion.

### Quantenhardware

### Quantenbus

Der nun folgende Abschnitt ist von besonderer Bedeutung. In einem Quantencomputer werden nicht Ladungsträger, sondern Abhängigkeiten transportiert. Das ist insofern ungewöhnlich, als dass hier der absolute Zustand der Quantenbits in vielen Fällen irrelevant ist. Vielmehr spielen nun Abhängigkeiten, also Informationen, die Rolle der Ladungsträger. Für den Transport dieser Ladungsträger bedarf es eines Transportbusses für die Abhängigkeiten der Quanteninformationen untereinander. Dieser Transportbus wird im Folgenden als Quantenbus (QUBUS) bezeichnet und ist das entscheidende Element zur Verknüpfung mehrere Quantenpunkte mehrere Quantenbits untereinander. Über die Quantenpunkte der Quantenbits können dann die diesen Quantenbits zugeordneten Kernquantenpunkte auch und gerade bei größerer Beabstandung zueinander erreicht werden, sodass Abhängigkeiten von einem Kernquantenpunkt über diesen Quantenbus zu einem anderen Kernquantenpunkt transportiert werden können. Dies ermöglicht die Kopplung zweier Kernquantenpunkte, die nicht so dicht beieinander platziert sind, dass sie direkt gekoppelt werden können. Dabei wird bevorzugt der Quantenbus als Kette von Quantenpunkten, beispielsweise als n-Bit-Quantenregister (NBQUREG), ausgeführt. Es handelt es sich also um ein bevorzugt, aber nicht notwendigerweise um eine streckenweise lineare Kette, die de facto eine Abhängigkeitsleitung darstellt. Die Quantenpunkte dieser Kette bilden ein großes Quantenregister. Es wird hierbei ausgenutzt, dass die Reichweite der Kopplungen der Quantenpunkte - hier auch als Elektron-Elektron-Kopplungsreichweite bezeichnet-, also beispielsweise der NV-Zentren in Diamant oder der G-Zentren in Silizium oder der V-Zentren in Siliziumkarbid untereinander, größer ist als die Reichweite der Kopplungen der Kernquantenpunkte mit den Quantenpunkten -hier auch als Kern-Elektron-Kopplungsreichweite bezeichnet-.

Ein solcher Quantenbus (QUBUS) weist daher bevorzugt n Quantenbits (QUB1 bis QUBn), mit n als ganzer positiver Zahl, auf. Um einen Quantenbus (QUBUS) bilden zu können, muss n≥2 gelten. Beispielhaft nehmen wir an, dass der Quantenbus (QUBUS) ein erstes Kernquantenbit (CQUB1) aufweist und ein n-tes Kernquantenbit (CQUBn) aufweist. Das erste Kernquantenbit (CQUB1) sei dem ersten Quantenbit (QUB1) des Quantenbusses (QUBUS) beispielhaft zugeordnet. Das n-te Kernquantenbit (CQUBn) sei dem n-ten Quantenbit (QUBn) des Quantenbusses (QUBUS) beispielhaft zugeordnet. Dies ist nur ein Beispiel. Jedes Quantenbit der Quantenbits (QUB1 bis QUBn) des Quantenbusses (QUBUS) kann kein oder ein oder mehrere Kernquantenpunkte aufweisen. Genauso gut kann das hier beschriebene Quantenbusbeispiel auch nur einen Teilquantenbus eines größeren Quantenbusses (QUBUS) oder eines Quantenbusnetzwerks (QUNET) darstellen. Wir nehmen daher nur zur Verdeutlichung und zur Vereinfachung und beispielhaft an, dass sich das erste Quantenbit (QUB1) an einem Ende eines beispielhaft linearen verzweigungsfreien Quantenbusses befindet und dass sich an dem anderen Ende dieses beispielhaften Modellquantenbusses sich das n-te Quantenbit (QUBn) befindet. Komplexere Topologien des Quantenbusses sind ausdrücklich möglich und werden von der Beanspruchung mit umfasst. Insofern handelt es sich hier nur um ein Beispiel zur Verdeutlichung des Abhängigkeitstransports über den Quantenbus.

Wir nummerieren zur besseren Klarheit der Beschreibung die n Quantenbits (QUB1 bis QUBn) längs des eispielhaft als linear angenommenen Quantenbusses von 1 bis n durch. Offensichtlich bilden in diesem Beispiel diese n Quantenbits (QUB1 bis QUBn) ein beispielhaftes n-Bit-Quantenregister (NBQUREG).

Dabei ist ein j-tes Quantenbit (QUBj) ein beliebiges dieser n Quantenbits (QUB1 bis QUBn) mit 1<j<n ist, das nur zu berücksichtigen ist, wenn n>2 gilt.

Jedes j-te Quantenbit (QUBj) besitzt ein Vorgängerquantenbit (QUB(j-1)) und ein Nachfolgerquantenbit (QUB(j+1)).

Das erste Quantenbit (QUB1) bildet mit dem ersten Kernquantenbit (CQUB1) ein erstes Kern-Elektron-Quantenregister (CEQUREG1).

Das n-te Quantenbit (QUBn) bildet mit dem n-ten Kernquantenbit (CQUBn) ein n-tes Kern-Elektron-Quantenregister (CEQUREGn).

Das erste Quantenbit (QUB1) bildet nun mit dem zweiten Quantenbit (QUB2) ein erstes Elektron-Elektron-Quantenregister (QUREG1), das am Anfang des hier beispielhaft als linear angenommenen Quantenbusses liegt.

Das n-te Quantenbit (QUBn) bildet mit dem (n-1)-ten Quantenbit (QUB(n-1)) ein (n-1)-tes Elektron-Elektron-Quantenregister (QUREG(n-1)), das am anderen Ende des Quantenbusses liegt.

Zwischen diesen beiden Quantenregistern (QUREG1, QUREG(n-1)) befindet sich nun längs des Quantenbusses (QUBUS) eine Kette von Zwei-Bit-Quantenregistern, die sich bevorzugt überlappen.

Jedes der anderen n-2 Quantenbits wird zu besseren Klarheit nun im Folgenden als j-tes Quantenbit (QUBj) mit 1<j<n bezeichnet, wenn n>2 ist. Jedes dieser j-ten Quantenbits bildet dann mit seinem Vorgängerquantenbit (QUB(j-1)) ein (j-1)-tes Quantenregister (QUREG(j-1)). In gleicher Weise bildet jedes dieser j-ten Quantenbits mit seinem Nachfolgerquantenbit (QUB(j+1)) ein j-tes Quantenregister (QUREGj). Somit ergibt sich dann eine geschlossene Kette mit zwei Kern-Elektron-Quantenregistern (CEQUREG1, CEQUREGn) und n-1 Zwei-Bit-Quantenregistern (QUREG1 bis QUREG(n-1)) zwischen dem ersten Kernquantenbit (CQUB1) und dem n-ten Kernquantenbit (CQUBn). Diese geschlossene Kette mit zwei Kern-Elektron-Quantenregistern (CEQUREG1, CEQUREGn) und n-1 Zwei-Bit-Quantenregistern (QUREG1 bis QUREG(n-1)) zwischen dem ersten Kernquantenbit (CQUB1) und dem n-ten Kernquantenbit (CQUBn) ermöglicht dann den Transport von Abhängigkeiten zwischen den Kernquantenbits (CQUB1, CQUBn) und zwar auch dann, wenn aufgrund eines zu großen räumlichen Abstands das erste Kernquantenbit (CQUB1) nicht mit dem n-ten Kernquantenbit (CQUBn) direkt ohne Zuhilfenahme der n Quantenbits (QUB1 bis QUBn) koppeln kann.

An dieser Stelle erinnern wir uns nun, dass ein Quantenbit mit einer Mehrzahl von Kernquantenbits eine QuantenALU bilden kann. Das Quantenbit einer QuantenALU kann dann mittels eines solchen Quantenbusses mit dem Quantenbit einer anderen QuantenALU verbunden werden. Wie zuvor beschränken wir uns beispielhaft auf die direkte Verbindung zweier QuantenALUs durch eine Kette von Quantenregistern. Es ist offensichtlich, das komplexere Topologien mit Verzweigungen, Schleifen und mehreren QuantenALUs und Kernquantenbits möglich sind. Solche Vorrichtungen werden durch die Beanspruchung mit umfasst. Zur Vereinfachung nehmen wir für die Erläuterung wieder beispielhaft an, dass durch die Kette von Quantenregistern ein Quantenbus (QUBUS) mit n Quantenbits (QUB1 bis QUBn) gebildet wird. Auch hierbei soll wieder n eine ganze positive Zahl, mit n≥2, darstellen. Der beispielhafte Quantenbus (QUBUS) soll beispielhaft eine erste QuantenALU (QUALU1) und eine n-te QuantenALU (QUALUn) aufweisen. Wie zuvor nummerieren wir zur besseren Klarheit die n Quantenbits (QUB1 bis QUBn) des beispielhaften, einfachen Quantenbusses von 1 bis n durch. Das erste Quantenbit (QUB1) soll beispielhaft das Quantenbit (QUB1) der ersten QuantenALUs (QUALU1) sein und das n-te Quantenbit (QUBn) das Quantenbit (QUBn) der n-ten QuantenALUs (QUALUn). Die dazwischenliegenden Quantenbits werden zur Vereinfachung pauschal als j-tes Quantenbit (QUBj) bezeichnet, das somit ein beliebiges dieser n Quantenbits (QUB1 bis QUBn) mit 1<j<n repräsentiert, das nur zu berücksichtigen ist, wenn n>2 gilt. Jedes j-te Quantenbit (QUBj) besitzt in diesem Beispiel ein Vorgängerquantenbit (QUB(j-1)) und ein Nachfolgerquantenbit (QUB(j+1)). Das erste Quantenbit (QUB1) bildet in diesem Beispiel mit dem zweiten Quantenbit (QUB2) ein erstes Elektron-Elektron-Quantenregister (QUREG1). Das n-te Quantenbit (QUBn) bildet in diesem Beispiel mit dem (n-1)-ten Quantenbit (QUB(n-1)) ein (n-1)-tes Elektron-Elektron-Quantenregister (QUREG(n-1)). Jedes der anderen n-2 Quantenbits, im Folgenden als j-tes Quantenbit (QUBj) mit 1<j<n bezeichnet, wenn n>2 ist, bildet in diesem Beispiel mit seinem Vorgängerquantenbit (QUB(j-1)) ein (j-1)-tes Quantenregister (QUREG(j-1)) und mit seinem Nachfolgerquantenbit (QUB(j+1)) ein j-tes Quantenregister (QUREGj). Hierdurch ergibt sich wieder eine geschlossene Kette von n-1 Quantenregistern (QUREG1 bis QUREG(n-1)) zwischen dem ersten Kernquantenbit (CQUB1) und dem n-ten Kernquantenbit (CQUBn). Somit wird der Transport von Abhängigkeiten zwischen den Kernquantenbits der QuantenALUs möglich. Zum Ersten kann der Transport der Abhängigkeiten innerhalb einer QuantenALU zwischen zwei Kernquantenbits dieser QuantenALU über das Quantenbit der betreffenden QuantenALU erfolgen. Zum Zweiten kann der Transport der Abhängigkeiten zwischen dem Kernquantenbit einer QuantenALU und dem Kernquantenbit einer anderen QuantenALU über die besagte Kette von Zwei-Bit-Quantenregistern erfolgen. Hierdurch wird die Verschränkung aller Kernquantenbits miteinander möglich. Die Kernquantenbits dienen daher bevorzugt dem Quantenberechnungsvorgang während bevorzugt die Quantenpunkte dem Transport der Abhängigkeiten zwischen den Kernquantenbits dienen.

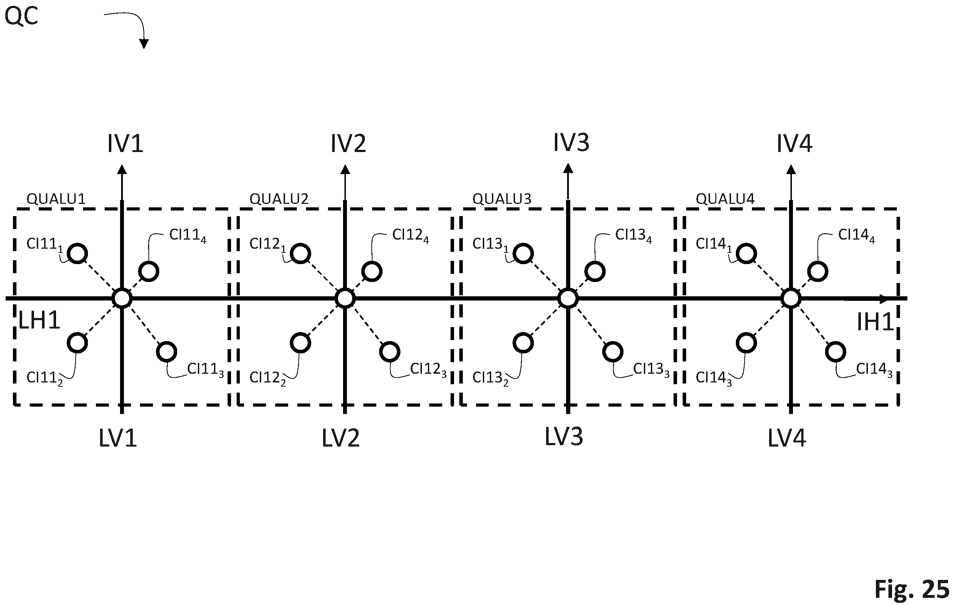

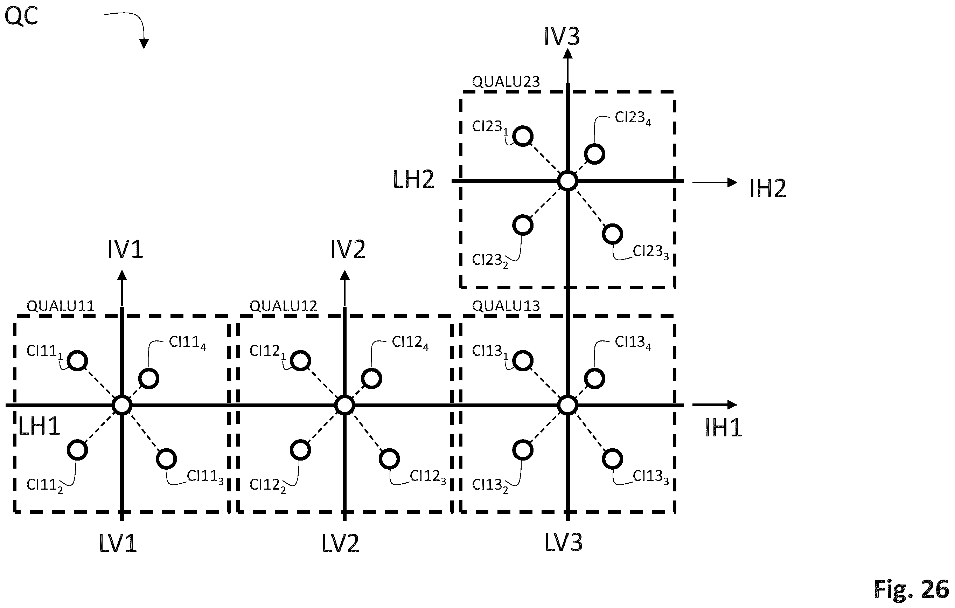

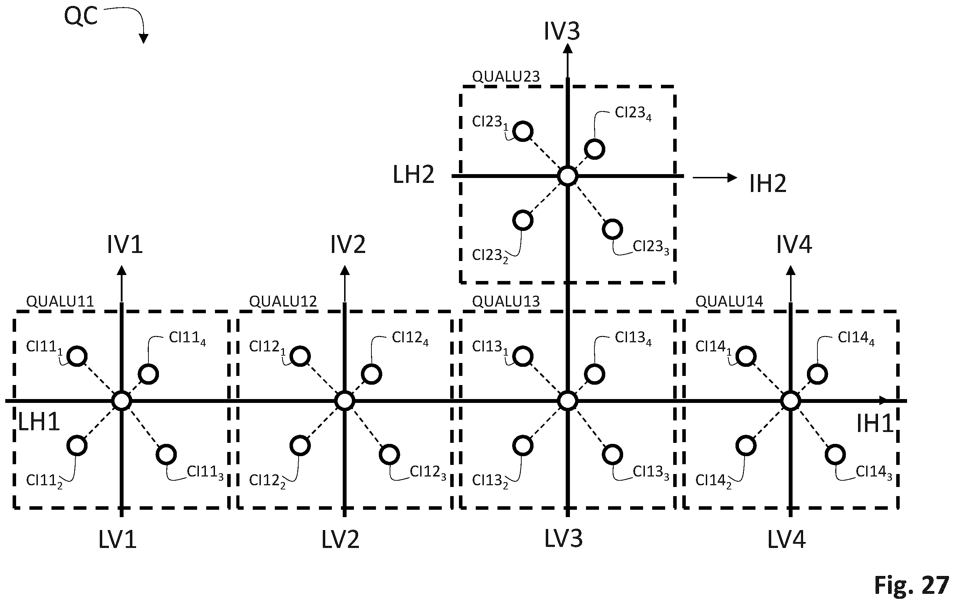

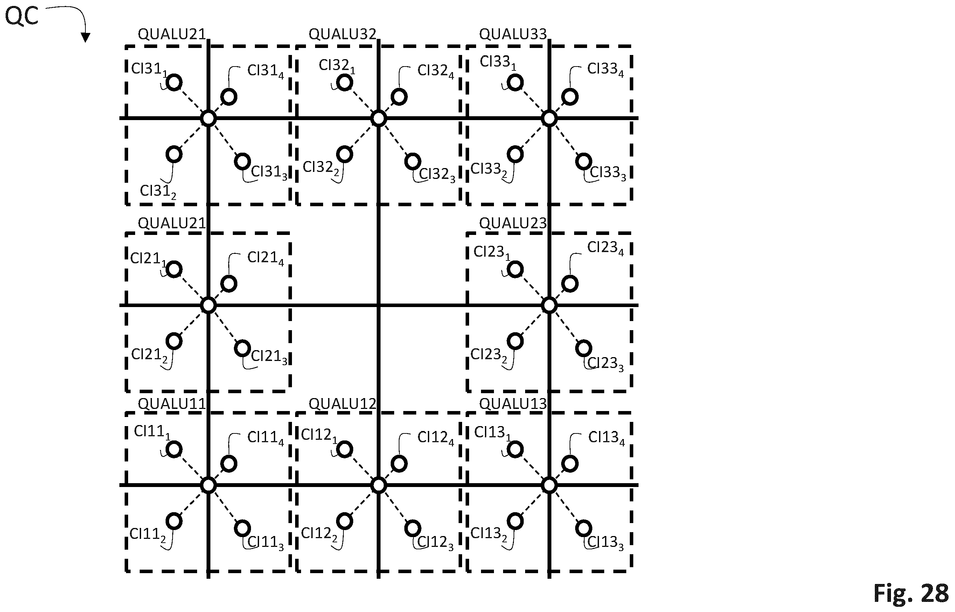

Wie bereits erwähnt, weist der vorgeschlagene Quantenbus lineare Abschnitte (Figur 25) und/oder eine Verzweigung (Figur 27) und/oder einen Knick (Figur 26) oder eine Schleife (Figur 28) auf.

Bevorzugt wird der Quantenbus mit Mitteln (HD1 bis HDn, HS1 bis HSn, and HD1 bis VDn, VS1 bis VSn, CBA, CBB, µC) versehen, um den Spin der Elektronenkonfiguration des n-ten Quantenpunkts (NVn) der n-ten QuantenAlu (QUALUn) und/oder den Kernspin eines Kernquantenpunkts (Cln) der n-ten QuantenAlu (QUALUn) in Abhängigkeit von der Elektronenkonfiguration des ersten Quantenpunkts (NV1) der ersten QuantenAlu (QUALU1) und/oder den Kernspin eines Kernquantenpunkts (CI1) der ersten QuantenAlu (QUALUn) mit Hilfe von Quantenbits der n Quantenbits (QUB1 bis QUBn) zu ändern. Natürlich gilt dies auch für andere Paarungen von Kernquantenpunkten der Vorrichtung in analoger Weise.

### Quantenbusbetrieb

Zu dem zuvor beschriebenen Quantenbus (QUBUS), der dem Transport von Abhängigkeiten zwischen den Kernquantenpunkten der Kernquantenbits bzw. den Kernquantenpunkten der QuantenALUs dient, die über Quantenpunkte der zugehörigen Quantenbits an den Quantenbus angeschlossen sind, gehört ein Verfahren zum Betrieb eines solchen Quantenbusses. Da die QuantenALUs aus Kern-Elektron-Quantenregistern (CEQUREG) bestehen, ist es ausreichend, den Transport an einem einfachen Beispiel zu beschreiben. Die möglichen, komplexeren Quantenbus-Topologien mit Verzweigungen und Ringen von Quantenpunkt-Ketten aus verketteten Zweibit-Quantenregistern (QUREG) sind ausdrücklich von der Beanspruchung miteingeschlossen. Das Verfahren zum Betreiben eines solchen Quantenbusses (QUBUS) ist bevorzugt ein Verfahren zum Austausch, insbesondere Spin-Austausch, der Quanteninformation, insbesondere der Spin-Information, des j-ten Quantenpunkts (NVj) eines j-ten Quantenbits (QUBj) mit der Quanteninformation, insbesondere der Spin-Information des (j+1)-ten Quantenpunkt (NV(j+1)) des nachfolgenden (j+1)-ten Quantenbits (QUB(j+1)) eines Quantenbusses (QUBUS). Hierbei steht der j-te Quantenpunkt (NVj) eines j-ten Quantenbits (QUBj) beispielhaft für einen Quantenpunkt der Kette von Quantenpunkten des Quantenbusses. Das Verfahren basiert auf der Durchführung einer Elektron-Elektron-CNOT-Operation, wie zuvor beschrieben. Dabei wird die Elektron-Elektron-CNOT-Operation mit dem j-ten Quantenbit (QUBj) als erstes Quantenbit (QUB1) der Elektron-Elektron-CNOT-Operation und mit dem (j+1)-ten Quantenbit (QUB(j+1)) als zweites Quantenbit (QUB2) der Elektron-Elektron-CNOT-Operation durchgeführt. Zusammengefasst handelt es sich also um nichts anderes als die Anwendung einer Elektron-Elektron-CNOT-Operation auf ein Quantenpunktpaar von Quantenpunkten des Quantenbusses (QUBUS).

Mit Hilfe dieser Operation kann bereits der Transport von Abhängigkeiten über den Quantenbus (QUBUS) sichergesellt werden. Es fehlt aber noch die Ankopplung der Kernquantenpunkte an die Kette von Quantenpunkten. Dies geschieht nun mit dem nachfolgenden Verfahren.

Hierzu geben wir hier ein beispielhaftes Verfahren zum Verschränken des beispielhaft gewählten ersten Quantenpunkts (NV1) des ersten Quantenbits (QUB1) mit dem beispielhaft gewählten ersten Kernquantenpunkt (CI1) des ersten Kernquantenbits (CQUB1) eines Quantenbusses (QUBUS) an. Ein erster Schritt dieses Verfahrens ist das Durchführen einer Elektron-Kern-Austausch-Operation, insbesondere einer Kern-Elektron-Entenglement-Operation, wie oben beschrieben. Dabei sind das erste Quantenbit (QUB1) das Quantenbit (QUB) der besagten Elektron-Kern-Austausch-Operation und das erste Kernquantenbit (CQUB1) das Kernquantenbit (CQUB) der besagten Elektron-Kern-Austausch-Operation. Hierbei stehen das erste Quantenbit (QUB1) beispielhaft für ein beliebiges erstes Quantenbit des Quantenbusses (QUBUS) und das das erste Kernquantenbit (CQUB1) für ein beliebiges Kernquantenbit des Quantenbusses (QUBUS), das mit dem ersten Quantenbit (QUB1) wechselwirken kann. Mit Hilfe dieser Operation kann somit nun auch die Ankopplung der Kernquantenpunkte an die Kette von Quantenpunkten sichergestellt werden.

Es ist aber auch das Ziel, die Quanteninformation eines Kernquantenbits in Abhängigkeit von einem anderen Kernquantenbit, das ebenfalls über den Quantenbus (QUBUS) erreichbar ist, zu verändern.

Hierzu geben wir hier ein weiteres beispielhaftes Verfahren zum Verschränken des beispielhaft gewählten n-ten Quantenpunkts (NVn) des n-ten Quantenbits (QUBn) mit dem ebenfalls beispielhaft gewählten n-ten Kernquantenpunkt (Cln) des n-ten Kernquantenbits (CQUBn) eines Quantenbusses (QUBUS) an. Es handelt sich also um die Anwendung des unmittelbar zuvor beschriebenen Verfahrens auf das n-te Quantenbit (QUBn) und das n-te Kern-Quantenbit (CQUBn) statt des ersten Quantenbits (QUB1) und des ersten Kernquantenbits (CQUB1). Hierbei stehen das n-te Quantenbit (QUBn) beispielhaft für ein beliebiges weiteres Quantenbit des Quantenbusses (QUBUS) und das das n-te Kernquantenbit (CQUBn) für ein beliebiges weiteres Kernquantenbit des Quantenbusses, das mit dem n-ten Quantenbit (QUBn) wechselwirken kann. Wichtig ist für das hier diskutierte Beispiel nur, dass das erste Quantenbit (QUB1) vom n-ten Quantenbit (QUBn) und dass das erste Kernquantenbit (CQUB1) vom n-ten Kernquantenbit (CQUBn) verschieden sind. Zum besseren Verständnis wurden die Indices 1 und n als willkürliches Beispiel gewählt. Es hätten auch die Indices i und j mit i≠j statt 1 und n gewählt werden können. Das Verfahren umfasst dann das Durchführen einer Elektron-Kern-Austausch-Operation, insbesondere eine Kern-Elektron-Entenglement-Operation, wie oben beschrieben. Dabei stellt das n-te Quantenbit (QUBn) das Quantenbit (QUB) der besagten Elektron-Kern-Austausch-Operation und das n-te Kernquantenbit (CQUBn) das Kernquantenbit (CQUB) der besagten Elektron-Kern-Austausch-Operation dar. Somit ist nun auch die Anbindung des Weiteren Kernquantenpunkts an den Quantenbus möglich. Wir nehmen nun an, dass eine Kette von n Quantenpunkten den ersten Quantenpunkt (NV1) und damit das erste Quantenbit (QUB1) mit dem n-ten Quantenpunkt (NVn) und damit mit dem n-ten Quantenbit (QUBn) verbindet. Der Quantenbus kann darüber hinaus weitere Quantenbits und weitere Kernquantenbits umfassen, die hier beispielhaft nicht weiter betrachtet werden.

Bevor der beispielhafte erste Kernquantenpunkt (CI1) des ersten Kernquantenbits (CQUB1) mit dem beispielhaften n-ten Kernquantenpunkt (Cln) des n-ten Kernquantenbits (CQUBn) verschränkt werden kann, werden die Quantenpunkte der Kette der Quantenpunkte des Quantenbusses (QUBUS) zwischen diesen beiden Kernquantenpunkten und ggf. weitere Quantenpunkte bevorzugt zurückgesetzt. Das Verfahren zum Verschränken des ersten Kernquantenbits (CQUB1) mit dem n-ten Kernquantenbit (CQUBn) eines Quantenbusses (QUBUS) umfasst daher ggf. das vorausgehende Löschen der n Quantenbits (QUB1 bis QUBn) des Quantenbusses (QUBUS), insbesondere mittels eines Quantenbit-Rücksetzverfahrens, zur Initialisierung des Quantenbusses (QUBUS). Anschließend erfolgt das Verschränken des ersten Quantenpunkts (NV1) des ersten Quantenbits (QUB1) mit dem ersten Kernquantenpunkt (CI1) des ersten Kernquantenbits (CQUB1) des Quantenbusses (QUBUS), insbesondere durch Anwendung des zuvor beschriebenen Verfahrens zum Verschränken des ersten Quantenpunkts (NV1) des ersten Quantenbits (QUB1) mit dem ersten Kernquantenpunkt (CI1) des ersten Kernquantenbits (CQUB1) eines Quantenbusses (QUBUS). Durch diese Operation wird die Änderungsinformation auf das erste Quantenbit (QUB1) des Quantenbusses (QUBUS) gelegt. Die Änderungsinformation kann nun vom erste Quantenbit (QUB1) des Quantenbusses (QUBUS) zum anderen Ende des Quantenbusses (QUBUS) transportiert werden. Dies geschieht durch anschließendes wiederholtes Ausführen des folgenden Schrittes bis alle n-1 Quantenpunkte (NV2 bis NVn) mit ihrem Vorgängerquantenpunkt (NV1 bis NV(n-1)) und damit mit dem ersten Kernquantenpunkt (CI1) des ersten Kernquantenbits (CQUB1) verschränkt sind.

Hierzu wird beginnend mit dem ersten Quantenpunkt (QUB1) des Quantenbusses (QUBUS) für alle nachfolgenden Quantenbits (QUBj) der folgende Schritt ausgeführt, wobei mit jeder Schrittausführung der Index j um 1 erhöht wird, bis j=n erreicht ist. Dieser folgende Schritt beinhaltet das Verschränken des j-ten Quantenpunkts (NVj) eines j-ten Quantenbits (QUBj) mit dem (j+1)-ten Quantenpunkt (NV(j+1)) des nachfolgenden (j+1)-ten Quantenbits (QUB(j+1)) des Quantenbusses (QUBUS). Bei der ersten Anwendung dieses Schrittes wird logischer Weise j=1 gewählt, um den ersten Quantenpunkt (NV1) mit dem zweiten Quantenpunkt (NV2) zu verschränken. Bei den folgenden Anwendungen dieses Schrittes bis zum Erreichen der zuvor benannten Schleifenabbruchbedingung von j=n wird nach der Durchführung des Schrittes der neue Index j um eine erhöht mit j=j+1 gewählt und der j-te Quantenpunkt (NVj) mit dem (j+1)-ten Quantenpunkt (NV(j+1)) verschränkt. Bei dem Verfahren, das in jedem dieser Schritte angewendet wird, handelt es sich bevorzugt um das oben beschriebene Verfahren zum Austausch, insbesondere Spin-Austausch, der Quanteninformation, insbesondere der Spin-Information, des j-ten Quantenpunkts (NVj) eines j-ten Quantenbits (QUBj) mit der Quanteninformation, insbesondere der Spin-Information, des (j+1)-ten Quantenpunkts (NV(j+1)) des nachfolgenden (j+1)-ten Quantenbits (QUB(j+1)) eines Quantenbusses (QUBUS). Anschließend erfolgt ein erneutes wiederholtes Ausführen des Schrittes bis alle n-1 Quantenpunkte (NV2 bis NVn) mit ihrem Vorgängerquantenpunkt (NV1 bis NV(n-1)) und damit mit der Quanteninformation des ersten Kernquantenpunkts (CI1) des ersten Kernquantenbits (CQUB1) verschränkt sind.

Auf diese Weise wird die Änderungsinformation nun von dem ersten Quantenpunkt (NV1) des ersten Quantenbits (QUB1) über die anderen Quantenpunkte (NV2 bis NV(n-1)) des Quantenbusses (QUBUS) bis zum n-ten Quantenpunkt (NVn) des n-ten Quantenbits (QUBn) des Quantenbusses (QUBn) transportiert. Nun verbleibt die Aufgabe eine abschließende Verschränkung der Quanteninformation des n-ten Quantenpunkts (NVn) des n-ten Quantenbits (QUBn) mit der Quanteninformation des n-ten Kernquantenpunkts (Cln) des n-ten Kernquantenbits (CQUBn) vorzunehmen, um den Transport der Änderungsinformation abzuschließen.

Es folgt daher das zeitlich anschließende Verschränken des n-ten Quantenpunkts (NVn) des n-ten Quantenbits (QUBn) mit dem n-ten Kernquantenpunkt (Cln) des n-ten Kernquantenbits (CQUBn) des Quantenbusses (QUBUS), insbesondere durch Anwendung eines Verfahren zum Verschränken des n-ten Quantenpunkts (NVn) des n-ten Quantenbits (QUBn) mit dem n-ten Kernquantenpunkt (Cln) des n-ten Kernquantenbits (CQUBn) eines Quantenbusses (QUBUS).

Es ist nun sinnvoll, die Verschränkung ggf. noch einmal in die andere Richtung zu transportieren. Hierzu wird ggf. der folgende Schritt der Verschränkung der Quanteninformation, insbesondere des Spin-Austauschs, des j-ten Quantenpunkts (NVj) eines j-ten Quantenbits (QUBj) mit dem (j+1)-ten Quantenpunkt (NV(j+1)) des nachfolgenden (j+1)-ten Quantenbits (QUB(j+1)) des Quantenbusses (QUBUS) mehrfach ausgeführt. Bei der ersten Anwendung dieses Schrittes wird nun, da es zurückgehen soll, j=n gewählt. Bei den folgenden Anwendungen dieses Schrittes wird mit jedem Schritt im Vergleich zum vorhergehenden Schritt bis zum Erreichen der zuvor benannten Schleifenabbruchbedingung von j=1 der neue Index mit j=j-1 gewählt. Nachdem dann die Änderungsinformation vom n-ten Quantenbit (QUBn) zum ersten Quantenbit (QUB1) zurücktransportiert wurde, wird der erste Quantenpunkt (NV1) des ersten Quantenbits (QUB1) nun mit dem ersten Kernquantenpunkt (CI1) des ersten Kernquantenbits (CQUB1) verschränkt. Es erfolgt eine Verschränkung der Quanteninformation, insbesondere ein Spin-Austausch, des ersten Quantenpunkts (NV1) des ersten Quantenbits (QUB1) mit der Quanteninformation des ersten Kernquantenpunkt (CI1) des ersten Kernquantenbits (CQUB1) des Quantenbusses (QUBUS).

Ggf. erfolgt ein abschließendes Löschen der n Quantenbits (QUB1 bis QUBn) des Quantenbusses (QUBUS).

Nun sei hier ein weiteres Verfahren zum Verschränken des ersten Kernquantenbits (CQUB1) mit dem n-ten Kernquantenbit (CQUBn) eines Quantenbusses (QUBUS) angegeben. Bei diesem weiteren Verfahren erfolgt zuerst ggf. ein vorausgehendes Löschen der n Quantenbits (QUB1 bis QUBn) des Quantenbusses (QUBUS) zur Initialisierung des Quantenbusses (QUBUS). Ggf. erfolgt auch zuvor ein vorausgehendes Löschen des ersten Kernquantenbits (CQUB1) und/oder ein vorausgehendes Löschen des n-ten Kernquantenbits (CQUBn). Sofern dieser Löschvorgang Quantenbits der n Quantenbits des Quantenbusses modifiziert haben sollte ist es ggf. sinnvoll nochmals ein vorausgehendes nochmaliges Löschen des ersten Quantenbits (QUB1) und des n-ten Quantenbits bis QUBn) des Quantenbusses (QUBUS) zur Initialisierung des Quantenbusses (QUBUS) durchzuführen.

Es erfolgt dann bevorzugt das Durchführen eines Hadamard-Gates mit dem ersten Quantenbit (QUB1) als Quantenbit (QUB) des besagten Hadamard-Gates und das Durchführen einer Elektron-Kern- CNOT-Operation mit dem mit dem ersten Quantenbit (QUB1) und dem ersten Kernquantenbit (CQUB1). Nun wird die Änderungsinformation, die mit dem letzten Schritt auf den Quantenbus (QUBUS) gelegt wurde, über den Quantenbus (QUBUS) transportiert. Hierzu erfolgt ein wiederholtes Ausführen des folgenden Schrittes bis alle n-1 Quantenpunkte (NV2 bis NVn) mit ihrem Vorgängerquantenpunkt (NV1 bis NV(n-1)) verschränkt sind. Dieser folgende Schritt ist dabei das Verschränken des j-ten Quantenpunkts (NVj) eines j-ten Quantenbits (QUBj) mit dem (j+1)-ten Quantenpunkt (NV(j+1)) des nachfolgenden (j+1)-ten Quantenbits (QUB(j+1)) des Quantenbusses (QUBUS), insbesondere mittels eines Elektron-Elektron-CNOTs, wie zuvor beschrieben. Bei der ersten Anwendung dieses Schrittes wird wieder j=1 gewählt. Bei den folgenden Anwendungen dieses Schrittes bis zum Erreichen der zuvor benannten Schleifenabbruchbedingung von j=n wird in jedem neuen Schritt der neue Index dann wieder mit j=j+1 gewählt. Hierdurch werden dann alle n Quantenpunkte (NV1 bis NVn) des Quantenbusses (QUBUS) miteinander verschränkt.

Um nun auch den n-ten Kernquantenpunkt (Cln) mit den n Quantenpunkten (QUB1 bis QUBn) des Quantenbusses (QUBUS) zu verschränken, erfolgt dann die Durchführung einer Elektron-Kern- CNOT-Operation mit dem mit dem n-ten Quantenbit (QUBn) und dem n-ten Kernquantenbit (CQUBn). Als Ergebnis sind dann der erste Kernquantenpunkt (NV1) des ersten Kernquantenbits (CQUB1) mit dem n-ten Kernquantenpunkt (NVn) des n-ten Kernquantenbits (CQUBn) verschränkt. Ggf. sollten Quantenpunkte (NV1 bis NVn) der Quantenbits (QUB1 bis QUBn) des Quantenbusses (QUBUS) dann wieder mittels "grünem Licht" zurückgesetzt werden.

### Quantencomputer

Ein Quantencomputer, der in der Lage ist, die oben beschriebenen Verfahren auszuführen, zeichnet sich dadurch aus, dass er typischerweise zumindest eine Steuervorrichtung (µC) und typischerweise zumindest eine Lichtquelle (LED) umfasst. Die Lichtquelle, die bevorzugt zur Erzeugung des "grünen Lichts" zum Zurücksetzen der Quantenpunkte (NV1 bis NVn) der Quantenbits (QUB1 bis QUBn) des Quantenbusses (QUBUS) dient, kann insbesondere eine LED und/oder ein Laser und/oder ein durchstimmbarer Laser sein. Um die zumindest eine Lichtquelle betreiben zu können, umfasst der Quantencomputer bevorzugt zumindest einen Lichtquellentreiber (LEDDR). Ein Quantencomputer, wie er hier vorgeschlagen wird umfasst bevorzugt zumindest eine der folgenden quantenbasierenden Teilvorrichtungen wie ein oder bevorzugt mehrere Quantenbit (QUB) und/oder ein oder bevorzugt mehrere Quantenregister (QUREG) und/oder ein oder bevorzugt mehrere Kern-Elektron-Quantenregister (CEQUREG), und/oder ein oder mehrere Kern-Elektron- Kern-Elektron-Quantenregister (CECEQUREG) und/oder eine oder mehrere Anordnung von Quantenpunkten (NV) und/oder einen oder mehrere Quantenbusse (QUBUS).

Die zumindest eine Lichtquelle (LED) wird bevorzugt von dem zumindest einen Lichtquellentreiber (LEDDR) zeitweise in Abhängigkeit von einem Steuersignal der Steuervorrichtung (µC) mit elektrischer Energie versorgt.

Die mindestens eine Lichtquelle (LED) ist bevorzugt dazu geeignet und/oder bestimmt, mindestens einen Teil der Quantenpunkte (NV) zurückzusetzen. Bevorzugt zeigt es sich darin, dass die Lichtquelle (LED) dazu geeignet und/oder bestimmt ist, einen oder mehrere Quantenpunkte mit "grünem Licht" zu bestrahlen.

Bevorzugt zeichnet sich der Quantencomputer (QC) dadurch aus, dass er zumindest einen Schaltkreis und/oder Halbleiterschaltkreis und/oder CMOS-Schaltkreis insbesondere zur Ansteuerung der Quantenbits und/oder Kernquantenbits und/oder Quantenregister und/oder Elektron-Kern-Quantenregister umfasst. Bevorzugt umfasst ein solcher Quantencomputer zumindest eine der folgenden quantenbasierenden Teilvorrichtungen wie ein oder mehrere Quantenbits (QUB) und/oder ein oder mehrere Quantenregister (QUREG) und/oder ein oder mehrere Kern-Elektron-Quantenregister (CEQUREG) und/oder ein oder mehrere Kern-Elektron- Kern-Elektron-Quantenregister (CECEQUREG) und/oder eine oder mehrere Anordnungen von Quantenpunkten (NV) und/oder einen oder mehrere Quantenbusse (QUBUS). Bevorzugt weist dabei der mindestens eine Schaltkreis und/oder Halbleiterschaltkreis und/oder CMOS-Schaltkreis Mittel auf, die einzeln oder zu mehreren in Gemeinschaft dazu eingerichtet und geeignet sind, zumindest eines der zuvor beschriebenen Verfahren, insbesondere der Verfahrensgruppen Elektron-Kern-Austausch-Operation und/oder Quantenbit-Rücksetzverfahren und/oder Kern-Elektron-Quantenregister-Rücksetzverfahren und/oder Quantenbit-Mikrowellenansteuerverfahren und/oder Kern-Elektron-Quantenregister-Radiowellenansteuerverfahren und/oder Kernquantenbit-Radiowellenansteuerverfahren und/oder Kern-Kern-Quantenregister-Radiowellenansteuerverfahren und/oder selektives Quantenbit-Ansteuerverfahren und/oder selektives Quantenregisteransteuerverfahren und/oder Quantenbit-Bewertung und/oder Quantencomputerergebnisextraktion und/oder Quantum-Computing durchzuführen und/oder einen Quantenbusbetrieb, wie zuvor beschrieben, auszuführen.

Bevorzugt weist der Quantencomputer eine oder mehrere Vorrichtungen einer Magnetfeldkontrolle (MFC) mit mindestens einem oder mehreren Magnetfeldsensoren (MFS) und mindesten einem oder mehreren Stellgliedern, insbesondere einer Magnetfeldkontrolle (MFK), auf, um das Magnetfeld im Bereich der Vorrichtung durch aktive Regelung zu stabilisieren. Bevorzugt ist dabei insbesondere die Magnetfeldkontrolle (MFC) ein Teil der Steuervorrichtung. Ebenso bevorzugt kann die Magnetfeldkontrolle (MFC) von der Steuervorrichtung bzw. einen Steuerrechner (µC) gesteuert werden.

### Integrierte Schaltung für einen Quantencomputer

Der für den Quantencomputer bevorzugt verwendete Schaltkreis und/oder Halbleiterschaltkreis und/oder CMOS-Schaltkreis umfasst bevorzugt zumindest eine Steuervorrichtung (µC). Bevorzugt weist er Mittel, die zur Ansteuerung zumindest einer der folgenden quantenbasierenden Teilvorrichtungen mit einem ersten anzusteuernden Quantenbit (QUB1) geeignet und/oder vorgesehen sind, auf. Diese sind beispielhaft ein oder mehrere Quantenbits (QUB) und/oder ein oder mehrere Quantenregister (QUREG) und/oder ein oder mehrere Kern-Elektron-Quantenregister (CEQUREG) und/oder ein oder mehrere Kern-Elektron-Kern-Elektron-Quantenregister (CECEQUREG) und/oder ein oder mehrere Anordnungen von Quantenpunkten (NV) und/oder einen Quantenbus (QUBUS) und/oder ein oder mehrere QuantenALUs (QUALU).,

Bevorzugt umfasst er zur Ansteuerung eines beispielhaften ersten anzusteuernden Quantenbits (QUB1)
- eine dem beispielhaften ersten anzusteuernden Quantenbit (QUB1) zugeordnete, erste horizontale Treiberstufe (HD1) zur Ansteuerung des ersten anzusteuernden Quantenbits (QUB1) und/oder
- eine dem beispielhaften ersten anzusteuernden Quantenbit (QUB1) zugeordnete, erste horizontale Empfängerstufe (HS1), die mit der ersten horizontalen Treiberstufe (HD1) eine Einheit bilden kann, zur Ansteuerung des ersten anzusteuernden Quantenbits (QUB1) und/oder
- eine dem beispielhaften ersten anzusteuernden Quantenbit (QUB1) zugeordnete, erste vertikale Treiberstufe (VD1) zur Ansteuerung des ersten anzusteuernden Quantenbits (QUB1) und/oder
- eine dem beispielhaften ersten anzusteuernden Quantenbit (QUB1) zugeordnete, erste vertikale Empfängerstufe (VS1), die mit der ersten vertikalen Treiberstufe (VD1) eine Einheit bilden kann.

Hierbei steht das erste Quantenbit (QUB1) repräsentativ für ein beliebiges Quantenbit des Quantencomputers bzw. der Quantentechnologischen Vorrichtung. Die Ansprüche sind daher für ein beliebiges Quantenbit des Quantencomputers bzw. der Quantentechnologischen Vorrichtung auszulegen. Die Bezeichnung "erstes Quantenbit (QUB1)" ist hier also nur eine Bezeichnung für ein beliebiges Quantenbit der Vorrichtung. Der Begriff "erstes" soll nur die Unterscheidung zu weiteren Quantenbits ermöglichen. Gleiches gilt in analoger Weise für die erste Treiberstufe (HD1), die erste horizontale Empfängerstufe (HS1), die erste vertikale Treiberstufe (VD1) und die erste vertikale Empfängerstufe (VS1).

Die erste horizontale Treiberstufe (HD1) und die erste horizontale Empfängerstufe (HS1) steuern bevorzugt das beispielhafte erste anzusteuernde Quantenbit (QUB1) über die erste horizontale Leitung (LH1) des ersten Quantenbits (QUB1) an.

Die erste vertikale Treiberstufe (VD1) und die erste vertikale Empfängerstufe (VS1) steuern bevorzugt das beispielhafte erste anzusteuernde Quantenbit (QUB1) über die erste vertikale Leitung (LV1) des ersten Quantenbits (QUB1) an.

Bevorzugt speist die erste horizontale Treiberstufe (HD1) den ersten horizontalen Strom (IH1) in die erste horizontale Leitung (LH1) des ersten Quantenbits (QUB1) ein.

Bevorzugt speist die erste vertikale Treiberstufe (VD1) den ersten vertikalen Strom (IV1) in die erste vertikale Leitung (LV1) des ersten Quantenbits (QUB1) ein.

Der erste horizontale Strom (IH1) weist dabei bevorzugt eine erste horizontale Stromkomponente mit einer ersten horizontalen Modulation mit einer ersten Frequenz (f) auf.

Bevorzugt weist der erste vertikale Strom (IV1) eine erste vertikale Stromkomponente mit einer ersten vertikalen Modulation mit der ersten Frequenz (f) auf.

Bevorzugt ist die erste vertikale Modulation der ersten vertikalen Stromkomponente des ersten vertikalen Stromes (IV1) gegenüber der ersten horizontalen Modulation der ersten horizontalen Stromkomponente des ersten horizontalen Stromes (IH1) um einen ersten zeitlichen Phasenversatz von im Wesentlichen +/-π/2 der Frequenz (f) zumindest zeitweise zeitlich phasenverschoben.

Bevorzugt sind die erste horizontale Stromkomponente des ersten horizontalen Stroms (IH1) mit einem ersten horizontalen Strompuls mit einer ersten Pulsdauer (τ_{P1}) und/oder die erste vertikale Stromkomponente des ersten vertikalen Stroms (IV1) mit einem ersten vertikalen Strompuls mit der ersten Pulsdauer (τ_{P1}) gepulst.

Bevorzugt sind der erste vertikale Strompuls um den zeitlichen ersten Phasenversatz gegenüber dem ersten horizontalen Strompuls zeitlich phasenversetzt und/oder der erste vertikale Strompuls um den zeitlichen ersten Phasenversatz von +/- π/2 der Frequenz (f) gegenüber dem ersten horizontalen Strompuls zeitlich phasenversetzt.

Bevorzugt ist dabei die erste Frequenz (f) wirkungsgleich zu einer der folgenden Frequenzen:
- einer Kern-Elektron- Mikrowellenresonanzfrequenz (F_{MWCE}) oder
- einer Elektron-Kern-Radiowellenresonanzfrequenz (f_{RWEC}) oder
- einer Elektron1-Elektron1-Mikrowellenresonanzfrequenz (f_{MW}) oder
- einer Elektron1-Elektron2-Mikrowellenresonanzfrequenz (f_{MWEE}) oder
- einer Kern-Kern-Radiowellenresonanzfrequenz (f_{RWCC}).

Bevorzugt entspricht die erste Pulsdauer τ_{P} zumindest zeitweise einem ganzzahligen Vielfachen von π/4 der Periodendauer τ_{RCE} der Rabi-Oszillation der Kern-Elektron Rabi-Oszillation, wenn die erste Frequenz (f) wirkungsgleich zu einer Kern-Elektron- Mikrowellenresonanzfrequenz (F_{MWCE}) ist, und/oder die erste Pulsdauer τ_{P} entspricht zumindest zeitweise einem ganzzahligen Vielfachen von π/4 der Periodendauer τ_{REC} der Rabi-Oszillation der Elektron-Kern-Rabi-Oszillation, wenn die erste Frequenz (f) wirkungsgleich zu einer Elektron-Kern-Radiowellenresonanzfrequenz (f_{RWEC}) ist. Auch kann die erste Pulsdauer τ_{P} zumindest zeitweise einem ganzzahligen Vielfachen von π/4 der Periodendauer τ_{R} der Rabi-Oszillation der Elektron1-Elektron1-Rabi-Oszillation entsprechen, wenn die erste Frequenz (f) wirkungsgleich zu einer Elektron1-Elektron1-Mikrowellenresonanzfrequenz (f_{MW}) ist und/oder zumindest zeitweise einem ganzzahligen Vielfachen der von π/4 der Periodendauer τ_{REE} der Rabi-Oszillation der Elektron1-Elektron2-Rabi-Oszillation entsprechen, wenn die erste Frequenz (f) wirkungsgleich zu einer Elektron1-Elektron2-Mikrowellenresonanzfrequenz (f_{MWEE}) ist. Ebenso kann die erste Pulsdauer τ_{P} zumindest zeitweise einem ganzzahligen Vielfachen von π/4 der Periodendauer τ_{RCC} der Rabi-Oszillation der Kern-Kern-Rabi-Oszillation entsprechen, wenn die erste Frequenz (f) wirkungsgleich zu einer Kern-Kern-Radiowellenresonanzfrequenz (f_{RWCC}) ist.

Bevorzugt weist der Schaltkreis und/oder Halbleiterschaltkreis und/oder CMOS-Schaltkreis eine zweite horizontale Treiberstufe (HD2) zur Ansteuerung eines zweien anzusteuernden Quantenbits (QUB2) und sie eine zweite horizontale Empfängerstufe (HS2) auf, die mit der zweiten horizontalen Treiberstufe (HD2) eine Einheit bilden kann. Diese dienen bevorzugt der Ansteuerung des zweiten anzusteuernden Quantenbits (QUB2).

Der besagte Schaltkreis und/oder Halbleiterschaltkreis und/oder CMOS-Schaltkreis umfasst des Weiteren bevorzugt eine zweite vertikale Treiberstufe (VD2) zur Ansteuerung eines zweiten anzusteuernden Quantenbits (QUB2) und eine zweite vertikale Empfängerstufe (VS2), die mit der zweiten vertikalen Treiberstufe (VD2) eine Einheit bilden kann. Diese dienen ebenfalls bevorzugt zur Ansteuerung des zweiten anzusteuernden Quantenbits (QUB2).

Die erste vertikale Treiberstufe (VD1) wird bevorzugt zur Ansteuerung des zweiten anzusteuernden Quantenbits (QUB2) verwendet. Die erste vertikale Empfängerstufe (VS1) wird bevorzugt zur Ansteuerung des zweiten anzusteuernden Quantenbits (QUB2) verwendet.

Hierbei steht das zweite Quantenbit (QUB1) repräsentativ für ein beliebiges Quantenbit des Quantencomputers bzw. der Quantentechnologischen Vorrichtung, das vom zuvor genannten beispielhaften ersten Quantenbit (QUB1) verschieden ist. Die Ansprüche sind daher für ein beliebiges Quantenbit des Quantencomputers bzw. der quantentechnologischen Vorrichtung, das vom zuvor genannten beispielhaften ersten Quantenbit (QUB1) verschieden ist, auszulegen. Die Bezeichnung "zweites Quantenbit (QUB2)" ist hier also nur eine Bezeichnung für ein beliebiges Quantenbit der Vorrichtung, das vom zuvor genannten beispielhaften ersten Quantenbit (QUB1) verschieden ist. Der Begriff "zweites" soll nur die Unterscheidung zu weiteren Quantenbits und von dem besagten ersten Quantenbit (QUB1) ermöglichen. Gleiches gilt in analoger Weise für die zweite Treiberstufe (HD2), die zweite horizontale Empfängerstufe (HS2), die zweite vertikale Treiberstufe (VD2) und die zweite vertikale Empfängerstufe (VS2).

Bevorzugt werden die erste horizontale Treiberstufe (HD1) und die erste horizontale Empfängerstufe (HS1) zur Ansteuerung des zweiten anzusteuernden Quantenbits (QUB2) mitverwendet. (siehe Figuren)

Bevorzugt speist die erste horizontale Treiberstufe (HD1) einen ersten horizontalen Gleichstromanteil als weiteren horizontalen Stromanteil in die erste horizontale Leitung (LH1) ein. Der Betrag des ersten horizontalen Gleichstromanteils kann dabei 0A sein. Die zweite horizontale Treiberstufe (HD2) speist bevorzugt einen zweiten horizontalen Gleichstromanteil als weiteren horizontalen Stromanteil in die zweite horizontale Leitung (LH2) ein, wobei der Betrag des zweiten horizontalen Gleichstromanteils 0A sein kann. Die erste vertikale Treiberstufe (VD1) speist bevorzugt einen ersten vertikalen Gleichstromanteil als weiteren vertikalen Stromanteil in die erste vertikale Leitung (LV1) ein. Der Betrag des ersten vertikalen Gleichstromanteils kann 0A sein. Die zweite vertikale Treiberstufe (HD2) speist einen zweiten vertikalen Gleichstromanteil als weiteren vertikalen Stromanteil in die zweite vertikale Leitung (LV2) ein. Dabei kann der Betrag des zweiten vertikalen Gleichstromanteils 0A sein.

Der erste horizontale Gleichstromanteil und/oder der zweite horizontale Gleichstromanteil und/oder der erste vertikale Gleichstromanteil und/oder der zweite vertikale Gleichstromanteil können so eingestellt werden, dass die erste Kern-Elektron- Mikrowellenresonanzfrequenz (f_{MWCE1}) eines ersten Kern-Elektron-Quantenregisters (CEQUREG1) eines Kern-Elektro-Kern-Elektron-Quantenregisters (CECEQUREG) von der zweiten Kern-Elektron- Mikrowellenresonanzfrequenz (f_{MWCE2}) eines zweiten Kern-Elektron-Quantenregisters (CEQUREG2) des Kern-Elektro-Kern-Elektron-Quantenregisters (CECEQUREG) abweicht oder dass die erste Elektron-Kern-Radiowellenresonanzfrequenz (f_{RWEC1}) eines ersten Kern-Elektron-Quantenregisters (CEQUREG1) eines Kern-Elektro-Kern-Elektron-Quantenregisters (CECEQUREG) von der zweiten Elektron-Kern-Radiowellenresonanzfrequenz (f_{RWEC2}) eines zweiten Kern-Elektron-Quantenregisters (CEQUREG2) des Kern-Elektro-Kern-Elektron-Quantenregisters (CECEQUREG) abweicht oder dass die erste Elektron1-Elektron1-Mikrowellenresonanzfrequenz (f_{MW1}) eines ersten Quantenbits (QUB1) eines Quantenregisters (QUREG) von der zweiten Elektron1-Elektron1-Mikrowellenresonanzfrequenz (f_{MW2}) eines zweiten Quantenbits (QUB2) des Quantenregisters (QUREG) abweicht. Hierdurch wird eine selektive Ansteuerung möglich.

### Herstellungsverfahren

Im Folgenden wird nun ein Verfahren zum Herstellen eines Quantenregisters (QUREG) und/oder eines Quantenbits (QUB) und/oder einer Anordnung von Quantenpunkten und/oder einer Anordnung von Quantenbits vorgeschlagen.

Das Verfahren umfasst das Bereitstellen eines Substrats (D), insbesondere eines Diamanten. Es umfasst das typischerweise darauffolgende Aufbringen einer epitaktischen Schicht (DEPI), um die Perfektion des Kristallgitters sicherzustellen.

Bevorzugt wird dabei eine n-dotierte Schicht bevorzugt mittels CVD Methoden abgeschieden.

Im beispielhaften Falle von Diamant als epitaktische Schicht (DEPI) auf einem Diamant-Substrat (D) handelt es sich bevorzugt um eine n-dotierte Diamantschicht bevorzugt aus ¹²C-Kohlenstoff und/oder weniger gut, da radioaktiv ¹⁴C-Kohlenstoff. Im Falle einer epitaktischen Diamant-Schicht (DEPI) ist diese bevorzugt bereits mit einer Schwefeldotierung und/oder einer anderen n-Dotierung versehen. Hierbei können aber auch Stickstoffatome zur n-Dotierung der epitaktischen Diamant-Schicht (DEPI) beispielsweise in Form von P1-Zentren verwendet werden. Bevorzugt erfolgt die Dotierung der epitaktischen Diamant-Schicht (DEPI) jedoch mit ³²S- und/oder ³²S-Isotopen.

Im beispielhaften Falle von Silizium als epitaktische Schicht (DEPI) auf einem Silizium-Substrat (D) handelt es sich bevorzugt um eine n-dotierte Silizium-Schicht, die bevorzugt aus ²⁸Si-Isotopen gefertigt ist und/oder aus Silizium-Isotopen ohne magnetisches Moment gefertigt ist. Im Falle einer epitaktischen Silizium-Schicht ist diese bevorzugt bereits mit einer Dotierung mit einem oder mehreren der Isotope ¹²⁰Te, ¹²²Te, ¹²⁴Te, ¹²⁶Te, ¹²⁸Te, ¹³⁰Te, ⁴⁶Ti, ⁴⁸Ti, ⁵⁰Ti, ¹²C, ¹⁴C, ⁷⁴Se, ⁷⁶Se, ⁷⁸Se, ⁸⁰Se, ¹³⁰Ba, ¹³²Ba, ¹³⁴Ba, ¹³⁶Ba, ¹³⁸Ba, ³²S, ³⁴S, oder ³⁶S und/oder anderen Isotopen ohne magnetischen Kernmoment mit einer n-Dotierung versehen. Hierbei können auch die Kohlenstoffatome in Form von ¹²C- oder ¹⁴C-Isotopen zur n-Dotierung der epitaktischen Diamant-Schicht (DEPI) beispielsweise in Form von G-Zentren verwendet werden.

Die epitaktischen Schicht (DEPI) kann ein größeres Volumen als das Substrat (D) haben. Bei dem Substrat (D) kann es sich auch nur um einen Kristallisationskeim handeln.

Sofern im Falle von Diamant als Substrat (D) das Substrat (D) bzw. die epitaktische Schicht (DEPI) nicht oder in nicht ausreichendem Maße n- oder Schwefel-dotiert sind, erfolgt ggf. bevorzugt noch eine Schwefelimplantation und/oder n-Dotierung zumindest von Teilen des Substrats (D) bzw. zumindest von Teilen der epitaktischen Schicht (DEPI). Des Weiteren erfolgen bevorzugt noch eine bevorzugt anschließende Reinigung und ein Ausheilen der Strahlenschäden.

Zur Herstellung der Quantenpunkte im Substrat (D) erfolgt bevorzugt eine deterministische Einzelionenimplantation zur Herstellung von paramagnetischen Zentren als Quantenpunkte (NV) in vorbestimmten Bereichen des Substrats (D) bzw. der epitaktischen Schicht (DEPI).

Im Falle eines Diamanten als Substrat (D) kann beispielsweise eine Einzelionenimplantation einzelner Stickstoffatome zur Herstellung paramagnetischer Zentren als Quantenpunkte (NV) in vorbestimmten Bereichen des Substrats (D) bzw. der epitaktischen Schicht (DEPI) durchgeführt werden. Dies dient im Falle eines Diamanten als Substrat (D) beispielsweise bevorzugt der Herstellung von NV-Zentren als Quantenpunkten (NV) in vorbestimmten Bereichen des als Substrat (D) dienenden Diamanten bzw. dessen ggf. zuvor aufgebrachter epitaktischen Schicht (DEPI).

Im Falle von Silizium als Substrat (D) kann beispielsweise eine Einzelionenimplantation einzelner Kohlenstoffatome, insbesondere beispielsweise einzelner ¹²C-Isotope, zur Herstellung paramagnetischer Zentren als Quantenpunkte (NV) in vorbestimmten Bereichen des Substrats (D) bzw. der epitaktischen Schicht (DEPI) durchgeführt werden. Dies dient im Falle von Silizium als Substrat (D) beispielsweise bevorzugt der Herstellung von G-Zentren als Quantenpunkten (NV) in vorbestimmten Bereichen des als Substrat (D) dienenden Siliziumkristalls bzw. dessen ggf. zuvor aufgebrachter epitaktischen Schicht (DEPI).

Bevorzugt erfolgen auch hier ggf. wieder eine Reinigung und eine Temperaturbehandlung.

Bevorzugt erfolgt anschließend eine Vermessung der Funktion, Position und der T2-Zeiten der implantierten Einzelatome und ggf. eine Wiederholung der beiden vorausgehenden Schritte, falls die Messung einen Fehlschlag der Herstellung der Quantenpunkte ergibt.

Im Falle von NV-Zentren in Diamant kann deren Position durch Bestrahlung mit "grünem Licht" und Erfassung der Fluoreszenzposition erfasst werden.

Um das elektrische Auslesen der Quantenpunkte zu ermöglichen, erfolgt bevorzugt ein Herstellen von ohmschen Kontakten zum Substrat (D) bzw. zur epitaktischen Schicht (DEPI).

Werden im Falle von Silizium diese Kontakte ausreichend zu den Quantenpunkten (NV) bzw. Kernquantenpunkten (CI) beabstandet, so können die Kontakte durch Kontaktdotierungen mit konventionellen Dotierstoffen der III. Hauptgruppe wie B, Ga etc. bzw. V.-Hauptgruppe wie P und As hergestellt werden, obwohl diese über ein magnetisches Kernmoment µ verfügen. Hierbei ist es wichtig, dass der Abstand der Kontaktdiffusionen incl. deren Ausdiffusionen zu den Quantenpunkten (NV) und/oder Kernquantenpunkten (CI) größer ist als die maximale Elektron-Elektron-Kopplungsreichweiter zwischen zwei Quantenpunkten (NV1, NV2) und größer ist als die maximale Elektron-Kern-Kopplungsreichweite zwischen einem Quantenpunkt (NV) und einem Kernquantenpunkt (CI). Es hat sich gezeigt, dass hier ein Abstand im µm-Bereich funktioniert. Der Nachteil bei solch großen Abständen der Kontakte von den Quantenpunkten und/oder Kernquantenpunkten (CI) ist jedoch, dass die Fotoladungsträger nicht mehr Quantenpunktspezifisch bzw. Kernquantenpunktspezifisch abgesaugt werden können. Daher wird empfohlen, trotz der schlechteren Aktivierungsenergie eine Dotierung mit Isotopen ohne magnetisches Kernmoment µ, wie sie oben aufgeführt sind, durchzuführen.

Der horizontalen Leitungen (LH1, LH2, LH3) und ggf. die horizontalen Abschirmleitungen (SH1, SH2, SH3, SH4) werden mittels lithografischer Schritte hergestellt. Bevorzugt werden die horizontalen Leitungen (LH1, LH2, LH3) und ggf. die horizontalen Abschirmleitungen (SH1, SH2, SH3, SH4) aus einem Material, dass im Wesentlichen aus Isotopen ohne magnetisches Kernmoment besteht, hergestellt. Besonders bevorzugt sind hierbei das Titan-Isotop ⁴⁶Ti und/oder das Titan-Isotop ⁴⁸Ti und/oder das Titan-Isotop ⁵⁰Ti zur Herstellung von entsprechenden Titan-Leitungen.

Für die Herstellung eines mehrlagigen Metallisierungsstapels erfolgen ein oder mehrmals das Abscheiden einer Isolation (IS) und jeweils, sofern notwendig, das Öffnen von Durchkontaktierungen.

Bevorzugt wird die Isolation (IS) ganz oder in Teilen aus Isotopen ohne magnetisches Kernmoment µ hergestellt. Besonders bevorzugt ist eine Abscheidung oder ein Aufsputtern oder ein Wachstum von ²⁸Si¹⁶O₂ als Isolationsoxid.

Die vertikalen Leitungen (LV1, LV2, LV3) und ggf. die vertikalen Abschirmleitungen (SV1, SV2, SV3, SV4) werden mittels lithografischer Schritte hergestellt. Bevorzugt werden die vertikalen Leitungen (LV1, LV2, LV3) und ggf. die vertikalen Abschirmleitungen (SV1, SV2, SV3, SV4) aus einem Material, dass im Wesentlichen aus Isotopen ohne magnetisches Kernmoment besteht, hergestellt. Besonders bevorzugt sind hierbei das Titan-Isotop ⁴⁶Ti und/oder das Titan-Isotop ⁴⁸Ti und/oder das Titan-Isotop ⁵⁰Ti zur Herstellung von entsprechenden Titan-Leitungen.

Neben diesem Basisverfahren zur Herstellung von Quantenpunkten, Quantenbits (QUB), Quantenregistern (QUREG) wird nun auch ein Verfahren zum Herstellen eines Kern-Elektron-Quantenregisters (CEQUREG) und/oder eines Quantenbits (QUB) zusammen mit einem Kernquantenbit (CQUB) und/oder einer Anordnung von Quantenpunkten (NV) zusammen mit einer Anordnung von Kernquantenpunkten (CI) und/oder einer Anordnung von Quantenbits (QUB) zusammen mit einer Anordnung von Kernquantenbits (CQUB) beschrieben.

Diese Verfahren umfassen das Bereitstellen eines Substrats (D) und ggf. das Aufbringen einer epitaktischen Schicht (DEPI). Sofern das Substrat (D) bzw. die epitaktische Schicht (DEPI) nicht dotiert sind, erfolgen insbesondere wieder die besagte Dotierung zumindest von Teilen des Substrats (D) bzw. zumindest von Teilen der epitaktischen Schicht (DEPI) und die Reinigung und ggf. für den Fall, dass die Dotierung mittels Ionenimplantation erfolgte, das Ausheilen der Strahlenschäden. Bevorzugt umfasst das Substrat (D) oder zumindest die epitaktische Schicht (DEPI) im Wesentlichen nur Isotope ohne ein magnetisches Kernmoment. Der Begriff "im Wesentlichen" bedeutet dabei, dass der Gesamtanteil K_{1G} der Isotope mit magnetischen Moment eines Elements, das Bestandteil des Substrats (D) bzw. der epitaktischen Schicht (DEPI) ist, bezogen auf 100% dieses Elements, das Bestandteil des Substrats (D) bzw. der epitaktischen Schicht (DEPI) ist, gegenüber den in den obigen Tabellen angegebenen natürlichen Gesamtanteil K_{1G} auf einen Anteil K_{1G}' der Isotope mit magnetischen Moment eines Elements, das Bestandteil des Substrats (D) bzw. der epitaktischen Schicht (DEPI) ist, bezogen auf 100% dieses Elements, das Bestandteil des Substrats (D) bzw. der epitaktischen Schicht (DEPI) ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element des Substrats (D) bzw. der epitaktischen Schicht (DEPI) im Einwirkungsbereich der als Quantenpunkte (NV) benutzten paramagnetischen Störstellen (NV) und/oder der als Kernquantenpunkten (CI) benutzten nuklearen Spins ist.

Zur Herstellung der Kernquantenpunkte (CI) erfolgt bevorzugt nun jedoch eine deterministische Einzelionenimplantation vorbestimmter Isotope, die ein magnetisches Kernmoment µ aufweisen zur Herstellung von Kern-Quantenpunkten (CI) in vorbestimmten Bereichen des Substrats (D) bzw. der epitaktischen Schicht (DEPI). Bevorzugt wird diese Implantation auch zur gleichzeitigen Herstellung von paramagnetischen Zentren als Quantenpunkten (NV) genutzt.

Bevorzugt erfolgen wieder eine Reinigung und Temperaturbehandlung und die Vermessung der Funktion, Position und der T2-Zeiten der durch die implantierten Einzelatome gebildeten Quantenpunkte (NV) und/oder Kernquantenpunkte (CI) und ggf. eine Wiederholung der beiden vorausgehenden Schritte im Falle eines Fehlschlags.

Ggf. wird eine Isolationsschicht (IS) auf der Oberfläche (OF) des Substrats (D) bzw. der epitaktischen Schicht (DEPI) abgeschieden. Sofern eine epitaktische Schicht (DEPI) abgeschieden wurde bezieht sich der Begriff Oberfläche (OF) auf die Oberfläche der epitaktischen Schicht (DEPI) und im anderen Falle auf die Oberfläche des Substrats (D) direkt. Bevorzugt umfasst das Material der Isolationsschicht (IS) im Wesentlichen nur Isotope ohne magnetisches Kernmoment. Der Begriff "im Wesentlichen" bedeutet hierbei, dass der Gesamtanteil K_{1G} der Isotope mit magnetischen Moment eines Elements, das Bestandteil der Isolationsschicht (IS) ist, bezogen auf 100% dieses Elements, das Bestandteil d der Isolationsschicht (IS) ist, gegenüber den in den obigen Tabellen angegebenen natürlichen Gesamtanteil K_{1G} auf einen Anteil K_{1G}' der Isotope mit magnetischen Moment eines Elements, das Bestandteil der Isolationsschicht (IS) ist, bezogen auf 100% dieses Elements, das Bestandteil der Isolationsschicht (IS) ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element der Isolationsschicht (IS) im Einwirkungsbereich der als Quantenpunkte (NV) benutzten paramagnetischen Störstellen (NV) und/oder der als Kernquantenpunkten (CI) benutzten nuklearen Spins ist.

Wie zuvor erfolgen das Herstellen von ohmschen Kontakten zum Substrat (D) bzw. zur epitaktischen Schicht (DEPI), das Herstellen der horizontalen Leitungen (LH1, LH2, LH3) und ggf. der horizontalen Abschirmleitungen (SH1, SH2, SH3, SH4), das Herstellen einer ggf. zweiten Isolation, (IS), ggf. das Öffnen der Durchkontaktierungen durch die zweite Isolation (IS) sowie das Herstellen der vertikalen Leitungen (LV1, LV2, LV3) und ggf. der vertikalen Abschirmleitungen (SV1, SV2, SV3, SV4). Sofern erforderlich kann der Metallisierungsstapel weitere Isolations- und Metallisierungsebenen umfassen.

Bevorzugt werden die Isolationen (IS) im Wesentlichen aus Isotopen ohne magnetisches Kernmoment µ hergestellt. Der Begriff "im Wesentlichen" bedeutet dabei, dass der Gesamtanteil K_{1G} der Isotope mit magnetischen Moment eines Elements, das Bestandteil einer Isolation (IS) ist, bezogen auf 100% dieses Elements, das Bestandteil der Isolation(IS) ist, gegenüber den in den obigen Tabellen angegebenen natürlichen Gesamtanteil K_{1G} auf einen Anteil K_{1G}' der Isotope mit magnetischen Moment eines Elements, das Bestandteil d der Isolation(IS) ist, bezogen auf 100% dieses Elements, das Bestandteil der Isolation(IS) ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element d der Isolation(IS) im Einwirkungsbereich der als Quantenpunkte (NV) benutzten paramagnetischen Störstellen (NV) und/oder der als Kernquantenpunkten (CI) benutzten nuklearen Spins ist.

Bevorzugt werden die horizontalen Leitungen (LH1, LH2, LH3) und/oder ggf. die horizontalen Abschirmleitungen (SH1, SH2, SH3, SH4) und/oder die vertikalen Leitungen (LV1, LV2, LV3) und ggf. die vertikalen Abschirmleitungen (SV1, SV2, SV3, SV4) im Wesentlichen aus Isotopen ohne magnetisches Kernmoment hergestellt. Der Begriff "im Wesentlichen" bedeutet dabei, dass der Gesamtanteil K_{1G} der Isotope mit magnetischen Moment eines Elements, das Bestandteil einer horizontalen Leitung (LH1, LH2, LH3) und/oder ggf. einer horizontalen Abschirmleitung (SH1, SH2, SH3, SH4) und/oder einer vertikalen Leitungen (LV1, LV2, LV3) und ggf. einer vertikalen Abschirmleitungen (SV1, SV2, SV3, SV4) oder eines Abschnitts dieser ist, bezogen auf 100% dieses Elements, das Bestandteil der horizontalen Leitung (LH1, LH2, LH3) und/oder ggf. der horizontalen Abschirmleitung (SH1, SH2, SH3, SH4) und/oder der vertikalen Leitungen (LV1, LV2, LV3) und ggf. der vertikalen Abschirmleitungen (SV1, SV2, SV3, SV4) oder des Abschnitts dieser ist, gegenüber den in den obigen Tabellen angegebenen natürlichen Gesamtanteil K_{1G} auf einen Anteil K_{1G}' der Isotope mit magnetischen Moment eines Elements, das Bestandteil der horizontalen Leitung (LH1, LH2, LH3) und/oder ggf. der horizontalen Abschirmleitung (SH1, SH2, SH3, SH4) und/oder der vertikalen Leitungen (LV1, LV2, LV3) und ggf. der vertikalen Abschirmleitungen (SV1, SV2, SV3, SV4) oder des Abschnitts dieser ist, bezogen auf 100% dieses Elements, das Bestandteil der horizontalen Leitung (LH1, LH2, LH3) und/oder ggf. der horizontalen Abschirmleitung (SH1, SH2, SH3, SH4) und/oder der vertikalen Leitungen (LV1, LV2, LV3) und ggf. der vertikalen Abschirmleitungen (SV1, SV2, SV3, SV4) oder des Abschnitts dieser ist, herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element d der Isolation(IS) im Einwirkungsbereich der als Quantenpunkte (NV) benutzten paramagnetischen Störstellen (NV) und/oder der als Kernquantenpunkten (CI) benutzten nuklearen Spins ist.

Diese Verfahren umfassen im Falle einer auf Diamant basierenden Vorrichtung das Bereitstellen eines Substrats (D), insbesondere eines Diamanten, und ggf. das Aufbringen einer epitaktischen Schicht (DEPI), ggf. bereits mit Schwefeldotierung und/oder n-Dotierung. Das Material unter der Oberfläche (OF) des Substrats (D) und/oder das Material der epitaktischen Schicht (DEPI) umfasst bevorzugt abgesehen von den Isotopen der Kernquantenpunkte (CI) im Wesentlichen nur ¹²C-Isotope und/oder ¹⁴C-Isotope. Die Konzentration der C-Isotope mit magnetischen Moment, also beispielsweise der 13C-Isotope ist bevorzugt herabgesetzt. Hinsichtlich der Auslegung des Begriffs "im Wesentlichen" verweisen wir auf die obigen Ausführungen. Sofern das Substrat (D) bzw. die epitaktische Schicht (DEPI) nicht n- oder Schwefel-dotiert sind, erfolgen insbesondere im Falle eines Diamantmaterials bevorzugt wieder die besagte Schwefelimplantation und/oder n-Dotierung zumindest von Teilen des Substrats (D) bzw. zumindest von Teilen der epitaktischen Schicht (DEPI) und die Reinigung und das Ausheilen der Strahlenschäden. Für die Dotierung im Kopplungsbereich der Quantenpunkte (NV) bzw. der Kernquantenpunkte (CI) werden bevorzugt Isotope des Dotierstoffes ohne magnetisches Kernmoment verwendet. Im Falle einer Schwefeldotierung von Diamant wird bevorzugt das ³²S-Schwefel-Isotop für die n-Dotierung verwendet.

Diese Verfahren umfassen im Falle einer auf Silizium basierenden Vorrichtung das Bereitstellen eines Substrats (D), insbesondere eines Silizium-Wafers, und ggf. das Aufbringen einer epitaktischen Schicht (DEPl), ggf. bereits mit einer Dotierung. Das Material unter der Oberfläche (OF) des Substrats (D) und/oder das Material der epitaktischen Schicht (DEPI) umfasst bevorzugt abgesehen von den Isotopen der Kernquantenpunkte (CI) im Wesentlichen nur ²⁸Si-Isotope und/oder (schlechter) ³⁰Si-Isotope oder (noch schlechter) andere Si-Isotope mit langer Halbwertszeit und ohne magnetisches Kernmoment. Die Konzentration der Si-Isotope mit magnetischen Moment, also beispielsweise der ²⁹Si-Isotope ist bevorzugt herabgesetzt. Hinsichtlich der Auslegung des Begriffs "im Wesentlichen" verweisen wir auf die obigen Ausführungen. Sofern das Substrat (D) bzw. die epitaktische Schicht (DEPI) nicht dotiert sind, erfolgen insbesondere im Falle eines Siliziummaterials bevorzugt wieder eine n-Dotierung mittels der Isotope ²⁰Te, ¹²²Te, ¹²⁴Te, ¹²⁶Te, ¹²⁸Te, ¹⁵⁰Te, ⁴⁶Ti, ⁴⁸Ti, ⁵⁰Ti, ²C, ¹⁴C, ⁷⁴Se, ⁷⁶Se, ⁷⁸Se, ⁸⁰Se, ¹³⁰Ba, ¹³²Ba, ¹³⁴Ba, ¹³⁶Ba, ¹³⁸Ba, ³²S, ³⁴S, oder ³⁶S und/oder eine p-Dotierung mittels der Isotope ¹⁰Be, ¹⁰²Pd, ¹⁰⁴Pd, ¹⁰⁶Pd, ¹⁰⁸Pd, ¹¹⁰Pd, ²⁰⁴Tl zumindest von Teilen des Substrats (D) bzw. zumindest von Teilen der epitaktischen Schicht (DEPI) und die Reinigung und das Ausheilen der Strahlenschäden. Für die Dotierung im Kopplungsbereich der Quantenpunkte (NV) bzw. der Kernquantenpunkte (CI) werden also wieder bevorzugt Isotope des Dotierstoffes ohne magnetisches Kernmoment verwendet. Außerhalb dieses Kopplungsbereiches können die konventionellen Dotierstoffe (z.B. B, AS, P, In, Ga etc.) verwendet werden, die typischerweise ein magnetisches Kernmoment µ aufweisen.

Diese Verfahren umfassen im Falle einer auf Siliziumkarbid basierenden Vorrichtung das Bereitstellen eines Substrats (D), insbesondere eines Siliziumkarbid-Wafers, und ggf. das Aufbringen einer epitaktischen Schicht (DEPI), ggf. bereits mit einer Dotierung. Das Material unter der Oberfläche (OF) des Substrats (D) und/oder das Material der epitaktischen Schicht (DEPI) umfasst bevorzugt abgesehen von den Isotopen der Kernquantenpunkte (CI) im Wesentlichen nur ¹²C-Isotope und/oder ¹⁴C-Isotope sowie ²⁸Si-Isotope und ³⁰Si-Isotope. Die Konzentration der C-Isotope mit magnetischen Moment, also beispielsweise der ¹³C-Isotope ist bevorzugt im Bereich der Quantenpunkte (NV) bzw. der Kernquantenpunkte (CI) herabgesetzt. Die Konzentration der Si-Isotope mit magnetischen Moment, also beispielsweise der ²⁹Si-Isotope ist bevorzugt im Bereich der Quantenpunkte (NV) bzw. der Kernquantenpunkte (CI) herabgesetzt. Hinsichtlich der Auslegung des Begriffs "im Wesentlichen" verweisen wir auf die obigen Ausführungen. Sofern das Substrat (D) bzw. die epitaktische Schicht (DEPI) nicht n- dotiert sind, erfolgen insbesondere im Falle eines Siliziumkarbidmaterials bevorzugt wieder eine Dotierung zumindest von Teilen des Substrats (D) bzw. zumindest von Teilen der epitaktischen Schicht (DEPI) und die Reinigung und das Ausheilen der Strahlenschäden. Für die Dotierung im Kopplungsbereich der Quantenpunkte (NV) bzw. der Kernquantenpunkte (CI) werden bevorzugt Isotope des Dotierstoffes ohne magnetisches Kernmoment verwendet.

Zur Herstellung der Kernquantenpunkte (CI) in einem Substrat (D) oder einer epitaktischen Schicht (DEPI) erfolgt bevorzugt nun jedoch eine deterministische Einzelionenimplantation vorbestimmter Isotope mit magnetischem Kernmoment µ zur Herstellung von Kern-Quantenpunkten (CI) in vorbestimmten Bereichen des Substrats (D) bzw. der epitaktischen Schicht (DEPI). Bevorzugt werden diese Isotope und die Bedingungen der Einzelionenimplantation so gewählt, dass die Herstellung der Kernquantenpunkte (CI) gleichzeitig auch zur Herstellung von Quantenpunkten (NV) führt. Bevorzugt weisen diese vorbestimmten Bereiche des Substrats (D) bzw. der epitaktischen Schicht (DEPI) im Wesentlichen bis auf bereits hergestellte Kernquantenpunkte (CI) keine Isotope mit magnetischen Kernmoment µ in ihrem Material auf, die mit den Quantenpunkten (NV) bzw. Kernquantenpunkten (CI) in Wechselwirkung treten können. Bevorzugt umfassen sie im Wesentlichen nur ein Isotop, abgesehen von den Isotopen der Kernquantenpunkte und der Quantenpunkte. Hinsichtlich der Auslegung des Begriffs "im Wesentlichen" wird auf die obigen Ausführungen verwiesen. Bevorzugt werden Quantenpunkte (NV) und Kernquantenpunkte im Material des Substrats (D) bzw. der epitaktischen Schicht (DEPI) gelichzeitig hergestellt. Erforderlich ist, dass die Konzentration der Kernquantenpunkte (CI) im Umfeld eines Quantenpunkts (NV) nicht zu hoch ist und dass die Abstände dieser Kernquantenpunkte (CI) im Umfeld eines Quantenpunkts (NV), die mit dem Quantenpunkt (NV) koppeln können, zum betreffenden Quantenpunkt (NV) unterschiedlich sind, um zu einer unterschiedlichen Kopplungsstärke zwischen dem betreffenden Quantenpunkt (NV) und dem jeweiligen Kernquantenpunkt (CI) und damit zu unterschiedlichen Resonanzfrequenzen für die Kopplung der Paare aus einem Kernquantenpunkt (CI) und einem Quantenpunkt (NV) zu führen.

Im Falle von Diamant als Material des Substrats (D) oder der epitaktischen Schicht (DEPI) erfolgt zur Herstellung der Kernquantenpunkte (CI) in dem Diamant-Substrat (D) oder der epitaktischen Diamant-Schicht (DEPI) bevorzugt nun jedoch eine deterministische Einzelionenimplantation vorbestimmter Isotope, beispielsweise ¹⁵N-Isotopen mit einem magnetischen Kernmoment, zur Herstellung von paramagnetischen Zentren als Quantenpunkten (NV) und zur Herstellung von Kernquantenpunkten (CI) in vorbestimmten Bereichen des Substrats (D) bzw. der epitaktischen Schicht (DEPI). Bevorzugt weisen diese vorbestimmten Bereiche des Substrats (D) bzw. der epitaktischen Schicht (DEPI) im Wesentlichen bis auf bereits hergestellte kernquantenpunkte (CI) keine Isotope mit magnetischen Kernmoment µ in ihrem Material auf. Bevorzugt umfassen sie im Wesentlichen nur ¹²C-Isotope, die kein magnetisches Kernmoment aufweisen. Bevorzugt umfassen sie im Wesentlichen nur ²⁸Si-Isotope, die kein magnetisches Kernmoment aufweisen. Bevorzugt weisen diese vorbestimmten Bereiche des Substrats (D) bzw. der epitaktischen Schicht (DEPI) im Wesentlichen bis auf bereits hergestellte Kernquantenpunkte (CI) nur eine Isotopensorte ohne magnetisches Kernmoment µ, beispielsweise ¹²C-Isotope, in ihrem Material auf. Hinsichtlich der Auslegung des Begriffs "im Wesentlichen" wird auf die obigen Ausführungen verwiesen. Bevorzugt werden Quantenpunkte (NV) und Kernquantenpunkte (CI) im Diamantmaterial gelichzeitig z.B. durch Implantation von ¹⁵N-Isotopen hergestellt. Bevorzugt erfolgt die Herstellung mittels Einzelionenimplantation von ¹⁵N-Stickstoff oder entsprechenden anderen Stickstoffatomen zur Herstellung von NV-Zentren als Quantenpunkte (NV), wobei die Stickstoffatomen der NV-Zentren als Kernquantenpunkte (CQUB) in den vorbestimmten Bereichen des Substrats (D) bzw. der epitaktischen Schicht (DEPI) dienen können. Zusätzlich können auch Kohlenstoff-Isotope mit magnetischem Kernmoment µ, beispielsweise ¹³C-Kohlenstoff-Isotope, zur Schaffung weiterer Kernquantenpunkte (CI) implantiert werden, die mit dem Quantenpunkt (NV), also dem NV-Zentrum, koppeln können. Als weitere Kernquantenpunkte (CI) können aber auch durch unvollständige Purifizierung der Isotopenzusammensetzung des Diamantbereiches verbliebene Anteile an Kohlenstoff-Isotopen mit magnetischem Kernmoment µ innerhalb des betreffenden Bereichs innerhalb der Kern-Elektron-Kopplungsreichweite eines Quantenpunkts (NV) genutzt werden. Hierbei kann es sich beispielsweise um ¹³C-Isotope, die ein magnetisches Kernmoment µ aufweisen, handeln. Erforderlich ist aber, dass deren Konzentration nicht zu hoch ist und dass deren Abstände zum Quantenpunkt (NV) unterschiedlich sind, um zu einer unterschiedlichen Kopplungsstärke zwischen Kernquantenpunkt, also beispielsweise dem Kern des ¹³C-Isotops und dem Quantenpunkt, also beispielsweise dem NV-Zentrum, damit zu unterschiedlichen Resonanzfrequenzen zu führen.

Im Falle von Silizium als Material des Substrats (D) oder der epitaktischen Schicht (DEPI) erfolgt zur Herstellung der Kernquantenpunkte (CI) in dem Silizium-Substrat (D) oder der epitaktischen Silizium-Schicht (DEPI) bevorzugt nun jedoch eine deterministische Einzelionenimplantation vorbestimmter Isotope, beispielsweise ¹³C-Isotopen mit einem magnetischen Kernmoment, zur Herstellung von paramagnetischen Zentren als Quantenpunkten (NV), beispielsweise von G-Zentren, und zur Herstellung von Kernquantenpunkten (CI) in vorbestimmten Bereichen des Substrats (D) bzw. der epitaktischen Schicht (DEPI). Bevorzugt weisen diese vorbestimmten Bereiche des Substrats (D) bzw. der epitaktischen Schicht (DEPI) im Wesentlichen bis auf bereits hergestellte Kernquantenpunkte (CI) keine Isotope mit magnetischen Kernmoment µ in ihrem Material auf. Bevorzugt umfassen sie im Wesentlichen nur ²⁸Si-Isotope, die kein magnetisches Kernmoment aufweisen. Bevorzugt weisen diese vorbestimmten Bereiche des Substrats (D) bzw. der epitaktischen Schicht (DEPI) im Wesentlichen bis auf bereits hergestellte Kernquantenpunkte (CI) nur eine Isotopensorte ohne magnetisches Kernmoment µ, beispielsweise ²⁸Si-Isotope, in ihrem Material auf. Hinsichtlich der Auslegung des Begriffs "im Wesentlichen" wird auf die obigen Ausführungen verwiesen. Bevorzugt werden Quantenpunkte (NV) und Kernquantenpunkte (CI) im Siliziummaterial gelichzeitig z.B. durch Implantation von ¹³C-Isotopen hergestellt. Bevorzugt erfolgt die Herstellung mittels Einzelionenimplantation von ¹³C-Kohlenstoff oder entsprechenden anderen Kohlenstoffatomen zur Herstellung von G-Zentren als Quantenpunkte (NV), wobei die Kohlenstoffatome der G-Zentren als Kernquantenpunkte (CQUB) in den vorbestimmten Bereichen des Substrats (D) bzw. der epitaktischen Schicht (DEPI) dienen können. Zusätzlich können auch Silizium-Isotope mit magnetischem Kernmoment µ, beispielsweise ²⁹Si-Silizium-Isotope, zur Schaffung weiterer Kernquantenpunkte (CI) implantiert werden, die mit dem Quantenpunkt (NV), also dem G-Zentrum, koppeln können. Als weitere Kernquantenpunkte (CI) können aber auch durch unvollständige Purifizierung der Isotopenzusammensetzung des Silizium-Bereiches verbliebene Anteile an Silizium-Isotopen mit magnetischem Kernmoment µ innerhalb des betreffenden Bereichs innerhalb der Kern-Elektron-Kopplungsreichweite eines Quantenpunkts (NV) genutzt werden. Hierbei kann es sich beispielsweise um ²⁹Si-Isotope, die ein magnetisches Kernmoment µ aufweisen, handeln. Erforderlich ist aber, dass deren Konzentration nicht zu hoch ist und dass deren Abstände zum Quantenpunkt (NV) unterschiedlich sind, um zu einer unterschiedlichen Kopplungsstärke zwischen Kernquantenpunkt, also beispielsweise dem Kern des ²⁹Si-Isotops und dem Quantenpunkt, also beispielsweise dem G-Zentrum, damit zu unterschiedlichen Resonanzfrequenzen zu führen.

Im Falle von Siliziumkarbid als Material des Substrats (D) oder der epitaktischen Schicht (DEPI) erfolgt zur Herstellung der Kernquantenpunkte (CI) in dem Siliziumkarbid-Substrat (D) oder der epitaktischen Siliziumkarbid-Schicht (DEPI) bevorzugt nun jedoch eine deterministische Einzelionenimplantation vorbestimmter Isotope, beispielsweise ²⁸Si-Isotopen ohne magnetisches Kernmoment oder von ²⁹Si-Isotopen mit magnetischem Kernmoment, zur Herstellung von paramagnetischen Zentren als Quantenpunkten (NV), beispielsweise von V_{Si}-Zentren, und im Falle der Implantation von Isotopen mit magnetischen Kernmoment zur zeitgleichen Herstellung von Kernquantenpunkten (CI) in vorbestimmten Bereichen des Substrats (D) bzw. der epitaktischen Schicht (DEPI). Für Siliziumkarbid wurde die Herstellung von V_{Si}-Zentren auch durch Bestrahlung mit Elektronen berichtet. Auf die Schrift Junfeng Wang, Xiaoming Zhang, Yu Zhou, Ke Li, Ziyu Wang, Phani Peddibhotla, Fucai Liu, Sven Bauerdick, Axel Rudzinski, Zheng Liu, Weibo Gao, "Scalable fabrication of single silicon vacancy defect arrays in silicon carbide using focused ion beam" ACS Photonics, 2017, 4 (5), pp 1054-1059, DOI: 10.1021/acsphotonics.7b00230, arXiv:1703.04479 [quant-ph] wird in diesem Zusammenhang hingewiesen. Bevorzugt weisen die vorbestimmten Bereiche des Substrats (D) bzw. der epitaktischen Schicht (DEPI), in denen die Herstellung der Quantenpunkte (NV) bzw. der Kernquantenpunkte (CI) erfolgt, im Wesentlichen bis auf bereits hergestellte Kernquantenpunkte (Cl) keine Isotope mit magnetischen Kernmoment µ in ihrem Material auf. Bevorzugt umfassen sie im Wesentlichen nur ²⁸Si-Isotope und ¹²C-Isotope, die beide kein magnetisches Kernmoment aufweisen. Bei dem Siliziumkarbid handelt es sich also bevorzugt um ²⁸Si¹²C. Bevorzugt weisen diese vorbestimmten Bereiche des Substrats (D) bzw. der epitaktischen Schicht (DEPI) im Wesentlichen bis auf bereits hergestellte Kernquantenpunkte (CI) nur eine Isotopensorte ohne magnetisches Kernmoment µ, beispielsweise ²⁸Si-Isotope und beispielsweise ¹²C-Isotope, in ihrem Material auf. Hinsichtlich der Auslegung des Begriffs "im Wesentlichen" wird auf die obigen Ausführungen verwiesen. Bevorzugt werden Quantenpunkte (NV) und Kernquantenpunkte (CI) im Siliziumkarbidmaterial gleichzeitig z.B. durch Implantation von ²⁹Si-Isotopen mit magnetischem Kernmoment in Form von V_{Si}-Zentren bevorzugt in einem ²⁸Si¹²C-Siliziumkarbidbereich hergestellt. Bevorzugt erfolgt die Herstellung mittels Einzelionenimplantation von ²⁹Si-Siliziumatomen oder entsprechenden anderen Siliziumatomen zur Herstellung von V_{Si}-Zentren als Quantenpunkte (NV), wobei die Siliziumatome der V_{Si}-Zentren als Kernquantenpunkte (CQUB) in den vorbestimmten Bereichen des Substrats (D) bzw. der epitaktischen Schicht (DEPI) dienen können. Zusätzlich können auch Silizium-Isotope mit magnetischem Kernmoment µ, beispielsweise ²⁹Si-Silizium-Isotope, und/oder auch Kohlenstoff-Isotope mit magnetischem Kernmoment µ, beispielsweise ¹³C-Kohlenstoff-Isotope, zur Schaffung weiterer Kernquantenpunkte (CI) implantiert werden, die mit dem Quantenpunkt (NV), also dem V_{Si}-Zentrum, koppeln können. Als weitere Kernquantenpunkte (CI) können aber auch durch unvollständige Purifizierung der Isotopenzusammensetzung des Siliziumkarbid-Bereiches verbliebene Anteile an Silizium-Isotopen mit magnetischem Kernmoment µ und/oder verbliebene Anteile an Kohlenstoff-Isotopen mit magnetischem Kernmoment µ innerhalb des betreffenden Bereichs innerhalb der Kern-Elektron-Kopplungsreichweite eines Quantenpunkts (NV) genutzt werden. Hierbei kann es sich beispielsweise um ²⁹Si-Isotope, die ein magnetisches Kernmoment µ aufweisen, und/oder beispielsweise um ¹³C-Isotope, die ein magnetisches Kernmoment µ aufweisen, handeln. Erforderlich ist aber, dass deren Konzentration nicht zu hoch ist und dass deren Abstände zum Quantenpunkt (NV) unterschiedlich sind, um zu einer unterschiedlichen Kopplungsstärke zwischen Kernquantenpunkt, also beispielsweise dem Kern des ²⁹Si-Isotops bzw. des ¹³C-Isotops und dem Quantenpunkt, also beispielsweise dem V_{Si}-Zentrum, damit zu unterschiedlichen Resonanzfrequenzen zu führen.

Der Vollständigkeit halber sei hier erwähnt, dass durch eine n-Dotierung vor den Implantationen bei der Schaffung von paramagnetischen Zentren, die eine Fehlstelle aufweisen, es sich bewährt hat, durch eine Erhöhung der Elektronendichte mittels einer Anhebung des Fermi-Niveaus die Fehlstellen schon in der Entstehungsphase während der Implantation negativ zu laden. Dies führt zu einer Veränderung des Diffusionsprozesses für die Fehlstellen. Während ungeladene Fehlstellen im Kristall des Substrats (D) bzw. innerhalb der epitaktischen Schicht (DEPI) zu einer Zusammenballung neigen und damit die Ausbeute an paramagnetischen Zentren und damit der Quantenpunkte (NV) massiv z.T. bis zur Unbrauchbarkeit verringern, führt eine n-Dotierung zu einer negativen Aufladung der Fehlstellen und damit zu einer Abstoßung der Fehlstellen untereinander. Hierdurch wird die Wahrscheinlichkeit einer Zusammenballung verringert und die Ausbeute steigt in einen technisch brauchbaren Wertebereich.

Der Vollständigkeit halber sei hier erwähnt, dass statt Siliziumkarbid (z.B. ²⁸Si¹²C) in verschiedenen Modifikationen auch andere Mischkristalle aus Elementen der vierten Hauptgruppe zusammen mit den diesen Mischkristallen der vierten Hauptgruppe zuzuordnenden paramagnetischen Zentren für die in dieser Schrift offengelegten Verfahren und Vorrichtungen in Frage kommen. Alle diese Mischkristalle weisen in der Regel eine kleinere Bandlücke als Diamant auf. Zu nennen wären beispielsweise Germaniumsilizid (GeSi), Zinnsilizid (SnSi), Germaniumkarbid (GeC), Zinncarbid (SnC). Noch komplexere ternäre und quaternäre Mischkristalle sind denkbar, werden hier aber aus Platzgründen nicht behandelt. Bevorzugt werden auch diese Kristalle zumindest in den Bereichen der Quantenpunkte und/oder Kernquantenpunkte dieser Kristalle im Wesentlichen aus Isotopen ohne magnetischem Kernmoment gefertigt. Auf die Isotopenlisten oben und die Ausführungen zum Begriff "im Wesentlichen" wird hier in analoger Wese verwiesen.

Bevorzugt erfolgen nach der Herstellung der Quantenpunkte (NV) und/oder der Herstellung der Kernquantenpunkte (CI) wieder eine Reinigung und Temperaturbehandlung und die Vermessung der Funktion, Position und der T2-Zeiten der implantierten Einzelatome und ggf. eine Wiederholung der beiden vorausgehenden Schritte im Falle eines Fehlschlags.

Wie zuvor erfolgen das Herstellen von ohmschen Kontakten zum Substrat (D) bzw. zur epitaktischen Schicht (DEPI), das Herstellen der horizontalen Leitungen (LH1, LH2, LH3) und ggf. der horizontalen Abschirmleitungen (SH1, SH2, SH3, SH4), das Abscheiden mindestens einer oder mehrerer Isolationen (IS) und das Öffnen der Durchkontaktierungen sowie das Herstellen der vertikalen Leitungen (LV1, LV2, LV3) und ggf. der vertikalen Abschirmleitungen (SV1, SV2, SV3, SV4). Wie zuvor ergeben sich grundsätzlich zwei Methoden zur Herstellung von Kontakten zu dem Substrat (D) und/oder der epitaktischen Schicht (DEPI): Zum Ersten kann das Substrat (D) und/oder die epitaktische Schicht (DEPI) mit konventionellen Dotierstoffen, die üblicherweise der III. Hauptgruppe oder der V. Hauptgruppe angehören hoch dotiert werden und so die Möglichkeit, einen ohmschen Kontakt auszubilden, bieten. Da diese Standarddotierstoffe jedoch ein magnetisches Kernmoment in ihren stabilen Isotopen aufweisen, muss ein Mindestabstand dieser Kontakte zu den Quantenpunkten (NV) oder den Kernquantenpunkten (CI) eingehalten werden, der größer ist, als die Kern-Kern-Kopplungsreichweite zwischen dem magnetischen Kernmoment des Dotieratoms und dem Kernquantenpunkt (CI) bzw. größer als die Kern-Elektron-Kopplungsreichweite zwischen dem magnetischen Kernmoment des Dotierstoffatoms und dem Quantenpunkt (NV). Zum zweiten kann das Substrat mit Isotopen ohne magnetisches Kernmoment µ dotiert werden. Für Diamant kommt besonders ³²S-Isotope für eine n-Dotierung in Frage. Auf die obigen Ausführungen zur n-Dotierung von Si und zur p-Dotierung von Si wird hier nochmals verwiesen. Für die Isolationen (IS) werden wieder bevorzugt Isotope ohne magnetisches Kernmoment verwendet, wenn deren Abstand zum Quantenpunkt (NV) kleiner ist als die Kern-Elektron-Kopplungsreichweite zwischen dem Atomkern eines Atoms der Isolation (IS) und dem Quantenpunkt (NV) oder wenn deren Abstand zum Kernquantenpunkt (CI) kleiner ist als die Kern-Kern-Kopplungsreichweite zwischen dem Atomkern eines Atoms der Isolation (IS) und dem Kernquantenpunkt (CI).

Nun wollen wir hier ein allgemeines Verfahren zum Herstellen eines Kern-Elektron-Quantenregisters (CEQUREG) und/oder eines Quantenbits (QUB) zusammen mit einem Kernquantenbit (CQB) und/oder einer Anordnung von Quantenpunkten (NV) zusammen mit einer Anordnung von Kernquantenpunkten (CI) und/oder einer Anordnung von Quantenbits (QUB) zusammen mit einer Anordnung von Kernquantenbits (CQUB) angeben. Es umfasst wieder das Bereitstellen eines Substrats (D), insbesondere eines Substrats, das im Wesentlichen Isotope der IV. Hauptgruppe umfasst, und ggf. das Aufbringen einer epitaktischen Schicht (DEPI), ggf. bereits mit einer Dotierung, bevorzugt einer n-Dotierung. Sofern das Substrat (D) bzw. die epitaktische Schicht (DEPI) nicht dotiert sind, erfolgen wieder bevorzugt eine Dotierung z.B. mittels Ionenimplantation zumindest von Teilen des Substrats (D) bzw. zumindest von Teilen der epitaktischen Schicht (DEPI) und die Reinigung und das Ausheilen der Strahlenschäden. Nun erfolgt bevorzugt eine deterministische Einzelionenimplantation vorbestimmter Isotope, insbesondere Isotopen mit/oder ohne magnetischem Kernmoment, zur Herstellung von paramagnetischen Zentren als Quantenpunkte (NV) in vorbestimmten Bereichen des Substrats (D) bzw. der epitaktischen Schicht (DEPI). Alternativ oder zusammen mit der zuvor beschriebenen deterministischen Einzelionenimplantation kann eine deterministische Einzelionenimplantation vorbestimmter Isotope mit magnetischen Moment des Atomkerns zur Herstellung von Kern-Quantenpunkten (CI) in den vorbestimmten Bereichen des Substrats (D) bzw. der epitaktischen Schicht (DEPI) erfolgen. Es findet dann wieder eine Reinigung und Temperaturbehandlung statt. Wieder erfolgt bevorzugt eine Vermessung der Funktion, Position und der T2-Zeiten der implantierten Einzelatome und ggf. Wiederholung der drei vorausgehenden Schritte. Wie zuvor umfasst das Verfahren bevorzugt das Herstellen von ohmschen Kontakten zum Substrat (D) bzw. zur epitaktischen Schicht (DEPI) und das Herstellen der horizontalen Leitungen (LH1, LH2, LH3) und ggf. der horizontalen Abschirmleitungen (SH1, SH2, SH3, SH4), das Abscheiden einer Isolation (IS) und Öffnen der Durchkontaktierungen und das Herstellen der vertikalen Leitungen (LV1, LV2, LV3) und ggf. der vertikalen Abschirmleitungen (SV1, SV2, SV3, SV4). Wie zuvor ergeben sich auch hier grundsätzlich zwei Methoden zur Herstellung von Kontakten zu dem Substrat (D) und/oder der epitaktischen Schicht (DEPI): Zum Ersten kann das Substrat (D) und/oder die epitaktische Schicht (DEPI) mit konventionellen Dotierstoffen, die üblicherweise der III. Hauptgruppe oder der V. Hauptgruppe angehören hoch dotiert werden und so die Möglichkeit, einen ohmschen Kontakt auszubilden, bieten. Da diese Standarddotierstoffe jedoch ein magnetisches Kernmoment in ihren stabilen Isotopen aufweisen, muss ein Mindestabstand dieser Kontakte zu den Quantenpunkten (NV) oder den Kernquantenpunkten (CI) eingehalten werden, der größer ist, als die Kern-Kern-Kopplungsreichweite zwischen dem magnetischen Kernmoment des Dotieratoms und dem Kernquantenpunkt (CI) bzw. größer als die Kern-Elektron-Kopplungsreichweite zwischen dem magnetischen Kernmoment des Dotierstoffatoms und dem Quantenpunkt (NV). Zum zweiten kann das Substrat mit Isotopen ohne magnetisches Kernmoment µ dotiert werden. Für Diamant kommt besonders ³²S-Isotope für eine n-Dotierung in Frage. Auf die obigen Ausführungen zur n-Dotierung von Si und zur p-Dotierung von Si wird hier nochmals verwiesen. Für die Isolationen (IS) werden wieder bevorzugt Isotope ohne magnetisches Kernmoment verwendet, wenn deren Abstand zum Quantenpunkt (NV) kleiner ist als die Kern-Elektron-Kopplungsreichweite zwischen dem Atomkern eines Atoms der Isolation (IS) und dem Quantenpunkt (NV) oder wenn deren Abstand zum Kernquantenpunkt (CI) kleiner ist als die Kern-Kern-Kopplungsreichweite zwischen dem Atomkern eines Atoms der Isolation (IS) und dem Kernquantenpunkt (CI).

Nun wollen wir hier ein konkreteres Verfahren zum Herstellen eines Kern-Elektron-Quantenregisters (CEQUREG) und/oder eines Quantenbits (QUB) zusammen mit einem Kernquantenbit (CQB) und/oder einer Anordnung von Quantenpunkten (NV) zusammen mit einer Anordnung von Kernquantenpunkten (CI) und/oder einer Anordnung von Quantenbits (QUB) zusammen mit einer Anordnung von Kernquantenbits (CQUB) in Diamant angeben. Es umfasst wieder das Bereitstellen eines Substrats (D) in Form eines Diamanten, und ggf. das Aufbringen einer epitaktischen Schicht (DEPI), ggf. bevorzugt bereits mit Schwefeldotierung und/oder n-Dotierung. Sofern das Substrat (D) bzw. die epitaktische Schicht (DEPI) nicht n- oder Schwefel-dotiert sind, erfolgen wieder bevorzugt eine Schwefelimplantation und/oder eine andere n-Dotierung zumindest von Teilen des Substrats (D) bzw. zumindest von Teilen der epitaktischen Schicht (DEPI) und die Reinigung und das Ausheilen der Strahlenschäden. Nun erfolgt bevorzugt eine deterministische Einzelionenimplantation vorbestimmter Isotope, insbesondere beispielsweise von ¹⁴N-Stickstoff und/oder ¹⁵N-Stickstoff in Diamant, zur Herstellung von paramagnetischen Zentren als Quantenpunkte (NV) in vorbestimmten Bereichen des Diamant-Substrats (D) bzw. der epitaktischen Diamant-Schicht (DEPI), insbesondere beispielsweise zur Herstellung von NV-Zentren als Quantenpunkte (NV) in vorbestimmten Bereichen eines als Substrats (D) dienenden Diamanten. Alternativ oder zusammen mit der zuvor beschriebenen deterministischen Einzelionenimplantation kann eine deterministische Einzelionenimplantation vorbestimmter Isotope mit magnetischen Moment des Atomkerns, insbesondere von ¹³C-Kohlenstoff in Diamant, zur Herstellung von Kern-Quantenpunkten (CI) in den vorbestimmten Bereichen des Diamant-Substrats (D) bzw. der epitaktischen Schicht (DEPI), insbesondere zur Herstellung von Kernquantenpunkten (CQUB) in den vorbestimmten Bereichen eines als Substrats (D) dienenden Diamanten erfolgen. Es findet dann wieder eine Reinigung und Temperaturbehandlung statt. Wieder erfolgt bevorzugt eine Vermessung der Funktion, Position und der T2-Zeiten der implantierten Einzelatome und ggf. Wiederholung der drei vorausgehenden Schritte. Wie zuvor umfasst das Verfahren bevorzugt das Herstellen von ohmschen Kontakten zum Substrat (D) bzw. zur epitaktischen Schicht (DEPI) und das Herstellen der horizontalen Leitungen (LH1, LH2, LH3) und ggf. der horizontalen Abschirmleitungen (SH1, SH2, SH3, SH4), das Abscheiden einer Isolation (IS) und Öffnen der Durchkontaktierungen und das Herstellen der vertikalen Leitungen (LV1, LV2, LV3) und ggf. der vertikalen Abschirmleitungen (SV1, SV2, SV3, SV4). Auf die vorausgehenden Ausführungen wird hier verwiesen.

Nun wollen wir hier ein weiteres konkreteres Verfahren zum Herstellen eines Kern-Elektron-Quantenregisters (CEQUREG) und/oder eines Quantenbits (QUB) zusammen mit einem Kernquantenbit (CQB) und/oder einer Anordnung von Quantenpunkten (NV) zusammen mit einer Anordnung von Kernquantenpunkten (CI) und/oder einer Anordnung von Quantenbits (QUB) zusammen mit einer Anordnung von Kernquantenbits (CQUB) in Silizium angeben. Es umfasst wieder das Bereitstellen eines Substrats (D) in Form eines Siliziumkristalls, und ggf. das Aufbringen einer epitaktischen Schicht (DEPI), ggf. bevorzugt bereits mit r n-Dotierung. Auf die obigen Ausführungen zur n-Dotierung von Silizium wird verwiesen. Sofern das Substrat (D) bzw. die epitaktische Schicht (DEPI) nicht n-dotiert sind, erfolgen wieder bevorzugt eine Dotierung, insbesondere bevorzugt eine n-Dotierung, zumindest von Teilen des Substrats (D) bzw. zumindest von Teilen der epitaktischen Schicht (DEPI) und die Reinigung und das Ausheilen der Strahlenschäden. Nun erfolgt bevorzugt eine deterministische Einzelionenimplantation vorbestimmter Isotope, insbesondere beispielsweise von ¹²C-Kohlenstoff und/oder ¹³C-Kohlenstoff in Silizium, zur Herstellung von paramagnetischen Zentren als Quantenpunkte (NV) in vorbestimmten Bereichen des Diamant-Substrats (D) bzw. der epitaktischen Diamant-Schicht (DEPI), insbesondere beispielsweise zur Herstellung von G-Zentren als Quantenpunkte (NV) in vorbestimmten Bereichen eines als Substrats (D) dienenden Siliziumkristalls. Alternativ oder zusammen mit der zuvor beschriebenen deterministischen Einzelionenimplantation kann eine deterministische Einzelionenimplantation vorbestimmter Isotope mit magnetischen Moment des Atomkerns, insbesondere von ²⁹Si-Silizium in den Siliziumkristall, zur Herstellung von Kern-Quantenpunkten (CI) in den vorbestimmten Bereichen des Silizium-Substrats (D) bzw. der epitaktischen Schicht (DEPI), insbesondere zur Herstellung von Kernquantenpunkten (CQUB) in den vorbestimmten Bereichen eines als Substrats (D) dienenden Siliziumkristalls erfolgen. Es findet dann wieder eine Reinigung und Temperaturbehandlung statt. Wieder erfolgt bevorzugt eine Vermessung der Funktion, Position und der T2-Zeiten der implantierten Einzelatome und ggf. Wiederholung der drei vorausgehenden Schritte. Wie zuvor umfasst das Verfahren bevorzugt das Herstellen von ohmschen Kontakten zum Substrat (D) bzw. zur epitaktischen Schicht (DEPI) und das Herstellen der horizontalen Leitungen (LH1, LH2, LH3) und ggf. der horizontalen Abschirmleitungen (SH1, SH2, SH3, SH4), das Abscheiden einer Isolation (IS) und Öffnen der Durchkontaktierungen und das Herstellen der vertikalen Leitungen (LV1, LV2, LV3) und ggf. der vertikalen Abschirmleitungen (SV1, SV2, SV3, SV4). Wie zuvor ergeben sich auch hier grundsätzlich zwei Methoden zur Herstellung von Kontakten zu dem Silizium-Substrat (D) und/oder der epitaktischen Silizium-Schicht (DEPI): Zum Ersten kann das Substrat (D) und/oder die epitaktische Schicht (DEPI) mit konventionellen Dotierstoffen, die üblicherweise der III. Hauptgruppe oder der V. Hauptgruppe angehören, hoch dotiert werden und so die Möglichkeit, einen ohmschen Kontakt auszubilden, bieten. Da diese Standarddotierstoffe jedoch ein magnetisches Kernmoment in ihren stabilen Isotopen aufweisen, muss ein Mindestabstand dieser Kontakte zu den Quantenpunkten (NV) oder den Kernquantenpunkten (CI) eingehalten werden, der größer ist, als die Kern-Kern-Kopplungsreichweite zwischen dem magnetischen Kernmoment des Dotieratoms und dem Kernquantenpunkt (CI) bzw. größer als die Kern-Elektron-Kopplungsreichweite zwischen dem magnetischen Kernmoment des Dotierstoffatoms und dem Quantenpunkt (NV). Zum zweiten kann das Substrat mit Isotopen ohne magnetisches Kernmoment µ dotiert werden. Für Silizium kommen besonders ³²S-Isotope für eine n-Dotierung in Frage. Auf die obigen Ausführungen zur n-Dotierung von Si und zur p-Dotierung von Si wird hier nochmals verwiesen. Für die Isolationen (IS) werden wieder bevorzugt Isotope ohne magnetisches Kernmoment verwendet, wenn deren Abstand zum Quantenpunkt (NV) kleiner ist als die Kern-Elektron-Kopplungsreichweite zwischen dem Atomkern eines Atoms der Isolation (IS) und dem Quantenpunkt (NV) oder wenn deren Abstand zum Kernquantenpunkt (CI) kleiner ist als die Kern-Kern-Kopplungsreichweite zwischen dem Atomkern eines Atoms der Isolation (IS) und dem Kernquantenpunkt (CI). Bevorzugt wird die Isolation (Si) als Siliziumdioxid mit Isotopen, die im Wesentlichen kein magnetisches Kernmoment µ aufweisen, ausgeführt. Besonders kommt als Isolation (IS) ²⁸Si¹⁶O₂ in Frage.

### Quantenassembler

Für den Betrieb eines Quantencomputers ist eine geeignete Mikrocode-Programmierung der Steuervorrichtung (µC) erforderlich. In den vorausgehenden Abschnitten wurden verschiedene Verfahren und Verfahrensschritte vorgestellt, die dazu dienen verschiedene Komponenten des Quantencomputers in vorbestimmter Weise zu manipulieren. Jede dieser Quantenoperationen kann durch einen Operator-Kode symbolisiert werden.

Es wird daher vorgeschlagen, zumindest folgende beispielhaften Micro-Codes vorzusehen:

| Mnemonic für Quanten-OP-Code | Bedeutung | Parameter für Quanten-OP-Code |
|---|---|---|
| MFMW | Ermittlung der gemeinsame Elektron-Elektron-Mikrowellenfrequenz (f_{MW}) für einen einzelnen Quantenpunkt (NV) z.B. mittels eines Verfahrens nach den Merkmalen 298 bis 302 | a)Nummer der horizontalen Leitung (LH) |
| | | b) Nummer der vertikalen Leitung (LV) |
| | | c) Speicherstelle des Ergebnisses |
| | | d) Speicherstelle der Rabi-Frequenz bzw. der Rabi-Oszillations-Periodendauer |
| | | e) ggf. Gleichwert des Potentials der horizontalen Leitung (LH) |
| | | f) ggf. Gleichwert des Potentials der vertikalen Leitung (LV) |
| MFMWEE | Ermittlung der gemeinsame Elektron1-Elektron2- | a)Nummer der ersten horizontalen Leitung (LH1) |
| | Mikrowellenfrequenz (f_{MW}) für die Kopplung zweier | b) Nummer der ersten vertikalen Leitung (LV1) |
| | Quantenpunkte (NV1, NV2) z.B. mittels eines Verfahrens nach den Merkmalen 303 bis 307 | c)Nummer der zweiten horizontalen Leitung (LH2) |
| | | d) Nummer der zweiten vertikalen Leitung (LV2) |
| | | e) Speicherstelle des Ergebnisses |
| | | f) Speicherstelle der Rabi-Frequenz bzw. der Rabi-Oszillations-Periodendauer |
| | | g) ggf. Gleichwert des Potentials der ersten horizontalen Leitung (LH1) |
| | | h) ggf. Gleichwert des Potentials der ersten vertikalen Leitung (LV1) |
| | | i) ggf. Gleichwert des Potentials der zweiten horizontalen Leitung (LH2) |
| | | j) ggf. Gleichwert des Potentials der zweiten vertikalen Leitung (LV2) |
| MFMWCE | Ermittlung der Kern-Elektron-Mikrowellenfrequenz (f_{MWCE}) z.B. mittels eines Verfahrens nach den Merkmalen 308 bis 312 | a) Nummer der horizontalen Leitung (LH) |
| | | b) Nummer der vertikalen Leitung (LV) |
| | | c) Speicherstelle des Ergebnisses |
| | | d) Speicherstelle der Rabi-Frequenz bzw. der Rabi-Oszillations-Periodendauer |
| | | e) ggf. Gleichwert des Potentials der horizontalen Leitung (LH) |
| | | f) ggf. Gleichwert des Potentials der vertikalen Leitung (LV) |
| MFRWCC | Ermittlung der Kern-Kern - Radiowellenfrequenz (f_{RWCC}) | a) Nummer der ersten horizontalen Leitung (LH1) |
| | | b) Nummer der ersten vertikalen |
| | z.B. mittels eines Verfahrens nach den Merkmalen 318 bis 322 | Leitung (LV1) |
| | | a) Nummer der zweiten horizontalen Leitung (LH2) |
| | | b) Nummer der zweiten vertikalen Leitung (LV2) |
| | | c) Speicherstelle des Ergebnisses |
| | | d) Speicherstelle der Rabi-Frequenz bzw. der Rabi-Oszillations-Periodendauer |
| | | e) ggf. Gleichwert des Potentials der ersten horizontalen Leitung (LH1) |
| | | f) ggf. Gleichwert des Potentials der ersten vertikalen Leitung (LV1) |
| | | g) ggf. Gleichwert des Potentials der zweiten horizontalen Leitung (LH2) |
| | | h) ggf. Gleichwert des Potentials der zweiten vertikalen Leitung (LV2) |
| MFRWCC | Ermittlung der Elektron-Kern-Radiowellenfrequenz (f_{RWEC}) z.B. mittels eines Verfahrens nach den Merkmalen 313 bis 317 | a) Nummer der horizontalen Leitung (LH) |
| | | b) Nummer der vertikalen Leitung (LV) |
| | | c) Speicherstelle des Ergebnisses |
| | | d) Speicherstelle der Rabi-Frequenz bzw. der Rabi-Oszillations-Periodendauer |
| | | e) ggf. Gleichwert des Potentials der horizontalen Leitung (LH) |
| | | f) ggf. Gleichwert des Potentials der vertikalen Leitung (LV) |
| RESQB | Zurücksetzen des Quantenpunkts (NV) | a) Nummer der horizontalen Leitung (LH) |
| | | b) Nummer der vertikalen Leitung (LV) |
| | z.B. mittels eines Verfahrens nach dem Merkmal 323 | |
| RESQBR | Zurücksetzen des Quantenpunkts (NV) Durch Relaxation z.B. mittels eines Verfahrens nach dem Merkmal 324 | a) Nummer der horizontalen Leitung (LH) |
| | | b) Nummer der vertikalen Leitung (LV) |
| | | |
| RESQRCE | Zurücksetzen eines Kern-Elektron-Quantenregister s (CEQUREG)z.B. mittels eines Verfahrens nach den Merkmalen 325 bis 327 | a) Nummer der horizontalen Leitung (LH) |
| | | b) Nummer der vertikalen Leitung (LV) |
| MQBP | Manipulation eines Quantenpunkts (NV) z.B. mittels eines Verfahrens nach den Merkmalen 328 bis 333 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | e) Pulslänge in Anzahl der zeitlichen Pulslängen eines π/4 Pulses der Rabi-Oszillation. |
| | | f) Polarisation des zu erzeugenden zirkular polarisierten Magnetfeldes |
| | | g) ggf. Gleichwert des Potentials der horizontalen Leitung (LH) |
| | | h) ggf. Gleichwert des Potentials der vertikalen Leitung (LV) |
| MCBP | Manipulation eines Kernquantenpunkts (CI) z.B. mittels eines Verfahrens nach den Merkmalen 334 bis 338 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | e) Pulslänge in Anzahl der zeitlichen Pulslängen eines π/4 Pulses der Rabi-Oszillation. |
| | | f) Polarisation des zu erzeugenden zirkular polarisierten Magnetfeldes |
| | | g) Pulslänge in Anzahl der zeitlichen Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitung (LH) |
| | | j) ggf. Gleichwert des Potentials der ersten Leitung (LV) |
| SMQB | Selektive Manipulation eines Quantenpunkts (NV) innerhalb eines Quantenregisters (QUREG) z.B. mittels eines Verfahrens nach den Merkmalen 339 bis 346 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | e) Pulslänge in Anzahl der zeitlichen Pulslängen eines π/4 Pulses der Rabi-Oszillation. |
| | | f) Polarisation des zu erzeugenden |
| | | zirkular polarisierten Magnetfeldes |
| | | g) Gleichwert des Potentials der horizontalen Leitung (LH) |
| | | h) Gleichwert des Potentials der vertikalen Leitung (LV) |
| | | i) ggf. Gleichwert des Potentials der horizontalen Leitungen (LHx), die nicht die horizontale Leitung (LH) sind |
| | | j) ggf. Gleichwert des Potentials der vertikalen Leitungen (LVx), die nicht die vertikale Leitung (LV) sind. |
| KQBQB | Kopplung eines ersten Quantenpunkts (NV1) mit einem zweiten Quantenpunkt (NV2) z.B. mittels eines Verfahrens nach den Merkmalen 367 bis 385 | a) Nummer der Speicherstelle der zu verwendenden Frequenz |
| | | b) Nummer der Speicherstelle der Rabi-Oszillations-Periodendauer |
| | | c) Nummer der ersten horizontalen Leitung (LH1) |
| | | d) Nummer der ersten vertikalem Leitung (LV1) |
| | | e) Nummer der zweiten horizontalen Leitung (LH2) |
| | | f) Nummer der zweiten vertikalen Leitung (LV2) |
| | | g) Pulslänge in Anzahl der zeitlichen Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitungen (LH1, LH2) |
| | | j) ggf. Gleichwert des Potentials der vertikalen Leitungen (LV1, LV2)) |
| KQBCB | Kopplung eines ersten Quantenpunkts (NV) mit einem Kernquantenpunkt (CI) z.B. mittels eines Verfahrens nach den Merkmalen 386 bis 390 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | g) Pulslänge in Anzahl der zeitlichen Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitung (LH) |
| | | j) ggf. Gleichwert des Potentials der vertikalen Leitung (LV) |
| CNQBCBA | CNOT Verknüpfung eines ersten Quantenpunkts (NV) mit einem Kernquantenpunkt (CI) z.B. mittels eines Verfahrens nach den Merkmalen 386 bis 390 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | g) Pulslänge in Anzahl der zeitlichen |
| | | Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitung (LH) |
| | | j) ggf. Gleichwert des Potentials der vertikalen Leitung (LV) |
| CNQBCBB | CNOT Verknüpfung eines ersten Quantenpunkts (NV) mit einem Kernquantenpunkt (CI) z.B. mittels eines Verfahrens nach den Merkmalen 391 bis 395 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | g) Pulslänge in Anzahl der zeitlichen Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitung (LH) |
| | | j) ggf. Gleichwert des Potentials der vertikalen Leitung (LV) |
| CNQBCBC | CNOT Verknüpfung eines ersten Quantenpunkts (NV) mit einem | a) Nummer der Speicherstelle der zu verwendenden Frequenz |
| | | b) Nummer der Speicherstelle der |
| | Kernquantenpunkt (CI) z.B. mittels eines Verfahrens nach den Merkmalen 396 bis 412 | Rabi-Oszillations-Periodendauer |
| | | c) Nummer der horizontalen Leitung (LH) |
| | | d) Nummer der vertikalen Leitung (LV) |
| | | g) Pulslänge in Anzahl der zeitlichen Pulslängen eines π/4 Pulses der Rabi-Oszillation. |
| | | h) Polarisation des zu erzeugenden zirkular polarisierten Magnetfeldes |
| | | i) ggf. Gleichwert des Potentials der horizontalen Leitung (LH) |
| | | j) ggf. Gleichwert des Potentials der vertikalen Leitung (LV) |
| VQB | Selektive Bewertung eines Quantenpunkts (NV) innerhalb eines Quantenregisters (QUREG) z.B. mittels eines Verfahrens nach den Merkmalen 418 bis 419 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | e) Pulslänge in Anzahl der zeitlichen Pulslängen eines π/4 Pulses der Rabi-Oszillation. |
| | | f) Polarisation des zu erzeugenden zirkular polarisierten Magnetfeldes |
| | | g) Nummer der Speicherstelle für das Bewertungsergebnis |
| | | h) Gleichwert des Potentials der horizontalen Leitung (LH) |
| | | i) Gleichwert des Potentials |
| | | der vertikalen Leitung (LV) |
| | | j) ggf. Gleichwert des Potentials der horizontalen Leitungen (LHx), die nicht die horizontale Leitung (LH) sind |
| | | k) ggf. Gleichwert des Potentials der vertikalen Leitungen (LVx), die nicht die vertikale Leitung (LV) sind. |
| SCNQB | Selektive CNOT-Operation eines Quantenpunkts (NV) innerhalb eines Quantenregisters (QUREG) z.B. mittels eines Verfahrens nach den Merkmalen 420 bis 421 | a) Nummer der Speicherstelle der zu verwendenden Frequenz |
| | | b) Nummer der Speicherstelle der Rabi-Oszillations-Periodendauer |
| | | c) Nummer der horizontalen Leitung (LH) |
| | | d) Nummer der vertikalen Leitung (LV) |
| | | e) Pulslänge in Anzahl der zeitlichen Pulslängen eines π/4 Pulses der Rabi-Oszillation. |
| | | f) Polarisation des zu erzeugenden zirkular polarisierten Magnetfeldes |
| | | g) Gleichwert des Potentials der horizontalen Leitung (LH) |
| | | h) Gleichwert des Potentials der vertikalen Leitung (LV) |
| | | i) ggf. Gleichwert des Potentials der horizontalen Leitungen (LHx), die nicht die horizontale Leitung (LH) sind |
| | | j) ggf. Gleichwert des Potentials der vertikalen Leitungen (LVx), die nicht die vertikale Leitung (LV) sind. |

Die Verfahren entsprechend der Merkmale 422 bis 424 könne in der Regel aus den obigen Operationen zusammengesetzt werden. Es ist denkbar, weitere Operationen durch möglichen Varianten vorzusehen. Des Weiteren ist es sinnvoll die üblichen Assembler Instruktionen wie Sprünge, Verzweigungen, bedingte Sprünge, Programmzählermanipulationen, Move-Operationen, Additionsoperationen, Schiebeoperationen (links und rechts), Inversion, Bitmanipulationen, Aufruf von Unterroutinen, Stack-Operationen, Stack-Pointer-Operationen etc. weiter zuzulassen.

Auch ist es sinnvoll, bestimmte, oft verwendete Sequenzen der MNEMONICs ebenfalls hard zu kodieren und für diese eigene Mnemonics vorzusehen.

Die entsprechenden Signalabläufe werden bevorzugt in einem bevorzugt nicht flüchtigen Programmspeicher der Steuervorrichtung (µC) abgelegt.

Der Speicher der Steuervorrichtung (µC) umfasst dann bevorzugt eine Tabelle der Resonanzfrequenzen der Quantenpunkte und der Kernquantenpunkte und deren Kopplungen und der betreffenden horizontalen und vertikalen Leitungen, die zu betätigen sind, sowie die zugehörigen Rabi-Frequenzen sowie die ggf. anzulegenden Potenziale an die horizontalen und vertikalen Leitungen bzw. die ggf. Verstimmung der Resonanzfrequenzen einzuspeisenden Gleichströme. Diese Daten erlauben es der Steuervorrichtung (µC), die Quantenpunkte, die Kernquantenpunkte, die Paare aus zwei und ggf. mehr Quantenpunkten, die Paare aus Quantenpunkt und Kernquantenpunkt und ggf. die komplexeren Strukturen selektiv und gezielt anzusprechen und zu manipulieren.

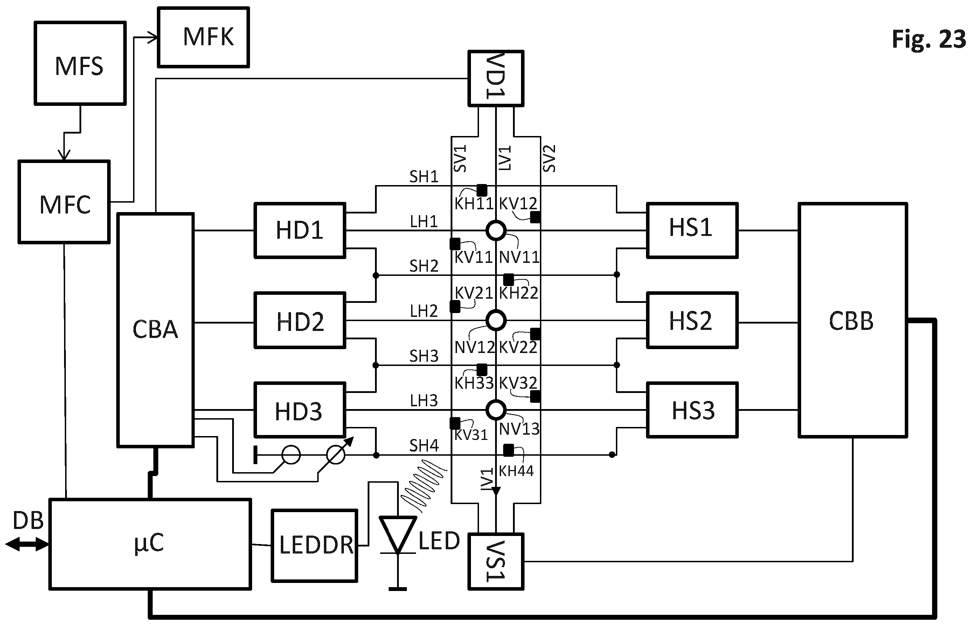

Ein Programm, ein Q-Assembler, übersetzt einen in für den Menschen lesbarer Textform vorliegenden Steuercode in binare Code-Sequenzen, die durch die Steuervorrichtung (µC) bei Bedarf ausgeführt werden, wodurch die Steuervorrichtung (µC) in vorgesehener Weise dann die Quanteninformation der Quantenpunkte, der Kernquantenpunkte, der Paare aus zwei und ggf. mehr Quantenpunkten, der Paare aus Quantenpunkt und Kernquantenpunkt und ggf. der komplexeren Strukturen selektiv und gezielt anzusprechen und zu manipulieren. Mit Hilfe dieser QuantenAssembler-Sprache ist es dann möglich für den Quantencomputer komplexere Programme zuentwickeln, um die Geräte zu bedienen und eine einfache Schnittstelle für die Softwareentwicklung bereitzustellen. Die Steuervor (µC) führt den Mikrocode aus. Mikrocode im Sinne des vorgeschlagenen Projekts ist die Verbindung zwischen einem vorgegebenen Binärcode - dem Quantenassembler-Code -, den die Steuervorrichtung (µC) von einem externen Überwachungscomputer (ZSE) über den Datenbus(DB) auf einer Seite empfängt, und der konkreten Folge von Signalen und der entsprechenden Signalformen für die Steuerleitungen, den Laser und für die Ausleseschaltungen. In diesem Sinne ist die Steuereinheitsfunktion der Steuervorrichtung µC) mit der Mikrocode-Programmierung eines herkömmlichen Prozessors vergleichbar. Die Steuervorrichtung (µC) hat bevorzugt das Quantencomputerprogramm in ihrem Speicher gespeichert. Das Quantencomputerprogramm besteht aus Sequenzen von Quantenassembler-Code in binärer Form, der sich in einem Speicher der Steuervorrichtung (µC) befindet. Die Steuervorrichtung (µC) führt den binären Quantenassembler-Code, der sich in einem Speicher der Steuervorrichtung (µC) befindet, aus und erzeugt auf den vertikalen Leitungen und horizontalen Leitungen die Signale unter Zuhilfenahme weiterer Mittel (CBA, HD1, HD2, HD3, VD1, VS1, HS1, HS2, HS3, LEDDR, LED, CBB) (siehe auch Figur 23) in Abhängigkeit von diesen bevorzugt binären Codes. Dies ermöglicht die Entwicklung von Quantencomputersoftware auf der hier offengelegten Hardware.

### Quantencomputersystem

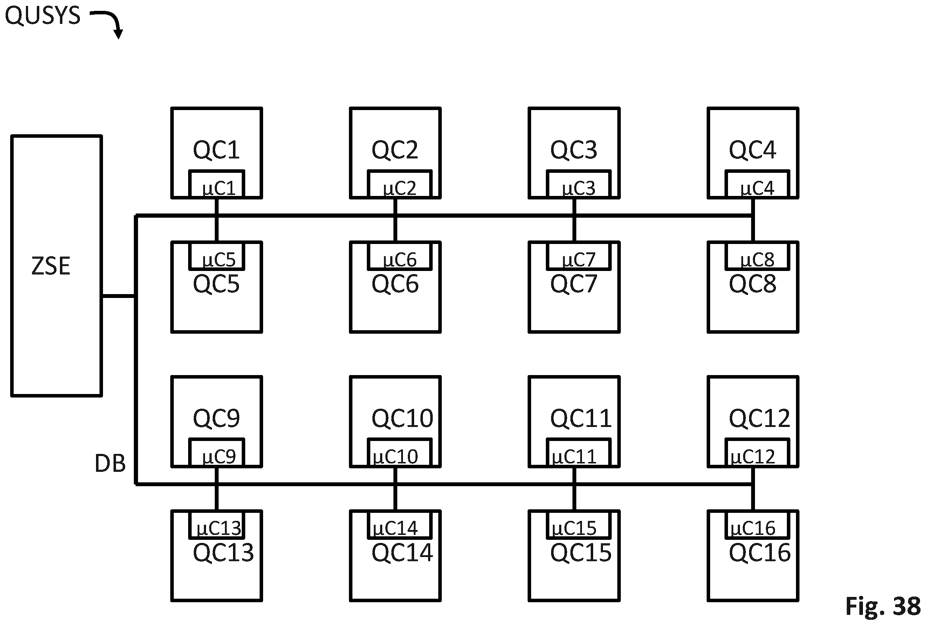

Ein externer Überwachungscomputer kann über einen konventionellen Datenbus eine Vielzahl von bevorzugt gleich aufgebauten Quantencomputern ansprechen. Der externe konventionelle Überwachungscomputer bildet dann mit der Vielzahl von Quantencomputern ein Quantencomputersystem. Bevorzugt sind die Quantencomputer des Quantencomputersystems wie hier beschrieben aufgebaut. Der hier beschriebene Aufbau der Quantencomputer hat den Vorteil, dass er sehr kompakt und sehr preiswert ist. Die Quantencomputer des Quantencomputersystems können beispielsweise bei Verwendung von Diamant als Material der Substrate (D) bzw. der epitaktischen Schichten (DEPI) und von NV-Zentren als Quantenpunkten (NV) bei Raumtemperatur betrieben werden. Bevorzugt wird eine sehr große Anzahl von Quantencomputern für ein Quantencomputersystem verwendet. Bevorzugt sind alle Quantencomputer gleich aufgebaut. Beispielsweise können Sie wie dar Quantencomputer der Figur 23 aufgebaut sein. Bevorzugt führen alle Quantencomputer des Quantencomputersystems die gleichen Operationen zur gleichen Zeit aus. Da die Realisierungen der Kernquantenpunkte und der Quantenpunkte im Detail unter den Quantencomputern voneinander abweichen, können kleinere Unterschiede bestehen. Wichtig ist, dass die Quantencomputer sich funktionsäquivalent verhalten. Trotzdem werden nicht alle Quantencomputer bei der Durchführung von Quantenoperationen zu den gleichen Ergebnissen kommen, da Quantencomputer nur bestimmte Ergebnisse mit einer bestimmten Wahrscheinlichkeit berechnen. Hier kann die große Zahl der Quantencomputer (siehe auch Figur 38) in dem Quantencomputersystem (QUSYS) ausgenutzt werden. Da alle Quantencomputer parallel in gleicher Weise arbeiten, werden die Quantencomputer am häufigsten die korrekten Ergebnisse errechnen. Der externe Überwachungscomputer, in Figur 38 die zentrale Steuereinrichtung (ZSE), des Quantencomputersystems (QUSYS) fragt über die Datenleitung die Ergebnisse einer in gleicher Weise von allen Quantencomputern ausgeführten, längeren Sequenz von Quantenoperationen bei allen betreffenden Quantencomputern ab. Der externe Überwachungscomputer, in Figur 38 die zentrale Steuereinrichtung (ZSE), bewertet alle Ergebnisse nach Häufigkeit der Errechnung durch die Quantencomputer des Quantencomputersystems (QUSYS). Mit Hilfe eines statistischen Verfahrens errechnet der externe Überwachungscomputer des Quantencomputersystems (QUSYSS) das wahrscheinlichste Ergebnis aus den Ergebnissen der Quantencomputer und wählt dieses als gültiges Zwischenergebnis aus. Danach übermittelt der externe Überwachungscomputer, in Figur 38 die zentrale Steuereinrichtung (ZSE), des Quantencomputersystems (QUSYS) dieses gültige Zwischenergebnis an alle Quantencomputer und veranlasst diese zum Ersten ihren jeweiligen Quantenbus mit den QuantenALUs zurückzusetzen und dann die Bloch-Vektoren so einzustellen, dass sie dem Zwischenergebnis entsprechen. Danach führen die Quantencomputer dann die nächste längere Sequenz von Quantenoperationen aus bis wieder ein zweites Zwischenergebnis vorliegt und dann die nächste Fehlerkorrekturschleife durch den externen Überwachungscomputer, in Figur 38 die zentrale Steuereinrichtung (ZSE), des Quantencomputersystems (QUSYS) durchgeführt wird.

Ein solches Quantencomputersystem (QUSYS) zeichnet sich somit dadurch aus, dass es einen konventionellen externen Überwachungscomputer, in Figur 38 die zentrale Steuereinrichtung (ZSE), des Quantencomputersystems (QUSYS) umfasst, der mit den Quantencomputern (in Figur 38 QC1 bis QC16) des Quantencomputersystems (QUSYS) über einen oder mehrere bevorzugt konventionelle Datenbusse (DB) kommuniziert. Die Datenbusse können konventionelle Datenübertragungstrecken beliebiger Art sein. Bevorzugt ist die Anzahl der Quantencomputer in dem Quantencomputersystem (QUSYS) größer als 5, besser größer als 10, besser größer als 20, besser größer als 50, besser größer als 100, besser größer als 200, besser größer als 500, besser größer als 100, besser größer als 200, besser größer als 500, besser größer als 1000, besser größer als 2000, besser größer als 5000, besser größer als 10000, besser größer als 20000, besser größer als 50000, besser größer als 100000, besser größer als 200000, besser größer als 50000, besser größer als 1000000. Hier gilt, dass die Auflösung der Fehlerkorrektur umso besser wird, je mehr Quantencomputer Teil des Quantencomputersystems (QUSYS) sind. Bevorzugt umfass jeder Quantencomputer (QUC1 bis QUC16) dabei eine Steuervorrichtung (µC), die jeweils mit dem externen Überwachungscomputer, in Figur 38 die zentrale Steuereinrichtung (ZSE), des Quantencomputersystems (QUSYS) über den einen Datenbus (DB) oder die mehreren, bevorzugt konventionelle Datenbusse (DB) kommunizieren. Bevorzugt umfasst jeder Quantencomputer dieser Quantencomputer (QC1 bis QC16) Mittel, die geeignet sind, die Zustände ihrer Quantenpunkte (NV) und/oder ihrer Kernquantenpunkte und/oder der Paare von Quantenpunkten und/oder der Paare aus Quantenpunkten und Kernquantenpunkten zu manipulieren und ggf. zu kontrollieren. Des Weiteren verfügen die Quantencomputer dieser Quantencomputer (QC1 bis QC16) jeweils bevorzugt über Mittel (LED, LEDDRV) zur Erzeugung von Anregungsstrahlung in Form von "grünem Licht". Ggf. kann diese Erzeugung des "grünen Lichts" auch zentral für einen oder mehrere oder alle Quantencomputer des Quantencomputersystems (QUSYS) erfolgen. In letzterem Fall wird die zugehörige Lichtquelle (LED) dann abweichend von Figur 23 von dem externen Überwachungscomputer des Quantencomputersystems (QUSYS) gesteuert. In Figur 38 entspricht der externe Überwachungscomputer des Quantencomputersystems (QUSYS) der zentralen Steuereinrichtung (ZSE).

Damit der Quantencomputer (QUC) die Befehle ausführen kann umfasst der Quantencomputer (QUC) bevorzugt die besagte Steuervorrichtung (µC). Dabei sollte die Steuervorrichtung (µC) dazu geeignet und eingerichtet sein, beispielsweise über den besagten Datenbus (DB) Befehle und/oder Kodes und/oder Kode-Folgen zu empfangen. Die die Steuervorrichtung (µC) führt dann bevorzugt in Abhängigkeit von diesen empfangenen Befehlen und/oder empfangenen Kodes und/oder empfangenen Kode-Folgen zumindest einer der folgenden Quantenoperationen durch den Quantencomputer (QUC) aus: MFMW, MFMWEE, MFMWCE, MFRWCC, FRWCC, RESQB, RESQBR, RESQRCE, MQBP, MCBP, SMQB, KQBQB, KQBCB, CNQBCBA, CNQBCBB, CNQBCBC, VQB, SCNQB. Hierzu erzeugt und moduliert die besagte Steuervorrichtung (µC) je nach empfangenen Befehl die geeigneten Steuersignale auf den m vertikalen Leitungen (LV, LV1 bis LVm) (mit m als ganzer positiver Zahl), den n horizontalen Leitungen (LH, LH1 bis LHn) (mit n als ganzer positiver Zahl) und den zugehörigen Abschirmleitungen sowie zur Ansteuerung der einen Lichtquelle (LED) oder der mehreren Lichtquellen (LED). Außerdem erfasst die Steuervorrichtung (µC) ggf. die Fotoströme (Iₚₕ) und steuert ggf. die Extraktionsspannung (Vₑₓₜ).

Hieraus ergibt sich ein geeignetes Verfahren zum Betrieb eines Quantencomputers, wie er hier vorgestellt wurde:
In einem ersten Schritt wird eine erste Datei, im Folgenden Source-Code genannt, bereitgestellt. Bevorzugt besteht der Source-Code aus Symbolen, die in einer geordneten Reihenfolge im Source-Code angeordnet sind. Den grundlegenden Operationen, die die Steuervorrichtung (µC) ausführen kann und die im Folgenden Quantenassemblerbefehle genannt werden, sind dabei vorbestimmte Zeichenketten zugeordnet. Zu diesen Quantenassemblerbefehle gehören bevorzugt zumindest einige, besser alle der bereits erwähnten Quantenoperationen des Quantencomputers (QUC), also insbesondere die Quantenoperationen MFMW, MFMWEE, MFMWCE, MFRWCC, FRWCC, RESQB, RESQBR, RESQRCE, MQBP, MCBP, SMQB, KQBQB, KQBCB, CNQBCBA, CNQBCBB, CNQBCBC, VQB, SCNQB. Bevorzugt gehören zu den Quantenassemblerbefehlen aber auch solche Assemblerbefehle, wie sie von konventionellen Computern her bekannt sind.

Solche Quantenassemblerbefehle können beispielsweise die eines 6502-Prozessors sein, der sich leicht in ein FPGA implementieren lässt:

| TYP, | MNEMONIC, BEFEHL, | | BEDEUTUNG |
|---|---|---|---|
| Ladebefehle | LDA | Load Accumulator | Lade Akkumulator |
| Ladebefehle | LDX | Load X-Register | Lade X-Register |
| Ladebefehle | LDY | Load Y-Register | Lade Y-Register |
| Speicherbefehle | STA | STore Accumulator | Speichere Akkumulator |
| Speicherbefehle | STX | STore X-Register | Speichere X-Register |
| Speicherbefehle | STY | STore Y-Register | Speichere Y-Register |
| Transfer-Befehle | TAX | Transfer Accumulator to X | Kopiere Akkumulator zu X |
| Transfer-Befehle | TAY | Transfer Accumulator to Y | Kopiere Akkumulator zu Y |
| Transfer-Befehle | TXA | Transfer X to Accumulator | Kopiere X zu Akkumulator |
| Transfer-Befehle | TYA | Transfer Y to Accumulator | Kopiere Y zu Akkumulator |
| Transfer-Befehle | TSX | Transfer Stackpointer to X | Kopiere Stackpointer zu X |
| Transfer-Befehle | TXS | Transfer X to Stackpointer | Kopiere X zu Stackpointer |
| Logische Operationen | AND | And | Logisches "Und" |
| Logische Operationen | ORA | OR Accumulator | Logisches "Oder" |
| Logische Operationen | EOR | Exclusive OR | Logisches "Entweder/Oder" (XOR) |
| Arithmetische Operationen | ADC | ADd with Carry | Addiere mit Übertrag |
| Arithmetische Operationen | SBC | Subtract with Carry | Subtrahiere mit Übertrag |
| Arithmetische Operationen | INC | INCrement | Inkrementiere Speicherzelle |
| Arithmetische Operationen | DEC | DECrement | Dekrementiere Speicherzelle |
| Arithmetische Operationen | INX | INcrement X | Inkrementiere X-Register |
| Arithmetische Operationen | INY | INcrement Y | Inkrementiere Y-Register |
| Arithmetische Operationen | DEX | DEcrement X | Denkrementiere X-Register |
| Arithmetische Operationen | DEY | DEcrement Y | Denkrementiere Y-Register |
| Bitweises Verschieben | ASL | Arithmetical Shift Left | Bitweises Verschieben nach links |
| Bitweises Verschieben | LSR | Logical Shift Right | Bitweises Verschieben nach rechts |
| Bitweises Verschieben | ROL | ROtate Left | Bitweises Rotieren nach links |
| Bitweises Verschieben | ROR | ROtate Right | Bitweises Rotieren nach rechts ROR |
| Vergleichs-Operationen | CMP | CoMPare | Vergleiche mit Akkumulator |
| Vergleichs-Operationen | CPX | ComPare X | Vergleiche mit X |
| Vergleichs-Operationen | CPY | ComPare Y | Vergleiche mit Y |
| Vergleichs-Operationen | BIT | BIT test | BIT-Test mit Akkumulator |
| Sprungbefehle (unbedingt) | JMP | JuMP | Unbedingter Sprung |
| Sprungbefehle (unbedingt) | JSR | Jump to SubRoutine | Unterprogrammaufruf |
| Sprungbefehle (unbedingt) | RTS | ReTurn from Subroutine | Rückkehr aus Unterprogramm |
| Sprungbefehle (unbedingt) | RTI | ReTurn from Interrupt | Rückkehr aus Interrupt |
| Sprungbefehle (bedingt) | BCC | Branch on Carry Clear | Verzweige bei gelöschtem Carry-Flag |
| Sprungbefehle (bedingt) | BCS | Branch on Carry Set | Verzweige bei gesetztem Carry-Flag |
| Sprungbefehle (bedingt) | BEQ | Branch on EQual | Verzweige bei gesetztem Zero-Flag |
| Sprungbefehle (bedingt) | BNE | Branch on Not Equal | Verzweige bei gelöschtem Zero-Flag |
| Sprungbefehle (bedingt) | BPL | Branch on PLus | Verzweige bei gelöschtem Negativ-Flag |
| Sprungbefehle (bedingt) | BMI | Branch on Minus | Verzweige bei gesetztem Negativ-Flag |
| Sprungbefehle (bedingt) | BVC | Branch on Overflow Clear | Verzweige bei gelöschtem Overflow-Flag |
| Sprungbefehle (bedingt) | BVS | Branch on Overflow Set | Verzweige bei gesetztem Overflow-Flag |
| Flag-Befehl | SEC | SEt Carry | Setze Carry-Flag |
| Flag-Befehl | CLC | CLear Carry | Lösche Carry-Flag |
| Flag-Befehl | SEI | SEt Interrupt | Setze Interrupt-Flag |
| Flag-Befehl | CLI | CLear Interrupt | Lösche Interrupt-Flag |
| Flag-Befehl | CLV | CLear oVerflow | Lösche Overflow-Flag |
| Flag-Befehl | SED | SEt Decimal | Setze Decimal-Flag |
| Flag-Befehl | CLD | CLear Decimal | Lösche Decimal-Flag |
| Stack-Befehle | PHA | PusH Akkumulator | Lege Akkumulatorinhalt auf Stack |
| Stack-Befehle | PLA | PuLl Akkumulator | Hole Akkumulatorwert vom Stack |
| Stack-Befehle | PHP | PusH Processor status | Lege Statusregister auf Stack |
| Stack-Befehle | PLP | PuLl Processor status | Hole Statusregister vom Stack |
| Spezial-Befehle | NOP | No OPeration | Keine Operation |
| Spezial-Befehle | BRK | BReaK | Software-Interrupt |

Diese Liste ist aber nur ein Beispiel möglicher Quantenassemblerbefehle. Jedem Mnemonic sind ist dabei ein spezifischer, eindeutiger Wert, im folgenden OP-Code genannt, zugeordnet, der die betreffende Operation für die Steuervorrichtung (µC) kodiert. Auch jeder Quantenoperation, insbesondere den Quantenoperationen, die den Mnemonics MFMW, MFMWEE, MFMWCE, MFRWCC, FRWCC, RESQB, RESQBR, RESQRCE, MQBP, MCBP, SMQB, KQBQB, KQBCB, CNQBCBA, CNQBCBB, CNQBCBC, VQB, SCNQB entsprechen, sind typischerweise solche spezifischen, eindeutigen Wert, d.h. OP-Codes und zwar hier speziell Quanten-OP-Codes, zugeordnet. Findet die Steuervorrichtung (µC) beim Ausführen des Programms einen solchen vorbestimmten Wert, so führt die Steuervorrichtung die betreffende Operation entsprechend dem OP-Code durch. Kodiert der aufgefundene Wert mittels eines Quanten-Op-Codes eine Quantenoperation, so führt die Steuervorrichtung (µC) die diesem Quanten-OP-Code zugeordnete Quantenoperation durch, deren Mnemonic dem betreffenden Quanten-OP-Code zugeordnet ist.

Neben den Mnemonics der möglichen Operationen und Quantenoperationen umfasst der Source-Code auch Daten in Form von Symbolketten. In einem zweiten Schritt übersetzt eine Datenverarbeitungsanlage den Source-Code in eine zweite Datei, im Folgenden Binar-File genannt. Das Binär-File umfasst eine geordnete Folge von Werten. Einige dieser Werte entsprechen dabei bevorzugt OP-Codes und Quanten-OP-Codes der betreffenden Mnemonics des Source-Codes. Das Binärfile umfasst darüber hinaus ggf. Daten, die als Zeichenketten im Source-Code kodiert waren. Ggf. umfasst der Source-Code auch Steuerbefehle zur Steuerung der Ausführung dieses zweiten Schrittes durch die Datenverarbeitungsanlage.

Mittels einer Datenverbindung, die typischerweise den Datenbus (DB) des Quantencomputers (QUC) umfasst, und/oder eines Datenträgers wird das Binar-File in einen Speicher der Steuervorrichtung (µC) in einem dritten Schritt übertragen.

In einem vierten Schritt wird die Steuervorrichtung (µC) veranlasst, an einer vorbestimmten Stelle im Speicher mit der Ausführung der OP-Codes und Quanten-OP-Codes zu beginnen. Dabei können den OP-Codes und Quanten-Op-Codes Daten zugeordnet sein, von denen die Ausführung der OP-Codes und/oder Quanten-Op-Codes abhängt. Im Falle der Quanten-OP-Codes können solche Daten, die einem Quanten-OP-Code zugeordnet sind, beispielsweise die oben erwähnten Parameter für Quanten-OP-Code sein.

In einem fünften Schritt werden dann OP-Code für OP-Code ausgeführt, bis ggf. -sofern vorgesehen - ein Haltebefehl gefunden wird. Hierbei kann es sich bei den OP-Codes ggf. auch um Quanten-OP-Codes handeln.

### Sensorsystem

Die vorgeschlagene Vorrichtung und die hier vorgeschlagenen Verfahren können auch als Sensorsystem eingesetzt werden. Bevorzugt wird dann das Magnetfeld, d.h. der messbare Wert der magnetischen Flussdichte B und/oder der Wert der magnetischen Feldstärke H, nicht mehr stabilisiert. Die Wechselwirkung mit dem Umfeld wird dann durch die Steuervorrichtung (µC) mittels der Quantenpunkte erfasst, ausgewertet und über den Datenbus (DB) weitergegeben. Es sind daher auch Sensorsysteme ausdrücklich von den Ansprüchen umfasst.

In einem solchen Sensorsystem wird der Wert der Intensität der Fluoreszenzstrahlung eines Quantenpunkts (NV) und/oder der Wert des durch einen Quantenpunkt (NV) erzeugten Fotostroms bei Bestrahlung mit "grünem Licht", also der für den betreffenden Quantenpunkt (NV) geeigneten Anregungsstrahlung, erfasst und als Messwert ausgegeben. Hierbei wird ausgenutzt, dass der Wert der Intensität der Fluoreszenzstrahlung eines Quantenpunkts (NV) und/oder der Wert des durch einen Quantenpunkt (NV) erzeugten Fotostroms bei Bestrahlung mit "grünem Licht", also der für den betreffenden Quantenpunkt (NV) geeigneten Anregungsstrahlung, in der Regel von externen physikalischen Parametern abhängt. Dieser externe physikalische Parameter kann beispielsweise die magnetische Flussdichte B am Ort des paramagnetischen Zentrums des Quantenpunkts (NV) oder die Temperatur oder die elektrische Flussdichte oder die Geschwindigkeit der Vorrichtung, die den Quantenpunkt (NV) aufweist oder deren Beschleunigung oder die Gravitationsfeldstärke oder die Rotationsgeschwindigkeit oder die Rotationsbeschleunigung sein. Der so erfasste Wert kann dann nach ggf. erfolgter Nachbearbeitung durch eine Auswertevorrichtung (µC) ggf. als Messwert für den aktuellen Wert des betreffenden externen physikalischen Parameters ausgegeben werden.

### Liste der Figuren

- Figur 1: zeigt ein Quantenbit (QUB).
- Figur 2: zeigt ein Kernquantenbit (CQUB).

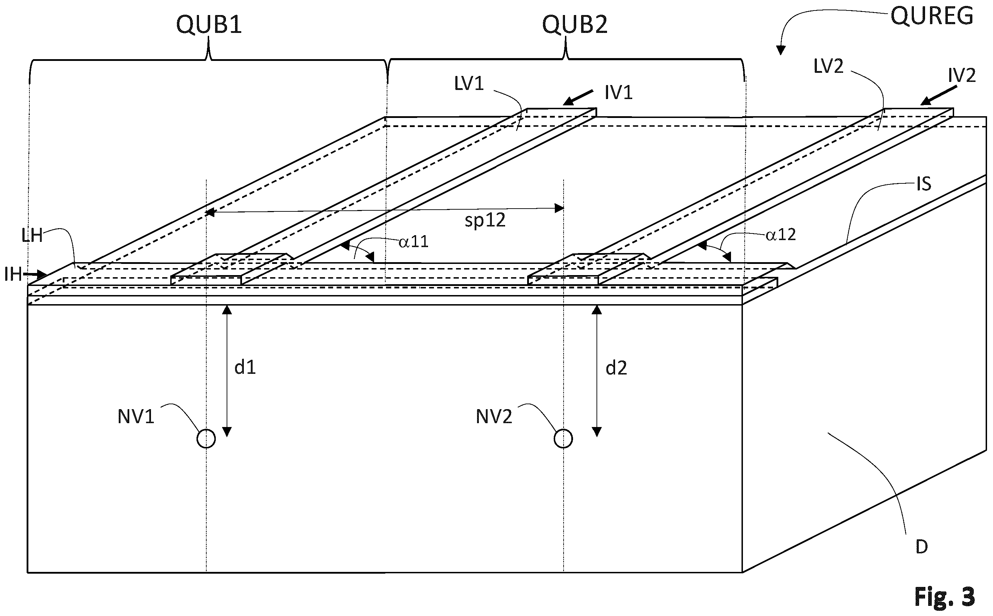

- Figur 3: zeigt ein Quantenregister (QUREG).

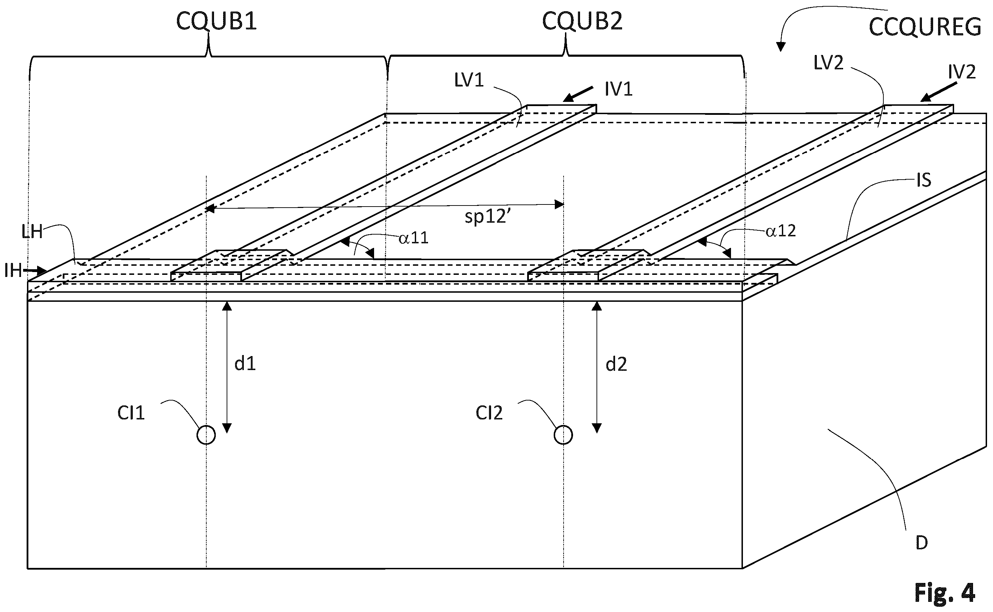

- Figur 4: zeigt ein Kern-Kern-Quantenregister (CCQUREG).

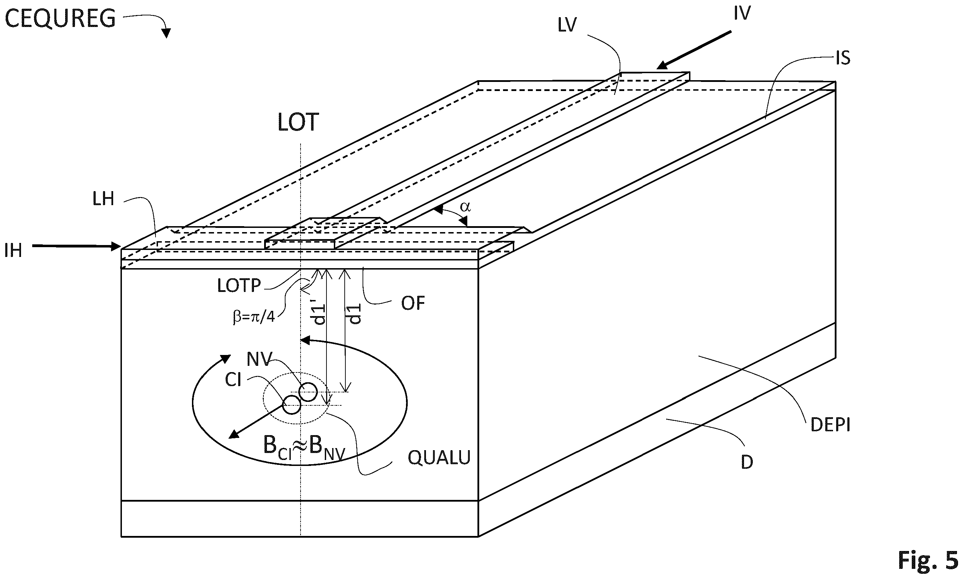

- Figur 5: zeigt ein Kern-Elektron-Quantenregister (CEQUREG).

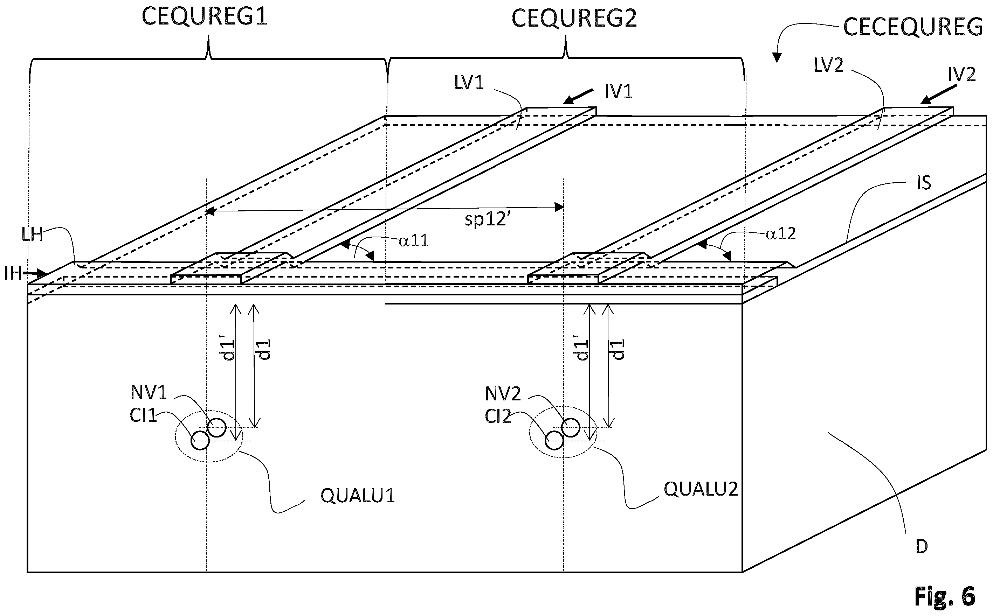

- Figur 6: zeigt ein Kern-Elektron-Kern-Elektron-Quantenregister (CECEQUREG).

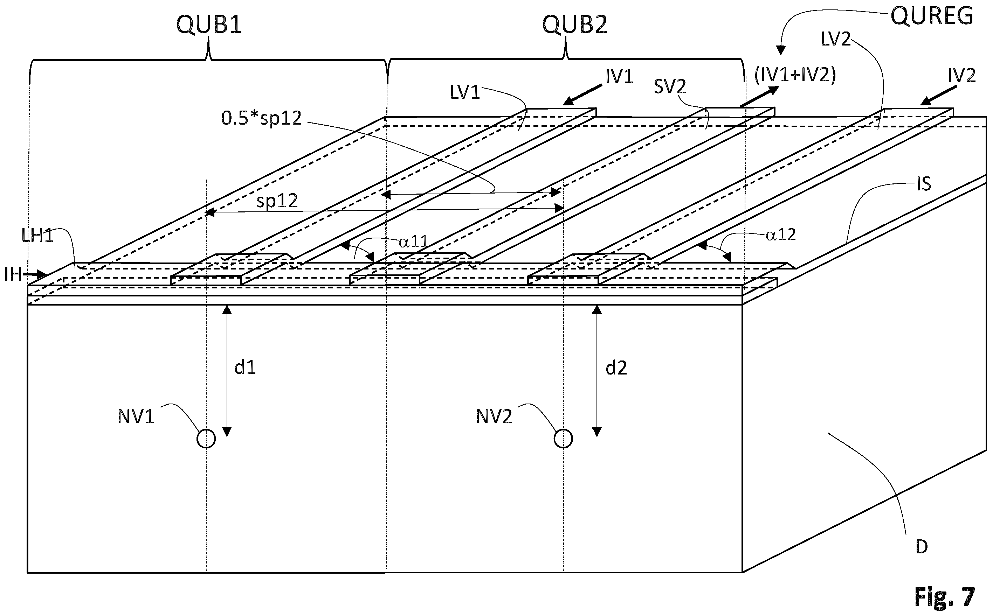

- Figur 7: zeigt ein Quantenregister (QUREG) mit einer zweiten vertikalen Abschirmleitung (SV2)

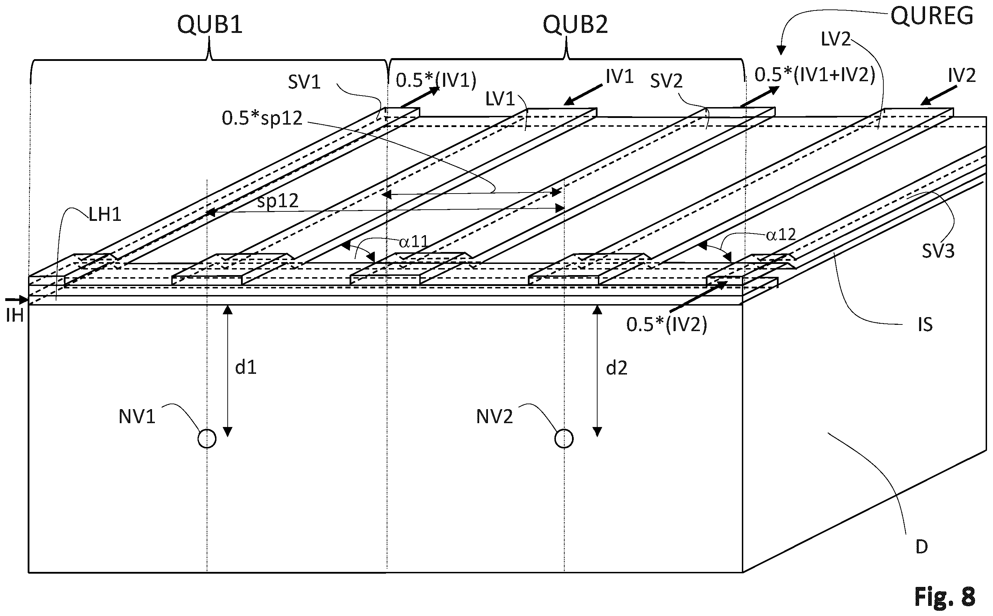

- Figur 8: zeigt ein Quantenregister (QUREG) mit einer zweiten vertikalen Abschirmleitung (SV2) und mit einer ersten vertikalen Abschirmleitung (SV1) mit einer dritten vertikalen Abschirmleitung (SV3).

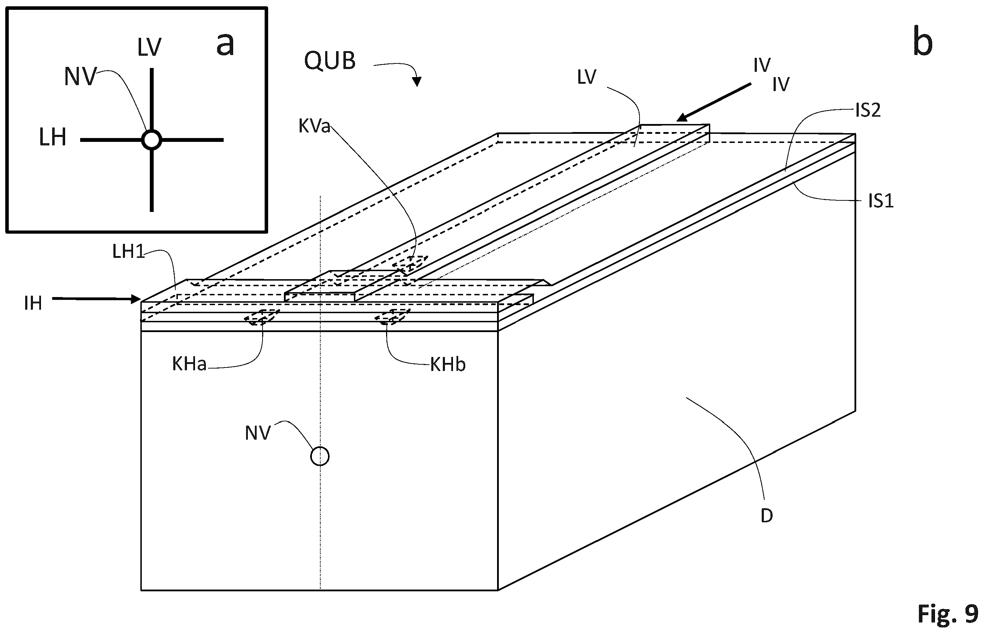

- Figur 9: zeigt ein Quantenbit (QUB) mit Kontakten (KHa, KHb, KVa) zum elektrischen Auslesen der Photoelektronen und eine symbolische Darstellung des Quantenbits (QUB).
- Figur 10: zeigt die symbolische Darstellung eines eindimensionalen Quantenregisters (QREG1D) mit drei Quantenbits (QUB1, QUB2, QUB3).

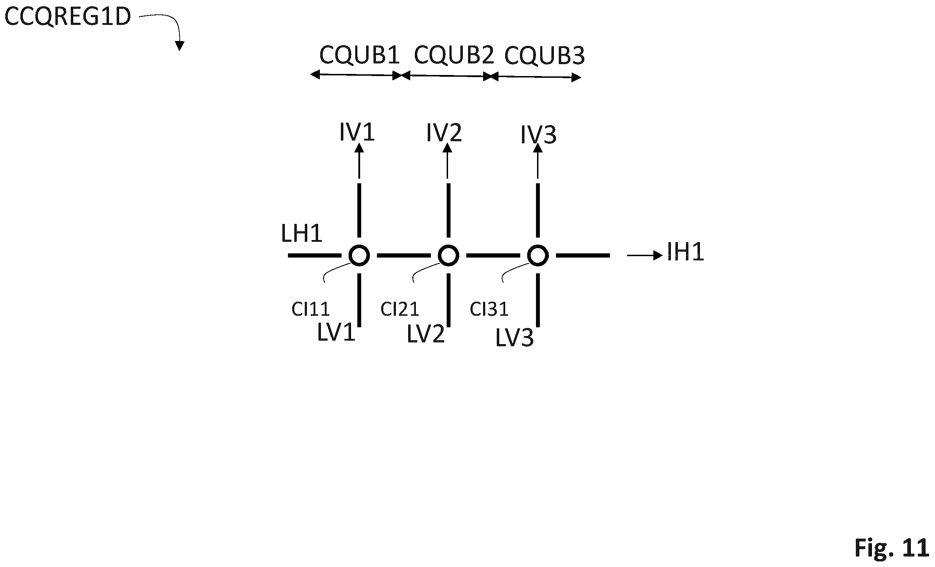

- Figur 11: zeigt die symbolische Darstellung eines eindimensionalen Kernquantenregisters (CCQREG1D) mit drei Kernquantenbits (CQUB1, CQUB2, CQUB3).

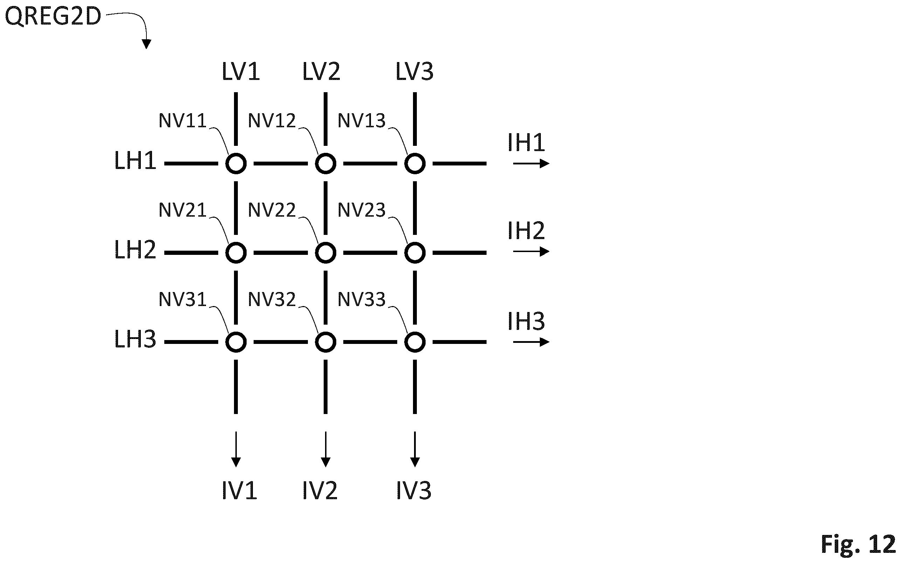

- Figur 12: zeigt die symbolische Darstellung eines zweidimensionalen Quantenregisters (QREG2D) mit neun Quantenpunkten (NV11 bis NV33).

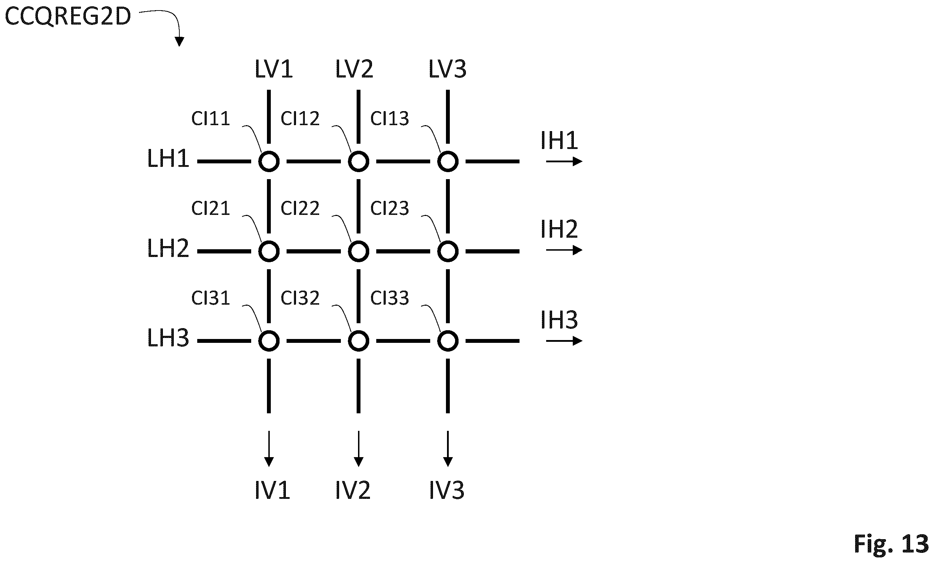

- Figur 13: zeigt die symbolische Darstellung eines zweidimensionalen Kernquantenregisters (CCQREG2D) mit neun Kernquantenpunkten (CI11 bis CI33).

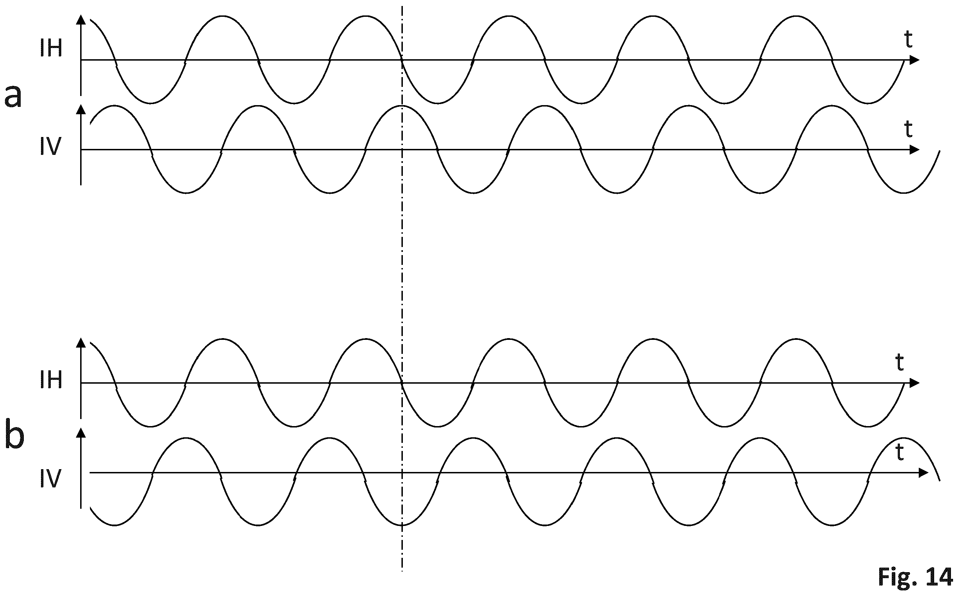

- Figur 14: zeigt einen beispielhaften zeitlichen Amplitudenverlauf der horizontalen Stromkomponente des horizontalen Stromes (IH) und der vertikalen Stromkomponente des vertikalen Stromes (IV) mit einer Phasenverschiebung von +/- π/2 zur Erzeugung eines zirkular polarisierten elektromagnetischen Feldes am Ort des Quantenpunkts (NV) bzw. des Kernquantenpunkts (CI).

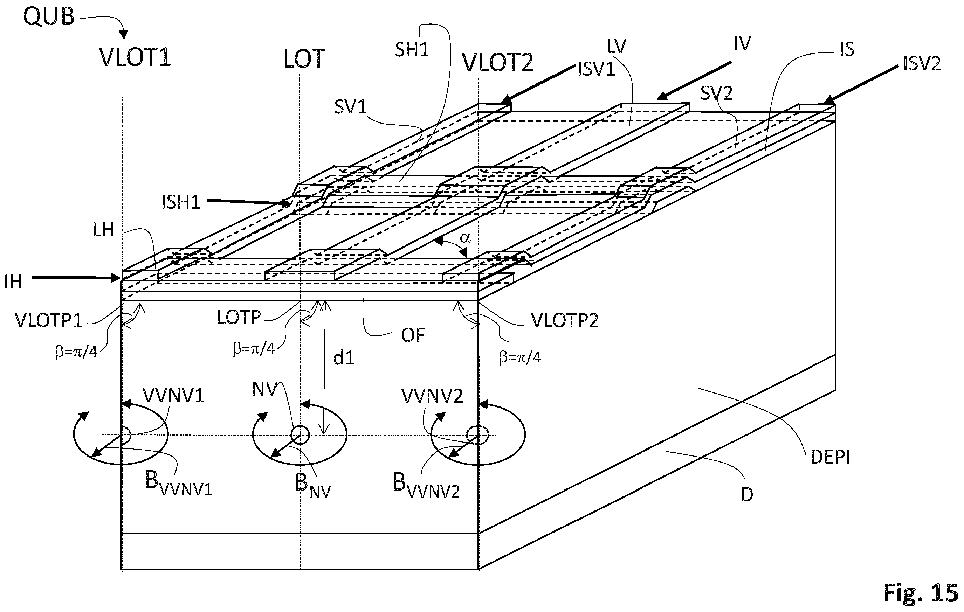

- Figur 15: dient der Veranschaulichung einer optimalen Bestromung am Beispiels eines Quantenbits (QUB) mit einer ersten vertikalen Abschirmleitung (SV1) und einer zweiten vertikalen Abschirmleitung (SV2).
- Figur 16: dient der Veranschaulichung einer optimalen Bestromung am Beispiels eines Quantenbits (QUB) mit einer ersten horizontalen Abschirmleitung (SH1) und einer zweiten horizontalen Abschirmleitung (SH2).

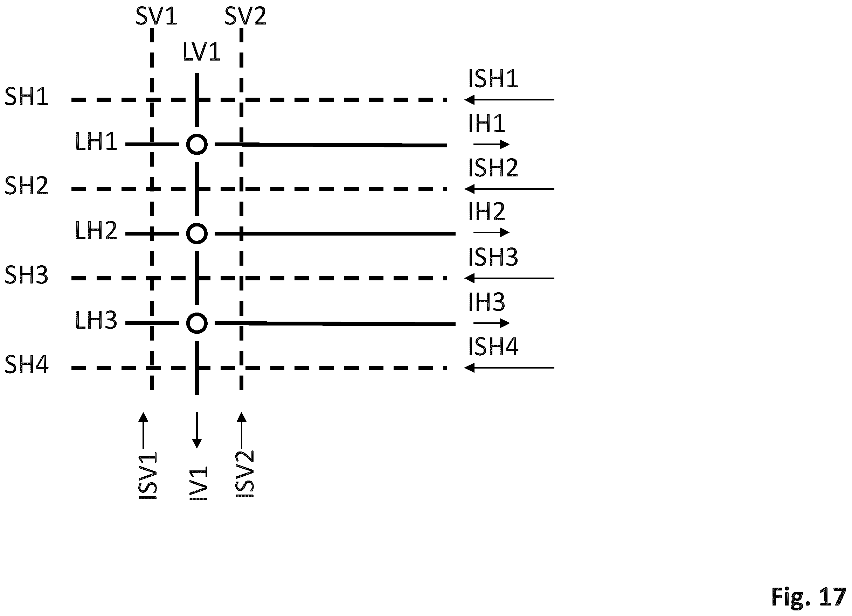

- Figur 17: zeigt die symbolische Darstellung eines Drei-Bit-Quantenregisters oder Kernquantenregisters mit Abschirmleitungen und einer gemeinsamen ersten vertikalen Ansteuerleitung (IV1).

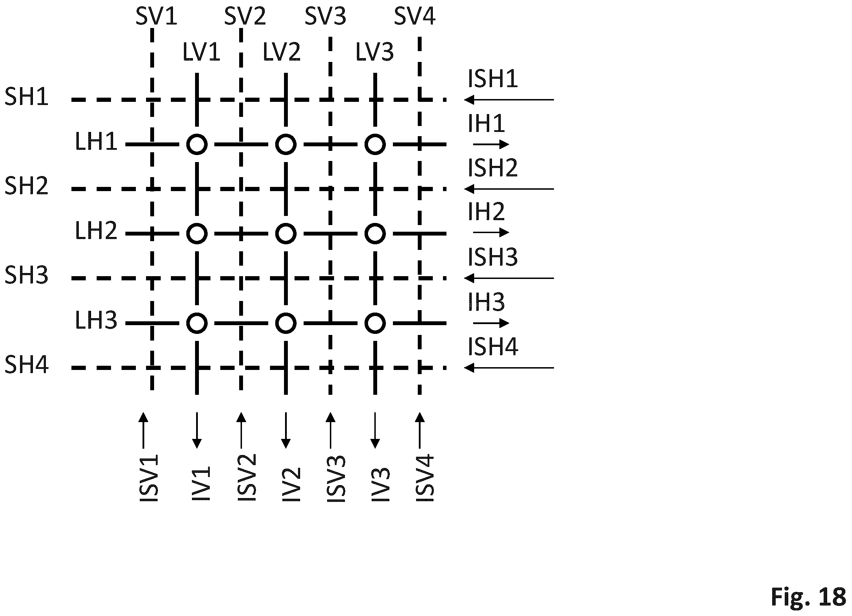

- Figur 18: zeigt die symbolische Darstellung eines zweidimensionalen Drei-x-Drei-Bit-Quantenregisters oder Kernquantenregisters mit Abschirmleitungen und Kontakten zum Auslesen der Photoelektronen.

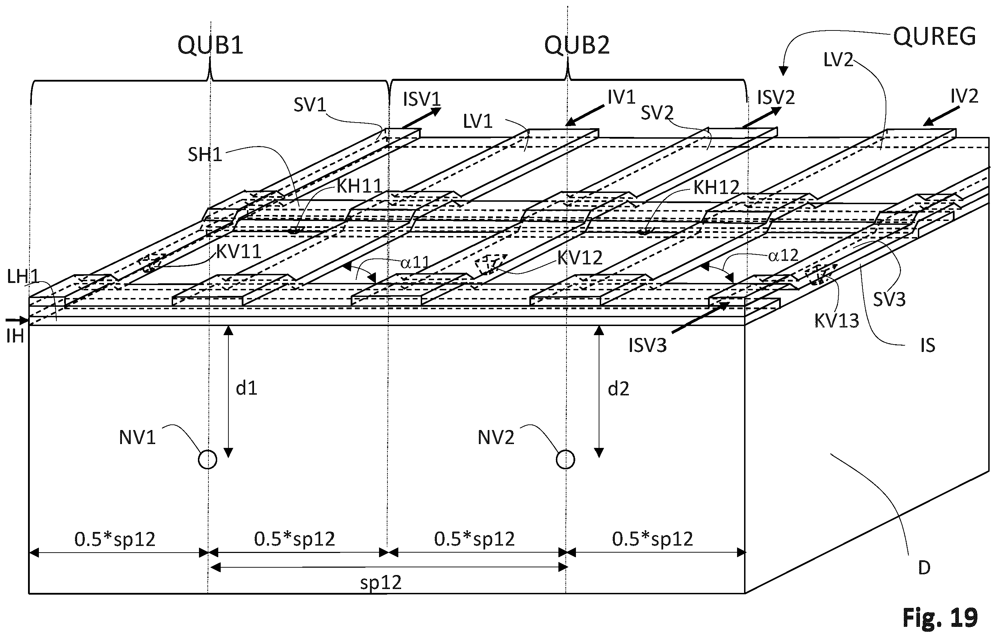

- Figur 19: zeigt ein beispielhaftes Zwei-Bit Quantenregister (QUREG) mit einer gemeinsamen ersten horizontalen Leitung (LH1), mehreren Abschirmleitungen und zwei Quantenpunkten (NV1, NV2).

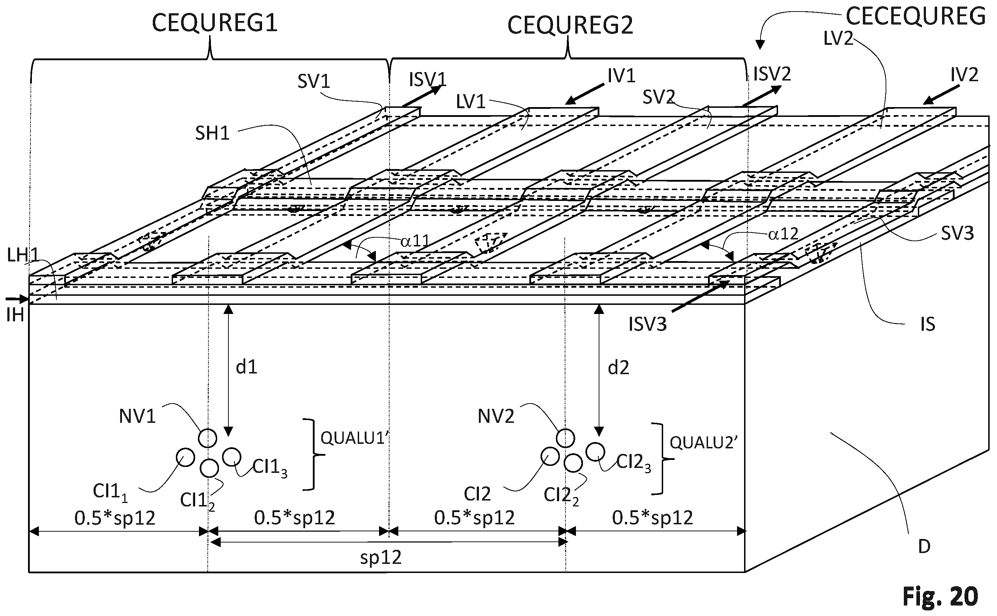

- Figur 20: zeigt ein beispielhaftes Zwei-Bit-Kern-Elektron-Kern-Elektron-Quantenregister (CECEQUREG) mit einer gemeinsamen ersten horizontalen Leitung (LH1), mehreren Abschirmleitungen und zwei QuantenALUs (QUALU1, QUALU2).

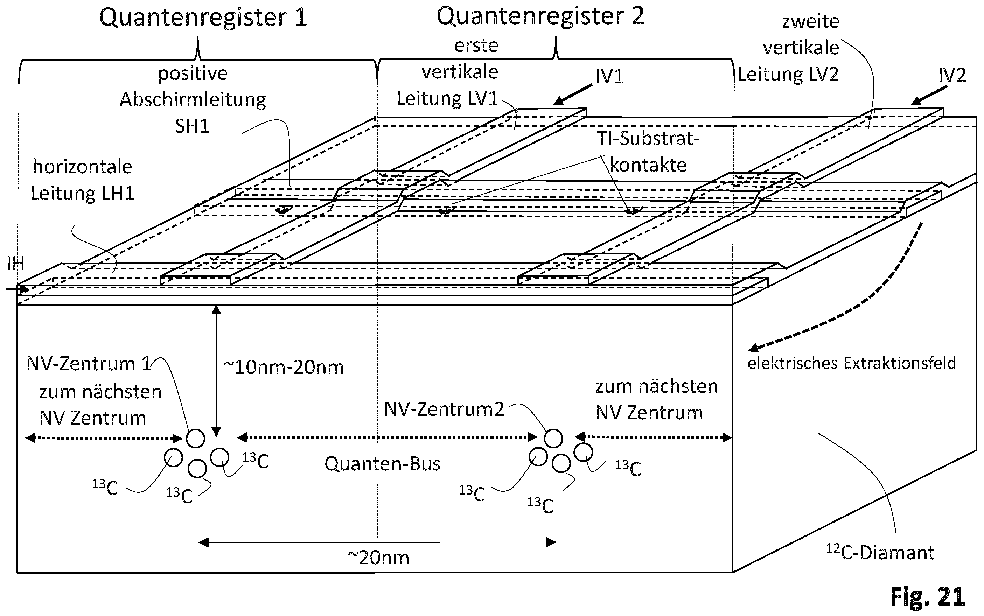

- Figur 21: dient der Erläuterung des Quantenbusbetriebes.

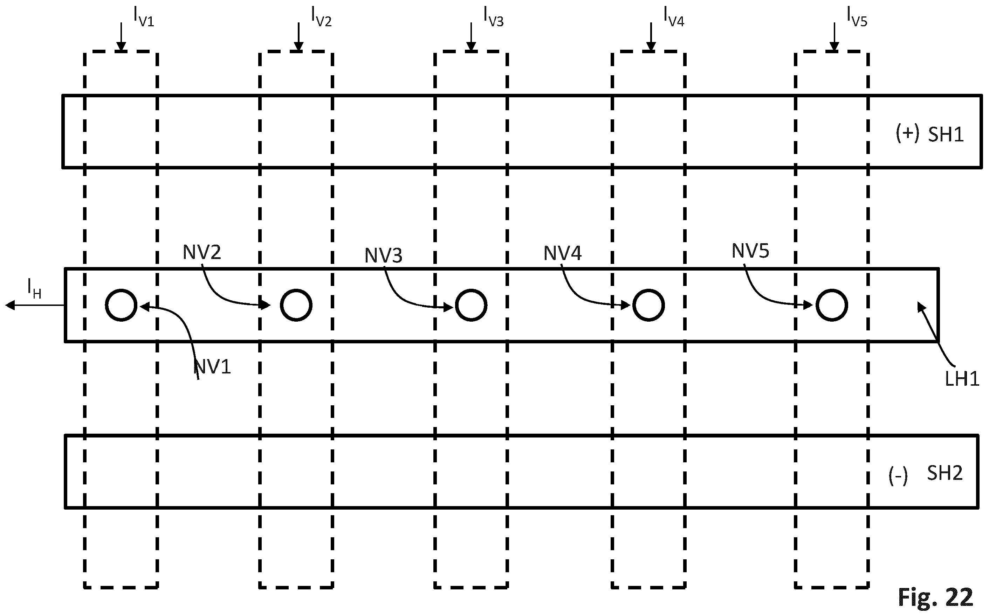

- Figur 22: zeigt beispielhaft die Anordnung für ein beispielhaftes Fünf-Bit Quantenregister in stark vereinfachter Form in der Aufsicht.
- Figur 23: zeigt das Blockdiagramm eines beispielhaften Quantencomputers mit einem beispielhaften schematisch angedeuteten Drei-Bit Quantenregister, das ggf. auch z.B. durch ein Drei-Bit Kern-Elektron-Kern-Elektron-Quantenregister (CECEQUREG) mit drei QuantenALUs ersetzt werden könnte.

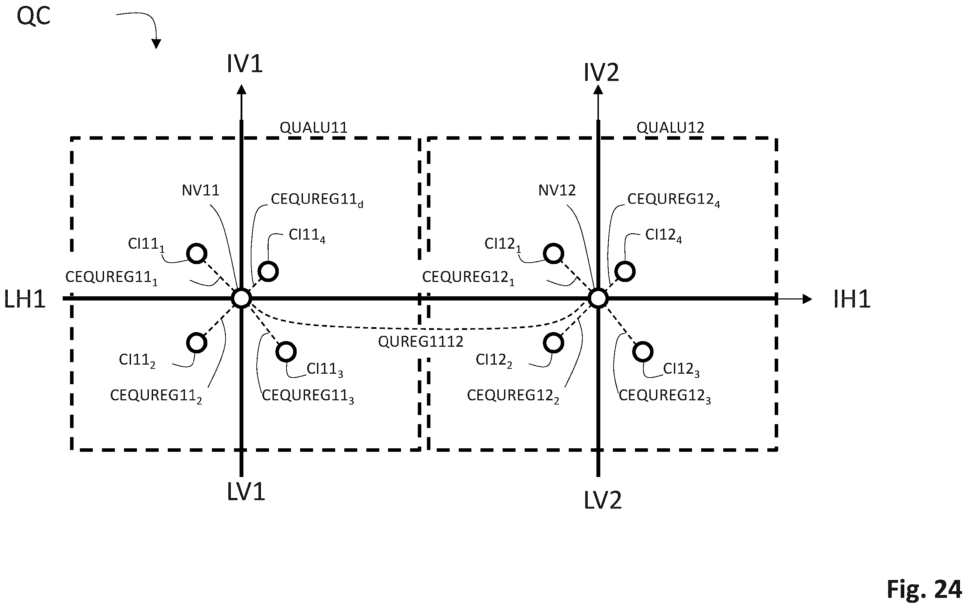

- Figur 24: zeigt eine beispielhafte symbolische horizontale Anordnung eines Kern-Elektron-Kern-Elektron-Quantenregister (CECEQUREG) mit zwei QuantenALUs (QUALU1, QUALU2).
- Figur 25: zeigt eine beispielhafte symbolische horizontale Anordnung eines Kern-Elektron-Kern-Elektron-Quantenregister (CECEQUREG) mit vier QuantenALUs (QUALU1, QUALU2, QUALU3, QUALU4).
- Figur 26: zeigt eine beispielhafte symbolische horizontale Anordnung eines Kern-Elektron-Kern-Elektron-Quantenregister (CECEQUREG) mit vier QuantenALUs (QUALU11, QUALU12, QUALU13, QUALU23) über Eck.
- Figur 27: zeigt eine beispielhafte symbolische horizontale Anordnung eines Kern-Elektron-Kern-Elektron-Quantenregister (CECEQUREG) mit fünf QuantenALUs (QUALU11, QUALU12, QUALU13, QUALU14, QUALU23) als Verzweigung.
- Figur 28: zeigt eine beispielhafte symbolische horizontale Anordnung eines Kern-Elektron-Kern-Elektron-Quantenregister (CECEQUREG) mit acht QuantenALUs (QUALU11, QUALU12, QUALU13, QUALU21, QUALU23, QUALU31, QUALU32, QUALU33,) als Ring.

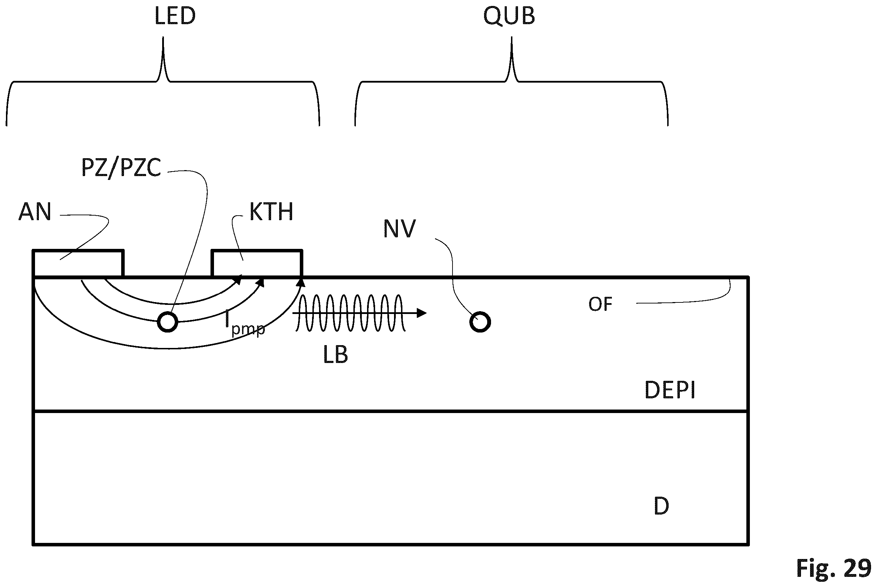

- Figur 29: zeigt eine Vorrichtung, die innerhalb eines Substrats (D) oder innerhalb einer epitaktischen Schicht (DEPI) untergebracht werden kann und somit in den vorausgehenden Vorrichtungen verwendet werden kann und bei der in dem Material des Substrats (D) oder der epitaktischen Schicht (DEPI) eine Strahlungsquelle (PL1) gefertigt ist, die als Lichtquelle (LED) für das "grüne Licht" verwendet wird.

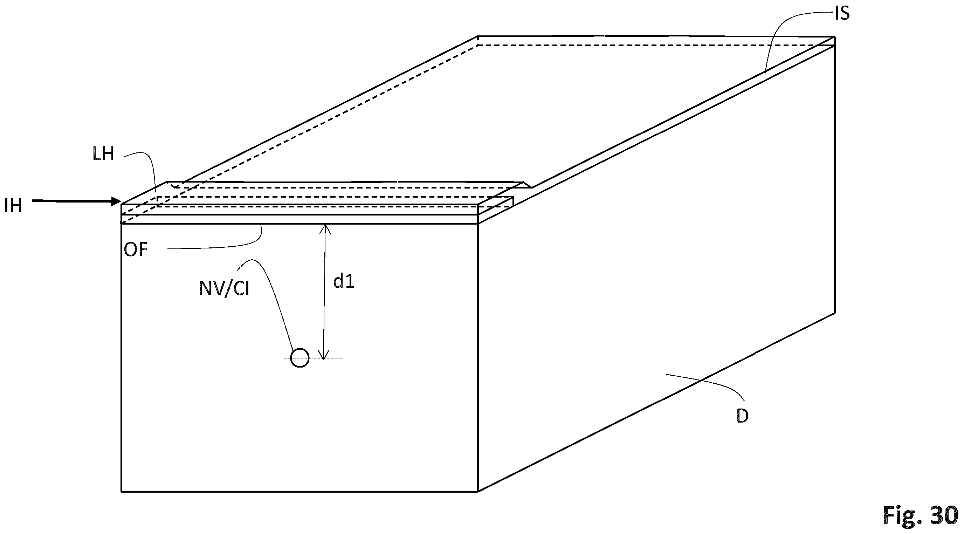

- Figur 30: zeigt eine vereinfachte Vorrichtung der Figur 1 mit einem Substrat (D), das im Falle von NV-Zentren als paramagnetischen Zentren (NV1) bevorzugt Diamant und im Falle von G-Zentren bevorzugt Silizium ist und im Valle von V_{Si}-Zentren bevorzugt Siliziumkarbid ist, mit einem oder mehreren paramagnetischen Zentren als Quantenpunkt (NV) bzw. Quantenpunkten (NV) in dem Substrat (D), wobei diese mit einer Leitung (LH), die auf der Oberfläche (OF) des Substrats (D) angebracht und befestigt ist und die bevorzugt von dem Substrat (D) beispielsweise durch eine Isolation (IS) elektrisch isoliert ist, aufgrund eines sehr geringen ersten Abstands (d1) von bevorzugt weniger als 100nm mit dem magnetischen Feld dieser Leitung (LH) wechselwirken, wenn die Leitung (LH) von einem elektrischen Strom (IH) durchströmt wird.

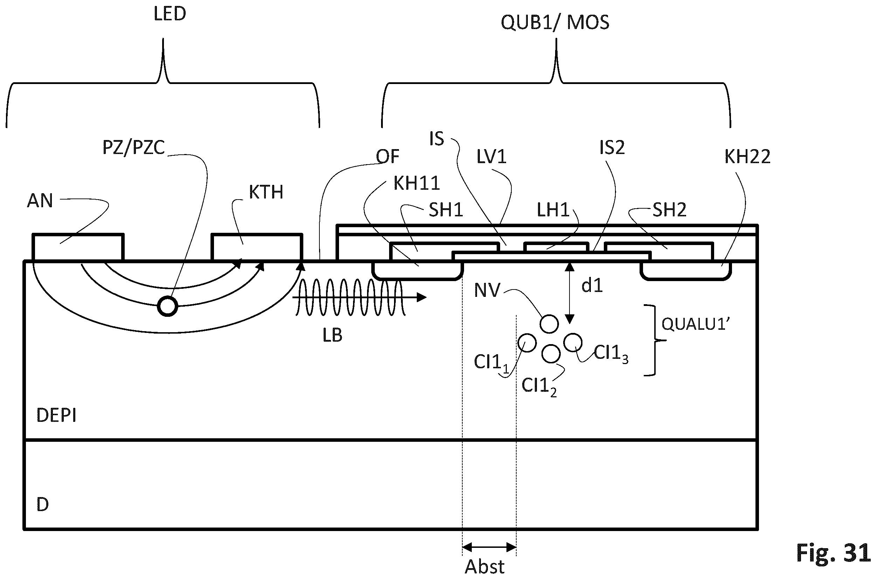

- Figur 31: zeigt die Kombination eines paramagnetischen Zentrums als Quantenpunkt (NV) in einem Halbleitermaterial eines halbleitenden Substrats (D), beispielsweise aus Silizium oder Siliziumcarbid, mit einem MOS-Transistor in diesem Material, wobei die horizontalen Schirmleitungen (SH1, SH2) die Source- und Drain-Kontakte darstellen, während die erste horizontale Leitung (LH1) das Gate des MOS-Transistors bildet und durch das Gate-Oxid von dem Material des Substrats (D) isoliert ist. Die Pumpstrahlung (LB) in Form des "grünen Lichts" wird durch ein Zentrum (PZ) erzeugt.

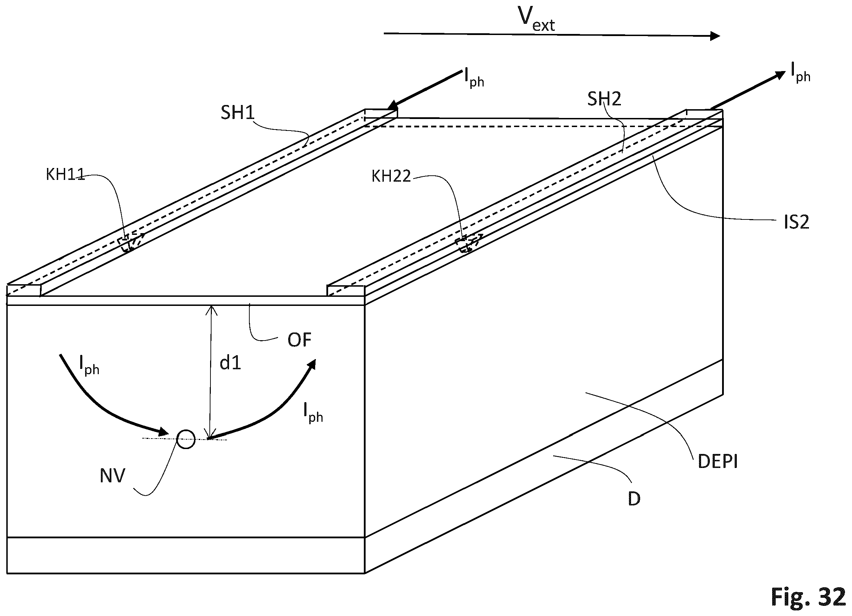

- Figur 32: zeigt eine Struktur eines Substrats (D) mit einer Vorrichtung zum Auslesen des Fotostroms (I_{Ph}) eines paramagnetischen Zentrums als Quantenpunkt (NV).

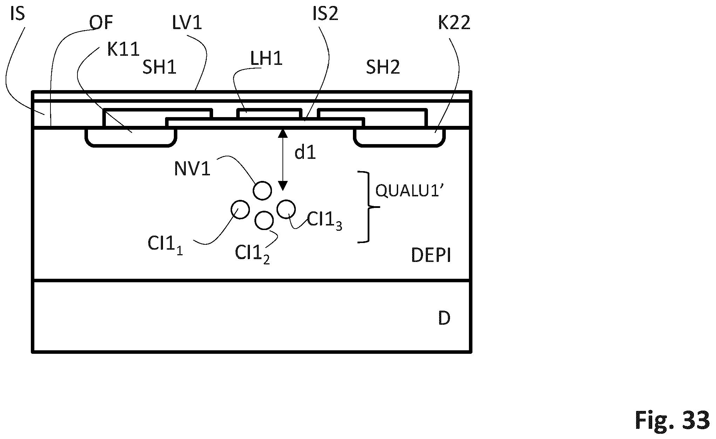

- Figur 33: zeigt eine Teilvorrichtung der Figur 20 in Form einer QuantenALU, wobei die Teilvorrichtung ein Transistor ist.

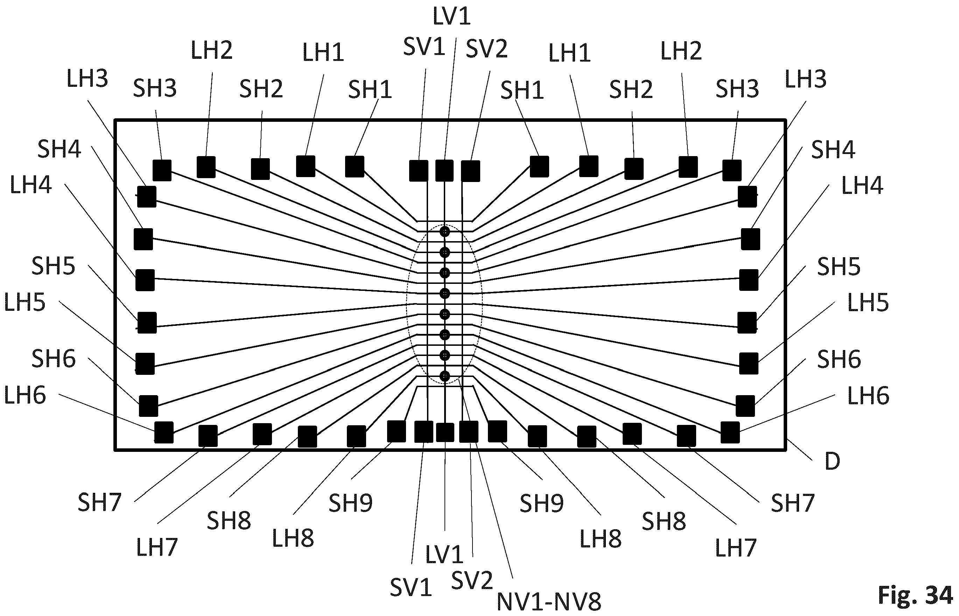

- Figur 34: zeigt eine vereinfachte Aufsicht auf die Oberfläche eines Substrats (D) mit beispielhaft acht Quantenbits (NV1 bis NV8), die als schwarze Kreise in einer senkrechten Linie gleich beabstandet angeordnet und angedeutet sind.

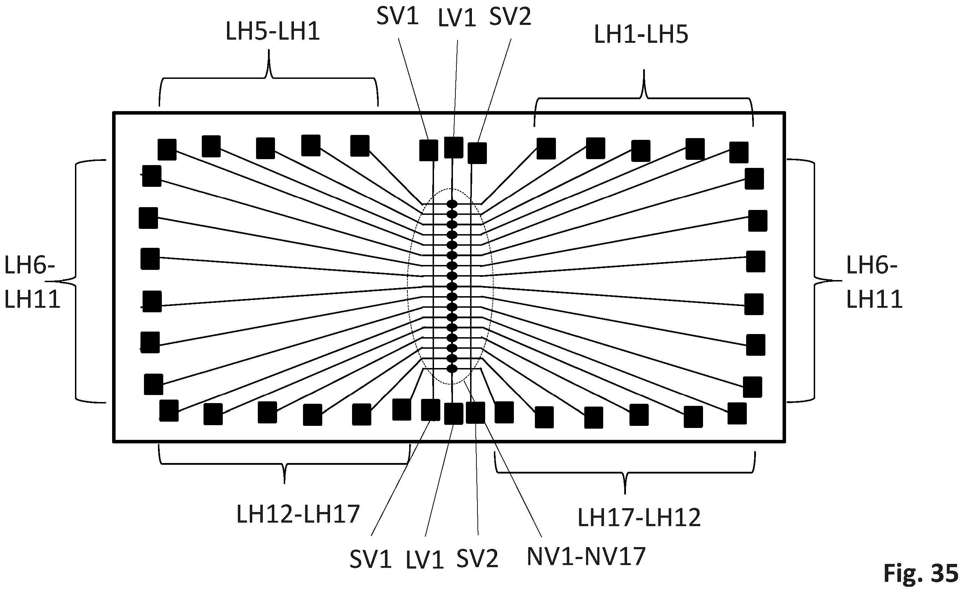

- Figur 35: entspricht der Figur 34 mit dem Unterschied, dass keine horizontalen Schirmleitungen vorgesehen sind.

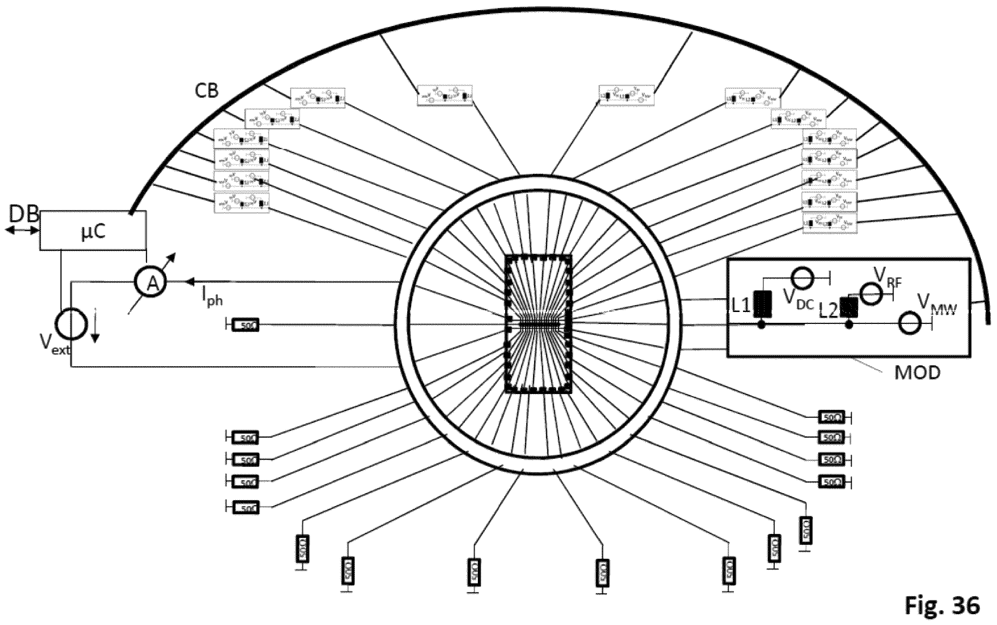

- Figur 36: zeigt das Substrat der Figur 35 eingebaut in ein Ansteuersystem analog zu Figur 23.

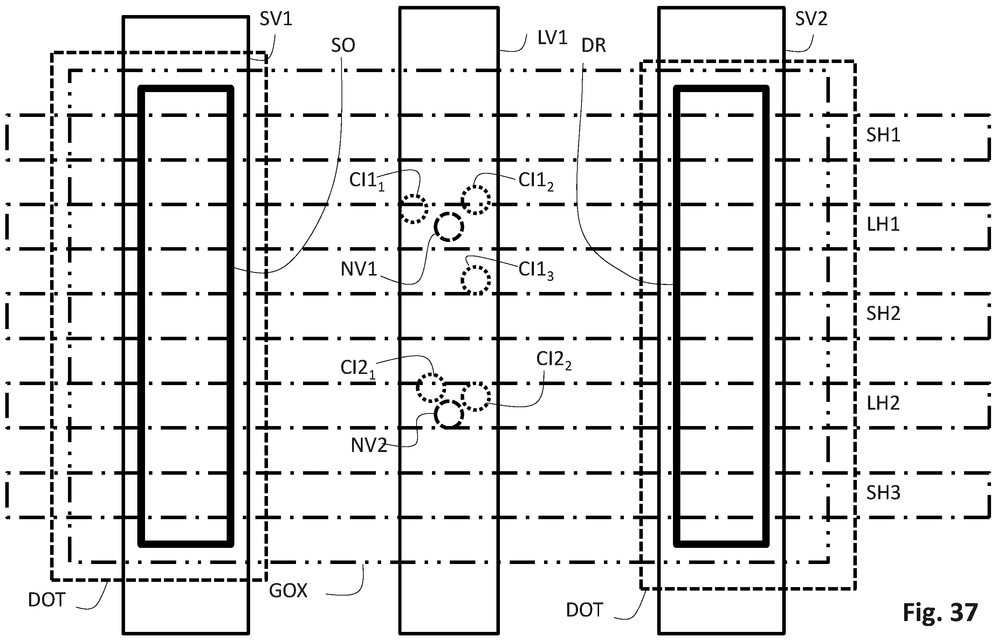

- Figur 37: zeigt einen beispielhaften Transistor, der als Quantencomputer betrieben wird in der Aufsicht von oben vereinfacht schematisch.
- Figur 38: zeigt ein beispielhaftes Quantencomputersystem (QUSYS) mit einer beispielhaften zentralen Steuereinheit (ZSE).

### Beschreibung der Figuren

### Figur 1

Die Figur 1 zeigt ein beispielhaftes Quantenbit (QUB). Das Substrat (D) besitzt eine Unterseite (US). Besonders bevorzugt ist das Substrat aus Diamant oder Silizium oder Siliziumkarbid oder aus einen anderen Element der IV. Hauptgruppe des Periodensystems oder einem Mischkristall aus Elementen der IV. Hauptgruppe des Periodensystems gefertigt. Bevorzugt weisen die Isotope des Substrats (D) im Wesentlichen kein magnetisches Kernmoment µ auf. Eine epitaktische Schicht (DEPI) ist zur Verbesserung der elektronischen Eigenschaften auf dem Substrat (D) aufgebracht. Bevorzugt umfasst das Substrat (D) und/oder die epitaktische Schicht (DEPI) im Wesentlichen nur Isotope ohne ein magnetisches Kernmoment µ. Bevorzugt umfasst das Substrat (D) und/oder die epitaktische Schicht (DEPI) im Wesentlichen nur einen Isotopentyp eines Isotops ohne ein magnetisches Kernmoment µ.Das Paket aus Substrat (D) und epitaktischer Schicht (DEPI) besitzt eine Oberfläche (OF). Auf der Oberfläche (OF) ist eine horizontale Leitung (LH) aufgebracht, die von einem mit einer horizontalen Modulation modulierten horizontalen elektrischen Strom (IH) durchströmt wird. Die Oberfläche (OF) und die horizontale Leitung (LH) sind von einer Isolation (IS) bedeckt. Ggf. befindet sich eine weitere Isolation zwischen der horizontalen Leitung (LH) und der Oberfläche (OF), um die horizontale Leitung elektrisch zu isolieren. Auf der Isolation (IS) ist eine vertikale Leitung (LV) aufgebracht, die von einem mit einer vertikalen Modulation modulierten vertikalen elektrischen Strom (IV) durchströmt wird. Die horizontale Leitung (LH) und die vertikale Leitung (LV) sind bevorzugt gegeneinander elektrisch isoliert. Bevorzugt ist der Winkel α zwischen der horizontalen Leitung (LH) und der vertikalen Leitung (LV) ein rechter Winkel. Die horizontale Leitung (LH) und die vertikale Leitung (LV) kreuzen sich an dem Durchtrittspunkt (LOTP) einer virtuellen Lot-Linie (LOT) durch die Oberfläche (OF). Bevorzugt befindet sich direkt unter dem Kreuzungspunkt (LOTP) der Quantenpunkt (NV) in einem ersten Abstand (d1) unter der Oberfläche (OF) in der epitaktischen Schicht (DEPI). Im Falle von Diamant als Material der epitaktischen Schicht (DEPI) kann der Quantenpunkt (NV) beispielsweise ein NV-Zentrum sein. Im Falle von Silizium als Material der epitaktischen Schicht (DEPI) kann der Quantenpunkt (NV) beispielsweise ein G-Zentrum sein. Im Falle von Siliziumkarbid als Material der epitaktischen Schicht (DEPI) kann der Quantenpunkt (NV) beispielsweise ein V_{Si}-Zentrum sein. Ist die vertikale Modulation des vertikalen Stromes (IV) gegenüber der horizontalen Modulation das horizontalen Stromes (IH) um +/- π/2 verschoben, so ergibt sich dann am Ort des Quantenpunkts (NV) beispielsweise ein rotierendes Magnetfeld (B_{NV}), das den Quantenpunkt (NV) beeinflusst. Dieses kann zur Manipulation des Quantenpunkts (NV) benutzt werden. Hierbei wird die Frequenz so gewählt, dass der Quantenpunkt (NV) in Resonanz mit dem rotierenden Magnetfeld (B_{NV}) gerät. Die zeitliche Dauer des Pulses bestimmt dann den Drehwinkel der Quanteninformation. Die Polarisationsrichtung bestimmt die Richtung.

### Figur 2

Figur 2 zeigt ein Kernquantenbit (CQUB). Sie entspricht der Figur 1 mit dem Unterschied, dass der Quantenpunkt (NV) der Figur 1. Durch einen Kernquantenpunkt (CI), der bevorzugt durch ein Isotop mit einem magnetischen Kernspin gebildet wird, ersetzt ist. Im Falle von Diamant als Material der epitaktischen Schicht (DEPI) kann der Kernquantenpunkt (CI) beispielsweise ein ¹³C-Isotop sein. Im Falle von Silizium als Material der epitaktischen Schicht (DEPI) kann der Kernquantenpunkt (CI) beispielsweise ein ²⁹Si-isotop sein. Im Falle von Siliziumkarbid als Material der epitaktischen Schicht (DEPI) kann der Kernquantenpunkt (CI) beispielsweise ein ²⁹Si-Isotop oder ein ¹³C-Isotop sein.

### Figur 3

Figur 3 zeigt ein beispielhaftes Quantenregister (QUREG) mit einem ersten Quantenbit (QUB1) und einem zweiten Quantenbit (QUB2). Die Quantenbits (QUB1, QUB2) des Quantenregisters (QUREG) besitzen ein gemeinsames Substrat (D) und eine gemeinsame epitaktische Schicht (DEPI). Die horizontale Leitung des ersten Quantenbits (QUB1) ist die horizontale Leitung (LH). Die horizontale Leitung des zweiten Quantenbits (QUB2) ist in diesem Beispiel ebenfalls die horizontale Leitung (LH). Die vertikale Leitung des ersten Quantenbits (QUB1) ist die erste vertikale Leitung (LV1). Die vertikale Leitung des zweiten Quantenbits (QUB2) ist die zweite vertikale Leitung (LV2). Die horizontale Leitung (LH) und die erste vertikale Leitung (LV1) kreuzen bevorzugt oberhalb des ersten Quantenpunkts (NV1), der bevorzugt in einem ersten Abstand (d1) unter der Oberfläche liegt, in einem bevorzugt rechten Winkel (*α*11). Die horizontale Leitung (LH) und die zweite vertikale Leitung (LV2) kreuzen bevorzugt oberhalb des zweiten Quantenpunkts (NV2), der bevorzugt in einem zweiten Abstand (d2) unter der Oberfläche liegt, in einem bevorzugt rechten Winkel (α12). Bevorzugt sind der erste Abstand (d1) und der zweite Abstand (d2) ähnlich zueinander. Bei NV-Zentren in Diamant liegen diese Abstände (d1, d2) bevorzugt bei 10nm bis 20nm. Bei G-Zentren in Silizium liegen diese Abstände (d1, d2) bevorzugt ebenfalls bei 10nm bis 20nm. Bei V_{Si}-Zentren in Siliziumkarbid liegen diese Abstände (d1, d2) bevorzugt ebenfalls bei 10nm bis 20nm. Die horizontale Leitung (LH) wird durch einen mit einer horizontalen Modulation modulierten horizontalen Strom (IH) durchströmt. Die erste vertikale Leitung (LV1) wird durch einen mit einer ersten vertikalen Modulation modulierten ersten vertikalen Strom (IV1) durchströmt. Die zweite vertikale Leitung (LV2) wird durch einen mit einer zweiten vertikalen Modulation modulierten zweiten vertikalen Strom (IV2) durchströmt. Der erste Quantenpunkt (NV1) ist vom zweiten Quantenpunkt (NV2) mit einem Abstand (sp12) beabstandet.

### Figur 4

Figur 4 zeigt ein beispielhaftes Kern-Kern-Quantenregister (CCQUREG) mit einem ersten Kernquantenbit (CQUB1) und einem zweiten Kernquantenbit (CQUB2). Die Figur 4 entspricht der Figur 3 mit dem Unterschied, dass der erste Quantenpunkt (NV1) durch einen ersten Kernquantenpunkt (CI1) ersetzt ist und dass der zweite Quantenpunkt (NV2) durch einen zweiten Kernquantenpunkt (CI2) ersetzt ist. Der erste Kernquantenpunkt (CI1) ist vom zweiten Kernquantenpunkt (CI2) mit einem Abstand (sp12') beabstandet.

### Figur 5

Figur 5 zeigt ein beispielhaftes Kern-Elektron-Quantenregister (CEQUREG). Es entspricht weitestgehend einer Kombination der Figuren 1 und 2. Verglichen mit Figur 1 ist der Quantenpunkt (NV) der Figur 1 nun durch die Kombination aus einem Quantenpunkt (NV) und einem Kernquantenpunkt (CI) ersetzt. Diese Kombination ist gleichzeitig die einfachste Form einer QuantenALU (QUALU). Der Quantenpunkt (NV) befindet sich dabei in einem Abstand (d1) unter der Oberfläche (OF) im Substrat (D) oder der epitaktischen Schicht (DEPI). Der Kernquantenpunkt (NV) befindet sich dabei in einem Abstand (d1') unter der Oberfläche (OF) im Substrat (D) oder der epitaktischen Schicht (DEPI). Die Abstände (d1, d1') sind bevorzugt annähernd gleich.

### Figur 6

Figur 6 zeigt ein beispielhaftes Kern-Elektron-Kern-Elektron-Quantenregister (CECEQUREG). Es entspricht weitestgehend einer Kombination der Figuren 3 und 4 und 5. Verglichen mit Figur 3 sind der Quantenpunkte (NV1, NV2) der Figur 6 nun jeweils durch eine Kombination aus einem Quantenpunkt (NV) und einem Kernquantenpunkt (CI) ersetzt. Dies ist die einfachste Form eines Quantenbusses (QUBUS) mit einer ersten QuantenALU (NV1, CI1) und einer zweiten QuantenALU (NV2, CI2). Dabei können der erste Kernquantenpunkt (CI1) und der zweite Kernquantenpunkt (CI2) mit Hilfe des ersten Quantenpunktes (NV1) und des zweiten Quantenpunkts (NV2) miteinander verschränkt werden. Dabei dienen der erste Quantenpunkt (NV1) und der zweite Quantenpunkt (NV2) bevorzugt dem Transport der Abhängigkeit und der erste Kernquantenpunkt (CI1) und der zweite Kernquantenpunkt (CI2) den Berechnungen und der Speicherung. Ausgenutzt wird hierbei, dass die Reichweite der Kopplung der Quantenpunkte (NV1, NV2) untereinander größer ist als die Reichweite der Kernquantenpunkte (CI1, CI2) untereinander und dass die T2-Zeit der Kernquantenpunkte (CI1, CI2) länger ist als die der Quantenpunkte (NV1, NV2). Typischerweise ist der Abstand zwischen dem ersten Kernquantenpunkt (CI1) und dem zweiten Quantenpunkt (NV2) größer als die Elektron-Kern-Kopplungsreichweite, sodass der Zustand des ersten Kernquantenpunkts (CI1) den Zustand des zweiten Quantenpunkts (NV2) nicht beeinflussen kann und der Zustand des zweiten Quantenpunkts (NV2) den Zustand des ersten Kernquantenpunkts (CI1) nicht beeinflussen kann. Typischerweise ist der Abstand zwischen dem zweiten Kernquantenpunkt (CI2) und dem ersten Quantenpunkt (NV1) größer als die Elektron-Kern-Kopplungsreichweite, sodass der Zustand des zweiten Kernquantenpunkts (CI2) den Zustand des ersten Quantenpunkts (NV1) nicht beeinflussen kann und der Zustand des ersten Quantenpunkts (NV1) den Zustand des zweiten Kernquantenpunkts (CI2) nicht beeinflussen kann. Typischerweise ist der Abstand zwischen dem ersten Quantenpunkt (NV1) und dem zweiten Quantenpunkt (NV2) kleiner als die Elektron-Elektron-Kopplungsreichweite, sodass der Zustand des ersten Quantenpunkts (NV1) den Zustand des zweiten Quantenpunkts (NV2) beeinflussen kann und der Zustand des zweiten Quantenpunkts (NV2) den Zustand des ersten Quantenpunkts (NV1) beeinflussen kann.

### Figur 7

Figur 7 zeigt das beispielhafte Quantenregister (QUREG) der Figur 3 mit einer zweiten vertikalen Abschirmleitung (SV2). Diese technische Lehre kann ggf. auch auf die Register der Figuren 4 und 6 angewendet werden. Die Abschirmleitung ermöglicht die Einspeisung eines weiteren Stromes zur Verbesserung der Selektion der Quantenpunkte während der Ausführung der Operationen durch Bestromung der vertikalen und horizontalen Leitungen.

### Figur 8

Figur 8 zeigt ein beispielhaftes Quantenregister (QUREG) mit einer zweiten vertikalen Abschirmleitung (SV2) und mit einer ersten vertikalen Abschirmleitung (SV1) mit einer dritten vertikalen Abschirmleitung (SV3). Diese technische Lehre kann ggf. auch auf die Register der Figuren 4 und 6 angewendet werden. Die zusätzlichen Abschirmleitungen ermöglichen die Einspeisung weiterer Stromes zur Verbesserung der Selektion der Quantenpunkte während der Ausführung der Operationen durch Bestromung der vertikalen und horizontalen Leitungen. Die beiden zusätzlichen Leitungen ermöglichen eine noch bessere Einstellung.

### Figur 9

Figur 9 zeigt ein beispielhaftes Quantenbit (QUB) mit beispielhaften Kontakten (KHa, KHb, KVa) zum elektrischen Auslesen der Fotoelektronen in Form eines Fotostromes (I_{Ph}) und eine symbolische Darstellung des Quantenbits (QUB). Die symbolische Darstellung zeigt den Quantenpunkt (NV) als Kreis in der Mitte und die horizontale Leitung (LH) als horizontalen Strich und die vertikale Leitung (LV) als vertikalen Strich. Diese beispielhafte symbolische Darstellung wird im Folgenden zur Verdeutlichung der Konstruktion komplexerer Zusammenschaltungen von Quantenbits, Kernquantenbits und QuantenALUs verwendet.

### Figur 10

Figur 10 zeigt die beispielhafte symbolische Darstellung eines beispielhaften eindimensionalen Quantenregisters (QREG1D) mit drei Quantenbits (QUB1, QUB2, QUB3).

Das erste Quantenbit (QUB1) des beispielhaften eindimensionalen Quantenregisters (QREG1D) umfasst die erste horizontale Leitung (LH1) und die erste vertikale Leitung (LV1) sowie den ersten Quantenpunkt der ersten Reiher und ersten Spalte (NV11).

Das zweite Quantenbit (QUB2) des beispielhaften eindimensionalen Quantenregisters (QREG1D) umfasst die erste horizontale Leitung (LH1) und die zweite vertikale Leitung (LV2) sowie den zweiten Quantenpunkt der zweiten Spalte und ersten Reihe (NV21).

Das dritte Quantenbit (QUB3) des beispielhaften eindimensionalen Quantenregisters (QREG1D) umfasst die erste horizontale Leitung (LH1) und die dritte vertikale Leitung (LV3) sowie den dritten Quantenpunkt der dritten Spalte und ersten Reihe (NV31).

Die erste horizontale Leitung (LH1) wird mit einem ersten horizontalen Strom (IH1) bestromt.

Die erste vertikale Leitung (LV1) wird mit einem ersten vertikalen Strom (IV1) bestromt.

Die zweite vertikale Leitung (LV2) wird mit einem zweiten vertikalen Strom (IV2) bestromt.

Die dritte vertikale Leitung (LV3) wird mit einem dritten vertikalen Strom (IV3) bestromt.

### Figur 11

Figur 11 zeigt die beispielhafte symbolische Darstellung eines beispielhaften eindimensionalen Kernquantenregisters (CCQREG1D) mit drei Kernquantenbits (CQUB1, CQUB2, CQUB3).

Das erste Kernquantenbit (CQUB1) des beispielhaften eindimensionalen Kernquantenregisters (CCQREG1D) umfasst die erste horizontale Leitung (LH1) und die erste vertikale Leitung (LV1) sowie den ersten Kernquantenpunkt der ersten Reihe und ersten Spalte (CI11).

Das zweite Kernquantenbit (CQUB2) des beispielhaften eindimensionalen Kernquantenregisters (CCQREG1D) umfasst die erste horizontale Leitung (LH1) und die zweite vertikale Leitung (LV2) sowie den zweiten Kernquantenpunkt der zweiten Spalte und ersten Reihe (CI21).

Das dritte Kernquantenbit (CQUB3) des beispielhaften eindimensionalen Kernquantenregisters (CCQREG1D) umfasst die erste horizontale Leitung (LH1) und die dritte vertikale Leitung (LV3) sowie den dritten Kernquantenpunkt der dritten Spalte und ersten Reihe (CI31).

Die erste horizontale Leitung (LH1) wird mit einem ersten horizontalen Strom (IH1) bestromt.

Die erste vertikale Leitung (LV1) wird mit einem ersten vertikalen Strom (IV1) bestromt.

Die zweite vertikale Leitung (LV2) wird mit einem zweiten vertikalen Strom (IV2) bestromt.

Die dritte vertikale Leitung (LV3) wird mit einem dritten vertikalen Strom (IV3) bestromt.

### Figur 12

Figur 12 zeigt die beispielhafte symbolische Darstellung eines beispielhaften zweidimensionalen Quantenregisters (QREG2D) mit drei mal drei Quantenbits (QUB11, QUB12, QUB13, QUB21, QUB22, QUB23, QUB31, QUB32, QUB33) und zugehörigen drei mal drei Quantenpunkten (NV11, NV12, NV13, NV21, NV22, NV23, NV31, NV32, NV33).

Das Quantenbit (QUB11) des beispielhaften eindimensionalen Quantenregisters (QREG1D) in der ersten Reihe und ersten Spalte umfasst die erste horizontale Leitung (LH1) und die erste vertikale Leitung (LV1) sowie den Quantenpunkt der ersten Reihe und ersten Spalte (NV11).

Das Quantenbit (QUB12) des beispielhaften eindimensionalen Quantenregisters (QREG1D) in der ersten Reihe und zweiten Spalte umfasst die erste horizontale Leitung (LH1) und die zweite vertikale Leitung (LV2) sowie den Quantenpunkt der ersten Reihe und zweiten Spalte (NV12).

Das Quantenbit (QUB13) des beispielhaften eindimensionalen Quantenregisters (QREG1D) in der ersten Reihe und dritten Spalte umfasst die erste horizontale Leitung (LH1) und die dritte vertikale Leitung (LV3) sowie den Quantenpunkt der ersten Reihe und dritten Spalte (NV13).

Das Quantenbit (QUB21) des beispielhaften eindimensionalen Quantenregisters (QREG1D) in der zweiten Reihe und ersten Spalte umfasst die zweite horizontale Leitung (LH2) und die erste vertikale Leitung (LV1) sowie den Quantenpunkt der zweiten Reihe und ersten Spalte (NV21).

Das Quantenbit (QUB22) des beispielhaften eindimensionalen Quantenregisters (QREG1D) in der zweiten Reihe und zweiten Spalte umfasst die zweite horizontale Leitung (LH2) und die zweite vertikale Leitung (LV2) sowie den Quantenpunkt der zweiten Reihe und zweiten Spalte (NV22).

Das Quantenbit (QUB23) des beispielhaften eindimensionalen Quantenregisters (QREG1D) in der zweiten Reihe und dritten Spalte umfasst die zweite horizontale Leitung (LH2) und die dritte vertikale Leitung (LV3) sowie den Quantenpunkt der zweiten Reihe und dritten Spalte (NV23).

Das Quantenbit (QUB31) des beispielhaften eindimensionalen Quantenregisters (QREG1D) in der dritten Reihe und ersten Spalte umfasst die dritte horizontale Leitung (LH3) und die erste vertikale Leitung (LV1) sowie den Quantenpunkt der dritten Reihe und ersten Spalte (NV31).

Das Quantenbit (QUB32) des beispielhaften eindimensionalen Quantenregisters (QREG1D) in der dritten Reihe und zweiten Spalte umfasst die dritte horizontale Leitung (LH3) und die zweite vertikale Leitung (LV2) sowie den Quantenpunkt der dritten Reihe und zweiten Spalte (NV32).

Das Quantenbit (QUB33) des beispielhaften eindimensionalen Quantenregisters (QREG1D) in der dritten Reihe und dritten Spalte umfasst die dritte horizontale Leitung (LH3) und die dritte vertikale Leitung (LV3) sowie den Quantenpunkt der dritten Reihe und dritten Spalte (NV33).

Die erste horizontale Leitung (LH1) wird mit einem ersten horizontalen Strom (IH1) bestromt.

Die zweite horizontale Leitung (LH2) wird mit einem zweiten horizontalen Strom (IH2) bestromt.

Die dritte horizontale Leitung (LH3) wird mit einem dritten horizontalen Strom (IH3) bestromt.

Die erste vertikale Leitung (LV1) wird mit einem ersten vertikalen Strom (IV1) bestromt.

Die zweite vertikale Leitung (LV2) wird mit einem zweiten vertikalen Strom (IV2) bestromt.

Die dritte vertikale Leitung (LV3) wird mit einem dritten vertikalen Strom (IV3) bestromt.

### Figur 13

Figur 13 zeigt die symbolische Darstellung eines zweidimensionalen Kernquantenregisters (CCQREG2D) mit drei mal drei Kernquantenbits (CQUB11, CQUB12, CQUB13, CQUB21, CQUB22, CQUB23, CQUB31, CQUB32, CQUB33) und entsprechenden drei mal drei Kernquantenpunkten (CI11, CI12, CI13, CI21, CI22, CI23, CI31, CI32, CI33).

Das Kernquantenbit (CQUB11) des beispielhaften eindimensionalen Kernquantenregisters (CCQREG2D) in der ersten Reihe und ersten Spalte umfasst die erste horizontale Leitung (LH1) und die erste vertikale Leitung (LV1) sowie den Kernquantenpunkt der ersten Reihe und ersten Spalte (CI11).

Das Kernquantenbit (CQUB12) des beispielhaften eindimensionalen Kernquantenregisters (CCQREG2D) in der ersten Reihe und zweiten Spalte umfasst die erste horizontale Leitung (LH1) und die zweite vertikale Leitung (LV2) sowie den Kernquantenpunkt der ersten Reihe und zweiten Spalte (CI12).

Das Kernquantenbit (CQUB13) des beispielhaften eindimensionalen Kernquantenregisters (CCQREG2D) in der ersten Reihe und dritten Spalte umfasst die erste horizontale Leitung (LH1) und die dritte vertikale Leitung (LV3) sowie den Kernquantenpunkt der ersten Reihe und dritten Spalte (CI13).

Das Kernquantenbit (CQUB21) des beispielhaften eindimensionalen Kernquantenregisters (CCQREG2D) in der zweiten Reihe und ersten Spalte umfasst die zweite horizontale Leitung (LH2) und die erste vertikale Leitung (LV1) sowie den Kernquantenpunkt der zweiten Reihe und ersten Spalte (CI21).

Das Kernquantenbit (CQUB22) des beispielhaften eindimensionalen Kernquantenregisters (CCQREG2D) in der zweiten Reihe und zweiten Spalte umfasst die zweite horizontale Leitung (LH2) und die zweite vertikale Leitung (LV2) sowie den Kernquantenpunkt der zweiten Reihe und zweiten Spalte (CI22).

Das Kernquantenbit (CQUB23) des beispielhaften eindimensionalen Kernquantenregisters (CCQREG2D) in der zweiten Reihe und dritten Spalte umfasst die zweite horizontale Leitung (LH2) und die dritte vertikale Leitung (LV3) sowie den Kernquantenpunkt der zweiten Reihe und dritten Spalte (CI23).

Das Kernquantenbit (CQUB31) des beispielhaften eindimensionalen Kernquantenregisters (CCQREG2D) in der dritten Reihe und ersten Spalte umfasst die dritte horizontale Leitung (LH3) und die erste vertikale Leitung (LV1) sowie den Kernquantenpunkt der dritten Reihe und ersten Spalte (CI31).

Das Kernquantenbit (QUB32) des beispielhaften eindimensionalen Kernquantenregisters (CCQREG2D) in der dritten Reihe und zweiten Spalte umfasst die dritte horizontale Leitung (LH3) und die zweite vertikale Leitung (LV2) sowie den Kernquantenpunkt der dritten Reihe und zweiten Spalte (C132).

Das Kernquantenbit (CQUB33) des beispielhaften eindimensionalen Kernquantenregisters (CCQREG2D) in der dritten Reihe und dritten Spalte umfasst die dritte horizontale Leitung (LH3) und die dritte vertikale Leitung (LV3) sowie den Kernquantenpunkt der dritten Reihe und dritten Spalte (CI33).

Die erste horizontale Leitung (LH1) wird mit einem ersten horizontalen Strom (IH1) bestromt.

Die zweite horizontale Leitung (LH2) wird mit einem zweiten horizontalen Strom (IH2) bestromt.

Die dritte horizontale Leitung (LH3) wird mit einem dritten horizontalen Strom (IH3) bestromt.

Die erste vertikale Leitung (LV1) wird mit einem ersten vertikalen Strom (IV1) bestromt.

Die zweite vertikale Leitung (LV2) wird mit einem zweiten vertikalen Strom (IV2) bestromt.

Die dritte vertikale Leitung (LV3) wird mit einem dritten vertikalen Strom (IV3) bestromt.

### Figur 14

Figur 14 zeigt einen beispielhaften zeitlichen Amplitudenverlauf der horizontalen Stromkomponente des horizontalen Stromes (IH) und der vertikalen Stromkomponente des vertikalen Stromes (IV) in Abhängigkeit von der Zeit (t) mit einer Phasenverschiebung von +/- π/2 zur Erzeugung eines zirkular polarisierten elektromagnetischen Feldes am Ort des Quantenpunkts (NV) bzw. des Kernquantenpunkts (CI).

### Figur 15 und 16

Figur 15 und 16 dienen der Veranschaulichung einer optimalen Bestromung. Zunächst wird hier auf Figur 15 eingegangen. Am Beispiel eines Quantenbits (QUB) mit einer ersten vertikalen Abschirmleitung (SV1) und einer zweiten vertikalen Abschirmleitung (SV2) wird das Prinzip dargestellt. Die Zeichnung entspricht im Wesentlichen der Figur 9. Zusätzlich sind eine erste vertikale Abschirmleitung (SV1) und eine zweite vertikale Abschirmleitung (SV2) und eine erste horizontale Abschirmleitung (SH1) eingezeichnet. Parallel zu einem ersten Lot (LOT) durch den Quantenpunkt (NV) können eine erste weitere Lot-Line (VLOT1) und eine zweite weitere Lot-Linie (VLOT2) durch die jeweiligen Kreuzungspunkte der entsprechenden vertikalen Abschirmleitungen (SV1, SV2) mit der horizontalen Leitung (LH) gezeichnet werden. In dem Abstand (d1) des Quantenpunkts (NV) von der Oberfläche (OF) können dann ein erster virtueller vertikaler Quantenpunkt (VVNV1) und ein zweiter virtueller Quantenpunkt (VVNV2) definiert werden. Der erste vertikale elektrische Abschirmstrom (ISV1) durch die erste vertikale Abschirmleitung (SV1) und der zweite vertikale elektrische Abschirmstrom (ISV2) durch die zweite vertikale Abschirmleitung (SV2) und der erste horizontale elektrische Abschirmstrom (ISH1) durch die erste horizontale Abschirmleitung (SH1) und der nicht eingezeichnete zweite horizontale elektrische Abschirmstrom (ISH2) durch die nicht eingezeichnete zweite horizontale Abschirmleitung (SH2) sowie der horizontale Strom (IH) durch die horizontale Leitung (IH) und der vertikale Strom (IV) durch die vertikale Leitung ergeben zusammen sechs Parameter, die frei gewählt werden können. Nun kann die Flussdichte (B_{NV}) des zirkular polarisierten elektromagnetischen Wellenfelds zur Manipulation des Quantenpunkts (NV) am Ort des Quantenpunkts (NV) vorgegeben werden und verlangt werden, dass die erste virtuelle horizontale magnetische Flussdichte (B_{VHNV1}) am Ort des ersten virtuellen horizontalen Quantenpunkts (VHNV1) und die zweite virtuelle horizontale magnetische Flussdichte (B_{VHNV2}) am Ort des zweiten virtuellen horizontalen Quantenpunkts (VHNV2) und die erste virtuelle vertikale magnetische Flussdichte (B_{VVNV}) am Ort des ersten virtuellen vertikalen Quantenpunkts (VVNV1) und die zweite virtuelle vertikale magnetische Flussdichte (B_{VVNV2}) am Ort des zweiten virtuellen vertikalen Quantenpunkts (VVNV2) verschwinden. Der erste virtuelle horizontale Quantenpunkt (VHNV1) und der zweite virtuelle horizontale Quantenpunkt (VHNV2) sind in der Figur nicht eingezeichnet, da die Figur einen Querschnitt darstellt und für die Sichtbarkeit die Schnittfläche um 90° um die LOT-Achse gedreht werden muss. Figur 16 stellt diesen Schnitt dar. Figur 16 dient der Veranschaulichung einer optimalen Bestromung am Beispiels eines Quantenbits (QUB) mit einer ersten horizontalen Abschirmleitung (SH1) und einer zweiten horizontalen Abschirmleitung (SH2). Durch diese ausgewogene Bestromung kann das unbeabsichtigte Ansprechen von Quantenpunkten minimiert werden.

### Figur 17

Figur 17 zeigt die symbolische Darstellung eines drei Bit Quantenregisters oder Kernquantenregisters mit vier horizontalen Abschirmleitungen (SH1, SH2, SH3, SH4) und zwei vertikalen Abschirmleitungen (SV1, SV2) und mit einer gemeinsamen ersten vertikalen Ansteuerleitung (LV1) und mit drei horizontalen Leitungen (LH1, LH2, LH3).

Die erste horizontale Abschirmleitung (SH1) wird mit dem ersten horizontalen Abschirmstrom (ISH1), der durch die erste horizontale Abschirmleitung (SH1) fließt, bestromt.

Die zweite horizontale Abschirmleitung (SH2) wird mit dem zweiten horizontalen Abschirmstrom (ISH2), der durch die zweite horizontale Abschirmleitung (SH1) fließt, bestromt.

Die dritte horizontale Abschirmleitung (SH3) wird mit dem dritten horizontalen Abschirmstrom (ISH3), der durch die dritte horizontale Abschirmleitung (SH3) fließt, bestromt.

Die vierte horizontale Abschirmleitung (SH4) wird mit dem vierten horizontalen Abschirmstrom (ISH4), der durch die vierte horizontale Abschirmleitung (SH4) fließt, bestromt.

Die erste vertikale Abschirmleitung (SV1) wird mit dem ersten vertikalen Abschirmstrom (ISV1), der durch die erste vertikale Abschirmleitung (SV1) fließt, bestromt.

Die zweite vertikale Abschirmleitung (SV2) wird mit dem zweiten vertikalen Abschirmstrom (ISV2), der durch die zweite vertikale Abschirmleitung (SV2) fließt, bestromt.

Die erste horizontale Leitung (LH1) wird mit dem ersten horizontalen Strom (IH1), der durch die erste horizontale Leitung (LH1) fließt, bestromt.

Die zweite horizontale Leitung (LH2) wird mit dem zweiten horizontalen Strom (IH2), der durch die zweite horizontale Leitung (LH2) fließt, bestromt.

Die dritte horizontale Leitung (LH3) wird mit dem dritten horizontalen Strom (IH3), der durch die dritte horizontale Leitung (LH3) fließt, bestromt.

Die erste vertikale Leitung (LV1) wird mit dem ersten vertikalen Strom (IV1), der durch die erste vertikale Leitung (LV1) fließt, bestromt.

Wie leicht erkennbar ist, werden drei Szenarien benötigt, die sicherstellen, dass immer nur ein Quantenpunkt bestromt wird.

Wir nehmen zuerst an, dass es sich um Quantenbits (QUB1, QUB2, QUB3) mit drei Quantenpunkten (NV1, NV2, NV3) handelt.

Im ersten Szenario A werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{NV1}) des zirkular polarisierten elektromagnetischen Wellenfelds zur Manipulation des ersten Quantenpunkts (NV1) am Ort des ersten Quantenpunkts (NV1) von Null verschieden ist und die Flussdichte (B_{NV2}) des zirkular polarisierten elektromagnetischen Wellenfelds zur Manipulation des zweiten Quantenpunkts (NV2) am Ort des zweiten Quantenpunkts (NV2) gleich oder nahezu gleich Null ist und die Flussdichte (B_{NV3}) des zirkular polarisierten elektromagnetischen Wellenfelds zur Manipulation des dritten Quantenpunkts (NV3) am Ort des dritten Quantenpunkts (NV3) gleich Null oder nahezu null ist.

Im zweiten Szenario B werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{NV1}) des zirkular polarisierten elektromagnetischen Wellenfelds zur Manipulation des ersten Quantenpunkts (NV1) am Ort des ersten Quantenpunkts (NV1) gleich Null oder nahezu null ist und die Flussdichte (B_{NV2}) des zirkular polarisierten elektromagnetischen Wellenfelds zur Manipulation des zweiten Quantenpunkts (NV2) am Ort des zweiten Quantenpunkts (NV2) von Null verschieden ist und die Flussdichte (B_{NV3}) des zirkular polarisierten elektromagnetischen Wellenfelds zur Manipulation des dritten Quantenpunkts (NV3) am Ort des dritten Quantenpunkts (NV3) gleich Null oder nahezu null ist.

Im dritten Szenario C werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{NV1}) des zirkular polarisierten elektromagnetischen Wellenfelds zur Manipulation des ersten Quantenpunkts (NV1) am Ort des ersten Quantenpunkts (NV1) gleich Null oder nahezu null ist und die Flussdichte (B_{NV2}) des zirkular polarisierten elektromagnetischen Wellenfelds zur Manipulation des zweiten Quantenpunkts (NV2) am Ort des zweiten Quantenpunkts (NV2) gleich Null oder nahezu null ist und die Flussdichte (B_{NV3}) des zirkular polarisierten elektromagnetischen Wellenfelds zur Manipulation des dritten Quantenpunkts (NV3) am Ort des dritten Quantenpunkts (NV3) von Null verschieden ist.

Offensichtlich kann dann mit dem Szenario A das erste Quantenbit (QUB1) mit dem ersten Quantenpunkt (NV1) selektiert und manipuliert werden, ohne die anderen Quantenbits (QUB2, QUB3) mit den anderen Quantenpunkten (NV2, NV3) zu beeinflussen.

Offensichtlich kann dann mit dem Szenario B das zweite Quantenbit (QUB2) mit dem zweiten Quantenpunkt (NV2) selektiert und manipuliert werden, ohne die anderen Quantenbits (QUB1, QUB3) mit den anderen Quantenpunkten (NV1, NV3) zu beeinflussen.

Offensichtlich kann dann mit dem Szenario C das dritte Quantenbit (QUB3) mit dem dritten Quantenpunkt (NV3) selektiert und manipuliert werden, ohne die anderen Quantenbits (QUB1, QUB2) mit den anderen Quantenpunkten (NV1, NV2) zu beeinflussen.

Dieses Szenario kann für lineare Quantenregister wie in Figur 17 für beliebig lange Quantenregister mit mehr als 3 Quantenbits beliebig erweitert werden.

Nun stellen wir uns vor, dass die Punkte in Figur 17 nicht Quantenpunkte, sondern Kernquantenpunkte sind.

Wir nehmen zuerst an, dass es sich um Kernquantenbits (CQUB1, CQUB2, CQUB3) mit drei Kernquantenpunkten (CI1, CI2, CI3) handelt.

Im ersten Szenario A werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{CI1}) des zirkular polarisierten elektromagnetischen Wellenfelds zur Manipulation des ersten Kernquantenpunkts (CI1) am Ort des ersten Kernquantenpunkts (CI1) von Null verschieden ist und die Flussdichte (B_{CI2}) des zirkular polarisierten elektromagnetischen Wellenfelds zur Manipulation des zweiten Kernquantenpunkts (CI2) am Ort des zweiten Kernquantenpunkts (CI2) gleich oder nahezu gleich Null ist und die Flussdichte (B_{CI3}) des zirkular polarisierten elektromagnetischen Wellenfelds zur Manipulation des dritten Kernquantenpunkts (CI3) am Ort des dritten Kernquantenpunkts (CI3) gleich Null oder nahezu null ist.

Im zweiten Szenario B werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{CI1}) des zirkular polarisierten elektromagnetischen Wellenfelds zur Manipulation des ersten Kernquantenpunkts (CI1) am Ort des ersten Kernquantenpunkts (CI1) gleich Null oder nahezu null ist und die Flussdichte (B_{CI2}) des zirkular polarisierten elektromagnetischen Wellenfelds zur Manipulation des zweiten Kernquantenpunkts (CI2) am Ort des zweiten Kernquantenpunkts (CI2) von Null verschieden ist und die Flussdichte (B_{CI3}) des zirkular polarisierten elektromagnetischen Wellenfelds zur Manipulation des dritten Kernquantenpunkts (CI3) am Ort des dritten Kernquantenpunkts (CI3) gleich Null oder nahezu null ist.

Im dritten Szenario C werden die vertikalen Abschirmströme (ISV1, ISV2) und die horizontalen Abschirmströme (ISH1, ISH2, ISH3, ISH4) und der erste vertikale Strom (IV1) und die horizontalen Ströme (IH1, IH2, IH3) so gewählt, dass die Flussdichte (B_{CI1}) des zirkular polarisierten elektromagnetischen Wellenfelds zur Manipulation des ersten Kernquantenpunkts (CI1) am Ort des ersten Kernquantenpunkts (CI1) gleich Null oder nahezu null ist und die Flussdichte (B_{CI2}) des zirkular polarisierten elektromagnetischen Wellenfelds zur Manipulation des zweiten Kernquantenpunkts (CI2) am Ort des zweiten Kernquantenpunkts (CI2) gleich Null oder nahezu null ist und die Flussdichte (B_{CI3}) des zirkular polarisierten elektromagnetischen Wellenfelds zur Manipulation des dritten Kernquantenpunkts (CI3) am Ort des dritten Kernquantenpunkts (CI3) von Null verschieden ist.

Offensichtlich kann dann mit dem Szenario A das erste Kernquantenbit (CQUB1) mit dem ersten Kernquantenpunkt (CI1) selektiert und manipuliert werden, ohne die anderen Kernquantenbits (CQUB2, CQUB3) mit den anderen Kernquantenpunkten (CI2, CI3) zu beeinflussen.

Offensichtlich kann dann mit dem Szenario B das zweite Kernquantenbit (CQUB2) mit dem zweiten Kernquantenpunkt (CI2) selektiert und manipuliert werden, ohne die anderen Kernquantenbits (CQUB1, CQUB3) mit den anderen Kernquantenpunkten (CI1, CI3) zu beeinflussen.

Offensichtlich kann dann mit dem Szenario C das dritte Kernquantenbit (CQUB3) mit dem dritten Kernquantenpunkt (CI3) selektiert und manipuliert werden, ohne die anderen Kernquantenbits (CCQUB2) mit den anderen Kernquantenpunkten (CI1, CI2) zu beeinflussen.

Dieses Szenario kann für lineare Kernquantenregister wie in Figur 17 für beliebig lange Kernquantenregister mit mehr als 3 Kernquantenbits beliebig erweitert werden.

Wie leicht erkennbar ist, können 10 Ströme frei gewählt werden. Es müssen aber nur drei magnetische Flussdichten bestimmt werden. Daher ist das System mit sehr vielen Freiheitsgraden versehen. Es können also theoretisch die Abschirmleitungen (SH1, SH2, SH3, SH4, SV1, SV2) bei einem solchen Szenario weggelassen werden. Sofern mehr als zwei Metallisierungslagen vorgesehen werden, ist es sinnvoll, wenn einige Abschirmleitungen in einem anderen Winkel als 0° oder 90° über die Quantenpunkte geführt werden, um lokal das Magnetfeld durch die gemeinsame vertikale Leitung (LV1) kompensieren zu können.

### Figur 18

Figur 18 zeigt die symbolische Darstellung eines zweidimensionalen drei x drei Bit Quantenregisters oder Kernquantenregisters mit Abschirmleitungen und Kontakten zum Auslesen der Fotoelektronen in Form von Fotoströmen (Iₚₕ).

Die Vorrichtung weist vier horizontalen Abschirmleitungen (SH1, SH2, SH3, SH4) und vier vertikalen Abschirmleitungen (SV1, SV2, SV3, SV4) und mit drei vertikalen Ansteuerleitungen (LV1, LV2, LV3) und mit drei horizontalen Leitungen (LH1, LH2, LH3) auf.

Die erste horizontale Abschirmleitung (SH1) wird mit dem ersten horizontalen Abschirmstrom (ISH1), der durch die erste horizontale Abschirmleitung (SH1) fließt, bestromt.

Die zweite horizontale Abschirmleitung (SH2) wird mit dem zweiten horizontalen Abschirmstrom (ISH2), der durch die zweite horizontale Abschirmleitung (SH1) fließt, bestromt.

Die dritte horizontale Abschirmleitung (SH3) wird mit dem dritten horizontalen Abschirmstrom (ISH3), der durch die dritte horizontale Abschirmleitung (SH3) fließt, bestromt.

Die vierte horizontale Abschirmleitung (SH4) wird mit dem vierten horizontalen Abschirmstrom (ISH4), der durch die vierte horizontale Abschirmleitung (SH4) fließt, bestromt.

Die erste vertikale Abschirmleitung (SV1) wird mit dem ersten vertikalen Abschirmstrom (ISV1), der durch die erste vertikale Abschirmleitung (SV1) fließt, bestromt.

Die zweite vertikale Abschirmleitung (SV2) wird mit dem zweiten vertikalen Abschirmstrom (ISV2), der durch die zweite vertikale Abschirmleitung (SV2) fließt, bestromt.

Die dritte vertikale Abschirmleitung (SV3) wird mit dem dritten vertikalen Abschirmstrom (ISV3), der durch die dritte vertikale Abschirmleitung (SV3) fließt, bestromt.

Die vierte vertikale Abschirmleitung (SV4) wird mit dem vierten vertikalen Abschirmstrom (ISV4), der durch die vierte vertikale Abschirmleitung (SV4) fließt, bestromt.

Die erste horizontale Leitung (LH1) wird mit dem ersten horizontalen Strom (IH1), der durch die erste horizontale Leitung (LH1) fließt, bestromt.

Die zweite horizontale Leitung (LH2) wird mit dem zweiten horizontalen Strom (IH2), der durch die zweite horizontale Leitung (LH2) fließt, bestromt.

Die dritte horizontale Leitung (LH3) wird mit dem dritten horizontalen Strom (IH3), der durch die dritte horizontale Leitung (LH3) fließt, bestromt.

Die erste vertikale Leitung (LV1) wird mit dem ersten vertikalen Strom (IV1), der durch die erste vertikale Leitung (LV1) fließt, bestromt.

Die zweite vertikale Leitung (LV2) wird mit dem zweiten vertikalen Strom (IV2), der durch die zweite vertikale Leitung (LV2) fließt, bestromt.

Die dritte vertikale Leitung (LV3) wird mit dem dritten vertikalen Strom (IV3), der durch die dritte vertikale Leitung (LV3) fließt, bestromt.

Wie leicht zu verstehen ist, bestehen 14 Freiheitsgrade bei 9 Punkten, die zu lösen sind. Bevorzugt sollte das Gitter der Abschrimleitungen um 45° gegen die horizontalen Leitungen und vertikalen Leitungen verdreht werden, was aber einen bei den notwendigen Dimensionen schwierigen Lithografieprozess erfordert.

### Figur 19

Figur 19 zeigt ein beispielhaftes zwei Bit Quantenregister (QUREG) mit einer gemeinsamen ersten horizontalen Leitung (LH1), mehreren Abschirmleitungen und zwei Quantenpunkten (NV1, NV2). Die

Figur 19 entspricht weitestgehend der Figur 8. Nun ist zusätzlich zur Erläuterung des Ausleseprozesses eine erste horizontale Abschrimleitung (SH1) parallel zu der ersten horizontalen Leitung (LH1) eingezeichnet. Da es sich um ein Querschnittsbild handelt ist die entsprechende zweite horizontale Abschirmleitung (SH2) die auf der anderen Seite der ersten horizontalen Leitung (LH1) ebenfalls parallel zu dieser verläuft, nicht eingezeichnet. Durch Kontakte (KV11, KH11, KV12, KH12, KV13) sind die Abschirmleitungen in diesem Beispiel mit dem Substrat verbunden. Wird nun ein Extraktionsfeld zwischen zwei parallellaufende Abschirmleitungen durch Anlegen einer Extraktionsspannung zwischen diesen angelegt, so kommt es zu einem messbaren Stromfluss, wenn die Quantenpunkte (NV1, NV2) mit grünem Licht bestrahlt werden und diese sich im richtigen Quantenzustand befinden. Weiteres kann beispielsweise in Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogenvacancy centers in diamond", Science 363, 728-731 (2019) 15 February 2019 gefunden werden. Besonders bevorzugt wird diese Konstruktion in linearen Vorrichtungen, wie beispielsweise die der Figur 10, eingesetzt.

### Figur 20

Figur 20 entspricht der Figur 19 mit dem Unterschied, dass nun die Quantenpunkte (NV1, NV2) jeweils Teil mehrerer Kern-Elektron-Quantenregister sind. Jeder Quantenpunkt (NV1, NV2) ist in dem Beispiel der Figur 20 Teil einer QuantenALU (QUALU1, QUALU2).

Der erste Quantenpunkt (NV1) der ersten QuantenALU (QUALU1) kann im Beispiel der Figur 20 mit einem ersten Kernquantenpunkt (CI1₁) der ersten QuantenALU (QUALU1) wechselwirken, wenn die erste vertikale Leitung (LV1) und die erste horizontale Leitung (LH1) mit einem ersten vertikalen Strom (IV1) und einem ersten horizontalen Strom (IH1) bestromt werden, die mit einer ersten Elektron-Kern-Radiowellenresonanzfrequenz (f_{RWEC1_1}) für die erste QuantenALU (QUALU1) oder einer ersten Kern-Elektron- Mikrowellenresonanzfrequenz (f_{MWCE1}_₁) für die erste QuantenALU (QUALU1) moduliert sind. Diese erste Elektron-Kern-Radiowellenresonanzfrequenz (f_{RWEC1_1}) für die erste QuantenALU (QUALU1) und diese erste Kern-Elektron- Mikrowellenresonanzfrequenz (f_{MWCE1_1}) für die erste QuantenALU (QUALU1) werden bevorzugt in einem Initialisierungsschritt einmalig durch eine OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Der erste Quantenpunkt (NV1) der ersten QuantenALU (QUALU1) kann in dem Beispiel der Figur 20 mit einem zweiten Kernquantenpunkt (CI1₂) der ersten QuantenALU (QUALU1) wechselwirken, wenn die erste vertikale Leitung (LV1) und die erste horizontale Leitung (LH1) mit einem ersten vertikalen Strom (IV1) und einem ersten horizontalen Strom (IH1) bestromt werden, die mit einer zweiten Elektron-Kern-Radiowellenresonanzfrequenz (f_{RWEC2_1}) für die erste QuantenALU (QUALU1) oder einer zweiten Kern-Elektron- Mikrowellenresonanzfrequenz (f_{MWCE2_1}) für die erste QuantenALU (QUALU1) moduliert sind. Diese zweite Elektron-Kern-Radiowellenresonanzfrequenz (f_{RWEC2_1}) für die erste QuantenALU (QUALU1) und diese zweite Kern-Elektron- Mikrowellenresonanzfrequenz (f_{MWCE2_1}) für die erste QuantenALU (QUALU1) werden bevorzugt in dem besagten Initialisierungsschritt einmalig durch eine weitere OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Der erste Quantenpunkt (NV1) der ersten QuantenALU (QUALU1) kann in dem Beispiel der Figur 20 mit einem dritten Kernquantenpunkt (CI1₃) der ersten QuantenALU (QUALU1) wechselwirken, wenn die erste vertikale Leitung (LV1) und die erste horizontale Leitung (LH1) mit einem ersten vertikalen Strom (IV1) und einem ersten horizontalen Strom (IH1) bestromt werden, die mit einer dritten Elektron-Kern-Radiowellenresonanzfrequenz (f_{RWEC3_1}) für die erste QuantenALU (QUALU1) oder einer dritte Kern-Elektron- Mikrowellenresonanzfrequenz (f_{MWCE3_1}) für die erste QuantenALU (QUALU1) moduliert sind. Diese dritte Elektron-Kern-Radiowellenresonanzfrequenz (f_{RWEC3_1}) für die erste QuantenALU (QUALU1) und diese dritte Kern-Elektron- Mikrowellenresonanzfrequenz (f_{MWCE3_1}) für die erste QuantenALU (QUALU1) werden bevorzugt in dem besagten Initialisierungsschritt einmalig durch eine weitere OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Der zweite Quantenpunkt (NV2) der zweiten QuantenALU (QUALU2) kann Beispiel der Figur 20 mit einem ersten Kernquantenpunkt (CI2₁) der zweiten QuantenALU (QUALU2) wechselwirken, wenn die zweite vertikale Leitung (LV2) und die erste horizontale Leitung (LH1) mit einem zweiten vertikalen Strom (IV2) und einem ersten horizontalen Strom (IH1) bestromt werden, die mit einer ersten Elektron-Kern-Radiowellenresonanzfrequenz (f_{RWEC1_2}) für die zweite QuantenALU (QUALU2) oder einer ersten Kern-Elektron- Mikrowellenresonanzfrequenz (f_{MWCE1_2}) für die zweite QuantenALU (QUALU2) moduliert sind. Diese erste Elektron-Kern-Radiowellenresonanzfrequenz (f_{RWEC1_2}) für die zweite QuantenALU (QUALU2) und diese erste Kern-Elektron- Mikrowellenresonanzfrequenz (f_{MWCE1_2}) für die zweite QuantenALU (QUALU2) werden bevorzugt in einem Initialisierungsschritt einmalig durch eine OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Der zweite Quantenpunkt (NV2) der zweiten QuantenALU (QUALU2) kann in dem Beispiel der Figur 20 mit einem zweiten Kernquantenpunkt (CI2₂) der zweiten QuantenALU (QUALU2) wechselwirken, wenn die zweite vertikale Leitung (LV2) und die erste horizontale Leitung (LH1) mit einem zweiten vertikalen Strom (IV2) und einem ersten horizontalen Strom (IH1) bestromt werden, die mit einer zweiten Elektron-Kern-Radiowellenresonanzfrequenz (f_{RWEC2_2}) für die zweite QuantenALU (QUALU2) oder einer zweiten Kern-Elektron- Mikrowellenresonanzfrequenz (f_{MWCE2_2}) für die zweite QuantenALU (QUALU2) moduliert sind. Diese zweite Elektron-Kern-Radiowellenresonanzfrequenz (f_{RWEC2_2}) für die zweite QuantenALU (QUALU2) und diese zweite Kern-Elektron-Mikrowellenresonanzfrequenz (f_{MWCE2_2}) für die zweite QuantenALU (QUALU2) werden bevorzugt in dem besagten Initialisierungsschritt einmalig durch eine weitere OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Der zweite Quantenpunkt (NV2) der zweiten QuantenALU (QUALU2) kann in dem Beispiel der Figur 20 mit einem dritten Kernquantenpunkt (CI2₃) der zweiten QuantenALU (QUALU2) wechselwirken, wenn die zweite vertikale Leitung (LV2) und die erste horizontale Leitung (LH1) mit einem zweiten vertikalen Strom (IV2) und einem ersten horizontalen Strom (IH1) bestromt werden, die mit einer dritten Elektron-Kern-Radiowellenresonanzfrequenz (f_{RWEC3_2}) für die zweite QuantenALU (QUALU2) oder einer dritten Kern-Elektron- Mikrowellenresonanzfrequenz (f_{MWCE3_2}) für die zweite QuantenALU (QUALU2) moduliert sind. Diese dritte Elektron-Kern-Radiowellenresonanzfrequenz (f_{RWEC3_2}) für die zweite QuantenALU (QUALU2) und diese dritte Kern-Elektron- Mikrowellenresonanzfrequenz (f_{MWCE3_2}) für die zweite QuantenALU (QUALU2) werden bevorzugt in dem besagten Initialisierungsschritt einmalig durch eine weitere OMDR Messung gemessen. Die Messwerte werden in einem Speicher des Steuerrechners der Steuervorrichtung (µC) abgelegt, die dieser abruft, wenn das entsprechende Kern-Elektron-Quantenregister (CEQUREG) angesteuert werden soll. Der Steuerrechner der Steuervorrichtung (µC) stellt dann die Frequenzen entsprechend ein.

Da die Reichweite der Kopplung der Quantenpunkte (NV1, NV2) größer ist, können diese miteinander gekoppelt werden. Der zweite Quantenpunkt (NV2) der zweiten QuantenALU (QUALU2) kann in dem Beispiel der Figur 20 mit dem ersten Quantenpunkt (NV1) der ersten QuantenALU (QUALU1) wechselwirken, wenn die erste vertikale Leitung (LV1) und die die zweite vertikale Leitung (LV2) und die erste horizontale Leitung (LH1) mit einem ersten vertikalen Strom (IV1) und einem zweiten vertikalen Strom (IV2) und einem ersten horizontalen Strom (IH1) bestromt werden, die mit einer Elektron1-Elektron2- Mikrowellenresonanzfrequenz (f_{MWEE12}) für die Kopplung des ersten Quantenpunkts (NV1) der ersten QuantenALU (QUALU1) mit dem zweiten Quantenpunkt (NV2) der zweiten QuantenALU (QUALU2) moduliert sind. Diese Elektron1-Elektron2-Mikrowellenresonanzfrequenz (f_{MWEE12}) für die Kopplung des ersten Quantenpunkts (NV1) der ersten QuantenALU (QUALU1) wird bevorzugt in dem besagten Initialisierungsschritt einmalig durch eine weitere OMDR Messung gemessen. Die Messwerte werden in einem Speicher des Steuerrechners der Steuervorrichtung (µC) abgelegt, die dieser abruft, wenn das entsprechende Elektron-Elektron-Quantenregister (QUREG) umfassend den ersten Quantenpunkt (NV1) und den zweiten Quantenpunkt (NV2) angesteuert werden soll. Der Steuerrechner der Steuervorrichtung (µC) stellt dann die Frequenzen entsprechend ein.

### Figur 21

Figur 21 dient der nochmaligen Erläuterung des Quantenbusbetriebes. Sie entspricht im Wesentlichen der Figur 19. Die Quantenpunkte (NV) können über größere Entfernungen als die Kernquantenbits (CI) gekoppelt werden. Sie erfüllen die Funktion des sogenannten "flying Q-bits". , Die Quantenpunkte (NV) sind bei Verwendung von Diamant als Material des Substrats (D) bzw. des Materials der epitaktischen Schicht (DEPI) bevorzugt NV-Zentren, die in einer bevorzugt praktisch isotopenreinem ¹²C-Diamantschicht gefertigt sind. Die Quantenpunkte (NV) sind bei Verwendung von Silizium als Material des Substrats (D) bzw. des Materials der epitaktischen Schicht (DEPI) bevorzugt G-Zentren, die in einer bevorzugt praktisch isotopenreinem ²⁸Si-Siliziumschicht gefertigt sind. Die Quantenpunkte (NV) sind bei Verwendung von Siliziumkarbid als Material des Substrats (D) bzw. des Materials der epitaktischen Schicht (DEPI) bevorzugt V_{Si}-Zentren, die in einer bevorzugt praktisch isotopenreinem ²⁸Si¹²C-Siliziumkarbidschicht gefertigt sind. Mit den Quantenpunkten (NV) werden Abhängigkeiten über größere Entfernungen innerhalb der Vorrichtung transportiert, während die eigentliche Berechnung in den Kernquantenpunkten (CI) stattfindet. Die Kernquantenpunkte (CI) sind bei Verwendung von Diamant als Material des Substrats (D) bzw. des Materials der epitaktischen Schicht (DEPI) bevorzugt ¹³C-Isotope innerhalb des Diamantmaterials oder ¹⁵N Isotope als Stickstoffatome der besagten NV-Zentren. Die Kernquantenpunkte (CI) sind bei Verwendung von Silizium als Material des Substrats (D) bzw. des Materials der epitaktischen Schicht (DEPI) bevorzugt ²⁹Si-Isotope innerhalb des Siliziummaterials oder ¹³C Isotope als Kohlenstoffatome der besagten G-Zentren. Die Kernquantenpunkte (CI) sind bei Verwendung von Siliziumkarbid als Material des Substrats (D) bzw. des Materials der epitaktischen Schicht (DEPI) bevorzugt ¹³C-Isotope und/oder ²⁹Si-Isotope innerhalb des Siliziumkarbidmaterials. Die Verwendung von Kernquantenbits (CI) hat den Vorteil, dass die T2-Zeiten in den Kernquantenbits dann wesentlich länger sind. Die Quantenpunkte (NV1, NV2) spielen also in etwa die Rolle von Anschlüssen der QuantenALUs (QUALU1, QUALU2).

Dieser Quantenbus (QUBUS) bestehend aus einer mehr oder weniger verzweigten Kette von Quantenpunkten (NV1, NV2) und den lokalen Kernquantenpunkten (CI1₁, CI1₂, CI1₃, CI2₁, CI2₂, CI2₃), die über die Quantenpunkte (NV1, NV2) an den eigentlichen Quantenbus angeschlossen sind, stellt den Kern der Erfindung und das Herz des Quanten-Computers dar. Dabei kann der Quantenbus (QUBUS) so groß werden, dass nicht alle Kernquantenpunkte (CI1₁, CI1₂, CI1₃, CI2₁, CI2₂, CI2₃) mit allen Quantenpunkten (NV1, NV2) koppeln können. Ein Quantenbus (QUBUS) kann auch mehr als **zwei Quantenpunkte** (NV1, NV2) aufweisen, die beispielsweise längs einer geordneten Kette hintereinander angeordnet sein können, wobei immer je zwei benachbarte Quantenpunkte so nahe beieinanderstehen, dass dies miteinander koppeln können, während die Kopplung eines Quantenpunkts mit anderen als seinen maximal zwei unmittelbaren Nachbarn in dieser beispielhaft linearen Kette von Quantenpunkten aufgrund einer zu großen Entfernung nicht direkt möglich ist. In dem Fall kann der übernächste Quantenpunkt in der beispielhaften Kette von Quantenpunkten mit dem Quantenpunkt jedoch indirekt durch Kopplung mit dem nächsten Quantenpunkt, dem mit dem Quantenpunkt gekoppelt sein kann, gekoppelt werden. Unter Kopplung kann hier eine Verschränkung von Zuständen verstanden werden.

### Figur 22

Figur 22 zeigt beispielhaft die Anordnung für ein beispielhaftes Fünf-Bit-Quantenregister in stark vereinfachter Form in der Aufsicht. Die fünf Quantenpunkte (NV1, NV2, NV3, NV4, NV5) sind linear angeordnet und können durch eine gemeinsame erste horizontale Leitung (LH1) angesteuert werden. Senkrecht dazu sind in einer anderen Metallisierungsebene die erste vertikale Leitung (LV1) zur Ansteuerung des ersten Quantenpunkts (NV1) und die zweite vertikale Leitung (LV2) zur Ansteuerung des zweiten Quantenpunkts (NV2) und die dritte vertikale Leitung (LV3) zur Ansteuerung des dritten Quantenpunkts (NV3) und die vierte vertikale Leitung (LV4) zur Ansteuerung des vierten Quantenpunkts (NV4) und die fünfte vertikale Leitung (LV5) zur Ansteuerung des fünften Quantenpunkts (NV5) gefertigt. Die Vorrichtung des Beispiels der Figur 22 weist nur eine erste horizontale Abschirmleitung (SH1) und eine zweite horizontale Abschirmleitung (SH2) auf. Vertikale Abschirmleitungen sind in dem Beispiel nicht vorgesehen. Durch Anlegen einer Extraktionsspannung (Vₑₓₜ) zwischen der horizontalen Abschirmleitung (SH1) und der zweiten horizontalen Abschirmleitung (SH2) können die Fotoelektronen ausgelesen werden.

### Figur 23

Figur 23 zeigt das Blockdiagramm eines beispielhaften Quantencomputers mit einem beispielhaften schematisch angedeuteten Drei-Bit-Quantenregister, das ggf. auch z.B. durch ein Drei-Bit-Kern-Elektron-Kern-Elektron-Quantenregister (CECEQUREG) mit drei QuantenALUs ersetzt werden könnte. Eine Erweiterung auf ein n-Bit-Quantenregister ist dem Fachmann leicht möglich.

Der Kern der beispielhaften Ansteuervorrichtung der Figur 23 ist eine Steuervorrichtung (µC) die bevorzugt ein Steuerrechner ist. Bevorzugt weist die Gesamtvorrichtung eine Magnetfeldkontrolle (MFC) auf, die ihre Betriebsparameter bevorzugt von der besagten Steuervorrichtung (µC) erhält und bevorzugt Betriebsstatusdaten an diese Steuervorrichtung (µC) zurückgibt. Die Magnetfeldkontrolle (MFC) ist bevorzugt ein Regler, dessen Aufgabe es ist, ein externes magnetisches Feld durch aktive Gegenregelung zu kompensieren. Bevorzugt nutzt die Magnetfeldkontrolle (MFC) hierfür einen Magnetfeldsensor (MFS), der bevorzugt den magnetischen Fluss in der Vorrichtung bevorzugt in der Nähe der Quantenpunkte erfasst. Bevorzugt handelt es sich bei dem Magnetfeldsensor (MFS) um einen Quantensensor. Hier sei auf die Anmeldungen DE 10 2018 127 394.0, DE 10 2019 130 114.9, DE 10 2019 120 076.8 und DE 10 2019 121 137.9 verwiesen. Mit Hilfe einer Magnetfeldkontrollvorrichtung (MFK) regelt die Magnetfeldkontrolle (MFC) die magnetische Flussdichte nach. Bevorzugt wird ein Quantensensor verwendet, da dieser die höhere Genauigkeit aufweist, um das Magnetfeld ausreichend zu stabilisieren.

Die Steuervorrichtung (µC) steuert bevorzugt über eine Kontrolleinheit A (CBA) die horizontalen und vertikalen Treiberstufen an, die bevorzugt die horizontalen Leitungen und vertikalen Leitungen mit den jeweiligen horizontalen und vertikalen Strömen bestromen und die richtigen Frequenzen und zeitlichen Burst-Dauern erzeugen.

Die Kontrolleinheit A stellt entsprechend den Vorgaben der Steuervorrichtung (µC) die Frequenz und die Pulsdauer des ersten horizontalen Abschirmstromes (ISH1) für die erste horizontale Abschirmleitung (SH1) in der ersten horizontalen Treiberstufe (HD1) ein.

Die Kontrolleinheit A stellt entsprechend den Vorgaben der Steuervorrichtung (µC) die Frequenz und die Pulsdauer des ersten horizontalen Stromes (IH1) für die erste horizontale Leitung (LH1) in der ersten horizontalen Treiberstufe (HD1) ein.

Die Kontrolleinheit A stellt entsprechend den Vorgaben der Steuervorrichtung (µC) die Frequenz und die Pulsdauer des zweiten horizontalen Abschirmstromes (ISH2) für die zweite horizontale Abschirmleitung (SH2) in der ersten horizontalen Treiberstufe (HD1) und der in der zweiten horizontalen Treiberstufe (HD2) ein.

Die Kontrolleinheit A stellt entsprechend den Vorgaben der Steuervorrichtung (µC) die Frequenz und die Pulsdauer des zweiten horizontalen Stromes (IH2) für die zweite horizontale Leitung (LH2) in der zweiten horizontalen Treiberstufe (HD2) ein.

Die Kontrolleinheit A stellt entsprechend den Vorgaben der Steuervorrichtung (µC) die Frequenz und die Pulsdauer des dritten horizontalen Abschirmstromes (ISH3) für die dritte horizontale Abschirmleitung (SH3) in der zweiten horizontalen Treiberstufe (HD2) und der in der dritten horizontalen Treiberstufe (HD3) ein.

Die Kontrolleinheit A stellt entsprechend den Vorgaben der Steuervorrichtung (µC) die Frequenz und die Pulsdauer des dritten horizontalen Stromes (IH3) für die dritte horizontale Leitung (LH3) in der dritten horizontalen Treiberstufe (HD3) ein.

Die Kontrolleinheit A stellt entsprechend den Vorgaben der Steuervorrichtung (µC) die Frequenz und die Pulsdauer des vierten horizontalen Abschirmstromes (ISH4) für die vierte horizontale Abschirmleitung (SH4) in der dritten horizontalen Treiberstufe (HD2) und in der vierten horizontalen Treiberstufe (HD4), die aus Platzmangel nur angedeutet ist, ein.

Die Kontrolleinheit A stellt entsprechend den Vorgaben der Steuervorrichtung (µC) die Frequenz und die Pulsdauer des ersten vertikalen Abschirmstromes (ISV1) für die erste vertikale Abschirmleitung (SV1) in der ersten vertikalen Treiberstufe (HV1) ein.

Die Kontrolleinheit A stellt entsprechend den Vorgaben der Steuervorrichtung (µC) die Frequenz und die Pulsdauer des ersten vertikalen Stromes (IV1) für die erste vertikale Leitung (LV1) in der ersten vertikalen Treiberstufe (VD1) ein.

Synchronisiert durch die Kontrolleinheit A speisen diese Treiberstufen (VD1, HD1, HD2, HD3, HD4) ihren Strom in einem festen Phasenverhältnis bezogen auf einen gemeinsamen Synchronisationszeitpunkt in die Leitungen (SV1, LV1, SV2, SH1, LH1, SH2, LH2, SH3, LH3, SH4) ein.

Zuvor konfiguriert eine Kontrolleinheit B eine erste horizontale Empfängerstufe (HS1) in der Art, dass sie die von der ersten horizontalen Treiberstufe (HD1) eingespeisten Ströme auf der anderen Seite der Leitungen wieder entnimmt.

Zuvor konfiguriert die Kontrolleinheit B eine zweite horizontale Empfängerstufe (HS2) in der Art, dass sie die von der zweiten horizontalen Treiberstufe (HD2) eingespeisten Ströme auf der anderen Seite der Leitungen wieder entnimmt.

Zuvor konfiguriert die Kontrolleinheit B eine dritte horizontale Empfängerstufe (HS3) in der Art, dass sie die von der dritten horizontalen Treiberstufe (HD3) eingespeisten Ströme auf der anderen Seite der Leitungen wieder entnimmt.

Zuvor konfiguriert die Kontrolleinheit B eine erste vertikale Empfängerstufe (VS1) in der Art, dass sie die von der ersten vertikalen Treiberstufe (VD1) eingespeisten Ströme auf der anderen Seite der Leitungen wieder entnimmt.

Des Weiteren weist das beispielhafte System der Figur 23 eine Lichtquelle (LED) für "grünes Licht" im Sinne dieser Schrift auf. Mittels eines Lichtquellentreibers (LEDDR) kann die Steuervorrichtung (µC) die Quantenpunkte mit dem "grünen Licht" bestrahlen. Bei Bestrahlung mit diesem "grünen Licht" werden Fotoelektronen erzeigt, die durch die erste horizontale Empfängerstufe (HS1) und/oder die zweite horizontale Empfängerstufe (HS2) und/oder die dritte horizontale Empfängerstufe (HS3) und/oder die erste vertikale Empfängerstufe (VS1) durch Anlegen eines Extraktionsfeldes beispielsweise an die angeschlossenen Abschirmleitungen abgesaugt werden können.

### Figur 24

Figur 24 zeigt eine beispielhafte symbolische horizontale Anordnung eines Kern-Elektron-Kern-Elektron-Quantenregister (CECEQUREG) mit zwei QuantenALUs (QUALU1, QUALU2). Die symbolische Darstellung korrespondiert mit der Darstellung eines Quantenbusses (QUBUS) mit zwei QuantenALUs (QUALU1, QUALU2) der Figur 20.

Da wir das Netzwerk im Folgenden immer komplexer aufbauen werden, werden die Indices bereits hier so gewählt, dass zweidimensionale und nicht nur lineare Anordnungen abgedeckt werden.

Ein erster Quantenpunkt (NV11) der ersten Zeile und ersten Spante der Anordnung und ein zweiter Quantenpunkt (NV12) der ersten Zeile und zweiten Zeile der Anordnung sind längs der ersten horizontalen Leitung (LH1) angeordnet. Der erste Quantenpunkt (NV11) und der zweite Quantenpunkt (NV12) bilden ein Quantenregister (QUREG1112). Der erste Quantenpunkt (NV11) in der ersten Zeile und ersten Spalte ist der Anschluss der ersten QuantenALU (QUALU11) in der ersten Zeile und ersten Spalte. Der erste Quantenpunkt (NV11) in der ersten Zeile und ersten Spalte ist der Anschluss der ersten QuantenALU (QUALU11) in der ersten Zeile und ersten Spalte. Der zweite Quantenpunkt (NV12) in der ersten Zeile und zweiten Spalte ist der Anschluss der zweiten QuantenALU (QUALU12) in der ersten Zeile und zweiten Spalte.

Dem ersten Quantenpunkt (NV11) der ersten Spalte und ersten Zeile ist eine erste vertikale Leitung (LV1) zugeordnet.

Dem zweiten Quantenpunkt (NV12) der zweiten Spalte und ersten Zeile ist eine zweite vertikale Leitung (LV2) zugeordnet.

Ein erster Kernquantenpunkt (CI11₁) der ersten QuantenALU (QUALU11) der ersten Spalte und ersten Zeile bildet zusammen mit dem ersten Quantenpunkt (NV11) der ersten Zeile und ersten Spalte ein erstes Kern-Elektron-Quantenregister (CEQUREG11₁) der ersten QuantenALU (QUALU11) der ersten Spalte und ersten Zeile.

Ein zweiter Kernquantenpunkt (CI11₂) der ersten QuantenALU (QUALU11) der ersten Spalte und ersten Zeile bildet zusammen mit dem ersten Quantenpunkt (NV11) der ersten Zeile und ersten Spalte ein zweites Kern-Elektron-Quantenregister (CEQUREG11₂) der ersten QuantenALU (QUALU11) der ersten Spalte und ersten Zeile.

Ein dritter Kernquantenpunkt (CI11₃) der ersten QuantenALU (QUALU11) der ersten Spalte und ersten Zeile bildet zusammen mit dem ersten Quantenpunkt (NV11) der ersten Zeile und ersten Spalte ein drittes Kern-Elektron-Quantenregister (CEQUREG11₃) der ersten QuantenALU (QUALU11) der ersten Spalte und ersten Zeile.

Ein vierter Kernquantenpunkt (CI11₄) der ersten QuantenALU (QUALU11) der ersten Spalte und ersten Zeile bildet zusammen mit dem ersten Quantenpunkt (NV11) der ersten Zeile und ersten Spalte ein viertes Kern-Elektron-Quantenregister (CEQUREG11₄) der ersten QuantenALU (QUALU11) der ersten Spalte und ersten Zeile.

Das vierte Kern-Elektron-Quantenregister (CEQUREG11₄) der ersten QuantenALU (QUALU11) der ersten Spalte und ersten Zeile und das dritte Kern-Elektron-Quantenregister (CEQUREG11₃) der ersten QuantenALU (QUALU11) der ersten Spalte und ersten Zeile und das zweite Kern-Elektron-Quantenregister (CEQUREG11₂) der ersten QuantenALU (QUALU11) der ersten Spalte und ersten Zeile und das erste Kern-Elektron-Quantenregister (CEQUREG11₁) der ersten QuantenALU (QUALU11) der ersten Spalte und ersten Zeile bilden die erste QuantenALU der ersten Zeile und ersten Spalte.

Ein erster Kernquantenpunkt (CI12₁) der zweiten QuantenALU (QUALU12) der zweiten Spalte und ersten Zeile bildet zusammen mit dem zweiten Quantenpunkt (NV12) der ersten Zeile und zweiten Spalte ein erstes Kern-Elektron-Quantenregister (CEQUREG12₁) der zweiten QuantenALU (QUALU12) der zweiten Spalte und ersten Zeile.

Ein zweiter Kernquantenpunkt (CI12₂) der zweiten QuantenALU (QUALU12) der zweiten Spalte und ersten Zeile bildet zusammen mit dem zweiten Quantenpunkt (NV12) der ersten Zeile und zweiten Spalte ein zweites Kern-Elektron-Quantenregister (CEQUREG12₂) der zweiten QuantenALU (QUALU12) der zweiten Spalte und ersten Zeile.

Ein dritter Kernquantenpunkt (CI12₃) der zweiten QuantenALU (QUALU12) der zweiten Spalte und ersten Zeile bildet zusammen mit dem zweiten Quantenpunkt (NV12) der ersten Zeile und zweiten Spalte ein drittes Kern-Elektron-Quantenregister (CEQUREG12₃) der zweiten QuantenALU (QUALU12) der zweiten Spalte und ersten Zeile.

Ein vierter Kernquantenpunkt (CI12₄) der zweiten QuantenALU (QUALU12) der zweiten Spalte und ersten Zeile bildet zusammen mit dem zweiten Quantenpunkt (NV12) der ersten Zeile und zweiten Spalte ein viertes Kern-Elektron-Quantenregister (CEQUREG12₄) der zweiten QuantenALU (QUALU12) der zweiten Spalte und ersten Zeile.

Das vierte Kern-Elektron-Quantenregister (CEQUREG12₄) der zweiten QuantenALU (QUALU12) der zweiten Spalte und ersten Zeile und das dritte Kern-Elektron-Quantenregister (CEQUREG12₃) der zweiten QuantenALU (QUALU12) der zweiten Spalte und ersten Zeile und das zweite Kern-Elektron-Quantenregister (CEQUREG12₂) der zweiten QuantenALU (QUALU12) der zweiten Spalte und ersten Zeile und das erste Kern-Elektron-Quantenregister (CEQUREG12₁) der zweiten QuantenALU (QUALU12) der zweiten Spalte und ersten Zeile bilden die zweite QuantenALU (QUALU12) der ersten Zeile und zweiten Spalte.

### Figur 25

Figur 25 zeigt eine beispielhafte symbolische horizontale Anordnung eines Kern-Elektron-Kern-Elektron-Quantenregister (CECEQUREG) mit vier QuantenALUs (QUALU1, QUALU2, QUALU3, QUALU4). Die Quantenpunkte der QuantenALUs sind längs der gemeinsamen ersten horizontalen Leitung (LH1) angeordnet.

Die erste QuantenALU (QUALU11) der ersten Spalte und ersten Zeile umfasst vier Kernquantenbits (CI11₁, CI11₂, CI11_{3;}, CI11₄). Sie wird zusätzlich durch eine erste vertikale Leitung (LV1) angesteuert.

Die zweite QuantenALU (QUALU12) der zweiten Spalte und ersten Zeile umfasst vier Kernquantenbits (CI12₁, C112₂, CI12₃, CI12₄). Sie wird zusätzlich durch eine zweite vertikale Leitung (LV2) angesteuert.

Die dritte QuantenALU (QUALU13) der dritten Spalte und ersten Zeile umfasst vier Kernquantenbits (CI13₁, CI13₂, CI13₃, CI13₄). Sie wird zusätzlich durch eine dritte vertikale Leitung (LV3) angesteuert.

Die vierte QuantenALU (QUALU14) der vierten Spalte und ersten Zeile umfasst vier Kernquantenbits (CI14₁, CI14₂, CI14₃, CI14₄). Sie wird zusätzlich durch eine vierte vertikale Leitung (LV4) angesteuert.

### Figur 26

Figur 26 zeigt eine beispielhafte symbolische horizontale Anordnung eines Kern-Elektron-Kern-Elektron-Quantenregister (CECEQUREG) mit vier QuantenALUs (QUALU11, QUALU12, QUALU13, QUALU23) über Eck.

Der Quantenpunkt (NV11) der ersten QuantenALU (QUALU11) der ersten Zeile und ersten Spalte und der Quantenpunkt (NV12) der zweiten QuantenALU (QUALU12) der ersten Zeile und zweiten Spalte und der Quantenpunkt (NV13) der dritten QuantenALU (QUALU13) der ersten Zeile und dritten Spalte sind längs der gemeinsamen ersten horizontalen Leitung (LH1) angeordnet.

Der Quantenpunkt (NV13) der dritten QuantenALU (QUALU13) der ersten Zeile und dritten Spalte und der Quantenpunkt (NV23) der vierten QuantenALU (QUALU23) der zweiten Zeile und dritten Spalte sind längs der gemeinsamen dritten vertikalen Leitung (LV3) angeordnet.

Die erste QuantenALU (QUALU11) der ersten Spalte und ersten Zeile umfasst vier Kernquantenbits (CI11₁, CI11₂, CI11₃, CI11₄). Sie wird zusätzlich durch eine erste vertikale Leitung (LV1) angesteuert.

Die zweite QuantenALU (QUALU12) der zweiten Spalte und ersten Zeile umfasst vier Kernquantenbits (CI12₁, C112₂, CI12₃, CI12₄). Sie wird zusätzlich durch eine zweite vertikale Leitung (LV2) angesteuert.

Die dritte QuantenALU (QUALU13) der dritten Spalte und ersten Zeile umfasst vier Kernquantenbits (CI13₁, CI13₂, CI13₃, CI13₄).

Die vierte QuantenALU (QUALU23) der dritten Spalte und zweiten Zeile umfasst vier Kernquantenbits (CI23₁, CI32₂, CI23₃, CI23₄). Sie wird zusätzlich durch eine zweite horizontale Leitung (LH2) angesteuert.

### Figur 27

Figur 27 zeigt eine beispielhafte symbolische horizontale Anordnung eines Kern-Elektron-Kern-Elektron-Quantenregister (CECEQUREG) mit fünf QuantenALUs (QUALU11, QUALU12, QUALU13, QUALU14, QUALU23) als Verzweigung.

Der Quantenpunkt (NV11) der ersten QuantenALU (QUALU11) der ersten Zeile und ersten Spalte und der Quantenpunkt (NV12) der zweiten QuantenALU (QUALU12) der ersten Zeile und zweiten Spalte und der Quantenpunkt (NV13) der dritten QuantenALU (QUALU13) der ersten Zeile und dritten Spalte und der Quantenpunkt (NV14) der vierten QuantenALU (QUALU14) der ersten Zeile und vierten Spalte sind längs der gemeinsamen ersten horizontalen Leitung (LH1) angeordnet.

Der Quantenpunkt (NV13) der dritten QuantenALU (QUALU13) der ersten Zeile und dritten Spalte und der Quantenpunkt (NV23) der fünften QuantenALU (QUALU23) der zweiten Zeile und dritten Spalte sind längs der gemeinsamen dritten vertikalen Leitung (LV3) angeordnet.

Die erste QuantenALU (QUALU11) der ersten Spalte und ersten Zeile umfasst vier Kernquantenbits (CI11₁, CI11₂, CI11₃, CI11₄). Sie wird zusätzlich durch eine erste vertikale Leitung (LV1) angesteuert.

Die zweite QuantenALU (QUALU12) der zweiten Spalte und ersten Zeile umfasst vier Kernquantenbits (CI12₁, C112₂, CI12₃, CI12₄). Sie wird zusätzlich durch eine zweite vertikale Leitung (LV2) angesteuert.

Die dritte QuantenALU (QUALU13) der dritten Spalte und ersten Zeile umfasst vier Kernquantenbits (CI13₁, CI13₂, CI13₃, CI13₄).

Die vierte QuantenALU (QUALU14) der vierten Spalte und ersten Zeile umfasst vier Kernquantenbits (CI14₁, CI14₂, CI14₃, CI14₄). Sie wird zusätzlich durch eine vierte vertikale Leitung (LV4) angesteuert.

Die fünfte QuantenALU (QUALU23) der dritten Spalte und zweiten Zeile umfasst vier Kernquantenbits (CI23₁, CI32₂, CI23₃, CI23₄). Sie wird zusätzlich durch eine zweite horizontale Leitung (LH2) angesteuert.

### Figur 28

Figur 28 zeigt eine beispielhafte symbolische horizontale Anordnung eines Kern-Elektron-Kern-Elektron-Quantenregister (CECEQUREG) mit acht QuantenALUs (QUALU11, QUALU12, QUALU13, QUALU21, QUALU23, QUALU31, QUALU32, QUALU33,) als Ring.

### Figur 29

Figur 29 zeigt eine Vorrichtung, die innerhalb eines Substrats (D) oder innerhalb einer epitaktischen Schicht (DEPI) untergebracht werden kann und somit in den vorausgehenden Vorrichtungen verwendet werden kann und bei der in dem Material des Substrats (D) oder der epitaktischen Schicht (DEPI) eine Strahlungsquelle gefertigt ist, die als Lichtquelle (LED) für das "grüne Licht" verwendet wird.

In dem Beispiel der Figur 29 injiziert ein Anoden-Kontakt (AN) einen elektrischen Strom in das Substrat (D) bzw. die epitaktische Schicht (DEPI). Auf B. Burchard "Elektronische und optoelektronische Bauelemente und Bauelementstrukturen auf Diamantbasis", Dissertation, Hagen 1994 und auf die Schrift DE 4 322 830 A1 wird in diesem Zusammenhang hingewiesen. Ein Kathoden-Kontakt (KTH) extrahiert diesen elektrischen Strom wieder aus dem Substrat (D) bzw. der epitaktischen Schicht (DEPI). Diese Diode hat hier die Funktion der Lichtquelle (LED). Ein im Strompfad innerhalb des Substrats (D) bzw. der epitaktischen Schicht (DEPI) liegendes Zentrum (PZ), dient als Strahlungsquelle dieser Lichtquelle (LED). Im Falle von Diamant als Substrat (D) bzw. die epitaktische Schicht (DEPI) kann es sich bei diesem Zentrum (PZ) beispielsweise um H3-Zentrum in dem beispielhaften Diamantmaterial, das als Substrat (D) bzw. epitaktische Schicht (DEPI) dient, handeln. Das Zentrum (PZ) emittiert in diesem Beispiel "grünes Licht" (LB) bei einem Stromfluss eines Pumpstromes (Iₚₘₚ) in dem Substrat (D) bzw. in der epitaktischen Schicht (DEPI). Im Falle von Diamant als Substrat (D) bzw. als epitaktischer Schicht (DEPI) emittiert das beispielhafte H3-Zentrum also "grünes Licht" (LB) bei einem Stromfluss eines Pumpstromes (Iₚₘₚ) in dem Diamanten als Substrat (D) bzw. als epitaktischer Schicht (DEPI) von dem Anoden-Kontakt (AN) zum Kathoden-Kontakt (KTH). Dieses "grüne Licht" (LB) des Zentrums (PZ), beispielsweise des besagten H3-Zentrums, kann dann dazu benutzt werden, ein oder mehrere Quantenpunkte (NV) in Form paramagnetischer Zentren anzusteuern und ggf. zurückzusetzen. Die Zentren (PZ) und/oder die Gruppen (PZC) der Zentren (PZ) können ein ein- oder zwei- oder dreidimensionales Gitter innerhalb des Substrats (D) bzw. der epitaktischen Schicht (DEPI) bilden. Im Falle eines eindimensionalen Gitters können die Zentren (PZ) beispielsweise kreisförmig um einen gemeinsamen Mittelpunkt herum angeordnet sein, wobei sich in dem Mittelpunkt dann bevorzugt ein Quantenpunkt (NV) in Form eines paramagnetischen Zentrums (NV) oder mehrere Quantenpunkte (NV) befinden. Bevorzugt bildet in einer Variante die Anordnung der Zentren PZ bzw. der Gruppen (PZC) der Zentren (PZ) zusammen mit der Anordnung der Quantenpunkte (NV) in Form paramagnetischer Zentren (NV) ein ein- zwei oder dreidimensionales Gitter, wobei die Elementarzelle des Gitters dann ein oder mehrere Zentren (PZ) und/oder eine oder mehrere Gruppen (PZC) von Zentren (PZ) einerseits und ein oder mehrere Quantenpunkte (NV) in Form paramagnetischer Zentren (NV) umfasst. Es kann sich um ein translatorisches und/oder rotatorisches Gitter um eine gemeinsame Symmetrieachse oder einen Symmetriepunkt handeln.

Zum Schluss sollte noch erwähnt werden, dass die Struktur der Figur 29 geeignet ist, das Zentrum (PZ) mit dem Quantenpunkt (NV) zu verschränken. Ggf. kann der optische Pfad zwischen Zentrum (PZ) und Quantenpunkt (NV) noch mit optischen Funktionselementen der Photonik wie Lichtwellenleitern, Linsen, Filtern, Blenden, photonischen Kristallen etc. ergänzt und ggf. modifiziert werden. Auf die zum Zeitpunkt der Anmeldung dieser Schrift noch unveröffentlichten Patentanmeldungen DE 10 2019 120 076.8, PCT / DE 2020 / 100 648 und DE 10 2019 121 028.3 wird an dieser Stelle verwiesen, deren Offenbarungsgehalt soweit rechtlich zulässig Teil dieser Offenlegung ist.

### Figur 30

Figur 30 zeigt eine vereinfachte Vorrichtung der Figur 1 mit einem Substrat (D), das im Falle von NV-Zentren als paramagnetischen Zentren (NV1) bevorzugt Diamant und im Falle von G-Zentren bevorzugt Silizium ist und im Falle von V_{Si}-Zentren bevorzugt Siliziumkarbid ist, mit einem oder mehreren paramagnetischen Zentren als Quantenpunkt (NV) bzw. Quantenpunkten (NV) in dem Substrat (D), wobei diese mit einer Leitung (LH), die auf der Oberfläche (OF) des Substrats (D) angebracht und befestigt ist und die bevorzugt von dem Substrat (D) beispielsweise durch eine Isolation (IS) elektrisch isoliert ist, aufgrund eines sehr geringen ersten Abstands (d1) von bevorzugt weniger als 100nm mit dem magnetischen Feld dieser Leitung (LH) wechselwirken, wenn die Leitung (LH) von einem elektrischen Strom (IH) durchströmt wird.

Bei der Ausarbeitung der Erfindung wurde erkannt, dass eine Spule zur Einkopplung einer Mikrowellenstrahlung und/oder zur Einstellung eines magnetischen Bias-Feldes in Form einer Bias-Flussdichte B₀, nicht notwendigerweise eine Windung oder einen Bogen aufweisen muss. Vielmehr ist es so, dass eine Leitung beispielsweise als mikrostrukturierte Leitung (LH, LV) beispielsweise auf der Oberfläche (OF) des Substrats (D) bzw. der epitaktischen Schicht (DEPI) gefertigt sein kann. Das paramagnetische Zentrum eines Quantenpunkts (NV) bzw. der Kernquantenpunkt (CI) kann wenige nm unter der Oberfläche (OF) des Substrats (D) bzw. der epitaktischen Schicht (DEPI) gefertigt sein. Dadurch kann sich der Quantenpunkt (NV) bzw. der Kernquantenpunkt (CI) im magnetischen Nahfeld der Leitung (LH, LV) befinden. Bevorzugt befinden sich der Quantenpunkt (NV) bzw. der Kernquantenpunkt (CI) in einem ersten Abstand (r) von weniger als 1µm, besser weniger als 500nm, besser weniger als 200nm, besser weniger als 100nm, besser weniger als 50nm, besser weniger als 20nm von der hier beispielhaft dargestellten horizontalen Leitung (LH) entfernt. Bei der Ausarbeitung der Erfindung wurde davon ausgegangen, dass die Leitung (LH) besonders bevorzugt weniger als 50nm von dem Quantenpunkt (NV) in Form eines paramagnetischen Zentrums entfernt ist. Durch diesen geringen Abstand können bereits mit betragsmäßig sehr geringen elektrischen Strömen (IH) in der Leitung (LH) erhebliche magnetische Flussdichten B am Ort des Quantenpunkts (NV) in Form des paramagnetischen Zentrums (NV) bzw. am Ort des Kernquantenpunkts (CI) erzeugt werden, die diese neben anderen möglicherweise relevanten physikalischen Parametern beeinflussen.

In dem Beispiel der Figur 30 wird eine Leitung (LH) mit einem Strom (IH) bestromt. In der Figur 30 ist die Leitung (LH) vorzugsweise gegenüber dem Substrat (D) bzw. der epitaktischen Schicht (DEPI) isoliert. Ggf. wird hierzu eine weitere Isolation genutzt, die zur Vereinfachung in der Figur 30 nicht eingezeichnet ist. Bevorzugt handelt es sich bei dieser weiteren, hier nicht eingezeichneten Isolation im Falle eines Substrats (D) bzw. einer epitaktischen Schicht (DEPI) aus Silizium oder Siliziumkarbid um eine Schicht aus Siliziumdioxid, die bevorzugt im Wesentlichen keine Isotope mit einem magnetischen Kernmoment aufweist. Bevorzugt handelt es sich in diesem Fall um ein Gate-Oxid. Bevorzugt handelt es sich in diesem Fall um ²⁸Si¹⁶ O₂.Bevorzugt befindet sich der Quantenpunkt (NV) in Form des paramagnetischen Zentrums bzw. der Kernquantenpunkt (CI) direkt unter der Leitung (LH) in einem Abstand (d1) unter der Oberfläche (OF) des Substrats (D) bzw. der epitaktischen Schicht (DEPI). In einer Variante ist der Abstand (d1) bevorzugt sehr klein gewählt. Bevorzugt ist der Abstand (d1) kleiner als 1µm, besser kleiner als 500nm, besser kleiner als 250nm, besser kleiner als 100nm, besser kleiner als 50nm, besser kleiner als 25nm, ggf. kleiner als 10nm. Mit geringer werdenden Abständen (d1) zur Oberfläche (OF) steigt der Einfluss der Oberflächenzustände. Es hat sich daher bewährt Abstände (d1) kleiner als 20nm möglichst nicht zu unterschreiten und ggf., insbesondere im Falle von Diamant als Substrat (D), die Oberfläche (OF) mittels der Abscheidung einer epitaktischen Schicht (DEPI) nach der Fertigung der Quantenpunkte (NV) in Form paramagnetischer Zentren (NV1) bzw. der Kernquantenpunkte (CI) wieder anzuheben, sodass der Abstand (d1) einen solchen Substratmaterial spezifischen Mindestabstand (d1) wieder überschreitet. Die Leitung (LH) ist bevorzugt in der in der Figur 30 dargestellten Weise auf der Oberfläche (OF) des Substrats (D) bzw. der epitaktischen Schicht (DEPI) gefertigt und an diesem Substrat (D) bzw. der epitaktischen Schicht (DEPI) befestigt und gegen das Substrat (D) bzw. die epitaktische Schicht (DEPI) elektrisch isoliert. Insbesondere können, wie beschrieben, Modulationen des Ansteuerstromes (IH) zur Manipulation des Spins des Quantenpunkts (NV) in Form des paramagnetischen Zentrums bzw. der Spins des Kernquantenpunkts (CI) verwendet werden. Bevorzugt ist die Leitung (LH) fest mit dem Substrat (D) bzw. der epitaktischen Schicht (DEPI) verbunden und bildet typischerweise eine Einheit mit dieser. Die Leitung (LH) wird typischerweise bevorzugt durch Elektronenstrahllithografie oder ähnlich hochauflösende Lithografiemethoden auf dem Substrat (D) bzw. der epitaktischen Schicht (DEPI) bzw. auf der Oberfläche einer dazwischenliegenden, hier nicht gezeichneten und bereits beschriebenen weiteren Isolation gefertigt, wenn unter unterschiedlichen Leitungen (LH) liegende Quantenpunkte (NV) und/oder Kernquantenpunkte (CI) miteinander koppeln sollen. Ist eine solche Kopplung nicht beabsichtigt, so können weniger hochauflösende Lithografiemethoden Verwendung finden. Werden elektrostatische Potenziale zwischen dem Substrat (D) bzw. der epitaktischen Schicht (DEPI) und dieser Leitung (LH, LV) durch eine Treiberstufe (HD) zur Ansteuerung des anzusteuernden Quantenpunkts (NV) als Treiberstufe dieser Leitung (LH) angelegt, so lassen sich die Quantenzustände des Quantenpunkts (NV) in Form des paramagnetischen Zentrums bzw. des Kernquantenpunkts (CI) unterhalb der betreffenden Leitung (LH) manipulieren und beeinflussen. Auf diese Weise kann beispielsweise ein einzelner Quantenpunkt (NV) durch lokale Verschiebung des Fermi-Niveaus mit Hilfe einer elektrischen Spannung zwischen Leitung (LH) und Substrat (D) bzw. epitaktischer Schicht (DEPI) gezwungen werden, einen manipulierbaren Quantenzustand zu verlassen oder zumindest die Resonanzfrequenz für Quantenzustandsmanipulationen zu verändern. Im Falle von NV-Zentren in Diamant kann das bedeuten, dass ein NV-Zentrum als Quantenpunkt (NV) den NV⁻-Zustand verlässt. Durch die Verstimmung der Resonanzfrequenzen bei Anlegen einer Spannung können einzelne Quantenpunkte (NV) somit in einem Quantenregister je nach Wahl dieser Spannung von Manipulationen ausgeschlossen oder in solche Manipulationen eingeschlossen werden. Auf diese Weise können beispielsweise bei der Verwendung von NV-Zentren in Diamant als paramagnetische Zentren der Quantenpunkte (NV) einzelne NV-Zentren durch lokale Verschiebung des Fermi-Niveaus gezwungen werden, die Resonanzfrequenzen zu verändern und damit an Quantenmanipulationen auf Basis von elektromagnetischen Kräften mit bestimmten Frequenzen je nach Einstellung der Spannung nicht mehr teilzunehmen bzw. teilzunehmen. Auch kann ggf. der Ladungszustand des Quantenpunkts (NV) durch die Manipulation der Lage des Fermi-Niveaus mittels der Spannung zwischen Substrat (D) bzw. epitaktischer Schicht (DEPI) einerseits und Leitung (LH) andererseits beeinflusst werden. Beispielsweise kann ein NV-Zentrum in Diamant als Substrat (D) oder epitaktische Schicht (DEPI) auf diese Weise mittels der Wahl des elektrischen Potenzials der Leitung (LH) in den NV⁻-Zustand gebracht oder aus diesem entfernt werden. Durch die Wahl des elektrischen Potenzials einer in einem solch geringen Abstand zu einem Quantenpunkt (NV) liegenden Leitung, kann somit beispielsweise die Kette von Quantenpunkten eines n-Bit-Quantenregisters gezielt unterbrochen werden. Somit können einzelne Quantenpunkte oder ganze Gruppen von Quantenpunkten von Quantenmanipulationen ausgenommen werden. Dies ermöglicht letztlich den gezielten Zugriff auf einzelne Quantenpunkte ohne unbeabsichtigte Manipulation der gezielt verstimmten Quantenpunkte. Dieses Verfahren ermöglicht also letztlich die Adressierung einzelner Quantenpunkte. Mit Hilfe dieser Konstruktion ist es somit möglich beispielsweise in einem ein-dimensionalen Gitter von Quantenpunkten (NV) die Teilnahme einzelner Quantenpunkte (NV) an Quantenoperationen selektiv durch geeignete Einstellung eines leitungsspezifischen elektrischen Potenziale der betreffenden horizontalen Leitung (LH), die sich oberhalb des einzelnen paramagnetischen Zentrums des Quantenpunkts (NV) auf der Oberfläche (OF) des Substrats (D) bzw. der epitaktischen Schicht (DEPI) befindet, an- und auszuschalten und so eine linienhafte Auflösung durch selektive Aktivierung und Deaktivierung der Teilnahme einzelner paramagnetischer Zentren der Quantenpunkte (NV) an Quantenmanipulationen zu erreichen. Somit schlagen wir hier ein System vor, das ein Substrat (D) ggf. mit einer epitaktischen Schicht (DEPI) aufweist, dass ein oder mehrere erste Mittel (LH), und ein oder mehrere zweite Mittel (HD) aufweist, um z.B. mittels statischer Potenziale der ersten Mittel (LH) gegenüber dem Potenzial des Substrats (D) oder der epitaktischen Schicht (DEPI) das Fermi-Niveau am Ort einzelner paramagnetischer Zentren einzelner Quantenpunkte (NV) so zu beeinflussen, dass diese einzelnen Quantenpunkte (NV) für die Teilnahme an Quantenzustandsmanipulationen ihres Quantenzustands aktiviert wird bzw. deaktiviert werden, wobei aktiviert bedeutet, dass die betreffenden Quantenpunkte (NV) an Manipulationen ihres Quantenzustands teilnehmen, und wobei deaktiviert bedeutet, dass die betreffenden Quantenpunkte (NV) an Manipulationen ihres Quantenzustands nicht teilnehmen. Bevorzugt wird die horizontale Leitung (LH) aus einem optisch transparenten Material, beispielsweise Indium-Zinn-Oxid (Englische Abkürzung: ITO) hergestellt. Aus der Schrift Marcel Manheller, Stefan Trellenkamp, Rainer Waser, Silvia Karthäuser, "Reliable fabrication of 3 nm gaps between nanoelectrodes by electron-beam lithography", Nanotechnology, Vol. 23, No. 12, Mar. 2012, DOI: 10.1088/0957-4484/23/12/125302 ist bekannt, dass die horizontalen Leitungen (LH) in sehr geringem Abstand (z.B. 5nm und kleiner, z.B. 5nm) zueinander hergestellt werden können. Aus der Schrift J. Meijer, B. Burchard, M. Domhan, C. Wittmann, T. Gaebel, I. Popa, F. Jelezko, J. Wrachtrup, "Generation of single color centers by focused nitrogen implantation" Appl. Phys. Lett. 87, 261909 (2005); https://doi.org/10.1063/1.2103389 ist eine hochgenaue Platzierung der Stickstoffatome zur Erzeugung der NV-Zentren bekannt. Maßnahmen zur Ausbeutesteigerung bei der Fertigung der Quantenpunkte, wie beispielsweise bei der Fertigung von NV-Zentren in Diamant, z.B. mittels einer Schwefelimplantation oder einer n-Dotierung des Substrats (D), werden in der hier vorgelegten Schrift genannt. Insofern ist eine präzise, ausbeutesichere Platzierung der paramagnetischen Zentren zur Fertigung der Quantenpunkte (NV) unter den Leitungen (LH) mittels fokussierter Ionenimplantation ohne Probleme möglich. Die örtlich hochaufgelöste Fertigung der Leitungen (LH) ist mittels Elektronenstrahllithografie möglich. Die Platzierung kann so dicht beieinander erfolgen, dass zwei benachbarte paramagnetische Zentren zweier Quantenpunkte (NV) unter unterschiedlichen Leitungen (LH1, LH2) miteinander wechselwirken können und ein Quantenregister auf Basis der Kopplung der Elektronenkonfigurationen bilden können, das über die Leitungen (LH) mittels Mikrowellensignalen angesteuert werden kann.

Durch gezielte deterministische und/oder fokussiert Ionenimplantation ggf. einzelner oder mehrerer Fremdatome in das Material (MPZ) des Substrats (D) des Sensorelements ist eine ausreichend koordinatentreue Fertigung einzelner oder mehrerer Quantenpunkte (NV) in Form entsprechender paramagnetischer Zentren möglich. Auf die Schrift J. Meijer, B. Burchard, M. Domhan, C. Wittmann, T. Gaebel, I. Popa, F. Jelezko, J. Wrachtrup, "Generation of single color centers by focused nitrogen implantation" Appl. Phys. Lett. 87, 261909 (2005); https://doi.org/10.1063/1.2103389 wird hier nochmals verwiesen. Bei Verwendung eines Diamanten als Substrat (D) oder epitaktische Schicht (DEPI) kann durch eine n-Dotierung, beispielsweise mit Schwefel, die Ausbeute an NV-Zentren gesteigert werden. Somit ist eine genaue Platzierung der Quantenpunkte (NV) in Form paramagnetischer Zentren in einer vorhersagbaren Weise räumlich relativ zu der Leitung (LH) möglich und damit ausführbar. Die Leitung (LH) kann auch aus dotiertem Silizium hergestellt werden.

Bevorzugt ist die Leitung (LH) aus einem bei der Wellenlänge des "grünen Lichts" (LB) optisch transparenten Material. Beispielsweise kann dieses Material der Leitung (LH) Indium-Zinn-Oxid, kurz ITO genannt, oder ein ähnliches, optisch transparentes und elektrisch nichtleitendes Material sein.

### Figur 31

Figur 31 zeigt die Kombination eines paramagnetischen Zentrums als Quantenpunkt (NV) in einem Halbleitermaterial eines bevorzugt halbleitenden Substrats (D) bzw. einer epitaktischen Schicht (DEPI), beispielsweise aus Silizium oder Siliziumcarbid, mit einem MOS-Transistor (MOS) in diesem Material, wobei die horizontalen Abschirmleitungen (SH1, SH2) die Source- und Drain-Kontakte des Transistors (MOS) darstellen, während die erste horizontale Leitung (LH1) das Gate des MOS-Transistors (MOS) bildet und durch das Gate-Oxid als weitere Isolation (IS2) von dem Material des Substrats (D) bzw. der epitaktischen Schicht (DEPI) isoliert ist. Die Pumpstrahlung in Form des "grünen Lichts" (LB) wird durch ein Zentrum (PZ) erzeugt.

Figur 31 zeigt eine Vorrichtung, die innerhalb eines Substrats (D) oder innerhalb einer epitaktischen Schicht (DEPI) untergebracht werden kann und somit in den vorausgehenden Vorrichtungen verwendet werden kann und bei der in dem Material des Substrats (D) oder der epitaktischen Schicht (DEPI) eine Lichtquelle (LED) gefertigt ist, die als Lichtquelle (LED) für das "grüne Licht" verwendet wird.

In dem Beispiel der Figur 31 injiziert ein Anoden-Kontakt (AN) einen elektrischen Strom in das Substrat (D) bzw. die epitaktische Schicht (DEPI). Auf B. Burchard "Elektronische und optoelektronische Bauelemente und Bauelementstrukturen auf Diamantbasis", Dissertation, Hagen 1994 und auf die Schrift DE 4 322 830 A1 wird in diesem Zusammenhang hingewiesen. Ein Kathoden-Kontakt (KTH) extrahiert diesen elektrischen Strom wieder aus dem Substrat (D) bzw. der epitaktischen Schicht (DEPI). Diese Diode hat hier die Funktion der Lichtquelle (LED). Ein im Strompfad innerhalb des Substrats (D) bzw. der epitaktischen Schicht (DEPI) liegendes Zentrum (PZ), dient als Strahlungsquelle dieser Lichtquelle (LED). Im Falle von Diamant als Substrat (D) bzw. die epitaktische Schicht (DEPI) kann es sich bei diesem Zentrum (PZ) beispielsweise um H3-Zentrum in dem beispielhaften Diamantmaterial, das als Substrat (D) bzw. epitaktische Schicht (DEPI) dient, handeln. Das Zentrum (PZ) emittiert in diesem Beispiel "grünes Licht" (LB) bei einem Stromfluss eines Pumpstromes (Iₚₘₚ) in dem Substrat (D) bzw. in der epitaktischen Schicht (DEPI). Im Falle von Diamant als Substrat (D) bzw. als epitaktischer Schicht (DEPI) emittiert das beispielhafte H3-Zentrum also "grünes Licht" (LB) bei einem Stromfluss eines Pumpstromes (Iₚₘₚ) in dem Diamanten als Substrat (D) bzw. als epitaktischer Schicht (DEPI) von dem Anoden-Kontakt (AN) zum Kathoden-Kontakt (KTH). Dieses "grüne Licht" (LB) des Zentrums (PZ), beispielsweise des besagten H3-Zentrums, kann dann dazu benutzt werden, ein oder mehrere Quantenpunkte (NV) in Form paramagnetischer Zentren (NV) anzusteuern und ggf. zurückzusetzen. Die Zentren (PZ) und/oder die Gruppen (PZC) der Zentren (PZ) können ein ein- oder zwei- oder dreidimensionales Gitter innerhalb des Substrats (D) bzw. der epitaktischen Schicht (DEPI) bilden. Im Falle eines eindimensionalen Gitters können die Zentren (PZ) beispielsweise kreisförmig um einen gemeinsamen Mittelpunkt herum angeordnet sein, wobei sich in dem Mittelpunkt dann bevorzugt ein Quantenpunkt (NV) in Form eines paramagnetischen Zentrums (NV) oder mehrere Quantenpunkte (NV) befinden. Bevorzugt bildet in einer Variante die Anordnung der Zentren PZ bzw. der Gruppen (PZC) der Zentren (PZ) zusammen mit der Anordnung der Quantenpunkte (NV) in Form paramagnetischer Zentren (NV) ein ein- zwei oder dreidimensionales Gitter, wobei die Elementarzelle des Gitters dann ein oder mehrere Zentren (PZ) und/oder eine oder mehrere Gruppen (PZC) von Zentren (PZ) einerseits und ein oder mehrere Quantenpunkte (NV) in Form paramagnetischer Zentren (NV) umfasst. Es kann sich um ein translatorisches und/oder rotatorisches Gitter um eine gemeinsame Symmetrieachse oder einen Symmetriepunkt handeln.

Es sollte noch erwähnt werden, dass die Struktur der Figur 31 geeignet ist, das Zentrum (PZ) mit dem Quantenpunkt (NV) und ggf. vorhandene Kernquantenbits (, CI1₁, CI1₂, CI1₃) zu verschränken. Ggf. kann der optische Pfad zwischen Zentrum (PZ) und Quantenpunkt (NV) noch mit optischen Funktionselementen der Photonik wie Lichtwellenleitern, Linsen, Filtern, Blenden, Spiegeln, photonischen Kristallen etc. ergänzt und ggf. modifiziert werden. Auf die zum Zeitpunkt der Anmeldung dieser Schrift noch unveröffentlichten Patentanmeldungen DE 10 2019 120 076.8, PCT / DE 2020 / 100 648 und DE 10 2019 121 028.3 wird an dieser Stelle verwiesen, deren Offenbarungsgehalt soweit rechtlich zulässig Teil dieser Offenlegung ist.

Die Struktur der Figur 31 entspricht weitestgehend der der Figur 29. In dem Beispiel der Figur 31 ist der Quantenpunkt (NV) nun jedoch Teil einer beispielhaften QuantenALU (QUALU1'). In dem Beispiel der Figur 31 umfasst die QuantenALU (QUALU1') beispielhaft den Quantenpunkt (NV) und einen ersten Kernquantenpunkt (CI1₁) und einen zweiten Kernquantenpunkt (CI1₂) und einen dritten Kernquantenpunkt (CI1₃). Die Struktur des MOS-Transistors (MOS) entspricht mit dieser QuantenALU (QUALU1') beispielhaft dem ersten Quantenbit (QUB1) der Figur 19. Die erste horizontale Abschirmleitung (SH1) ist über den ersten horizontalen Kontakt (K11) des ersten Quantenbits (QUB1) mit dem Substrat (D) bzw. der epitaktischen Schicht (DEPI) verbunden. Die zweite horizontale Abschirmleitung (SH2) ist über den zweiten horizontalen Kontakt (K22) des zweiten Quantenbits (QUB2) mit dem Substrat (D) bzw. der epitaktischen Schicht (DEPI) verbunden. Eine weitere Isolation (IS) isoliert die horizontale Leitung (LH1) gegenüber dem Substrat (D) bzw. der epitaktischen Schicht (DEPI). Bevorzugt umfasst das Substrat (D) bzw. die epitaktische Schicht (DEPI) zumindest im Bereich der QuantenALU (QUALU1') im Wesentlichen Isotope ohne magnetisches Kernmoment µ. Bevorzugt umfasst das Substrat (D) bzw. die epitaktische Schicht (DEPI) zumindest im Bereich der QuantenALU (QUALU1') je Element im Wesentlichen nur einen Isotopentyp der möglichen Isotope ohne magnetisches Kernmoment µ.

Im Falle von Diamant als Substrat (D) bzw. epitaktische Schicht (DEPI) umfasst das Substrat (D) bzw. die epitaktische Schicht (DEPI) im Wesentlichen nur Isotope des Kohlenstoffs ohne magnetisches Moment µ. Bevorzugt sind dies die Isotope ¹²C und ¹⁴C. Bevorzugt umfasst das Substrat (D) bzw. die epitaktische Schicht (DEPI) im Wesentlichen nur das Isotop ¹²C.

Im Falle von Silizium als Substrat (D) bzw. epitaktische Schicht (DEPI) umfasst das Substrat (D) bzw. die epitaktische Schicht (DEPI) im Wesentlichen nur Isotope des Siliziums ohne magnetisches Moment µ. Bevorzugt sind dies die Isotope ²⁸Si und ³⁰Si. Bevorzugt umfasst das Substrat (D) bzw. die epitaktische Schicht (DEPI) im Wesentlichen nur das Isotop ²⁸Si.

Im Falle von Siliziumkarbid als Substrat (D) bzw. epitaktische Schicht (DEPI) umfasst das Substrat (D) bzw. die epitaktische Schicht (DEPI) im Wesentlichen nur Isotope des Siliziums ohne magnetisches Moment µ und nur Isotope des Kohlenstoffs ohne magnetisches Moment µ. Bevorzugt sind dies die Isotope ²¹Si und ³⁰Si und die Isotope ¹²C und ¹⁴C. Bevorzugt umfasst das Substrat (D) bzw. die epitaktische Schicht (DEPI) im Wesentlichen nur das Isotop ²¹Si und das Isotop ¹²C.

Der Begriff "im Wesentlichen" bedeutet hierbei, dass der Gesamtanteil K_{1G} der Isotope mit magnetischen Moment eines betrachteten Elements, das Teil des das Substrat (D) bzw. der epitaktischen Schicht (DEPI) ist, bezogen auf 100% dieses betrachteten Elements gegenüber den in den obigen Tabellen angegebenen natürlichen Gesamtanteil K_{1G} auf einen Anteil K_{1G}' der Isotope mit magnetischen Moment eines betrachteten Elements bezogen auf 100% dieses betrachteten Elements herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element im Einwirkungsbereich der als Quantenpunkte (NV) benutzten paramagnetischen Störstellen (NV) und/oder der als Kernquantenpunkten (CI) benutzten nuklearen Spins ist.

Sofern die Kontakte (KH11, KH22) mittels Dotierung des Substrats (D) bzw. der epitaktischen Schicht (DEPI) mit Isotopen mit magnetischem Kernmoment µ hergestellt werden, sollte der Abstand (Abst) zwischen der einer Komponente der QuantenALU (QUALU1') nächsten Kante eines Kontakts (KH11, KH22) und dieser Komponente der QuantenALU (QUALU1') größer als die Kern-Kern-Kopplungsreichweite zwischen einem Dotieratom des betreffenden Kontakts (KH11, KH22) und dem betreffenden Kernquantenpunkt (CI1₁, CI1₂, CI1₃) der QuantenALU (QUALU1') und größer als die Kern-Elektron-Kopplungsreichweite zwischen einem Dotieratom des betreffenden Kontakts (KH11, KH22) und dem Quantenpunkt (NV) der QuantenALU (QUALU1') sein. Erfahrungsgemäß sind hier 500nm ausreichend. Bei der Ausarbeitung der Erfindung wurden mehrere µm als Abstand (Abst) benutzt. Sofern dieser Abstand (Abst) aus welchen Gründen auch immer unterschritten werden muss, sollte die Dotierung der Kontakte (KH11, KH22) bevorzugt im Wesentlichen mittels Isotopen erfolgen, die kein magnetisches Kernmoment µ aufweisen.

Der Begriff "im Wesentlichen" bedeutet hierbei, dass der Gesamtanteil K_{1G} der Isotope mit magnetischen Moment eines betrachteten Elements, das Teil des Kontakts (KH11, KH22) ist, bezogen auf 100% dieses betrachteten Elements gegenüber den in den obigen Tabellen angegebenen natürlichen Gesamtanteil K_{1G} auf einen Anteil K_{1G}' der Isotope mit magnetischen Moment eines betrachteten Elements bezogen auf 100% dieses betrachteten Elements herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element im Einwirkungsbereich der als Quantenpunkte (NV) benutzten paramagnetischen Störstellen (NV) und/oder der als Kernquantenpunkten (CI) benutzten nuklearen Spins ist.

Bevorzugt wird im Falle von Silizium oder Siliziumkarbid als Material des Substrats (D) bzw. der epitaktischen Schicht (DEPI) die weitere Isolation (IS2) als Gate-Oxid ausgeführt. Eine bevorzugte Herstellungsmethode ist in diesem Fall eine thermische Oxidation. Bevorzugt ist das Gate-Oxid dann im Wesentlichen aus Isotopen ohne magnetisches Moment gefertigt.

Der Begriff "im Wesentlichen" bedeutet hierbei, dass der Gesamtanteil K_{1G} der Isotope mit magnetischen Moment eines betrachteten Elements, das Teil der weiteren Isolation (IS2) ist, bezogen auf 100% dieses betrachteten Elements gegenüber den in den obigen Tabellen angegebenen natürlichen Gesamtanteil K_{1G} auf einen Anteil K_{1G}' der Isotope mit magnetischen Moment eines betrachteten Elements bezogen auf 100% dieses betrachteten Elements herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element im Einwirkungsbereich der als Quantenpunkte (NV) benutzten paramagnetischen Störstellen (NV) und/oder der als Kernquantenpunkten (CI) benutzten nuklearen Spins ist.

Die Leitung (LH1), die das Gate des Transistors (MOS) bildet, wird beispielsweise aus Indiumzinnoxid (englisch: indium tin oxide = ITO) gefertigt. Dies hat aber den Nachteil, dass dies nicht ohne magnetisches Kernmoment möglich ist. In dem Fall muss der Abstand (d1) zwischen der QuantenALU (QUALU1') bzw. dem Quantenpunkt (NV) bzw. den Kernquantenpunkten (CI1₁, CI1₂, CI1₃) so groß sein, dass die magnetischen Kernmomente der entsprechenden Isotope der Leitung (LH1) nicht mit der QuantenALU (QUALU1') bzw. dem Quantenpunkt (NV) bzw. den Kernquantenpunkten (CI1₁, CI1₂, CI1₃) wechselwirken können.

Eine weitere Möglichkeit zur Realisierung der Abschirmleitungen (SH1, SH2) und der Leitung (LH1) ist beispielsweise die Verwendung von Titan, wobei Isotope ohne magnetisches Kernmoment µ bevorzugt sind. Besonders bevorzugt sind hierbei das Titan-Isotop ⁴⁶Ti und/oder das Titan-Isotop ⁴⁸Ti und/oder das Titan-Isotop ⁵⁰Ti zur Herstellung von entsprechenden Titan-Leitungen.

Somit wird bei entsprechender räumlicher Nähe einer Abschirmleitung (SH1, SH2) oder der Leitung (LH1) die entsprechende Leitung bevorzugt im Wesentlichen aus Isotopen ohne magnetisches Kernmoment µ gefertigt. Der Begriff "im Wesentlichen" bedeutet hierbei, dass der Gesamtanteil K_{1G} der Isotope mit magnetischen Moment eines betrachteten Elements, das Teil einer Leitung (SH1, SH2, LH1) ist, bezogen auf 100% dieses betrachteten Elements gegenüber den in den obigen Tabellen angegebenen natürlichen Gesamtanteil K_{1G} auf einen Anteil K_{1G}' der Isotope mit magnetischen Moment eines betrachteten Elements bezogen auf 100% dieses betrachteten Elements herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element im Einwirkungsbereich der als Quantenpunkte (NV) benutzten paramagnetischen Störstellen (NV) und/oder der als Kernquantenpunkten (CI) benutzten nuklearen Spins ist.

In dem Beispiel der Figur 31 ist die erste vertikale Leitung (LV1) der Figur 19 eingezeichnet und durch eine Isolation (IS) von der ersten Abschirmleitung (SH1) und der zweiten Abschirmleitung (SH2) und der ersten horizontalen Leitung (LH1) und damit von dem Substrat (D) und der epitaktischen Schicht (DEPI) elektrisch isoliert.

Im Falle von Siliziumkarbid oder Silizium als Substrat (D) bzw. epitaktische Schicht (DEPI) kann beispielsweise die weitere Isolation (IS2) oder die Isolation (IS) aus Siliziumoxid bestehen. In dem Fall umfassen beispielsweise die Isolation (IS) und/oder die weitere Isolation (IS) bevorzugt im Wesentlichen nur Isotope ohne magnetisches Kernmoment. In dem Fall umfassen beispielsweise die Isolation (IS) und/oder die weitere Isolation (IS) bevorzugt im Wesentlichen nur Isotope ²⁸Si und ³⁰Si und ¹⁶O und ¹⁸O ohne magnetisches Kernmoment. In dem Fall umfassen beispielsweise die Isolation (IS) und/oder die weitere Isolation (IS) ganz besonders bevorzugt im Wesentlichen nur Isotope ²¹Si und ¹⁶O ohne magnetisches Kernmoment. Der Begriff "im Wesentlichen" bedeutet hierbei, dass der Gesamtanteil K_{1G} der Isotope mit magnetischen Moment eines betrachteten Elements, das Teil der weiteren Isolation (IS2) oder eines Gate-Oxids ist, bezogen auf 100% dieses betrachteten Elements gegenüber den in den obigen Tabellen angegebenen natürlichen Gesamtanteil K_{1G} auf einen Anteil K_{1G}' der Isotope mit magnetischen Moment eines betrachteten Elements bezogen auf 100% dieses betrachteten Elements herabgesetzt ist. Wobei dieser Anteil K_{1G}' kleiner als 50%, besser kleiner als 20%, Besser kleiner als 10%, besser kleiner als 5%, besser kleiner als 2%, besser kleiner als 1%, besser kleiner als 0,5%, besser kleiner als 0,2%, besser kleiner als 0,1% des natürlichen Gesamtanteil K_{1G} für das betreffende Element im Einwirkungsbereich der als Quantenpunkte (NV) benutzten paramagnetischen Störstellen (NV) und/oder der als Kernquantenpunkten (CI) benutzten nuklearen Spins ist.

Wie bereits in Figur 1 erläutert kreuzen sich die erste horizontale Leitung (LH1) und die erste vertikale Leitung (LV1) über dem Quantenpunkt (NV). Im Falle eines halbleitenden Materials als Material des Substrats (D) bzw. der epitaktischen Schicht (DEPI), beispielsweise im Falle von Silizium oder Siliziumkarbid als Material des Substrats (D) bzw. der epitaktischen Schicht (DEPI), bildet das Quantenbit (QUB1) einen MOS-Transistor (MOS), bei dem im Kanalgebiet des Transistors (MOS) sich ein Quantenpunkt (NV) und/oder ein Kern-Elektron-Quantenregister (CEQUREG) und/oder, wie hier, eine QuantenALU(QUALU1') befindet. Es ist auch denkbar, dass sich dort mehr als ein Quantenpunkt (NV) und/oder mehr als ein Kern-Elektron-Quantenregister (CEQUREG) und/oder mehr als eine QuantenALU(QUALU1') befindet. Bevorzugt bilden dann die mindestens zwei Quantenpunkte (NV1, NV2) ein Zwei-Bit-Quantenregister, wobei jedoch die Quantenpunkte nur durch eine Konstruktion aus gekreuzten Leitungen (LH1, LV1) angesprochen werden können. Diese sich kreuzenden Leitungen (LH1, LH2) stellen im ein Mittel zur Erzeugung eines Magnetfeldes mit einem zirkular rotierenden magnetischen Flussdichtevektor B am Ort des Quantenpunkts (NV) bzw. am Ort der Kernquantenpunkte (CI1₁, CI1₂, CI1₃) dar, das zur Manipulation des Quantenzustands des Quantenpunkts (NV) bzw. der Kernquantenpunkte (CI1₁, CI1₂, CI1₃) benutzt werden kann. Die Auslesung des Zustands des Quantenpunkts (NV) erfolgt bevorzugt durch Bestrahlung mit "grünem Licht" und Absaugung des zugehörigen quantenzustandsabhängigen Fotostroms über die Kontakte (K11, K22) mittels einer Extraktionsspannung (Vₑₓₜ).

### Figur 32

Figur 32 zeigt eine Struktur eines Substrats (D) mit einer Vorrichtung zum Auslesen des Fotostroms (I_{Ph}) eines paramagnetischen Zentrums als Quantenpunkt (NV). Zwischen einer ersten Abschirmleitung (SH1) und einer zweiten Abschirmleitung (SH2) wird eine Extraktionsspannung (Vₑₓₜ) angelegt. Die erste Abschirmleitung (SH1) kontaktiert das Substrat (D) bzw. die epitaktische Schicht (DEPI) mittels eines ersten Kontakts (KH11) elektrisch. Die zweite Abschirmleitung (SH2) kontaktiert das Substrat (D) bzw. die epitaktische Schicht (DEPI) mittels eines zweiten Kontakts (KH22) elektrisch. Die erste Abschirmleitung (SH1) ist von der zweiten Abschirmleitung (SH2) beabstandet. Die erste Abschrimleitung (SH1) und die zweite Abschirmleitung (SH2) sind abgesehen vom ersten Kontakt (KH11) und dem zweiten Kontakt (KH22) durch eine weitere Isolation (IS2) ansonsten elektrisch gegenüber dem Substrat (D) bzw. der epitaktischen Schicht (DEPI) isoliert. Zischen der ersten Abschirmleitung (SH1) und der zweiten Abschirmleitung (SH2) befindet sich in dem Beispiel hier ein Quantenpunkt (NV) in Form eines paramagnetischen Zentrums. Der Quantenpunkt befindet sich in einer Tiefe (d1) unter der Oberfläche (OF). Wird der Quantenpunkt mit "grünem Licht" bestrahlt, so fließt bei Anlegen einer Extraktionsspannung (Vₑₓₜ) zwischen der ersten Abschirmleitung (SH1) und der zweiten Abschrimleitung (SH2) ein elektrischer Fotostrom (Iₚₕ), der von dem Quantenzustand des Quantenpunkts (NV) abhängig ist. Ist das Substrat (D) bzw. die epitaktische Schicht (DEPI) aus Diamant und handelt es sich um ein NV-Zentrum, so fließt ein Fotostrom (Iₚₕ), wenn sich das NV-Zentrum im NV⁻-Zustand befindet. In diesem Zusammenhang wird auf die Schriften Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond" Science 15 Feb 2019, Vol. 363, Issue 6428, pp. 728-731, DOI: 10.1126/science.aav2789 und Mathias H. Metsch, Katharina Senkalla, Benedikt Tratzmiller, Jochen Scheuer, Michael Kern, Jocelyn Achard, Alexandre Tallaire, Martin B. Plenio, Petr Siyushev, and Fedor Jelezko, "Initialization and Readout of Nuclear Spins via a Negatively Charged Silicon-Vacancy Center in Diamond" Phys. Rev. Lett. 122, 190503 - Published 17 May 2019 hingewiesen.

### Figur 33

Figur 33 zeigt eine Teilvorrichtung der Figur 20 in Form einer QuantenALU, wobei die Teilvorrichtung ein Transistor ist. Der Transistor entspricht dem der Figur 31.

### Figur 34

Figur 34 zeigt eine vereinfachte Aufsicht auf die Oberfläche eines Substrats (D) mit beispielhaft acht Quantenbits (NV1 bis NV8), die als schwarze Kreise in einer senkrechten Linie gleich beabstandet angeordnet und angedeutet sind. Zur besseren Übersicht sind die Quantenpunkte mit einer gestrichelten Ellipse markiert und mit einem gemeinsamen Bezugszeichen (NV1-NV8) versehen. Allen acht Quantenbist (QUB1 bis QUB8) ist gemeinsam, dass die erste vertikale Leitung (LV1) über die betreffenden Quantenpunkte (NV1 bis NV8) wie in Figur 1 gezeichnet hinweg geführt ist. Am Anfang und am Ende der ersten vertikalen Leitung (LV1) befindet sich jeweils ein Bond-Pad (Kontaktfläche).

Links und rechts der ersten vertikalen Leitung (LV1) sind beispielhaft die erste vertikale Abschirmleitung (SV1) und die zweite vertikale Abschirmleitung (SV2) parallel zur ersten vertikalen Leitung (LV1) und elektrisch isoliert voneinander geführt. Die erste vertikale Abschirmleitung (SV1) und die zweite vertikale Abschirmleitung (SV2) beginnen und enden jeweils in einem Bond-Pad. Senkrecht zur ersten vertikalen Leitung (LV1) kreuzt je Quantenpunkt der acht Quantenpunkte (NV1 bis NV8) je eine horizontale Leitung, die dem jeweiligen Quantenpunkt der acht Quantenpunkte (NV1 bis NV8) zugeordnet ist ,von acht zugehörigen horizontalen Leitungen (LH1 bis LH8) die erste vertikale Leitung (LV1) und die erste vertikale Abschirmleitung (SV1) und die zweite vertikale Abschirmleitung (SH2) und zwar genau über einem zugehörigen Quantenpunkt der acht Quantenpunkte (NV1 bis NV8). Zwischen je zwei horizontalen Leitungen kreuzt jeweils eine horizontale Abschirmleitung der neuen Horizontalen Abschirmleitungen (SH1 bis SH9) die erste vertikale Leitung (LV1) und die erste vertikale Abschirmleitung (SV1) und die zweite vertikale Abschirmleitung (SH2). Die erste horizontale Abschirmleitung (SH1) kreuzt die erste vertikale Leitung (LV1) und die erste vertikale Abschirmleitung (SV1) und die zweite vertikale Abschirmleitung (SH2) oberhalb des ersten Quantenpunkts (NV1). ). Die neunte horizontale Abschirmleitung (SH9) kreuzt die erste vertikale Leitung (LV1) und die erste vertikale Abschirmleitung (SV1) und die zweite vertikale Abschirmleitung (SH2) unterhalb des achten Quantenpunkts (NV8). Jede dieser neun horizontalen Abschirmleitungen (SH1 bis SH9) und jede der acht horizontalen Leitungen (LH1 bis LH8) beginnt mit einem Bond-Pad und Endet mit einem Bond-Pad. Bevorzugt wird diese Struktur mittels Elektronenstrahllithografie hergestellt. Bevorzugt entsprechen die Quantenbits jedes für sich in ihrem Querschnitt beispielsweise der Figur 15.

Im Folgenden kann angenommen werden, dass ein solches Substrat (D) in ein größeres System eingebaut wird.

### Figur 35

Die Figur 35 entspricht der Figur 34 mit dem Unterschied, dass keine horizontalen Schirmleitungen vorgesehen sind. Stattdessen werden die freigewordenen Räume für weitere Quantenbits genutzt, sodass sich bei gleichem Platzbedarf, aber größerem Übersprechen siebzehn Quantenpunkte (NV1 bis NV17) ansteuern lassen.

### Figur 36

Figur 36 zeigt das Substrat der Figur 35 eingebaut in ein Ansteuersystem analog zu Figur 23. Das System ist um 90° gedreht dargestellt, sodass die vertikalen Leitungen nun horizontal verlaufen und die horizontalen Leitungen nun vertikal. Das System ist stark vereinfacht. Jede der Leitungen (LV1, LH1 bis LH17) wird durch je ein Modul (MOD) getrieben. Die Module (MOD) werden über einen Kontrollbus (CD) durch die Steuervorrichtung (µC) gesteuert. Auf der anderen Seite des Substrats (D) sind die Leitungen (LV1, LH1 bis LH17) alle in dem Beispiel der Figur 36 mit einem Widerstand (50Ω) entsprechend dem Wellenwiderstand der jeweiligen Leitung abgeschlossen, um Reflexionen zu verhindern. Die erste vertikale Abschirmleitung (SH1) und die zweite vertikale Abschrimleitung kontaktieren das Substrat (D) oberhalb und unterhalb der Quantenpunkte des Substrats (D), sodass mittels einer Extraktionsspannungsquelle (Vₑₓₜ), die eine Extraktionsspannung (Vₑₓₜ) liefert, die Fotoelektronen bzw. Fotoladungen abgezogen werden können. Bevorzugt besitzt das Substrat (D) einen Rückseitenkontakt, der auf einem definierten Potenzial liegt. Die Steuervorrichtung (µC) steuert die einer Extraktionsspannungsquelle (Vₑₓₜ) und ein Amperemeter (A) zur Messung dieses Fotostromes (Iₚₕ), was die Bewertung der Zustände der Quantenpunkte ermöglicht. Die anderen Module sind klein gezeichnet. Beispielhaft für die Module ist ein beispielhaftes Modul (MOD) ein wenig größer gezeichnet. Eine Gleichspannungsquelle (V_{DC}) ist über eine erste Impedanz (L1) oder einen ersten Filterschaltkreis an die erste vertikale Leitung angeschlossen. Die beispielhafte erste Impedanz (L1) bzw. der erste Filterschaltkreis sorgen dafür, dass die Mikrowellen- und Radiowellensignale auf der ersten vertikalen Leitung nicht durch die Gleichspannung der Gleichspannungsquelle (V_{DC}) modifiziert werden. Die beispielhafte Gleichspannungsquelle (V_{DC}) speist bei Bedarf einen vom Abschlusswiderstand (50Ω) anhängigen Gleichstrom in die erste vertikale Leitung (LV1) ein und kann so die Resonanzfrequenzen der Quantenpunkte verstimmen.

Eine Radiowellenquelle speist bei Bedarf eine Radiowellenfrequenz in die erste vertikale Leitung ein. Eine zweite Impedanz (L2) bzw. ein zweite Filterschaltkreis entkoppeln bevorzugt die Radiowellenquelle und die anderen Quellen (V_{DC}, V_{MW}) des Moduls von der Radiowellenquelle (V_{RF}).

Eine nicht gezeichnete dritte Impedanz bzw. ein dritter Filterschaltkreis entkoppeln bevorzugt die Mikrowellenquelle und die anderen Quellen (V_{DC}, V_{RW}) des Moduls von der Mikrowellenquelle (V_{RF}).

Bevorzugt werden alle Leitungen von einer Seite mittels eines solchen Moduls angesteuert und bevorzugt auf der anderen Seite mit einem Wellenwiderstand abgeschlossen. Bevorzugt werden alle Leitungen als Triplate-Leitungen mit definiertem Wellenwiderstand ohne Stoßstellen ausgeführt.

Die Steuervorrichtung (µC) steuert die gesamte Vorrichtung und kommuniziert über einen Datenbus (DB) mit einem übergeordneten externen Rechnersystem, das das Quantencomputersystem steuert.

### Figur 37

Figur 37 zeigt einen beispielhaften Transistor, der als Quantencomputer betrieben wird in der Aufsicht von oben vereinfacht schematisch.

Wir nehmen beispielhaft an, dass der Transistor in isotopenreinem ²⁸Si-Silizium gefertigt ist. Eine Fertigung in anderen Mischkristallen aus einem oder mehreren Elementen der IV. Hauptgruppe ohne magnetisches Kernmoment µ ist ebenso denkbar. Auch insofern ist der Transistor hier nur beispielhaft.

Links ist ein erster dotierter Bereich (DOT) eingezeichnet, der das Source-Gebiet des Transistors darstellen soll. Die Dotierung wird typischerweise mit Isotopen der III. Hauptgruppe oder der V. Hauptgruppe des Periodensystems der Elemente vorgenommen. Diese haben aber allesamt ein von Null verschiedenes magnetisches Kernmoment µ, die die Quantenpunkte (NV1, NV2) und die Kernquantenpunkte (CI1₁, CI1₂, CI1₃, CI2₁, CI2₂) stören können. Daher sollte ein Mindestabstand jeweils zwischen der Source-Gebiet-Dotierung und der Drain-Gebiet-Dotierung einerseits und den Quantenpunkten (NV1, NV2) und den Kernquantenpunkten (CI1₁, CI1₂, CI1₃, CI2₁, CI2₂) eingehalten werden. Es haben sich Abstände von mehr als 1µ bewährt. Rechts ist der entsprechende zweite dotierte Bereich (DOT) eingezeichnet, der das Drain-Gebiet des Transistors darstellen soll. Der Source-Kontakt (SO) verbindet den linken dotierten Source-Kontaktbereich (DOT) mit der ersten vertikalen Abschirmleitung (SV1). Der Drain-Kontakt (DR) verbindet den rechten dotierten Drain-Kontaktbereich (DOT) mit der zweiten vertikalen Abschirmleitung (SV2). Wieschen der ersten vertikalen Abschirmleitung (SV1) und der zweiten vertikalen Abschirmleitung (SV1) ist die erste vertikale Leitung (LV1) geführt. Die erste vertikale Leitung (LV1) stellt in diesem Beispiel das Gate des Transistors dar. Die erste vertikale Leitung ist durch die weitere Isolierung (IS2) in Form des Gate-Oxids von dem Substrat (D) elektrisch isoliert. Die weitere Isolierung ist bevorzugt sehr dünn ausgeführt. Sie hat bevorzugt eine Dicke von weniger als 10nm. Bevorzugt ist die erste vertikale Leitung transparent für die Anregungsstrahlung, das "grüne Licht", ausgeführt. Bevorzugt ist die erste vertikale Leitung (LV1) und damit der Gate-Kontakt des Transistors, hierfür ausreichend dünn ausgeführt oder aus Indium-Zinn-Oxid oder anderen transparenten und elektrisch leitenden Stoffen hergestellt. Der Transistor der Figur 37 umfasst beispielhaft zwei Quanten ALUs mit zwei Quantenpunkten (NV1, NV2). Die erste QuantenALU umfasst den ersten Quantenpunkt (NV1) und den ersten Kernquantenpunkt (C11₁) der ersten QuantenALU und den zweiten Kernquantenpunkt (C11₂) der ersten QuantenALU und den dritten Kernquantenpunkt (C11₃) der ersten QuantenALU. Die zweite QuantenALU umfasst den zweiten Quantenpunkt (NV2) und den ersten Kernquantenpunkt (C12₁) der zweiten QuantenALU und den zweiten Kernquantenpunkt (C12₂) der zweiten QuantenALU.

Die erste horizontale Leitung (LH1) kreuzt im Bereich des ersten Quantenpunkts (NV1) die erste vertikale Leitung (LV1).

Die zweite horizontale Leitung (LH2) kreuzt im Bereich des zweiten Quantenpunkts (NV2) die erste vertikale Leitung (LV1).

Die erste horizontale Leitung (LH1) kreuzt auch die erste vertikale Abschirmleitung (SV1) und die zweite vertikale Abschirmleitung (SV2). Die zweite horizontale Leitung (LH2) kreuzt auch die erste vertikale Abschirmleitung (SH1) und die zweite vertikale Abschirmleitung (SH2).

Oberhalb der ersten horizontalen Leitung (LH1) verläuft die erste horizontale Abschirmleitung (SH1).

Zwischen der ersten horizontalen Leitung (LH1) und der zweiten horizontalen Leitung (LH2) verläuft die zweite horizontale Abschirmleitung (SH2).

Unterhalb der zweiten horizontalen Leitung (LH2) verläuft die dritte horizontale Abschirmleitung (SH3).

Auch die horizontalen Leitungen (SH1, SH2, SH3, LH1, LH2) sind bevorzugt transparent für die Anregungsstrahlung, das "grüne Licht", ausgeführt. Bevorzugt sind die erste horizontale Leitung (LH1), die zweite horizontale Leitung (LH2), die erste horizontale Abschirmleitung (SH1), die zweite horizontale Abschirmleitung (SH2) und die dritte horizontale Abschirmleitung (SH2) hierfür ausreichend dünn ausgeführt oder aus Indium-Zinn-Oxid oder anderen transparenten und elektrisch leitenden Stoffen hergestellt. Die erste horizontale Leitung (LH1), die zweite horizontale Leitung (LH2), die erste horizontale Abschirmleitung (SH1), die zweite horizontale Abschirmleitung (SH2) sind durch die Isolation (IS) gegenüber der ersten vertikalen Leitung (LV1), der ersten vertikalen Abschirmleitung (SV1) und der zweiten vertikalen Abschirmleitung (SV2) elektrisch isoliert. Bevorzugt ist die Isolation (IS) so dünn wie die weitere Isolation (IS2) im Bereich des Transistors.

Bevorzugt kreuzen sich kreuzende Leitungen im Bereich dieses Transistors in einem Winkel von 90°.

In dem mit GOX bezeichneten Bereich ist die weitere Isolation (IS2) typischerweise dünner als im übrigen Bereich ausgeführt. Da der vertikale Abstand des ersten Quantenpunkts (NV1) vom zweiten Quantenpunkt (NV2) sehr klein in der Größenordnung von 20nm sein sollte und gleichzeitig der horizontale Abstand der Kontaktdotierungen (DOT) typischerweise im µm Bereich liegt ist die Zeichnung extrem stark verzerrt, um die grundlegenden Prinzipien darzustellen zu können.

### Figur 38

Figur 38 zeigt ein beispielhaftes Quantencomputersystem (QUSYS) mit einer beispielhaften zentralen Steuereinheit (ZSE). Die beispielhafte zentrale Steuereinheit (ZSE) ist in diesem Beispiel über einen vorzugsweise bidirektionalen Datenbus (DB) mit einer Vielzahl von Quanten-Computern (QC1 bis QC16) verbunden. Bevorzugt umfasst ein solches Quanten-Computersystem mehr als einen Quanten-Computer (QC1 bis QC16). In dem Beispiel der Figur 38 umfasst jeder der Quanten-Computer (QC1 bis QC16) eine Steuervorrichtung (µC). In dem Beispiel der Figur 38 sind beispielhaft 16 Quanten-Computer (QC1 bis QC16) über den Datenbus (DB) mit der Zentralensteuereinrichtung (ZSE) verbunden. Bei dem Datenbus (DB) kann es sich um ein beliebiges Datenübertragungssystem handeln. Es kann beispielsweise drahtgebunden, drahtlos, lichtwellenleitergebunden, optisch, akustisch, funkgestützt sein. Im Falle eines drahtgebundenen Systems kann der Datenbus ganz oder in Teilabschnitten ein Eindrahtdatenbus, wie beispielsweise einen LIN-Bus oder ein Zweidrahtdatenbus, wie beispielsweise einen CAN-Datenbus sein. Der Datenbus kann ganz oder in Teilabschnitten ein komplexerer Datenbus mit mehreren Leitern und/oder mehreren logischen Pegeln etc. handeln. Der Datenbus kann ganz oder in Teilabschnitten ein Ethernet-Datenbus sein. Der Datenbus kann ganz aus einer Art von Datenbus bestehen oder aus verschiedenen Datenübertragungstrecken zusammengesetzt sein. Der Datenbus (DB) kann sternförmig wie in dem Beispiel der Figur 38 angeordnet sein. Der Datenbus kann ganz oder in Teilen auch beispielsweise wie in einem LIN-Datenbus als Verkettung der Busknoten in Form der Quanten-Computer (QC1 bis QC16) ausgeführt sein, wobei dann bevorzugt jede der Steuervorrichtungen der betreffenden Quanten-Computer dieses Teils des Quanten-Computer-Systems bevorzugt über mehr als eine Datenschnittstelle verfügen, um mehr als einen Datenbus an den betreffenden Quanten-Computer anschließen zu können. Es ist denkbar, dass dann einer oder mehrere Quanten-Computer der Quanten-Computer (QC1 bis QC16) als Bus-Master und damit als zentrale Steuereinrichtungen (ZSE) für untergeordnete Teil-Netze des Quanten-Computer-Systems agieren.

Es ist daher des Weiteren denkbar, dass es sich bei der zentralen Steuereinrichtung (ZSE) des Quanten-Computer-Systems (QUSYS) um die Steuervorrichtung (µC) eines Quanten-Computers handelt bzw. dass die zentrale Steuervorrichtung (ZSE) des Quanten-Computer-Systems (QUSYS) ein Quanten-Computer mit einer Steuereinrichtung (µC) ist, wobei hier im Falle der Figur 38 auf die "normalen" Rechnereigenschaften der Steuervorrichtung (µC) abgehoben wird, die das Quanten-Computer-System (QUSYS) als zentrale Steuereinrichtung (ZSE) steuern. Aus der Perspektive der Quantencomputer (QC1 bis QC16) entspricht die zentrale Steuereinrichtung (ZSE) einem externen Überwachungscomputer des Quantencomputersystems (QUSYS).

Das Datenübertragungsnetz des Quantencomputersystems (QSYS) kann ganz oder in Teilen einer linearen Kette von Busknoten in Form der Quantencomputer (QC1 bis QC16) längs eines Teils des Datenbusses (DB) oder längs des Datenbusses (DB) entsprechen, die auch zu einem Ring (Stichwort Token-Ring) geschlossen sein kann.

Das Datenübertragungsnetz des Quantencomputersystems (QSYS) kann ganz oder in Teilen einer Stern-struktur von Busknoten in Form der Quantencomputer (QC1 bis QC16), die an einer oder mehreren Datenleitungen und/oder Datenübertragungsmedien angeschlossen sind. Eine Sternstruktur liegt z.B. bei Funkübertragung der Daten vor. Auch kann einer, mehrere oder alle Quantencomputer über eine Punkt-Zu-Punkt-Verbindung mit der zentralen Steuereinrichtung (ZSE) verbunden sein. In dem Fall muss die zentrale Steuereinrichtung (ZSE) für jede Punkt-zu-Punkt-Verbindung über eine separate Datenschnittstelle verfügen.

Das Datenübertragungsnetz des Quantencomputersystems (QSYS) kann als Baumstruktur angelegt sein, wobei einzelne Quantencomputer beispielsweise über mehr als eine Datenbusschnittstelle verfügen und als Bus-Master, also zentrale Steuereinrichtung (ZSE) für Sub-Netz des Datenübertragungsnetzes aus Datenbussen und Quantencomputern dienen können.

Das Quantencomputersystem (QUSYS) kann somit hierarchisch strukturiert sein, wobei die Steuervorrichtungen (µC) einzelner Quantencomputer Zentrale Steuereinrichtung (ZSE) von Unterquantencomputersystemen sind. Die Unterquantencomputersysteme sind dabei selbst Quantencomputersysteme (QUSYS). Die zentrale Steuereinrichtung (ZSE) des Unterquantencomputersystems ist dabei bevorzugt selbst ein Quantencomputer, der bevorzugt selbst wieder Teil eines übergeordneten Quantencomputersystems (QUSYS) ist.

Durch diese Hierarchisierung können unterschiedliche Berechnungen in unterschiedlichen Unterquantencomputersystemen parallel bearbeitet werden, wobei die Anzahl der verwendeten Quantencomputer je nach Aufgabe anders gewählt wird.

Bevorzugt umfasst somit das Quantencomputersystem mehrere miteinander gekoppelte Rechnereinheiten. Eine solche Rechnereinheit kann eine Programm der künstlichen Intelligenz verwenden, die mit den Quantencomputern und/oder den Quantenregistern und/oder den Quantenbits gekoppelt werden kann. Dabei kann sowohl die Eingabe in das Programm der künstlichen Intelligenz von dem Zustand der Quantenpunkte dieser Komponenten des Quantencomputersystems abhängen, als auch die Ansteuerung der Quantenbist und Quantenpunkte dieser Komponenten des Quantencomputersystems von den Ergebnissen des Programms der künstlichen Intelligenz abhängen. Das Programm der künstlichen Intelligenz kann sowohl in der die zentrale Steuereinrichtung (ZSE)als auch in den Steuervorrichtungen (µC) der Quantencomputer ausgeführt werden. Hierbei können auch nur Teile des Programms der künstlichen Intelligenz in der die zentrale Steuereinrichtung (ZSE) ausgeführt werden, während andere Teile des Programms der künstlichen Intelligenz in der Steuervorrichtungen (µC) von Quantencomputern innerhalb des Quantencomputersystems ausgeführt werden. Auch können hierbei auch nur Teile des Programms der künstlichen Intelligenz in einer Steuervorrichtung (µC) eines Quantencomputers ausgeführt werden, während andere Teile des Programms der künstlichen Intelligenz in anderen Steuervorrichtungen (µC) anderer Quantencomputer innerhalb des Quantencomputersystems ausgeführt werden. Dies Abarbeitung eines Programms der künstlichen Intelligenz kann also über das Quantencomputersystem verteilt sein oder in einer Rechnereinheit konzentriert erfolgen. Dabei wirkt das Programm der künstlichen Intelligenz mit Quantenpunkten (NV) der Quantencomputer zusammen. Die Rechnereinheit kann also in Wirklichkeit auch ein System aus Rechnereinheiten sein. Eine Rechnereinheit kann eine beispielsweise somit die zentrale Steuereinrichtung (ZSE) eines Quantencomputersystems (QSYS) mit einem oder mehreren Quantenpunkten (NV) und/oder eine oder mehrere Steuervorrichtungen (µC) eines Quantencomputers mit einem oder mehreren Quantenpunkten (NV) umfassen. Komplexere Topologien mit weiteren zwischengeschalteten Rechnerknoten sind denkbar. Die Rechnereinheit, die wie beschrieben auch ein Verbund von Rechnereinheiten sein kann, führt ein Programm der künstlichen Intelligenz aus. Ein solche Programm der künstlichen Intelligenz kann beispielsweise ein neuronales Netzwerkmodell mit neuronalen Netzwerkknoten sein. Das neuronale Netzwerkmodell verwendet dabei typischerweise ein oder mehrere Eingangswerte und/oder ein oder mehrere Eingangssignale. Das neuronale Netzwerkmodell, liefert typischerweise ein oder mehrere Ausgangswerte und/oder ein oder mehrere Ausgangssignale. Es wird hier nun vorgeschlagen das Programm der künstlichen Intelligenz durch ein Programm zu ergänzen, das eine oder mehrere der oben erwähnten Quantenoperationen auf einem oder mehreren Quantencomputern ausführt. Diese Kopplung KANN BEISPIELSWEISE IN DER EINEN Richtung dadurch geschehen, dass die Ansteuerung eines oder mehrere Quantenpunkte (NV), insbesondere mittels horizontaler Leitungen (LH) und/oder vertikaler Leitungen (LV), von einem oder mehreren Ausgangswerten und/oder einem oder mehreren Ausgangssignalen des neuronalen Netzwerkmodells abhängt. In der Anderen Richtung werden zu einem Zeitpunkt Zustände eines oder mehrerer Quantenpunkte ausgelesen und in dem Programm der künstlichen Intelligenz, in diesem Beispiel dem neuronalen Netzwerkmodell, als Eingabe verwendet. Der Wert eines oder mehrerer Eingangswerte und/oder eines oder mehrerer Eingangssignale des Programms der künstlichen Intelligenz, hier desneutonalen Netzwerkmodells, hängt dann von dem Zustand eines oder mehrerer der Quantenpunkte (NV) ab.

### Glossar

### Grünes Licht

Grünes Licht wird in der technischen Lehre dieser Offenlegung für das Rücksetzen der Quantenpunkte (NV) verwendet. Es hat sich gezeigt, dass in Verbindung mit NV-Zentren als Quantenpunkte (NV) in Diamant als Substrat (D) und/oder der epitaktischen Schicht (DEPI) prinzipiell Licht mit einer Wellenlänge von höchstens 700nm und mindestens 500nm besonders geeignet ist. Im Zusammenhang mit anderen Materialien des Substrats (D) und/oder der epitaktischen Schicht (DEPI) kann ein ganz anderer Wellenlängenbereich die gleichen Funktionen erfüllen. Insofern ist grünes Licht hier als Funktionsdefinition verstanden werden, wobei die Funktion als äquivalent zu der Funktion in dem System mit NV-Zentren in Diamant als Quantenpunkten (NV) verstanden werden soll. Insbesondere bei der Verwendung eines NV-Zentrums (NV) als Quantenpunkt (NV) sollte das grüne Licht eine Wellenlänge in einem Wellenlängenbereich von 400 nm bis 700 nm Wellenlänge und/oder besser 450 nm bis 650 nm und/oder besser 500 nm bis 550 nm und/oder besser 515 nm bis 540 nm aufweisen. Bevorzugt ist dabei eine Wellenlänge von 532 nm Wellenlänge. Licht, dass bei der Verwendung anderer Quantenpunkttypen als von NV-Zentren in Diamant zur Ausführung gleicher Funktionen verwendet wird, wird ebenfalls als "grünes Licht" bezeichnet. Insofern sind solche Ausführungen von Ansprüchen umfasst in denen von "grünem Licht" die Rede ist.

### horizontal

Das Eigenschaftswort "horizontal" wird in dieser Offenlegung sofern nicht ausdrücklich anders angegeben als Teil des Namens der Vorrichtungsteile und der zugehörigen Größen verwendet. Dies geschieht, da die Quantenbits durchnummeriert sind. Hierdurch können die Spalten (vertikal) und Zeilen (horizontal) innerhalb von zweidimensionalen Quantenbit-Anordnungen besser unterschieden werden. Eine "horizontale Leitung" ist demnach eine Leitung innerhalb einer solchen zwei- oder eindimensionalen Anordnung, die längs einer Zeile entlanggeführt ist. Der zugeordnete Strom wird dann beispielsweise in analoger Weise als "horizontaler Leitungsstrom" bezeichnet, um ein Beispiel für die Benennung einer Größe zu geben.

### Isotopenrein

Isotopenrein im Sinne dieser Offenlegung ist ein Material dann, wenn die Konzentration anderer Isotope als der Basis-Isotope, die das Material dominieren, so gering ist, dass der technische Zweck in einem für die Produktion und den Verkauf von Produkten ausreichenden Maße mit einer wirtschaftlich ausreichenden Produktionsausbeute erreicht wird. Dies bedeutet, dass Störungen, die von solchen Isotopenverunreinigungen ausgehen, die Funktionstüchtigkeit der Quantenbits nicht oder höchstens ausreichend gering stören. Auf Diamant bezogen heißt das, dass der Diamant bevorzugt im Wesentlichen aus ¹²C-Isotopen als Basis-Isotopen besteht, die kein magnetisches Moment haben.

### Nähe

Wenn in dieser Offenlegung beispielsweise von einer "Vorrichtung, die zur Erzeugung eines zirkular polarisierten Mikrowellenfeldes sich in der Nähe des Lot-Punktes (LOTP) oder am Lot-Punkt (LOTP) befindet" die Rede ist, so ist der Begriff Nähe so zu verstehen, dass diese Vorrichtung mit ihrem polarisierten Mikrowellenfeld oder sonst wie auf den Quantenpunkt (NV), der sich auf der Lot-Linie (LOT) befindet, eine beabsichtigte Wirkung ausübt oder ausüben kann, wobei beabsichtigt wiederum im Zusammenhang mit der hier vorgelegten Offenlegung so zu verstehen ist, dass durch die beabsichtigte Wirkung ein Verfahrensschritt in den Funktionsschritten zur bestimmungsgemäßen Nutzung einer hier vorgeschlagenen Vorrichtung durchgeführt werden kann.

### Reines Substrat

Ein reines Substrat im Sinne dieser Offenlegung liegt dann vor, wenn die Konzentration anderer Atome als der Basis-Atome, die das Material des Substrats dominieren, so gering ist, dass der technische Zweck in einem für die Produktion und den Verkauf von Produkten ausreichenden Maße mit einer wirtschaftlich ausreichenden Produktionsausbeute erreicht wird. Dies bedeutet, dass Störungen, die von solchen atomaren Verunreinigungen ausgehen, die Funktionstüchtigkeit der Quantenbits nicht oder höchstens ausreichend gering stören. Auf Diamant bezogen heißt das, dass der Diamant bevorzugt im Wesentlichen aus C-Atomen besteht und keine oder nur unwesentlich viele Fremdatome umfasst. Bevorzugt enthält der das Substrat möglichst keine ferromagnetischen Verunreinigungen wie beispielsweise Fe und/oder Ni, da deren Magnetfelder mit dem Spin des Quantenpunkts (NV) wechselwirken können.

### unwesentliche Phasendrehung

Eine unwesentliche Phasendrehung des Zustandsvektors eines Quantenpunkts im Sinne dieser Offenlegung ist eine Phasendrehung, die für den Betrieb und die Funktionstüchtigkeit als unwesentlich oder korrigierbar betrachtet werden kann. Sie kann daher in erster Näherung als gleich null angenommen werden.

### vertikal

Das Eigenschaftswort " vertikal " wird in dieser Offenlegung sofern nicht ausdrücklich anders angegeben als Teil des Namens der Vorrichtungsteile und der zugehörigen Größen verwendet. Dies geschieht, da die Quantenbits durchnummeriert sind. Hierdurch können die Spalten (vertikal) und Zeilen (horizontal) innerhalb von zweidimensionalen Quantenbit-Anordnungen besser unterschieden werden. Eine " vertikal Leitung" ist demnach eine Leitung innerhalb einer solchen zwei- oder eindimensionalen Anordnung, die längs einer Spalte entlanggeführt ist. Der zugeordnete Strom wird dann beispielsweise in analoger Weise als " vertikal Leitungsstrom" bezeichnet, um ein Beispiel für die Benennung einer Größe zu geben.

### Bezugszeichenliste

- 50Ω: Abschlusswiderstand als Beispiel einer Realisierung einer Empfängerstufe (HS1, HS2, HS3, VS3). In dem Beispiel der Figur 36 schließen die Abschlusswiderstände die horizontalen und vertikalen Leitungen ab, um Reflexionen zu verhindern. Je nach Konstruktion der Leitungen kann deren Wellenwiderstandswert abweichen. In dem Fall sollte der Wert des Abschlusswiderstands entsprechend angepasst werden.
- α: Kreuzungswinkel in dem sich die vertikale Leitung (LV) und die horizontale Leitung (LH) kreuzen. Dieser Kreuzungswinkel hat bevorzugt einen Winkelbetrag von π/2.
- α11: Kreuzungswinkel in dem sich die erste vertikale Leitung (LV1) und die erste horizontale Leitung (LH1) kreuzen. Dieser Kreuzungswinkel hat bevorzugt einen Winkelbetrag von π/2.
- α12: Kreuzungswinkel in dem sich die zweite vertikale Leitung (LV2) und die erste horizontale Leitung (LH1) kreuzen. Dieser Kreuzungswinkel hat bevorzugt einen Winkelbetrag von π/2.
- A: Amperemeter. In dem Beispiel der Figur 36 wird das Amperemeter, das dort ein Stromsensor ist, benutzt, um einen Messwert für den Fotostrom zu gewinnen, der von den Quantenpunkten des Quantencomputers erzeugt wird. In dem Beispiel der Figur 36 wird das Amperemeter von der Steuervorrichtung (µC) gesteuert und ausgelesen.
- β: Winkel von π/2 (rechter Winkel) zwischen Lot-Linie (LOT) und Oberfläche (OF) des Substrats (D) bzw. der epitaktischen Schicht (DEPI);
- B_{CI}: Flussdichtevektor des zirkular polarisierten elektromagnetischen Wellenfelds zur Manipulation des Kernquantenpunkts (CI) am Ort des Kernquantenpunkts (CI). In Figur 2 ist zum besseren Verständnis die Rotation dieses Flussdichtevektors eingezeichnet. In der Figur 2 wird die Rotation des Flussdichtevektors durch Ansteuerung der horizontalen Leitung (LH) mit einem horizontalen Stromanteil (IH), der mit einer horizontalen Kern-Kern-Radiowellenfrequenz (f_{RWHCC}) mit einer horizontalen Modulation moduliert ist, und durch Ansteuerung der vertikalen Leitung (LV) mit einem vertikalen Stromanteil (IV), der mit einer vertikalen Kern-Kern-Radiowellenfrequenz (f_{RWVCC}) mit einer vertikalen Modulation moduliert, die um +/- π/2 in der Phase gegenüber der horizontalen Modulation verschoben ist. Die vertikale Kern-Kern-Radiowellenfrequenz (f_{RWVCC}) und die horizontale Kern-Kern-Radiowellenfrequenz (f_{RWHCC}) sind typischerweise zueinander gleich und damit typischerweise gleich einer gemeinsamen Kern-Kern-Radiowellenfrequenz (f_{RWCC}).
- B_{CI1}: Flussdichtevektor des zirkular polarisierten elektromagnetischen Wellenfelds zur Manipulation des ersten Kernquantenpunkts (CI1) am Ort des ersten Kernquantenpunkts (CI1);
- B_{CI2}: Flussdichtevektor des zirkular polarisierten elektromagnetischen Wellenfelds zur Manipulation des zweiten Kernquantenpunkts (CI2) am Ort des zweiten Kernquantenpunkts (CI2);
- B_{CI3}: Flussdichtevektor des zirkular polarisierten elektromagnetischen Wellenfelds zur Manipulation des dritten Kernquantenpunkts (CI3) am Ort des dritten Kernquantenpunkts (CI3);
- B_{NV}: Flussdichtevektor des zirkular polarisierten elektromagnetischen Wellenfelds zur Manipulation des Quantenpunkts (NV) am Ort des Quantenpunkts (NV). In Figur 1 ist zum besseren Verständnis die Rotation dieses Flussdichtevektors eingezeichnet. In der Figur 1 wird die Rotation des Flussdichtevektors durch Ansteuerung der horizontalen Leitung (LH) mit einem horizontalen Stromanteil (IH), der mit einer horizontalen Elektron-Elektron-Mikrowellenfrequenz (f_{MWH}) mit einer horizontalen Modulation moduliert ist, und durch Ansteuerung der vertikalen Leitung (LV) mit einem vertikalen Stromanteil (IV), der mit einer vertikalen Elektron-Elektron-Mikrowellenfrequenz (f_{MWV}) mit einer vertikalen Modulation moduliert, die um +/- π/2 in der Phase gegenüber der horizontalen Modulation verschoben ist. Die vertikale Elektron-Elektron-Mikrowellenfrequenz (f_{MWV}) und die horizontale Elektron-Elektron-Mikrowellenfrequenz (f_{MWH}) sind typischerweise zueinander gleich und damit typischerweise gleich einer gemeinsamen Elektron-Elektron-Mikrowellenfrequenz (f_{MW}).
- B_{NV1}: Flussdichtevektor des zirkular polarisierten elektromagnetischen Wellenfelds zur Manipulation des ersten Quantenpunkts (NV1) am Ort des ersten Quantenpunkts (NV1);
- B_{NV2}: Flussdichtevektor des zirkular polarisierten elektromagnetischen Wellenfelds zur Manipulation des zweiten Quantenpunkts (NV2) am Ort des zweiten Quantenpunkts (NV2);
- B_{NV3}: Flussdichtevektor des zirkular polarisierten elektromagnetischen Wellenfelds zur Manipulation des dritten Quantenpunkts (NV3) am Ort des dritten Quantenpunkts (NV3);
- BSC: Rückseitenkontakt des Substrats (D);
- B_{VHNV1}: erster virtueller horizontaler magnetischer Flussdichtevektor am Ort des ersten virtuellen horizontalen Quantenpunkts (VHNV1);
- B_{VHNV2}: zweiter virtueller horizontaler magnetischer Flussdichtevektor am Ort des zweiten virtuellen horizontalen Quantenpunkts (VHNV2);
- B_{VVNV1}: erster virtueller vertikaler magnetischer Flussdichtevektors am Ort des ersten virtuellen vertikalen Quantenpunkts (VVNV1);
- B_{VVNV2}: zweiter virtueller vertikaler magnetischer Flussdichtevektors am Ort des zweiten virtuellen vertikalen Quantenpunkts (VVNV2);
- CB: Control-Bus;
- CBA: Kontrolleinheit A;
- CBB: Kontrolleinheit B;
- CI: Kernquantenpunkt;
- CI1: erster Kernquantenpunkt;
- CI1₁: erster Kernquantenpunkt (CI1₁) der ersten QuantenALU (QUALU1);
- CI1₂: zweiter Kernquantenpunkt (CI1₂) der ersten QuantenALU (QUALU1);
- CI1₃: dritter Kernquantenpunkt (CI1₃) der ersten QuantenALU (QUALU1);
- CI11₁: erster Kernquantenpunkt (CI11₁) der QuantenALU (QUALU11) der ersten Spalte und ersten Zeile;
- CI11₂: zweiter Kernquantenpunkt (CI11₂) der QuantenALU (QUALU11) der ersten Spalte und ersten Zeile;
- CI11₃: dritter Kernquantenpunkt (CI11₃) der QuantenALU (QUALU11) der ersten Spalte und ersten Zeile;
- CI11₄: vierter Kernquantenpunkt (CI11₄) der QuantenALU (QUALU11) der ersten Spalte und ersten Zeile;
- CI12₁: erster Kernquantenpunkt (CI12₁) der QuantenALU (QUALU12) der zweiten Spalte und ersten Zeile;
- CI12₂: zweiter Kernquantenpunkt (CI12₂) der QuantenALU (QUALU12) der zweiten Spalte und ersten Zeile;
- CI12₃: dritter Kernquantenpunkt (CI12₃) der QuantenALU (QUALU12) der zweiten Spalte und ersten Zeile;
- CI12₄: vierter Kernquantenpunkt (CI12₄) der QuantenALU (QUALU12) der zweiten Spalte und ersten Zeile;
- CI13₁: erster Kernquantenpunkt (CI13₁) der QuantenALU (QUALU13) der dritten Spalte und ersten Zeile;
- CI13₂: zweiter Kernquantenpunkt (CI13₂) der QuantenALU (QUALU13) der dritten Spalte und ersten Zeile;
- CI13₃: dritter Kernquantenpunkt (CI13₃) der QuantenALU (QUALU13) der dritten Spalte und ersten Zeile;
- CI13₄: vierter Kernquantenpunkt (CI13₄) der QuantenALU (QUALU13) der dritten Spalte und ersten Zeile;
- CI14₁: erster Kernquantenpunkt (CI14₁) der QuantenALU (QUALU14) der vierten Spalte und ersten Zeile;
- CI14₂: zweiter Kernquantenpunkt (CI14₂) der QuantenALU (QUALU14) der vierten Spalte und ersten Zeile;
- CI14₃: dritter Kernquantenpunkt (CI14₃) der QuantenALU (QUALU14) der vierten Spalte und ersten Zeile;
- CI14₄: vierter Kernquantenpunkt (CI14₄) der QuantenALU (QUALU14) der vierten Spalte und ersten Zeile;
- CI2: zweiter Kernquantenpunkt;
- CI2₁: erster Kernquantenpunkt (CI2₁) der zweiten QuantenALU (QUALU2);
- CI2₂: zweiter Kernquantenpunkt (CI2₂) der zweiten QuantenALU (QUALU2);
- CI2₃: dritter Kernquantenpunkt (CI2₃) der zweiten QuantenALU (QUALU2);
- CI21₁: erster Kernquantenpunkt (CI21₁) der QuantenALU (QUALU11) der ersten Spalte und zweiten Zeile;
- CI21₂: zweiter Kernquantenpunkt (CI21₂) der QuantenALU (QUALU11) der ersten Spalte und zweiten Zeile;
- CI21₃: dritter Kernquantenpunkt (CI21₃) der QuantenALU (QUALU11) der ersten Spalte und zweiten Zeile;
- CI21₄: vierter Kernquantenpunkt (CI21₄) der QuantenALU (QUALU11) der ersten Spalte und zweiten Zeile;
- CI22₁: erster Kernquantenpunkt (CI22₁) der QuantenALU (QUALU12) der zweiten Spalte und zweiten Zeile;
- CI22₂: zweiter Kernquantenpunkt (CI22₂) der QuantenALU (QUALU12) der zweiten Spalte und zweiten Zeile;
- CI22₃: dritter Kernquantenpunkt (CI22₃) der QuantenALU (QUALU12) der zweiten Spalte und zweiten Zeile;
- CI22₄: vierter Kernquantenpunkt (CI22₄) der QuantenALU (QUALU12) der zweiten Spalte und zweiten Zeile;
- CI23₁: erster Kernquantenpunkt (CI23₁) der QuantenALU (QUALU13) der dritten Spalte und zweiten Zeile;
- CI23₂: zweiter Kernquantenpunkt (CI23₂) der QuantenALU (QUALU13) der dritten Spalte und zweiten Zeile;
- CI23₃: dritter Kernquantenpunkt (CI23₃) der QuantenALU (QUALU13) der dritten Spalte und zweiten Zeile;
- CI23₄: vierter Kernquantenpunkt (CI23₄) der QuantenALU (QUALU13) der dritten Spalte und zweiten Zeile;
- CI24₁: erster Kernquantenpunkt (CI24₁) der QuantenALU (QUALU14) der vierten Spalte und zweiten Zeile;
- CI24₂: zweiter Kernquantenpunkt (CI24₂) der QuantenALU (QUALU14) der vierten Spalte und zweiten Zeile;
- CI24₃: dritter Kernquantenpunkt (CI24₃) der QuantenALU (QUALU14) der vierten Spalte und zweiten Zeile;
- CI24₄: vierter Kernquantenpunkt (CI24₄) der QuantenALU (QUALU14) der vierten Spalte und zweiten Zeile;
- CI3: dritter Kernquantenpunkt;
- CI31₁: erster Kernquantenpunkt (CI31₁) der QuantenALU (QUALU11) der ersten Spalte und dritten Zeile;
- CI31₂: zweiter Kernquantenpunkt (CI31₂) der QuantenALU (QUALU11) der ersten Spalte und dritten Zeile;
- CI31₃: dritter Kernquantenpunkt (CI31₃) der QuantenALU (QUALU11) der ersten Spalte und dritten Zeile;
- CI31₄: vierter Kernquantenpunkt (CI31₄) der QuantenALU (QUALU11) der ersten Spalte und dritten Zeile;
- CI32₁: erster Kernquantenpunkt (CI32₁) der QuantenALU (QUALU12) der zweiten Spalte und dritten Zeile;
- CI32₂: zweiter Kernquantenpunkt (CI32₂) der QuantenALU (QUALU12) der zweiten Spalte und dritten Zeile;
- CI32₃: dritter Kernquantenpunkt (CI32₃) der QuantenALU (QUALU12) der zweiten Spalte und dritten Zeile;
- CI32₄: vierter Kernquantenpunkt (CI32₄) der QuantenALU (QUALU12) der zweiten Spalte und dritten Zeile;
- CI33₁: erster Kernquantenpunkt (CI33₁) der QuantenALU (QUALU13) der dritten Spalte und dritten Zeile;
- CI33₂: zweiter Kernquantenpunkt (CI33₂) der QuantenALU (QUALU13) der dritten Spalte und dritten Zeile;
- CI33₃: dritter Kernquantenpunkt (CI33₃) der QuantenALU (QUALU13) der dritten Spalte und dritten Zeile;
- CI33₄: vierter Kernquantenpunkt (CI33₄) der QuantenALU (QUALU13) der dritten Spalte und dritten Zeile;
- CI34₁: erster Kernquantenpunkt (CI34₁) der QuantenALU (QUALU14) der vierten Spalte und dritten Zeile;
- CI34₂: zweiter Kernquantenpunkt (CI34₂) der QuantenALU (QUALU14) der vierten Spalte und dritten Zeile;
- CI34₃: dritter Kernquantenpunkt (CI34₃) der QuantenALU (QUALU14) der vierten Spalte und dritten Zeile;
- CI34₄: vierter Kernquantenpunkt (CI34₄) der QuantenALU (QUALU14) der vierten Spalte und dritten Zeile;
- D: Substrat. Bei dem Substrat kann es sich bevorzugt um ein Wide-Band-Gap-Material handeln. Ganz besonders bevorzugt wird Diamant verwendet. Es wird hier aber auch vorgeschlagen, andere Wide-Band-Gap-Materialien, wie BN, GaN etc. zu erproben. Auch ist die Verwendung anderer Materialien aus Elementen der IV. Hauptgruppe des Periodensystems und deren Mischkristalle denkbar. Auch ist die Verwendung von Isolatoren mit hoher Ladungsträgerbeweglichkeit denkbar. Hierbei ist auf die Isotopenzusammensetzung zu achten, da das Material keine magnetischen Kernmomente µ aufweisen darf. Bevorzugt kann es sich bei dem Substrat um Diamant handeln, der bevorzugt isotopenrein ist. Besonders bevorzugt ist die Verwendung von isotopenreinem, im Wesentlichen ¹²C-Isotope umfassenden Diamant. Bevorzugt enthält der Diamant möglichst keine ferromagnetischen Verunreinigungen wie beispielsweise Fe und/oder Ni. Bevorzugt handelt es sich bei dem Substrat (D) und/oder der Epitaxieschicht (DEPI) um Diamant. Bevorzugt sind das Substrat (D) und/oder die Epitaxieschicht (DEPI) aus dem gleichen Material. Wird Silizium als Substratmaterial verwendet, so umfasst das Material des Substrats im Wesentlichen bevorzugt ²⁸Si-Isotope und/oder ³⁰Si-Isotope, da diese keinen Kernspin aufweisen. Wird Siliziumkarbid als Substratmaterial verwendet, so umfasst das Material des Substrats im Wesentlichen bevorzugt ²⁸Si-Isotope und/oder ³⁰Si-Isotope und ¹²C-Isotope und/oder ¹⁴C-Isotope, da diese keinen Kernspin aufweisen;
- d1: Abstand des Quantenpunkts (NV) des Quantenbist (QUB) unter der Oberfläche (OF) des Substrats (D) und/oder der ggf. vorhandenen epitaktischen Schicht (DEPI), wobei der erste Abstand längs der Lot-Line (LOT) vom Quantenpunkts (NV) des Quantenbist (QUB) zur Oberfläche (OF) des Substrats (D) und/oder der ggf. vorhandenen epitaktischen Schicht (DEPI) gemessen wird, bzw.
erster Abstand des ersten Quantenpunkts (NV1) des ersten Quantenbits (QUB1) des Quantenregisters (QUREG) unter der Oberfläche (OF) des Substrats (D) und/oder der ggf. vorhandenen epitaktischen Schicht (DEPI), wobei der erste Abstand längs der Lot-Line (LOT) vom ersten Quantenpunkt (NV1) des ersten Quantenbits (QUB1) des Quantenregisters (QUREG) zur Oberfläche (OF) des Substrats (D) und/oder der ggf. vorhandenen epitaktischen Schicht (DEPI) gemessen wird;
- d2: zweiter Abstand des zweiten Quantenpunkts (NV2) des zweiten Quantenbits (QUB2) des Quantenregisters (QUREG) unter der Oberfläche (OF) des Substrats (D) und/oder der ggf. vorhandenen epitaktischen Schicht (DEPI), wobei der erste Abstand längs der Lot-Line (LOT) vom zweiten Quantenpunkt (NV2) des zweiten Quantenbits (QUB1) des Quantenregisters (QUREG) zur Oberfläche (OF) des Substrats (D) und/oder der ggf. vorhandenen epitaktischen Schicht (DEPI) gemessen wird;
- DEPI: epitaktische Schicht, die auf dem Substrat (D) aufgebracht ist. Die epitaktische Schicht wird bevorzugt mittels CVD-Verfahren auf einem der orientierten Oberfläche eines Einkristalls abgeschieden. Bevorzugt ist die epitaktische Schicht isotopenrein. Dies ermöglicht lange Kohärenzzeiten. Auch ist eine solche Schicht bevorzugt weitestgehend frei von Fremdatomen. Die Dicke der Schicht wird bevorzugt so gewählt, dass eine Wechselwirkung zwischen den Kristallstörungen des Substrats(D), beispielsweise in Form von Isotopenabweichungen (z.B. in Form von ¹³C-Isotopen bei Diamant als Substrat) oder Fremdatomen (z.B. Fe- oder Ni-Atomen) minimiert wird. Im Falle von NV-Zentren in Diamant können dann preiswerte in Metallschmelzen gezüchtete Diamanten als Substrat (D) verwendet werden, obwohl diese großen Mengen an Eisenatomen (Fe-Atome) enthalten. Sofern die Qualität des Substrats (D) ausreichend ist, kann auf die epitaktische Schicht verzichtet werden. Aus diesem Grund ist diese epitaktische Schicht (DEPI) nicht in allen Figuren eingezeichnet. Bevorzugt umfasst die epitaktische Schicht zumindest im Bereich der Quantenpunkte (NV) bzw. im Bereich der Kernquantenpunkte (CI) im Wesentlichen keine Isotope mit magnetischen Kernmoment. Im Falle von Diamant als epitaktische Schicht umfasst die epitaktische Schicht bevorzugt im Wesentlichen ¹²C-Isotope und ¹⁴C-Isotope. Im Falle von Diamant als epitaktische Schicht umfasst die epitaktische Schicht noch stärker bevorzugt im Wesentlichen nur ¹²C-Isotope. Im Falle von Silizium als epitaktische Schicht umfasst die epitaktische Schicht bevorzugt im Wesentlichen ²⁸Si-Isotope und ³⁰Si-Isotope. Im Falle von Silizium als epitaktische Schicht umfasst die epitaktische Schicht noch stärker bevorzugt im Wesentlichen nur ²⁸Si-Isotope. Im Falle von Siliziumkarbid als epitaktische Schicht umfasst die epitaktische Schicht bevorzugt im Wesentlichen ²⁸Si-Isotope und ³⁰Si-Isotope bzw. ¹²C-Isotope und ¹⁴C-Isotope. Im Falle von Silizium als epitaktische Schicht umfasst die epitaktische Schicht noch stärker bevorzugt im Wesentlichen nur ²⁸Si-Isotope bzw. ¹²C-Isotope.
- DOT: Bereich der Kontaktdotierung des Substrats(D) bzw. der epitaktischen Schicht (DEPI);
- DR: Drain. Das Drain in Figur 37 entspricht dem Kontakt KV12 in Figur 19.
- f_{MW}: gemeinsame Elektron-Elektron-Mikrowellenfrequenz (f_{MW});
- f_{MW1}: erste Elektron1-Elektron1-Mikrowellenresonanzfrequenz (f_{MW1});
- f_{MWCE1}: erste Kern-Elektron- Mikrowellenresonanzfrequenz;
- f_{MWCE2}: zweite Kern-Elektron- Mikrowellenresonanzfrequenz;
- f_{MWCE1_1}: erste Kern-Elektron- Mikrowellenresonanzfrequenz für die erste QuantenALU (QUALU1) zur Ansteuerung des ersten Kernquantenpunkts (CI2₁) der ersten QuantenALU (QUALU1);
- f_{MWCE2_1}: zweite Kern-Elektron- Mikrowellenresonanzfrequenz für die erste QuantenALU (QUALU1) zur Ansteuerung des zweiten Kernquantenpunkts (CI2₂) der ersten QuantenALU (QUALU1);
- f_{MWCE3_1}: dritte Kern-Elektron- Mikrowellenresonanzfrequenz für die erste QuantenALU (QUALU1) zur Ansteuerung des dritten Kernquantenpunkts (CI2₃) der ersten QuantenALU (QUALU1);
- f_{MWCE1_2}: erste Kern-Elektron- Mikrowellenresonanzfrequenz für die zweite QuantenALU (QUALU2) zur Ansteuerung des ersten Kernquantenpunkts (CI2₁) der zweiten QuantenALU (QUALU2);
- f_{MWCE2_2}: zweite Kern-Elektron- Mikrowellenresonanzfrequenz für die zweite QuantenALU (QUALU2) zur Ansteuerung des zweiten Kernquantenpunkts (CI2₂) der zweiten QuantenALU (QUALU2);
- f_{MWCE3_2}: dritte Kern-Elektron- Mikrowellenresonanzfrequenz für die zweite QuantenALU (QUALU2) zur Ansteuerung des dritten Kernquantenpunkts (CI2₃) der zweiten QuantenALU (QUALU2);
- f_{MW2}: zweite Elektron1-Elektron1-Mikrowellenresonanzfrequenz (f_{MW2});
- f_{MWH}: horizontale Elektron-Elektron-Mikrowellenfrequenz. Die vertikale Elektron-Elektron-Mikrowellenfrequenz (f_{MWV}) und die horizontale Elektron-Elektron-Mikrowellenfrequenz (f_{MWH}) sind typischerweise zueinander gleich und damit typischerweise gleich einer gemeinsamen Elektron-Elektron-Mikrowellenfrequenz (f_{MW});
- f_{MWH1}: erste horizontale Elektron-Elektron-Mikrowellenfrequenz. Die erste vertikale Elektron-Elektron-Mikrowellenfrequenz (f_{MWV1}) und die erste horizontale Elektron-Elektron-Mikrowellenfrequenz (f_{MWH1}) sind typischerweise zueinander gleich und damit typischerweise gleich einer gemeinsamen ersten Elektron-Elektron-Mikrowellenfrequenz (f_{MW1});
- f_{MWHEE1}: erste horizontalen Elektron1-Elektron2-Mikrowellenresonanzfrequenz;
- f_{MWHEE2}: zweite horizontale Elektron1-Elektron2-Mikrowellenresonanzfrequenz;
- f_{MWV}: vertikale Elektron-Elektron-Mikrowellenfrequenz. Die vertikale Elektron-Elektron-Mikrowellenfrequenz (f_{MWV}) und die horizontale Elektron-Elektron-Mikrowellenfrequenz (f_{MWH}) sind typischerweise zueinander gleich und damit typischerweise gleich einer gemeinsamen Elektron-Elektron-Mikrowellenfrequenz (f_{MW});
- f_{MWV1}: erste vertikale Elektron-Elektron-Mikrowellenfrequenz. Die erste vertikale Mikrowellenfrequenz (f_{MWV1}) und die erste horizontale Elektron-Elektron-Mikrowellenfrequenz (f_{MWH1}) sind typischerweise zueinander gleich und damit typischerweise gleich einer gemeinsamen ersten Elektron-Elektron-Mikrowellenfrequenz (f_{MW1});

- f_{MWVEE1}: erste vertikale Elektron1-Elektron2-Mikrowellenresonanzfrequenz;
- f_{RWCC}: Kern-Kern-Radiowellenfrequenz. Die horizontale Kern-Kern-Radiowellenfrequenz (f_{RWHCC}) und die vertikale Kern-Kern-Radiowellenfrequenz (f_{RWVCC}) sind typischerweise gleich zueinander und gleich einer gemeinsamen Kern-Kern-Radiowellenfrequenz (f_{RWCC});
- f_{RWHCC}: horizontale Kern-Kern-Radiowellenfrequenz. Die horizontale Kern-Kern-Radiowellenfrequenz (f_{RWHCC}) und die vertikale Kern-Kern-Radiowellenfrequenz (f_{RWVCC}) sind typischerweise gleich zueinander und gleich einer gemeinsamen Kern-Kern-Radiowellenfrequenz (f_{RWCC});
- f_{RWVCC}: vertikale Kern-Kern-Radiowellenfrequenz. Die horizontale Kern-Kern-Radiowellenfrequenz (f_{RWHCC}) und die vertikale Kern-Kern-Radiowellenfrequenz (f_{RWVCC}) sind typischerweise gleich zueinander und gleich einer gemeinsamen Kern-Kern-Radiowellenfrequenz (f_{RWCC});
- f_{RWEC1_1}: erste Elektron-Kern-Radiowellenresonanzfrequenz für die erste QuantenALU (QUALU1) zur Ansteuerung des ersten Kernquantenpunkts (CI1₁) der ersten QuantenALU (QUALU1);
- f_{RWEC2_1}: zweite Elektron-Kern-Radiowellenresonanzfrequenz für die erste QuantenALU (QUALU1) zur Ansteuerung des zweiten Kernquantenpunkts (CI1₂) der ersten QuantenALU (QUALU1);
- f_{RWEC3_1}: dritte Elektron-Kern-Radiowellenresonanzfrequenz für die erste QuantenALU (QUALU1) zur Ansteuerung des dritten Kernquantenpunkts (CI1₃) der ersten QuantenALU (QUALU1);
- f_{RWEC1_2}: erste Elektron-Kern-Radiowellenresonanzfrequenz für die zweite QuantenALU (QUALU2) zur Ansteuerung des ersten Kernquantenpunkts (CI2₁) der zweiten QuantenALU (QUALU2);
- f_{RWEC2_2}: zweite Elektron-Kern-Radiowellenresonanzfrequenz für die zweite QuantenALU (QUALU2) zur Ansteuerung des zweiten Kernquantenpunkts (CI2₂) der zweiten QuantenALU (QUALU2);
- f_{RWEC3_2}: dritte Elektron-Kern-Radiowellenresonanzfrequenz für die zweite QuantenALU (QUALU2) zur Ansteuerung des dritten Kernquantenpunkts (CI2₃) der zweiten QuantenALU (QUALU2);
- GOX: Bereich des Gate-Oxid-Fensters in dem die weitere Isolation (IS2) bevorzugt auf ein Minimalmaß reduziert ist.
- HD: horizontale Treiberstufe (HD) zur Ansteuerung des anzusteuernden Quantenbits (QUB);
- HD1: erste horizontale Treiberstufe (HD1) zur Ansteuerung des ersten anzusteuernden Quantenbits (QUB1);
- HD2: zweite horizontale Treiberstufe (HD2) zur Ansteuerung des zweiten anzusteuernden Quantenbits (QUB2);
- HD3: dritte horizontale Treiberstufe (HD3) zur Ansteuerung des dritten anzusteuernden Quantenbits (QUB3);
- HLOT1: erste weitere horizontale Lot-Linie (HLOT1) parallel zur ersten Lot-Linie (LOT) vom Ort eines ersten virtuellen horizontalen Quantenpunkts (VHNV1) zur Oberfläche (OF) des Substrats (D) und/oder der ggf. vorhandenen epitaktischen Schicht (DEPI);
- HLOT2: zweite weitere horizontale Lot-Linie (HLOT2) parallel zur zweiten Lot-Linie (LOT) vom Ort eines zweiten virtuellen horizontalen Quantenpunkts (VHNV2) zur Oberfläche (OF) des Substrats (D) und/oder der ggf. vorhandenen epitaktischen Schicht (DEPI);
- HS1: erste horizontale Empfängerstufe (HS1), die mit der ersten horizontalen Treiberstufe (HD1) eine Einheit bilden kann, zur Ansteuerung des ersten anzusteuernden Quantenbits (QUB1);
- HS2: zweite horizontale Empfängerstufe (HS2), die mit der zweiten horizontalen Treiberstufe (HD2) eine Einheit bilden kann, zur Ansteuerung des zweiten anzusteuernden Quantenbits (QUB3);
- HS3: dritte horizontale Empfängerstufe (HS3), die mit der dritten horizontalen Treiberstufe (HD3) eine Einheit bilden kann, zur Ansteuerung des dritten anzusteuernden Quantenbits (QUB3);
- IH: horizontaler Strom. Der horizontale Strom ist der elektrische Strom, der die horizontale Leitung (LH) durchströmt.
- IH1: erster horizontaler Strom. Der erste horizontale Strom ist der elektrische Strom, der die erste horizontale Leitung (LH1) durchströmt.
- IH2: zweiter horizontaler Strom. Der zweite horizontale Strom ist der elektrische Strom, der die zweite horizontale Leitung (LH2) durchströmt.
- IH3: dritter horizontaler Strom. Der dritte horizontale Strom ist der elektrische Strom, der die dritte horizontale Leitung (LH3) durchströmt.
- IH4: vierter horizontaler Strom. Der vierte horizontale Strom ist der elektrische Strom, der die vierte horizontale Leitung (LH4) durchströmt.
- IHG1: erste horizontaler Gleichstromkomponente;
- IHG2: zweite horizontaler Gleichstromkomponente;
- IHi: i-ter horizontaler Strom. Der i-te horizontale Strom ist der elektrische Strom, der die i-te horizontale Leitung (LHi) durchströmt.
- IHm: m-ter horizontaler Strom. Der m-te horizontale Strom ist der elektrische Strom, der die m-te horizontale Leitung (LHm) durchströmt.
- IHM1: erster horizontaler Mikrowellenstrom mit dem die erste horizontale Leitung (LH1) bestromt wird;
- IHM2: zweiter horizontaler Mikrowellenstrom mit dem die zweite horizontale Leitung (LH2) bestromt wird;
- IHQUREG: inhomogenes Quantenregister;
- Iph: Fotostrom;
- IS: Isolation. Die bevorzugt verwendete Isolation hat die Aufgabe, die horizontale Leitung (LH) von der vertikalen Leitung (LV) elektrisch zu isolieren. Bevorzugt handelt es sich um ein Oxid, beispielsweise SiO₂, das bevorzugt aufgesputtert wird. Bevorzugt umfasst die Isolation im Wesentlichen Isotope ohne magnetisches Kernmoment. Bevorzugt ist ²⁸Si¹⁶O₂. Auf die Ausführungen zum Begriff "im Wesentlichen" wird hier verwiesen. Bevorzugt umfasst die weitere Isolation im Wesentlichen jeweils nur einen Isotopentyp je Element von Isotopen ohne magnetisches Kernmoment;
- IS2: weitere Isolation. Die bevorzugt verwendete weitere Isolation hat die Aufgabe, die horizontale Leitung (LH) bzw. die vertikale Leitung (LV) elektrisch von dem Substrat (D) bzw. der epitaktischen Schicht (DEPI) zu isolieren. Bevorzugt handelt es sich um ein Oxid, beispielsweise SiO₂, das bevorzugt aufgesputtert wird. Bevorzugt umfasst die weitere Isolation im Wesentlichen Isotope ohne magnetische Kernmoment. Bevorzugt ist ²⁸Si¹⁶O₂. Auf die Ausführungen zum Begriff "im Wesentlichen" wird hier verwiesen. Bevorzugt umfasst die weitere Isolation im Wesentlichen jeweils nur einen Isotopentyp je Element von Isotopen ohne magnetisches Kernmoment;
- ISH1: erster horizontaler Abschirmstrom, der durch die erste horizontale Abschirmleitung (SH1) fließt;
- ISH2: zweiter horizontaler Abschirmstrom Strom, der durch die zweite horizontale Abschirmleitung (SH2) fließt;
- ISH3: dritter horizontaler Abschirmstrom Strom, der durch die dritte horizontale Abschirmleitung (SH3) fließt;
- ISH4: vierter horizontaler Abschirmstrom Strom, der durch die vierte horizontale Abschirmleitung (SH3) fließt;
- ISV1: erster vertikaler Abschirmstrom, der durch die erste vertikale Abschirmleitung (SV1) fließt;
- ISV2: zweiter vertikaler Abschirmstrom, der durch die zweite vertikale Abschirmleitung (SV2) fließt;
- ISV3: dritter vertikaler Abschirmstrom, der durch die dritte vertikale Abschirmleitung (SV3) fließt;
- ISV4: vierter vertikaler Abschirmstrom, der durch die vierte vertikale Abschirmleitung (SV4) fließt;
- IV: vertikaler Strom. Der vertikale Strom ist der elektrische Strom, der die vertikale Leitung (LV) durchströmt;
- IV1: erster vertikaler Strom. Der erste vertikale Strom ist der elektrische Strom, der die erste vertikale Leitung (LV1) durchströmt;
- IV2: zweiter vertikaler Strom. Der zweite vertikale Strom ist der elektrische Strom, der die zweite vertikale Leitung (LV2) durchströmt;
- IV3: dritter vertikaler Strom. Der dritte vertikale Strom ist der elektrische Strom, der die dritte vertikale Leitung (LV3) durchströmt;
- IV4: vierter vertikaler Strom. Der vierte vertikale Strom ist der elektrische Strom, der die vierte vertikale Leitung (LV4) durchströmt;
- IVG1: erster vertikaler Gleichstrom;
- IVG2: zweiter vertikaler Gleichstrom;
- IVj: j-ter vertikaler Strom. Der j-te vertikale Strom ist der elektrische Strom, der die j-te vertikale Leitung (LVj) durchströmt;
- IVM1: erster vertikaler Mikrowellenstrom mit dem die erste vertikale Leitung (LV1) bestromt wird;
- IVM2: zweiter vertikaler Mikrowellenstrom mit dem die zweite vertikale Leitung (LV2) bestromt wird;
- IVn: n-ter vertikaler Strom. Der n-te vertikale Strom ist der elektrische Strom, der die n-te vertikale Leitung (LVn) durchströmt;
- ITO: Indium-Zinn-Oxid. Hierbei handelt es sich um ein beispielhaftes Material zur Herstellung der horizontalen Leitung (LH) und/oder der vertikalen Leitung (LV) und/oder der Abschirmleitungen;
- KH11: erster horizontaler Kontakt des ersten Quantenbits (QUB1). Der erste horizontale Kontakt des ersten Quantenbits (QUB1) verbindet die erste horizontale Abschirmleitung (SH1) im ersten Quantenmit (QUB1) elektrisch mit dem Substrat (D) bzw. der epitaktischen Schicht (DEPI). Bevorzugt handelt es sich im Falle von Diamant als Substratmaterial um einen Kontakt, der Titan umfasst oder aus Titan gefertigt ist;
- KH12: erster horizontaler Kontakt des zweiten Quantenbits (QUB2). Der erste horizontale Kontakt des zweiten Quantenbits (QUB2) verbindet die erste horizontale Abschirmleitung (SH1) im zweiten Quantenbit (QUB2) elektrisch mit dem Substrat (D) bzw. der epitaktischen Schicht (DEPI). Bevorzugt handelt es sich im Falle von Diamant als Substratmaterial um einen Kontakt, der Titan umfasst oder aus Titan gefertigt ist;
- KH22: zweiter horizontaler Kontakt des ersten Quantenbits (QUB1) und erster horizontaler Kontakt des zweiten Quantenbits (QUB2). Das erste Quantenbit (QUB1) und das zweite Quantenbit (QUB2) nutzen in dem Beispiel der Figur 23 diesen Kontakt gemeinsam. Der Kontakt verbindet die zweite horizontale Abschirmleitung (SH2) im ersten Quantenbit (QUB1) bzw. zweiten Quantenbit (QUB2) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KH33: zweiter horizontaler Kontakt des zweiten Quantenbits (QUB2) und erster horizontaler Kontakt des dritten Quantenbits (QUB3). Das zweite Quantenbit (QUB2) und das dritte Quantenbit (QUB3) nutzen in dem Beispiel der Figur 23 diesen Kontakt gemeinsam. Der Kontakt verbindet die dritte horizontale Abschirmleitung (SH3) im zweiten Quantenbit (QUB2) bzw. dritten Quantenbit (QUB3) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KH44: zweiter horizontaler Kontakt des dritten Quantenbits (QUB3). Der zweite horizontale Kontakt des dritten Quantenbits (QUB3) verbindet die vierte horizontale Abschirmleitung (SH4) im dritten Quantenbit (QUB3) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KTH: Kathodenkontakt;
- KV11: erster vertikaler Kontakt des ersten Quantenbits (QUB1). Der erste vertikale Kontakt des ersten Quantenbits (QUB1) verbindet die erste vertikale Abschirmleitung (SV1) im ersten Quantenbit (QUB1) elektrisch mit dem Substrat (D) bzw. der epitaktischen Schicht (DEPI). Bevorzugt handelt es sich im Falle von Diamant als Substratmaterial um einen Kontakt, der Titan umfasst oder aus Titan gefertigt ist;
- KV12: zweiter vertikaler Kontakt des ersten Quantenbits (QUB1) und zweiten Quantenbits (QUB2). Das erste Quantenbit (QUB1) und das zweite Quantenbit (QUB2) nutzen den zweiten vertikalen Kontakt bevorzugt gemeinsam. Der zweite vertikale Kontakt des ersten Quantenbits (QUB1) und zweiten Quantenbits (QUB2) verbindet bevorzugt die zweite vertikale Abschirmleitung (SH2) bevorzugt auf der Grenze zwischen erstem Quantenbit (QUB1) und zweiten Quantenbit (QUB2) elektrisch mit dem Substrat (D) bzw. der epitaktischen Schicht (DEPI). Bevorzugt handelt es sich im Falle von Diamant als Substratmaterial um einen Kontakt, der Titan umfasst oder aus Titan gefertigt ist;
- KV13: dritter vertikaler Kontakt des zweiten Quantenbits (QUB2) und dritten Quantenbits (QUB3). Das zweite Quantenbit (QUB2) und das dritte Quantenbit (QUB3) nutzen den dritten vertikalen Kontakt bevorzugt gemeinsam. Der dritte vertikale Kontakt des zweiten Quantenbits (QUB2) und des dritten Quantenbits (QUB3) verbindet bevorzugt die dritte vertikale Abschirmleitung (SH3) bevorzugt auf der Grenze zwischen zweiten Quantenbit (QUB2) und dritten Quantenbit (QUB3) elektrisch mit dem Substrat (D) bzw. der epitaktischen Schicht (DEPI). Bevorzugt handelt es sich m Falle von Diamant als Substratmaterial um einen Kontakt, der Titan umfasst oder aus Titan gefertigt ist;
- KV21: erster vertikaler Kontakt des zweiten Quantenbits (QUB2). Der erste vertikale Kontakt des zweiten Quantenbits (QUB2) verbindet die erste vertikale Abschirmleitung (SV1) im zweiten Quantenbit (QUB2) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KV31: erster vertikaler Kontakt des dritten Quantenbits (QUB3). Der erste vertikale Kontakt des dritten Quantenbits (QUB3) verbindet die erste vertikale Abschirmleitung (SV1) im dritten Quantenbit (QUB13) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KV22: zweiter vertikaler Kontakt des zweiten Quantenbits (QUB2). Der zweite vertikale Kontakt des zweiten Quantenbits (QUB2) verbindet die zweite vertikale Abschirmleitung (SV2) im zweiten Quantenbit (QUB2) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- KV32: zweiter vertikaler Kontakt des dritten Quantenbits (QUB3). Der zweite vertikale Kontakt des dritten Quantenbits (QUB3) verbindet die zweite vertikale Abschirmleitung (SV2) im dritten Quantenbit (QUB3) elektrisch mit dem Substrat (D) bzw. einer epitaktischen Schicht (DEPI). Bevorzugt handelt es sich im Falle von Diamant als Substratmaterial um einen Kontakt, der Titan umfasst oder aus Titan gefertigt ist;
- L1: erste Sperrinduktivität. Die erste Sperrinduktivität dient zur Einspeisung einer Gleichspannung in die betreffende horizontale oder vertikale Leitung.
- L2: zweite Sperrinduktivität. Die zweite Sperrinduktivität dient zur Einspeisung des betreffenden Radiofrequenzsignals in die betreffende horizontale oder vertikale Leitung.
- LB: grünes Licht. Das grüne Licht dient in dieser Schrift zur Initialisierung der Quantenpunkte (NV). Es handelt sich um Pumpstrahlung für die paramagnetischen Zentren, die die Quantenpunkte (NV) bilden. Auf die Ausführungen im Glossar wird verwiesen.
- LED: Lichtquelle. Die Lichtquelle dient bevorzugt der Erzeugung des "grünen Lichts" im Sinne dieser Schrift. Man beachte, dass das "grüne Licht" nur bei der Verwendung von NV-Zentren in Diamant als Quantenpunkte (NV) in dem Substrat (D) tatsächlich bevorzugt eine dem Menschen grün erscheinende Farbe hat. Bei anderen Störstellen in anderen Substratkristallen kann dies erheblich anders sein. Auf eine Konstruktionsmöglichkeit entsprechend Figur 29 wird hingewiesen. Daher handelt es sich um eine funktionale Definition. Bevorzugt wird eine LED oder ein Laser oder eine Laser-LED oder dergleichen verwendet. Typischerweise werden relativ hohe Beleuchtungsstärken verwendet. Daher kann die Lichtquelle auch optische Funktionselemente wie Filter, Linsen, Spiegel, Blenden, photonische Kristalle etc. zur Strahlformung und Lenkung und Filterung mitumfassen.
- LEDDR: Lichtquellentreiber;
- LH: horizontale Leitung;
- LH1: erste horizontale Leitung;
- LH2: zweite horizontale Leitung;
- LH3: dritte horizontale Leitung;
- LH4: vierte horizontale Leitung;
- LH5: fünfte horizontale Leitung;
- LH6: sechste horizontale Leitung;
- LH7: siebte horizontale Leitung;
- LH8: achte horizontale Leitung;
- LH9: neunte horizontale Leitung;
- LH10: zehnte horizontale Leitung;
- LH11: elfte horizontale Leitung;
- LH12: zwölfte horizontale Leitung;
- LH13: dreizehnte horizontale Leitung;
- LH14: vierzehnte horizontale Leitung;
- LH15: fünfzehnte horizontale Leitung;
- LH16: sechzehnte horizontale Leitung;
- LH17: siebzehnte horizontale Leitung;
- LHi: i-te horizontale Leitung;
- LHj: j-te horizontale Leitung;
- LHm: m-te horizontale Leitung;
- LHn: n-te horizontale Leitung;
- LOT: Lot-Linie (LOT) des Lots vom Ort des Quantenpunkts (NV) zur Oberfläche (OF) des Substrats (D) und/oder der ggf. vorhandenen epitaktischen Schicht (DEPI). Es handelt sich um eine gedachte Linie;
- LOTP: Lotpunkt, an dem die Lot-Linie (LOT), die eine gedachte Linie ist, die Oberfläche (OF) des Substrats (D) und/oder der ggf. vorhandenen epitaktischen Schicht (DEPI) durchstößt. Es handelt sich somit um einen gedachten Punkt;
- LV: vertikale Leitung;
- LV1: erste vertikale Leitung;
- LV2: zweite vertikale Leitung;
- LV3: dritte vertikale Leitung;
- LV4: vierte vertikale Leitung;
- LVj: j-te vertikale Leitung;
- LVn: n-te vertikale Leitung;
- µC: Steuervorrichtung;
- MFC: Magnetfeldkontrolle;
- MFK: Magnetfeldkontrollvorrichtung (Aktor);
- MFS: Magnetfeldsensor;
- MOD: Modul zur Ansteuerung der horizontalen Leitungen und der vertikalen Leitungen. Das Modul wird über einen Steuerbus (CB) durch die Steuervorrichtung (µC) gesteuert. Das Modul stellt die Gleichspannung zur und ggf. den Gleichstrom zu Einstellung bzw. Verstimmung der Resonanzfrequenzen der betreffenden Quantenpunkte bzw. der betreffenden Kernquantenpunkte, bzw. der Paare aus Quantenpunkten bzw. der Paare aus Kernquantenpunkt und Quantenpunkt bereit. Des Weiteren stellt das Modul die Rabifrequenz und Mikrowellenfrequenzsignale zur Ansteuerung dieser bereit. Bevorzugt hat der Ausgang des Moduls den gleichen Wellenwiderstand wie die betreffende, angesteuerte Leitung. Werden Tri-Plate-Leitungen verwendet, stellt das Modul bevorzugt alle drei Leitungen bereit. Das Modul umfass bevorzugt die Treiberstufe (HD1, HD2, HD3, VD1). Ggf. kann die Kontrolleinheit (CBA, CBB) ganz oder teilweise Teil des Moduls sein.
- MOS: MOS-Transistor;
- NV: Quantenpunkt. Bei dem Quantenpunkt handelt es sich bevorzugt um ein paramagnetisches Zentrum. Typischerweise handelt es sich bei dem paramagnetischen Zentrum um ein Störstellenzentrum in dem Substrat (D) und/oder in der Epitaxieschicht (DEPI). Handelt es sich dem Substrat (D) und/oder in der Epitaxieschicht (DEPI), so handelt es sich bevorzugt bei dem Störstellenzentrum um eines der bekannten Störstellenzentren in Diamant. Hierzu sei auf das Buch Alexander Zaitsev, "Optical Properties of Diamond", Springer; Auflage: 2001 (20. Juni 2001) verwiesen.
- NV1: erster Quantenpunkt des ersten Quantenbits (QUB1);
- NV2: zweiter Quantenpunkt des zweiten Quantenbits (QUB2);
- NV3: dritter Quantenpunkt des dritten Quantenbits (QUB3);
- NV4: vierter Quantenpunkt des vierten Quantenbits (QUB4);
- NV5: fünfter Quantenpunkt des fünften Quantenbits (QUB5);
- NV6: sechster Quantenpunkt des sechsten Quantenbits (QUB6);
- NV7: siebter Quantenpunkt des siebten Quantenbits (QUB7);
- NV8: achter Quantenpunkt des achten Quantenbits (QUB8);
- NV9: neunter Quantenpunkt des neunten Quantenbits (QUB9);
- NV10: achter Quantenpunkt des zehnten Quantenbits (QUB10);
- NV11: Quantenpunkt des Quantenbits (QUB11) in der ersten vertikalen Spalte und in der ersten horizontalen Zeile eines eindimensionalen Quantenregisters (QREG1D) oder eines zweidimensionalen Quantenregisters (QREG2D). In Figur 35 hat dieses Bezugszeichen ausnahmsweise die Bedeutung des elften Quantenpunkts des elften Quantenbits. (QUB11);
- NV12: zwölfter Quantenpunkt des zwölften Quantenbits (QUB12);
- NV13: dreizehnter Quantenpunkt des dreizehnten Quantenbits (QUB13);
- NV14: vierzehnter Quantenpunkt des vierzehnten Quantenbits (QUB14);
- NV15: fünfzehnter Quantenpunkt des fünfzehnten Quantenbits (QUB15);
- NV16: sechzehnter Quantenpunkt des sechzehnten Quantenbits (QUB16);
- NV17: siebzehnter Quantenpunkt des siebzehnten Quantenbits (QUB17);
- OF: Oberfläche des Substrats (D) oder der epitaktischen Schicht (DEPI). Im Sinne dieser Offenlegung wird die Oberfläche durch die Oberfläche des Stapels aus epitaktischer Schicht (DEPI) und Substrat (D) gebildet. Ist keine epitaktische Schicht vorhanden, so wird die Oberfläche durch die Oberfläche des Substrats (D) alleine im Sinne dieser Offenlegung gebildet.
- φ₁: erster Phasenwinkel der Rabi-Oszillation des ersten Quantenpunkts (NV1) des ersten Quantenbits (QUB1) des Quantenregisters (QUREG);
- φ₂: zweiter Phasenwinkel der Rabi-Oszillation des zweiten Quantenpunkts (NV2) des zweiten Quantenbits (QUB2) des Quantenregisters (QUREG);
- QC: Quantencomputer;
- QUALU: QuantenALU. Eine QuantenALU besteht im Sinne dieser Schrift aus zumindest einem Quantenpunkt (NV), bevorzugt aus genau einem Quantenpunkt (NV), und zumindest einem Kernquantenpunkt (CI), bevorzugt mehreren Kernquantenpunkten;
- QUALU1: erste QuantenALU. Die beispielhafte erste QuantenALU besteht aus einem ersten Quantenpunkt (NV1) und einem ersten Kernquantenpunkt (CI1);
- QUALU1': erste QuantenALU. Die beispielhafte erste QuantenALU besteht aus einem ersten Quantenpunkt (NV1) und einem ersten Kernquantenpunkt (CI1₁) der ersten QuantenALU und einem zweiten Kernquantenpunkt (CI1₂) der ersten QuantenALU und einem dritten Kernquantenpunkt (CI1₃) der ersten QuantenALU (Figur 20);
- QUALU11: QuantenALU in der ersten Zeile und ersten Spalte;
- QUALU12: QuantenALU in der ersten Zeile und zweiten Spalte;
- QUALU13: QuantenALU in der ersten Zeile und dritten Spalte;
- QUALU21: QuantenALU in der zweiten Zeile und ersten Spalte;
- QUALU22: QuantenALU in der zweiten Zeile und zweiten Spalte;
- QUALU23: QuantenALU in der zweiten Zeile und dritten Spalte;
- QUALU31: QuantenALU in der dritten Zeile und ersten Spalte;
- QUALU32: QuantenALU in der dritten Zeile und zweiten Spalte;
- QUALU33: QuantenALU in der dritten Zeile und dritten Spalte;
- QUALU2: zweite QuantenALU. Die beispielhafte zweite QuantenALU besteht aus einem zweiten Quantenpunkt (NV2) und einem zweiten Kernquantenpunkt (CI2);
- QUALU2': zweite QuantenALU. Die beispielhafte zweite QuantenALU besteht aus einem zweiten Quantenpunkt (NV2) und einem ersten Kernquantenpunkt (CI2₁) der zweiten QuantenALU und einem zweiten Kernquantenpunkt (CI2₂) der zweiten QuantenALU und einem dritten Kernquantenpunkt (CI2₃) der zweiten QuantenALU (Figur 20);
- QUREG: Quantenregister;
- QUREG1D: eindimensionales Quantenregister;
- QUREG2D: zweidimensionales Quantenregister;
- QUB: Quantenbit;
- QUB1: erstes Quantenbit des Quantenregisters (QUREG);
- QUB2: zweites Quantenbit des Quantenregisters (QUREG);
- QUB3: drittes Quantenbit des Quantenregisters (QUREG);
- QUB4: viertes Quantenbit des Quantenregisters (QUREG);
- QUB5: fünftes Quantenbit des Quantenregisters (QUREG);
- QUB6: sechstes Quantenbit des Quantenregisters (QUREG);
- QUB7: siebtes Quantenbit des Quantenregisters (QUREG);
- QUB8: achtes Quantenbit des Quantenregisters (QUREG);
- QUB9: neun Quantenbit des Quantenregisters (QUREG);
- QUB10: zehntes Quantenbit des Quantenregisters (QUREG);
- QUB11: elftes Quantenbit des Quantenregisters (QUREG);
- QUB12: zwölftes Quantenbit des Quantenregisters (QUREG);
- QUB13: dreizehntes Quantenbit des Quantenregisters (QUREG);
- QUB14: vierzehntes Quantenbit des Quantenregisters (QUREG);
- QUB15: fünfzehntes Quantenbit des Quantenregisters (QUREG);
- QUB16: sechzehntes Quantenbit des Quantenregisters (QUREG);
- QUB17: siebzehntes Quantenbit des Quantenregisters (QUREG);
- QUBi: i-tes Quantenbit des Quantenregisters (QUREG);
- QUBj: j-tes Quantenbit des Quantenregisters (QUREG);
- QUBn: n-tes Quantenbit des Quantenregisters (QUREG);
- SH1: erste horizontale Abschirmleitung;
- SH2: zweite horizontale Abschirmleitung;
- SH3: dritte horizontale Abschirmleitung;
- SH4: vierte horizontale Abschirmleitung;
- SH5: fünfte horizontale Abschirmleitung;
- SH6: sechste horizontale Abschirmleitung;
- SH7: siebte horizontale Abschirmleitung;
- SH8: achte horizontale Abschirmleitung;
- SH9: neunte horizontale Abschirmleitung;
- SHi: i-te horizontale Abschirmleitung;
- SHm: m-te horizontale Abschirmleitung;
- SO: Source. Die Source in Figur 37 entspricht dem Kontakt KV11 in Figur 19.
- sp12: Abstand zwischen dem ersten Quantenpunkt (NV1) des ersten Quantenbits (QUB1) und dem zweiten Quantenpunkt (NV2) des zweiten Quantenbits (QUB2) des beispielshaften Quantenregisters (QUREG);
- SV1: erste horizontale Abschirmleitung;
- SV2: zweite vertikale Abschirmleitung;
- SV3: dritte vertikale Abschirmleitung;
- SV4: vierte vertikale Abschirmleitung;
- SVj: j-te vertikale Abschirmleitung;
- SVn: n-te vertikale Abschirmleitung;
- SW1: erster Schwellwert;
- VD: vertikale Treiberstufe zur Ansteuerung des anzusteuernden Quantenbits (QUB);
- VD1: ersten vertikale Treiberstufe zur Ansteuerung des ersten anzusteuernden Quantenbits (QUB1);
- VD2: zweite vertikale Treiberstufe zur Ansteuerung des zweiten anzusteuernden Quantenbits (QUB2);
- VD3: dritte vertikale Treiberstufe zur Ansteuerung des dritten anzusteuernden Quantenbits (QUB3);
- V_{DC}: Gleichspannungsquelle der betreffenden Leitung. Diese Gleichspannungsquelle dient der Einstellung bzw. der Verstimmung der Resonanzfrequenzen der Quantenpunkte bzw. Kernquantenpunkte der Quantenbits bzw. Kernquantenbits, deren Teil die gespeiste betreffende Leitung ist.
- Vₑₓₜ: Extraktionsspannung bzw. Extraktionsspannungsquelle, die die Extraktionsspannung liefert. Die Extraktionsspannung wird benötigt, um die Fotoladungsträger der Quantenpunkte im Falle des elektrischen Auslesens abzusaugen. In dem Beispiel der Figur 36 wird die Extraktionsspannungsquelle von der Steuervorrichtung (µC) gesteuert.
- VHNV1: erster virtueller horizontaler Quantenpunkt;
- VHNV2: zweiter virtueller horizontaler Quantenpunkt;
- VLOT1: erste weitere vertikale Lot-Linie parallel zur Lot-Linie (LOT) vom Ort eines ersten virtuellen vertikalen Kernquantenpunkts (VVCI1) und/oder eines ersten vertikalen Quantenpunkts (VVNV1) zur Oberfläche (OF) des Substrats (D) und/oder der ggf. vorhandenen epitaktischen Schicht (DEPI);
- VLOT2: zweite weitere vertikale Lot-Linie parallel zur Lot-Linie (LOT) vom Ort eines zweiten virtuellen vertikalen Kernquantenpunkts (VVCI2) und/oder eines zweiten vertikalen Quantenpunkts (VVNV2) zur Oberfläche (OF) des Substrats (D) und/oder der ggf. vorhandenen epitaktischen Schicht (DEPI);
- VLOTP1: erster weiterer vertikaler Lotpunkt;
- VLOTP2: zweiter weiterer vertikaler Lotpunkt;
- V_{MW}: Mikrowellenquelle. In dem Beispiel der Figur 36 erzeugt die Mikrowellenquelle das Mikrowellensignal zur Ansteuerung der Quantenpunkte, Kernquantenpunkte und Paare von Quantenpunkten und Paaren aus Quantenpunkten einerseits und Kernquantenpunkten andererseits.
- VS1: erste vertikale Empfängerstufe, die mit der ersten vertikalen Treiberstufe (VD1) eine Einheit bilden kann, zur Ansteuerung des ersten anzusteuernden Quantenbits (QUB1);
- VS2: zweite vertikale Empfängerstufe, die mit der zweiten vertikalen Treiberstufe (VD2) eine Einheit bilden kann, zur Ansteuerung des zweiten anzusteuernden Quantenbits (QUB2);
- VS3: dritte vertikale Empfängerstufe, die mit der dritten vertikalen Treiberstufe (VD3) eine Einheit bilden kann, zur Ansteuerung des dritten anzusteuernden Quantenbits (QUB3);
- VVNV1: erster virtueller vertikaler Quantenpunkt;
- VVNV2: zweiter virtueller vertikaler Quantenpunkt;

### Liste der zitierten Schriften

### Patentliteratur

DE 4 322 830 A1

### Nichtpatentliteratur

Alexander Zaitsev, "Optical Properties of Diamond", Springer; Auflage: 2001 (20. Juni 2001)
Mathias H. Metsch, Katharina Senkalla, Benedikt Tratzmiller, Jochen Scheuer, Michael Kern, Jocelyn Achard, Alexandre Tallaire, Martin B. Plenio, Petr Siyushev, and Fedor Jelezko, "Initialization and Readout of Nuclear Spins via a Negatively Charged Silicon-Vacancy Center in Diamond" Phys. Rev. Lett. 122, 190503 - Published 17 May 2019
Unden T, Tomek N, Weggler T, Frank F, London P, Zopes J, Degen C, Raatz N, Meijer J, Watanabe H, Itoh K M, Plenio M B, Naydenov B & Jelezko F, "Coherent control of solid state nuclear spin nanoensemble", npj Quantum Information 4, Article number: 39 (2018)
Häußler S, Thiering G, Dietrich A, Waasem N, Teraji T, Isoya J, Iwasaki T, Hatano M, Jelezko F, Gali A, Kubanek A, "Photoluminescence excitation spectroscopy of SiV- and GeV- color center in diamond", New Journal of Physics, Volume 19 (2017)
Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond", Science 363, 728-731 (2019) 15 February 2019
Matthias Pfender, Nabeel Aslam, Patrick Simon, Denis Antonov, Gerg 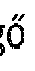 Thiering, Sina Burk, Felipe Fávaro de Oliveira, Andrej Denisenko, Helmut Fedder, Jan Meijer, Jose A. Garrido, Adam Gali, Tokuyuki Teraji, Junichi Isoya, Marcus William Doherty, Audrius Alkauskas, Alejandro Gallo, Andreas Grüneis, Philipp Neumann, and Jörg Wrachtrup, "Protecting a Diamond Quantum Memory by Charge State Control", DOI: 10.1021/acs.nanolett.7b01796, Nano Lett. 2017, 17, 5931-5937
Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond", Science 15 Feb 2019: Vol. 363, Issue 6428, pp. 728-731, DOI: 10.1126/science.aav2789
A. M. Tyryshkin, S. Tojo, J. J. L. Morton, H. Riemann, N. V. Abrosimov, P. Becker, H.-J. Pohl, Th. Schenkel,Mi. L. W. Thewalt, K. M. Itoh, S. A. Lyon, "Electron spin coherence exceeding seconds in high-purity silicon" NatureMat.11, 143 (2012)
D. Riedel, F. Fuchs, H. Kraus, S. Vath, A. Sperlich, V. Dyakonov, A. A. Soltamova, P. G. Baranov, V. A. Ilyin, G. V. Astakhov, "Resonant addressing and manipulation of silicon vacancy qubits in silicon carbide" arXiv:1210.0505v1 [cond-mat.mtrl-sci] 1 Oct 2012
D. D. Berhanuddin, " Generation and characterisation of the carbon G-centre in silicon", PhD-thesis URN: 1456601S, University of Surrey, März 201
C. Beaufils, W. Redjem, E. Rousseau, V. Jacques, A. Yu. Kuznetsov, C. Raynaud, C. Voisin, A. Benali, T. Herzig, S. Pezzagna, J. Meijer, M. Abbarchi, and G. Cassabois, "Optical properties of an ensemble of G-centers in silicon", Phys. Rev. B 97, 035303, 9. Januar 2018
H. R. Vydyanath, J. S. Lorenzo, F. A. Kröger, "Defect pairing diffusion, and solubility studies in selenium-doped silicon", Journal of Applied Physics 49, 5928 (1978), https://doi.org/10. 1063/1.324560
Stefania Castelletto and Alberto Boretti, "Silicon carbide color centers for quantumapplications" 2020 J. Phys. Photonics2 022001
M. K. Bhaskar, D. D. Sukachev, A. Sipahigil, R. E. Evans, M. J. Burek, C. T. Nguyen, L. J. Rogers, P. Siyushev, M. H. Metsch, H. Park, F. Jelezko, M. Lon ̌car, and M. D. Lukin "Quantum Nonlinear Optics with a Germanium-Vacancy Color Centerin a Nanoscale Diamond Waveguide", Phys.Rev. Lett.118 223603, DOI: 10.1103/PhysRevLett.118.223603, arXiv:1612.03036 [quant-ph]
D. D. Sukachev, A. Sipahigil, C. T. Nguyen, M. K. Bhaskar, R. E. Evans, F. Jelezko, M.D. Lukin "Silicon-vacancy spin qubit in diamond: a quantum memory exceeding 10 ms with single-shot state readout" 2017, Phys. Rev. Lett.119 223602
Marina Radulaski, Matthias Widmann, Matthias Niethammer, Jingyuan Linda Zhang, Sang-Yun Lee, Torsten Rendler, Konstantinos G. Lagoudakis, Nguyen Tien Son, Erik Janzén, Takeshi Ohshima, Jörg Wrachtrup, Jelena Vučković, "Scalable Quantum Photonics with Single Color Centers in Silicon
Carbide", Nano Letters 17 (3), 1782-1786 (2017), DOI: 10.1021/acs.nanolett.6b05102, arXiv:1612.02874
C. Wang, C. Kurtsiefer, H. Weinfurter, and B. Burchard, "Single photon emissionfrom SiV centres in diamond produced by ion implantation" J. Phys. B: At. Mol.Opt. Phys., 39(37), 2006
Björn Tegetmeyer, "Luminescence properties of SiV-centers in diamond diodes" Promotionsschrift, Universität Freiburg, 30.01.2018
Carlo Bradac, Weibo Gao, Jacopo Forneris, Matt Trusheim, Igor Aharonovich, "Quantum Nanophotonics with Group IV defects in Diamond", DOI: 10.1038/s41467-020-14316-x, arXiv:1906.10992
Rasmus Høy Jensen, Erika Janitz, Yannik Fontana, Yi He, Olivier Gobron, Ilya P. Radko, Mihir Bhaskar, Ruffin Evans, Cesar Daniel Rodriguez Rosenblueth, Lilian Childress, Alexander Huck, Ulrik Lund Andersen, "Cavity-Enhanced Photon Emission from a Single Germanium-Vacancy Center in a Diamond Membrane", arXiv:1912.05247v3 [quant-ph] 25 May 2020
Takayuki Iwasaki, Yoshiyuki Miyamoto, Takashi Taniguchi, Petr Siyushev, Mathias H. Metsch, Fedor Jelezko, Mutsuko Hatano, "Tin-Vacancy Quantum Emitters in Diamond", Phys. Rev. Lett. 119, 253601 (2017), DOI: 10.1103/PhysRevLett.119.253601, arXiv:1708.03576 [quant-ph]
Matthew E. Trusheim, Noel H. Wan, Kevin C. Chen, Christopher J. Ciccarino, Ravishankar Sundararaman, Girish Malladi, Eric Bersin, Michael Walsh, Benjamin Lienhard, Hassaram Bakhru, Prineha Narang, Dirk Englund, "Lead-Related Quantum Emitters in Diamond" Phys. Rev. B 99, 075430 (2019), DOI: 10.1103/PhysRevB.99.075430, arXiv:1805.12202 [quant-ph]
M. Hollenbach, Y. Berencén, U. Kentsch, M. Helm, G. V. Astakhov "Engineering telecom single-photon emitters in silicon for scalable quantum photonics" Opt. Express 28, 26111 (2020), DOI: 10.1364/OE.397377, arXiv:2008.09425 [physics.app-ph]
Castelletto and Alberto Boretti, "Silicon carbide color centers for quantum applications" 2020 J. Phys. Photonics2 022001
V. Ivády, J. Davidsson, N. T. Son, T. Ohshima, I. A. Abrikosov, A. Gali, "Identification of Si-vacancy related room-temperature qubits in 4H silicon carbide", Phys. Rev.B, 2017, 96,161114
J. Davidsson, V. Ivády, R. Armiento, N. T. Son, A. Gali, I. A. Abrikosov, "First principles predictions of magneto-optical data forsemiconductor point defect identification: the case of divacancy defects in 4H-SiC", New J. Phys., 2018, 20, 023035
J. Davidsson, V. Ivády, R. Armiento, T. Ohshima, N. T. Son, A. Gali, I. A. Abrikosov "Identification of divacancy and silicon vacancyqubits in 6H-SiC", Appl. Phys. Lett. 2019, 114, 112107
S. A. Zargaleh, S. Hameau, B. Eble, F. Margaillan, H. J. von Bardeleben, J. L. Cantin, W. Gao , "Nitrogen vacancy center in cubic silicon carbide: a promising qubit in the 1.5µm spectral range for photonic quantum networks" Phys. Rev.B, 2018, 98, 165203
S. A. Zargaleh et al "Evidence for near-infrared photoluminescence of nitrogen vacancy centers in 4H-SiC" Phys. Rev.B, 2016, 94, 060102
Junfeng Wang, Xiaoming Zhang, Yu Zhou, Ke Li, Ziyu Wang, Phani Peddibhotla, Fucai Liu, Sven Bauerdick, Axel Rudzinski, Zheng Liu, Weibo Gao, "Scalable fabrication of single silicon vacancy defect arrays in silicon carbide using focused ion beam" ACS Photonics, 2017, 4 (5), pp 1054-1059, DOI: 10.1021/acsphotonics.7b00230, arXiv:1703.04479 [quant-ph]
Marcel Manheller, Stefan Trellenkamp, Rainer Waser, Silvia Karthäuser, "Reliable fabrication of 3 nm gaps between nanoelectrodes by electron-beam lithography", Nanotechnology, Vol. 23, No. 12, Mar. 2012, DOI: 10.1088/0957-4484/23/12/125302
J. Meijer, B. Burchard, M. Domhan, C. Wittmann, T. Gaebel, I. Popa, F. Jelezko, J. Wrachtrup, "Generation of single color centers by focused nitrogen implantation" Appl. Phys. Lett. 87, 261909 (2005); https://doi.org/10.1063/1.2103389
Gurudev Dutt, Liang Jiang, Jeronimo R. Maze, A. S. Zibrov "Quantum Register Based on Individual Electronic and Nuclear Spin Qubits in Diamond", Science, Vol. 316, 1312-1316, 01.06.2007, DOI: 10. 1126/science. 1139831
Thiago P. Mayer Alegre, Antonio C. Torrezan de Souza, Gilberto Medeiros-Ribeiro, "Microstrip resonator for microwaves with controllable polarization", arXiv:0708.0777v2 [cond-mat.other] 11.10.2007
Schrift Benjamin Smeltzer, Jean Mclntyre, Lilian Childress "Robust control of individual nuclear spins in diamond", Phys. Rev. A 80, 050302(R) - 25 November 2009
Petr Siyushev, Milos Nesladek, Emilie Bourgeois, Michal Gulka, Jaroslav Hruby, Takashi Yamamoto, Michael Trupke, Tokuyuki Teraji, Junichi Isoya, Fedor Jelezko, "Photoelectrical imaging and coherent spin-state readout of single nitrogen-vacancy centers in diamond" Science 15 Feb 2019, Vol. 363, Issue 6428, pp. 728-731, DOI: 10.1126/science.aav2789
Timothy J. Proctor, Erika Andersson, Viv Kendon "Universal quantum computation by the unitary control of ancilla qubits and using a fixed ancilla-register interaction", Phys. Rev. A 88, 042330 -24 Okt. 2013
Charles George Tahan, "Silicon in the quantum limit: Quantum computing and decoherence in silicon architectures" PhD Thesis, University of Wisconsin - Madison, 2005
M. Abanto, L. Davidovich,Belita Koiller,R. L. de Matos Filho, "Quantum computation with doped silicon cavities", arXiv:0811.3865v1 [cond-mat.mes-hall] 24 Nov 2008
T. Schenkel, C. C. Lob, C. D. Weis, A. Schuh, A. Persaud, J. Bokor "Critical issues in the formation of quantum computer test structures by ion implantation", NIM B, Proceedings of the 23rd International Conference on Atomic Collisions in Solids, ICACS-23, Phalaborwa,South Africa, August 17-22, '08
G. D. Sanders, K. W. Kim, W. C. Holton, "A scalable solid-state quantum computer based on quantum dot pillar structures", DOI: 10.1103/PhysRevB.61.7526 arXiv:cond-mat/0001124
Matias Urdampilleta, Anasua Chatterjee, Cheuk Chi Lo, Takashi Kobayashi, John Mansir, Sylvain Barraud, Andreas C. Betz, Sven Rogge, M. Fernando Gonzalez-Zalba, John J. L. Morton, "Charge dynamics and spin blockade in a hybrid double quantum dot in silicon ", arXiv: 1503.01049v2 [cond-mat.mes-hall] 19 Mar 2015
Tobias Graß, Maciej Lewenstein, "Hybrid annealing using a quantum simulator coupled to a classical computer", arXiv:1611.09729v1 [quant-ph] 29 Nov 2016
T. F. Watson,S. G. J. Philips, E. Kawakami, D. R. Ward, P. Scarlino, M. Veldhorst, D. E. Savage, M. G. Lagally, Mark Friesen, S. N. Coppersmith, M. A. Eriksson, and L. M. K. Vandersypen, "A programmable two-qubit quantum processor in silicon ", arXiv:1708.04214v2 [cond-mat.mes-hall] 31 May 2018
C. H. Yang, R. C. C. Leon, J. C. C. Hwang, A. Saraiva, T. Tanttu, W. Huang, J. Camirand Lemyre, K. W. Chan, K. Y. Tan, F. E. Hudson, K. M. Itoh, A. Morello, M. Pioro-Ladrière, A. Laucht, A. S. Dzurak1, "Silicon quantum processor unit cell operation above one Kelvin", arXiv:1902.09126v2 [cond-mat.mes-hall] 19 Jun 2019
A. J. Sigillito, M. J. Gullans, L. F. Edge, M. Borselli, and J. R. Petta, "Coherent transfer of quantum information in silicon using resonant SWAP gates", arXiv:1906.04512v1 [cond-mat.mes-hall] 11 Jun 2019
A.A. Larionov, L.E. Fedichkin, A.A. Kokin, K.A. Valiev, "Nuclear magnetic resonance spectrum of 31P donors in silicon quantum computer", arXiv:quant-ph/0012005v1 1 Dec 2000
J. L. O'Brien, S. R. Schofield, M. Y. Simmons, R. G. Clark, A. S. Dzurak, N. J. Curson, B. E. Kane, N. S. McAlpine, M. E. Hawley, G. W. Brown, "Towards the fabrication of phosphorus qubits for a silicon quantum computer", Phys. Rev. B 64, 161401(R) (2001), DOI: 10.1103/PhysRevB.64.161401, arXiv:cond-mat/0104569
T. D. Ladd, J. R. Goldman, F. Yamaguchi, and Y. Yamamoto, "An all silicon quantum computer", Phys. Rev. Lett. 89, 017901 (2002), DOI: 10.1103/PhysRevLett.89.017901, arXiv:quant-ph/0109039
Belita Koiller, Xuedong Hu, S. Das Sarma, "Strain effects on silicon donor exchange: Quantum computer architecture Considerations", Phys. Rev. B 66, 115201 (2002), DOI: 10.1103/PhysRevB.66.115201, arXiv:cond-mat/0112078 [cond-mat.mes-hall]
T. Schenkel, J. Meijer, A. Persaud, J. W. McDonald, J. P. Holder, D. H. Schneider, "Single Ion Implantation for Solid State Quantum Computer Development" Journal of Vacuum Science & Technology B: Microelectronics and Nanometer Structures Processing, Measurement, and Phenomena 20, 2819 (2002); https://doi.org/10.1116/1.1518016,
Xuedong Hu, S. Das Sarma, "Gate errors in solid state quantum computer architectures", Phys. Rev. A 66, 012312 (2002), DOI: 10.1103/PhysRevA.66.012312, arXiv:cond-mat/0202152 [cond-mat.mes-hall],
L. Oberbeck, N. J. Curson, M. Y. Simmons, R. Brenner, A. R. Hamilton, S. R. Schofield, R. G. Clark, "Encapsulation of phosphorus dopants in silicon for the fabrication of a quantum computer", Appl. Phys. Lett. 81, 3197 (2002); https://doi.org/10.1063/1.1516859
T.M. Buehler, R.P. McKinnon, N.E. Lumpkin, R. Brenner, D.J. Reilly, L.D. Macks, A.R. Hamilton, A.S. Dzurak and R.G. Clark, "Self-aligned fabrication process for silicon quantum computer devices", DOI: 10.1088/0957-4484/13/5/330, arXiv:cond-mat/0208374
L.C.L. Hollenberg, A. S. Dzurak, C. Wellard, A. R. Hamilton, D. J. Reilly, G. J. Milburn, R. G. Clark, "Charge-based quantum computing using single donors in semiconductors", Phys. Rev. B 69, 113301, 11 March 2004, DOl:https://doi.org/10.1103/PhysRevB.69.113301
A. S. Dzurak, L. C. L. Hollenberg, D. N. Jamieson, F. E. Stanley, C. Yang, T. M. Bühler, V. Chan, D. J. Reilly, C. Wellard, R. Hamilton, C. I. Pakes, A. G. Ferguson, E. Gauja, S. Prawer, J. Milburn, R. G. Clark, "Charge-based silicon quantum computer architectures using controlled single-ion implantation" arXiv:cond-mat/0306265
S.-J. Park, A. Persaud, J. A. Liddle, J. Nilsson, J. Bokor, D. H. Schneider, I. Rangelow, T. Schenkel, "Processing Issues in Top-Down Approaches to Quantum Computer Development in Silicon", DOI: 10.1016/j.mee.2004.03.037, arXiv:cond-mat/0310195
L. M. Kettle, H.-S. Goan, Sean C. Smith, L. C. L. Hollenberg, C. J. Wellard, "Effects of J-gate potential and interfaces on donor exchange coupling in the Kane quantum computer architecture", J. Phys.: Cond. Matter, 16, 1011, (2004), DOI:10.1088/0953-8984/16/7/001, arXiv:cond-mat/0402183 [cond-mat.mtrl-sci]
Issai Shlimak, "Isotopically engineered silicon nanostructures in quantum computation and communication", HAIT Journal of Science and Engineering, vol.1, pp.196-206 (2004), arXiv:cond-mat/0403421 [cond-mat.mtrl-sci]
Xuedong Hu, Belita Koiller, S. Das Sarma, "Charge qubits in semiconductor quantum computer architectures: Tunnel coupling and decoherence", Phys. Rev. B 71, 235332 (2005), DOI: 10.1103/PhysRevB.71.235332, arXiv:cond-mat/0412340 [cond-mat.mes-hall]
Angbo Fang, Yia-Chung Chang, J.R. Tucker, "Simulation of Si:P spin-based quantum computer architecture", Phys. Rev. B 72, 075355 - Published 24 August 2005, DOI:https://doi.org/10.1103/PhysRevB.72.075355
W. M. Witzel, S. Das Sarma, "Quantum theory for electron spin decoherence induced by nuclear spin dynamics in semiconductor quantum computer architectures: Spectral diffusion of localized electron spins in the nuclear solid-state environment" Phys. Rev. B 74, 035322 (2006), DOI: 10.1103/PhysRevB.74.035322, arXiv:cond-mat/0512323 [cond-mat.mes-hall]

## Patentansprüche

1. Kernquantenbit (CQUB)
- umfassend eine Vorrichtung zur Ansteuerung eines Kernquantenpunkts (CI)
- mit einem Substrat (D) und
- ggf. mit einer epitaktischen Schicht (DEPI) und
- mit einem Kernquantenpunkt (CI) und
- wobei die Vorrichtung zur Ansteuerung eines Kernquantenpunkts (CI) eine Vorrichtung ist, die zur Erzeugung eines elektromagnetischen zirkular polarisierten Wellenfeldes (B_{RW}) am Ort des Kernquantenpunkts (CI) geeignet ist,
- wobei die epitaktische Schicht (DEPI), sofern vorhanden, auf dem Substrat (D) aufgebracht ist und
- wobei das Substrat (D) oder die ggf. vorhandene epitaktische Schicht (DEPI) eine Oberfläche (OF) aufweist und
- wobei der Kernquantenpunkt (CI) ein magnetisches Moment in Form eines Kernspins aufweist und
- wobei die Vorrichtung zur Ansteuerung eines Kernquantenpunkts (CI) sich auf der Oberfläche des Substrats (D) oder der Oberfläche der ggf. vorhandenen epitaktischen Schicht (DEPI) befindet und
- wobei die Vorrichtung zur Ansteuerung eines Kernquantenpunkts (CI) mit der Oberfläche des Substrats (D) oder mit der Oberfläche der ggf. vorhandenen epitaktischen Schicht (DEPI) fest verbunden ist,
**dadurch gekennzeichnet,**
- **dass** die Vorrichtung zur Ansteuerung eines Kernquantenpunkts (CI) eine elektrische vertikale Leitung (LV) umfasst und
- **dass** die Vorrichtung zur Ansteuerung eines Kernquantenpunkts (CI) eine elektrische horizontale Leitung (LH) umfasst und
- **dass** die vertikale Leitung (LV) die horizontale Leitung (LH) über dem Kernquantenpunkt (CI) kreuzt und
- **dass** die vertikale Leitung (LV) und die horizontale Leitung (LH) in ihrem Kreuzungsbereich durch eine Isolation (IS) voneinander elektrisch isoliert sind und
- **dass** die vertikale Leitung (LV) und die horizontale Leitung (LH) in ihrem Kreuzungsbereich einerseits und das Substrat (D) oder die ggf. vorhandene epitaktische Schicht (DEPI) andererseits durch eine weitere Isolation (IS2) voneinander elektrisch isoliert sind.

2. Kern-Elektron-Quantenregister (CEQUREG)
- umfassend ein Kernquantenbit (CQUB) nach Anspruch 1 und
- umfassend ein Quantenbit (QUB)
- umfassend eine Vorrichtung zur Ansteuerung eines Quantenpunkts (NV)
- mit einem Substrat (D) und
- ggf. mit einer epitaktischen Schicht (DEPI) und
- mit einem Quantenpunkt (NV) und
- wobei die Vorrichtung zur Ansteuerung eines Quantenpunkts (NV) eine Vorrichtung ist, die zur Erzeugung eines elektromagnetischen Wellenfeldes, insbesondere eines Mikrowellenfeldes (BMW) und/oder eines Radiowellenfeldes (BRW), am Ort des Quantenpunkts (NV) geeignet ist,
- wobei die epitaktische Schicht (DEPI), sofern vorhanden, auf dem Substrat (D) aufgebracht ist und
- wobei das Substrat (D) oder die ggf. vorhandene epitaktische Schicht (DEPI) eine Oberfläche (OF) aufweist und
- wobei der Quantenpunkt (NV) ein paramagnetisches Zentrum in dem Substrat (D) oder in der ggf. vorhandenen epitaktischen Schicht (DEPI) ist und
- wobei der Quantenpunkt (NV) ein paramagnetisches Zentrum ist, und
- wobei beim Fällen eines Lots längs einer Lot-Linie (LOT) vom Ort des Quantenpunkts (NV) zur Oberfläche (OF) des Substrats (D) oder der ggf. vorhandenen epitaktischen Schicht (DEPI) die Lot-Linie (LOT) die Oberfläche (OF) des Substrats (D) oder die Oberfläche der ggf. vorhandenen epitaktischen Schicht (DEPI) an einem Lotpunkt (LOTP) durchstößt und
- wobei die Vorrichtung zur Ansteuerung eines Quantenpunkts (NV) sich auf der Oberfläche des Substrats (D) oder der Oberfläche der ggf. vorhandenen epitaktischen Schicht (DEPI) befindet und
- wobei die Vorrichtung zur Ansteuerung eines Quantenpunkts (NV) sich in der Nähe des Lot-Punktes (LOTP) oder am Lot-Punkt (LOTP) befindet und
- wobei die Vorrichtung zur Ansteuerung eines Quantenpunkts (NV) mit der Oberfläche des Substrats (D) oder mit der Oberfläche der ggf. vorhandenen epitaktischen Schicht (DEPI) fest verbunden ist und
- wobei die Vorrichtung zur Ansteuerung eines Quantenpunkts (NV) eine elektrische vertikale Leitung (LV) umfasst und
- wobei die Vorrichtung zur Ansteuerung eines Quantenpunkts (NV) eine elektrische horizontale Leitung (LH) umfasst und
- wobei die vertikale Leitung (LV) die horizontale Leitung (LH) in der Nähe des Lot-Punktes (LOTP) oder am Lot-Punkt (LOTP) kreuzt und
- wobei die vertikale Leitung (LV) und die horizontale Leitung (LH) in ihrem Kreuzungsbereich durch eine Isolation (IS) voneinander elektrisch isoliert sind und
- wobei die vertikale Leitung (LV) und die horizontale Leitung (LH) in ihrem Kreuzungsbereich einerseits und das Substrat (D) oder die ggf. vorhandene epitaktische Schicht (DEPI) andererseits durch eine weitere Isolation (IS2) voneinander elektrisch isoliert sind.

## Claims

1. **Nuclear Qubit (CQUB)**
• comprising a device for control of a nuclear quantum dot (CI),
• with a substrate (D) and
• optionally with an epitaxial layer (DEPI) and
• with a nuclear quantum dot (CI), and
• wherein the device for control of a nuclear quantum dot (CI) is a device suitable for the generation of an electromagnetic circularly polarized wave field (BRW) at the location of the nuclear quantum dot (CI),
• wherein the epitaxial layer (DEPI), if present, is applied to the substrate (D), and
• wherein the substrate (D) or the optionally present epitaxial layer (DEPI) has a surface (OF), and
• wherein the nuclear quantum dot (CI) has a nuclear spin as a magnetic moment, and
• wherein the device for control of a nuclear quantum dot (CI) is located on the surface of the substrate (D) or on the surface of the optionally present epitaxial layer (DEPI), and
• wherein the device for control of a nuclear quantum dot (CI) is firmly connected to the surface of the substrate (D) or to the surface of the optionally present epitaxial layer (DEPI),
**characterized in that**
• the device for control of a nuclear quantum dot (CI) comprises an electrical vertical line (LV), and
• the device for control of a nuclear quantum dot (CI) comprises an electrical horizontal line (LH), and
• the vertical line (LV) crosses the horizontal line (LH) above the nuclear quantum dot (CI), and
• the vertical line (LV) and the horizontal line (LH) are electrically isolated from each other in their crossing area by an insulation (IS), and
• the vertical line (LV) and the horizontal line (LH) in their crossing area on the one hand and the substrate (D) or the optionally present epitaxial layer (DEPI) on the other hand are electrically isolated from each other by a further insulation (IS2).

2. **Nucleus Electron Quantum Register (CEQUREG)**
• comprising a nuclear qubit (CQUB) according to claim 1, and
• comprising a qubit (QUB),
∘ comprising a device for control of a quantum dot (NV),
∘ with a substrate (D), and
∘ optionally with an epitaxial layer (DEPI), and
∘ with a quantum dot (NV), and
∘ wherein the device for control of a quantum dot (NV) is a device suitable for the generation of an electromagnetic wave field, in particular a microwave field (BMW) and/or a radio wave field (BRW), at the location of the quantum dot (NV),
∘ wherein the epitaxial layer (DEPI), if present, is applied to the substrate (D), and
∘ wherein the substrate (D) or the optionally present epitaxial layer (DEPI) has a surface (OF), and
∘ wherein the quantum dot (NV) is a paramagnetic centre in the substrate (D) or in the optionally present epitaxial layer (DEPI), and
∘ wherein the quantum dot (NV) is a paramagnetic centre, and
∘ wherein, when dropping a perpendicular along a perpendicular line (LOT) from the location of the quantum dot (NV) to the surface (OF) of the substrate (D) or the optionally present epitaxial layer (DEPI), the perpendicular line (LOT) penetrates the surface (OF) of the substrate (D) or the surface of the optionally present epitaxial layer (DEPI) at a perpendicular point (LOTP), and
∘ wherein the device for control of a quantum dot (NV) is located on the surface of the substrate (D) or on the surface of the optionally present epitaxial layer (DEPI), and
∘ wherein the device for control of a quantum dot (NV) is located in the vicinity of the perpendicular point (LOTP) or at the perpendicular point (LOTP), and
∘ wherein the device for control of a quantum dot (NV) is firmly connected to the surface of the substrate (D) or to the surface of the optionally present epitaxial layer (DEPI), and
∘ wherein the device for control of a quantum dot (NV) comprises an electrical vertical line (LV), and
∘ wherein the device for control of a quantum dot (NV) comprises an electrical horizontal line (LH), and
∘ wherein the vertical line (LV) crosses the horizontal line (LH) in the vicinity of the perpendicular point (LOTP) or at the perpendicular point (LOTP), and
∘ wherein the vertical line (LV) and the horizontal line (LH) are electrically isolated from each other in their crossing area by an insulation (IS), and
∘ wherein the vertical line (LV) and the horizontal line (LH) in their crossing area on the one hand and the substrate (D) or the optionally present epitaxial layer (DEPI) on the other hand are electrically isolated from each other by a further insulation (IS2).

## Revendications

1. **Qubit nucléaire (CQUB)**
• comprenant un dispositif pour le contrôle d'un point quantique nucléaire (CI),
• avec un substrat (D) et
• éventuellement avec une couche épitaxiale (DEPI), et
• avec un point quantique nucléaire (CI), et
• le dispositif pour le contrôle d'un point quantique nucléaire (CI) étant un dispositif apte à générer un champ d'ondes électromagnétiques polarisées circulairement (BRW) à l'emplacement du point quantique nucléaire (CI),
• la couche épitaxiale (DEPI), si présente, étant déposée sur le substrat (D), et
• le substrat (D) ou la couche épitaxiale (DEPI), le cas échéant, présentant une surface (OF), et
• le point quantique nucléaire (CI) présentant un moment magnétique sous forme d'un spin nucléaire, et
• le dispositif pour le contrôle d'un point quantique nucléaire (CI) étant disposé sur la surface du substrat (D) ou sur la surface de la couche épitaxiale (DEPI), le cas échéant, et
• le dispositif pour le contrôle d'un point quantique nucléaire (CI) étant fixé à la surface du substrat (D) ou à la surface de la couche épitaxiale (DEPI), le cas échéant,
**caractérisé en ce que**
• le dispositif pour le contrôle d'un point quantique nucléaire (CI) comprend une ligne électrique verticale (LV), et
• le dispositif pour le contrôle d'un point quantique nucléaire (CI) comprend une ligne électrique horizontale (LH), et
• la ligne verticale (LV) croise la ligne horizontale (LH) au-dessus du point quantique nucléaire (CI), et
• la ligne verticale (LV) et la ligne horizontale (LH) sont électriquement isolées l'une de l'autre, dans leur zone de croisement, par une isolation (IS), et
• la ligne verticale (LV) et la ligne horizontale (LH), dans leur zone de croisement, d'une part, et le substrat (D) ou la couche épitaxiale (DEPI), le cas échéant, d'autre part, sont électriquement isolés l'un de l'autre par une autre isolation (IS2).

2. **Registre quantique noyau-électron (CEQUREG)**
• comprenant un qubit nucléaire (CQUB) selon la revendication 1, et
• comprenant un qubit (QUB),
∘ comprenant un dispositif pour le contrôle d'un point quantique (NV),
∘ avec un substrat (D), et
∘ éventuellement avec une couche épitaxiale (DEPI), et
∘ avec un point quantique (NV), et
∘ le dispositif pour le contrôle d'un point quantique (NV) étant un dispositif apte à générer un champ d'ondes électromagnétiques, en particulier un champ micro-ondes (BMW) et/ou un champ d'ondes radio (BRW), à l'emplacement du point quantique (NV),
∘ la couche épitaxiale (DEPI), si présente, étant déposée sur le substrat (D), et
∘ le substrat (D) ou la couche épitaxiale (DEPI), le cas échéant, présentant une surface (OF), et
∘ le point quantique (NV) étant un centre paramagnétique dans le substrat (D) ou dans la couche épitaxiale (DEPI), le cas échéant, et
∘ le point quantique (NV) étant un centre paramagnétique, et
∘ lorsqu'une perpendiculaire (LOT) est abaissée depuis l'emplacement du point quantique (NV) vers la surface (OF) du substrat (D) ou de la couche épitaxiale (DEPI), le cas échéant, la ligne perpendiculaire (LOT) traversant la surface (OF) du substrat (D) ou la surface de la couche épitaxiale (DEPI) au niveau d'un point perpendiculaire (LOTP), et
∘ le dispositif pour le contrôle d'un point quantique (NV) étant disposé sur la surface du substrat (D) ou sur la surface de la couche épitaxiale (DEPI), le cas échéant, et
∘ le dispositif pour le contrôle d'un point quantique (NV) étant disposé à proximité du point perpendiculaire (LOTP) ou au niveau du point perpendiculaire (LOTP), et
∘ le dispositif pour le contrôle d'un point quantique (NV) étant fixé à la surface du substrat (D) ou à la surface de la couche épitaxiale (DEPI), le cas échéant, et
∘ le dispositif pour le contrôle d'un point quantique (NV) comprenant une ligne électrique verticale (LV), et
∘ le dispositif pour le contrôle d'un point quantique (NV) comprenant une ligne électrique horizontale (LH), et
∘ la ligne verticale (LV) croisant la ligne horizontale (LH) à proximité du point perpendiculaire (LOTP) ou au niveau du point perpendiculaire (LOTP), et
∘ la ligne verticale (LV) et la ligne horizontale (LH) étant électriquement isolées l'une de l'autre, dans leur zone de croisement, par une isolation (IS), et
∘ la ligne verticale (LV) et la ligne horizontale (LH), dans leur zone de croisement, d'une part, et le substrat (D) ou la couche épitaxiale (DEPI), le cas échéant, d'autre part, étant électriquement isolés l'un de l'autre par une autre isolation (IS2).
